# EUROPEAN PATENT SPECIFICATION

(11) **EP 3 186 264 B1**
(45) Date of publication and mention of the grant of the patent: **28.11.2018**
(21) Application number: 15750362.4
(22) Date of filing: 07.08.2015
(51) Int. Cl.: C07F 15/00, C09K 11/06, H01L 51/00, H05B 33/10, C09K 11/02, H01L 51/50

(54) **ELECTROLUMINESCENT IMIDAZO-QUINOXALINE CARBENE METAL COMPLEXES**
ELEKTROLUMINESZENTE IMIDAZO-CHINOXALIN-CARBEN-METALLKOMPLEXE
COMPLEXES DE CARBÈNE-MÉTAL À IMIDAZO-QUINOXALINE ÉLECTROLUMINESCENT

(30) Priority: 08.08.2014 EP 14180422
(43) Date of publication of application: 05.07.2017
(60) Divisional application: 18202308.5
(73) Proprietor: UDC Ireland Limited, Ballycoolin, Dublin 15 (IE)
(72) Inventor: MURER, Peter, CH-4104 Oberwil (CH); GEßNER, Thomas, 69120 Heidelberg (DE); EICKHOFF, Christian, 68259 Mannheim (DE); BIRNSTOCK, Jan, 01187 Dresden (DE); MAY, Falk, 55126 Mainz (DE); KAHLE, Klaus, 67069 Ludwigshafen (DE)
(74) Representative: Maiwald Patent- und Rechtsanwaltsgesellschaft mbH
(86) International application number: PCT/EP2015/068240
(87) International publication number: WO 2016/020516

(56) References cited:
- WO-A1-2011/073149
- WO-A2-2005/019373

## Description

The present invention relates to metal-carbene complexes comprising at least one imidazo-quinoxaline ligand of the general formula (I), to organic electronic devices, especially OLEDs (Organic Light-Emitting Diodes) which comprise such complexes, to a light-emitting layer comprising at least one inventive metal carbene complex, to an apparatus selected from the group consisting of illuminating elements, stationary visual display units and mobile visual display units comprising such an OLED, to the use of such a metal-carbene complex for electrophotographic photoreceptors, photoelectric converters, organic solar cells (organic photovoltaics), switching elements, organic light emitting field effect transistors (OLEFETs), image sensors, dye lasers and electroluminescent devices and to a process for preparing such metal-carbene complexes.

Organic light-emitting diodes (OLEDs) exploit the propensity of materials to emit light when they are excited by electrical current. OLEDs are of particular interest as an alternative to cathode ray tubes and liquid-crystal displays for production of flat visual display units. Owing to the very compact design and the intrinsically low power consumption, devices comprising OLEDs are suitable especially for mobile applications, for example for applications in cellphones, smartphones, digital cameras, mp3 players, laptops, etc. In addition, white OLEDs give great advantages over the illumination technologies known to date, especially a particularly high efficiency.

The prior art proposes numerous materials which emit light on excitation by electrical current.

WO2006/056418A2 discloses the use of "unsymmetrical" transition metal-carbene complexes comprising one aromatic ligand and one aliphatic ligand connected with an imidazole ring in organic light-emitting diodes. The imidazole ring may comprise further aromatic or non-aromatic rings fused to the imidazole ring. All complexes shown in the examples in WO2006/056418A2 emit light in the purple to blue region of the electromagnetic spectrum.

WO2011/073149A1 discloses metal complexes comprising diazabenzimidazol carbene ligands and their use in OLEDs. According to the specification, metal complexes are provided emitting light especially in the blue region of the electromagnetic spectrum. Diazabenzimidazole carbene ligands, wherein the benzimidazole residue comprises further fused aromatic rings are excluded in WO2011/073149A1.

WO2012/170463 relates to metal-carbene complexes comprising a central atom selected from iridium and platinum, and specific azabenzimidazolocarbene ligands and to OLEDs, which comprise such complexes. WO2012/170461 and WO2012/121936 relate to metal-carbene complexes comprising a central atom selected from iridium and platinum, and diazabenzimid-azolocarbene ligands, to organic light diodes which comprise such complexes and to light-emitting layers comprising at least one such metal-carbene complex. However, no complexes which have imidazo-quinoxaline carbene lgands are disclosed by said documents.

The carbene complexes mentioned in the prior art mentioned above are - according to said prior art - especially suitable as emitter materials emitting light in the blue region of the visible electromagnetic spectrum.

In the prior art mentioned below, complexes suitable as emitter materials emitting light in the green region of the visible electromagnetic spectrum are mentioned.

Baldo et al., Applied Physics Letters, vol. 75, No. 1, 5 July 1999, 4-6, concerns an organic light-emitting device based on electrophosphorescent emitting light in the green region of the electromagnetic spectrum comprising - as emitter material *-fac* tris(2-phenylpyridine)iridium ([Ir(ppy)₃]).

US2011/0227049A1 concerns organic iridium complexes containing a 2-phenylpyridine ligand having a twisted aryl group on the pyridine portion of the ligand. The compounds may be used in organic light-emitting devices, particularly as emitting dopants. The iridium compounds shown in US2011/0227049A1 are, according to all examples, employed as emitter material in organic light-emitting diodes emitting light in the green region of the electromagnetic spectrum.

US2014/0203268A1 discloses heteroleptic iridium complexes having a combination of ligands which includes a single pyridyl dibenzo-substituted ligand. The compounds may be used in organic light-emitting devices. All organic light-emitting devices mentioned in the examples of US2014/0203268A1 comprise the specific iridium complexes mentioned before as emitter materials emitting light in the green region of the electromagnetic spectrum.

WO2012/053627A1 discloses organometallic complexes in which a 4-arylpyrimidine derivative is a ligand and iridium is a central metal, which organometallic complex emits phosphorescence and may be used in a light-emitting device. According to the specification, the organometallic complex has a broad range of emission spectra in the wavelength range of red to green.

WO 2005/019373 discloses transition metal complexes comprising carbene ligands for use as emitters in OLEDs.

One important application for phosphorescent emissive molecules is a full color display. Industry standards for such a display call for pixels adapted to emit the particular colors: saturated red, green and blue pixels. The color may be measured using CIE coordinates, which are well-known to a person skilled in the art.

There is therefore a need to provide phosphorescent emissive molecules emitting with high quantum efficiency and good color purity in the red, green and blue area of the electromagnetic spectrum.

Since highly emissive phosphorescent molecules emitting light in the blue region of the electromagnetic spectrum, based on carbene ligands, are known in the art (see for example the prior art mentioned above), it is an object of the present invention to provide phosphorescent emissive molecules based on transition metal carbene complexes, emitting in the green to yellow region of the visible electromagnetic spectrum, i.e. having a λₘₐₓ of 510 to 590 nm. The preferred CIE-y coordinate is higher than 0.47, preferably higher than 0.50.

It is a further object of the present invention to provide organic electronic devices, preferably OLEDs, having - compared with the organic electronic devices known in the art - a high color purity in the green to yellow region of the visible electromagnetic spectrum, a high efficiency, low voltage and/or improved lifetime/stability.

The object is achieved by a metal carbene complex, wherein the metal is selected from Ir and Pt, comprising at least one ligand of formula (A), preferably at least one ligand of formula (I) 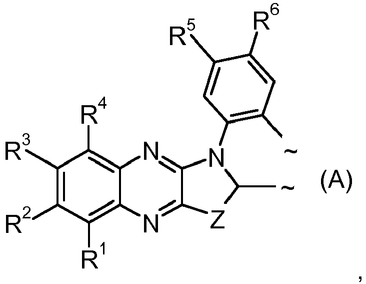 preferably 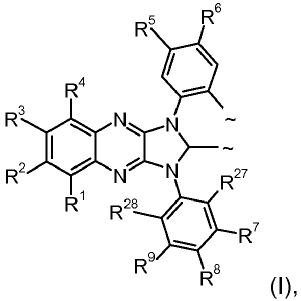 wherein
Z is NR^{x}, O or S, preferably NR^{x} or O, more preferably NR^{x},
R^{x} is 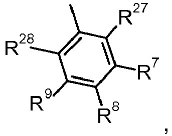
R¹, R², R³ and R⁴
are independently of each other hydrogen; a C₁-C₁₈alkyl group, which can optionally be substituted by at least one substituent E and/or interrupted by D; a C₃-C₁₂cycloalkyl group, which can optionally be substituted by at least one substituent E; a heterocycloalkyl group comprising 3 to 6 ring atoms, interrupted by at least one of O, S and NR⁶⁵ and/or substituted by at least one substituent E; a C₆-C₁₄aryl group, which can optionally be substituted by at least one substituent G; a -NR⁶⁵-C₆-C₁₄aryl group, preferably a -N(C₆-C₁₄aryl)₂ group, which can optionally be substituted by at least one substituent G; a heteroaryl group comprising 3 to 11 ring atoms, which can optionally be substituted by at least one substituent G, interrupted by at least one of O, S, N and NR⁶⁵; or a -NR⁶⁵-heteroaryl group, preferably a -N(heteroaryl)₂ group, comprising 3 to 11 ring atoms, which can optionally be substituted by at least one substituent G, interrupted by at least one of O, S, N and NR⁶⁵; a halogen atom, especially F or Cl; a C₁-C₁₈haloalkyl group such as CF₃; CN; or SiR⁸⁰R⁸¹R⁸²; or
R¹ and R², R² and R³ or R³ and R⁴ form together a ring 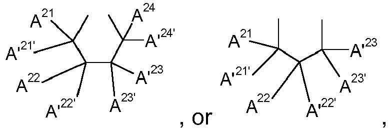 wherein A²¹, A^{21'}, A²², A^{22'}, A²³, A^{23'}, A^{24'} and A²⁴ are independently of each other H, a C₁-C₄alkyl group, a C₃-C₆cycloalkyl group, or a fluoroC₁-C₄alkyl group;
R⁵ and R⁶
are independently of each other hydrogen; a C₁-C₁₈alkyl group, which can optionally be substituted by at least one substituent E and/or interrupted by D; a C₃-C₁₂cycloalkyl group, which can optionally be substituted by at least one substituent E; a heterocycloalkyl group comprising 3 to 6 ring atoms, interrupted by at least one of O, S and NR⁶⁵ and/or substituted by at least one
substituent E; a C₆-C₁₄aryl group, which can optionally be substituted by at least one substituent G; a -NR⁶⁵-C₆-C₁₄aryl group, preferably a -N(C₆-C₁₄aryl)₂ group, which can optionally be substituted by at least one substituent G; a heteroaryl group comprising 3 to 11 ring atoms, which can optionally be substituted by at least one substituent G, interrupted by at least one of O, S, N and NR⁶⁵; a halogen atom, especially F or Cl; a C₁-C₁₈haloalkyl group such as CF₃; CN; or
SiR⁸⁰R⁸¹R⁸²;
R⁷, R⁸, R⁹, R²⁷ and R²⁸
are independently of each other hydrogen; a C₁-C₁₈alkyl group, which can optionally be substituted by at least one substituent E and/or interrupted by D; a C₃-C₁₂cycloalkyl group, which can optionally be substituted by at least one substituent E; a heterocycloalkyl group comprising 3 to 6 ring atoms, interrupted by at least one of O, S and NR⁶⁵ and/or substituted by at least one substituent E; a C₆-C₁₄aryl group, which can optionally be substituted by at least one substituent G; a heteroaryl group comprising 3 to 11 ring atoms, which can optionally be substituted by at least one substituent G, interrupted by at least one of O, S, N and NR⁶⁵ a halogen atom, especially F or Cl; a C₁-C₁₈haloalkyl group such as CF₃; CN; or SiR⁸⁰R⁸¹R⁸²; in addition to the groups mentioned above, R⁸ may be a -NR⁶⁵-C₆-C₁₄aryl group, preferably a -N(C₆-C₁₄aryl)₂ group, which can optionally be substituted by at least one substituent G; or a -NR⁶⁵-heteroaryl group, preferably a -N(heteroaryl)₂ group, comprising 3 to 11 ring atoms, which can optionally be substituted by at least one substituent G, interrupted by at least one of O, S, N and NR⁶⁵; or
R⁵ and R⁶ and/or R⁸ and R⁹ together form a group of formula 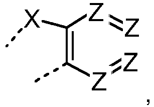 wherein Z is N or
CR'", wherein 0 or 1 Z is N, preferably 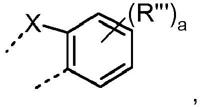 wherein X is O, S, NR⁷⁵ or CR⁷³R⁷⁴, preferably O; R'" is C₁-C₈alkyl and a is 0, 1 or 2, preferably 0 or 1, more preferably 0;
D is -CO-, -COO-, -S-, -SO-, -SO₂-, -O-, -NR⁶⁵-, -SiR⁷⁰R⁷¹-, -POR⁷²-, -CR⁶³=CR⁶⁴-, or -C≡C, preferably -O-, -S- or -NR⁶⁵-;
E is -OR⁶⁹, -SR⁶⁹, -NR⁶⁵R⁶⁶, -COR⁶⁸, -COOR⁶⁷, -CONR⁶⁵R⁶⁶, -CN, halogen, a C₁-C₁₈alkyl group, which can optionally be substituted by at least one substituent E and/or interrupted by D; preferably F; a C₁-C₈haloalkyl group such as CF₃, or a C₁-C₈alkyl group;
preferably, E is C₁-C₈alkyl, C₁-C₈alkoxy, CN, halogen, preferably F, or C₁-C₈haloalkyl, such as CF₃; more preferably E is C₁-C₈alkyl, C₁-C₈alkoxy, or C₁-C₈haloalkyl, such as CF₃;
G is E; or an unsubstituted C₆-C₁₄aryl group; a C₆-C₁₄aryl group, which is substituted by F, C₁-C₁₈alkyl, or C₁-C₁₈alkyl, which is substituted by F and/or interrupted by O; an unsubstituted heteroaryl group comprising 3 to 11 ring atoms, interrupted by at least one of O, S, N and NR⁶⁵; or a heteroaryl group comprising 3 to 11 ring atoms, interrupted by at least one of O, S, N and NR⁶⁵, which is substituted by F, unsubstituted C₁-C₁₈alkyl, SiR⁸⁰R⁸¹R⁸², or C₁-C₁₈alkyl which is substituted by F and/or interrupted by O;
preferably, G is a C₁-C₈alkyl group, or a group of formula 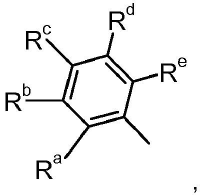 R^{a} is H, a C₁-C₅alkyl group, a fluoroC₁-C₄alkyl group, or a C₃-C₆cycloalkyl group, R^{e} is H, a C₁-C₅alkyl group, a fluoroC₁-C₄alkyl group, or a C₃-C₆cycloalkyl group, R^{c}, R^{b} and R^{d} are independently of each other hydrogen; a C₁-C₁₈alkyl group, which can optionally be substituted by E and/or interupted by D; a C₃-C₁₂cycloalkyl group, which can optionally be substituted by G; a C₃-C₁₀heterocycloalkyl radical which is interrupted by at least one of O, S and NR⁶⁵ and/or substituted by E; a C₆-C₂₄aryl group, which can optionally be substituted by G; or a C₂-C₃₀heteroaryl group, which can optionally be substituted by G; a halogen atom, especially F or Cl; C₁-C₈haloalkyl such as CF₃; CN; or SiR⁸⁰R⁸¹R⁸²; or
R^{c} and R^{b}, or R^{a} and R^{b} together form a group of formula 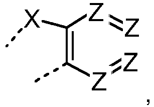 wherein Z is N or CR'", wherein 0 or 1 Z is N, preferably 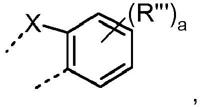 wherein X is O, S, NR⁷⁵ or CR⁷³R⁷⁴, preferably O; R'" is C₁-C₈alkyl and a is 0, 1 or 2, preferably 0 or 1, more preferably 0;
R⁶³ and R⁶⁴ are independently of each other H; unsubstituted C₆-C₁₈aryl; C₆-C₁₈aryl which is substituted by C₁-C₁₈alkyl, or C₁-C₁₈alkoxy; unsubstituted C₁-C₁₈alkyl; or C₁-C₁₈alkyl which is interrupted by -O-; preferably unsubstituted C₆-C₁₈aryl; C₆-C₁₈aryl which is substituted by C₁-C₁₈alkyl, or C₁-C₁₈alkoxy; unsubstituted C₁-C₁₈alkyl; or C₁-C₁₈alkyl which is interrupted by -O-; R⁶⁵ and R⁶⁶ are independently of each other H, an unsubstituted C₆-C₁₈aryl group; a C₆-C₁₈aryl group which is substituted by C₁-C₁₈alkyl, or C₁-C₁₈alkoxy; an unsubstituted C₁-C₁₈alkyl group; or a C₁-C₁₈alkyl group, which is interrupted by -O-;
R⁶⁵ and R⁶⁶ together form a five or six membered ring,
R⁶⁷ is H, an unsubstituted C₆-C₁₈aryl group; a C₆-C₁₈aryl group, which is substituted by C₁-C₁₈alkyl, or C₁-C₁₈alkoxy; an unsubstituted C₁-C₁₈alkyl group; or a C₁-C₁₈alkyl group, which is interrupted by -O-; preferably an unsubstituted C₆-C₁₈aryl group; a C₆-C₁₈aryl group, which is substituted by C₁-C₁₈alkyl, or C₁-C₁₈alkoxy; an unsubstituted C₁-C₁₈alkyl group; or a C₁-C₁₈alkyl group, which is interrupted by -O-;
R⁶⁸ is H; an unsubstituted C₆-C₁₈aryl group; a C₆-C₁₈aryl group, which is substituted by C₁-C₁₈alkyl, or C₁-C₁₈alkoxy; an unsubstituted C₁-C₁₈alkyl group; or a C₁-C₁₈alkyl group, which is interrupted by -O-;
R⁶⁹ is H, an unsubstituted C₆-C₁₈aryl; a C₆-C₁₈aryl, which is substituted by C₁-C₁₈alkyl, or C₁-C₁₈alkoxy; an unsubstituted C₁-C₁₈alkyl group; or a C₁-C₁₈alkyl group, which is interrupted by - O-; preferably an unsubstituted C₆-C₁₈aryl; a C₆-C₁₈aryl, which is substituted by C₁-C₁₈alkyl, or C₁-C₁₈alkoxy; an unsubstituted C₁-C₁₈alkyl group; or a C₁-C₁₈alkyl group, which is interrupted by -O-;
R⁷⁰ and R⁷¹ are independently of each other an unsubstituted C₁-C₁₈alkyl group; an unsubstituted C₆-C₁₈aryl group; or a C₆-C₁₈aryl group, which is substituted by C₁-C₁₈alkyl;
R⁷² is an unsubstituted C₁-C₁₈alkyl group; an unsubstituted C₆-C₁₈aryl group, or a C₆-C₁₈aryl group, which is substituted by C₁-C₁₈alkyl;
R⁷³ and R⁷⁴ are independently of each other H, C₁-C₂₅alkyl, C₁-C₂₅alkyl which is interrupted by O, C₇-C₂₅arylalkyl, C₆-C₂₄aryl, C₆-C₂₄aryl which is substituted by C₁-C₁₈alkyl, C₂-C₂₀heteroaryl, or C₂-C₂₀heteroaryl which is substituted by C₁-C₁₈alkyl;
R⁷⁵ is a C₆-C₁₈aryl group; a C₆-C₁₈aryl which is substituted by C₁-C₁₈alkyl, or C₁-C₁₈alkoxy; a C₁-C₁₈alkyl group; or a C₁-C₁₈alkyl group, which is interrupted by -O-;
R⁸⁰, R⁸¹ and R⁸² are independently of each other a C₁-C₂₅alkyl group, which can optionally be interrupted by O; a C₆-C₁₄aryl group, which can optionally be substituted by C₁-C₁₈alkyl; or a heteroaryl group comprising 3 to 11 ring atoms, which can optionally be substituted by C₁-C₁₈alkyl;
∼ is a bonding site to the metal.

It has been found by the inventors of the present invention that the inventive metal carbene complexes mentioned above emit light in the yellow to green area, especially in the yellow-green to green region, respectively in the green to yellow area, especially in the green to yellow-green region, of the visible electromagnetic spectrum (λₘₐₓ of 510 to 590 nm). It has been further found by the inventors of the present application - in contrast to the expectation of a person skilled in the art - that the imidazo-quinoxaline carbene metal complexes according to the present invention show a short lifetime of the luminescence (τᵥ) of the respective Pt or Ir carbene complexes, especially Ir carbene complexes, of the present invention.

These metal-carbene complexes may spend less time in the excited state, thereby decreasing the possibility for photochemical reactions, or quenching to occur. Therefore, these compounds may provide devices with improved stability and/or also improved device efficiency. In addition, the inventive metal-carbene complexes may provide reduced color-shift of the emission with increasing doping concentration of the compounds in a host material.

Organic electronic devices comprising the metal carbene complexes according to the present invention further show a high color purity in the green to yellow region, especially in the yellow-green to green region, respectively in the green to yellow-green region, of the visible electromagnetic spectrum, a high efficiency, low voltage and/or improved lifetime/stability.

Organic electronic devices, preferably OLEDs, comprising the metal-carbene complex according to the present invention further show improved device performance such as high quantum efficiency, high luminous efficacy, low voltage, good stabilities and/or long lifetimes. The inventive metal-carbene complexes comprising at least one ligand of formula (I) are particularly suitable as emitter materials with an emission in the green to yellow region of the visible electromagnetic spectrum with a λₘₐₓ of 510 to 590 nm. The preferred CIE-y coordinate is higher than 0.47, preferably higher than 0.50. This enables for example the production of white OLEDs, or full-color displays.

Any colour can be expressed by the chromaticity coordinates x and y on the CIE chromaticity diagram. The boundaries of this horseshoe-shaped diagram are the plots of monochromatic light, called spectrum loci, and all the colours in the visible spectrum fall within or on the boundary of this diagram. The arc near the centre of the diagram is called the Planckian locus, which is the plot of the coordinates of black body radiation at the temperatures from 1000 K to 20000 K, described as CCT.

The correlated colour temperature (CCT) is the temperature of a blackbody radiator that has a colour that most closely matches the emission from a nonblackbody radiator.

The metal carbene complexes of the present invention preferably emit yellow to green light (λₘₐₓ of 510 to 590 nm) with a FWHM (full width at half maximum) of 20 nm to 140 nm, more preferably of 40 nm to 100 nm, most preferably 60 nm to 90 nm.

In case of OLED display applications, the color purity plays a crucial role. In order to achieve highly efficient displays with high color gamut, it is reasonable that the spectra of the OLED emitters are narrow. Therefore, it is preferred that the emission shows a single peak spectrum with a full width half-maximum (FWHM) of 20 nm to 140 nm, more preferably of 40 nm to 100 nm, most preferably 60 nm to 90 nm. For OLED lighting application, a broad spectrum is benefitial.

The triplet decay time (= lifetime of the luminescence τᵥ) of metal carbene complexes of the present invention (as emitter) is 0.5 to 100 micro seconds, more preferably 0.5 to 10 micro seconds, most preferably 0.5 to 5 micro seconds, even more preferably 0.5 to 3 micro seconds.

The metal carbene complex according to the present invention is - at room temperature (i.e. at 25 °C) - a phosphorescent emitter.

The phosphosphorescent emitters according to the present invention emit preferably from triplet excited states. Phosphorescence may be preceded by a transition from a triplet excited state to an intermediate non-triplet state from which the emissive decay occurs. For example, organic molecules coordinated to lanthanide elements often phosphoresce from excited states localized on the lanthanide metal. However, such materials do not phosphoresce directly from a triplet excited state but instead emit from an atomic excited state centered on the lanthanide metal ion. The europium diketonate complexes illustrate one group of these types of species.

The absolute photoluminescence quantum yield of the metal carbene complexes of the present invention (measured at room temperature (in the context of the present invention "room temperature" is 25°C) is in general at least 50%, preferably at least 70%, e.g. 50 to 95 %, more preferably 70 to 95 %.

In a preferred embodiment, the absolute photoluminescence quantum yield of the metal carbene complexes of the present invention (measured at room temperature (in the context of the present invention "room temperature" is 25°C) is in general 50 to 99 %, more preferably 70 to 99 %.

The determination of the photoluminescence spectra of the inventive metal carbene complexes as well as the determination of the lifetime of luminescence τ_{V} are described below. The further data mentioned below can be determined based on said information by methods known to a person skilled in the art.

Another advantage of the complexes according to the present invention is their generally very high thermal stability. The complexes according to the present invention generally remain undegraded at a temperature above 250°C, preferably above 300 °C, more preferably above 350 °C, in general for a duration of more than 2 days, preferably more than 5 days, more preferably more than 9 days. This can for example been prooved by a so-called "ampulla test". For that test, 50 mg of material have been sealed in glass ampullas under nitrogen atmosphere and afterwards they were stored in an oven at different temperatures at temperatures between 310° up to 385°C for a duration of 10 days. After that period the materials have been investigated by means of HPLC to check their quality. The results show that the inventive complexes remain undegraded.

A variety of representations are used to depict the bonding in metal-carbenes, including those in which a curved line is used to indicate partial multiple bonding between the carbene carbon and the adjacent heteroatom(s): 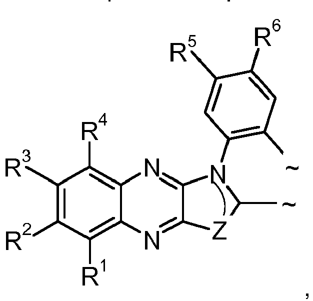 preferably 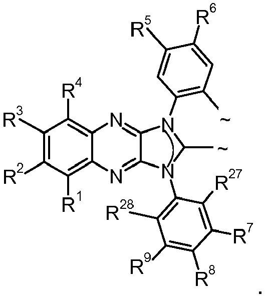 In the figures and structures herein, a metal-carbene bond is depicted as C-M, as, for example, 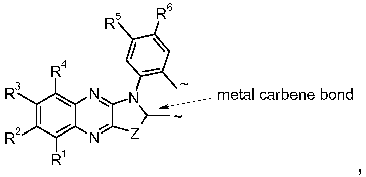 preferably

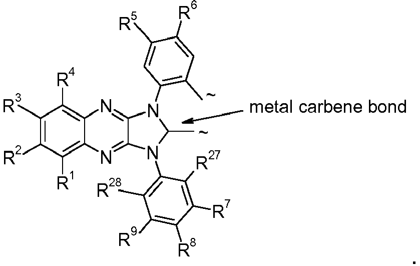

The residues mentioned in the specification of the present application generally have the following preferred meanings, if not defined differently in a specific residue:
A C₁-C₁₈alkyl group, which can optionally be substituted by at least one substituent E and/or interrupted by D: preferably a C₁-C₁₂alkyl group, which can optionally be substituted by at least one substituent E and/or interrupted by D; more preferably a C₁-C₈alkyl group, which can optionally be substituted by at least one substituent E and/or interrupted by D; most preferably a C₁-C₈alkyl group, which can optionally be substituted by at least one substituent E; even more preferably an unsubstituted C₁-C₈alkyl group; further even more preferably an unsubstituted C₁-C₅alkyl group, e.g. methyl, ethyl, propyl, like n-propyl, iso-propyl, n-butyl, sec-butyl, iso-butyl, tert-butyl, or neopentyl. The alkyl groups may be linear or branched.

A C₃-C₁₂cycloalkyl group, which can optionally be substituted by at least one substituent E: preferably a C₃-C₁₂cycloalkyl group, which can optionally be substituted by at least one substituent E; more preferably a C₃-C₆cycloalkyl group, which can optionally be substituted by at least one substituent E; most preferably an unsubstituted C₃-C₆cycloalkyl group, e.g. cyclohexyl or cyclopentyl.

A heterocycloalkyl group comprising 3 to 6 ring atoms, interrupted by at least one of O, S and NR⁶⁵ and/or substituted by at least one substituent E: preferably an unsubstituted heterocycloalkyl group comprising 3 to 6 ring atoms, interrupted by at least one of O, S and NR⁶⁵, e.g. heterocycloalkyl groups based on pyrrolidine, tetrahydrothiophene, tetrahydrofurane, tetrahydropyrane, tetrahydrothiopyrane, piperidine, dioxane, e.g. 1,4-dioxane or morpholine and derivatives thereof substituted by at least one substituent E.

A C₆-C₁₄aryl group, which can optionally be substituted by at least one substituent G: preferably a C₆-C₁₄aryl group, which can optionally be substituted by one or two groups G; more preferably a phenyl group, which can optionally be substituted by one or two groups G.
A -NR⁶⁵-C₆-C₁₄aryl group, which can optionally be substituted by at least one substituent G: preferably a -N(C₆-C₁₄aryl)₂ group, which can optionally be substituted by at least one substituent G; more preferably a -N(phenyl)₂ group, which can optionally be substituted by one or two groups G; most preferably an unsubstituted -N(phenyl)₂ group.

A heteroaryl group comprising 3 to 11 ring atoms, which can optionally be substituted by at least one substituent G, interrupted by at least one of O, S, N and NR⁶⁵: preferably a heteroaryl group comprising 3 to 11 ring atoms, which can optionally be substituted by one or two groups G, interrupted by at least one of O, S, N and NR⁶⁵; more preferably pyridyl, methylpyridyl, pyrimidyl, pyrazinyl, carbazolyl, dibenzofuranyl, dibenzothiophenyl, indolyl, methylindolyl, benzofuranyl and benzothiophenyl, which can optionally be substituted by one, or more groups selected from a C₁-C₅alkyl group, a C₃-C₆cycloalkyl group and a C₁-C₄fluoroalkyl group; especially carbazolyl, dibenzofuranyl, dibenzothiophenyl, which can optionally be substituted by one, or more groups selected from a C₁-C₅alkyl group, a C₃-C₆cycloalkyl group and a C₁-C₄fluoroalkyl group; more especially dibenzofuranyl, dibenzothiophenyl, which can optionally be substituted by one, or more groups selected from a C₁-C₄alkyl group, and a C₃-C₆cycloalkyl group.

A a -NR⁶⁵-heteroaryl group, comprising 3 to 11 ring atoms, which can optionally be substituted by at least one substituent G, interrupted by at least one of O, S, N and NR⁶⁵: preferably a - N(heteroaryl)₂ group, comprising 3 to 11 ring atoms, which can optionally be substituted by at least one substituent G, interrupted by at least one of O, S, N and NR⁶⁵, preferred heteroaryl residues are mentioned before.

A halogen atom: preferably F or Cl, more preferably F.

A C₁-C₁₈haloalkyl group; preferably a fluoroC₁-C₄alkyl group, more preferably CF₃. The alkyl groups may be linear or branched.

In the alkyl groups and aryl groups mentioned in the present application one or more hydrogen atoms may be substituted by deuterium atoms.

### Metal carbene complexes according to the present invention

The residues **R¹, R², R³ and R⁴** in the metal carbene complexes according to the present invention are independently of each other hydrogen; a C₁-C₁₈alkyl group, which can optionally be substituted by at least one substituent E and/or interrupted by D; a C₃-C₁₂cycloalkyl group, which can optionally be substituted by at least one substituent E; a heterocycloalkyl group comprising 3 to 6 ring atoms, interrupted by at least one of O, S and NR⁶⁵ and/or substituted by at least one substituent E; a C₆-C₁₄aryl group, which can optionally be substituted by at least one substituent G; a -NR⁶⁵-C₆-C₁₄aryl group, preferably a -N(C₆-C₁₄aryl)₂ group, which can optionally be substituted by at least one substituent G; a heteroaryl group comprising 3 to 11 ring atoms, which can optionally be substituted by at least one substituent G, interrupted by at least one of O, S, N and NR⁶⁵; or a -NR⁶⁵-heteroaryl group, preferably a -N(heteroaryl)₂ group, comprising 3 to 11 ring atoms, which can optionally be substituted by at least one substituent G, interrupted by at least one of O, S, N and NR⁶⁵; a halogen atom, especially F or Cl; a C₁-C₁₈haloalkyl group such as CF₃; CN; or SiR⁸⁰R⁸¹R⁸²; or

R¹ and R², R² and R³ or R³ and R⁴ form together a ring 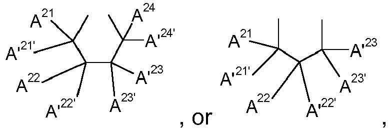 wherein A²¹, A^{21'}, A²², A^{22'}, A²³, A^{23'}, A^{24'} and A²⁴ are independently of each other H, a C₁-C₄alkyl group, a C₃-C₆cycloalkyl group, or a fluoroC₁-C₄alkyl group.

Preferably, R¹, R², R³ and R⁴ are independently of each other hydrogen; a C₁-C₁₂alkyl group, which can optionally be substituted by at least one substituent E and/or interrupted by D; a C₃-C₁₂cycloalkyl group, which can optionally be substituted by at least one substituent E; a C₆-C₁₄aryl group, which can optionally be substituted by one or two groups G; a heteroaryl group comprising 3 to 11 ring atoms, which can optionally be substituted by one or two groups G; or a -N(phenyl)₂ group, which can optionally be substituted by one or two groups G.

More preferably, R¹, R², R³ and R⁴ are independently of each other hydrogen; a C₁-C₈alkyl group, which can optionally be substituted by at least one substituent E and/or interrupted by D; a C₃-C₆cycloalkyl group, which can optionally be substituted by at least one substituent E; or a phenyl group, which can optionally be substituted by one or two groups G.

Most preferably, R¹, R², R³ and R⁴ are independently of each other hydrogen; a C₁-C₈alkyl group, which can optionally be substituted by at least one substituent E; a C₃-C₆cycloalkyl group, which can optionally be substituted by at least one substituent E; or a phenyl group, which can optionally be substituted by one or two groups G.

Even more preferably, R¹, R², R³ and R⁴ are independently of each other hydrogen; a C₁-C₈alkyl group, which can optionally be substituted by at least one substituent E; a C₃-C₆cycloalkyl group; or either R² and R³ or R¹ and R⁴ are a phenyl group, which can optionally be substituted by one or two groups G.

Further more preferably, R¹, R², R³ and R⁴ are independently of each other hydrogen; a C₁-C₈alkyl group; or a C₃-C₆cycloalkyl group.

In one especially preferred embodiment, either R² and R³ or R¹ and R⁴ are H.

Further more preferably, R¹ and R⁴ are hydrogen and R² and R³ are independently of each other hydrogen; a C₁-C₈alkyl group; or a C₃-C₆cycloalkyl group, or a phenyl group, which can optionally be substituted by one or two groups G.

Most preferably, R¹, R², R³ and R⁴ are hydrogen.

The residues **R⁵ and R⁶** are independently of each other hydrogen; a C₁-C₁₈alkyl group, which can optionally be substituted by at least one substituent E and/or interrupted by D; a C₃-C₁₂cycloalkyl group, which can optionally be substituted by at least one substituent E; a heterocycloalkyl group comprising 3 to 6 ring atoms, interrupted by at least one of O, S and NR⁶⁵ and/or substituted by at least one substituent E; a C₆-C₁₄aryl group, which can optionally be substituted by at least one substituent G; a -NR⁶⁵-C₆-C₁₄aryl group, preferably a -N(C₆-C₁₄aryl)₂ group, which can optionally be substituted by at least one substituent G; a heteroaryl group comprising 3 to 11 ring atoms, which can optionally be substituted by at least one substituent G, interrupted by at least one of O, S, N and NR⁶⁵; a halogen atom, especially F or Cl; a C₁-C₁₈haloalkyl group such as CF₃; CN; or SiR⁸⁰R⁸¹R⁸²; or
R⁵ and R⁶ together form a group of formula 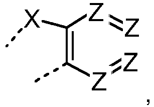 wherein Z is N or CR'", wherein 0 or 1 Z is N, preferably 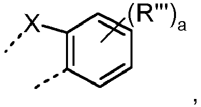 wherein X is O, S, NR⁷⁵ or CR⁷³R⁷⁴, preferably O; R'" is C₁-C₈alkyl and a is 0, 1 or 2, preferably 0 or 1, more preferably 0;
D is -CO-, -COO-, -S-, -SO-, -SO₂-, -O-, -NR⁶⁵-, -SiR⁷⁰R⁷¹-, -POR⁷²-, -CR⁶³=CR⁶⁴-, or -C≡C, preferably -O-, -S- or -NR⁶⁵-.

Preferably, R⁵ and R⁶ are independently of each other hydrogen; a C₁-C₁₂alkyl group, which can optionally be substituted by E and/or interrupted by D; a C₃-C₁₂cycloalkyl group, which can optionally be substituted by E; or
one of R⁵ and R⁶, preferably R⁵, is a group of formula 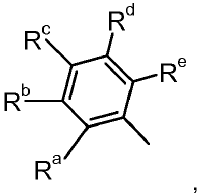 in a further preferred embodiment, R⁶ is a group of formula 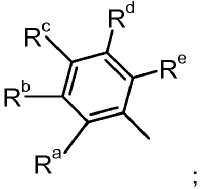 R^{a} is H, a C₁-C₅alkyl group, a fluoroC₁-C₄alkyl group, or a C₃-C₆cycloalkyl group; preferably H, a C₁-C₅alkyl group, C₃-C₆cycloalkyl group; more preferably H, or a C₁-C₅alkyl group;
R^{e} is H, a C₁-C₅alkyl group, a fluoroC₁-C₄alkyl group, or a C₃-C₆cycloalkyl group; preferably H, a C₁-C₅alkyl group, C₃-C₆cycloalkyl group; more preferably H, or a C₁-C₅alkyl group;
R^{c}, R^{b} and R^{d} are independently of each other hydrogen; a C₁-C₁₈alkyl group, which can optionally be substituted by E and/or interupted by D; a C₃-C₁₂cycloalkyl group, which can optionally be substituted by G; a C₆-C₁₄aryl group, which can optionally be substituted by G; or a C₂-C₃₀heteroaryl group, which can optionally be substituted by G; C₁-C₈haloalkyl such as CF₃; or SiR⁸⁰R⁸¹ R⁸²; preferably R^{c}, R^{b} and R^{d} are independently of each other H, a C₁-C₅alkyl group, C₃-C₆cycloalkyl group; more preferably H, or a C₁-C₅alkyl group; further preferably, R^{b}, R^{c} and R^{d} are hydrogen or a phenyl group, which can optionally be substituted by one or two groups G; or
R^{c} and R^{b}, or R^{a} and R^{b} together form a group of formula 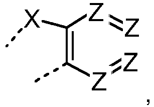 wherein Z is N or CR'", wherein 0 or 1 Z is N, preferably 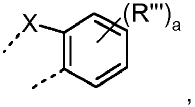 wherein X is O, S, NR⁷⁵ or CR⁷³R⁷⁴, preferably O; R'" is C₁-C₈alkyl and a is 0, 1 or 2, preferably 0 or 1, more preferably 0.

More preferably, R⁵ and R⁶ are independently of each other hydrogen; a C₁-C₈alkyl group, which can optionally be substituted by at least one substituent E and/or interrupted by D; or one of R⁵ and R⁶ is a C₃-C₆cycloalkyl group, which can optionally be substituted by at least one substituent E; or one of R⁵ and R⁶ is a phenyl group, which can optionally be substituted by one or two groups G.

Most preferably, R⁵ and R⁶ are independently of each other hydrogen; a C₁-C₈alkyl group, which can optionally be substituted by at least one substituent E; or a C₃-C₆cycloalkyl group, which can optionally be substituted by at least one substituent E; or a phenyl group, which can optionally be substituted by one or two groups G.

Even more preferably, R⁵ and R⁶ are independently of each other hydrogen; a C₁-C₈alkyl group, which can optionally be substituted by at least one substituent E; a C₃-C₆cycloalkyl group, which can optionally be substituted by at least one substituent E; or either R⁵ or R⁶, preferably R⁵, is a phenyl group, which can optionally be substituted by one or two groups G; in a further preferred embodiment R⁶ is a phenyl group, which can optionally be substituted by one or two groups G.

Further more preferably, R⁵ and R⁶ are independently of each other hydrogen; a C₁-C₈alkyl group; or a C₃-C₆cycloalkyl group. Preferably, at least one of R⁵ and R⁶ is hydrogen, and the other one is a C₁-C₈alkyl group. More preferably, at least R⁵ is hydrogen, and R⁶ is a C₁-C₈alkyl group. Most preferably both R⁵ and R⁶ are hydrogen.

In one further preferred embodiment, R⁵ and R⁶ are independently of each other hydrogen; a C₁-C₈alkyl group; or one of R⁵ and R⁶, preferably R⁵, is a phenyl group, which can optionally be substituted by one group or two groups selected from CF₃ or C₁-C₈alkyl, preferably optionally be substituted by one or two C₁-C₈alkyl group; in a further preferred embodiment R⁶ is a phenyl group, which can optionally be substituted by one group or two groups selected from CF₃ or C₁-C₈alkyl, preferably optionally be substituted by one or two C₁-C₈alkyl group; preferably, at least one of R⁵ and R⁶ is hydrogen; more preferably, at least one of R⁵ and R⁶ is hydrogen and the other one of R⁵ and R⁶ is hydrogen or a phenyl group, which can optionally be substituted by one or two C₁-C₈alkyl groups.

Most preferably, R⁵ and R⁶ are hydrogen.

In a further embodiment, R⁵ is H and R⁶ is a phenyl group, which can optionally be substituted by one group or two C₁-C₈alkyl groups.

R⁷, R⁸, R⁹, R²⁷ and R²⁸ are independently of each other hydrogen; a C₁-C₁₈alkyl group, which can optionally be substituted by at least one substituent E and/or interrupted by D; a C₃-C₁₂cycloalkyl group, which can optionally be substituted by at least one substituent E; a heterocycloalkyl group comprising 3 to 6 ring atoms, interrupted by at least one of O, S and NR⁶⁵ and/or substituted by at least one substituent E; a C₆-C₁₄aryl group, which can optionally be substituted by at least one substituent G; a heteroaryl group comprising 3 to 11 ring atoms, which can optionally be substituted by at least one substituent G, interrupted by at least one of O, S, N and NR⁶⁵ a halogen atom, especially F or Cl; a C₁-C₁₈haloalkyl group such as CF₃; CN; or SiR⁸⁰R⁸¹R⁸²; in addition to the groups mentioned above, R⁸ may be a -NR⁶⁵-C₆-C₁₄aryl group, preferably a -N(C₆-C₁₄aryl)₂ group, which can optionally be substituted by at least one substituent G; or a -NR⁶⁵-heteroaryl group, preferably a -N(heteroaryl)₂ group, comprising 3 to 11 ring atoms, which can optionally be substituted by at least one substituent G, interrupted by at least one of O, S, N and NR⁶⁵; or
R⁸ and R⁹ together form a group of formula 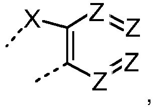 wherein Z is N or CR'", wherein 0 or 1 Z is N, preferably 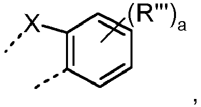 wherein X is O, S, NR⁷⁵ or CR⁷³R⁷⁴, preferably O; R'" is C₁-C₈alkyl and a is 0, 1 or 2, preferably 0 or 1, more preferably 0;
D is -CO-, -COO-, -S-, -SO-, -SO₂-, -O-, -NR⁶⁵-, -SiR⁷⁰R⁷¹-, -POR⁷²-, -CR⁶³=CR⁶⁴-, or -C≡C, preferably -O-, -S- or -NR⁶⁵-.

Preferably, R⁷, R⁸ and R⁹ are independently of each other hydrogen; a C₁-C₁₂alkyl group, which can optionally be substituted by E and/or interrupted by D; a C₃-C₁₂cycloalkyl group, which can optionally be substituted by E, a C₆-C₁₄aryl group, which can optionally be substituted by one or two groups G; a heteroaryl group comprising 3 to 11 ring atoms, which can optionally be substituted by one or two groups G.

Preferably, R²⁷, R²⁸ are independently of each other hydrogen; or a C₁-C₁₂alkyl group, which can optionally be substituted by E and/or interrupted by D, preferably a CH₂-C₁-C₇alkyl group, which can optionally be substituted by E and/or interrupted by D.

More preferably, R⁷, R⁸ and R⁹ are independently of each other hydrogen; a C₁-C₈alkyl group, which can optionally be substituted by at least one substituent E and/or interrupted by D; a C₃-C₆cycloalkyl group, which can optionally be substituted by at least one substituent E or a phenyl group, which can optionally be substituted by one or two groups G.

More preferably, at least one of R²⁷ and R²⁸ is hydrogen.

Most preferably, R⁷, R⁸ and R⁹ are independently of each other hydrogen; a C₁-C₈alkyl group, which can optionally be substituted by at least one substituent E; or a C₃-C₆cycloalkyl group, which can optionally be substituted by at least one substituent E; or a phenyl group, which can optionally be substituted by one or two groups G.

Most preferably, R²⁷ and R²⁸ are hydrogen.

Even more preferably, R⁷, R⁸ and R⁹ are independently of each other hydrogen; a C₁-C₈alkyl group, which can optionally be substituted by at least one substituent E; a C₃-C₆cycloalkyl group; or R⁸ is a phenyl group, which can optionally be substituted by one or two groups G.

Further more preferably, R⁷, R⁸ and R⁹ are independently of each other hydrogen; a C₁-C₈alkyl group; or a C₃-C₆cycloalkyl group; most preferably, R⁷, R⁸ and R⁹ are a C₁-C₈alkyl group.

Further more preferably, R⁷ is hydrogen and R⁸ and R⁹ are identical with R⁵ and R⁶.

Most preferably, R⁷ and R⁹ are hydrogen and R⁸ is hydrogen or a phenyl group, which can optionally be substituted by one or two groups G.
Even most preferably, R⁷, R⁸ and R⁹ are hydrogen.

In a most preferred embodiment, R¹, R², R³, R⁴, R⁵, R⁶, R⁷, R⁸, R⁹ and R²⁷ and R²⁸ are hydrogen.

D is -CO-, -COO-, -S-, -SO-, -SO₂-, -O-, -NR⁶⁵-, -SiR⁷⁰R⁷¹-, -POR⁷²-, -CR⁶³=CR⁶⁴-, or -C≡C, preferably -O-, -S- or -NR⁶⁵-; more preferably -S-, or -O-;

E is -OR⁶⁹, -SR⁶⁹, -NR⁶⁵R⁶⁶, -COR⁶⁸, -COOR⁶⁷, -CONR⁶⁵R⁶⁶, -CN, halogen, or a C₁-C₁₈alkyl group, which can optionally be substituted by at least one substituent E and/or interrupted by D; preferably F; a C₁-C₈haloalkyl group such as CF₃, or a C₁-C₈alkyl group; preferably, E is C₁-C₈alkyl, C₁-C₈alkoxy, CN, halogen, preferably F, or C₁-C₈haloalkyl, such as CF₃; more preferably E is C₁-C₈alkyl, C₁-C₈alkoxy, or C₁-C₈haloalkyl, such as CF₃; more preferably, E is -OR⁶⁹, CF₃, C₁-C₈alkyl or F; most preferably CF₃, C₁-C₈alkyl or F; even most preferably, E is -C₁-Csalkyl.

G is E; or an unsubstituted C₆-C₁₄aryl group; a C₆-C₁₄aryl group, which is substituted by F, C₁-C₁₈alkyl, a C₃-C₆cycloalkyl group, or C₁-C₁₈alkyl, which is substituted by F and/or interrupted by O; an unsubstituted heteroaryl group comprising 3 to 11 ring atoms, interrupted by at least one of O, S, N and NR⁶⁵; or a heteroaryl group comprising 3 to 11 ring atoms, interrupted by at least one of O, S, N and NR⁶⁵, which is substituted by F, unsubstituted C₁-C₁₈alkyl, SiR⁸⁰R⁸¹R⁸², or C₁-C₁₈alkyl which is substituted by F and/or interrupted by O; preferably, G is a C₁-C₈alkyl group, or a group of formula 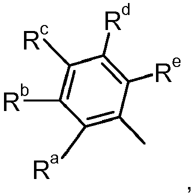 R^{a} is H, a C₁-C₈alkyl group, a fluoroC₁-C₄alkyl group, or a C₃-C₆cycloalkyl group, preferably R^{a} H, a C₁-C₅alkyl group, C₃-C₆cycloalkyl group; more preferably, R^{a} is H, or a C₁-C₅alkyl group; R^{e} is H, a C₁-C₅alkyl group, a fluoroC₁-C₄alkyl group, or a C₃-C₆cycloalkyl group; preferably R^{e} H, a C₁-C₅alkyl group, C₃-C₆cycloalkyl group; more preferably, R^{e} is H, or a C₁-C₅alkyl group; R^{e} is H, a C₁-C₅alkyl group, a fluoroC₁-C₄alkyl group, or a C₃-C₆cycloalkyl group;
R^{c}, R^{b} and R^{d} are independently of each other hydrogen; a C₁-C₁₈alkyl group, which can optionally be substituted by E and/or interupted by D; a C₃-C₁₂cycloalkyl group, which can optionally be substituted by G; a C₃-C₁₀heterocycloalkyl radical which is interrupted by at least one of O, S and NR⁶⁵ and/or substituted by E; a C₆-C₂₄aryl group, which can optionally be substituted by G; or a C₂-C₃₀heteroaryl group, which can optionally be substituted by G; a halogen atom, especially F or Cl; C₁-C₈haloalkyl such as CF₃; CN; or SiR⁸⁰R⁸¹R⁸²; preferably R^{c}, R^{b} and R^{d} are independently of each other H, a C₁-C₅alkyl group, C₃-C₆cycloalkyl group; more preferably, R^{c}, R^{b} and R^{d} are independently of each other H, or a C₁-C₅alkyl group; or
R^{c} and R^{b}, or R^{a} and R^{b} together form a group of formula 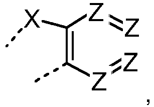 wherein Z is N or CR'",
wherein 0 or 1 Z is N, preferably 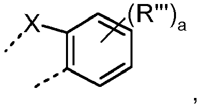 wherein X is O, S, NR⁷⁵ or CR⁷³R⁷⁴, preferably O; R'" is C₁-C₈alkyl and a is 0, 1 or 2, preferably 0 or 1, more preferably 0; more preferably, G is -OR⁶⁹, CF₃ or C₁-C₈alkyl; most preferably, G is CF₃ or C₁-C₈alkyl; even more preferably, G is C₁-C₈alkyl.

R⁶³ and R⁶⁴ are independently of each other H; unsubstituted C₆-C₁₈aryl; C₆-C₁₈aryl which is substituted by C₁-C₁₈alkyl, or C₁-C₁₈alkoxy; unsubstituted C₁-C₁₈alkyl; or C₁-C₁₈alkyl which is interrupted by -O-; preferably unsubstituted C₆-C₁₈aryl; C₆-C₁₈aryl which is substituted by C₁-C₁₈alkyl, or C₁-C₁₈alkoxy; unsubstituted C₁-C₁₈alkyl; or C₁-C₁₈alkyl which is interrupted by -O-; preferably, R⁶³ and R⁶⁴ are independently of each other a phenyl group, which can optionally be substituted by one or two C₁-C₈alkyl groups; an unsubstituted C₁-C₁₈alkyl group; or a C₁-C₁₈alkyl group, which is interrupted by -O-.

R⁶⁵ and R⁶⁶ are independently of each other H, an unsubstituted C₆-C₁₈aryl group; a C₆-C₁₈aryl group which is substituted by C₁-C₁₈alkyl, or C₁-C₁₈alkoxy; an unsubstituted C₁-C₁₈alkyl group; or a C₁-C₁₈alkyl group, which is interrupted by -O-; or R⁶⁵ and R⁶⁶ together form a five or six membered ring; preferably, R⁶⁵ and R⁶⁶ are independently of each other a phenyl group, which can optionally be substituted by one or two C₁-C₈alkyl groups; an unsubstituted C₁-C₁₈alkyl group; or a C₁-C₁₈alkyl group, which is interrupted by -O-.

R⁶⁷ is H, an unsubstituted C₆-C₁₈aryl group; a C₆-C₁₈aryl group, which is substituted by C₁-C₁₈alkyl, or C₁-C₁₈alkoxy; an unsubstituted C₁-C₁₈alkyl group; or a C₁-C₁₈alkyl group, which is interrupted by -O-; preferably an unsubstituted C₆-C₁₈aryl group; a C₆-C₁₈aryl group, which is substituted by C₁-C₁₈alkyl, or C₁-C₁₈alkoxy; an unsubstituted C₁-C₁₈alkyl group; or a C₁-C₁₈alkyl group, which is interrupted by -O-; preferably, R⁶⁷ is a phenyl group, which can optionally be substituted by one or two C₁-C₈alkyl groups; an unsubstituted C₁-C₁₈alkyl group; or a C₁-C₁₈alkyl group, which is interrupted by -O-.

R⁶⁸ is H; an unsubstituted C₆-C₁₈aryl group; a C₆-C₁₈aryl group, which is substituted by C₁-C₁₈alkyl, or C₁-C₁₈alkoxy; an unsubstituted C₁-C₁₈alkyl group; or a C₁-C₁₈alkyl group, which is interrupted by -O-; preferably, R⁶⁸ is a phenyl group, which can optionally be substituted by one or two C₁-C₈alkyl groups; an unsubstituted C₁-C₁₈alkyl group; or a C₁-C₁₈alkyl group, which is interrupted by -O-.

**R⁶⁹** is H, an unsubstituted C₆-C₁₈aryl; a C₆-C₁₈aryl, which is substituted by C₁-C₁₈alkyl, or C₁-C₁₈alkoxy; an unsubstituted C₁-C₁₈alkyl group; or a C₁-C₁₈alkyl group, which is interrupted by - O-; preferably an unsubstituted C₆-C₁₈aryl; a C₆-C₁₈aryl, which is substituted by C₁-C₁₈alkyl, or C₁-C₁₈alkoxy; an unsubstituted C₁-C₁₈alkyl group; or a C₁-C₁₈alkyl group, which is interrupted by -O-; preferably, R⁶⁹ is a phenyl group, which can optionally be substituted by one or two C₁-C₈alkyl groups; an unsubstituted C₁-C₁₈alkyl group; or a C₁-C₁₈alkyl group, which is interrupted by -O-.

**R⁷⁰ and R⁷¹** are independently of each other an unsubstituted C₁-C₁₈alkyl group; an unsubstituted C₆-C₁₈aryl group; or a C₆-C₁₈aryl group, which is substituted by C₁-C₁₈alkyl; preferably, R⁷⁰ and R⁷¹ are independently of each other a phenyl group, which can optionally be substituted by one or two C₁-C₈alkyl groups; or an unsubstituted C₁-C₁₈alkyl group.

**R⁷²** is an unsubstituted C₁-C₁₈alkyl group; an unsubstituted C₆-C₁₈aryl group, or a C₆-C₁₈aryl group, which is substituted by C₁-C₁₈alkyl; preferably, R⁷² is a phenyl group, which can optionally be substituted by one or two C₁-C₈alkyl groups; or an unsubstituted C₁-C₁₈alkyl group.

**R⁷³ and R⁷⁴** are independently of each other H, C₁-C₂₅alkyl, C₁-C₂₅alkyl which is interrupted by O, C₇-C₂₅arylalkyl, C₆-C₂₄aryl, C₆-C₂₄aryl which is substituted by C₁-C₁₈alkyl, C₂-C₂₀heteroaryl, or C₂-C₂₀heteroaryl which is substituted by C₁-C₁₈alkyl; preferably, R⁷³ and R⁷⁴ are independently of each other a phenyl group, which can optionally be substituted by one or two C₁-C₈alkyl groups; an unsubstituted C₁-C₁₈alkyl group; or a C₁-C₁₈alkyl group, which is interrupted by -O-.

**R⁷⁵** is a C₆-C₁₈aryl group; a C₆-C₁₈aryl which is substituted by C₁-C₁₈alkyl, or C₁-C₁₈alkoxy; a C₁-C₁₈alkyl group; or a C₁-C₁₈alkyl group, which is interrupted by -O-; preferably, R⁷⁵ is a phenyl group, which can optionally be substituted by one or two C₁-C₈alkyl groups; an unsubstituted C₁-C₁₈alkyl group; or a C₁-C₁₈alkyl group, which is interrupted by -O-.

**R⁸⁰, R⁸¹ and R⁸²** are independently of each other a C₁-C₂₅alkyl group, which can optionally be interrupted by O; a C₆-C₁₄aryl group, which can optionally be substituted by C₁-C₁₈alkyl; or a heteroaryl group comprising 3 to 11 ring atoms, which can optionally be substituted by C₁-C₁₈alkyl; preferably, R⁸⁰, R⁸¹ and R⁸² are independently of each other a phenyl group, which can optionally be substituted by one or two C₁-C₈alkyl groups; an unsubstituted C₁-C₁₈alkyl group; or a C₁-C₁₈alkyl group, which is interrupted by -O-.

In a preferred embodiment the present invention concerns the inventive metal carbene complex, wherein at least one of the radicals R¹, R², R^{3,} R⁴, R⁵, R⁶, R⁷, R⁸, and R⁹ is not hydrogen; preferably, either R⁵ is not hydrogen or at least two of the radicals R¹, R², R³, R⁴, R⁵, R⁶, R⁷, R⁸ and R⁹ are not hydrogen.

In a further preferred embodiment two adjacent radicals of the group R¹, R², R³, R⁴, R⁵, R⁶, R⁷, R⁸, R⁹, R²⁷ and R²⁸ are not at the same time an aromatic group, e.g. a C₆-C₁₄aryl group, which can optionally be substituted by at least one substituent G; a -NR⁶⁵-C₆-C₁₄aryl group, preferably a-N(C₆-C₁₄aryl)₂ group, which can optionally be substituted by at least one substituent G; a heteroaryl group comprising 3 to 11 ring atoms, which can optionally be substituted by at least one substituent G, interrupted by at least one of O, S, N and NR⁶⁵; or a -NR⁶⁵-heteroaryl group, preferably a -N(heteroaryl)₂ group, comprising 3 to 11 ring atoms, which can optionally be substituted by at least one substituent G, interrupted by at least one of O, S, N and NR⁶⁵.

The present invention also concerns a combination of both preferred embodiments mentioned before.

In a most preferred embodiment, the present invention concerns the inventive metal carbene complex, wherein R¹, R², R³, R⁴, R⁵, R⁶, R⁷, R⁸, R⁹ and R²⁷ and R²⁸ are hydrogen.

In the case that R⁶ and R⁸ are both present in the inventive metal carbene complexes, R⁶ and R⁸ are preferably identical.

In the case that R⁵ and R⁹ are both present in the inventive metal carbene complexes, R⁵ and R⁹ are identical. "Present" means in the sense of the present application that the respective residues are not hydrogen.

The metal carbene complex according to the present invention is preferably an inventive metal carbene complex, wherein
R¹, R², R³ and R⁴
are independently of each other hydrogen; a C₁-C₁₂alkyl group, which can optionally be substituted by at least one substituent E and/or interrupted by D; a C₃-C₁₂cycloalkyl group, which can optionally be substituted by at least one substituent E; a C₆-C₁₄aryl group, which can optionally be substituted by one or two groups G; a heteroaryl group comprising 3 to 11 ring atoms, which can optionally be substituted by one or two groups G; or a -N(phenyl)₂ group, which can optionally be substituted by one or two groups G;
preferably, R¹, R², R³ and R⁴ are independently of each other hydrogen; a C₁-C₈alkyl group, which can optionally be substituted by at least one substituent E and/or interrupted by D; a C₃-C₆cycloalkyl group, which can optionally be substituted by at least one substituent E; or a phenyl group, which can optionally be substituted by one or two groups G; more preferably, R¹, R², R³ and R⁴ are hydrogen;
R⁵ and R⁶
are independently of each other hydrogen; a C₁-C₁₂alkyl group, which can optionally be substituted by E and/or interrupted by D; a C₃-C₁₂cycloalkyl group, which can optionally be substituted by E;
or
one of R⁵ and R⁶, preferably R⁵, is a group of formula 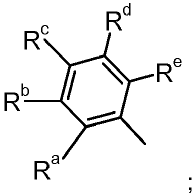 in a further preferred embodiment R⁶ is a group of formula;
R^{a} is H, a C₁-C₅alkyl group, a fluoroC₁-C₄alkyl group, or a C₃-C₆cycloalkyl group; preferably H, a C₁-C₅alkyl group, C₃-C₆cycloalkyl group; more preferably H, or a C₁-C₅alkyl group;
R^{e} is H, a C₁-C₅alkyl group, a fluoroC₁-C₄alkyl group, or a C₃-C₆cycloalkyl group; preferably H, a C₁-C₅alkyl group, C₃-C₆cycloalkyl group; more preferably H, or a C₁-C₅alkyl group;
R^{c}, R^{b} and R^{d} are independently of each other hydrogen; a C₁-C₁₈alkyl group, which can optionally be substituted by E and/or interupted by D; a C₃-C₁₂cycloalkyl group, which can optionally be substituted by G; a C₆-C₁₄aryl group, which can optionally be substituted by G; or a C₂-C₃₀heteroaryl group, which can optionally be substituted by G; C₁-C₈haloalkyl such as CF₃; or SiR⁸⁰R⁸¹R⁸²; preferably R^{c}, R^{b} and R^{d} are independently of each other H, a C₁-C₅alkyl group, C₃-C₆cycloalkyl group; more preferably H, or a C₁-C₅alkyl group; further preferably R^{c}, R^{b} and R^{d} are hydrogen or a phenyl group which can optionally substituted by one or two groups G;
or
R^{c} and R^{b}, or R^{a} and R^{b} together form a group of formula 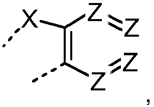 wherein Z is N or CR'",
wherein 0 or 1 Z is N, preferably 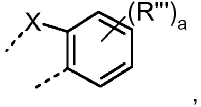 wherein X is O, S, NR⁷⁵ or CR⁷³R⁷⁴, preferably O; R'" is C₁-_{C8}alkyl and a is 0, 1 or 2, preferably 0 or 1, more preferably 0;
preferably, R⁵ and R⁶ are independently of each other hydrogen; a C₁-C₈alkyl group, which can optionally be substituted by at least one substituent E and/or interrupted by D; or one of R⁵ and R⁶ is a C₃-C₆cycloalkyl group, which can optionally be substituted by at least one substituent E; or one of R⁵ and R⁶ is a phenyl group, which can optionally be substituted by one or two groups G; more preferably, R⁵ and R⁶ are hydrogen;
R⁷, R⁸ and R⁹
are independently of each other hydrogen; a C₁-C₁₂alkyl group, which can optionally be substituted by E and/or interrupted by D; a C₃-C₁₂cycloalkyl group, which can optionally be substituted by E a C₆-C₁₄aryl group, which can optionally be substituted by one or two groups G; a heteroaryl group comprising 3 to 11 ring atoms, which can optionally be substituted by one or two groups G;
preferably, R⁷, R⁸ and R⁹ are independently of each other hydrogen; a C₁-C₈alkyl group, which can optionally be substituted by at least one substituent E and/or interrupted by D; a C₃-C₆cycloalkyl group, which can optionally be substituted by at least one substituent E; more preferably, R⁷ and R⁹ are hydrogen and R⁸ is hydrogen or a phenyl group which can be optionally substituted by one or two groups G; most preferably, R⁷, R⁸ and R⁹ are hydrogen;
R²⁷, R²⁸
are independently of each other hydrogen; a C₁-C₁₂alkyl group, which can optionally be substituted by E and/or interrupted by D, preferably a CH₂-C₁-C₇alkyl group, which can optionally be substituted by E and/or interrupted by D;
preferably, at least one of R²⁷ and R²⁸ is hydrogen, more preferably, R²⁷ and R²⁸ are hydrogen; D is -S-, or -O-
E is -OR⁶⁹, CF₃, C₁-C₈alkyl or F; preferably CF₃, C₁-C₈alkyl or F; most preferably C₁-C₈alkyl;
G is -OR⁶⁹, CF₃ or C₁-C₈alkyl; preferably CF₃ or C₁-C₈alkyl; more preferably C₁-C₈alkyl;
R⁶⁵ is a phenyl group, which can optionally be substituted by one or two C₁-C₈alkyl groups; an unsubstituted C₁-C₁₈alkyl group; or a C₁-C₁₈alkyl group, which is interrupted by -O-; and R⁶⁹ is a phenyl group, which can optionally be substituted by one or two C₁-C₈alkyl groups; an unsubstituted C₁-C₁₈alkyl group; or a C₁-C₁₈alkyl group, which is interrupted by-O-.

More preferably, the metal carbene complex according to the present invention is an inventive metal carbene complex, wherein
R¹, R², R³ and R⁴
are independently of each other hydrogen; a C₁-C₈alkyl group, which can optionally be substituted by at least one substituent E; a C₃-C₆cycloalkyl group, which can optionally be substituted by at least one substituent E; or a phenyl group, which can optionally be substituted by one or two groups G;
preferably, R¹, R², R³ and R⁴ are independently of each other hydrogen; a C₁-C₈alkyl group, which can optionally be substituted by at least one substituent E; a C₃-C₆cycloalkyl group; or either R² and R³ or R¹ and R⁴ are a phenyl group, which can optionally be substituted by one or two groups G; more preferably, R¹, R², R³ and R⁴ are hydrogen;
R⁵ and R⁶
are independently of each other hydrogen; a C₁-C₈alkyl group, which can optionally be substituted by at least one substituent E; or a C₃-C₆cycloalkyl group, which can optionally be substituted by at least one substituent E; or a phenyl group, which can optionally be substituted by one or two groups G;
preferably, R⁵ and R⁶ are independently of each other hydrogen; a C₁-C₈alkyl group, which can optionally be substituted by at least one substituent E; a C₃-C₆cycloalkyl group; or either R⁵ or R⁶, preferably R⁵, is a phenyl group, which can optionally be substituted by one or two groups G; in a further preferred embodiment, R⁶ is a phenyl group, which can optionally be substituted by one or two groups G; more preferably, R⁵ and R⁶ are hydrogen;
R⁷, R⁸ and R⁹
are independently of each other hydrogen; a C₁-C₈alkyl group, which can optionally be substituted by at least one substituent E; or a C₃-C₆cycloalkyl group, which can optionally be substituted by at least one substituent E; or a phenyl group, which can optionally be substituted by one or two groups G;
preferably, R⁷, R⁸ and R⁹ are independently of each other hydrogen; a C₁-C₈alkyl group, which can optionally be substituted by at least one substituent E; a C₃-C₆cycloalkyl group; or R⁸ is a phenyl group, which can optionally be substituted by one or two groups G; more preferably, R⁷ and R⁹ are hydrogen and R⁸ is hydrogen or a phenyl group which can be optionally substituted by one or two groups G; most preferably, R⁷, R⁸ and R⁹ are hydrogen;
R²⁷ and R²⁸
are hydrogen;
E is CF₃, C₁-C₈alkyl or F; preferably, E is C₁-C₈alkyl;
G is CF₃ or C₁-C₈alkyl; preferably C₁-C₈alkyl;
R⁶⁵ is a phenyl group, which can optionally be substituted by one or two C₁-C₈alkyl groups; an unsubstituted C₁-C₈alkyl group; or a C₁-C₈alkyl group, which is interrupted by -O-; and R⁶⁹ is a phenyl group, which can optionally be substituted by one or two C₁-C₈alkyl groups; an unsubstituted C₁-C₈alkyl group; or a C₁-C₈alkyl group, which is interrupted by -O-.

Most preferably, the metal carbene complex according to the present invention is an inventive metal carbene complex, wherein
R¹, R², R³ and R⁴
are independently of each other hydrogen; a C₁-C₈alkyl group; or a C₃-C₆cycloalkyl group;or either R¹ and R⁴ or R² and R³ are a phenyl group, which can optionally be substituted by one or two groups G; preferably, R¹ and R⁴ are hydrogen and R² and R³ are are independently of each other hydrogen; a C₁-C₈alkyl group; or a C₃-C₆cycloalkyl group, or a phenyl group, which can optionally be substituted by one or two groups G.

Further most preferably, R¹, R², R³ and R⁴ are hydrogen.

R⁵, R⁶, R⁷, R⁸ and R⁹
are independently of each other hydrogen; a C₁-C₈alkyl group; or a C₃-C₆cycloalkyl group; or R⁷ and R⁹ are hydrogen and R⁸ is hydrogen or a phenyl group which can be optionally substituted by one or two groups G and either one of R⁵ and R⁶ is phenyl group which can be optionally substituted by one or two groups G and the other one of R⁵ and R⁶ is hydrogen; more preferably, R⁵, R⁶, R⁷, R⁸ and R⁹ are hydrogen;
and
R²⁷ and R²⁸
are hydrogen.

Even more preferably, the metal carbene complex according to the present invention is an inventive metal carbene complex, wherein
either R² and R³ or R¹ and R⁴ are H; preferably, R¹ and R⁴ are H, more preferably, R¹, R², R³ and R⁴ are H.

Further more preferably, the metal carbene complex according to the present invention is an inventive metal carbene complex, wherein
R⁵ and R⁶ are independently of each other hydrogen; a C₁-C₈alkyl group; or one of R⁵ and R⁶, preferably R⁵, is a phenyl group, which can optionally be substituted by one or two groups selected from CF₃ or C₁-C₈alkyl, preferably optionally be substituted by one or two C₁-C₈alkyl groups; preferably, at least one of R⁵ and R⁶ is hydrogen; more preferably, R⁵ and R⁶ are hydrogen;
R⁷ and R⁹
are C₁-C₈alkyl or R⁷ and R⁹ are hydrogen; preferably, R⁷ and R⁹ are hydrogen;
R⁸
is hydrogen; a C₁-C₈alkyl group; or a phenyl group, which can optionally be para-substituted by one group selected from CF₃ or C₁-C₈alkyl, preferably optionally be substituted by one C₁-Csalkyl group; preferably, R⁸ is hydrogen;
R²⁷ and R²⁸
are hydrogen.

In a further embodiment of the present invention, the metal carbene complex according to the present invention is further more preferably an inventive metal carbene complex, wherein R⁵
is hydrogen; a C₁-C₈alkyl group, which can optionally be substituted by at least one substituent selected from CF₃, C₁-C₈alkyl and F, preferably a C₁-C₈alkyl substituent; a C₃-C₆cycloalkyl group, which can optionally be substituted by at least one substituent selected from CF₃, C₁-Csalkyl and F, preferably a C₁-C₈alkyl substituent; or a phenyl group, which can optionally be substituted by one or two groups selected from CF₃ and C₁-C₈alkyl, preferably optionally be substituted by one or two C₁-C₈alkyl groups; preferably hydrogen;
R⁶ and R⁸
are identical and selected from the group consisting of a C₁-C₈alkyl group, which can optionally be substituted by at least one substituent selected from CF₃, C₁-C₈alkyl and F, preferably a C₁-Csalkyl substituent; a C₃-C₆cycloalkyl group, which can optionally be substituted by at least one substituent selected from CF₃, C₁-C₈alkyl and F, preferably a C₁-C₈alkyl substituent; and a phenyl group, which can optionally be substituted by one or two groups selected from CF₃ and C₁-Csalkyl, preferably optionally be substituted by one or two C₁-C₈alkyl groups; preferably hydrogen; and
R⁷ and R⁹
are hydrogen,
wherein R⁵ and R⁶ are not at the same time a phenyl group, which can optionally be substituted by one or two groups selected from CF₃ and C₁-C₈alkyl, preferably optionally be substituted by one or two C₁-C₈alkyl groups;
R²⁷ and R²⁸
are hydrogen.

In a further embodiment of the present invention, the metal carbene complex according to the present invention is further more preferably an inventive metal carbene complex, wherein R⁷, R⁸ and R⁹ are H; and
R⁶ is H; and
R²⁷ and R²⁸
are hydrogen.

Preferably, the metal carben complex according to the present invention has the following formula (B), preferably the following formula (II) 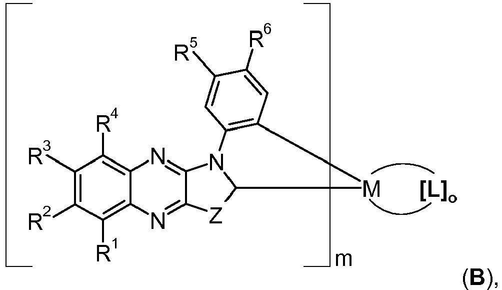 preferably 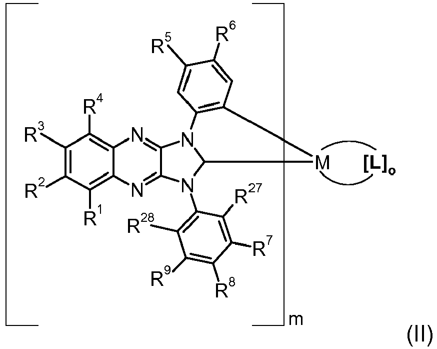 wherein
Z is NR^{x}, O or S, preferably NR^{x} or O, more preferably R^{x};
R^{x} is 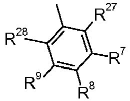
M is Pt, or Ir, preferably Ir;
if M is Ir, m is 1, 2, or 3, preferably 2 or 3; o is 0, 1, or 2, preferably 0 or 1; and the sum of m + o is 3;
   in the case that o = 2, the ligands L may be the same or different, preferably the same; and in the case that m is 2 or 3, the m carbene ligands may be the same or different, preferably the same;
   if M is Pt, m is 1, or 2; o is 0, or 1; and the sum of m + o is 2;
   in the case that m is 2, the m carbene ligands may be the same or different, preferably the same; and
   L is a monoanionic bidentate ligand;
   and R¹, R², R³, R⁴, R⁵, R⁶, R⁷, R⁸, R⁹, R²⁷ and R²⁸ having the meanings mentioned before.

Preferably, the metal carbene complex according to the present invention has the formula (II).

More preferably, the residues, symbols and indices in the metal carbene complex of formula (II) according to the present invention have the following meanings:
M is Ir;
m is 2 or 3; o is 0 or 1; and the sum of m + o is 3;
in the case that o = 2, the ligands L may be the same or different, preferably the same; and in the case that m is 2 or 3, the m carbene ligands may be the same or different, preferably the same; and
L is a monoanionic bidentate ligand;
and R¹, R², R³, R⁴, R⁵, R⁶, R⁷, R⁸, R⁹, R²⁷ and R²⁸ having the meanings mentioned before.

In one most preferred embodiment, the metal carbene complex according to the present invention has the formula (B), preferably the formula (II) mentioned above
wherein
Z is NR^{x}, O or S, preferably NR^{x} or O, more preferably NR^{x};
R^{x} is 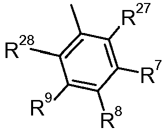
M is Ir;
m is 1; o is 2, wherein the ligands L may be the same or different, preferably the same; and
L is a monoanionic bidentate ligand;
and R¹, R², R³, R⁴, R⁵, R⁶, R⁷, R⁸, R⁹, R²⁷ and R²⁸ having the meanings mentioned before.

In another most preferred embodiment, the metal carbene complex according to the present invention has the formula (B), preferably the formula (II) mentioned above
wherein
Z is NR^{x}, O or S, preferably NR^{x} or O, more preferably NR^{x};
R^{x} is 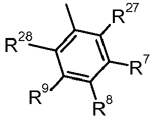
M is Ir;
m is 2; o is 1, wherein the m carbene ligands may be the same or different, preferably the same; and
L is a monoanionic bidentate ligand;
and R¹, R², R³, R⁴, R⁵, R⁶, R⁷, R⁸, R⁹, R²⁷ and R²⁸ having the meanings mentioned before.

In another most preferred embodiment, the metal carbene complex according to the present invention has the formula (B), preferably the formula (II) mentioned above
wherein
Z is NR^{x}, O or S, preferably NR^{x} or O, more preferably NR^{x};
R^{x} is 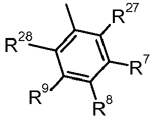
M is Ir;
m is 3; o is 0, wherein the m carbene ligands may be the same or different, preferably the same; and
L is a monoanionic bidentate ligand;
and R¹, R², R³, R⁴, R⁵, R⁶, R⁷, R⁸, R⁹, R²⁷ and R²⁸ having the meanings mentioned before.

Preferably, L in the metal carbene complex according to the present invention is a group of formula 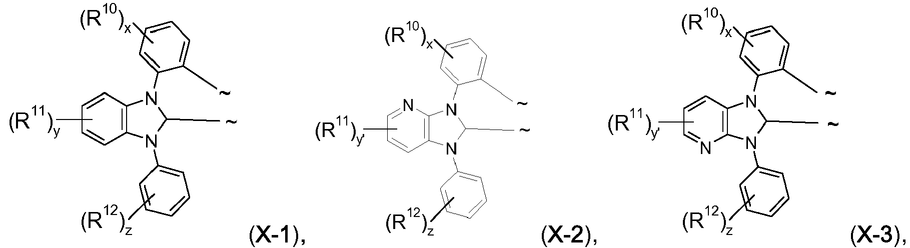 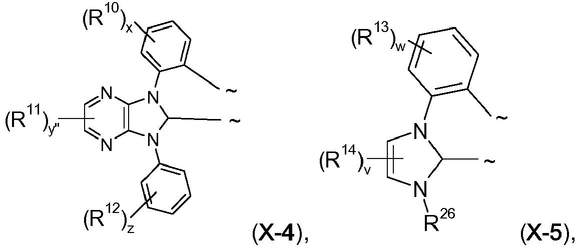 preferably 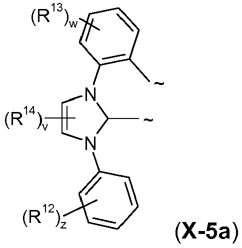 or 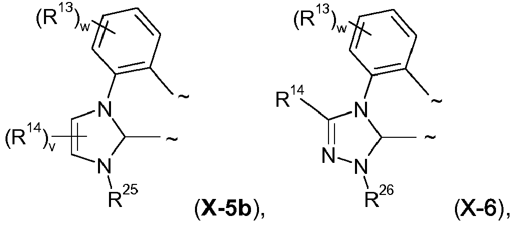 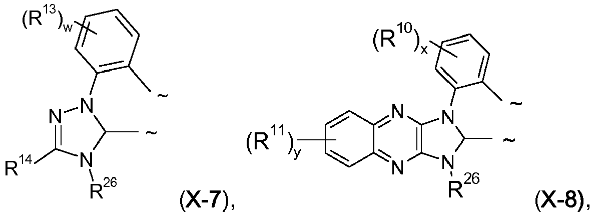 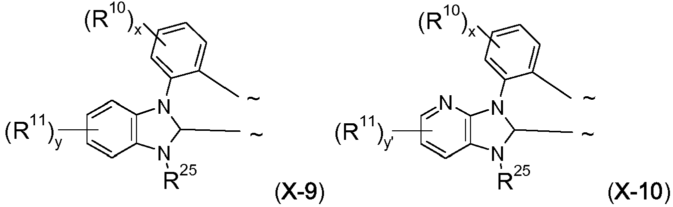 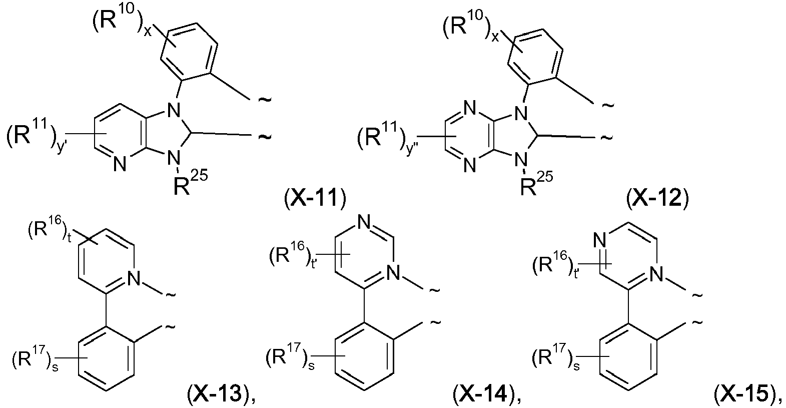 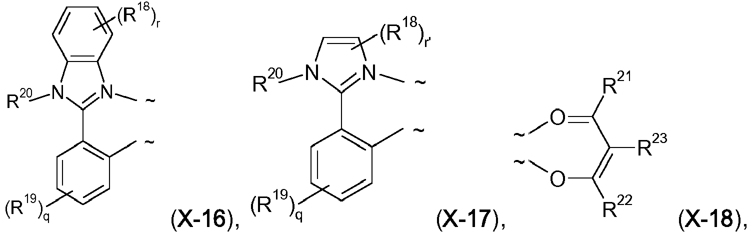 or 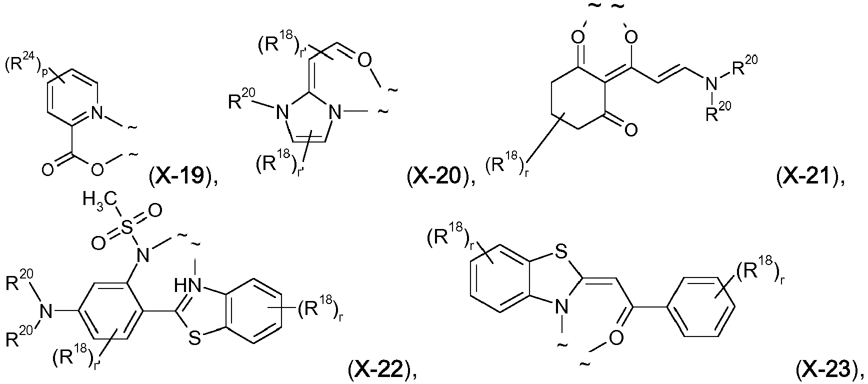 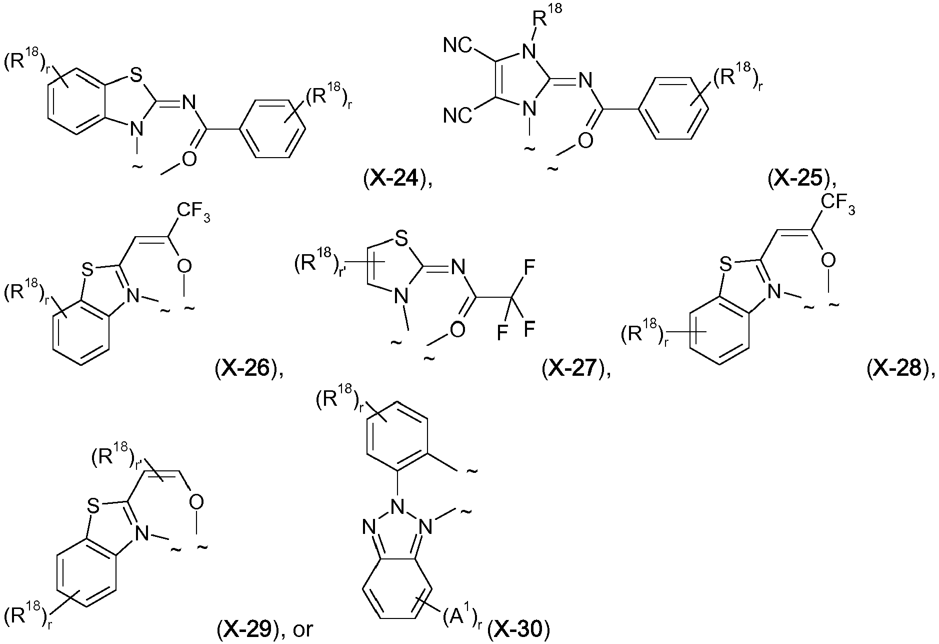 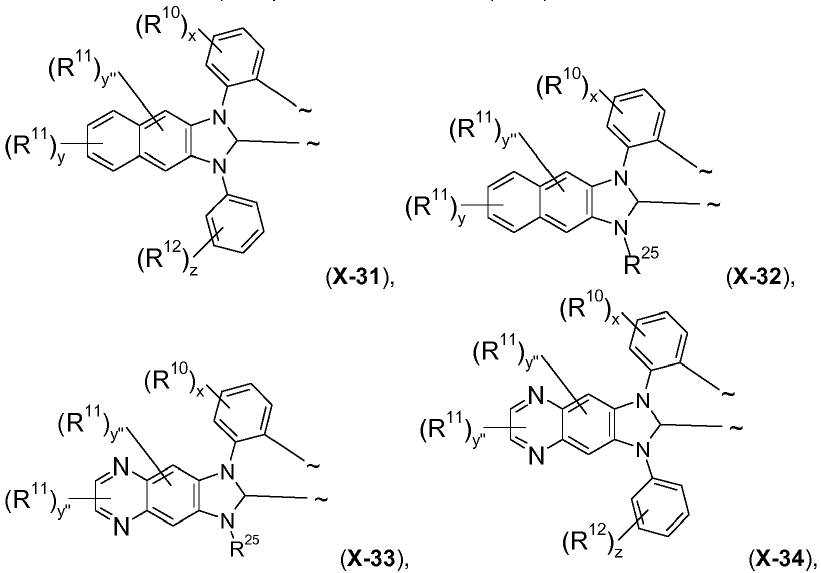 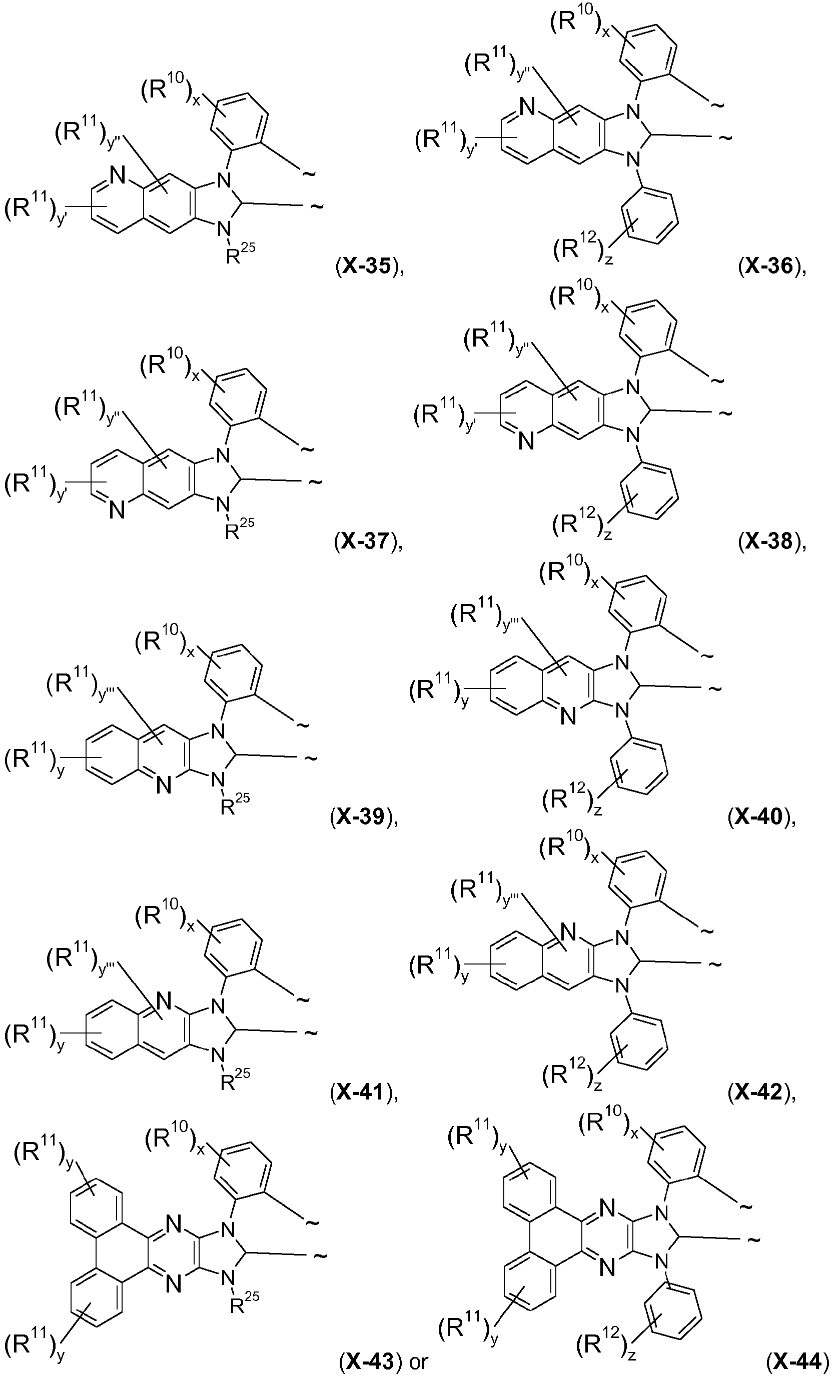 wherein
R¹⁰, R¹², R¹³, R¹⁶, R¹⁷, R¹⁸ and R¹⁹
the radicals R¹⁰, R¹², R¹³, R¹⁶, R¹⁷, R¹⁸ and R¹⁹ are - in each case - independently of each other a C₁-C₁₈alkyl group, which can optionally be substituted by E and/or interrupted by D; a C₃-C₁₂cycloalkyl group, which can optionally be substituted by E; a heterocycloalkyl group comprising 3 to 6 ring atoms, interrupted by at least one heteroatom selected from -O-, -S- and -NR⁶⁵-, optionally bearing at least one substituent E; a halogen atom, especially F or Cl; C₁-C₈haloalkyl such as CF₃; CN; or SiR⁸⁰R⁸¹R⁸²; or
one radical R¹⁰ and/or one radical R¹²; one radical R¹³ and/or one radical R¹²; one radical R¹⁶ and/or one radical R¹⁷; one radical R¹⁸ and/or one radical R¹⁹ is a group of formula 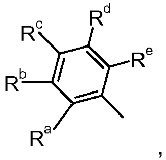
R^{a} is H, a C₁-C₅alkyl group, a fluoroC₁-C₄alkyl group, or a C₃-C₆cycloalkyl group, preferably C₁-C₅-alkyl, or H, more preferably H,
R^{e} is H, a C₁-C₅alkyl group, a fluoroC₁-C₄alkyl group, or a C₃-C₆cycloalkyl group, preferably C₁-C₅-alkyl, or H, more preferably H,
R^{c}, R^{b} and R^{d} are independently of each other hydrogen; a C₁-C₁₈alkyl group, which can optionally be substituted by E and/or interupted by D; a C₃-C₁₂cycloalkyl group, which can optionally be substituted by G; a C₃-C₁₀heterocycloalkyl radical which is interrupted by at least one of O, S and NR⁶⁵ and/or substituted by E; a C₆-C₂₄aryl group, which can optionally be substituted by G; or a C₂-C₃₀heteroaryl group, which can optionally be substituted by G; a halogen atom, especially F or Cl; C₁-C₈haloalkyl such as CF₃; CN; or SiR⁸⁰R⁸¹R⁸²; preferably H or a C₁-C₈alkyl group, more preferably, R^{d} is H and one of R^{b} or R^{c} is a C₁-C₈alkyl group and the other one of R^{b} and R^{d} is H; even more preferably R^{c}, R^{b} and R^{d} are H;
or
two adjacent radicals R¹⁰ and/or two adjacent radicals R¹²; two adjacent radicals R¹³ and/or two adjacent radicals R¹²; two adjacent radicals R¹⁶ and/or two adjacent radicals R¹⁷; or two adjacent radicals R¹⁹; or R^{c} and R^{b}, or R^{a} and R^{b} together form a group of formula 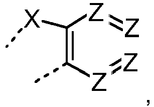
wherein Z is N or CR'", wherein 0 or 1 Z is N, preferably 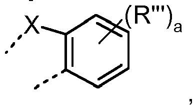 wherein X is O, S,
NR⁷⁵ or CR⁷³R⁷⁴, preferably O; R'" is C₁-C₈alkyl and a' is 0 or 1, preferably 0;
preferably, the radicals R¹⁰, R¹², R¹³, R¹⁶, R¹⁷, R¹⁸ and R¹⁹ are - in each case - independently of each other a C₁-C₈alkyl group, which can optionally be substituted by at least one substituent E and/or interrupted by D, especially methyl, ethyl, i-propyl, n-butyl, sec-butyl, tert-butyl or isoamyl; a C₃-C₆cycloalkyl group, which can optionally be substituted by at least one substituent E; F; Cl; C₁-C₈haloalkyl such as CF₃; CN;
in a further preferred embodiment, R¹⁰, R¹², R¹³, R¹⁶, R¹⁷, R¹⁸ and R¹⁹ are - in each case - independently of each other hydrogen, a C₁-C₈alkyl group especially methyl, ethyl, i-propyl, n-butyl, sec-butyl, tert-butyl or isoamyl; or a phenyl group, which can optionally be substituted by one or two groups G; or a C₂-C₃₀heteroaryl group, which can optionally be substituted by G; more preferably hydrogen, a C₁-C₈alkyl group especially methyl, ethyl, i-propyl, n-butyl, sec-butyl, tert-butyl or isoamyl; or a phenyl group, which can optionally be substituted by one or two C₁-C₈alkyl groups, for example 2-tolyl, 3-tolyl, 4-tolyl, 2-ethylphenyl, 3-ethylphenyl, 4-ethylphenyl, 2-isopropylphenyl, 3-isopropylphenyl or 4-isopropylphenyl; most preferably hydrogen or a C₁-Csalkyl group especially methyl, ethyl, i-propyl, n-butyl, sec-butyl, tert-butyl or isoamyl.
or
two adjacent radicals R¹⁰ and/or two adjacent radicals R¹²; two adjacent radicals R¹³ and/or two adjacent radicals R¹²; two adjacent radicals R¹⁶ and/or two adjacent radicals R¹⁷; or two adjacent radicals R¹⁹ together form a group of formula 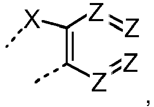 wherein Z is N or CR'",
wherein 0 or 1 Z is N, preferably 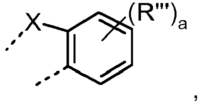 wherein X is O, S, NR⁷⁵ or CR⁷³R⁷⁴, preferably O or S; more preferably O; R'" is C₁-C₈alkyl and a' is 0 or 1, preferably 0;
R¹¹, R¹⁴, R²⁰, R²¹, R²², R²³ and R²⁴:
the radicals R¹¹, R¹⁴, R²⁰, R²¹, R²², R²³ and R²⁴ are - in each case - independently of each other a C₁-C₁₈alkyl group, which can optionally be substituted by at least one substituent E and/or
interrupted by D; a C₃-C₁₂cycloalkyl group, which can optionally be substituted by at least one substituent E; a heterocycloalkyl group comprising 3 to 6 ring atoms, interrupted by at least one heteroatom selected from -O-, -S- and -NR⁶⁵-, optionally bearing at least one substituent E; a C₆-C₁₄aryl group, which can optionally be substituted by one or two groups G; a heteroaryl group comprising 3 to 11 ring atoms, which can optionally be substituted by one or two groups G; or a -NR⁶⁵-phenyl group, which can optionally be substituted by one or two groups G;
preferably, R¹¹, R¹⁴, R²⁰, R²¹, R²², R²³ and R²⁴ are - in each case - independently of each other hydrogen; a C₁-C₈alkyl group, which can optionally be substituted by at least one substituent E and/or interrupted by D; a C₃-C₆cycloalkyl group, which can optionally be substituted by at least one substituent E; or a phenyl group, which can optionally be substituted by one or two groups G; C₁-C₈ haloalkyl such as CF₃; or SiR⁸⁰R⁸¹R⁸²; or in the case of **X-1, X-2, X-3, X-31, X-34, X-35, X-36, X-37** and **X-38 CN**;;
or
two adjacent radicals R¹¹ or two adjacent radicals R¹⁴ form together a group 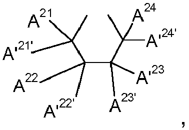 or 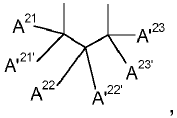 wherein A²¹, A^{21'}, A²², A^{22'}, A²³, A^{23'}, A^{24'} and A²⁴ are independently of each
other H, a C₁-C₄alkyl group, a C₃-C₆cycloalkyl group, or a fluoroC₁-C₄alkyl group;
preferably, R¹¹, R¹⁴, R²⁰, R²¹, R²², R²³ and R²⁴ are - in each case - independently of each other a C₁-C₈alkyl group, which can optionally be substituted by at least one substituent E and/or interrupted by D, especially methyl, ethyl, i-propyl, n-butyl, sec-butyl, tert-butyl or isoamyl; a C₃-C₆cycloalkyl group, which can optionally be substituted by at least one substituent E; C₁-Cshaloalkyl such as CF₃; or in the case of **X-1, X-2, X-3, X-31, X-34, X-35, X-36, X-37** and **X-38** CN;
in a further preferred embodiment R¹¹, R¹⁴, R²⁰, R²¹, R²², R²³ and R²⁴ are - in each case - independently of each other hydrogen, a C₁-C₈alkyl group especially methyl, ethyl, i-propyl, n-butyl, sec-butyl, tert-butyl or isoamyl; or a phenyl group, which can optionally be substituted by one or two groups G; or a C₂-C₃₀heteroaryl group, which can optionally be substituted by G; more preferably hydrogen, a C₁-C₈alkyl group especially methyl, ethyl, i-propyl, n-butyl, sec-butyl, tert-butyl or isoamyl; or a phenyl group, which can optionally be substituted by one or two C₁-C₈alkyl groups, for example 2-tolyl, 3-tolyl, 4-tolyl, 2-ethylphenyl, 3-ethylphenyl, 4-ethylphenyl, 2-isopropylphenyl, 3-isopropylphenyl or 4-isopropylphenyl; most preferably hydrogen or a C₁-Csalkyl group especially methyl, ethyl, i-propyl, n-butyl, sec-butyl, tert-butyl or isoamyl;
or
two adjacent radicals R¹¹ or two adjacent radicals R¹⁴ form together a group 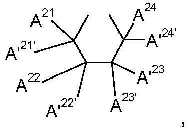 or 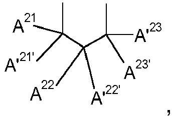 wherein A²¹, A^{21'}, A²², A^{22'}, A²³, A^{23'}, A^{24'} and A²⁴ are independently of each
other H, a C₁-C₄alkyl group, a C₃-C₆cycloalkyl group, or a fluoroC₁-C₄alkyl group;
R²⁵ is CH₃ or ethyl or iso-propyl;
R²⁶ is a phenyl group, which can optionally be substituted by one or two groups selected from CF₃ and C₁-C₈alkyl; preferably optionally substituted by one or two C₁-C₈alkyl groups; or R²⁶ is CH₃; or iso-propyl; preferably, R²⁶ is a phenyl group, which can optionally be substituted by one or two groups selected from CF₃ and C₁-C₈alkyl preferably optionally substituted by one or two C₁-C₈alkyl groups; in a further preferred embodiment R²⁶ is a phenyl group, which is substituted by one or two phenyl groups;
D is -S-, -O-, or -NR⁶⁵-;
E is -OR⁶⁹, -CN, CF₃, C₁-C₈alkyl or F; preferably CF₃ or C₁-C₈alkyl; more preferably C₁-C₈alkyl; G is -OR⁶⁹, -CN, CF₃ or C₁-C₈alkyl; preferably C₁-C₈alkyl;
R⁶⁵ is a phenyl group, which can optionally be substituted by one or two C₁-C₈alkyl groups; an unsubstituted C₁-C₁₈alkyl group; or a C₁-C₁₈alkyl group, which is interrupted by -O-; and R⁶⁹ is a phenyl group, which can optionally be substituted by one or two C₁-C₈alkyl groups; an unsubstituted C₁-C₁₈alkyl group; or a C₁-C₁₈alkyl group, which is interrupted by -O-;
A¹ is C₆-C₁₀aryl;
or
two adjoint groups A¹ together form a group 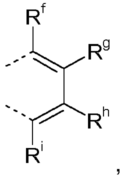 wherein R^{f}, R^{g}, R^{h} and Rⁱ are independently of each other H, or C₁-C₈alkyl;
Q¹ and Q² are independently of each other hydrogen, C₁-C₁₈alkyl, or C₆-C₁₈aryl;
w, x are are independently of each other 0, 1 or 2, preferably 0 or 1; more preferably 0;
z is 0, 1, 2 or 3, preferably 0, 1, more preferably 0;
y, y', y", u, v
   are independently of each other 0, 1 or 2, preferably 0 or 2; more preferably 0;
y'" is 0 or 1, preferably 0;
p, q, r, s, t, t', t"
   are are independently of each other 0, 1, 2, 3 or 4, preferably 0, 1, 2 or 3;
r' is 0, 1 or 2, preferably 0 or 1, more preferably 0.

Preferably, L in the metal carbene complex according to the present invention is a group of formula (X-1), (X-2), (X-3), (X-4), (X-5), preferably (X-5a) and (X-5b), (X-8), (X-9), (X-10), (X-11), (X-12), (X-13), (X-14), (X-15), (X-16), (X-17), (X-18), (X-20), (X-21), (X-22), (X-23), (X-24), (X-25), (X-26), (X-27), (X-28), and (X-29); or a group of formula (X-30), (X-31), (X-32), (X-33), (X-34), (X-35), (X-36), (X-37), (X-38), (X-39), (X-40), (X-41), (X-42), (X-43) or (X-44).

More preferably, L in the metal carbene complex according to the present invention is a group of formula (X-1), (X-2), (X-3), (X-4), (X-5), preferably (X-5a) and (X-5b), (X-8), (X-9), (X-10), (X-11), (X-12), (X-13), (X-14), (X-15), (X-16), (X-17), and (X-18); or a group of formula (X-31), (X-32), (X-33), (X-34), (X-35), (X-36), (X-37), (X-38), (X-39), (X-40), (X-41), (X-42), (X-43) or (X-44).

Most preferably, L in the metal carbene complex according to the present invention is a group of formula (X-1), (X-2), (X-3), (X-4), (X-5), preferably (X-5a) and (X-5b), (X-8), (X-9), (X-10), (X-11), and (X-12); or a group of formula (X-31), (X-32), (X-33), (X-34), (X-35), (X-36), (X-37), (X-38), (X-39), (X-40), (X-41), (X-42), (X-43) or (X-44).

Even more preferably, L in the metal carbene complex according to the present invention is a group of formula (X-1), (X-4), (X-5), preferably (X-5a) and (X-5b), (X-8), (X-9), (X-10), (X-11), and (X-12);; more preferably (X-1), (X-4), (X-5), (X-8), (X-9), and (X-12).

Most preferably, L in the metal carbene complex according to the present invention is a group of formula (X-1) or (X-4).

In a further preferred embodiment, L in the metal carbene complex according to the present invention is a group of formula (X-1), (X-2), (X-3), (X-4), (X-5a), (X-8, wherein R²⁶ is a phenyl group, which can optionally be substituted by one or two groups selected from CF₃ and C₁-Csalkyl), (X-31), (X-34), (X-36), (X-38), (X-40), (X-42) or (X-44).

In a further more preferred embodiment, L in the metal carbene complex according to the present invention is a group of formula (X-1), (X-2), (X-3), (X-4), (X-5a), (X-8, wherein R²⁶ is a phenyl group, which can optionally be substituted by one or two selected from CF₃ and C₁-C₈alkyl), (X-31), (X-34) or (X-44).

In a further even more preferred embodiment, L in the metal carbene complex according to the present invention is a group of formula (X-1), (X-4), (X-5a), (X-8, wherein R²⁶ is a phenyl group, which can optionally be substituted by one or two selected from CF₃ and C₁-C₈alkyl) or (X-31); further even more preferably L is (X-1), (X-4), (X-5a) or (X-31) and most preferably, L is (X-1) or (X-4).

In a further even more preferred embodiment, L in the metal carbene complex according to the present invention is a group of formula (X-1), (X-5a) or (X-31), more preferably (X-1) or (X-5a).

Most preferably, L is (X-1).

The metal M in the inventive metal carbene complexes is Ir or Pt, preferably Ir, more preferably Ir (III). In the case that the metal is Pt, Pt(II) is preferred.

In the most preferred metal carbene complexes of formula (II) according to the present invention the residues, symbols and indices have the following meanings:
M is Ir;
m is 2 or 3;
o is 0 or 1; and
L is (X-1) or (X-4),
whereby the m carbene ligands are preferably the same (identical),
wherein the further residues, symbols and indices in the metal carbene complexes of formula (II) are the same as mentioned above.

In a further more preferred embodiment, L in the metal carbene complex mentioned above is a group of formula (X-5a), (X-31), more preferably (X-1), (X-8, wherein R²⁶ is a phenyl group, which can optionally be substituted by one or two selected from CF₃ and C₁-C₈alkyl) or (X-31).

Even further preferred are metal carbene complexes of formula (II) according to the present invention the residues, symbols and indices have the following meanings:
M is Ir;
m is 2 or 3;
o is 0 or 1; and
L is (X-1) or (X-4),
whereby the m carbene ligands are preferably the same (identical);
wherein the residues R¹, R², R³, R⁴, R⁵, R⁶, R⁷, R⁸, R⁹, R²⁷, R²⁸ are H and the indices x, y, z and y" are 0.

In a further more preferred embodiment, L in the metal carbene complex mentioned above is a group of formula (X-5a), (X-8, wherein R²⁶ is a phenyl group, which can optionally be substituted by one or two selected from CF₃ and C₁-C₈alkyl) or (X-31).

In further most preferred embodiment, the residues, symbols and indices in the metal carbene complexes of formula (II) according to the present invention have the following meanings:
M is Ir;
m is 1;
o is 2; and
L is (X-1), (X-4) (X-5a), (X-8, wherein R²⁶ is a phenyl group, which can optionally be substituted by one or two selected from CF₃ and C₁-C₈alkyl) or (X-31), preferably (X-1), (X-4), (X-5a) or (X-31), even more preferably (X-1) or (X-4);
whereby the o carbene ligands are preferably the same (identical)
wherein the further residues, symbols and indices in the metal carbene complexes of formula (II) are the same as mentioned above.

In an even further preferred embodiment, the residues, symbols and indices in the metal carbene complexes of formula (II) according to the present invention have the following meanings: M is Ir;
m is 1;
o is 2; and
L is (X-1), (X-4) (X-5a), (X-8, wherein R²⁶ is a phenyl group, which can optionally be substituted by one or two selected from CF₃ and C₁-C₈alkyl) or (X-31), preferably (X-1), (X-4), (X-5a) or (X-31), even more preferably (X-1) or (X-4);
whereby the o carbene ligands are preferably the same (identical),
wherein the residues R¹, R², R³, R⁴, R⁵, R⁶, R⁷, R⁸, R⁹, R²⁷, R²⁸ are H and the indices x, y, z and y" are 0.

Preferably, the metal carbene complex according to the present invention is selected from 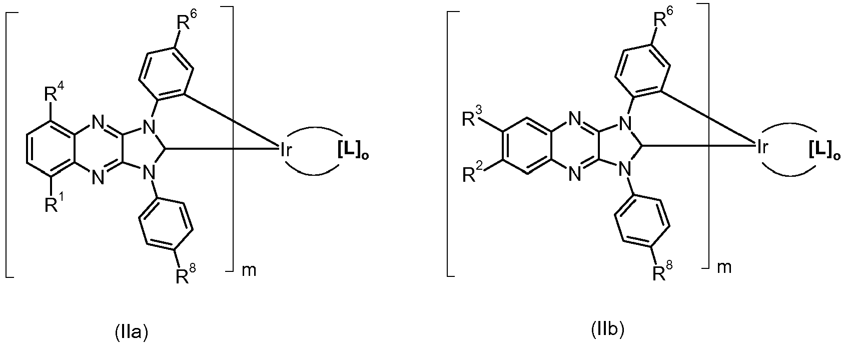 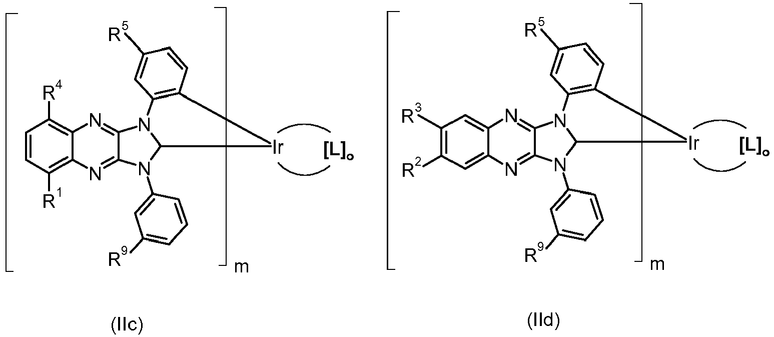 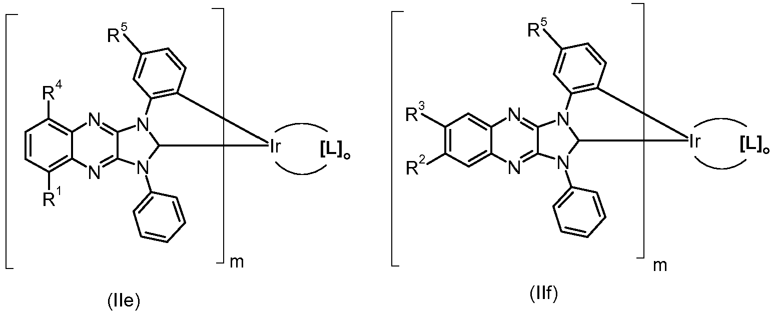 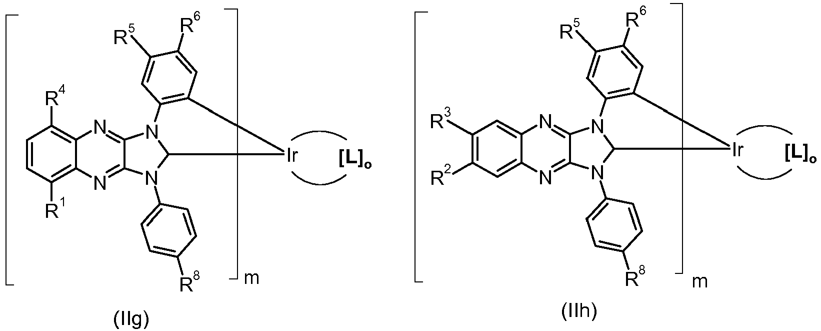 wherein
R¹, R², R³ and R⁴
are independently of each other - in each case - hydrogen; a C₁-C₈alkyl group, which can optionally be substituted by at least one substituent E and/or interrupted by D; a C₃-C₆cycloalkyl group, which can optionally be substituted by at least one substituent E; or a phenyl group, which can optionally be substituted by one or two groups G;
preferably, in the case that R¹, R², R³ and/or R⁴ are a phenyl group, which can optionally be substituted by one or two groups G; R⁵, R⁶, R⁸ and R⁹ are not a phenyl group, which can optionally be substituted by one or two groups G;
more preferably, R¹, R², R³ and R⁴ are independently of each other - in each case - hydrogen; a C₁-C₈alkyl group, which can optionally be substituted by at least one substituent E and/or interrupted by D; or a C₃-C₆cycloalkyl group, which can optionally be substituted by at least one substituent E;
most preferably, R¹ and R⁴ as well as R² and R³ are identical; even further more preferably, R¹, R², R³ and R⁴ are hydrogen;
R⁵ and R⁶
are independently of each other - in each case - hydrogen; a C₁-C₈alkyl group, which can optionally be substituted by at least one substituent E and/or interrupted by D; or a C₃-C₆cycloalkyl group, which can optionally be substituted by at least one substituent E; or a phenyl group, which can optionally be substituted by one or two groups G;
preferably, R⁵ and R⁶ are independently of each other - in each case - hydrogen; a C₁-C₈alkyl group, which can optionally be substituted by at least one substituent E and/or interrupted by D; or a C₃-C₆cycloalkyl group, which can optionally be substituted by at least one substituent E; or either R⁵ or R⁶, preferably R⁵, are a phenyl group, which can optionally be substituted by one or two groups G;
more preferably, R⁵ and R⁶ are independently of each other - in each case - hydrogen; a C₁-Csalkyl group, which can optionally be substituted by at least one substituent E and/or interrupted by D; or a C₃-C₆cycloalkyl group, which can optionally be substituted by at least one substituent E; or either R⁵ or R⁶, preferably R⁵, is a phenyl group, which can optionally be substituted by one or two groups G; in a further preferred embodiment, R⁶ is a phenyl group, which can optionally be substituted by one or two groups G; more preferably, R⁵ and R⁶ are hydrogen;
R⁸ and R⁹ are independently of each other hydrogen; a C₁-C₈alkyl group, which can optionally be substituted by at least one substituent E and/or interrupted by D; or a C₃-C₆cycloalkyl group, which can optionally be substituted by at least one substituent E; or a phenyl group, which can optionally be substituted by one or two groups G;
preferably, R⁸ and R⁹ are independently of each other - in each case - hydrogen; a C₁-C₈alkyl group, which can optionally be substituted by at least one substituent E and/or interrupted by D; or a C₃-C₆cycloalkyl group, which can optionally be substituted by at least one substituent E; or either R⁸ or R⁹ are a phenyl group, which can optionally be substituted by one or two groups G; more preferably, R⁸ and R⁹ are independently of each other - in each case - hydrogen; a C₁-Csalkyl group, which can optionally be substituted by at least one substituent E and/or interrupted by D; or a C₃-C₆cycloalkyl group, which can optionally be substituted by at least one substituent E; more preferably, R⁹ is hydrogen and R⁸ is hydrogen or a phenyl group which can be optionally substituted by one or two groups G; most preferably, R⁸ and R⁹ are hydrogen;
D is -S- or -O-;
E is -OR⁶⁹, -CN, CF₃, C₁-C₈alkyl or F; preferably CF₃ or C₁-C₈alkyl; preferably C₁-C₈alkyl;
G is -OR⁶⁹, -CN, CF₃ or C₁-C₈alkyl; preferably C₁-C₈alkyl;
R⁶⁹ is a phenyl group, which can optionally be substituted by one or two C₁-C₈alkyl groups; an unsubstituted C₁-C₈alkyl group; or a C₁-C₈alkyl group, which is interrupted by -O-;
L is a monoanionic bidentate ligand, for example 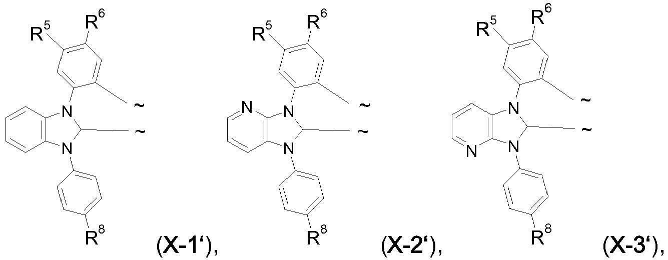 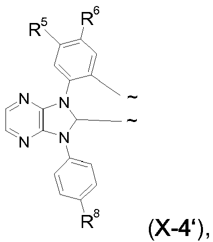 as well as 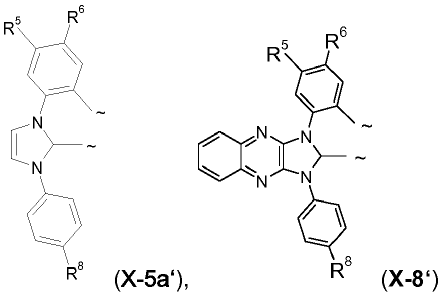 and 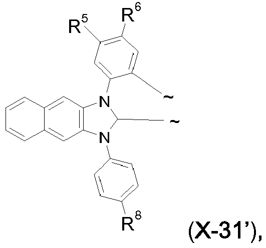 preferably (**X-1'**), (**X-4'**), (**X-5a'**), (**X-8'**) or (**X-31'**); more preferably, (**X-1'**), (**X-4'**), (**X-5a'**) or (**X-31'**);most preferably, (**X-1'**), (**X-4'**) or (**X-5a'**), further most preferably, (**X-1'**) or (**X-4'**); even further most preferably (**X-1'**).
m is 1, 2, or 3; preferably 2 or 3; or - in a further preferred embodiment - 1;
o is 0, 1, or 2; preferably 0 or 1; or - in a further preferred embodiment - 2;
and the sum of m + o is 3;

in the case that o = 2, the ligands L may be the same or different, preferably the same; and in the case that m is 2 or 3, the m carbene ligands may be the same or different, preferably the same.

More preferably, at least one of the residues R¹, R², R³, R⁴, R⁵, R⁶, R⁸ and R⁹ in the complexes of formulae (IIa), (IIb), (IIc), (IId), (IIe), (IIf), (IIg) and (IIh) is not hydrogen; most preferably, in formula (IIa), two or all of R¹, R⁴, R⁶ and R⁸ are not hydrogen; in formula (IIb), two or all of R², R³, R⁶ and R⁸ are not hydrogen; in formula (IIc), two or all of R¹, R⁴, R⁵ and R⁹ are not hydrogen; in formula (IId), two or all of R², R³, R⁵ and R⁹ are not hydrogen; in formula (IIe), one or all of R¹, R⁴ and R⁵ are not hydrogen; in formula (IIf), one or all of R², R³ and R⁵ are not hydrogen; in formula (IIg), three or all of R¹, R⁴, R⁵, R⁶ and R⁸ are not hydrogen; in formula (IIh), three or all of R², R³, R⁵, R⁶ and R⁸ are not hydrogen.

In a further preferred embodiment, R¹, R², R³ and R⁴ are hydrogen and the residues R⁵, R⁶ and R⁸ are as mentioned above.

In a further preferred embodiment of the present invention, R⁵, R⁶ and R⁸ in formulae (X-1'), (X-2'), (X-3'), and (X-4') are hydrogen. In a further preferred embodiment of the present invention, R⁵, R⁶ and R⁸ in formulae (X-5a'), (X-8') and (X-31') are hydrogen.

More preferably, the metal carbene complex according to the present invention is selected from the metal carbene complexes (IIa), (IIb), (IIe), (IIf), (IIg) and (IIh). In a further more preferred embodiment, the metal carbene complex according to the present invention is selected from the metal carbene complex (IId). Most preferably, the metal carbene complex according to the present invention is selected from the metal carbene complexes (IIb), (IId), (IIf) and (IIh).

In a most preferred embodiment, R¹, R², R³, R⁴, R⁵, R⁶, R⁸, and R⁹ are hydrogen, i.e. the metal carbene complex of the present invention has the following formula:

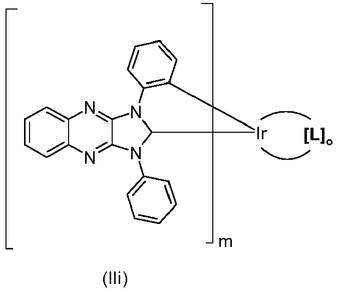

Most preferably, the metal carbene complex according to the present invention is selected from 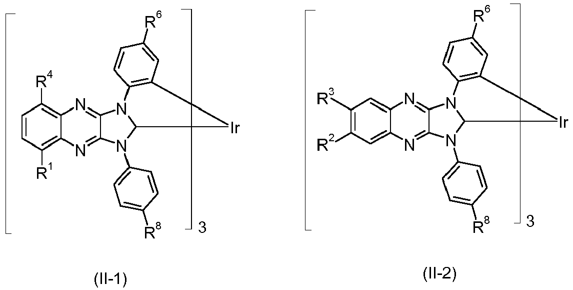 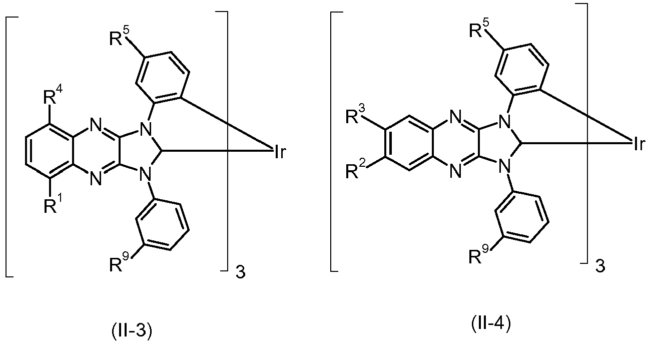 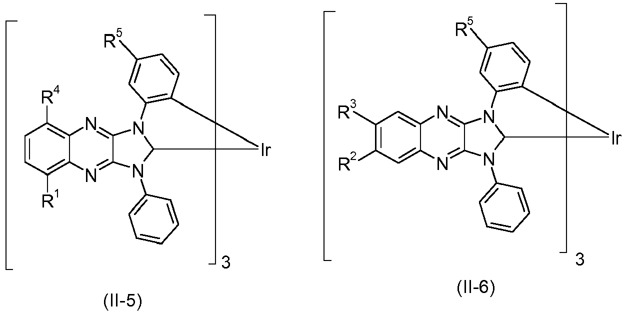 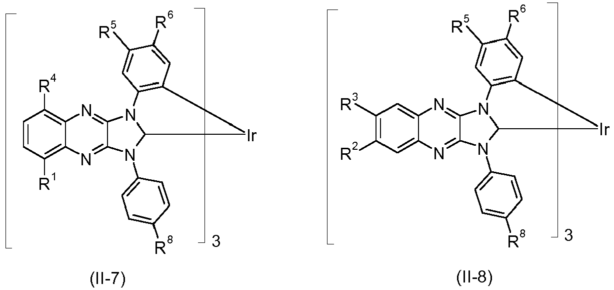 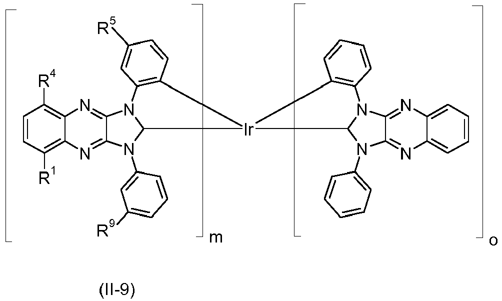 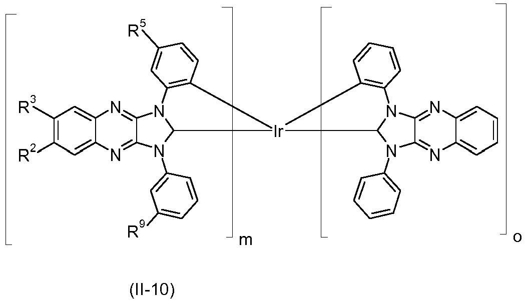 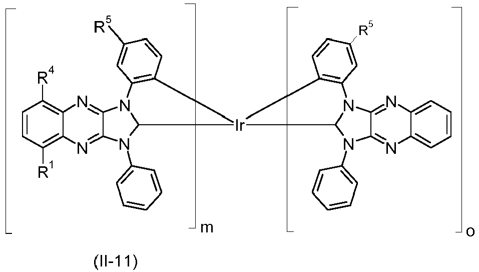 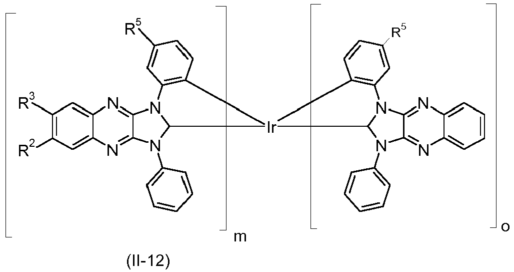 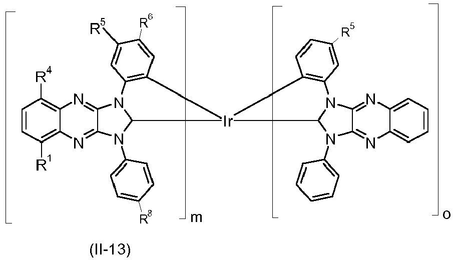 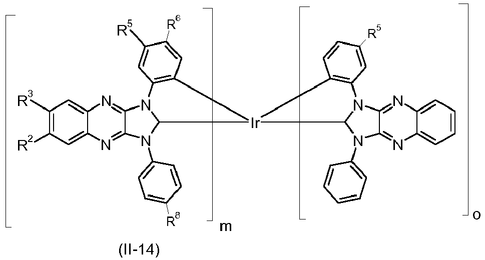 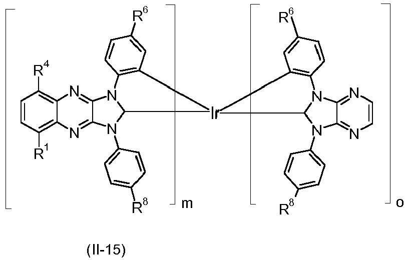 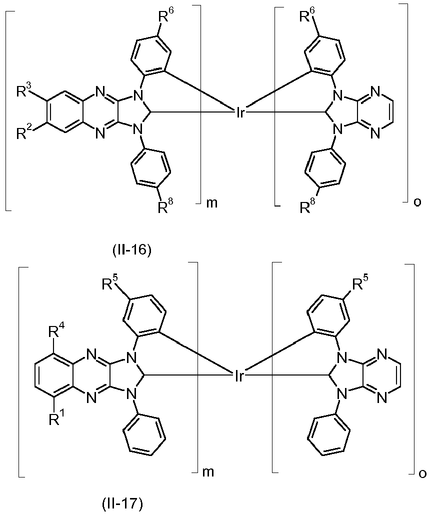 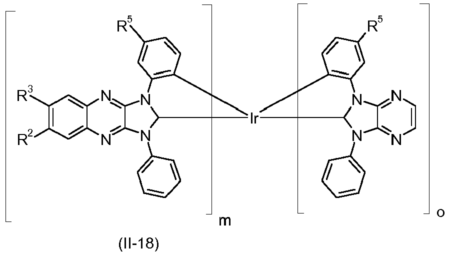 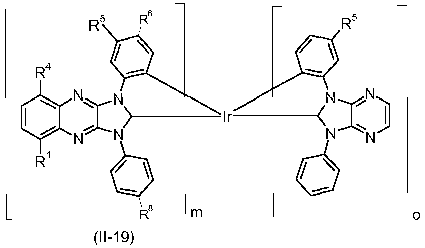 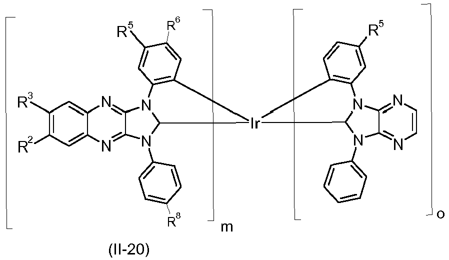 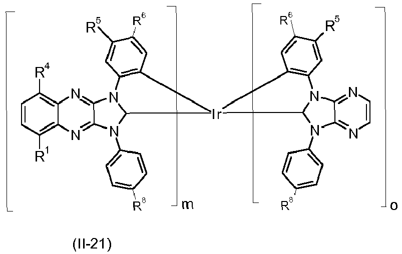 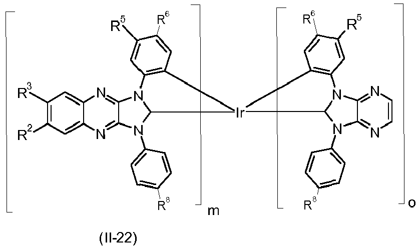 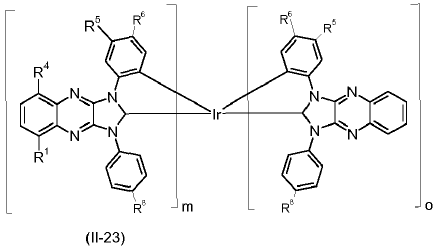 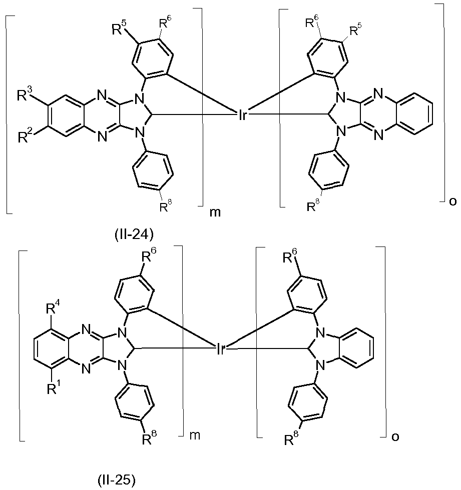 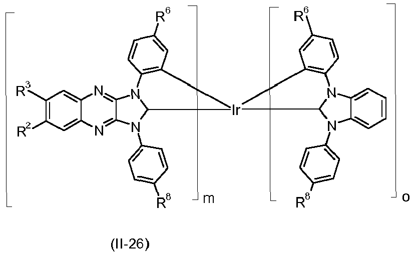 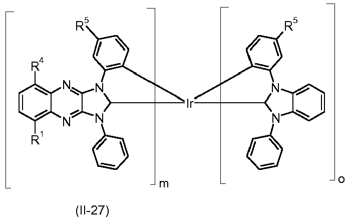 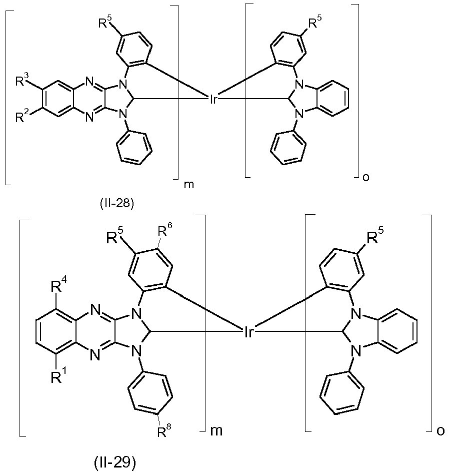 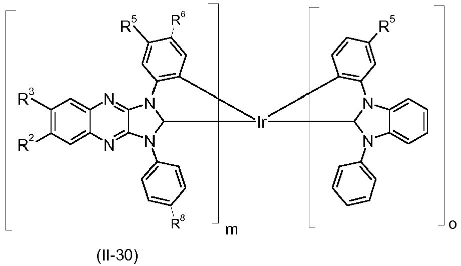 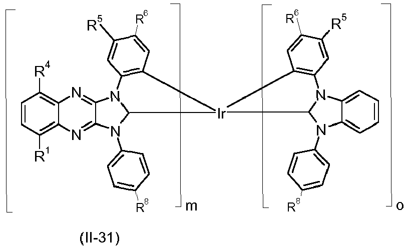 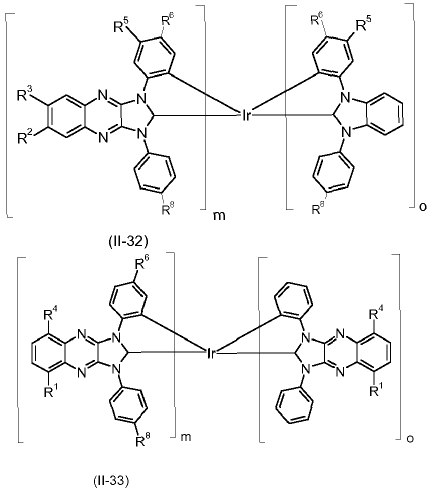 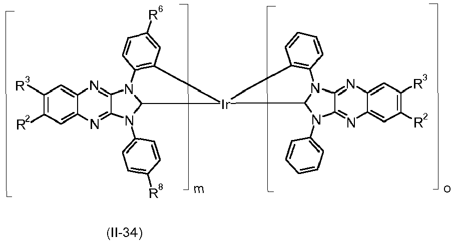 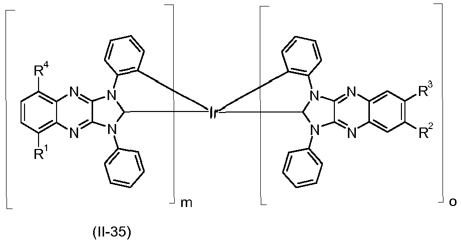 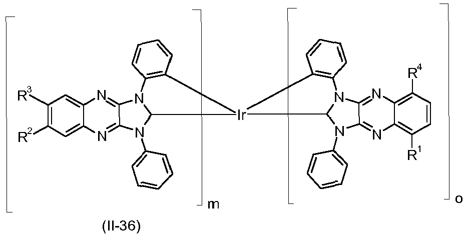 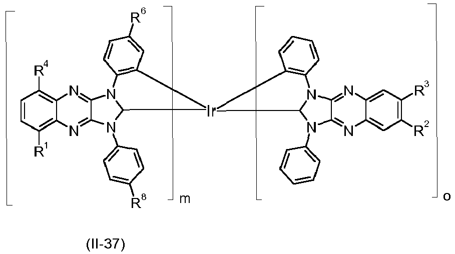 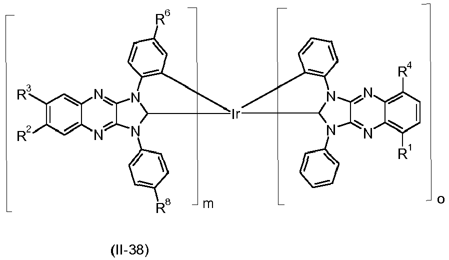 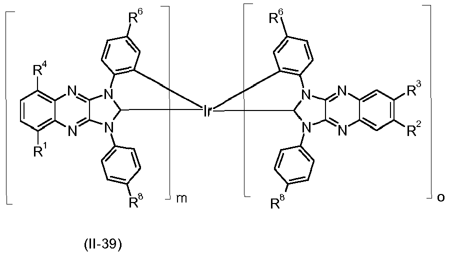 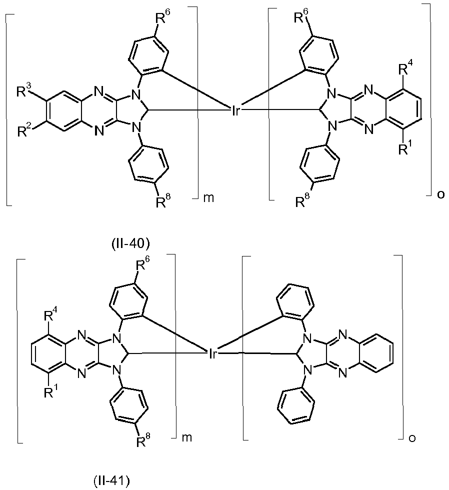 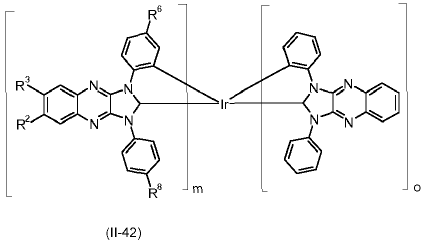 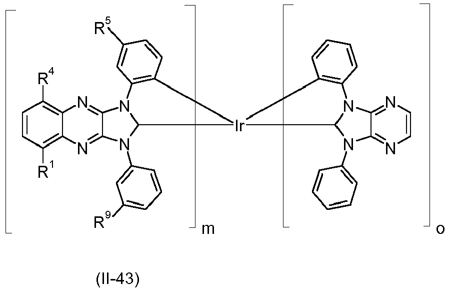 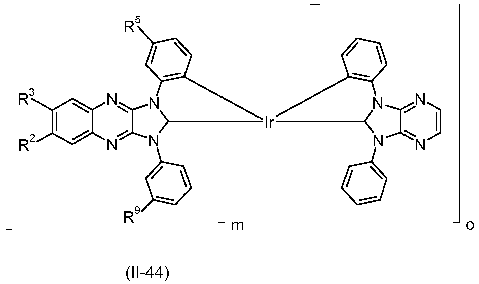 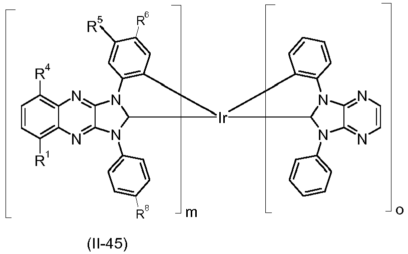 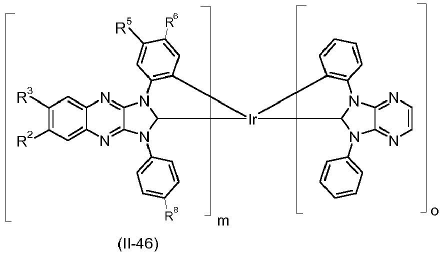 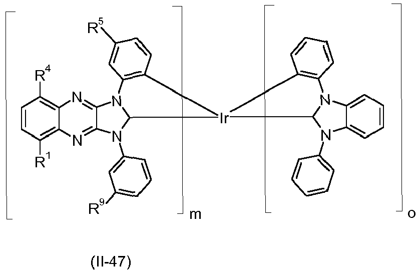 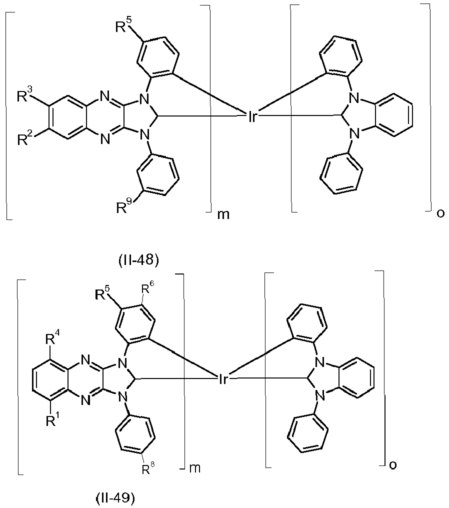 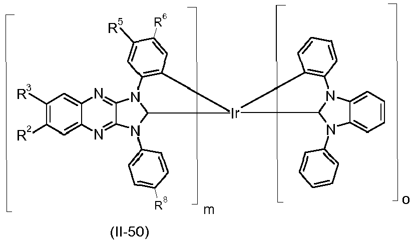 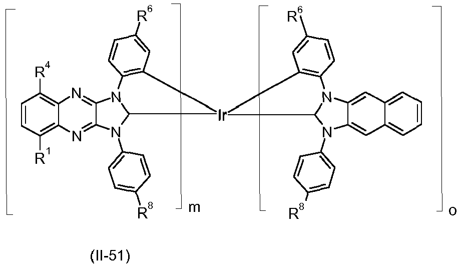 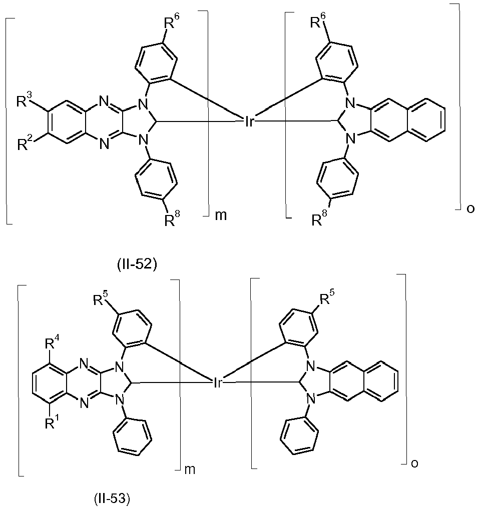 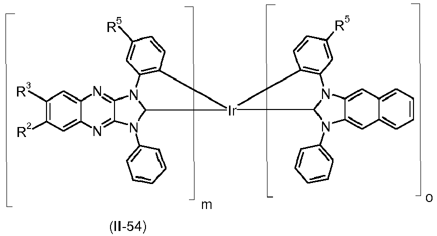 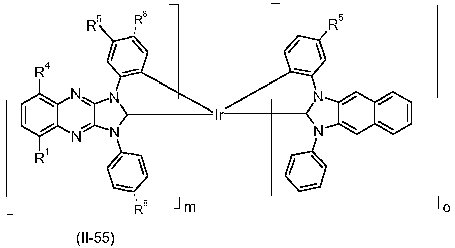 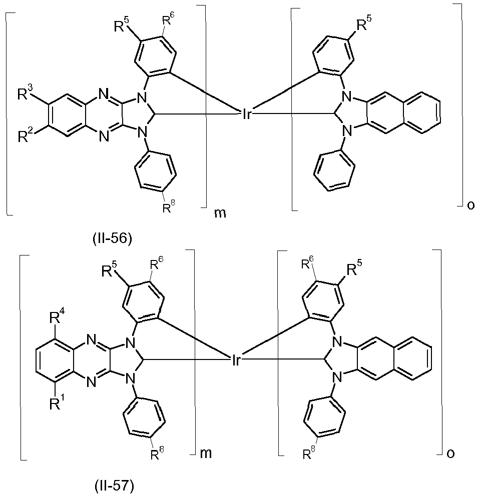 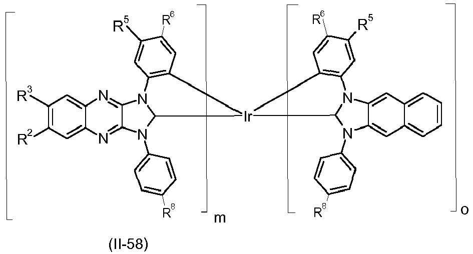 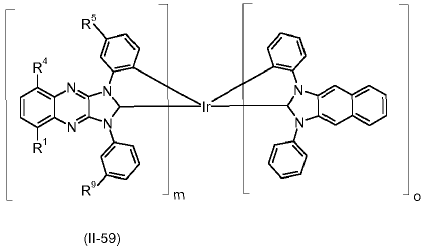 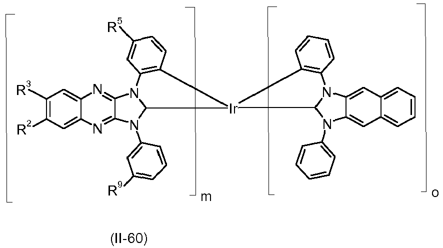 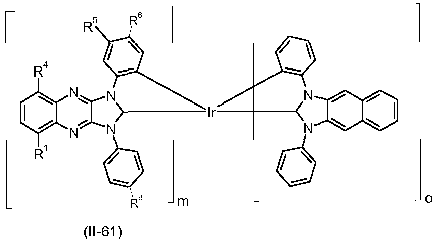 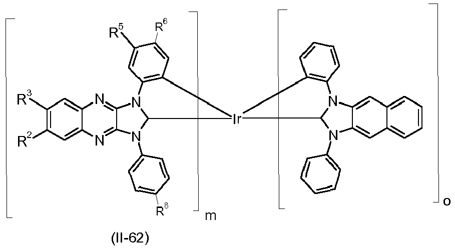 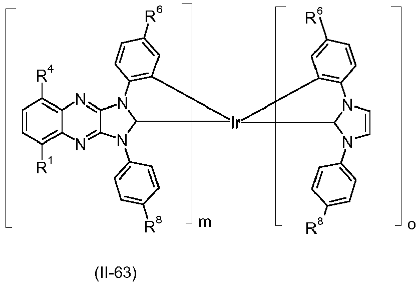 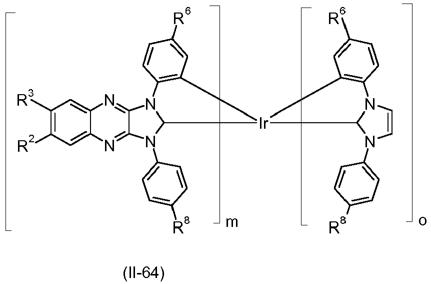 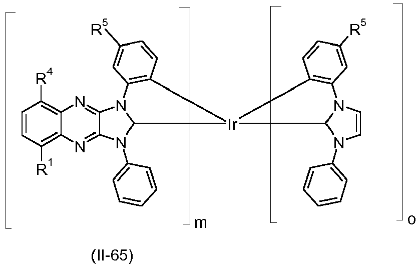 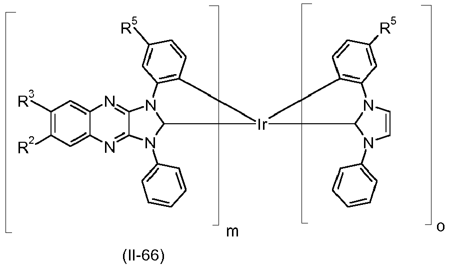 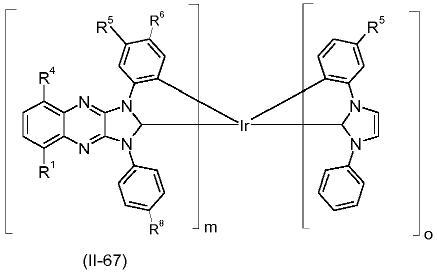 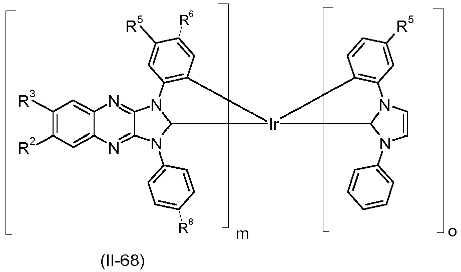 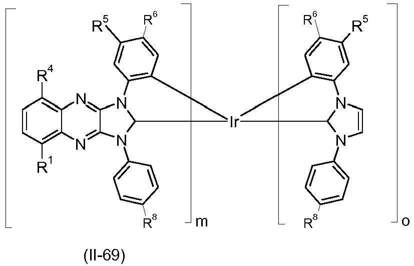 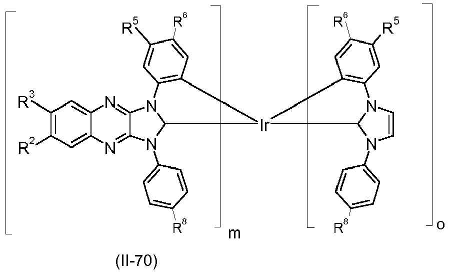 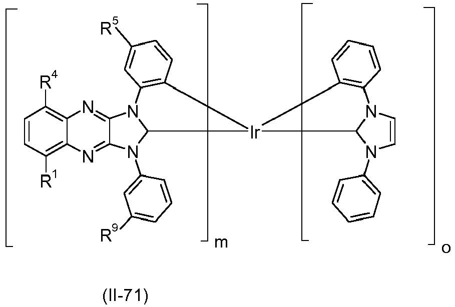 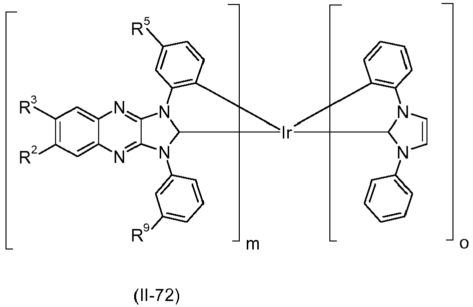 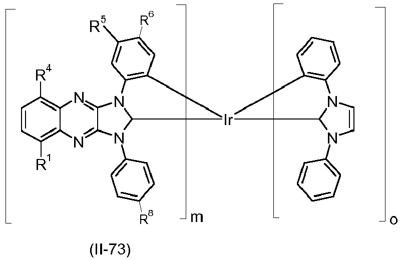 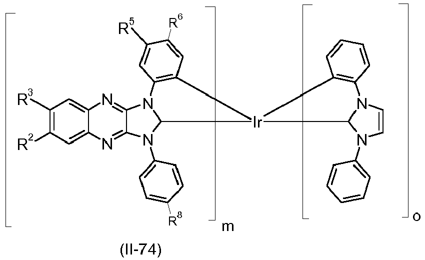 wherein
R¹, R², R³ and R⁴
are independently of each other - in each case - hydrogen, a C₁-C₈alkyl group, which can optionally be substituted by at least one substituent E and/or interrupted by D; a C₃-C₆cycloalkyl group, which can optionally be substituted by at least one substituent E; or a phenyl group, which can optionally be substituted by one or two groups G;
preferably, in the case that R¹, R², R³ and/or R⁴ are a phenyl group, which can optionally be substituted by one or two groups G; R⁵, R⁶, R⁸ and R⁹ are not a phenyl group, which can optionally be substituted by one or two groups G;
more preferably, R¹, R², R³ and R⁴ are independently of each other - in each case - hydrogen, a C₁-C₈alkyl group, which can optionally be substituted by at least one substituent E and/or interrupted by D; or a C₃-C₆cycloalkyl group, which can optionally be substituted by at least one substituent E;
most preferably, R¹ and R⁴ as well as R² and R³ are identical; even further more preferably, R¹, R², R³ and R⁴ are hydrogen;
R⁵ and R⁶
are independently of each other - in each case - hydrogen, a C₁-C₈alkyl group, which can optionally be substituted by at least one substituent E and/or interrupted by D; or a C₃-C₆cycloalkyl group, which can optionally be substituted by at least one substituent E; or a phenyl group, which can optionally be substituted by one or two groups G;
preferably, R⁵ and R⁶ are independently of each other - in each case - hydrogen, a C₁-C₈alkyl group, which can optionally be substituted by at least one substituent E and/or interrupted by D; or a C₃-C₆cycloalkyl group, which can optionally be substituted by at least one substituent E; or either R⁵ or R⁶, preferably R⁵, are a phenyl group, which can optionally be substituted by one or two groups G;
more preferably, R⁵ and R⁶ are independently of each other - in each case - hydrogen, a C₁-Csalkyl group, which can optionally be substituted by at least one substituent E and/or interrupted by D; or a C₃-C₆cycloalkyl group, which can optionally be substituted by at least one substituent E; or either R⁵ or R⁶, preferably R⁵, is a phenyl group, which can optionally be substituted by one or two groups G; in a further preferred embodiment, R⁶ is a phenyl group, which can optionally be substituted by one or two groups G; more preferably, R⁵ and R⁶ are hydrogen; R⁸ and R⁹
are independently of each other - in each case - hydrogen, a C₁-C₈alkyl group, which can optionally be substituted by at least one substituent E and/or interrupted by D; or a C₃-C₆cycloalkyl group, which can optionally be substituted by at least one substituent E; or a phenyl group, which can optionally be substituted by one or two groups G;
preferably, R⁸ and R⁹ are independently of each other - in each case - hydrogen, a C₁-C₈alkyl group, which can optionally be substituted by at least one substituent E and/or interrupted by D; or a C₃-C₆cycloalkyl group, which can optionally be substituted by at least one substituent E; or either R⁸ or R⁹ are a phenyl group, which can optionally be substituted by one or two groups G; more preferably, R⁸ and R⁹ are independently of each other - in each case - a C₁-C₈alkyl group, which can optionally be substituted by at least one substituent E and/or interrupted by D; or a C₃-C₆cycloalkyl group, which can optionally be substituted by at least one substituent E; more preferably, R⁹ is hydrogen and R⁸ is hydrogen or a phenyl group which can be optionally substituted by one or two groups G; most preferably, R⁸ and R⁹ are hydrogen;
most preferably, in the case that R⁶ and R⁸ are both present, R⁶ and R⁸ are identical; in the case that R⁵ and R⁹ are both present, R⁵ and R⁹ are identical;
D is -S- or -O-;
E is -OR⁶⁹, -CN, CF₃, C₁-C₈alkyl or F; preferably CF₃ or C₁-C₈alkyl; preferably C₁-C₈alkyl;
G is -OR⁶⁹, -CN, CF₃ or C₁-C₈alkyl; preferably C₁-C₈alkyl;
R⁶⁹ is a phenyl group, which can optionally be substituted by one or two C₁-C₈alkyl groups; an unsubstituted C₁-C₈alkyl group; or a C₁-C₈alkyl group, which is interrupted by-O-;
m is 2 or 1, preferably 2; in the case that m is 2, the two ligands are identical or different, preferably, the two ligands are identical;
o is 1 or 2, preferably 1; in the case that m is 2, the two ligands are identical or different, preferably, the two ligands are identical;
and the sum of m + o is 3.

Preferred residues R¹, R², R³, R⁴, R⁵, R⁶, R⁸ and R⁹ and combinations of said residues are mentioned above. Preferred groups D, E, G and R⁶⁹ are also mentioned above.

In one preferred embodiment of the present invention, at least one of the residues R¹, R², R³, R⁴, R⁵, R⁶, R⁸ and R⁹ in each formula of formulae (II-1) to (II-74) is not hydrogen.

In a most preferred embodiment, R¹, R², R³, R⁴, R⁵, R⁶, R⁸, and R⁹ in each formula of formulae (II-1) to (II-74) are hydrogen.

Even more preferably, the metal carbene complex according to the present invention is selected from the metal carbene complexes (II-1), (II-2), (II-5), (II-6), (II-7), (II-8), (II-11), (II-12), (II-13), (II-14), (II-15), (II-16), (II-17), (II-18), (II-19), (II-20), (II-21), (II-22), (II-23), (II-24), (II-25), (II-26), (II-27), (II-28), (II-29), (II-30), (II-31), (II-32), (II-33), (II-34), (II-35), (II-36), (II-37), (II-38), (II-39), (II-40), (II-41), (II-42), (II-45), and (II-46).

Additionally, even more preferably, the metal carbene complex according to the present invention is selected from the metal carbene complexes (II-51), (II-52), (II-53), (II-54), (II-55), (II-56), (II-57), (II-58), (II-59), (II-60), (II-61), (II-62), (II-63), (II-64), (II-65), (II-66), (II-67), (II-68), (II-69), (II-70), (II-71), (II-72), (II-73) and (II-74).

Further even more preferably, the metal carbene complex according to the present invention is selected from the metal carbene complexes (II-1), (II-2), (II-5), (II-6), (II-11), (II-12), (II-15), (II-16), (II-17), (II-18), (II-25), (II-26), (II-27), (II-28), (II-33), (II-34), (II-35), (II-36), (II-37), (II-38), (II-39), (II-40), (II-41), and (II-42).

Additionally, further even more preferably, the metal carbene complex according to the present invention is selected from the metal carbene complexes (II-51), (II-52), (II-53), (II-54), (II-59), (II-60), (II-63), (II-64), (II-65), (II-66), (II-71) and (II-72).

In a most preferred embodiment, R¹, R², R³, R⁴, R⁵, R⁶, R⁸, and R⁹ are hydrogen, i.e. the metal carbene complex of the present invention has one of the following formulae: 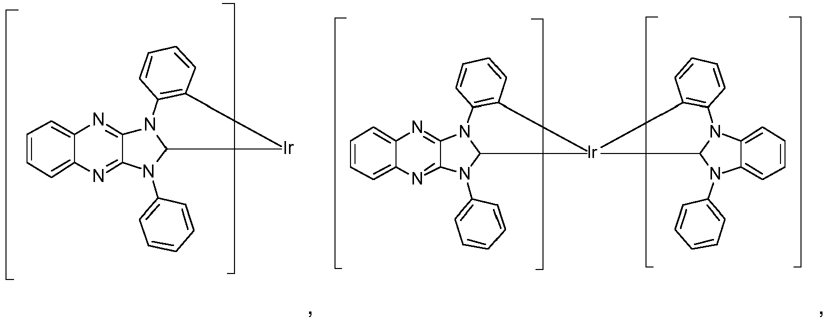 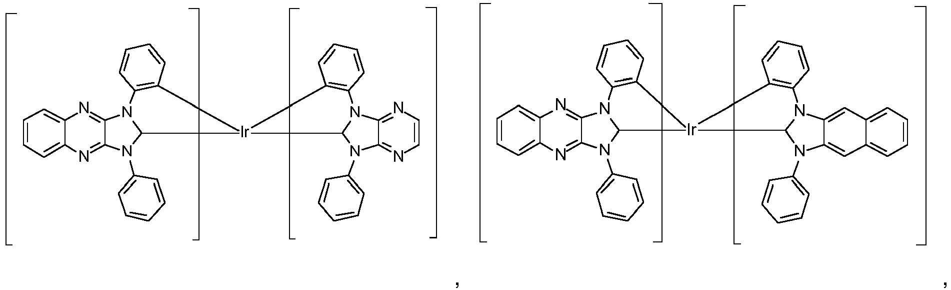 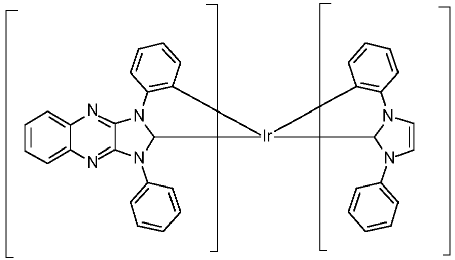 or
wherein
m is 1, 2 or 3, preferably 2 or 3; and
o is 0, 1 or 2, preferably 0 or 1.

In a further most preferred embodiment, R¹, R², R³, R⁴, R⁵, R⁶, R⁸, and R⁹ are hydrogen, i.e. the metal carbene complex of the present invention has one of the formulae (II-A), (II-B), (II-C), (II-D) or (II-E) as mentioned above, wherein
m is 1; and
o is 2.

Examples for particularly preferred metal carbene complexes according to the present invention are mentioned in the following tables: 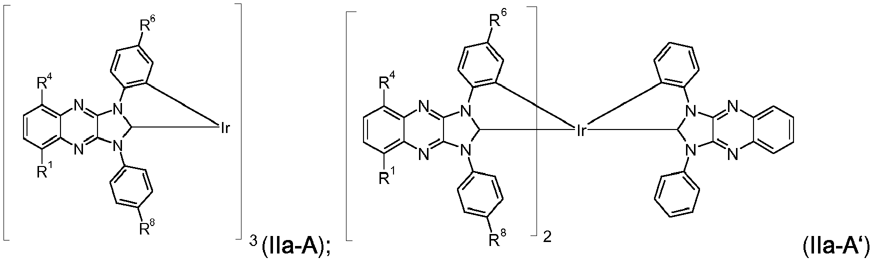 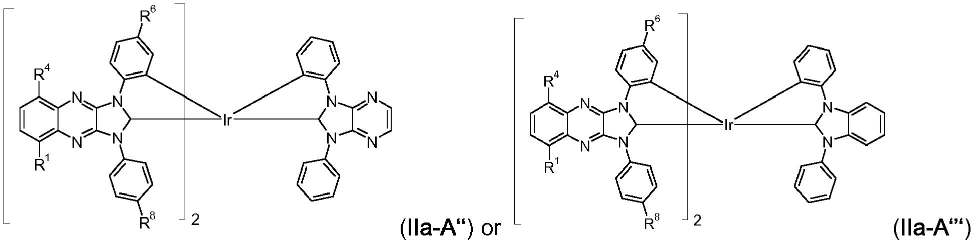 or

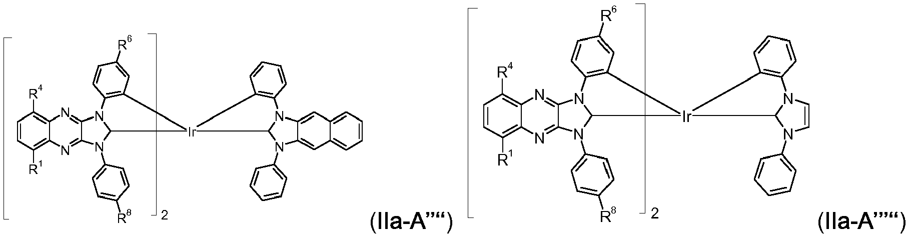

| **Cpd.** | **R⁴** | **R¹** | **R⁶ = R⁸** |
|---|---|---|---|
| A-1, A'-1, A"-1, A"'-1, A""-1, A""'-1 | -CH₃ | -CH₃ | H |
| A-2, A'-2, A"-2, A"'-2, A""-2, A""'-2 | -CH₂CH₃ | -CH₂CH₃ | H |
| A-3, A'-3, A"-3, A"'-3, A-""-3, A""'-3 | *n*-propyl | *n*-propyl | H |
| A-4, A'-4, A"-4, A"'-4, A""-4, A""'-4 | *iso*-propyl | *iso*-propyl | H |
| A-5, A'-5, A"-5, A"'-5, A""-5, A""'-5 | *sec*-butyl | *sec*-butyl | H |
| A-6, A'-6, A"-6, A"'-6, A""-6, A""'-6 | *iso*-butyl | *iso*-butyl | H |
| A-7, A'-7, A"-7, A"'-7, A""-7, A""'-7 | neopentyl | neopentyl | H |
| A-8, A'-8, A"-8, A"'-8, A""-8, A""'-8 | 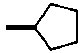 | 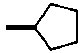 | H |
| A-9, A'-9, A"-9, A"'-9, A""-9, A""'-9 | 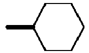 | 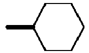 | H |
| A-10, A'-10, A"-10, A"'-10, A""-10, A'""-10 | -CH₃ | -CH₃ | -CH₃ |
| A-11, A'-11, A"-11, A"'-11, A""-11, A""'-11 | -CH₂CH₃ | -CH₂CH₃ | -CH₃ |
| A-12, A'-12, A"-12, A"'-12, A""-12, A""'-12 | *n*-propyl | *n*-propyl | -CH₃ |
| A-13, A'-13, A"-13, A"'-13, A""-13, A""'-13 | *iso*-propyl | *iso*-propyl | -CH₃ |
| A-14, A'-14, A"-14, A"'-14, A""-14, A""'-14 | *sec*-butyl | *sec*-butyl | -CH₃ |
| A-15, A'-15, A"-15, A"'-15, A""-15, A""'-15 | *iso*-butyl | *iso*-butyl | -CH₃ |
| A-16, A'-16, A"-16, A"'-16, A""-16, A""'-16 | neopentyl | neopentyl | -CH₃ |
| A-17, A'-17, A"-17, A"'-17, A""-17, A""'-17 | 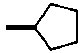 | 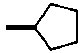 | -CH₃ |
| A-18, A'-18, A"-18, A"'-18, A""-18, A""'-18 | 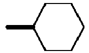 | 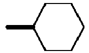 | -CH₃ |
| A-19, A'-19, A"-19, A"'-19, A""-19, A""'-19 | -CH₃ | -CH₃ | -CH₂CH₃ |
| A-20, A'-20, A"-20, A'"-20, A""-20, A""'-20 | -CH₂CH₃ | -CH₂CH₃ | -CH₂CH₃ |
| A-21, A'-21, A"-21, A"'-21, A""-21, A""'-21 | *n*-propyl | *n*-propyl | -CH₂CH₃ |
| A-22, A'-22, A"-22, A'"-22, A""-22, A""'-22 | *iso*-propyl | *iso*-propyl | -CH₂CH₃ |
| A-23, A'-23, A"-23, A'"-23, A""-23, A""'-23 | *sec*-butyl | *sec*-butyl | -CH₂CH₃ |
| A-24, A'-24, A"-24, A'"-24, A""-24, A""'-24 | *iso*-butyl | *iso*-butyl | -CH₂CH₃ |
| A-25, A'-25, A"-25, A'"-25, A""-25, A""'-25 | neopentyl | neopentyl | -CH₂CH₃ |
| A-26, A'-26, A"-26, A'"-26, A""-26, A""'-26 | 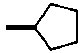 | 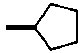 | -CH₂CH₃ |
| A-27, A'-27, A"-27, A'"-27, A""-27, A""'-27 | 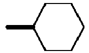 | 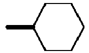 | -CH₂CH₃ |
| A-28, A'-28, A"-28, A'"-28, A""-28, A""'-28 | -CH₃ | -CH₃ | *n*-propyl |
| A-29, A'-29, A"-29, A'"-29, A""-29, A""'-29 | -CH₂CH₃ | -CH₂CH₃ | *n*-propyl |
| A-30, A'-30, A"-30, A'"-30, A""-30, A""'-30 | *n*-propyl | *n*-propyl | *n*-propyl |
| A-31, A'-31, A"-31, A"'-31, A""-31, A""'-31 | *iso*-propyl | *iso*-propyl | *n*-propyl |
| A-32, A'-32, A"-32, A'"-32, A""-32, A""'-32 | *sec*-butyl | *sec*-butyl | *n*-propyl |
| A-33, A'-33, A"-33, A'"-33, A""-33, A""'-33 | *iso*-butyl | *iso*-butyl | *n*-propyl |
| A-34, A'-34, A"-34, A'"-34, A""-34, A""'-34 | neopentyl | neopentyl | *n*-propyl |
| A-35, A'-35, A"-35, A'"-35, A""-35, A""'-35 | 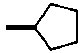 | 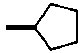 | *n*-propyl |
| A-36, A'-36, A"-36, A'"-36, A""-36, A""'-36 | 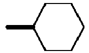 | 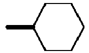 | *n*-propyl |
| A-37, A'-37, A"-37, A'"-37, A""-37, A""'-37 | -CH₃ | -CH₃ | *iso*-propyl |
| A-38, A'-38, A"-38, A'"-38, A""-38, A""'-38 | -CH₂CH₃ | -CH₂CH₃ | *iso*-propyl |
| A-39, A'-39, A"-39, A'"-39, A""-39, A""'-39 | *n*-propyl | *n*-propyl | *iso*-propyl |
| A-40, A'-40, A"-40, A'"-40, A""-40, A""'-40 | *iso*-propyl | *iso*-propyl | *iso*-propyl |
| A-41, A'-41, A"-41, A"'-41, A""-41, A""'-41 | *sec*-butyl | *sec*-butyl | *iso*-propyl |
| A-42, A'-42, A"-42, A'"-42, A""-42, A""'-42 | *iso*-butyl | *iso*-butyl | *iso*-propyl |
| A-43, A'-43, A"-43, A'"-43, A""-43, A""'-43 | neopentyl | neopentyl | *iso*-propyl |
| A-44, A'-44, A"-44, A'"-44, A""-44, A""'-44 | 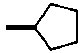 | 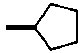 | *iso*-propyl |
| A-45, A'-45, A"-45, A'"-45, A""-45, A""'-45 | 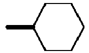 | 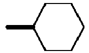 | *iso*-propyl |
| A-46, A'-46, A"-46 A"'-46, A""-46, A""'-46 | -CH₃ | -CH₃ | *sec*-butyl |
| A-47, A'-47, A"-47, A'"-47, A""-47, A""'-47 | -CH₂CH₃ | -CH₂CH₃ | *sec*-butyl |
| A-48, A'-48, A"-48, A'"-48, A""-48, A""'-48 | *n*-propyl | *n*-propyl | *sec*-butyl |
| A-49, A'-49, A"-49, A'"-49, A""-49, A""'-49 | *iso*-propyl | *iso*-propyl | *sec*-butyl |
| A-50, A'-50, A"-50, A'"-50, A""-50, A""'-50 | *sec*-butyl | *sec*-butyl | *sec*-butyl |
| A-51, A'-51, A"-51, A"'-51, A""-51, A""'-51 | *iso*-butyl | *iso*-butyl | *sec*-butyl |
| A-52, A'-52, A"-52, A'"-52, A""-52, A""'-52 | neopentyl | neopentyl | *sec*-butyl |
| A-53, A'-53, A"-53, A'"-53, A""-53, A""'-53 | 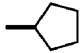 | 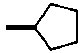 | *sec*-butyl |
| A-54, A'-54, A"-54, A'"-54, A""-54, A""'-54 | 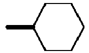 | 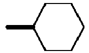 | *sec*-butyl |
| A-55, A'-55, A"-55, A'"-55, A""-55, A""'-55 | -CH₃ | -CH₃ | *iso*-butyl |
| A-56, A'-56, A"-56, A'"-56, A""-56, A""'-56 | -CH₂CH₃ | -CH₂CH₃ | *iso*-butyl |
| A-57, A'-57, A"-57, A'"-57, A""-57, A""'-57 | *n*-propyl | *n*-propyl | *iso*-butyl |
| A-58, A'-58, A"-58, A'"-58, A""-58, A""'-58 | *iso*-propyl | *iso*-propyl | *iso*-butyl |
| A-59, A'-59, A"-59, A'"-59, A""-59, A""'-59 | *sec*-butyl | *sec*-butyl | *iso*-butyl |
| A-60, A'-60, A"-60, A'"-60, A""-60, A""'-60 | *iso*-butyl | *iso*-butyl | *iso*-butyl |
| A-61, A'-61, A"-61, A"'-61, A""-61, A""'-61 | neopentyl | neopentyl | *iso*-butyl |
| A-62, A'-62, A"-62, A'"-62, A""-62, A""'-62 | 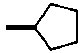 | 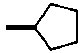 | *iso*-butyl |
| A-63, A'-63, A"-63, A'"-63, A""-63, A""'-63 | 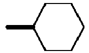 | 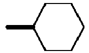 | *iso*-butyl |
| A-64, A'-64, A"-64, A'"-64, A""-64, A""'-64 | -CH₃ | -CH₃ | neopentyl |
| A-65, A'-65, A"-65, A'"-65, A""-65, A""'-65 | -CH₂CH₃ | -CH₂CH₃ | neopentyl |
| A-66, A'-66, A"-66, A'"-66, A""-66, A""'-66 | *n*-propyl | *n*-propyl | neopentyl |
| A-67, A'-67, A"-67, A'"-67, A""-67, A""'-67 | *iso*-propyl | *iso*-propyl | neopentyl |
| A-68, A'-68, A"-68, A'"-68, A""-68, A""'-68 | *sec*-butyl | *sec*-butyl | neopentyl |
| A-69, A'-69, A"-69, A'"-69, A""-69, A""'-69 | *iso*-butyl | *iso*-butyl | neopentyl |
| A-70, A'-70, A"-70, A'"-70, A""-70, A""'-70 | neopentyl | neopentyl | neopentyl |
| A-71, A'-71, A"-71, A"'-71, A""-71, A""'-71 | 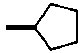 | 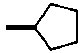 | neopentyl |
| A-72, A'-72, A"-72, A'"-72, A""-72, A""'-72 | 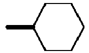 | 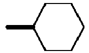 | neopentyl |
| A-73, A'-73, A"-73, A'"-73, A""-73, A""'-73 | -CH₃ | -CH₃ | 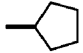 |
| A-74, A'-74, A"-74, A'"-74, A""-74, A""'-74 | -CH₂CH₃ | -CH₂CH₃ | 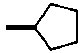 |
| A-75, A'-75, A"-75, A'"-75, A""-75, A""'-75 | *n*-propyl | *n*-propyl | 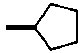 |
| A-76, A'-76, A"-76, A'"-76, A""-76, A""'-76 | *iso*-propyl | *iso*-propyl | 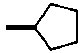 |
| A-77, A'-77, A"-77, A'"-77, A""-77, A'""-77 | *sec*-butyl | *sec*-butyl | 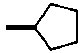 |
| A-78, A'-78, A"-78, A'"-78, A""-78, A""'-78 | *iso*-butyl | *iso*-butyl | 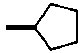 |
| A-79, A'-79, A"-79, A'"-79, A""-79, A""'-79 | neopentyl | neopentyl | 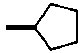 |
| A-80, A'-80, A"-80, A'"-80, A""-80, A""'-80 | 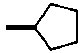 | 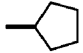 | 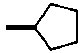 |
| A-81, A'-81, A"-81, A"'-81, A""-81, A""'-81 | 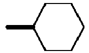 | 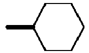 | 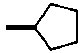 |
| A-82, A'-82, A"-82, A'"-82, A""-82, A""'-82 | -CH₃ | -CH₃ | 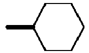 |
| A-83, A'-83, A"-83, A'"-83, A""-83, A""'-83 | -CH₂CH₃ | -CH₂CH₃ | 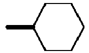 |
| A-84, A'-84, A"-84, A'"-84, A""-84, A""'-84 | *n*-propyl | *n*-propyl | 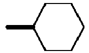 |
| A-85, A'-85, A"-85, A'"-85, A""-85, A""'-85 | *iso*-propyl | *iso*-propyl | 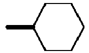 |
| A-86, A'-86, A"-86, A'"-86, A""-86, A""'-86 | *sec*-butyl | *sec*-butyl | 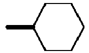 |
| A-87, A'-87, A"-87, A'"-87, A""-87, A""'-87 | *iso*-butyl | *iso*-butyl | 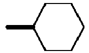 |
| A-88, A'-88, A"-88, A'"-88, A""-88, A""-88 | neopentyl | neopentyl | 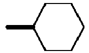 |
| A-89, A'-89, A"-89, A'"-89, A""-89, A""-89 | 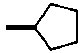 | 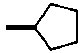 | 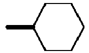 |
| A-90, A'-90, A"-90, A'"-90, A""-90, A""'-90 | 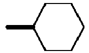 | 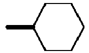 | 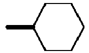 |
| A-91, A'-91, A"-91, A"'-91, A""-91, A""'-91 | -CH₃ | -CH₃ | *tert-*butyl |
| A-92, A'-92, A"-92, A'"-92, A""-92, A""'-92 | -CH₂CH₃ | -CH₂CH₃ | *tert-*butyl |
| A-93, A'-93, A"-93, A'"-93, A""-93, A""'-93 | *n*-propyl | *n*-propyl | *tert*-butyl |
| A-94, A'-94, A"-94, A'"-94, A""-94, A""'-94 | *iso*-propyl | *iso*-propyl | *tert*-butyl |
| A-95, A'-95, A"-95, A'"-95, A""-95, A""'-95 | *sec*-butyl | *sec*-butyl | *tert*-butyl |
| A-96, A'-96, A"-96, A'"-96, A""-96, A""'-96 | *iso*-butyl | *iso*-butyl | *tert*-butyl |
| A-97, A'-97, A"-97, A'"-97, A""-97, A""'-97 | neopentyl | neopentyl | *tert*-butyl |
| A-98, A'-98, A"-98, A'"-98, A""-98, A'""-98 | 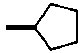 | 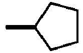 | *tert*-butyl |
| A-99, A'-99, A"-99, A'"-99, A""-99, A""-99 | 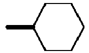 | 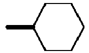 | *tert*-butyl |
| A-100, A'-100, A"-100, A"'-100, A""-100, A""'-100 | -CH₃ | -CH₃ | *tert*-amyl |
| A-101, A'-101, A"-101, A'"-101, A""-101, A""'-101 | -CH₂CH₃ | -CH₂CH₃ | *tert*-amyl |
| A-102, A'-102, A"-102, A'"-102, A""-102, A""'-102 | *n*-propyl | *n*-propyl | *tert*-amyl |
| A-103, A'-103, A"-103, A'"-103, A""-103, A""'-103 | *iso*-propyl | *iso*-propyl | *tert*-amyl |
| A-104, A'-104, A"-104, A'"-104, A""-104, A""'-104 | *sec*-butyl | *sec*-butyl | *tert*-amyl |
| A-105, A'-105, A"-105, A'"-105, A""-105, A""'-105 | *iso*-butyl | *iso*-butyl | *tert*-amyl |
| A-106, A'-106, A"-106, A"'-106, A""-106, A""'-106 | neopentyl | neopentyl | *tert*-amyl |
| A-107, A'-107, A"-107, A"'-107, A""-107, A""'-107 | 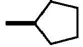 | 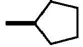 | *tert*-amyl |
| A-108, A'-108, A"-108, A"'-108, A""-108, A""'-108 | 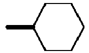 | 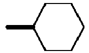 | *tert*-amyl |
| A-109, A'-109, A"-109, A"'-109, A""-109, A""'-109 | *tert*-butyl | *tert*-butyl | -CH₃ |
| A-110, A'-110, A"-110, A"'-110, A""-110, A""'-110 | *tert*-butyl | *tert*-butyl | -CH₂CH₃ |
| A-111, A'-111, A"-111, A"'-111, A""-111, A""'-111 | *tert*-butyl | *tert*-butyl | *n*-propyl |
| A-112, A'-112, A"-112, A"'-112, A""-112, A""'-112 | *tert*-butyl | *tert*-butyl | *iso*-propyl |
| A-113, A'-113, A"-113, A"'-113, A""-113, A""'-113 | *tert*-butyl | *tert*-butyl | *sec*-butyl |
| A-114, A'-114, A"-114, A"'-114, A""-114, A""'-114 | *tert*-butyl | *tert*-butyl | *iso*-butyl |
| A-115, A'-115, A"-115, A"'-115, A""-115, A""'-115 | *tert*-butyl | *tert*-butyl | neopentyl |
| A-116, A'-116, A"-116, A"'-116, A""-116, A""'-116 | *tert*-butyl | *tert*-butyl | 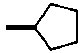 |
| A-117, A'-117, A"-117, A"'-117, A""-117, A""'-117 | *tert*-butyl | *tert*-butyl | 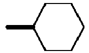 |
| A-118, A'-118, A"-118, A"'-118, A""-118, A""'-118 | *tert*-butyl | *tert*-butyl | *tert*-butyl |
| A-119, A'-119, A"-119, A"'-119, A""-119, A""'-119 | *tert*-butyl | *tert*-butyl | *tert*-amyl |
| A-120, A'-120, A"-120, A"'-120, A""-120, A""'-120 | *tert*-amyl | *tert*-amyl | -CH₃ |
| A-121, A'-121, A"-121, A"'-121, A""-121, A""'-121 | *tert*-amyl | *tert*-amyl | -CH₂CH₃ |
| A-122, A'-122, A"-122, A"'-122, A""-122, A""'-122 | *tert*-amyl | *tert*-amyl | *n*-propyl |
| A-123, A'-123, A"-123, A"'-123, A""-123, A""'-123 | *tert*-amyl | *tert*-amyl | *iso*-propyl |
| A-124, A'-124, A"-124, A"'-124, A""-124, A""'-124 | *tert*-amyl | *tert*-amyl | *sec*-butyl |
| A-125, A'-125, A"-125, A"'-125, A""-125, A""'-125 | *tert*-amyl | *tert*-amyl | *iso*-butyl |
| A-126, A'-126, A"-126, A"'-126, A""-126, A""'-126 | *tert*-amyl | *tert*-amyl | neopentyl |
| A-127, A'-127, A"-127, A"'-127, A""-127, A""'-127 | *tert*-amyl | *tert*-amyl | 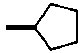 |
| A-128, A'-128, A"-128, A"'-128, A""-128, A""'-128 | *tert*-amyl | *tert*-amyl | 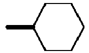 |
| A-129, A'-129, A"-129, A"'-129, A""-129, A""'-129 | *tert*-amyl | *tert*-amyl | *tert*-butyl |
| A-130, A'-130, A"-130, A"'-130, A""-130, A""'-130 | *tert*-amyl | *tert*-amyl | *tert*-amyl |
| A-131, A'-131, A"-131, A"'-131, A""-131, A""'-131 | *tert*-butyl | *tert*-butyl | H |
| A-132, A'-132, A"-132, A"'-132, A""-132, A""'-132 | *tert*-amyl | *tert*-amyl | H |
| A-133, A'-133, A"-133, A'''133, A""-133, A""'-133 | H | H | H |

Preferred compounds A, A', A", A"', A"" and A'"" are compounds A-1, A'-1, A"-1, A"'-1, A"" and A""'-1 to A-90, A'-90, A"-90, A"'-90, A""-90 and A""'-90. Further most preferred compounds are A-133, A'-133, A"-133, A""-133, A""-133 and A'""-133.

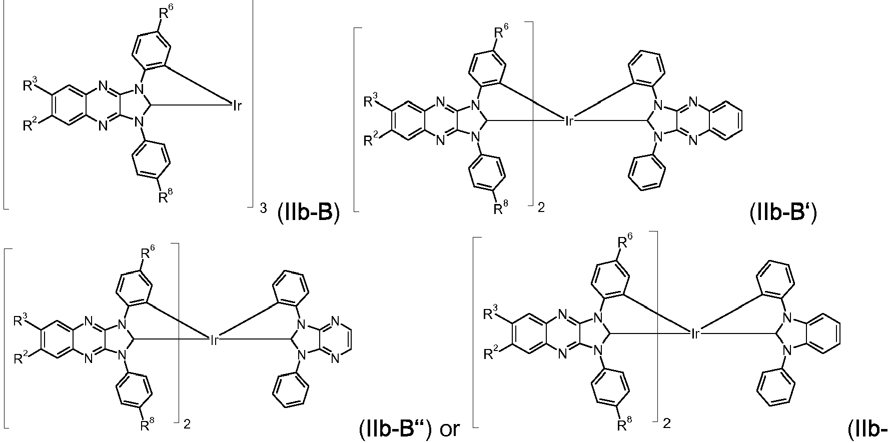

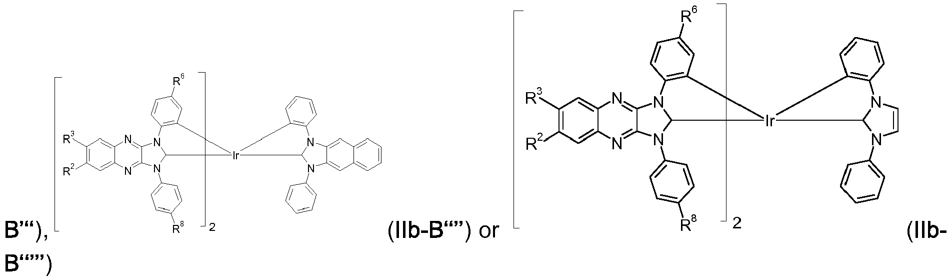

| **Cpd.** | **R³** | **R²** | **R⁶= R⁸** |
|---|---|---|---|
| B-1, B'-1, B"-1, B"'-1, B""-1, B""'-1 | -CH₃ | -CH₃ | H |
| B-2, B'-2, B"-2, B"'-2, B""-2, B""'-2 | -CH₂CH₃ | -CH₂CH₃ | H |
| B-3, B'-3, B"-3, B"'-3, B-""-3, B""'-3 | *n*-propyl | *n*-propyl | H |
| B-4, B'-4, B"-4, B"'-4, B""-4, B""'-4 | *iso*-propyl | *iso*-propyl | H |
| B-5, B'-5, B"-5, B"'-5, B""-5, B""'-5 | *sec*-butyl | *sec*-butyl | H |
| B-6, B'-6, B"-6, B"'-6, B""-6, B""'-6 | *iso*-butyl | *iso*-butyl | H |
| B-7, B'-7, B"-7, B"'-7, B""-7, B""'-7 | neopentyl | neopentyl | H |
| B-8, B'-8, B"-8, B"'-8, B""-8, B""'-8 | 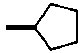 | 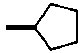 | H |
| B-9, B'-9, B"-9, B"'-9, B""-9, B""'-9 | 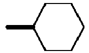 | 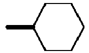 | H |
| B-10, B'-10, B"-10, B"'-10, B""-10, B""'-10 | -CH₃ | -CH₃ | -CH₃ |
| B-11, B'-11, B"-11, B"'-11, B""-11, B""'-11 | -CH₂CH₃ | -CH₂CH₃ | -CH₃ |
| B-12, B'-12, B"-12, B"'-12, B""-12, B'""-12 | *n*-propyl | *n*-propyl | -CH₃ |
| B-13, B'-13, B"-13, B"'-13, B""-13, B""'-13 | *iso*-propyl | *iso*-propyl | -CH₃ |
| B-14, B'-14, B"-14, B"'-14, B""-14, B""'-14 | *sec*-butyl | *sec*-butyl | -CH₃ |
| B-15, B'-15, B"-15, B"'-15, B""-15, B""'-15 | *iso*-butyl | *iso*-butyl | -CH₃ |
| B-16, B'-16, B"-16, B"'-16, B""-16, B""'-16 | neopentyl | neopentyl | -CH₃ |
| B-17, B'-17, B"-17, B"'-17, B""-17, B""'-17 | 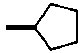 | 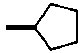 | -CH₃ |
| B-18, B'-18, B"-18, B"'-18, B""-18, B""'-18 | 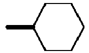 | 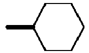 | -CH₃ |
| B-19, B'-19, B"-19, B"'-19, B""-19, B""'-19 | -CH₃ | -CH₃ | -CH₂CH₃ |
| B-20, B'-20, B"-20, B"'-20, B""-20, B""'-20 | -CH₂CH₃ | -CH₂CH₃ | -CH₂CH₃ |
| B-21, B'-21, B"-21, B"'-21, B""-21, B""'-21 | *n*-propyl | *n*-propyl | -CH₂CH₃ |
| B-22, B'-22, B"-22, B"'-22, B""-22, B""'-22 | *iso*-propyl | *iso*-propyl | -CH₂CH₃ |
| B-23, B'-23, B"-23, B"'-23, B""-23, B""'-23 | *sec*-butyl | *sec*-butyl | -CH₂CH₃ |
| B-24, B'-24, B"-24, B"'-24, B""-24, B""'-24 | *iso*-butyl | *iso*-butyl | -CH₂CH₃ |
| B-25, B'-25, B"-25, B"'-25, B""-25, B""'-25 | neopentyl | neopentyl | -CH₂CH₃ |
| B-26, B'-26, B"-26, B"'-26, B""-26, B""'-26 | 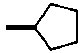 | 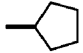 | -CH₂CH₃ |
| B-27, B'-27, B"-27, B"'-27, B""-27, B'""-27 | 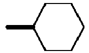 | 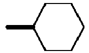 | -CH₂CH₃ |
| B-28, B'-28, B"-28, B"'-28, B""-28, B'""-28 | -CH₃ | -CH₃ | *n*-propyl |
| B-29, B'-29, B"-29, B"'-29, B""-29, B'""-29 | -CH₂CH₃ | -CH₂CH₃ | *n*-propyl |
| B-30, B'-30, B"-30, B"'-30, B""-30, B""'-30 | *n*-propyl | *n*-propyl | *n*-propyl |
| B-31, B'-31, B"-31, B"'-31, B""-31, B""'-31 | *iso*-propyl | *iso*-propyl | *n*-propyl |
| B-32, B'-32, B"-32, B"'-32, B""-32, B""'-32 | *sec*-butyl | *sec*-butyl | *n*-propyl |
| B-33, B'-33, B"-33, B"'-33, B""-33, B""'-33 | *iso*-butyl | *iso*-butyl | *n*-propyl |
| B-34, B'-34, B"-34, B"'-34, B""-34, B""'-34 | neopentyl | neopentyl | *n*-propyl |
| B-35, B'-35, B"-35, B"'-35, B""-35, B""'-35 | 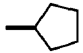 | 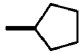 | *n*-propyl |
| B-36, B'-36, B"-36, B"'-36, B""-36, B""'-36 | 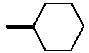 | 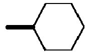 | *n*-propyl |
| B-37, B'-37, B"-37, B"'-37, B""-37, B""'-37 | -CH₃ | -CH₃ | *iso*-propyl |
| B-38, B'-38, B"-38, B"'-38, B""-38, B""'-38 | -CH₂CH₃ | -CH₂CH₃ | *iso*-propyl |
| B-39, B'-39, B"-39, B"'-39, B""-39, B""'-39 | *n*-propyl | *n*-propyl | *iso*-propyl |
| B-40, B'-40, B"-40, B"'-40, B""-40, B""'-40 | *iso*-propyl | *iso*-propyl | *iso*-propyl |
| B-41, B'-41, B"-41, B"'-41, B""-41, B""'-41 | *sec*-butyl | *sec*-butyl | *iso*-propyl |
| B-42, B'-42, B"-42, B"'-42, B""-42, B""'-42 | *iso*-butyl | *iso*-butyl | *iso*-propyl |
| B-43, B'-43, B"-43, B"'-43, B""-43, B""'-43 | neopentyl | neopentyl | *iso*-propyl |
| B-44, B'-44, B"-44, B"'-44, B""-44, B""'-44 | 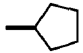 | 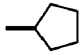 | *iso*-propyl |
| B-45, B'-45, B"-45, B"'-45, B""-45, B""'-45 | 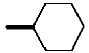 | 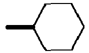 | *iso*-propyl |
| B-46, B'-46, B"-46 B"'-46, B""-46, B""'-46 | -CH₃ | -CH₃ | *sec*-butyl |
| B-47, B'-47, B"-47, B"'-47, B""-47, B""'-47 | -CH₂CH₃ | -CH₂CH₃ | *sec*-butyl |
| B-48, B'-48, B"-48, B"'-48, B""-48, B""'-48 | *n*-propyl | *n*-propyl | *sec*-butyl |
| B-49, B'-49, B"-49, B'"-49, B""-49, B""'-49 | *iso*-propyl | *iso*-propyl | *sec-*butyl |
| B-50, B'-50, B"-50, B"'-50, B""-50, B""'-50 | *sec*-butyl | *sec*-butyl | *sec*-butyl |
| B-51, B'-51, B"-51, B"'-51, B""-51, B""'-51 | *iso*-butyl | *iso*-butyl | *sec*-butyl |
| B-52, B'-52, B"-52, B"'-52, B""-52, B""'-52 | neopentyl | neopentyl | *sec*-butyl |
| B-53, B'-53, B"-53, B"'-53, B""-53, B""'-53 | 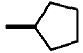 | 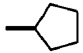 | *sec*-butyl |
| B-54, B'-54, B"-54, B"'-54, B""-54, B""'-54 | 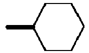 | 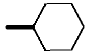 | *sec*-butyl |
| B-55, B'-55, B"-55, B"'-55, B""-55, B""'-55 | -CH₃ | -CH₃ | *iso*-butyl |
| B-56, B'-56, B"-56, B"'-56, B""-56, B""'-56 | -CH₂CH₃ | -CH₂CH₃ | *iso*-butyl |
| B-57, B'-57, B"-57, B"'-57, B""-57, B""'-57 | *n*-propyl | *n*-propyl | *iso*-butyl |
| B-58, B'-58, B"-58, B"'-58, B""-58, B""'-58 | *iso*-propyl | *iso*-propyl | *iso*-butyl |
| B-59, B'-59, B"-59, B"'-59, B""-59, B""'-59 | *sec*-butyl | *sec*-butyl | *iso*-butyl |
| B-60, B'-60, B"-60, B"'-60, B""-60, B""'-60 | *iso*-butyl | *iso*-butyl | *iso*-butyl |
| B-61, B'-61, B"-61, B"'-61, B""-61, B""'-61 | neopentyl | neopentyl | *iso*-butyl |
| B-62, B'-62, B"-62, B"'-62, B""-62, B""'-62 | 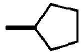 | 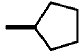 | *iso*-butyl |
| B-63, B'-63, B"-63, B"'-63, B""-63, B""'-63 | 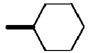 | 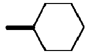 | *iso*-butyl |
| B-64, B'-64, B"-64, B"'-64, B""-64, B""'-64 | -CH₃ | -CH₃ | neopentyl |
| B-65, B'-65, B"-65, B"'-65, B""-65, B""'-65 | -CH₂CH₃ | -CH₂CH₃ | neopentyl |
| B-66, B'-66, B"-66, B"'-66, B""-66, B""'-66 | *n*-propyl | *n*-propyl | neopentyl |
| B-67, B'-67, B"-67, B"'-67, B""-67, B""'-67 | *iso*-propyl | *iso*-propyl | neopentyl |
| B-68, B'-68, B"-68, B"'-68, B""-68, B'""-68 | *sec*-butyl | *sec*-butyl | neopentyl |
| B-69, B'-69, B"-69, B"'-69, B""-69, B""'-69 | *iso*-butyl | *iso*-butyl | neopentyl |
| B-70, B'-70, B"-70, B"'-70, B""-70, B""'-70 | neopentyl | neopentyl | neopentyl |
| B-71, B'-71, B"-71, B"'-71, B""-71, B""'-71 | 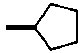 | 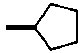 | neopentyl |
| B-72, B'-72, B"-72, B"'-72, B""-72, B""'-72 | 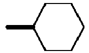 | 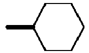 | neopentyl |
| B-73, B'-73, B"-73, B"'-73, B""-73, B""'-73 | -CH₃ | -CH₃ | 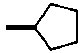 |
| B-74, B'-74, B"-74, B"'-74, B""-74, B""'-74 | -CH₂CH₃ | -CH₂CH₃ | 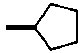 |
| B-75, B'-75, B"-75, B"'-75, B""-75, B""'-75 | *n*-propyl | *n*-propyl | 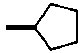 |
| B-76, B'-76, B"-76, B"'-76, B""-76, B""'-76 | *iso*-propyl | *iso*-propyl | 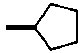 |
| B-77, B'-77, B"-77, B"'-77, B""-77, B""'-77 | *sec*-butyl | *sec*-butyl | 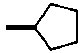 |
| B-78, B'-78, B"-78, B"'-78, B""-78, B""'-78 | *iso*-butyl | *iso*-butyl | 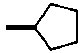 |
| B-79, B'-79, B"-79, B"'-79, B""-79, B""'-79 | neopentyl | neopentyl | 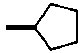 |
| B-80, B'-80, B"-80, B"'-80, B""-80, B""'-80 | 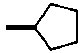 | 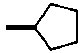 | 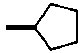 |
| B-81, B'-81, B"-81, B"'-81, B""-81, B""'-81 | 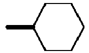 | 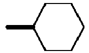 | 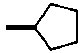 |
| B-82, B'-82, B"-82, B"'-82, B""-82, B""'-82 | -CH₃ | -CH₃ | 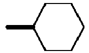 |
| B-83, B'-83, B"-83, B"'-83, B""-83, B""'-83 | -CH₂CH₃ | -CH₂CH₃ | 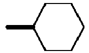 |
| B-84, B'-84, B"-84, B"'-84, B""-84, B""'-84 | *n*-propyl | *n*-propyl | 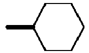 |
| B-85, B'-85, B"-85, B"'-85, B""-85, B""'-85 | *iso*-propyl | *iso*-propyl | 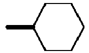 |
| B-86, B'-86, B"-86, B"'-86, B""-86, B""'-86 | *sec*-butyl | *sec*-butyl | 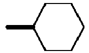 |
| B-87, B'-87, B"-87, B"'-87, B""-87, B""'-87 | *iso*-butyl | *iso*-butyl | 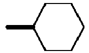 |
| B-88, B'-88, B"-88, B"'-88, B""-88, B""'-88 | neopentyl | neopentyl | 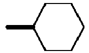 |
| B-89, B'-89, B"-89, B"'-89, B""-89, B""'-89 | 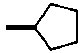 | 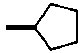 | 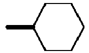 |
| B-90, B'-90, B"-90, B"'-90, B""-90, B""'-90 | 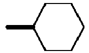 | 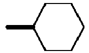 | 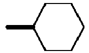 |
| B-91, B'-91, B"-91, B"'-91, B""-91, B""'-91 | -CH₃ | -CH₃ | *tert*-butyl |
| B-92, B'-92, B"-92, B"'-92, B""-92, B""'-92 | -CH₂CH₃ | -CH₂CH₃ | *tert*-butyl |
| B-93, B'-93, B"-93, B"'-93, B""-93, B""'-93 | *n*-propyl | *n*-propyl | *tert-*butyl |
| B-94, B'-94, B"-94, B"'-94, B""-94, B""'-94 | *iso*-propyl | *iso*-propyl | *tert*-butyl |
| B-95, B'-95, B"-95, B"'-95, B""-95, B""'-95 | *sec*-butyl | *sec*-butyl | *tert*-butyl |
| B-96, B'-96, B"-96, B"'-96, B""-96, B""'-96 | *iso*-butyl | *iso*-butyl | *tert*-butyl |
| B-97, B'-97, B"-97, B"'-97, B""-97, B""'-97 | neopentyl | neopentyl | *tert*-butyl |
| B-98, B'-98, B"-98, B"'-98, B""-98, B""'-98 | 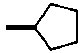 | 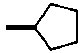 | *tert*-butyl |
| B-99, B'-99, B"-99, B"'-99, B""-99, B""'-99 | 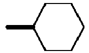 | 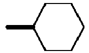 | *tert*-butyl |
| B-100, B'-100, B"-100, B"'-100, B""-100, B""'-100 | -CH₃ | -CH₃ | *tert*-amyl |
| B-101, B'-101, B"-101, B"'-101, B""-101, B""'-101 | -CH₂CH₃ | -CH₂CH₃ | *tert*-amyl |
| B-102, B'-102, B"-102, B"'-102, B""-102, B""'-102 | *n*-propyl | *n*-propyl | *tert*-amyl |
| B-103, B'-103, B"-103, B"'-103, B""-103, B""'-103 | *iso*-propyl | *iso*-propyl | *tert*-amyl |
| B-104, B'-104, B"-104, B"'-104, B""-104, B""'-104 | *sec*-butyl | *sec*-butyl | *tert*-amyl |
| B-105, B'-105, B"-105, B"'-105, B""-105, B""'-105 | *iso*-butyl | *iso*-butyl | *tert*-amyl |
| B-106, B'-106, B"-106, B"'-106, B""-106, B""'-106 | neopentyl | neopentyl | *tert*-amyl |
| B-107, B'-107, B"-107, B"'-107, B""-107, B""'-107 | 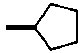 | 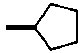 | *tert*-amyl |
| B-108, B'-108, B"-108, B"'-108, B""-108, B""'-108 | 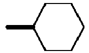 | 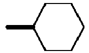 | *tert*-amyl |

Preferred compounds B, B', B", B'", B"" and B""' are compounds B-1, B'-1, B"-1, B"'-1, B""-1 and B""'-1 to B-90, B'-90, B"-90, B"'-90, B""-90 and B""'-90.

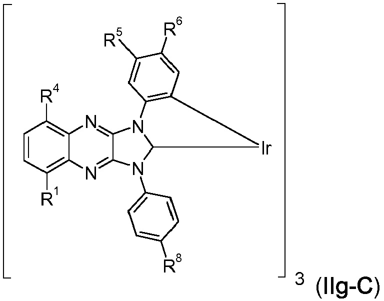

| **Cpd.** | **R4** | **R¹** | **R⁵ = R⁶ =R⁸** |
|---|---|---|---|
| C-1 | -CH₃ | -CH₃ | H |
| C-2 | -CH₂CH₃ | -CH₂CH₃ | H |
| C-3 | *n*-propyl | *n*-propyl | H |
| C-4 | *iso*-propyl | *iso*-propyl | H |
| C-5 | *sec*-butyl | *sec*-butyl | H |
| C-6 | *iso*-butyl | *iso*-butyl | H |
| C-7 | neopentyl | Neopentyl | H |
| C-8 | 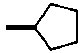 | 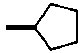 | H |
| C-9 | 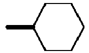 | 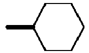 | H |
| C-10 | -CH₃ | -CH₃ | -CH₃ |
| C-11 | -CH₂CH₃ | -CH₂CH₃ | -CH₃ |
| C-12 | *n*-propyl | *n*-propyl | -CH₃ |
| C-13 | *iso*-propyl | *iso*-propyl | -CH₃ |
| C-14 | *sec*-butyl | *sec*-butyl | -CH₃ |
| C-15 | *iso*-butyl | *iso*-butyl | -CH₃ |
| C-16 | neopentyl | Neopentyl | -CH₃ |
| C-17 | 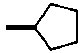 | 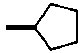 | -CH₃ |
| C-18 | 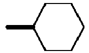 | 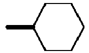 | -CH₃ |
| C-19 | -CH₃ | -CH₃ | -CH₂CH₃ |
| C-20 | -CH₂CH₃ | -CH₂CH₃ | -CH₂CH₃ |
| C-21 | *n*-propyl | *n*-propyl | -CH₂CH₃ |
| C-22 | *iso*-propyl | *iso*-propyl | -CH₂CH₃ |
| C-23 | *sec*-butyl | *sec*-butyl | -CH₂CH₃ |
| C-24 | *iso*-butyl | *iso*-butyl | -CH₂CH₃ |
| C-25 | neopentyl | Neopentyl | -CH₂CH₃ |
| C-26 | 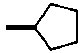 | 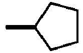 | -CH₂CH₃ |
| C-27 | 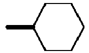 | 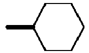 | -CH₂CH₃ |
| C-28 | -CH₃ | -CH₃ | *n*-propyl |
| C-29 | -CH₂CH₃ | -CH₂CH₃ | *n*-propyl |
| C-30 | *n*-propyl | *n*-propyl | *n*-propyl |
| C-31 | *iso*-propyl | *iso*-propyl | *n*-propyl |
| C-32 | *sec*-butyl | *sec*-butyl | *n*-propyl |
| C-33 | *iso*-butyl | *iso*-butyl | *n*-propyl |
| C-34 | neopentyl | Neopentyl | *n*-propyl |
| C-35 | 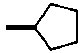 | 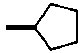 | *n*-propyl |
| C-36 | 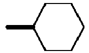 | 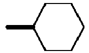 | *n*-propyl |
| C-37 | -CH₃ | -CH₃ | *iso*-propyl |
| C-38 | -CH₂CH₃ | -CH₂CH₃ | *iso*-propyl |
| C-39 | *n*-propyl | *n*-propyl | *iso*-propyl |
| C-40 | *iso*-propyl | *iso*-propyl | *iso*-propyl |
| C-41 | *sec*-butyl | *sec*-butyl | *iso*-propyl |
| C-42 | *iso*-butyl | *iso*-butyl | *iso*-propyl |
| C-43 | neopentyl | Neopentyl | *iso*-propyl |
| C-44 | 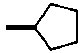 | 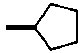 | *iso*-propyl |
| C-45 | 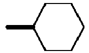 | 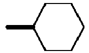 | *iso*-propyl |
| C-46 | -CH₃ | -CH₃ | *sec*-butyl |
| C-47 | -CH₂CH₃ | -CH₂CH₃ | *sec*-butyl |
| C-48 | *n*-propyl | *n*-propyl | *sec*-butyl |
| C-49 | *iso*-propyl | *iso*-propyl | *sec*-butyl |
| C-50 | *sec*-butyl | *sec*-butyl | *sec*-butyl |
| C-51 | *iso*-butyl | *iso*-butyl | *sec*-butyl |
| C-52 | neopentyl | Neopentyl | *sec*-butyl |
| C-53 | 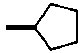 | 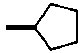 | *sec*-butyl |
| C-54 | 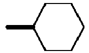 | 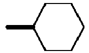 | *sec*-butyl |
| C-55 | -CH₃ | -CH₃ | *iso*-butyl |
| C-56 | -CH₂CH₃ | -CH₂CH₃ | *iso*-butyl |
| C-57 | *n*-propyl | *n*-propyl | *iso*-butyl |
| C-58 | *iso*-propyl | *iso*-propyl | *iso*-butyl |
| C-59 | *sec*-butyl | *sec*-butyl | *iso*-butyl |
| C-60 | *iso*-butyl | *iso*-butyl | *iso*-butyl |
| C-61 | neopentyl | Neopentyl | *iso*-butyl |
| C-62 | 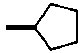 | 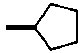 | *iso*-butyl |
| C-63 | 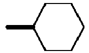 | 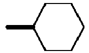 | *iso*-butyl |
| C-64 | -CH₃ | -CH₃ | neopentyl |
| C-65 | -CH₂CH₃ | -CH₂CH₃ | neopentyl |
| C-66 | *n*-propyl | *n*-propyl | neopentyl |
| C-67 | *iso*-propyl | *iso*-propyl | neopentyl |
| C-68 | *sec*-butyl | *sec*-butyl | neopentyl |
| C-69 | *iso*-butyl | *iso*-butyl | neopentyl |
| C-70 | neopentyl | Neopentyl | neopentyl |
| C-71 | 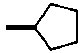 | 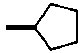 | neopentyl |
| C-72 | 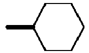 | 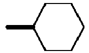 | neopentyl |
| C-73 | -CH₃ | -CH₃ | 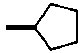 |
| C-74 | -CH₂CH₃ | -CH₂CH₃ | 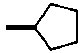 |
| C-75 | *n*-propyl | *n*-propyl | 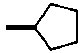 |
| C-76 | *iso*-propyl | *iso*-propyl | 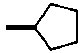 |
| C-77 | *sec*-butyl | *sec*-butyl | 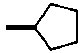 |
| C-78 | *iso*-butyl | *iso*-butyl | 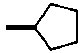 |
| C-79 | neopentyl | Neopentyl | 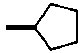 |
| C-80 | 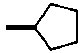 | 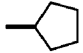 | 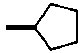 |
| C-81 | 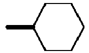 | 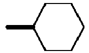 | 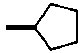 |
| C-82 | -CH₃ | -CH₃ | 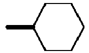 |
| C-83 | -CH₂CH₃ | -CH₂CH₃ | 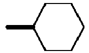 |
| C-84 | *n*-propyl | *n*-propyl | 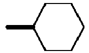 |
| C-85 | *iso*-propyl | *iso*-propyl | 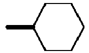 |
| C-86 | *sec*-butyl | *sec*-butyl | 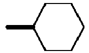 |
| C-87 | *iso*-butyl | *iso*-butyl | 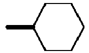 |
| C-88 | neopentyl | Neopentyl | 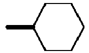 |
| C-89 | 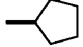 | 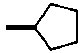 | 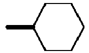 |
| C-90 | 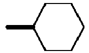 | 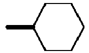 | 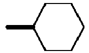 |
| C-91 | *tert*-butyl | *tert*-butyl | -CH₃ |
| C-92 | *tert*-butyl | *tert*-butyl | -CH₂CH₃ |
| C-93 | *tert*-butyl | *tert*-butyl | *n*-propyl |
| C-94 | *tert*-butyl | *tert*-butyl | *iso*-propyl |
| C-95 | *tert*-butyl | *tert*-butyl | *sec*-butyl |
| C-96 | *tert*-butyl | *tert*-butyl | *iso*-butyl |
| C-97 | *tert*-butyl | *tert*-butyl | neopentyl |
| C-98 | *tert*-butyl | *tert*-butyl | 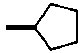 |
| C-99 | *tert*-butyl | *tert*-butyl | 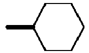 |
| C-100 | *tert*-amyl | *tert*-amyl | -CH₃ |
| C-101 | *tert*-amyl | *tert*-amyl | -CH₂CH₃ |
| C-102 | *tert*-amyl | *tert*-amyl | *n*-propyl |
| C-103 | *tert*-amyl | *tert*-amyl | *iso*-propyl |
| C-104 | *tert*-amyl | *tert*-amyl | *sec*-butyl |
| C-105 | *tert*-amyl | *tert*-amyl | *iso*-butyl |
| C-106 | *tert*-amyl | *tert*-amyl | neopentyl |
| C-107 | *tert*-amyl | *tert*-amyl | 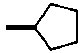 |
| C-108 | *tert*-amyl | *tert*-amyl | 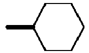 |
| C-109 | H | H | H |

Preferred compounds C are C-1 to C-90. Further, most preferred is compound C-109.

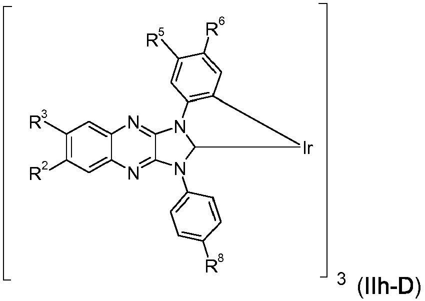

| **Cpd.** | **R³** | **R²** | **R⁵=R⁶**=R⁸ |
|---|---|---|---|
| D-1 | -CH₃ | -CH₃ | H |
| D-2 | -CH₂CH₃ | -CH₂CH₃ | H |
| D-3 | *n*-propyl | *n*-propyl | H |
| D-4 | *iso*-propyl | *iso*-propyl | H |
| D-5 | *sec*-butyl | *sec*-butyl | H |
| D-6 | *iso*-butyl | *iso*-butyl | H |
| D-7 | neopentyl | Neopentyl | H |
| D-8 | 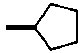 | 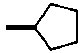 | H |
| D-9 | 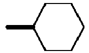 | 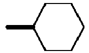 | H |
| D-10 | -CH₃ | -CH₃ | -CH₃ |
| D-11 | -CH₂CH₃ | -CH₂CH₃ | -CH₃ |
| D-12 | *n*-propyl | *n*-propyl | -CH₃ |
| D-13 | *iso*-propyl | *iso*-propyl | -CH₃ |
| D-14 | *sec*-butyl | *sec*-butyl | -CH₃ |
| D-15 | *iso*-butyl | *iso*-butyl | -CH₃ |
| D-16 | neopentyl | Neopentyl | -CH₃ |
| D-17 | 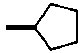 | 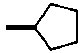 | -CH₃ |
| D-18 | 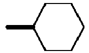 | 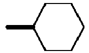 | -CH₃ |
| D-19 | -CH₃ | -CH₃ | -CH₂CH₃ |
| D-20 | -CH₂CH₃ | -CH₂CH₃ | -CH₂CH₃ |
| D-21 | *n*-propyl | *n*-propyl | -CH₂CH₃ |
| D-22 | *iso*-propyl | *iso*-propyl | -CH₂CH₃ |
| D-23 | *sec*-butyl | *sec*-butyl | -CH₂CH₃ |
| D-24 | *iso*-butyl | *iso*-butyl | -CH₂CH₃ |
| D-25 | neopentyl | Neopentyl | -CH₂CH₃ |
| D-26 | 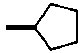 | 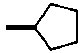 | -CH₂CH₃ |
| D-27 | 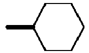 | 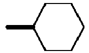 | -CH₂CH₃ |
| D-28 | -CH₃ | -CH₃ | *n*-propyl |
| D-29 | -CH₂CH₃ | -CH₂CH₃ | *n*-propyl |
| D-30 | *n*-propyl | *n*-propyl | *n*-propyl |
| D-31 | *iso*-propyl | *iso*-propyl | *n*-propyl |
| D-32 | *sec*-butyl | *sec*-butyl | *n*-propyl |
| D-33 | *iso*-butyl | *iso*-butyl | *n*-propyl |
| D-34 | neopentyl | Neopentyl | *n*-propyl |
| D-35 | 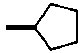 | 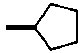 | *n*-propyl |
| D-36 | 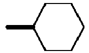 | 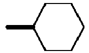 | *n*-propyl |
| D-37 | -CH₃ | -CH₃ | *iso*-propyl |
| D-38 | -CH₂CH₃ | -CH₂CH₃ | *iso*-propyl |
| D-39 | *n*-propyl | *n*-propyl | *iso*-propyl |
| D-40 | *iso*-propyl | *iso*-propyl | *iso*-propyl |
| D-41 | *sec*-butyl | *sec*-butyl | *iso*-propyl |
| D-42 | *iso*-butyl | *iso*-butyl | *iso*-propyl |
| D-43 | neopentyl | Neopentyl | *iso*-propyl |
| D-44 | 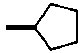 | 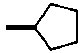 | *iso*-propyl |
| D-45 | 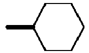 | 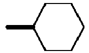 | *iso*-propyl |
| D-46 | -CH₃ | -CH₃ | *sec*-butyl |
| D-47 | -CH₂CH₃ | -CH₂CH₃ | *sec*-butyl |
| D-48 | *n*-propyl | *n*-propyl | *sec*-butyl |
| D-49 | *iso*-propyl | *iso*-propyl | *sec*-butyl |
| D-50 | *sec*-butyl | *sec*-butyl | *sec*-butyl |
| D-51 | *iso*-butyl | *iso*-butyl | *sec*-butyl |
| D-52 | neopentyl | Neopentyl | *sec*-butyl |
| D-53 | 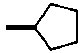 | 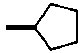 | *sec*-butyl |
| D-54 | 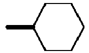 | 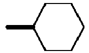 | *sec*-butyl |
| D-55 | -CH₃ | -CH₃ | *iso*-butyl |
| D-56 | -CH₂CH₃ | -CH₂CH₃ | *iso*-butyl |
| D-57 | *n*-propyl | *n*-propyl | *iso*-butyl |
| D-58 | *iso*-propyl | *iso*-propyl | *iso*-butyl |
| D-59 | *sec*-butyl | *sec*-butyl | *iso*-butyl |
| D-60 | *iso*-butyl | *iso*-butyl | *iso*-butyl |
| D-61 | neopentyl | Neopentyl | *iso*-butyl |
| D-62 | 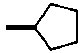 | 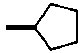 | *iso*-butyl |
| D-63 | 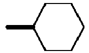 | 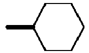 | *iso*-butyl |
| D-64 | -CH₃ | -CH₃ | neopentyl |
| D-65 | -CH₂CH₃ | -CH₂CH₃ | neopentyl |
| D-66 | *n*-propyl | *n*-propyl | neopentyl |
| D-67 | *iso*-propyl | *iso*-propyl | neopentyl |
| D-68 | *sec*-butyl | *sec*-butyl | neopentyl |
| D-69 | *iso*-butyl | *iso*-butyl | neopentyl |
| D-70 | neopentyl | Neopentyl | neopentyl |
| D-71 | 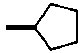 | 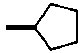 | neopentyl |
| D-72 | 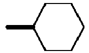 | 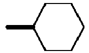 | neopentyl |
| D-73 | -CH₃ | -CH₃ | 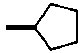 |
| D-74 | -CH₂CH₃ | -CH₂CH₃ | 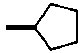 |
| D-75 | *n*-propyl | *n*-propyl | 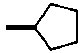 |
| D-76 | *iso*-propyl | *iso*-propyl | 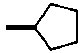 |
| D-77 | *sec*-butyl | *sec*-butyl | 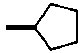 |
| D-78 | *iso*-butyl | *iso*-butyl | 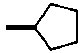 |
| D-79 | neopentyl | Neopentyl | 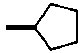 |
| D-80 | 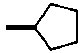 | 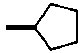 | 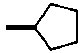 |
| D-81 | 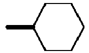 | 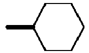 | 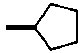 |
| D-82 | -CH₃ | -CH₃ | 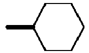 |
| D-83 | -CH₂CH₃ | -CH₂CH₃ | 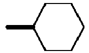 |
| D-84 | *n*-propyl | *n*-propyl | 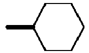 |
| D-85 | *iso*-propyl | *iso*-propyl | 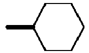 |
| D-86 | *sec*-butyl | *sec*-butyl | 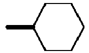 |
| D-87 | *iso*-butyl | *iso*-butyl | 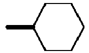 |
| D-88 | neopentyl | Neopentyl | 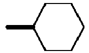 |
| D-89 | 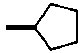 | 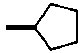 | 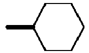 |
| D-90 | 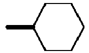 | 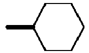 | 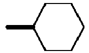 |

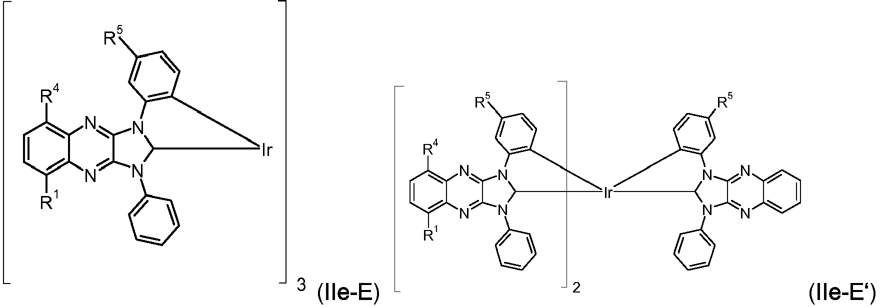

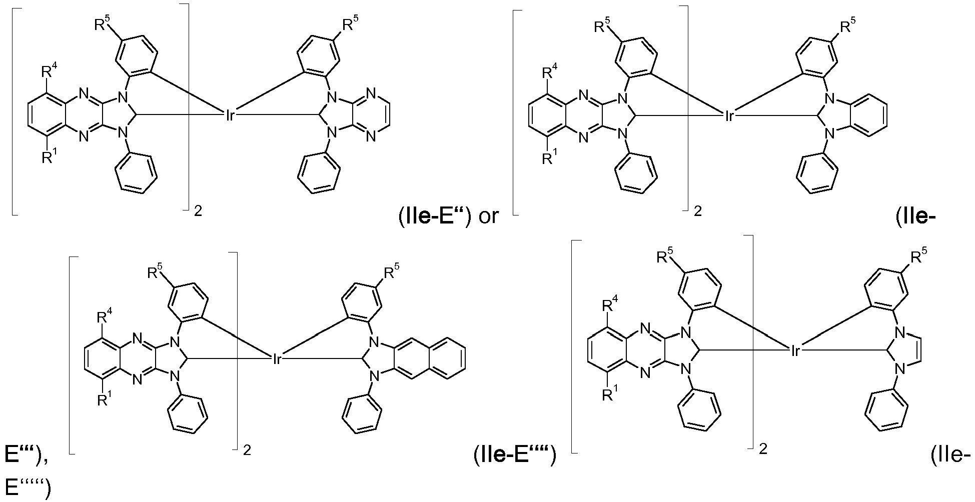

| **Cpd.** | **R⁴** | **R¹** | **R⁵** |
|---|---|---|---|
| E-1, E'-1, E"-1, E"'-1, E""-1, E""'-1 | -CH₃ | -CH₃ | H |
| E-2, E'-2, E"-2, E"'-2, E""-2, E""'-2 | -CH₂CH₃ | -CH₂CH₃ | H |
| E-3, E'-3, E"-3, E"'-3, E-""-3, E""'-3 | *n*-propyl | *n*-propyl | H |
| E-4, E'-4, E"-4, E"'-4, E""-4, E""'-4 | *iso*-propyl | *iso*-propyl | H |
| E-5, E'-5, E"-5, E"'-5, E""-5, E""'-5 | *sec*-butyl | *sec*-butyl | H |
| E-6, E'-6, E"-6, E"'-6, E""-6, E""'-6 | *iso*-butyl | *iso*-butyl | H |
| E-7, E'-7, E"-7, E"'-7, E""-7, E""'-7 | neopentyl | neopentyl | H |
| E-8, E'-8, E"-8, E"'-8, E""-8, E""'-8 | 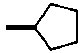 | 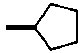 | H |
| E-9, E'-9, E"-9, E"'-9, E""-9, E""'-9 | 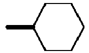 | 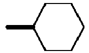 | H |
| E-10, E'-10, E"-10, E"'-10, E""-10, E""'-10 | -CH₃ | -CH₃ | -CH₃ |
| E-11, E'-11, E"-11, E"'-11, E""-11, E""'-11 | -CH₂CH₃ | -CH₂CH₃ | -CH₃ |
| E-12, E'-12, E"-12, E"'-12, E""-12, E""'-12 | *n*-propyl | *n*-propyl | -CH₃ |
| E-13, E'-13, E"-13, E"'-13, E""-13, E""'-13 | *iso*-propyl | *iso*-propyl | -CH₃ |
| E-14, E'-14, E"-14, E"'-14, E""-14, E""'-14 | *sec*-butyl | *sec*-butyl | -CH₃ |
| E-15, E'-15, E"-15, E"'-15, E""-15, E""'-15 | *iso*-butyl | *iso*-butyl | -CH₃ |
| E-16, E'-16, E"-16, E"'-16, E""-16, E""'-16 | neopentyl | neopentyl | -CH₃ |
| E-17, E'-17, E"-17, E"'-17, E""-17, E""'-17 | 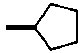 | 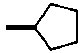 | -CH₃ |
| E-18, E'-18, E"-18, E"'-18, E""-18, E""'-18 | 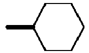 | 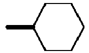 | -CH₃ |
| E-19, E'-19, E"-19, E"'-19, E""-19, E""'-19 | -CH₃ | -CH₃ | -CH₂CH₃ |
| E-20, E'-20, E"-20, E"'-20, E""-20, E""'-20 | -CH₂CH₃ | -CH₂CH₃ | -CH₂CH₃ |
| E-21, E'-21, E"-21, E"'-21, E""-21, E""'-21 | *n*-propyl | *n*-propyl | -CH₂CH₃ |
| E-22, E'-22, E"-22, E'"-22, E""-22, E""'-22 | *iso*-propyl | *iso*-propyl | -CH₂CH₃ |
| E-23, E'-23, E"-23, E"'-23, E""-23, E""'-23 | *sec*-butyl | *sec*-butyl | -CH₂CH₃ |
| E-24, E'-24, E"-24, E"'-24, E""-24, E""'-24 | *iso*-butyl | *iso*-butyl | -CH₂CH₃ |
| E-25, E'-25, E"-25, E"'-25, E""-25, E""'-25 | neopentyl | neopentyl | -CH₂CH₃ |
| E-26, E'-26, E"-26, E"'-26, E""-26, E""'-26 | 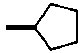 | 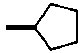 | -CH₂CH₃ |
| E-27, E'-27, E"-27, E"'-27, E""-27, E""'-27 | 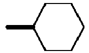 | 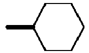 | -CH₂CH₃ |
| E-28, E'-28, E"-28, E"'-28, E""-28, E""'-28 | -CH₃ | -CH₃ | *n*-propyl |
| E-29, E'-29, E"-29, E"'-29, E""-29, E""'-29 | -CH₂CH₃ | -CH₂CH₃ | *n*-propyl |
| E-30, E'-30, E"-30, E"'-30, E""-30, E""'-30 | *n*-propyl | *n*-propyl | *n*-propyl |
| E-31, E'-31, E"-31, E"'-31, E""-31, E""'-31 | *iso*-propyl | *iso*-propyl | *n*-propyl |
| E-32, E'-32, E"-32, E"'-32, E""-32, E""'-32 | *sec*-butyl | *sec*-butyl | *n*-propyl |
| E-33, E'-33, E"-33, E"'-33, E""-33, E""'-33 | *iso*-butyl | *iso*-butyl | *n*-propyl |
| E-34, E'-34, E"-34, E"'-34, E""-34, E""'-34 | neopentyl | neopentyl | *n*-propyl |
| E-35, E'-35, E"-35, E"'-35, E""-35, E""'-35 | 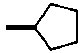 | 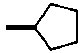 | *n*-propyl |
| E-36, E'-36, E"-36, E"'-36, E""-36, E""'-36 | 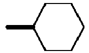 | 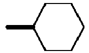 | *n*-propyl |
| E-37, E'-37, E"-37, E"'-37, E""-37, E""'-37 | -CH₃ | -CH₃ | *iso*-propyl |
| E-38, E'-38, E"-38, E"'-38, E""-38, E""'-38 | -CH₂CH₃ | -CH₂CH₃ | *iso*-propyl |
| E-39, E'-39, E"-39, E"'-39, E""-39, E""'-39 | *n*-propyl | *n*-propyl | *iso*-propyl |
| E-40, E'-40, E"-40, E"'-40, E""-40, E""'-40 | *iso*-propyl | *iso*-propyl | *iso*-propyl |
| E-41, E'-41, E"-41, E"'-41, E""-41, E""'-41 | *sec*-butyl | *sec*-butyl | *iso*-propyl |
| E-42, E'-42, E"-42, E"'-42, E""-42, E""'-42 | *iso*-butyl | *iso*-butyl | *iso*-propyl |
| E-43, E'-43, E"-43, E"'-43, E""-43, E""'-43 | neopentyl | neopentyl | *iso*-propyl |
| E-44, E'-44, E"-44, E"'-44, E""-44, E""'-44 | 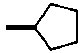 | 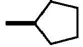 | *iso*-propyl |
| E-45, E'-45, E"-45, E"'-45, E""-45, E""'-45 | 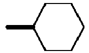 | 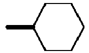 | *iso*-propyl |
| E-46, E'-46, E"-46 E"'-46, E""-46, E""'-46 | -CH₃ | -CH₃ | *sec*-butyl |
| E-47, E'-47, E"-47, E"'-47, E""-47, E""'-47 | -CH₂CH₃ | -CH₂CH₃ | *sec*-butyl |
| E-48, E'-48, E"-48, E"'-48, E""-48, E""'-48 | *n*-propyl | *n*-propyl | *sec*-butyl |
| E-49, E'-49, E"-49, E"'-49, E""-49, E""'-49 | *iso*-propyl | *iso*-propyl | *sec*-butyl |
| E-50, E'-50, E"-50, E"'-50, E""-50, E""'-50 | *sec*-butyl | *sec*-butyl | *sec*-butyl |
| E-51, E'-51, E"-51, E"'-51, E""-51, E""'-51 | *iso*-butyl | *iso*-butyl | *sec*-butyl |
| E-52, E'-52, E"-52, E"'-52, E""-52, E""'-52 | neopentyl | neopentyl | *sec*-butyl |
| E-53, E'-53, E"-53, E"'-53, E""-53, E""'-53 | 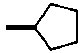 | 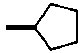 | *sec*-butyl |
| E-54, E'-54, E"-54, E"'-54, E""-54, E""'-54 | 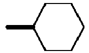 | 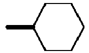 | *sec*-butyl |
| E-55, E'-55, E"-55, E"'-55, E""-55, E""'-55 | -CH₃ | -CH₃ | *iso*-butyl |
| E-56, E'-56, E"-56, E"'-56, E""-56, E""'-56 | -CH₂CH₃ | -CH₂CH₃ | *iso*-butyl |
| E-57, E'-57, E"-57, E'"-57, E""-57, E""'-57 | *n*-propyl | *n*-propyl | *iso*-butyl |
| E-58, E'-58, E"-58, E"'-58, E""-58, E""'-58 | *iso*-propyl | *iso*-propyl | *iso*-butyl |
| E-59, E'-59, E"-59, E"'-59, E""-59, E""'-59 | *sec*-butyl | *sec*-butyl | *iso*-butyl |
| E-60, E'-60, E"-60, E"'-60, E""-60, E""'-60 | *iso*-butyl | *iso*-butyl | *iso*-butyl |
| E-61, E'-61, E"-61, E"'-61, E""-61, E""'-61 | neopentyl | neopentyl | *iso*-butyl |
| E-62, E'-62, E"-62, E"'-62, E""-62, E""'-62 | 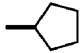 | 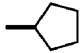 | *iso*-butyl |
| E-63, E'-63, E"-63, E"'-63, E""-63, E""'-63 | 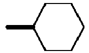 | 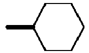 | *iso*-butyl |
| E-64, E'-64, E"-64, E"'-64, E""-64, E""'-64 | -CH₃ | -CH₃ | neopentyl |
| E-65, E'-65, E"-65, E"'-65, E""-65, E""'-65 | -CH₂CH₃ | -CH₂CH₃ | neopentyl |
| E-66, E'-66, E"-66, E"'-66, E""-66, E""'-66 | *n*-propyl | *n*-propyl | neopentyl |
| E-67, E'-67, E"-67, E"'-67, E""-67, E""'-67 | *iso*-propyl | *iso*-propyl | neopentyl |
| E-68, E'-68, E"-68, E"'-68, E""-68, E""'-68 | *sec*-butyl | *sec*-butyl | neopentyl |
| E-69, E'-69, E"-69, E"'-69, E""-69, E""'-69 | *iso*-butyl | *iso*-butyl | neopentyl |
| E-70, E'-70, E"-70, E"'-70, E""-70, E""'-70 | neopentyl | neopentyl | neopentyl |
| E-71, E'-71, E"-71, E"'-71, E""-71, E""'-71 | 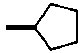 | 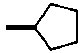 | neopentyl |
| E-72, E'-72, E"-72, E"'-72, E""-72, E""'-72 | 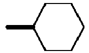 | 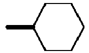 | neopentyl |
| E-73, E'-73, E"-73, E"'-73, E""-73, E""'-73 | -CH₃ | -CH₃ | 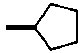 |
| E-74, E'-74, E"-74, E"'-74, E""-74, E""'-74 | -CH₂CH₃ | -CH₂CH₃ | 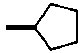 |
| E-75, E'-75, E"-75, E"'-75, E""-75, E""'-75 | *n*-propyl | *n*-propyl | 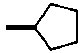 |
| E-76, E'-76, E"-76, E"'-76, E""-76, E""'-76 | *iso*-propyl | *iso*-propyl | 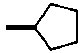 |
| E-77, E'-77, E"-77, E"'-77, E""-77, E""'-77 | *sec*-butyl | *sec*-butyl | 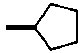 |
| E-78, E'-78, E"-78, E"'-78, E""-78, E""'-78 | *iso*-butyl | *iso*-butyl | 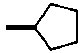 |
| E-79, E'-79, E"-79, E"'-79, E""-79, E""'-79 | neopentyl | neopentyl | 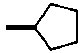 |
| E-80, E'-80, E"-80, E"'-80, E""-80, E""'-80 | 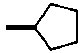 | 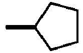 | 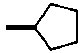 |
| E-81, E'-81, E"-81, E"'-81, E""-81, E""'-81 | 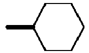 | 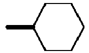 | 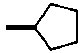 |
| E-82, E'-82, E"-82, E"'-82, E""-82, E""'-82 | -CH₃ | -CH₃ | 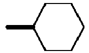 |
| E-83, E'-83, E"-83, E"'-83, E""-83, E""'-83 | -CH₂CH₃ | -CH₂CH₃ | 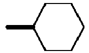 |
| E-84, E'-84, E"-84, E"'-84, E""-84, E""'-84 | *n*-propyl | *n*-propyl | 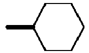 |
| E-85, E'-85, E"-85, E"'-85, E""-85, E""'-85 | *iso*-propyl | *iso*-propyl | 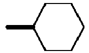 |
| E-86, E'-86, E"-86, E"'-86, E""-86, E""'-86 | *sec*-butyl | *sec*-butyl | 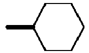 |
| E-87, E'-87, E"-87, E"'-87, E""-87, E""'-87 | *iso*-butyl | *iso*-butyl | 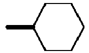 |
| E-88, E'-88, E"-88, E"'-88, E""-88, E""'-88 | neopentyl | neopentyl | 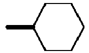 |
| E-89, E'-89, E"-89, E"'-89, E""-89, E""'-89 | 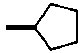 | 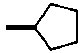 | 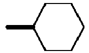 |
| E-90, E'-90, E"-90, E"'-90, E""-90, E""'-90 | 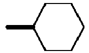 | 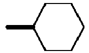 | 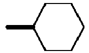 |
| E-91, E'-91, E"-91, E"'-91, E""-91, E""'-91 | -CH₃ | -CH₃ | *tert*-butyl |
| E-92, E'-92, E"-92, E"'-92, E""-92, E""'-92 | -CH₂CH₃ | -CH₂CH₃ | *tert*-butyl |
| E-93, E'-93, E"-93, E"'-93, E""-93, E""'-93 | *n*-propyl | *n*-propyl | *tert*-butyl |
| E-94, E'-94, E"-94, E"'-94, E""-94, E""'-94 | *iso*-propyl | *iso*-propyl | *tert*-butyl |
| E-95, E'-95, E"-95, E"'-95, E""-95, E""'-95 | *sec*-butyl | *sec*-butyl | *tert*-butyl |
| E-96, E'-96, E"-96, E"'-96, E""-96, E""'-96 | *iso*-butyl | *iso*-butyl | *tert*-butyl |
| E-97, E'-97, E"-97, E"'-97, E""-97, E""'-97 | neopentyl | neopentyl | *tert*-butyl |
| E-98, E'-98, E"-98, E"'-98, E""-98, E""'-98 | 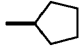 | 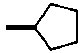 | *tert*-butyl |
| E-99, E'-99, E"-99, E"'-99, E""-99, E""'-99 | 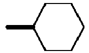 | 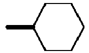 | *tert*-butyl |
| E-100, E'-100, E"-100, E"'-100, E""-100, E""'-100 | -CH₃ | -CH₃ | *tert*-amyl |
| E-101, E'-101, E"-101, E"'-101, E""-101, E""'-101 | -CH₂CH₃ | -CH₂CH₃ | *tert*-amyl |
| E-102, E'-102, E"-102, E"'-102, E""-102, E""'-102 | *n*-propyl | *n*-propyl | *tert*-amyl |
| E-103, E'-103, E"-103, E"'-103, E""-103, E""'-103 | *iso*-propyl | *iso*-propyl | *tert*-amyl |
| E-104, E'-104, E"-104, E"'-104, E""-104, E""'-104 | *sec*-butyl | *sec*-butyl | *tert*-amyl |
| E-105, E'-105, E"-105, E"'-105, E""-105, E""'-105 | *iso*-butyl | *iso*-butyl | *tert*-amyl |
| E-106, E'-106, E"-106, E"'-106, E""-106, E""'-106 | neopentyl | neopentyl | *tert*-amyl |
| E-107, E'-107, E"-107, E"'-107, E""-107, E""'-107 | 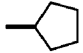 | 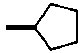 | *tert*-amyl |
| E-108, E'-108, E"-108, E"'-108, E""-108, E""'-108 | 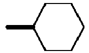 | 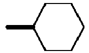 | *tert*-amyl |
| E-109, E'-109, E"-109, E"'-109, E""-109, E""'-109 | *tert*-butyl | *tert*-butyl | -CH₃ |
| E-110, E'-110, E"-110, E"'-110, E""-110, E""'-110 | *tert*-butyl | *tert*-butyl | -CH₂CH₃ |
| E-111, E'-111, E"-111, E"'-111, E""-111, E""'-111 | *tert*-butyl | *tert*-butyl | *n*-propyl |
| E-112, E'-112, E"-112, E"'-112, E""-112, E""'-112 | *tert*-butyl | *tert*-butyl | *iso*-propyl |
| E-113, E'-113, E"-113, E"'-113, E""-113, E""'-113 | *tert*-butyl | *tert*-butyl | *sec*-butyl |
| E-114, E'-114, E"-114, E"'-114, E""-114, E""'-114 | *tert*-butyl | *tert*-butyl | *iso*-butyl |
| E-115, E'-115, E"-115, E"'-115, E""-115, E""'-115 | *tert*-butyl | *tert*-butyl | neopentyl |
| E-116, E'-116, E"-116, E"'-116, E""-116, E""'-116 | *tert*-butyl | *tert*-butyl | 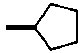 |
| E-117, E'-117, E"-117, E"'-117, E""-117, E""'-117 | *tert*-butyl | *tert*-butyl | 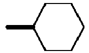 |
| E-118, E'-118, E"-118, E"'-118, E""-118, E""'-118 | *tert*-butyl | *tert*-butyl | *tert*-butyl |
| E-119, E'-119, E"-119, E"'-119, E""-119, E""'-119 | *tert*-butyl | *tert*-butyl | *tert*-amyl |
| E-120, E'-120, E"-120, E"'-120, E""-120, E""'-120 | *tert*-amyl | *tert*-amyl | -CH₃ |
| E-121, E'-121, E"-121, E"'-121, E""-121, E""'-121 | *tert*-amyl | *tert*-amyl | -CH₂CH₃ |
| E-122, E'-122, E"-122, E"'-122, E""-122, E""'-122 | *tert*-amyl | *tert*-amyl | *n*-propyl |
| E-123, E'-123, E"-123, E"'-123, E""-123, E""'-123 | *tert*-amyl | *tert*-amyl | *iso*-propyl |
| E-124, E'-124, E"-124, E"'-124, E""-124, E""'-124 | *tert*-amyl | *tert*-amyl | *sec*-butyl |
| E-125, E'-125, E"-125, E"'-125, E""-125, E""'-125 | *tert*-amyl | *tert*-amyl | *iso*-butyl |
| E-126, E'-126, E"-126, E"'-126, E""-126, E""'-126 | *tert*-amyl | *tert*-amyl | neopentyl |
| E-127, E'-127, E"-127, E"'-127, E""-127, E""'-127 | *tert*-amyl | *tert*-amyl | 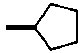 |
| E-128, E'-128, E"-128, E"'-128, E""-128, E""'-128 | *tert*-amyl | *tert*-amyl | 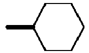 |
| E-129, E'-129, E"-129, E"'-129, E""-129, E""'-129 | *tert*-amyl | *tert*-amyl | *tert*-butyl |
| E-130, E'-130, E"-130, E"'-130, E""-130, E""'-130 | *tert*-amyl | *tert*-amyl | *tert*-amyl |

Preferred compounds E, E', E", E"', E"" and E""' are compounds E-1, E'-1, E"-1, E'"-1, E-1"" and E""'-1 to E-90, E'-90, E"-90, E"'-90, E""-90 and E""'-90.

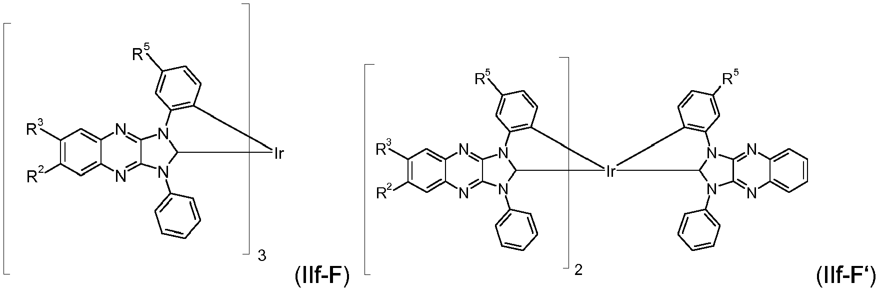

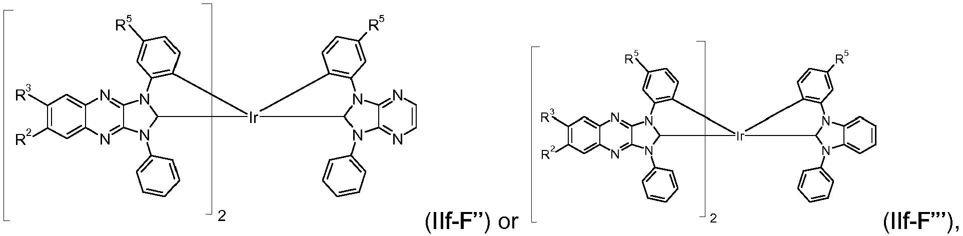

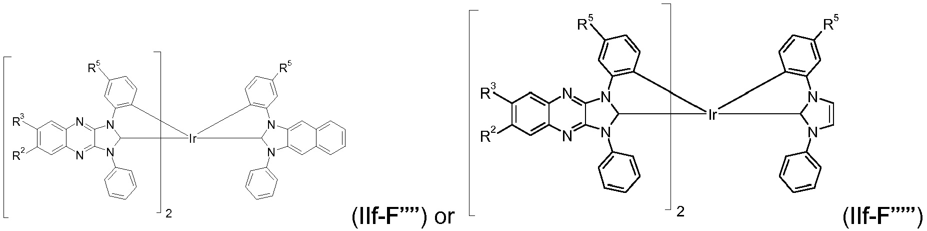

| **Cpd.** | **R³** | **R²** | **R⁵** |
|---|---|---|---|
| F-1, F'-1, F"-1, F"'-1, F""-1, F""'-1 | -CH₃ | -CH₃ | H |
| F-2, F'-2, F"-2, F"'-2, F""-2, F""'-2 | -CH₂CH₃ | -CH₂CH₃ | H |
| F-3, F'-3, F"-3, F"'-3, F-""-3, F""'-3 | *n*-propyl | *n*-propyl | H |
| F-4, F'-4, F"-4, F"'-4, F""-4, F""'-4 | *iso*-propyl | *iso*-propyl | H |
| F-5, F'-5, F"-5, F"'-5, F""-5, F""'-5 | *sec*-butyl | *sec*-butyl | H |
| F-6, F'-6, F"-6, F"'-6, F""-6, F""'-6 | *iso*-butyl | *iso*-butyl | H |
| F-7, F'-7, F"-7, F"'-7, F""-7, F""'-7 | neopentyl | neopentyl | H |
| F-8, F'-8, F"-8, F"'-8, F""-8, F""'-8 | 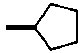 | 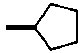 | H |
| F-9, F'-9, F"-9, F"'-9, F""-9, F""'-9 | 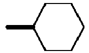 | 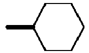 | H |
| F-10, F'-10, F"-10, F"'-10, F""-10, F""'-10 | -CH₃ | -CH₃ | -CH₃ |
| F-11, F'-11, F"-11, F"'-11, F""-11, F""'-11 | -CH₂CH₃ | -CH₂CH₃ | -CH₃ |
| F-12, F'-12, F"-12, F"'-12, F""-12, F""'-12 | *n*-propyl | *n*-propyl | -CH₃ |
| F-13, F'-13, F"-13, F"'-13, F""-13, F""'-13 | *iso*-propyl | *iso*-propyl | -CH₃ |
| F-14, F'-14, F"-14, F"'-14, F""-14, F""'-14 | *sec*-butyl | *sec*-butyl | -CH₃ |
| F-15, F'-15, F"-15, F"'-15, F""-15, F""'-15 | *iso*-butyl | *iso*-butyl | -CH₃ |
| F-16, F'-16, F"-16, F"'-16, F""-16, F""'-16 | neopentyl | neopentyl | -CH₃ |
| F-17, F'-17, F"-17, F"'-17, F""-17, F""'-17 | 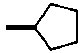 | 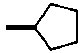 | -CH₃ |
| F-18, F'-18, F"-18, F"'-18, F""-18, F""'-18 | 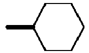 | 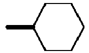 | -CH₃ |
| F-19, F'-19, F"-19, F"'-19, F""-19, F""'-19 | -CH₃ | -CH₃ | -CH₂CH₃ |
| F-20, F'-20, F"-20, F"'-20, F""-20, F""'-20 | -CH₂CH₃ | -CH₂CH₃ | -CH₂CH₃ |
| F-21, F'-21, F"-21, F"'-21, F""-21, F""'-21 | *n*-propyl | *n*-propyl | -CH₂CH₃ |
| F-22, F'-22, F"-22, F"'-22, F""-22, F""'-22 | *iso*-propyl | *iso*-propyl | -CH₂CH₃ |
| F-23, F'-23, F"-23, F"'-23, F""-23, F""'-23 | *sec*-butyl | *sec*-butyl | -CH₂CH₃ |
| F-24, F'-24, F"-24, F"'-24, F""-24, F""'-24 | *iso*-butyl | *iso*-butyl | -CH₂CH₃ |
| F-25, F'-25, F"-25, F"'-25, F""-25, F""'-25 | neopentyl | neopentyl | -CH₂CH₃ |
| F-26, F'-26, F"-26, F"'-26, F""-26, F""'-26 | 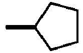 | 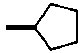 | -CH₂CH₃ |
| F-27, F'-27, F"-27, F"'-27, F""-27, F""'-27 | 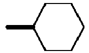 | 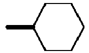 | -CH₂CH₃ |
| F-28, F'-28, F"-28, F"'-28, F""-28, F""'-28 | -CH₃ | -CH₃ | *n*-propyl |
| F-29, F'-29, F"-29, F"'-29, F""-29, F""'-29 | -CH₂CH₃ | -CH₂CH₃ | *n*-propyl |
| F-30, F'-30, F"-30, F"'-30, F""-30, F""'-30 | *n*-propyl | *n*-propyl | *n*-propyl |
| F-31, F'-31, F"-31, F"'-31, F""-31, F""'-31 | *iso*-propyl | *iso*-propyl | *n*-propyl |
| F-32, F'-32, F"-32, F"'-32, F""-32, F""'-32 | *sec*-butyl | *sec*-butyl | *n*-propyl |
| F-33, F'-33, F"-33, F"'-33, F""-33, F""'-33 | *iso*-butyl | *iso*-butyl | *n*-propyl |
| F-34, F'-34, F"-34, F"'-34, F""-34, F""'-34 | neopentyl | neopentyl | *n*-propyl |
| F-35, F'-35, F"-35, F"'-35, F""-35, F""'-35 | 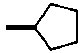 | 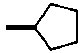 | *n*-propyl |
| F-36, F'-36, F"-36, F"'-36, F""-36, F""'-36 | 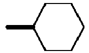 | 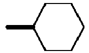 | *n*-propyl |
| F-37, F'-37, F"-37, F"'-37, F""-37, F""'-37 | -CH₃ | -CH₃ | *iso*-propyl |
| F-38, F'-38, F"-38, F"'-38, F""-38, F""'-38 | -CH₂CH₃ | -CH₂CH₃ | *iso*-propyl |
| F-39, F'-39, F"-39, F"'-39, F""-39, F""'-39 | *n*-propyl | *n*-propyl | *iso*-propyl |
| F-40, F'-40, F"-40, F"'-40, F""-40, F""'-40 | *iso*-propyl | *iso*-propyl | *iso*-propyl |
| F-41, F'-41, F"-41, F"'-41, F""-41, F""'-41 | *sec*-butyl | *sec*-butyl | *iso*-propyl |
| F-42, F'-42, F"-42, F"'-42, F""-42, F""'-42 | *iso*-butyl | *iso*-butyl | *iso*-propyl |
| F-43, F'-43, F"-43, F"'-43, F""-43, F""'-43 | neopentyl | neopentyl | *iso*-propyl |
| F-44, F'-44, F"-44, F"'-44, F""-44, F""'-44 | 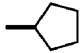 | 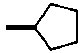 | *iso*-propyl |
| F-45, F'-45, F"-45, F"'-45, F""-45, F""'-45 | 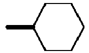 | 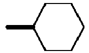 | *iso*-propyl |
| F-46, F'-46, F"-46 F"'-46, F""-46, F""'-46 | -CH₃ | -CH₃ | *sec*-butyl |
| F-47, F'-47, F"-47, F"'-47, F""-47, F""'-47 | -CH₂CH₃ | -CH₂CH₃ | *sec*-butyl |
| F-48, F'-48, F"-48, F"'-48, F""-48, F""'-48 | *n*-propyl | *n*-propyl | *sec*-butyl |
| F-49, F'-49, F"-49, F"'-49, F""-49, F""'-49 | *iso*-propyl | *iso*-propyl | *sec*-butyl |
| F-50, F'-50, F"-50, F"'-50, F""-50, F""'-50 | *sec*-butyl | *sec*-butyl | *sec*-butyl |
| F-51, F'-51, F"-51, F"'-51, F""-51, F""'-51 | *iso*-butyl | *iso*-butyl | *sec*-butyl |
| F-52, F'-52, F"-52, F"'-52, F""-52, F""'-52 | neopentyl | neopentyl | *sec*-butyl |
| F-53, F'-53, F"-53, F"'-53, F""-53, F""'-53 | 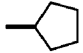 | 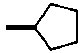 | *sec*-butyl |
| F-54, F'-54, F"-54, F"'-54, F""-54, F""'-54 | 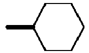 | 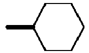 | *sec*-butyl |
| F-55, F'-55, F"-55, F"'-55, F""-55, F""'-55 | -CH₃ | -CH₃ | *iso*-butyl |
| F-56, F'-56, F"-56, F"'-56, F""-56, F""'-56 | -CH₂CH₃ | -CH₂CH₃ | *iso*-butyl |
| F-57, F'-57, F"-57, F"'-57, F""-57, F""'-57 | *n*-propyl | *n*-propyl | *iso*-butyl |
| F-58, F'-58, F"-58, F"'-58, F""-58, F""'-58 | *iso*-propyl | *iso*-propyl | *iso*-butyl |
| F-59, F'-59, F"-59, F"'-59, F""-59, F""'-59 | *sec*-butyl | *sec*-butyl | *iso*-butyl |
| F-60, F'-60, F"-60, F"'-60, F""-60, F""'-60 | *iso*-butyl | *iso*-butyl | *iso*-butyl |
| F-61, F'-61, F"-61, F"'-61, F""-61, F""'-61 | neopentyl | neopentyl | *iso*-butyl |
| F-62, F'-62, F"-62, F"'-62, F""-62, F""'-62 | 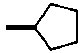 | 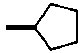 | *iso*-butyl |
| F-63, F'-63, F"-63, F"'-63, F""-63, F""'-63 | 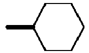 | 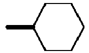 | *iso*-butyl |
| F-64, F'-64, F"-64, F"'-64, F""-64, F""'-64 | -CH₃ | -CH₃ | Neopentyl |
| F-65, F'-65, F"-65, F"'-65, F""-65, F""'-65 | -CH₂CH₃ | -CH₂CH₃ | Neopentyl |
| F-66, F'-66, F"-66, F"'-66, F""-66, F""'-66 | *n*-propyl | *n*-propyl | Neopentyl |
| F-67, F'-67, F"-67, F"'-67, F""-67, F""'-67 | *iso*-propyl | *iso*-propyl | Neopentyl |
| F-68, F'-68, F"-68, F"'-68, F""-68, F""'-68 | *sec*-butyl | *sec*-butyl | Neopentyl |
| F-69, F'-69, F"-69, F"'-69, F""-69, F""'-69 | *iso*-butyl | *iso*-butyl | neopentyl |
| F-70, F'-70, F"-70, F"'-70, F""-70, F""'-70 | neopentyl | neopentyl | Neopentyl |
| F-71, F'-71, F"-71, F"'-71, F""-71, F""'-71 | 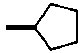 | 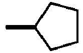 | Neopentyl |
| F-72, F'-72, F"-72, F"'-72, F""-72, F""'-72 | 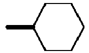 | 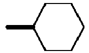 | Neopentyl |
| F-73, F'-73, F"-73, F"'-73, F""-73, F""'-73 | -CH₃ | -CH₃ | 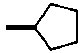 |
| F-74, F'-74, F"-74, F"'-74, F""-74, F""'-74 | -CH₂CH₃ | -CH₂CH₃ | 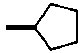 |
| F-75, F'-75, F"-75, F"'-75, F""-75, F""'-75 | *n*-propyl | *n*-propyl | 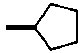 |
| F-76, F'-76, F"-76, F"'-76, F""-76, F""'-76 | *iso*-propyl | *iso*-propyl | 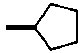 |
| F-77, F'-77, F"-77, F"'-77, F""-77, F""'-77 | *sec*-butyl | *sec*-butyl | 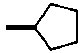 |
| F-78, F'-78, F"-78, F"'-78, F""-78, F""'-78 | *iso*-butyl | *iso*-butyl | 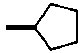 |
| F-79, F'-79, F"-79, F"'-79, F""-79, F""'-79 | neopentyl | neopentyl | 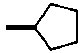 |
| F-80, F'-80, F"-80, F"'-80, F""-80, F""'-80 | 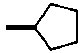 | 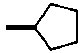 | 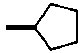 |
| F-81, F'-81, F"-81, F"'-81, F""-81, F""'-81 | 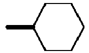 | 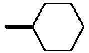 | 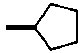 |
| F-82, F'-82, F"-82, F"'-82, F""-82, F""'-82 | -CH₃ | -CH₃ | 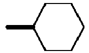 |
| F-83, F'-83, F"-83, F"'-83, F""-83, F""'-83 | -CH₂CH₃ | -CH₂CH₃ | 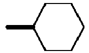 |
| F-84, F'-84, F"-84, F"'-84, F""-84, F""'-84 | *n*-propyl | *n*-propyl | 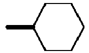 |
| F-85, F'-85, F"-85, F"'-85, F""-85, F""'-85 | *iso*-propyl | *iso*-propyl | 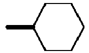 |
| F-86, F'-86, F"-86, F"'-86, F""-86, F""'-86 | *sec*-butyl | *sec*-butyl | 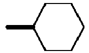 |
| F-87, F'-87, F"-87, F"'-87, F""-87, F""'-87 | *iso*-butyl | *iso*-butyl | 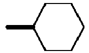 |
| F-88, F'-88, F"-88, F"'-88, F""-88, F""'-88 | neopentyl | neopentyl | 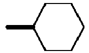 |
| F-89, F'-89, F"-89, F"'-89, F""-89, F""'-89 | 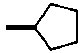 | 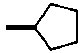 | 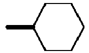 |
| F-90, F'-90, F"-90, F"'-90, F""-90, F""'-90 | 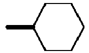 | 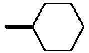 | 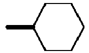 |
| F-91, F'-91, F"-91, F"'-91, F""-91, F""'-91 | -CH₃ | -CH₃ | *tert*-butyl |
| F-92, F'-92, F"-92, F"'-92, F""-92, F""'-92 | -CH₂CH₃ | -CH₂CH₃ | *tert*-butyl |
| F-93, F'-93, F"-93, F"'-93, F""-93, F""'-93 | *n*-propyl | *n*-propyl | *tert*-butyl |
| F-94, F'-94, F"-94, F"'-94, F""-94, F""'-94 | *iso*-propyl | *iso*-propyl | *tert*-butyl |
| F-95, F'-95, F"-95, F"'-95, F""-95, F""'-95 | *sec*-butyl | *sec*-butyl | *tert*-butyl |
| F-96, F'-96, F"-96, F"'-96, F""-96, F""'-96 | *iso*-butyl | *iso*-butyl | *tert*-butyl |
| F-97, F'-97, F"-97, F"'-97, F""-97, F""'-97 | neopentyl | neopentyl | *tert*-butyl |
| F-98, F'-98, F"-98, F"'-98, F""-98, F""'-98 | 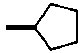 | 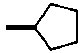 | *tert*-butyl |
| F-99, F'-99, F"-99, F"'-99, F""-99, F""'-99 | 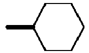 | 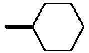 | *tert*-butyl |
| F-100, F'-100, F"-100, F"'-100, F""-100, F""'-100 | -CH₃ | -CH₃ | *tert*-amyl |
| F-101, F'-101, F"-101, F"'-101, F""-101, F""'-101 | -CH₂CH₃ | -CH₂CH₃ | *tert*-amyl |
| F-102, F'-102, F"-102, F"'-102, F""-102, F""'-102 | *n*-propyl | *n*-propyl | *tert*-amyl |
| F-103, F'-103, F"-103, F"'-103, F""-103, F""'-103 | *iso*-propyl | *iso*-propyl | *tert*-amyl |
| F-104, F'-104, F"-104, F"'-104, F""-104, F""'-104 | *sec*-butyl | *sec*-butyl | *tert*-amyl |
| F-105, F'-105, F"-105, F"'-105, F""-105, F""'-105 | *iso*-butyl | *iso*-butyl | *tert*-amyl |
| F-106, F'-106, F"-106, F"'-106, F""-106, F""'-106 | neopentyl | neopentyl | *tert*-amyl |
| F-107, F'-107, F"-107, F"'-107, F""-107, F""'-107 | 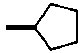 | 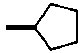 | *tert*-amyl |
| F-108, F'-108, F"-108, F"'-108, F""-108, F""'-108 | 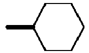 | 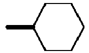 | *tert*-amyl |

Preferred compounds F, F', F", F"', F"" and F'"" are compounds F-1, F'-1, F"-1, F"'-1, F""-1 and F""'-1 to F-90, F'-90, F"-90, F"'-90, F""-90 and F""'-90. 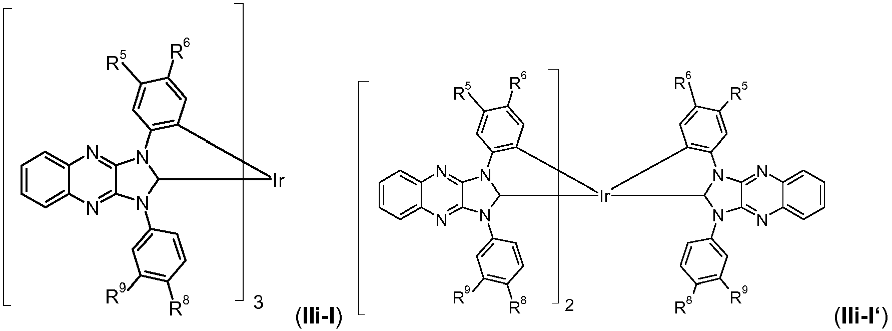 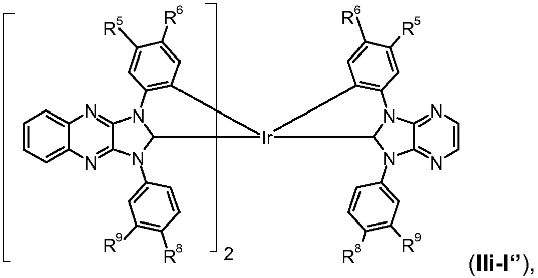 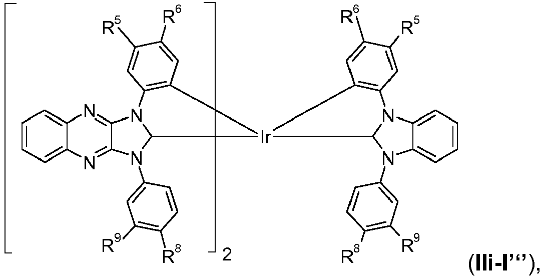 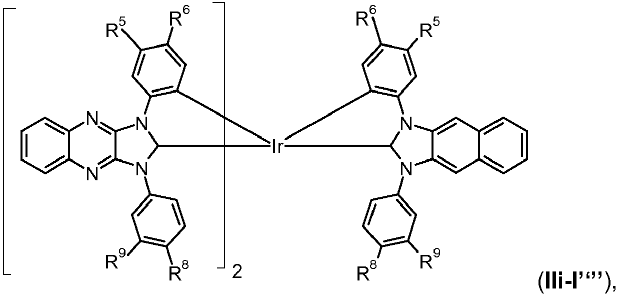 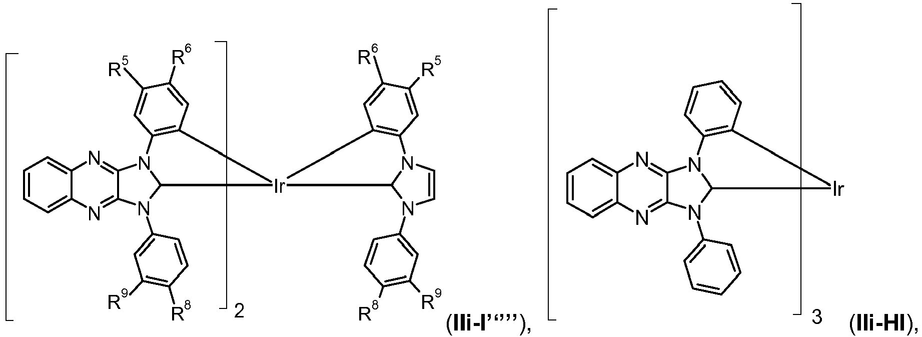 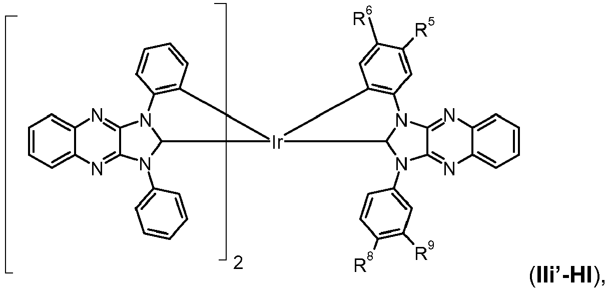 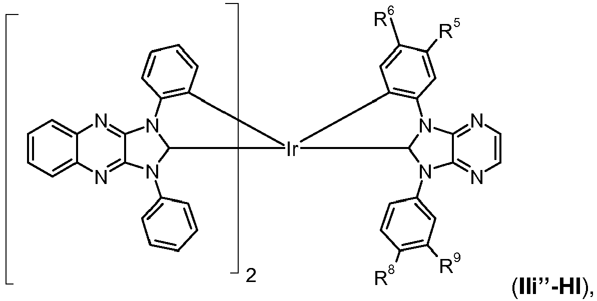 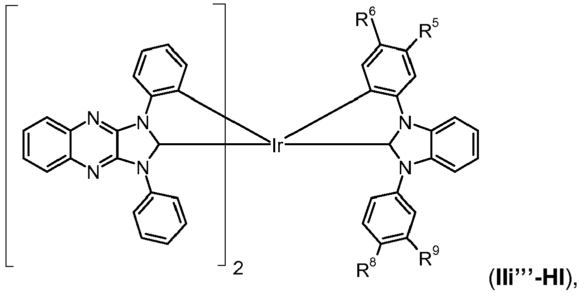 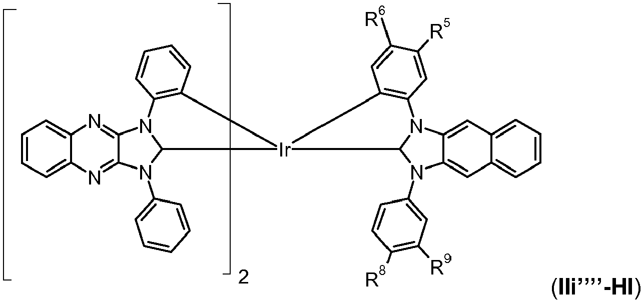 or

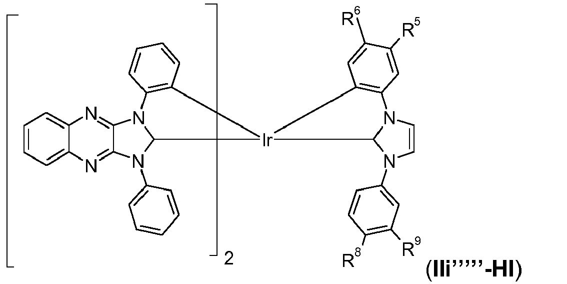

| **Cpd.** | **R⁵ = R⁸** | **R⁶ = R⁹** |
|---|---|---|
| I-1, I'-1, I"-1, I"'-1, I""-1, I""'-1, HI-1, HI'-1, HI"-1, HI'"-1, HI""-1, HI""'-1 | -CH₃ | H |
| I-2, I'-2, I"-2, I"'-2, I""-2, I""'-2, HI-2, HI'-2, HI"-2, HI"'-2, HI""-2, HI""'-2 | -CH₂CH₃ | H |
| I-3, I'-3, I"-3, I"'-3, I-""-3, I""'-3, HI-3, HI'-3, HI"-3, HI'"-3, HI-""-3, HI""'-3 | *n*-propyl | H |
| I-4, I'-4, I"-4, I'"-4, I""-4, I""'-4, HI-4, HI'-4, HI"-4, HI'"-4, HI""-4, HI""'-4 | *iso*-propyl | H |
| I-5, I'-5, I"-5, I"'-5, I""-5, I""'-5, HI-5, HI'-5, HI"-5, HI"'-5, HI""-5, HI""'-5 | *sec*-butyl | H |
| I-6, I'-6, I"-6, I"'-6, I""-6, I""'-6, HI-6, HI'-6, HI"-6, HI'"-6, HI""-6, HI""'-6 | *iso*-butyl | H |
| I-7, I'-7, I"-7, I"'-7, I""-7, I""'-7, HI-7, HI'-7, HI"-7, HI'"-7, HI""-7, HI""'-7 | neopentyl | H |
| I-8, I'-8, I"-8, I'"-8, I""-8, I""'-8, HI-8, HI'-8, HI"-8, HI'"-8, HI""-8, HI""'-8 | 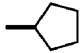 | H |
| I-9, I'-9, I"-9, I'"-9, I""-9, I""'-9, HI-9, HI'-9, HI"-9, HI'"-9, HI""-9, HI""'-9 | 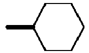 | H |
| I-10, I'-10, I"-10, I'"-10, I""-10, I'""-10, HI-10, HI'-10, HI"-10, HI'"-10, HI""-10, HI""'-10 | H | -CH₃ |
| I-11, I'-11, I"-11, I'"-11, I""-11, I'""-11, HI-11, HI'-11, HI"-11, HI"'-11, HI""-11, HI""'-11 | H | -CH₂CH₃ |
| I-12, I'-12, I"-12, I'"-12, I""-12, I""'-12, HI-12, HI'-12, HI"-12, HI"'-12, HI""-12, HI""'-12 | H | *n*-propyl |
| I-13, I'-13, I"-13, I'"-13, I""-13, I'""-13, HI-13, HI'-13, HI"-13, HI'"-13, HI""-13, HI""'-13 | H | *iso*-propyl |
| 1-14, I'-14, I"-14, I'"-14, I""-14, I""'-14, HI-14, HI'-14, HI"-14, HI"'-14, HI""-14, HI""'-14 | H | *sec*-butyl |
| I-15, I'-15, I"-15, I'"-15, I""-15, I'""-15, HI-15, HI'-15, HI"-15, HI'"-15, HI""-15, HI""'-15 | H | *iso*-butyl |
| I-16, I'-16, I"-16, I'"-16, I""-16, I'""-16, HI-16, HI'-16, HI"-16, HI'"-16, HI""-16, HI""'-16 | H | neopentyl |
| I-17, I'-17, I"-17, I'"-17, I""-17, I'""-17, HI-17, HI'-17, HI"-17, HI'"-17, HI""-17, HI""'-17 | H | 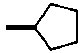 |
| I-18, I'-18, I"-18, I'"-18, I""-18, I'""-18, HI-18, HI'-18, HI"-18, HI'"-18, HI""-18, HI""'-18 | H | 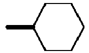 |
| I-19, I'-19, I"-19, I'"-19, I""-19, I'""-19, HI-19, HI'-19, HI"-19, HI'"-19, HI""-19, HI""'-19 | 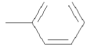 | H |
| I-20, I'-20, I"-20, I"'-20, I""-20, I""'-20, HI-20, HI'-20, HI"-20, HI"'-20, HI""-20, HI""'-20 | 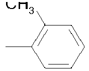 | H |
| I-21, I'-21, I"-21, I'"-21, I""21, I'""-21, HI-21, HI'-21, HI"-21, HI"'-21, HI""-21, HI""'-21 | 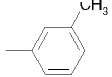 | H |
| I-22, I'-22, I"-22, I"'-22, I""-22, I'""-22, HI-22, HI'-22, HI"-22, HI"'-22, HI""-22, HI""'-22 | 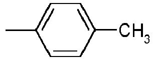 | H |
| I-23, I'-23, I"-23, I"'-23, I""-23, I'""-23, HI-23, HI'-23, HI"-23, HI"'-23, HI""-23, HI""'-23 | 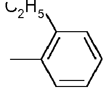 | H |
| I-24, I'-24, I"-24, I"'-24, I""-24, I'""-24, HI-24, HI'-24, HI"-24, HI"'-24, HI""-24, HI""'-24 | 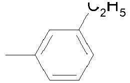 | H |
| I-25, I'-25, I"-25, I"'-25, I""-25, I'""-25, HI-25, HI'-25, HI"-25, HI"'-25, HI""-25, HI""'-25 | 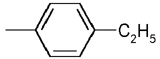 | H |
| I-26, I'-26, I"-26, I"'-26, I""-26, I'""-26, HI-26, HI'-26, HI"-26, HI"'-26, HI""-26, HI""'-26 | 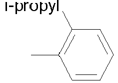 | H |
| I-27, I'-27, I"-27, I"'-27, I""-27, I'""-27, HI-27, HI'-27, HI"-27, HI"'-27, HI""-27, HI""'-27 | 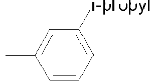 | H |
| I-28, I'-28, I"-28, I"'-28, I""-28, I'""-28, HI-28, HI'-28, HI"-28, HI"'-28, HI""-28, HI""'-28 | 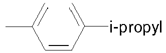 | H |
| I-29, I'-29, I"-29, I"'-29, I""-29, I'""-29, HI-29, HI'-29, HI"-29, HI"'-29, HI""-29, HI""'-29 | H | 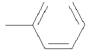 |
| I-30, I'-30, I"-30, I"'-30, I""-30, I""'-30, HI-30, HI'-30, HI"-30, HI"'-30, HI""-30, HI""'-30 | H | 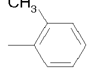 |
| I-31, I'-31, I"-31, I'"-31, I""-31, I'""-31, HI-31, HI'-31, HI"-31, HI"'-31, HI""-31, HI""'-31 | H | 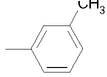 |
| I-32, I'-32, I"-32, I"'-32, I""-32, I""'-32, HI-32, HI'-32, HI"-32, HI"'-32, HI""-32, HI""'-32 | H | 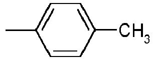 |
| I-33, I'-33, I"-33, I"'-33, I""-33, I""'-33, HI-33, HI'-33, HI"-33, HI"'-33, HI""-33, HI""'-33 | H | 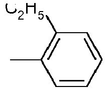 |
| I-34, I'-34, I"-34, I'"-34, I""-34, I""'-34, HI-34, HI'-34, HI"-34, HI"'-34, HI""-34, HI""'-34 | H | 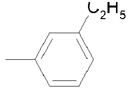 |
| I-35, I'-35, I"-35, I"'-35, I""-35, I""'-35, HI-35, HI'-35, HI"-35, HI"'-35, HI""-35, HI""'-35 | H | 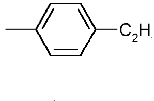 |
| I-36, I'-36, I"-36, I"'-36, I""-36, I""'-36, HI-36, HI'-36, HI"-36, HI"'-36, HI""-36, HI""'-36 | H | 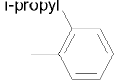 |
| I-37, I'-37, I"-37, I'"-37, I""-37, I""'-37, HI-37, HI'-37, HI"-37, HI"'-37, HI""-37, HI""'-37 | H | 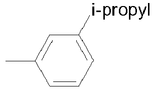 |
| I-38, I'-38, I"-38, I"'-38, I""-38, I""'-38, HI-38, HI'-38, HI"-38, HI"'-38, HI""-38, HI""'-38 | H | 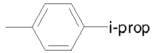 |
| I-39, I'-39, I"-39, I"'-39, I""-39, I""'-39, HI-39, HI'-39, HI"-39, HI"'-39, HI""-39, HI""'-39 | H | H |

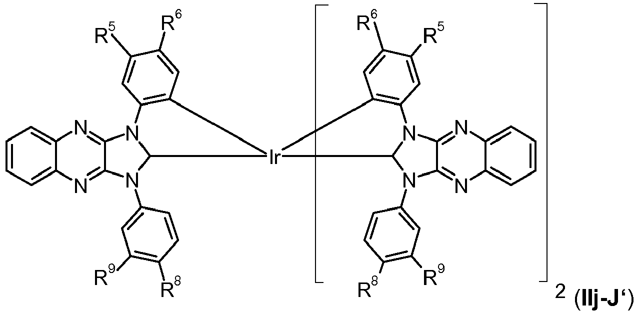

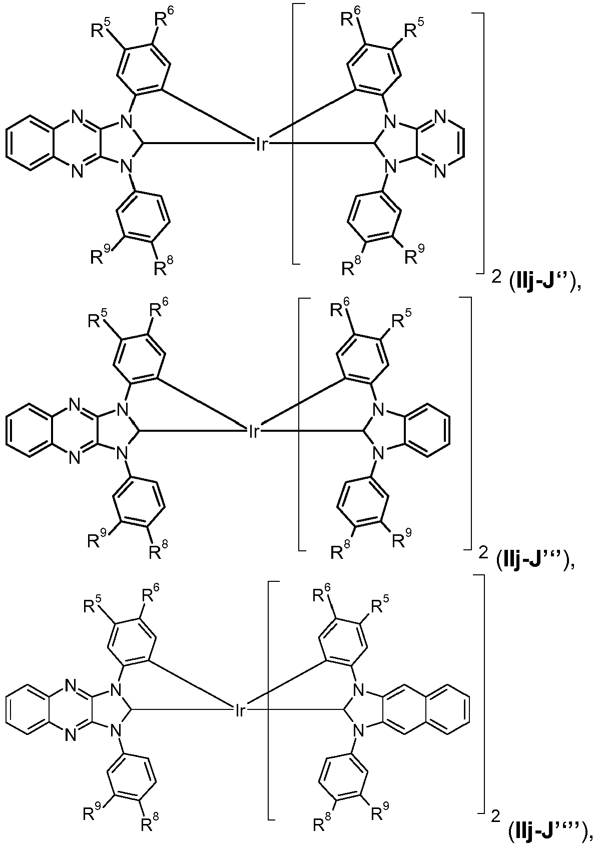

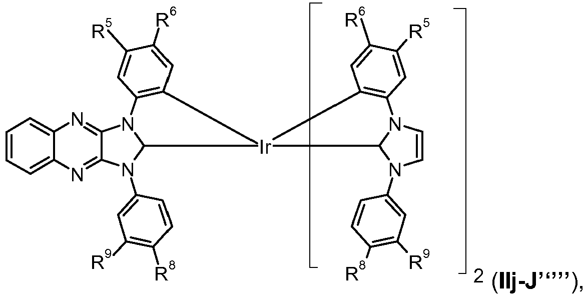

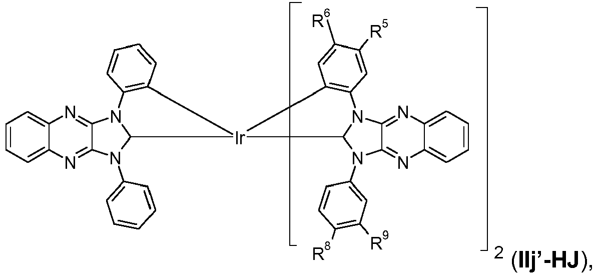

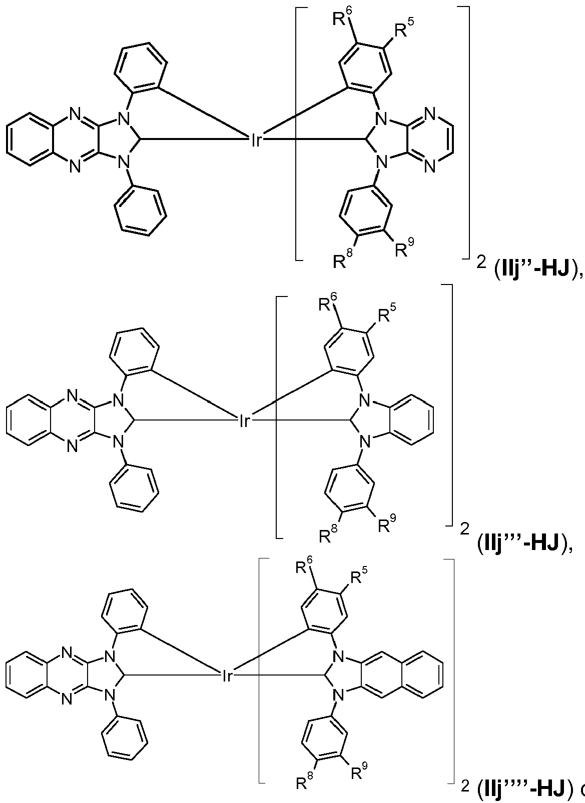

or

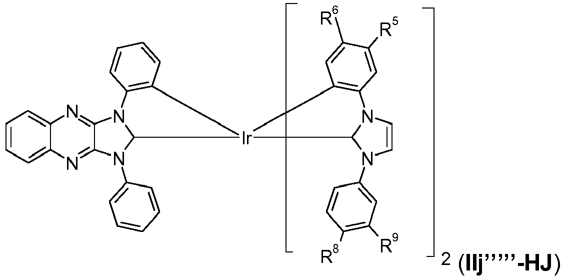

| **Cpd.** | **R⁵ = R⁸** | **R⁶ = R⁹** |
|---|---|---|
| J'-1, J"-1, J'"-1, J""-1, J""'-1, HJ'-1, HJ"-1, HJ"'-1, HJ""-1, HJ""'-1 | -CH₃ | H |
| J'-2, J"-2, J'"-2, J""-2, J""'-2, HJ'-2, HJ"-2, HJ"'-2, HJ""-2, HJ""'-2 | -CH₂CH₃ | H |
| J'-3, J"-3, J'"-3, J-""-3, J""'-3, HJ'-3, HJ"-3, HJ"'-3, HJ-""-3, HJ""'-3 | *n*-propyl | H |
| J'-4, J"-4, J"'-4, J""-4, J""'-4, HJ'-4, HJ"-4, HJ"'-4, HJ""-4, HJ""'-4 | *iso*-propyl | H |
| J'-5, J"-5, J"'-5, J""-5, J""'-5, HJ'-5, HJ"-5, HJ"'-5, HJ""-5, HJ""'-5 | *sec*-butyl | H |
| J'-6, J"-6, J"'-6, J""-6, J""'-6, HJ'-6, HJ"-6, HJ"'-6, HJ""-6, HJ""'-6 | *iso*-butyl | H |
| J'-7, J"-7, J"'-7, J""-7, J""'-7, HJ'-7, HJ"-7, HJ"'-7, HJ""-7, HJ""'-7 | neopentyl | H |
| J'-8, J"-8, J"'-8, J""-8, J""'-8, HJ'-8, HJ"-8, HJ"'-8, HJ""-8, HJ""'-8 | 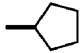 | H |
| J'-9, J"-9, J"'-9, J""-9, J""'-9, HJ'-9, HJ"-9, HJ"'-9, HJ""-9, HJ""'-9 | 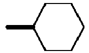 | H |
| J'-10, J"-10, J"'-10, J""-10, J""'-10, HJ'-10, HJ"-10, HJ"'-10, HJ""-10, HJ""'-10 | H | -CH₃ |
| J'-11, J"-11, J"'-11, J""-11, J""'-11, HJ'-11, HJ"-11, HJ"'-11, HJ""-11, HJ""'-11 | H | -CH₂CH₃ |
| J'-12, J"-12, J"'-12, J""-12, J""'-12, HJ'-12, HJ"-12, HJ"'-12, HJ""-12, HJ""'-12 | H | *n*-propyl |
| J'-13, J"-13, J"'-13, J""-13, J""'-13, HJ'-13, HJ"-13, HJ"'-13, HJ""-13, HJ""'-13 | H | *iso*-propyl |
| J'-14, J"-14, J"'-14, J""-14, J""'-14, HJ'-14, HJ"-14, HJ"'-14, HJ""-14, HJ""'-14 | H | *sec*-butyl |
| J'-15, J"-15, J"'-15, J""-15, J""'-15, HJ'-15, HJ"-15, HJ"'-15, HJ""-15, HJ""'-15 | H | *iso*-butyl |
| J'-16, J"-16, J"'-16, J""-16, J""'-16, HJ'-16, HJ"-16, HJ"'-16, HJ""-16, HJ""'-16 | H | neopentyl |
| J'-17, J"-17, J"'-17, J""-17, J""'-17, HJ'-17, HJ"-17, HJ"'-17, HJ""-17, HJ""'-17 | H | 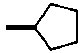 |
| J'-18, J"-18, J"'-18, J""-18, J""'-18, HJ'-18, HJ"-18, HJ"'-18, HJ""-18, HJ""'-18 | H | 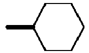 |
| J'-19, J"-19, J"'-19, J""-19, J""'-19, HJ'-19, HJ"-19, HJ"'-19, HJ""-19, HJ""'-19 | 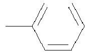 | H |
| J'-20, J"-20, J"'-20, J""-20, J""'-20, HJ'-20, HJ"-20, HJ"'-20, HJ""-20, HJ""'-20 | 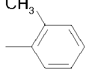 | H |
| J'-21, J"-21, J"'-21, J""-21, J""'-21, HJ'-21, HJ"-21, HJ"'-21, HJ""-21, HJ""'-21 | 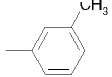 | H |
| J'-22, J"-22, J"'-22, J""-22, J""'-22, HJ'-22, HJ"-22, HJ"'-22, HJ""-22, HJ""'-22 | 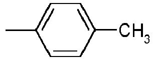 | H |
| J'-23, J"-23, J"'-23, J""-23, J""'-23, HJ'-23, HJ"-23, HJ"'-23, HJ""-23, HJ""'-23 | 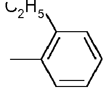 | H |
| J'-24, J"-24, J"'-24, J""-24, J""'-24, HJ'-24, HJ"-24, HJ"'-24, HJ""-24, HJ""'-24 | 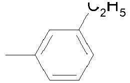 | H |
| J'-25, J"-25, J"'-25, J""-25, J""'-25, HJ'-25, HJ"-25, HJ"'-25, HJ""-25, HJ""'-25 | 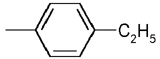 | H |
| J'-26, J"-26, J"'-26, J""-26, J""'-26, HJ'-26, HJ"-26, HJ"'-26, HJ""-26, HJ""'-26 | 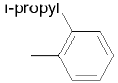 | H |
| J'-27, J"-27, J"'-27, J""-27, J""'-27, HJ'-27, HJ"-27, HJ"'-27, HJ""-27, HJ""'-27 | 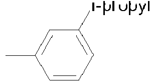 | H |
| J'-28, J"-28, J"'-28, J""-28, J""'-28, HJ'-28, HJ"-28, HJ"'-28, HJ""-28, HJ""'-28 | 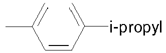 | H |
| J'-29, J"-29, J"'-29, J""-29, J""'-29, HJ'-29, HJ"-29, HJ"'-29, HJ""-29, HJ""'-29 | H | 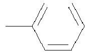 |
| J'-30, J"-30, J"'-30, J""-30, J""'-30, HJ'-30, HJ"-30, HJ"'-30, HJ""-30, HJ""'-30 | H | 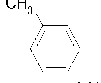 |
| J'-31, J"-31, J"'-31, J""-31, J""'-31, HJ'-31, HJ"-31, HJ"'-31, HJ""-31, HJ""'-31 | H | 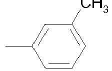 |
| J'-32, J"-32, J"'-32, J""-32, J""'-32, HJ'-32, HJ"-32, HJ"'-32, HJ""-32, HJ""'-32 | H | 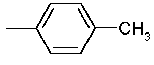 |
| J'-33, J"-33, J"'-33, J""-33, J""'-33, HJ'-33, HJ"-33, HJ"'-33, HJ""-33, HJ""'-33 | H | 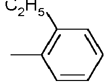 |
| J'-34, J"-34, J"'-34, J""-34, J""'-34, HJ'-34, HJ"-34, HJ"'-34, HJ""-34, HJ""'-34 | H | 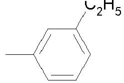 |
| J'-35, J"-35, J"'-35, J""-35, J""'-35, HJ'-35, HJ"-35, HJ"'-35, HJ""-35, HJ""'-35 | H | 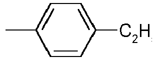 |
| J'-36, J"-36, J"'-36, J""-36, J""'-36, HJ'-36, HJ"-36, HJ"'-36, HJ""-36, HJ""'-36 | H | 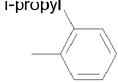 |
| J'-37, J"-37, J"'-37, J""-37, J""'-37, HJ'-37, HJ"-37, HJ"'-37, HJ""-37, HJ""'-37 | H | 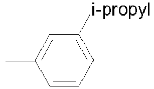 |
| J'-38, J"-38, J"'-38, J""-38, J""'-38, HJ'-38, HJ"-38, HJ"'-38, HJ""-38, HJ""'-38 | H | 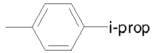 |
| J'-39, J"-39, J"'-39, J""-39, J""'-39, HJ'-39, HJ"-39, HJ"'-39, HJ""-39, HJ""'-39 | H | H |

Examples for most preferred metal carbene complexes of the present invention are the following complexes:

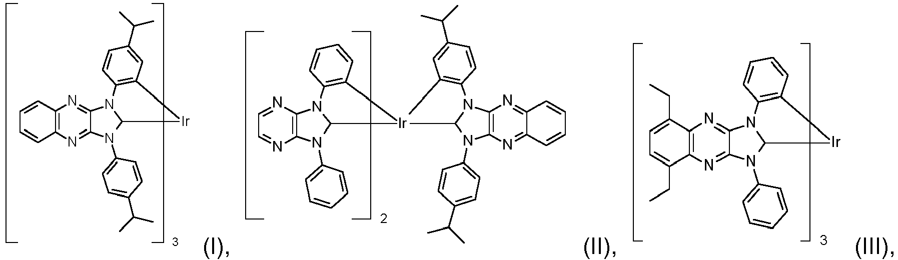

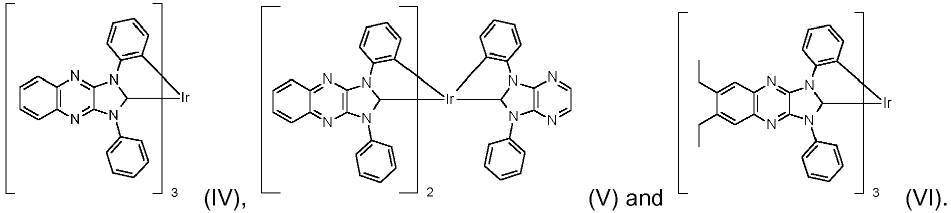

Further preferred compounds are 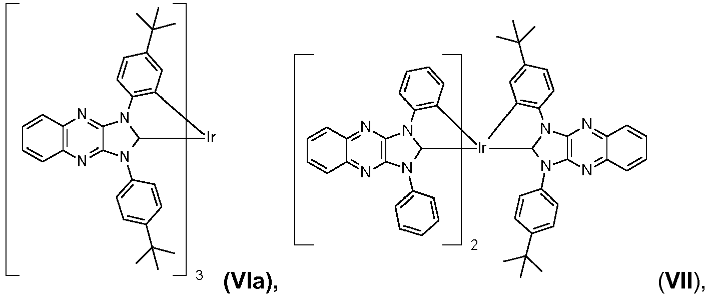 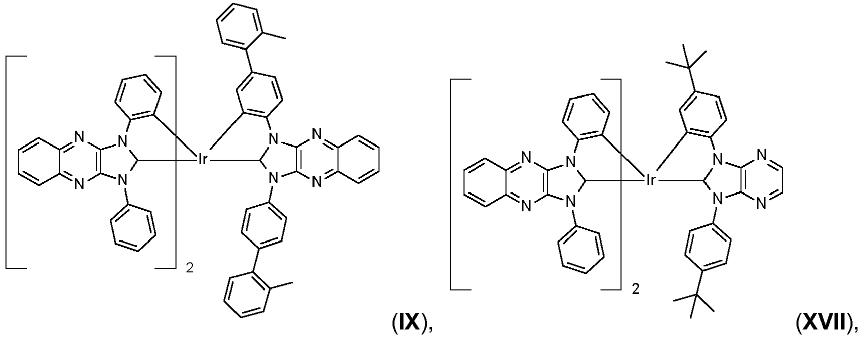 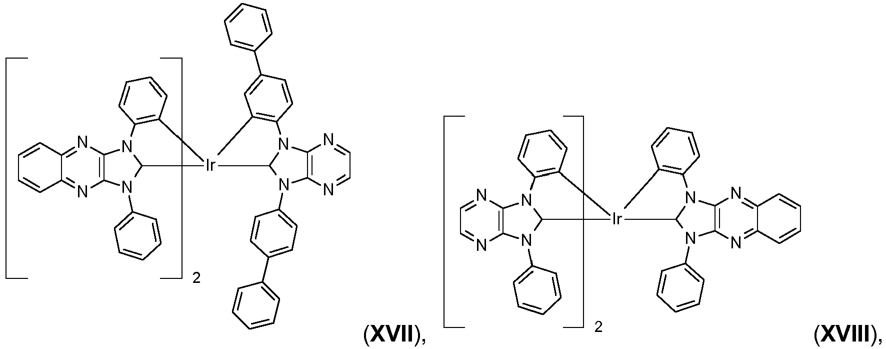 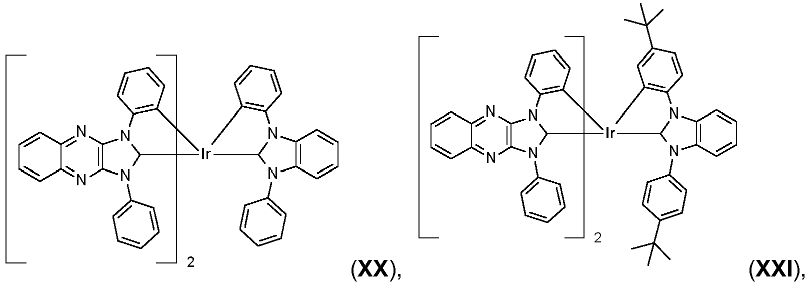 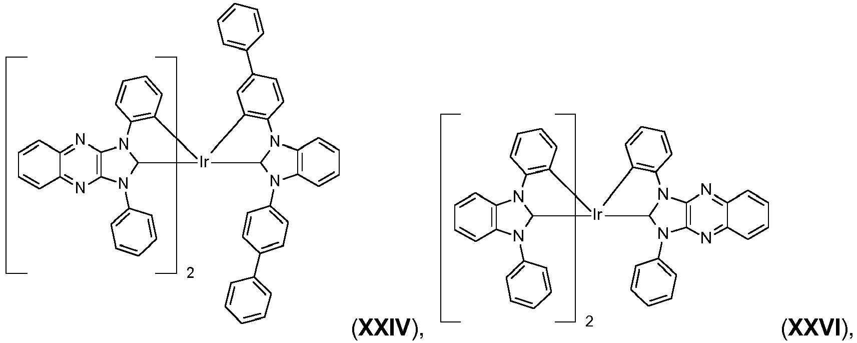 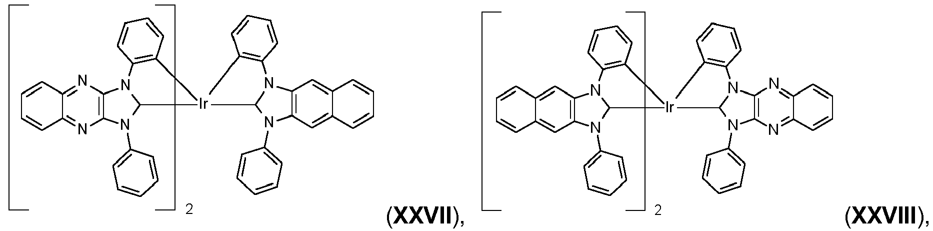 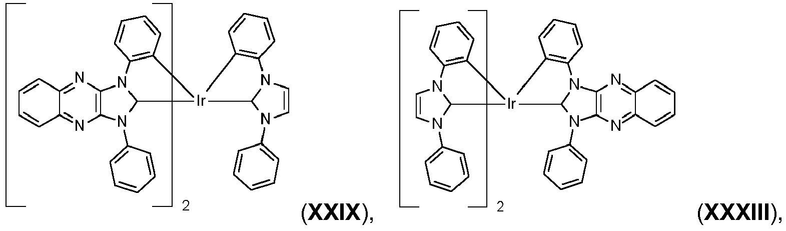 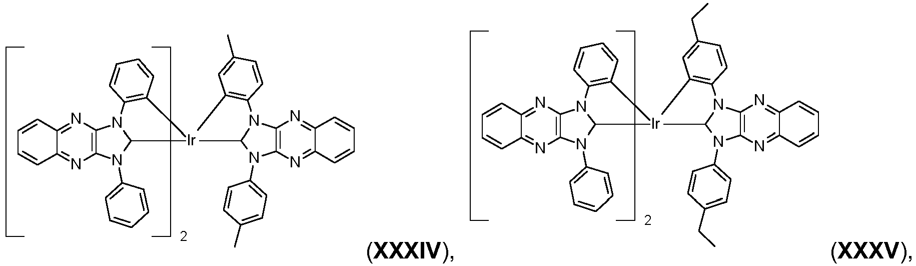 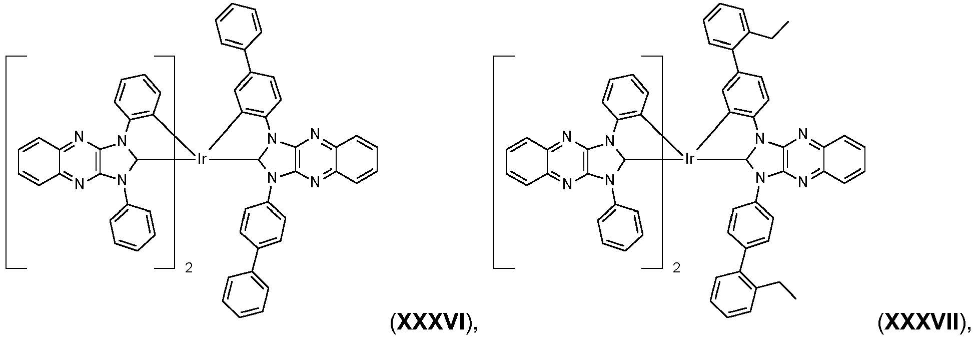 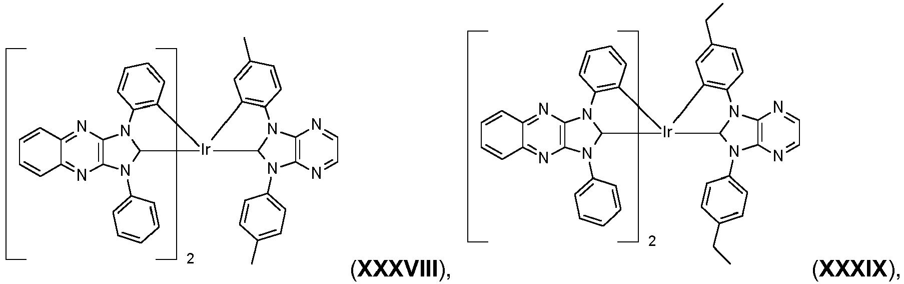 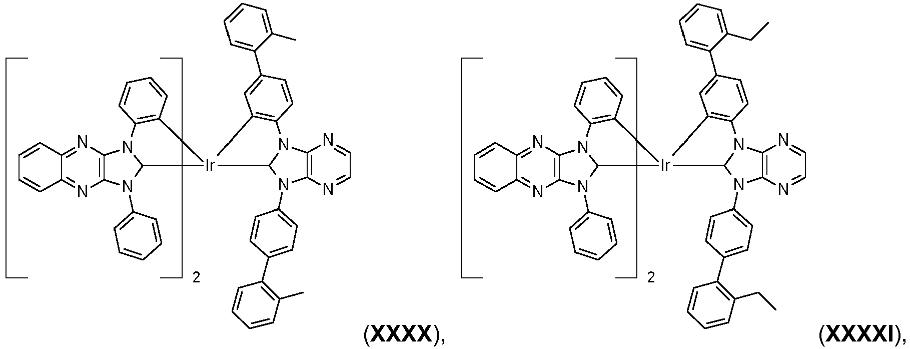 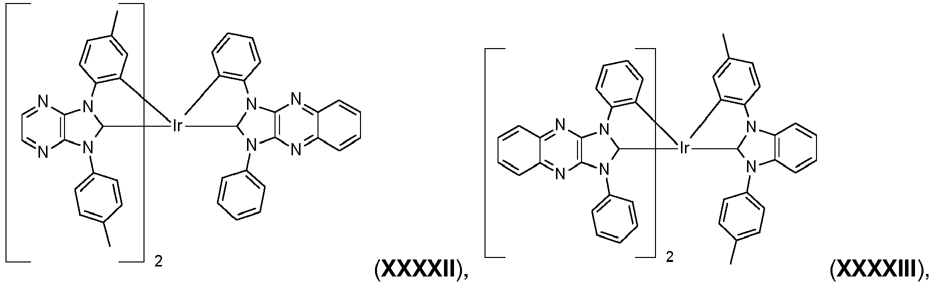 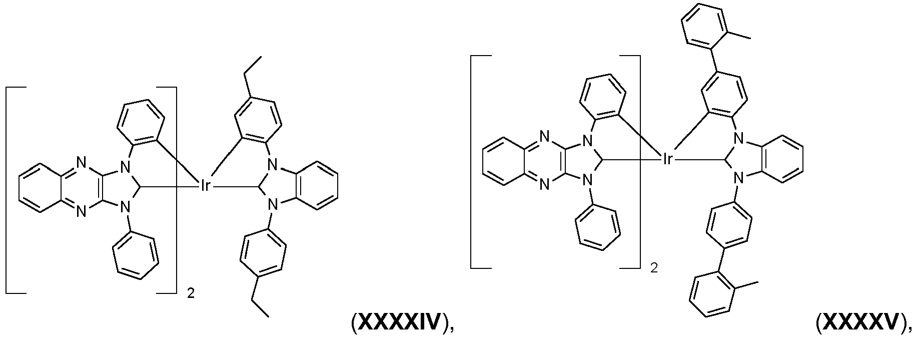 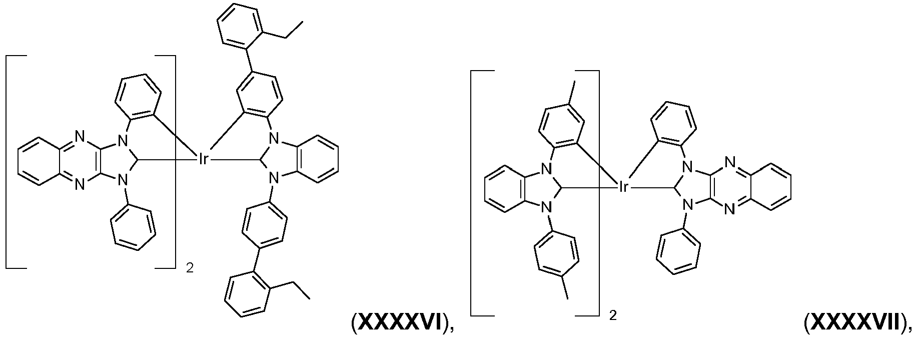 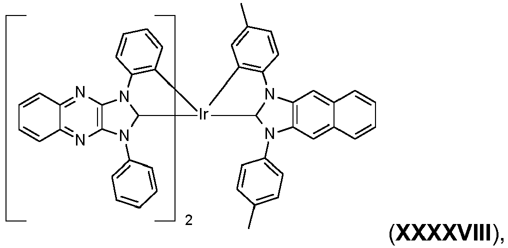 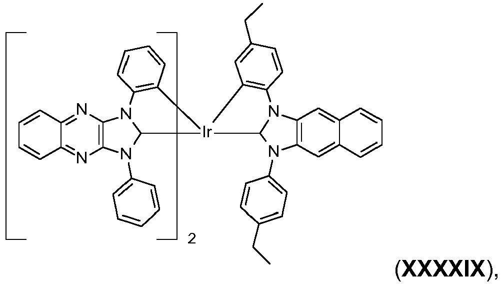 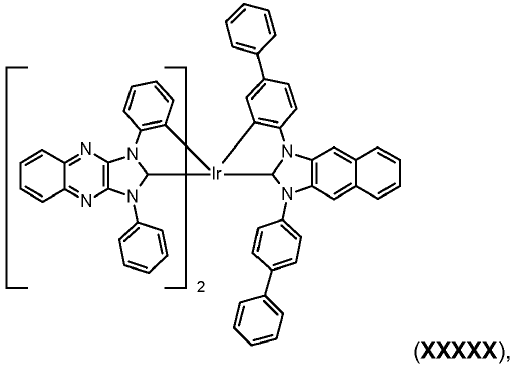 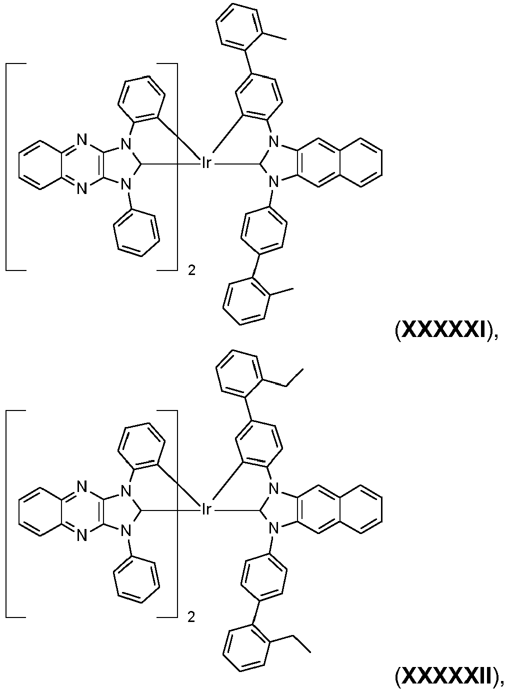 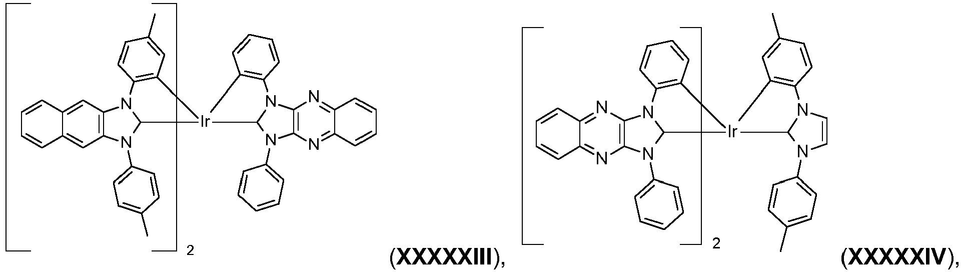 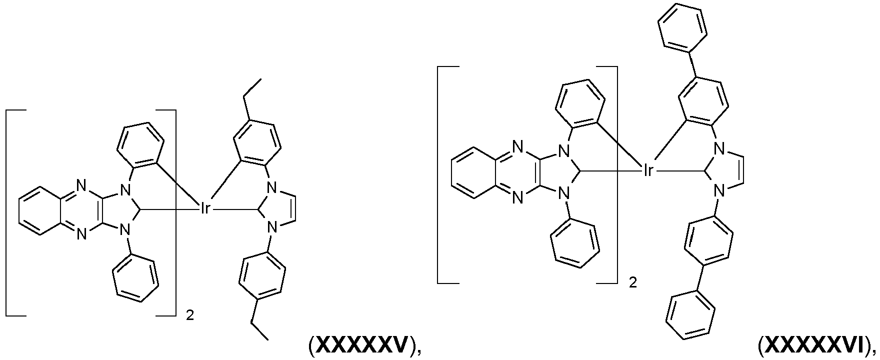 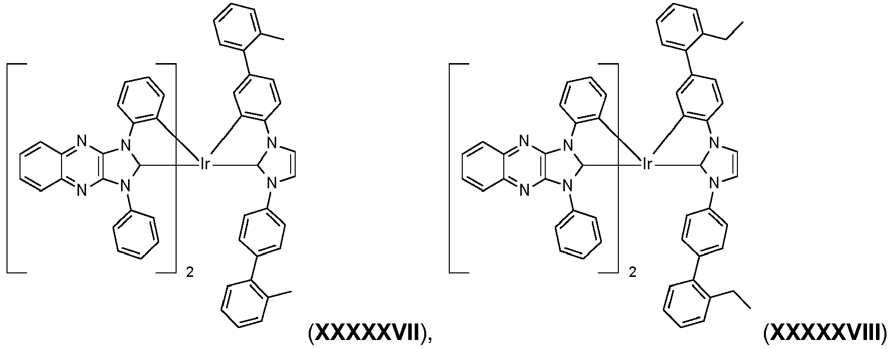 and

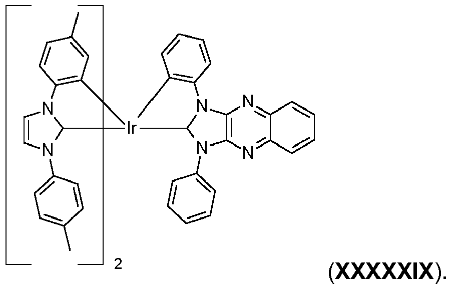

Most preferred compounds are the following compounds 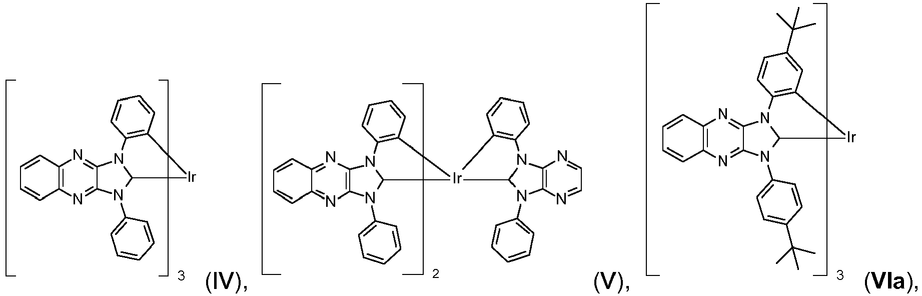 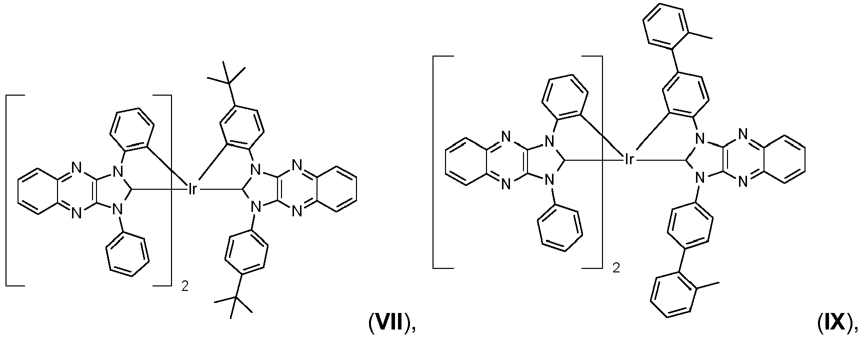 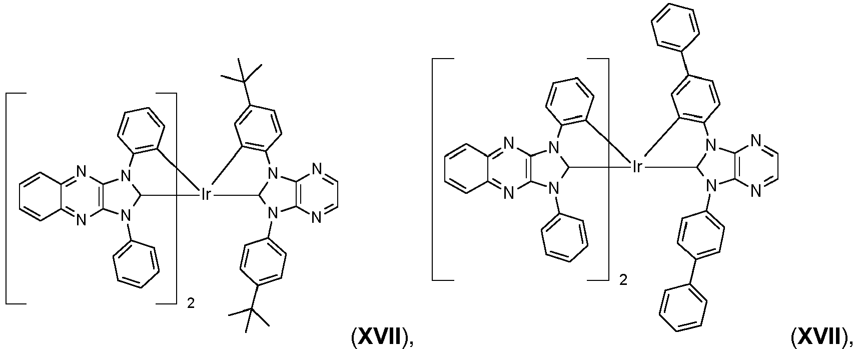 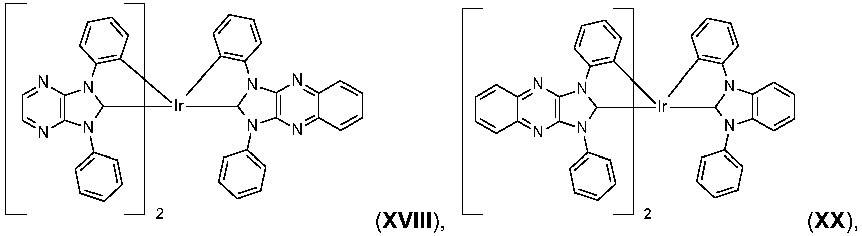 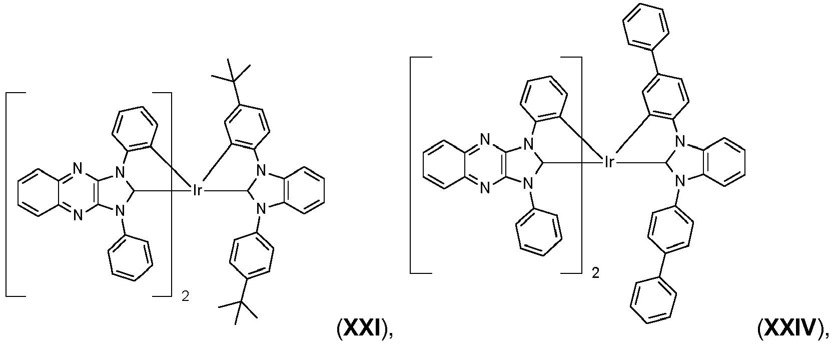 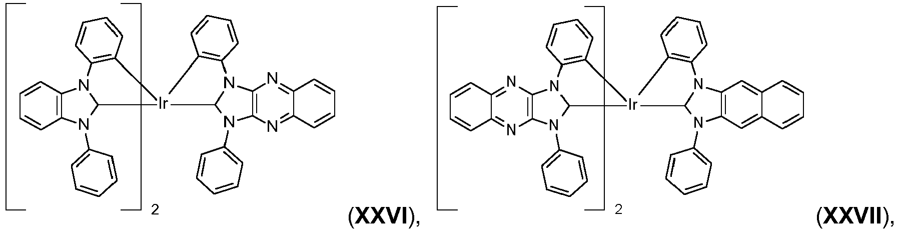 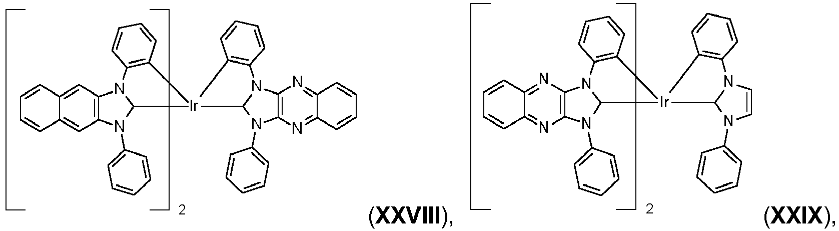 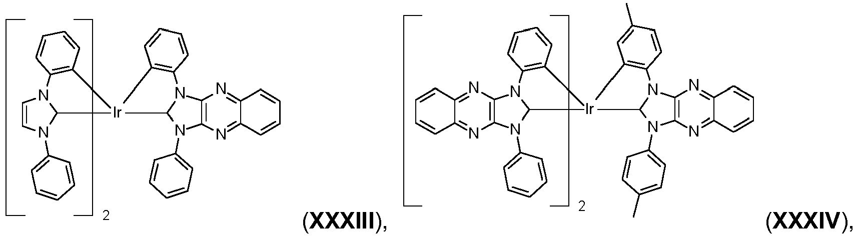 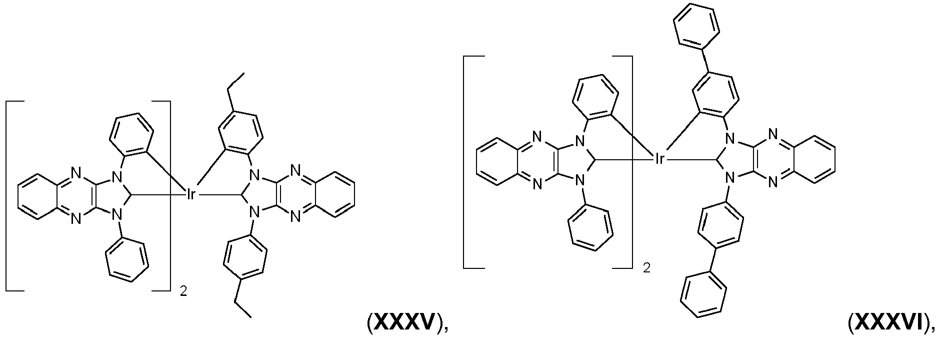 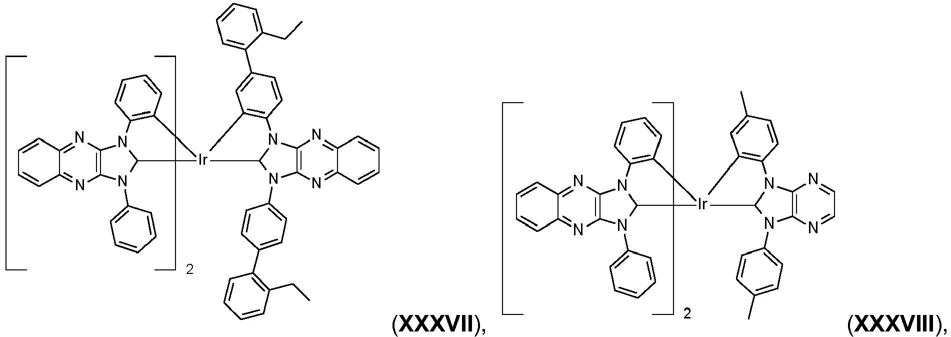 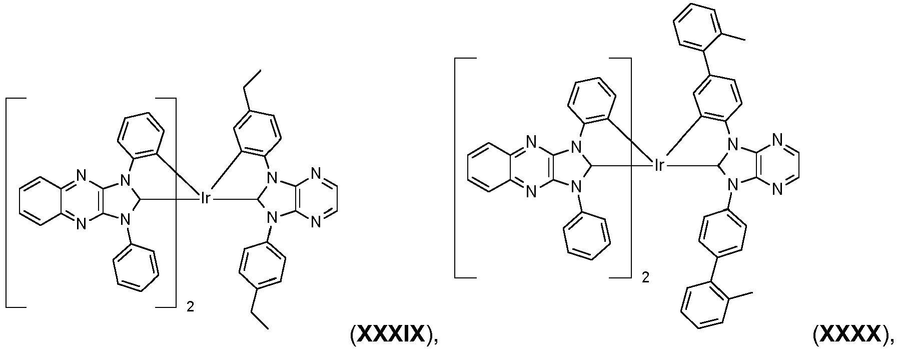 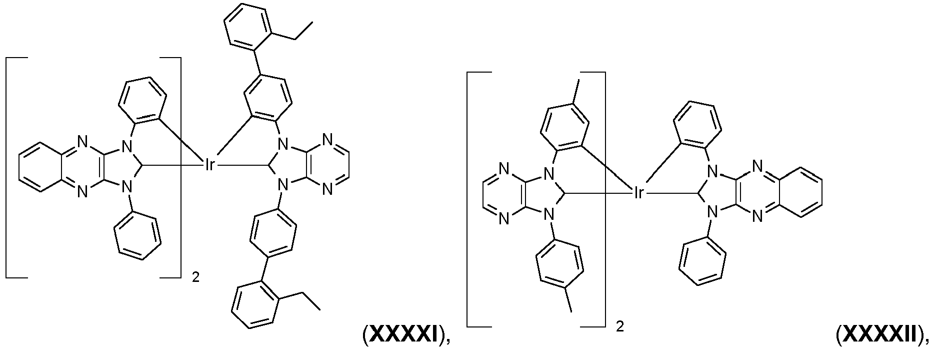 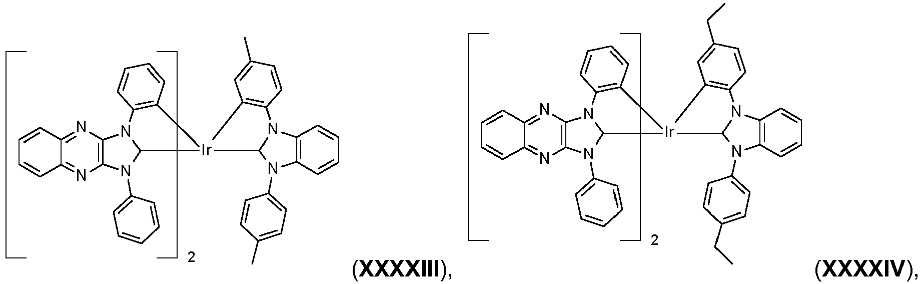 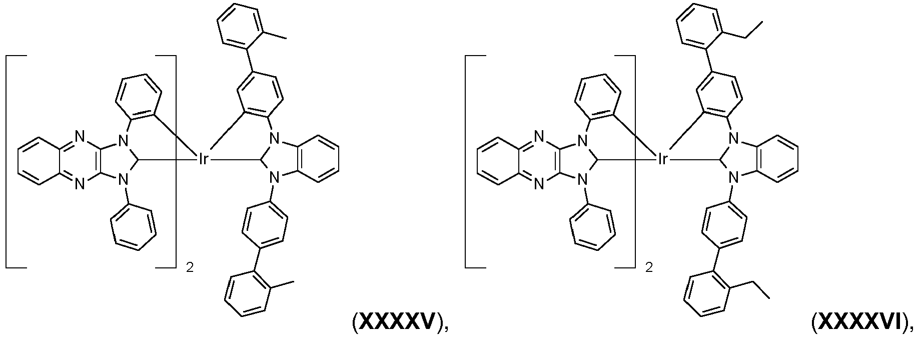 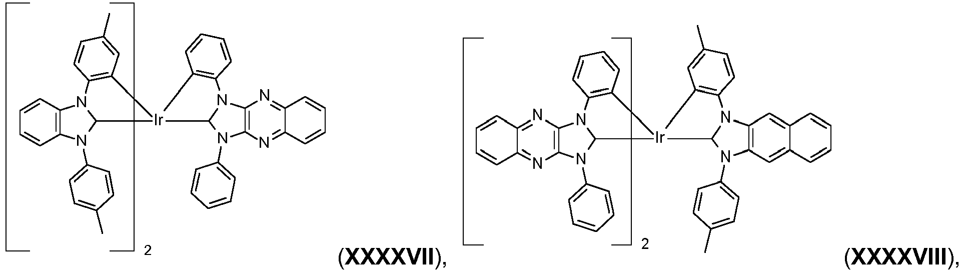 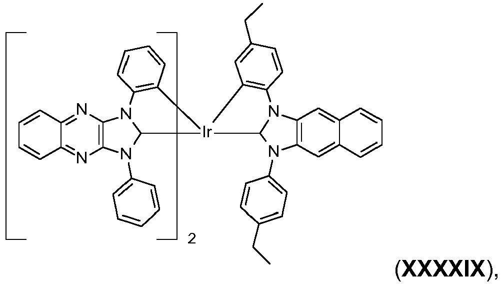 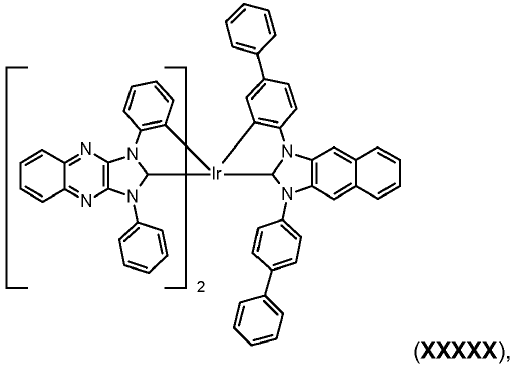 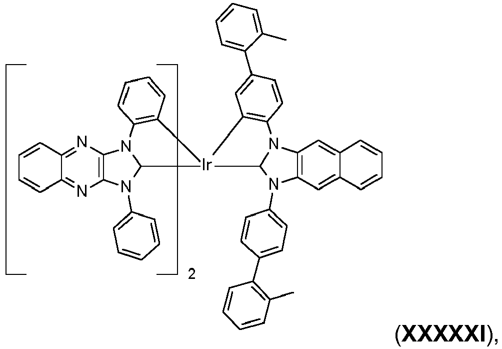 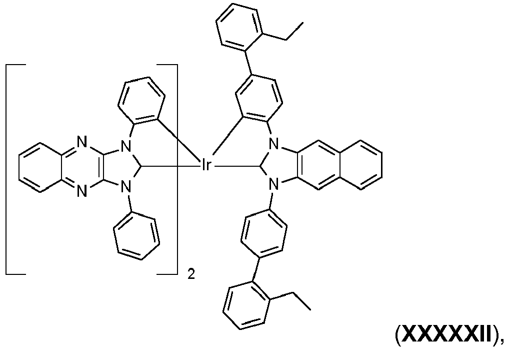 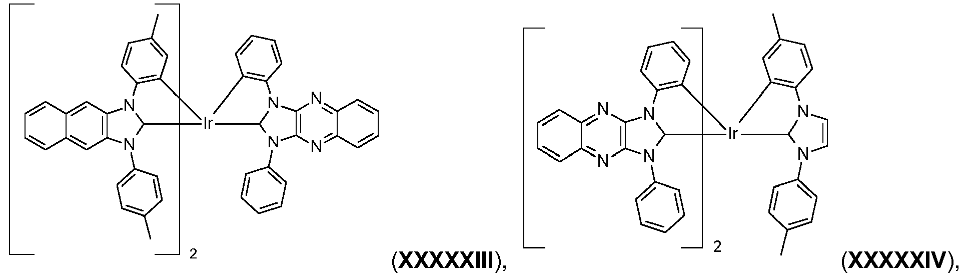 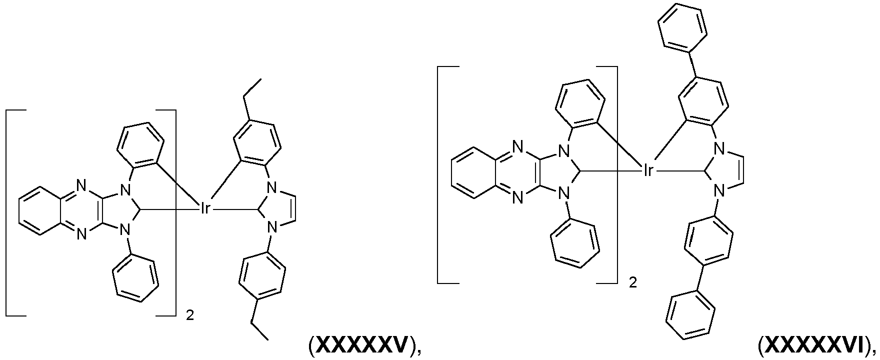 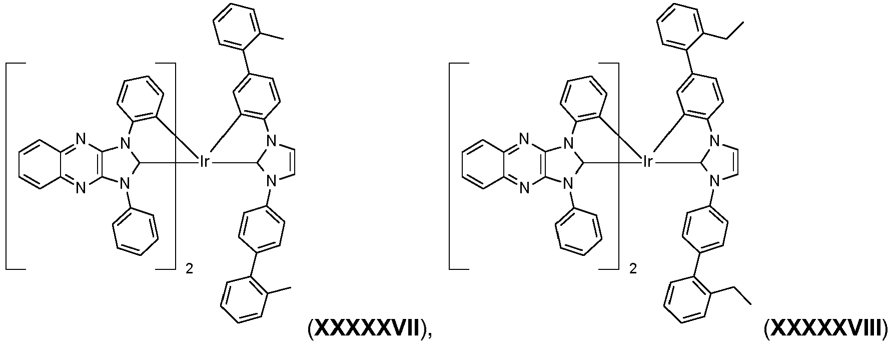 and

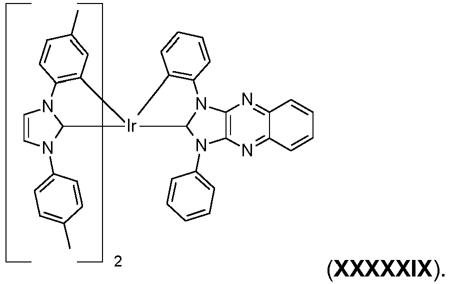

Even more preferred are the following compounds:

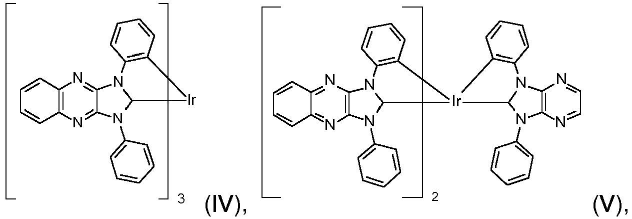

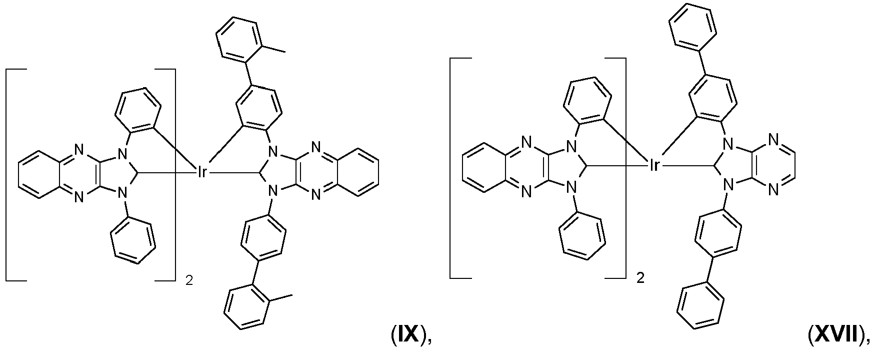

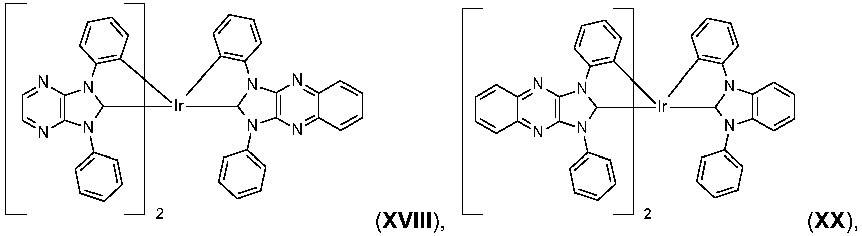

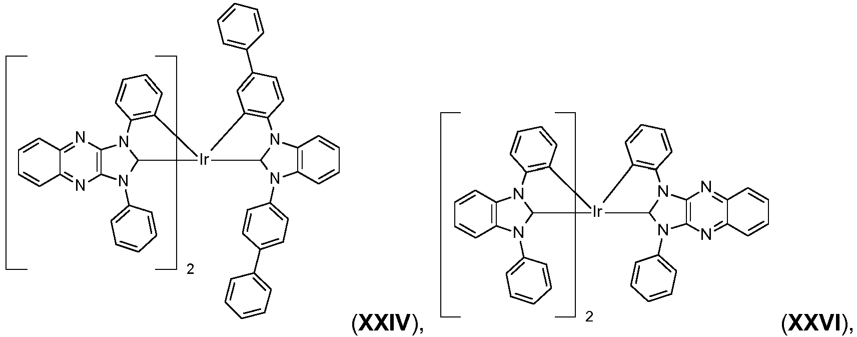

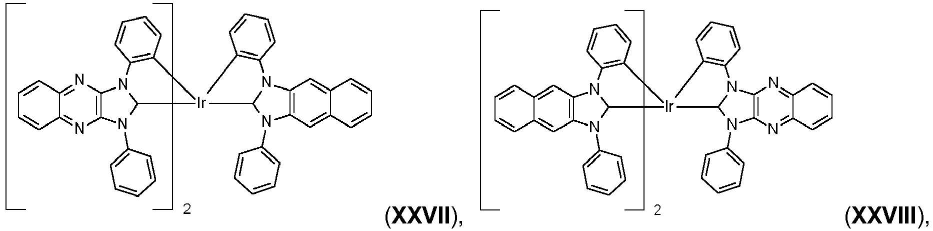

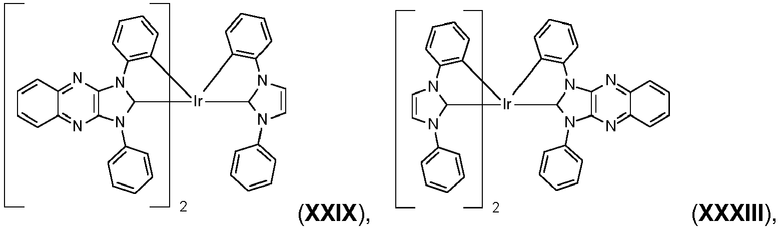

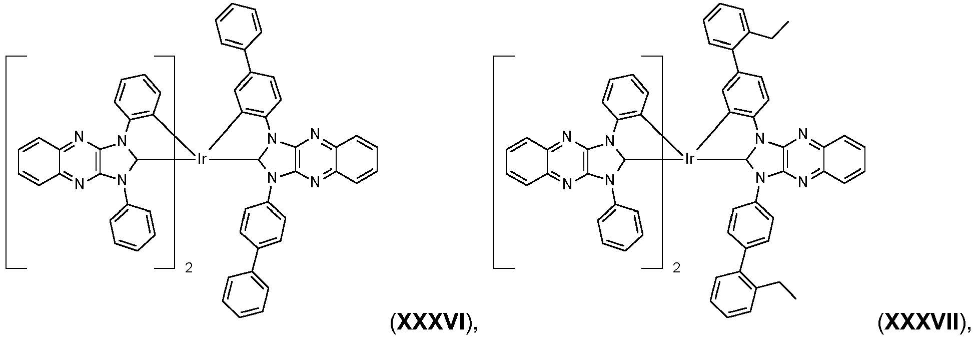

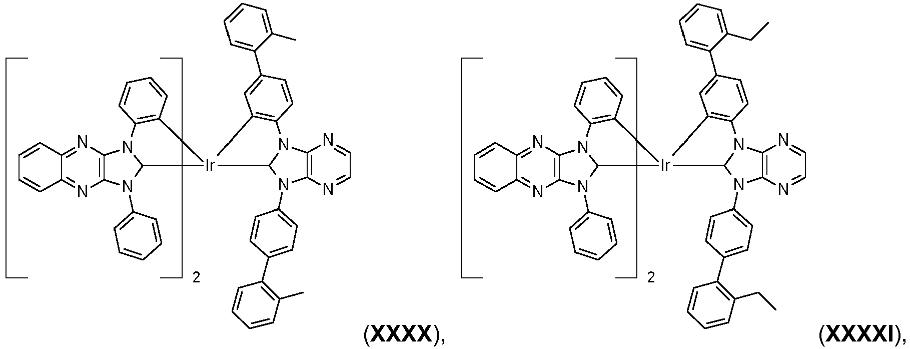

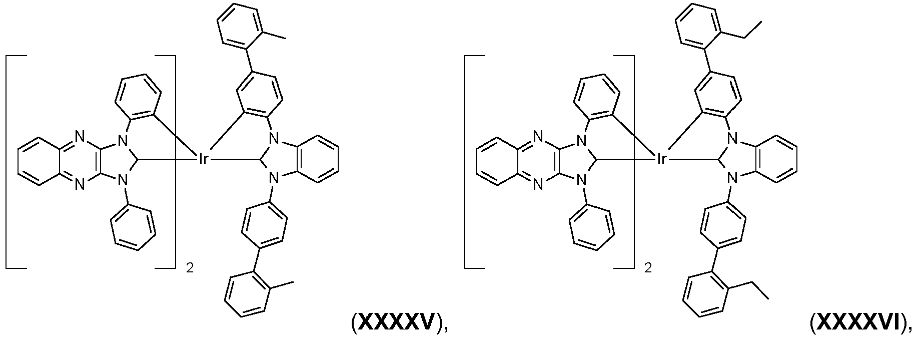

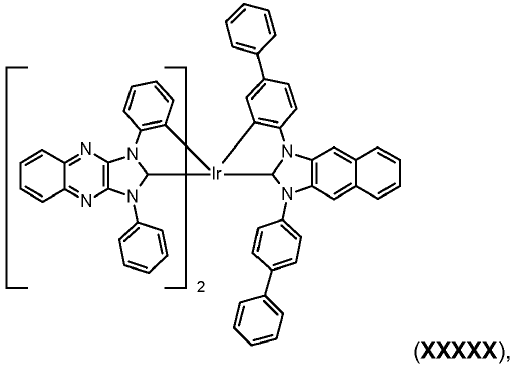

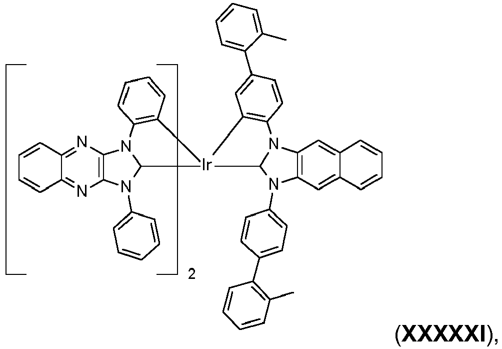

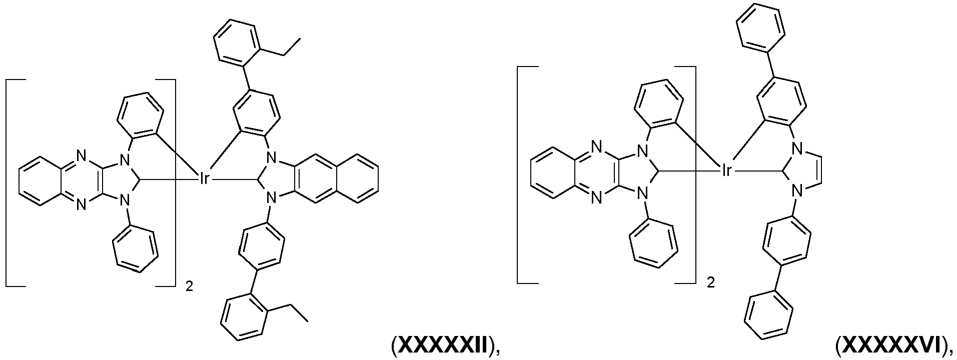

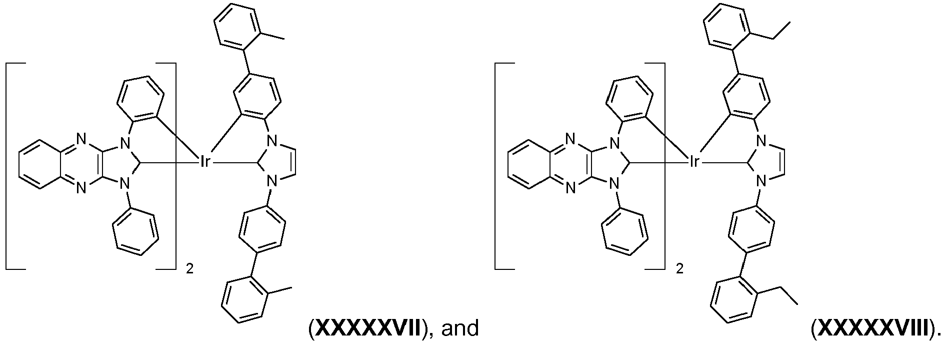

Even more preferred are the following compounds:

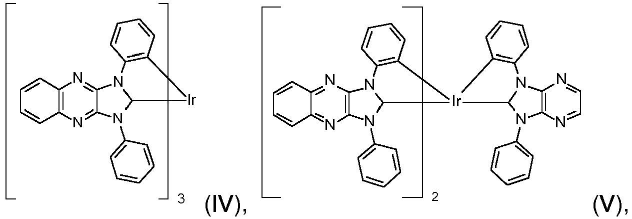

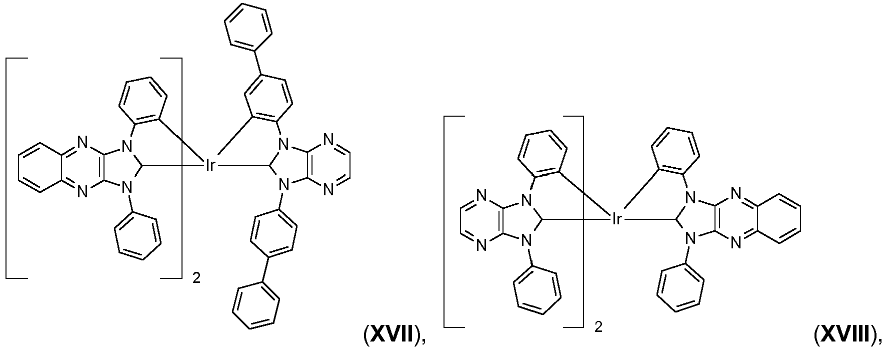

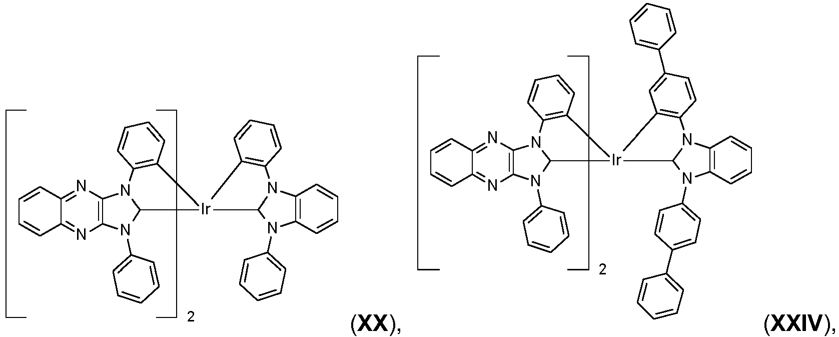

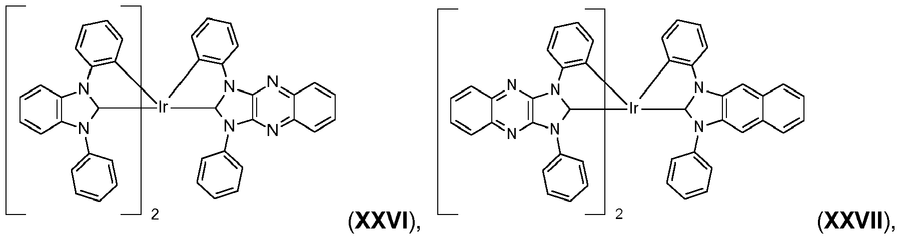

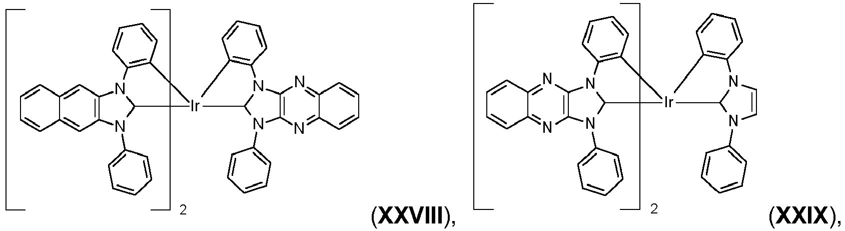

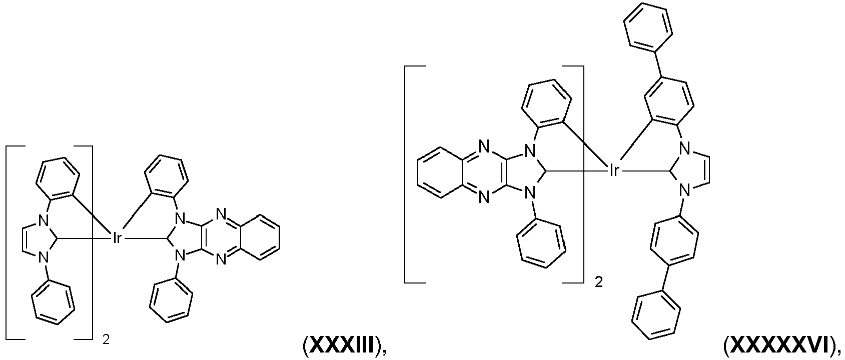

Even more preferred are the following compounds: 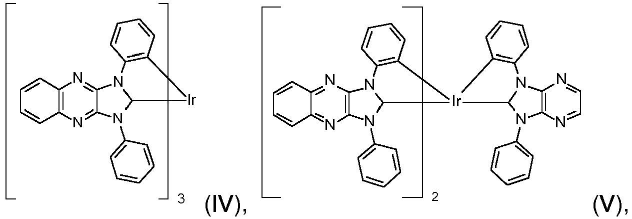 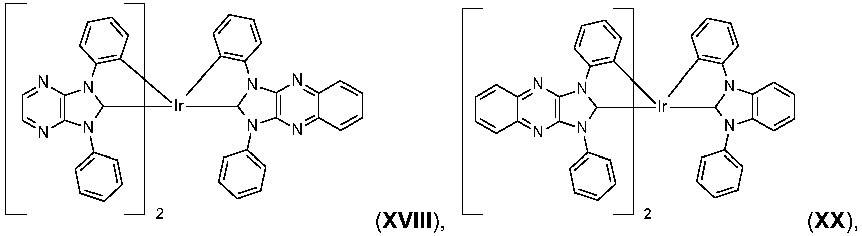 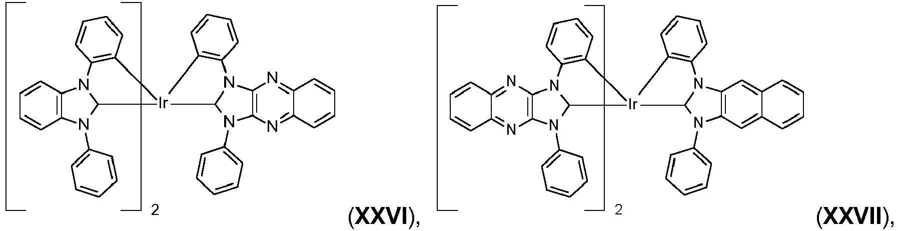 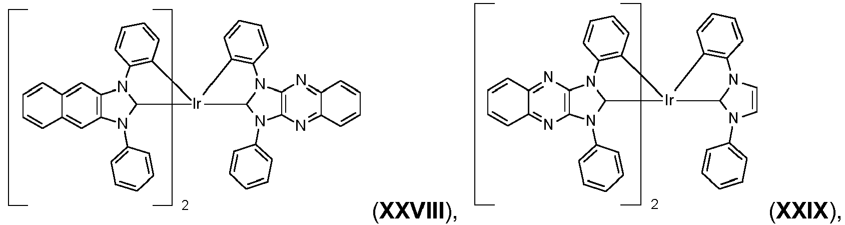 and

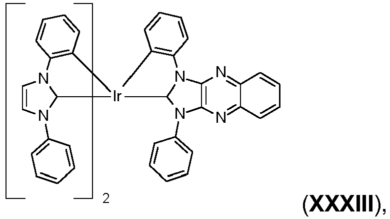

Even more preferred are the following compounds:

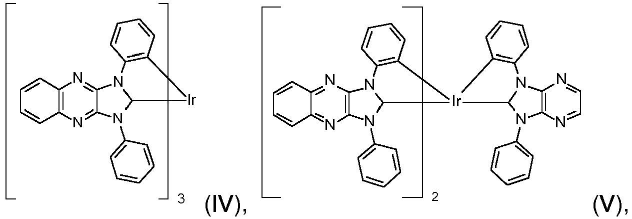

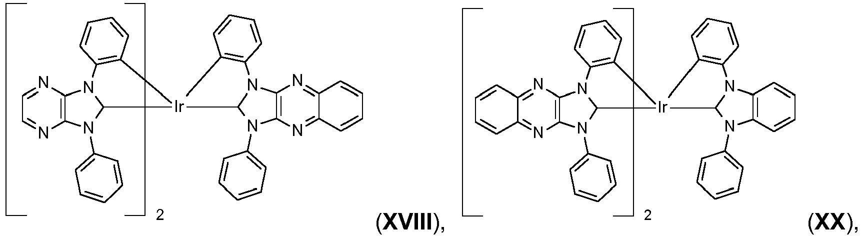

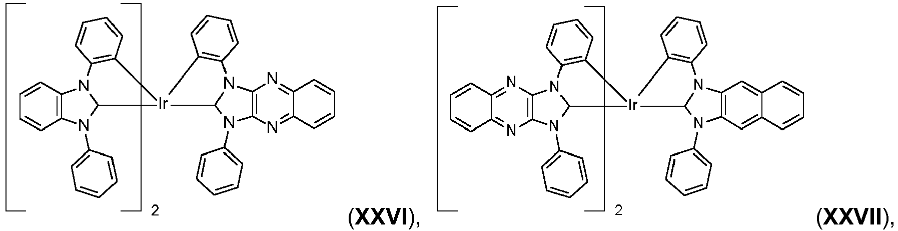

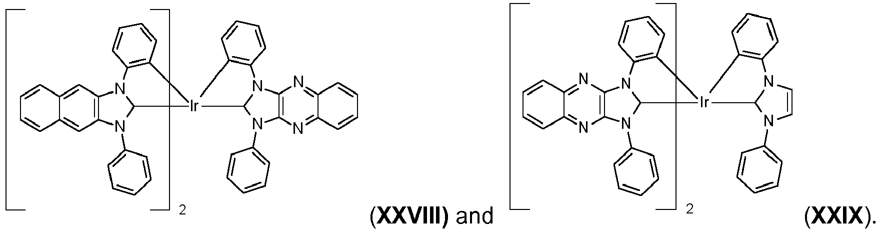

Even more preferred are the following compounds:

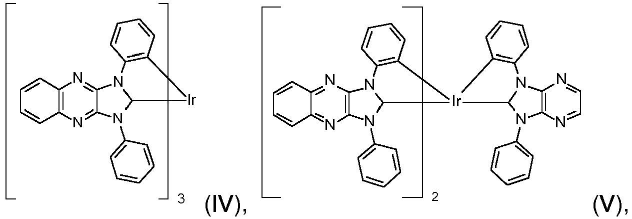

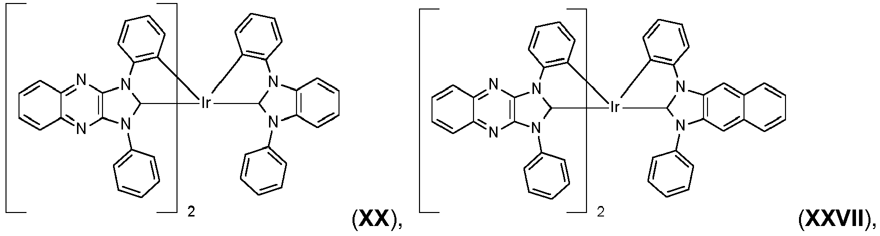

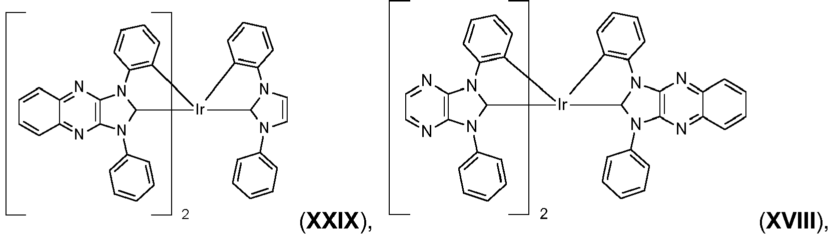

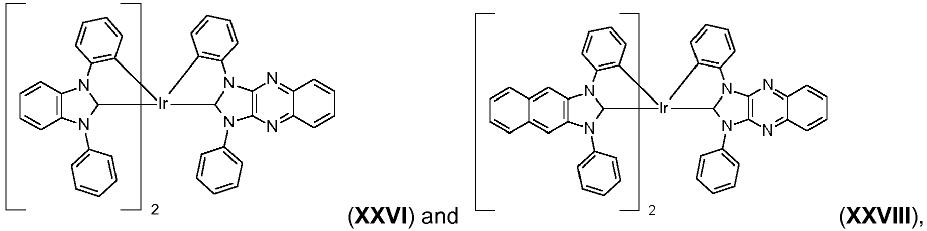

### Preparation of the inventive metal carbene complexes

### (a) Preparation of the inventive metal carbene complexes

The present invention also relates to a process for preparing the inventive metal carbene complexes, wherein the metal is selected from Ir and Pt, comprising at least one ligand of formula (A) 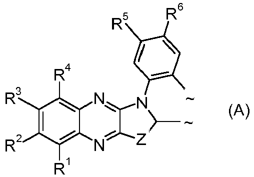 wherein
Z is NR^{x}, O or S, preferably NR^{x} or O, more preferably NR^{x},
R^{x} is 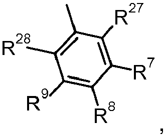 and the other residues, symbols and indices are mentioned above.

In a preferred embodiment, the present invention also relates to a process for preparing the inventive metal carbene complexes, wherein the metal is selected from Ir and Pt, comprising at least one ligand of formula (I') 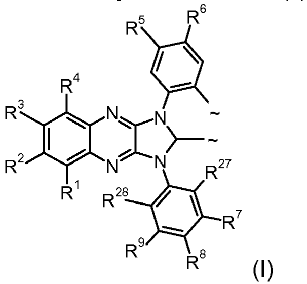 by contacting suitable compounds comprising Ir or Pt with the appropriate ligands or ligand precursors. The residues R¹, R², R³, R⁴, R⁵, R⁶, R⁷, R⁸, R⁹, R²⁷ and R²⁸ have been defined before.

In one embodiment of the process according to the invention, a suitable compound comprising iridium or platinum, preferably iridium, and appropriate carbene ligands, preferably in deprotonated form as the free carbene or in the form of a protected carbene, for example as the silver-carbene complex, are contacted.

The present invention therefore relates - in one embodiment - to a process according to the invention wherein the ligand precursor used is a corresponding Ag-carbene complex.

In a further preferred embodiment of the process according to the invention, the ligand precursors used are organic compounds which are reacted with suitable Ir or Pt comprising compounds. The carbene can be released from precursors of the carbene ligands by removing volatile substances, for example lower alcohols such as methanol or ethanol, for example at elevated temperature and/or under reduced pressure and/or using molecular sieves which bind the alcohol molecules eliminated. Corresponding processes are known to those skilled in the art.

The present invention also relates to the process according to the invention wherein the ligand precursor used is a compound of the general formula 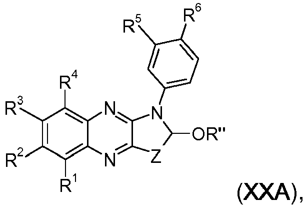 wherein R¹, R², R³, R⁴, R⁵, R⁶, R⁷, R⁸, R⁹, R²⁷ and R²⁸ and Z are as defined above, and
R" is SiR¹³R¹⁴R¹⁵, aryl, heteroaryl, alkyl, cycloalkyl or heterocycloalkyl, wherein
R¹³, R¹⁴ and R¹⁵ are independently of each other aryl, heteroaryl, alkyl, cycloalkyl or heterocycloalkyl.

Preferably, the present invention also relates to the process according to the invention wherein the ligand precursor used is a compound of the general formula 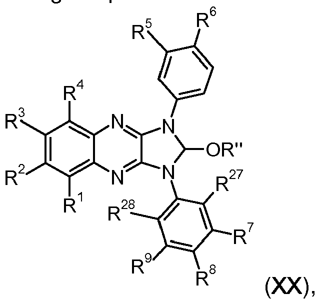 wherein R¹, R², R³, R⁴, R⁵, R⁶, R⁷, R⁸, R⁹, R²⁷ and R²⁸ are as defined above, and
R" is SiR¹³R¹⁴R¹⁵, aryl, heteroaryl, alkyl, cycloalkyl or heterocycloalkyl, wherein
R¹³, R¹⁴ and R¹⁵ are independently of each other aryl, heteroaryl, alkyl, cycloalkyl or heterocycloalkyl.

In a particularly preferred embodiment, R" is alkyl, especially C₁-C₂₀alkyl, preferably C₁-C₁₀alkyl, more preferably C₁-C₈alkyl, for example methyl, ethyl, propyl such as n-propyl, isopropyl, butyl such as n-butyl, isobutyl, tert-butyl, pentyl, hexyl, heptyl or octyl.

R" in the compound of the general formula (XXA) and (**XX**) is most preferably methyl or ethyl.

Compounds of the general formula (XXA) and (**XX**) are generally obtainable by processes known to those skilled in the art. Compounds of the general formula (XXA) and (**XX**) can be obtained for example by reacting compounds of the general formula (**XXIAa**), preferably by reacting compounds of the general formula (**XXIa**) 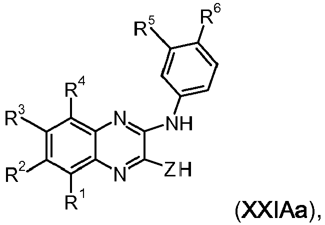 preferably 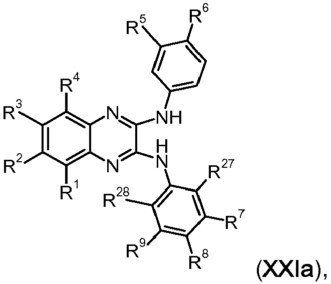 or the corresponding Cl or BF₄ salt of formula 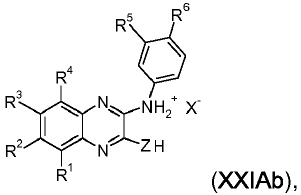 preferably 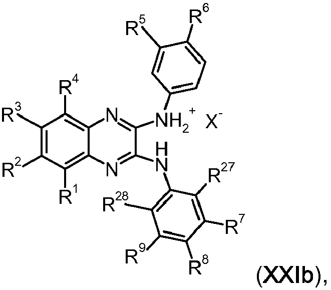 wherein X is Cl or BF₄, with compounds of the general formula HC(OR")₃ (**XXII**), or
by reacting compounds of the general formula (**XXIAa**) or (XXIAb), preferably (**XXIa**) or (XXIb) in a first step with Vilsmeier reagent ((chloromethylene)dimethylammonium chloride) and a sodium salt selected from NaBF₄, NaCl, NaBror Nal to obtain a compound of formula (XXIAc), preferably (**XXIc**) 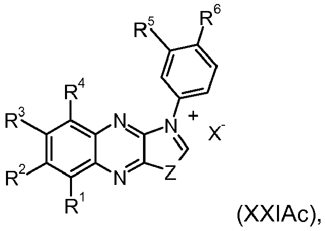 preferably 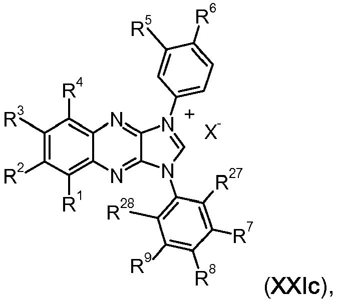 wherein X is BF₄, Cl, Bror I and in a second step with R"OH or M"OR", wherein M" is an alkali metal salt, preferably Na, wherein R, R', R⁴, R^{4'}, R⁵, R⁶ and R⁷ are as defined above and the metal is Ir or Pt, comprising one, two or three bidentate ligands of formula (**D**).

The reaction of compounds of formula (XXIAa), preferably (XXIa) with the compounds of the general formula HC(OR")₃ (**XXII**) is preferably carried out in the presence of an ammonium salt. Suitable ammonium salts are for example ammonium tetrafluoroborate or ammonium halides, e.g. ammonium chloride. The amount of the ammonium salt in relation to the compound of formula (XXIAa), preferably (XXIa) (100 mol%) is usually 1 mol% to 100 mol %.

This preparation of the compounds of the general formula (XXA), preferably (**XX**) can be effected in the presence or in the absence of a solvent. Suitable solvents are specified below. In one preferred embodiment, the compounds of the general formula (XXA), preferably (**XX**) are prepared in substance, or the compound of the general formula (XXIIA), preferably (**XXII**) is added in an excess, such that it functions as a solvent.

Compounds of the general formulae (XXIA) and (XXIIA), preferably (**XXI**) and (**XXII**) are commercially available and/or obtainable by processes known to those skilled in the art; for example, compounds of the general formula (XXIA), preferably (**XXI**) are obtainable by reacting the appropriate chlorides with the appropriate amines.

The compounds of the general formula (XXA), preferably (**XX**) are prepared generally at a temperature of 10 to 150°C, preferably 40 to 120°C, more preferably 60 to 110°C.

The reaction time is generally 2 to 48 hours, preferably 6 to 24 hours, more preferably 8 to 16 hours.

After the reaction has ended, the desired product can be isolated and purified by customary processes known to those skilled in the art, for example filtration, recrystallization, column chromatography, etc.

Appropriate compounds, especially complexes, comprising Ir or Pt, preferably iridium, are known to those skilled in the art. Particularly suitable compounds comprising platinum or iridium comprise, for example, ligands such as halides, preferably chloride, 1,5-cyclooctadiene (COD), cyclooctene (COE), phosphines, cyanides, alkoxides, pseudohalides and/or alkyl.

Particularly preferred complexes comprising the appropriate metal, especially iridium, are selected from the group consisting of [Ir(COD)Cl]₂, [Ir(COE)₂Cl]₂ IrCl₃ x H₂O, Ir(acac)₃, Ir(COD)₂BF₄, Ir(COD)₂BARF (BARF = tetrakis[3,5-bis(trifluoromethyl)phenyl]borate)), Pt(COD)Cl₂, Pt(acac)2, [Pt(C₆H₁₀)Cl₂]₂, K₂PtCl₆, Pt(pyridine)₂Cl₂, [PtMe2(SMe2)]2, Pt(SMe₂)₂Cl₂, Pt(SEt₂)₂Cl₂, Pt(phenanthroline)Cl₂, Pt(NH₃)₂Cl₂ and mixtures thereof.

The carbene ligand precursors are deprotonated, preferably before the reaction, for example, by basic compounds known to those skilled in the art, for example basic metalates, basic metal acetates, acetylacetonates or alkoxides, or bases such as KO^{t}Bu, NaO^{t}Bu, LiO^{t}Bu, NaH, silylamides, Ag₂O and phosphazene bases. Particular preference is given to deprotonating with Ag₂O to obtain the corresponding Ag-carbene, which is reacted with the compound comprising M to give the inventive complexes.

Particularly preferably, the carbene can be released from precursors of the carbene ligands by removing volatile substances, for example lower alcohols.

The process according to the invention for preparing the metal carbene complexes comprising at least one ligand of formula (I) according to the present invention using the compounds of the general formula (**XX**) has the advantage that the compounds of the general formula (XXA), preferably (**XX**) are stable intermediates which can be handled readily and can be isolated under standard laboratory conditions. In addition, the compounds of the general formula (XXA), preferably (**XX**) are soluble in customary organic solvents, such that the preparation of the inventive metal carbene complexes comprising at least one ligand of formula (A), preferably of formula (I) in homogeneous solution is possible, such that a workup of the desired product, i.e. of the metal carbene complexes comprising at least one ligand of formula (A), preferably of formula (I) is more readily possible, for example for isolation and/or purification.

The contacting is preferably effected in a solvent. Suitable solvents are known per se to those skilled in the art and are preferably selected from the group consisting of aromatic or aliphatic solvents, for example benzene, toluene, xylene or mesitylene, cyclic or acyclic ethers, for example dioxane or THF, alcohols, esters, amides, ketones, nitriles, halogenated compounds and mixtures thereof. Particularly preferred solvents are toluene, xylenes, mesitylene and dioxane.

The molar ratio of metal-noncarbene complex used to carbene ligand precursor used is generally 1:10 to 10:1, preferably 1:1 to 1:6, more preferably 1:2 to 1:5.

The contacting is generally effected at a temperature of 20 to 200°C, preferably 50 to 150°C, more preferably 60 to 150°C.

The reaction time depends on the desired carbene complex and is generally 0.02 to 50 hours, preferably 0.1 to 24 hours, more preferably 1 to 24 hours.

The metal carbene complexes comprising at least one ligand of formula (A), preferably of formula (I) obtained after the reaction can optionally be purified by processes known to those skilled in the art, for example washing, crystallization or chromatography, and optionally isomerized under conditions likewise known to those skilled in the art, for example with acid mediation, thermally or photochemically.

Suitable processes for preparing the metal carbene complex comprising at least one ligand of formula (A), preferably of formula (I) are for example mentioned in WO 2011/073149 and EP13174779.

The resulting complexes may yield different isomers that can be separated or converted into a form with a major isomer by isomerization of the mixture.

### (b) Post functionalization

It is also possible to insert the radical R⁵ - if present - by post-functionalization of the metal carbene complex (which does not comprise a residue R⁵). In the case of inventive heteroleptic metal carbene complexes comprising a ligand L selected from the ligands (X-1), (X-2), (X-3) or (X-4), comprising a substitutable position R⁵ (the position R⁵ is shown in the ligands (X-1'), (X-2'), (X-3') or (X-4')), in general, also the position R⁵ in said ligand L is post-functionalized at the same time.

The post-functionalization is exemplified in the following for ligands of formula (I), wherein Z - as mentioned in the ligands of formula (A) - is NR^{x}. However, a person skilled in the art knows that the post-functionalization steps can be easily transferred to prepare ligands of formula (A), wherein Z is O or S.

The present invention therefore further provides a process for preparing a metal carbene complex according to the present invention, compising at least one ligand of formula (I') 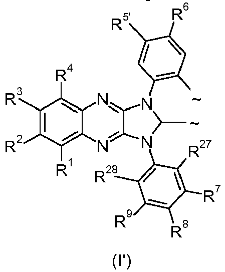 wherein the residues R¹, R², R³, R⁴, R⁶, R⁷, R⁸, R⁹, R²⁷ and R²⁸ have been defined before, and
R^{5'} is a C₁-C₁₈alkyl group, which can optionally be substituted by at least one substituent E and/or interrupted by D; a C₃-C₁₂cycloalkyl group, which can optionally be substituted by at least one substituent E; a C₆-C₁₄aryl group, which can optionally be substituted by at least one substituent G; a -N(C₆-C₁₄aryl)₂ group, which can optionally be substituted by at least one substituent G; or a heteroaryl group comprising 3 to 11 ring atoms, which can optionally be substituted by at least one substituent G, interrupted by at least one of O, S and N; comprising reacting metal carbene complex, wherein the metal is selected from Ir and Pt, comprising at least one ligand of formula of formula (III) 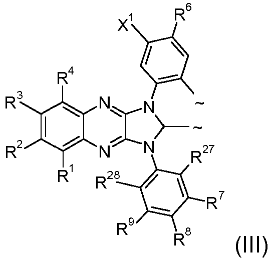 with a compound of formula (IV) corresponding to the respective Y-substituted residue R^{5'}:
R^{5'}-Y (**IV**)
wherein
X¹ is Cl, Br, or I, especially Br;
Y is -B(OH)₂, -B(OY¹)₂, 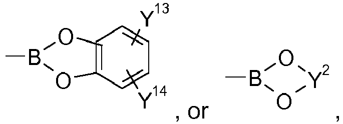 wherein Y¹ is a C₁-C₁₀alkyl group and
Y² is independently in each occurrence a C₂-C₁₀alkylene group, such as -CY³Y⁴-CY⁵Y⁶-, or-CY⁷Y⁸-CY⁹Y¹⁰- CY¹¹Y¹²- wherein Y³, Y⁴, Y⁵, Y⁶, Y⁷, Y⁸, Y⁹, Y¹⁰, Y¹¹ and Y¹² are independently of each other hydrogen, or a C₁-C₁₀alkyl group, especially -C(CH₃)₂C(CH₃)₂-, -CH₂C(CH₃)₂CH₂-, or -C(CH₃)₂CH₂C(CH₃)₂-, and Y¹³ and Y¹⁴ are independently of each other hydrogen, or a C₁-C₁₀alkyl group;
-SnR³⁰⁷R³⁰⁸R³⁰⁹, wherein R³⁰⁷, R³⁰⁸ and R³⁰⁹ are identical or different and are H or C₁-C₆alkyl, wherein two radicals optionally form a common ring and these radicals are optionally branched or unbranched;
ZnR³¹⁰R³¹¹, wherein R³¹⁰ is halogen and R³¹¹ is a C₁-C₁₀alkyl group, a C₆-C₁₂aryl group, or C₁-C₁₀alkenyl group; or
SiR³¹²R³¹³R³¹⁴, wherein R³¹², R³¹³ and R³¹⁴ are identical or different and are halogen, or C₁-C₆alkyl.

Preferred residues R^{5'} are:
a C₁-C₁₂alkyl group, which can optionally be substituted by E and/or interrupted by D; a C₃-C₁₂cycloalkyl group, which can optionally be substituted by E;
or
R^{5'}, is a group of formula 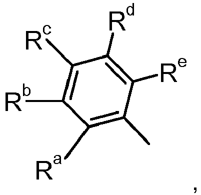
R^{a} is H, a C₁-C₅alkyl group, a fluoroC₁-C₄alkyl group, or a C₃-C₆cycloalkyl group; preferably H, a C₁-C₅alkyl group, C₃-C₆cycloalkyl group; more preferably H, or a C₁-C₅alkyl group;
R^{e} is H, a C₁-C₅alkyl group, a fluoroC₁-C₄alkyl group, or a C₃-C₆cycloalkyl group; preferably H, a C₁-C₅alkyl group, C₃-C₆cycloalkyl group; more preferably H, or a C₁-C₅alkyl group;
R^{c}, R^{b} and R^{d} are independently of each other hydrogen; a C₁-C₁₈alkyl group, which can optionally be substituted by E and/or interupted by D; a C₃-C₁₂cycloalkyl group, which can optionally be substituted by G; a C₆-C₁₄aryl group, which can optionally be substituted by G; or a C₂-C₃₀heteroaryl group, which can optionally be substituted by G; C₁-C₈haloalkyl such as CF₃; or SiR⁸⁰R⁸¹R⁸²; preferably R^{c}, R^{b} and R^{d} are independently of each other H, a C₁-C₅alkyl group, C₃-C₆cycloalkyl group; more preferably H, or a C₁-C₅alkyl group;
or
R^{c} and R^{b}, or R^{a} and R^{b} together form a group of formula 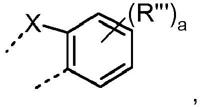 wherein X is O, S,
NR⁷⁵ or CR⁷³R⁷⁴; R'" is C₁-C₈alkyl and a is 0, 1 or 2, preferably 0 or 1, more preferably 0.

More preferably, R^{5'} is a C₁-C₈alkyl group, which can optionally be substituted by at least one substituent E and/or interrupted by D; or R^{5'} is a C₃-C₆cycloalkyl group, which can optionally be substituted by at least one substituent E; or a phenyl group, which can optionally be substituted by one or two groups G.

Most preferably, R^{5'} is a C₁-C₈alkyl group, which can optionally be substituted by at least one substituent E; or a C₃-C₆cycloalkyl group, which can optionally be substituted by at least one substituent E; or a phenyl group, which can optionally be substituted by one or two groups G.

Suitable and preferred groups E, D and G are mentioned before.

Preferred residues R¹, R², R³, R⁴, R⁶, R⁷, R⁸, R⁹, R²⁷ and R²⁸ have also been defined before.

Preferred reactions for the introduction of the substituent R^{5'} on the compound of formula (III) are in general metal catalyzed reactions and more specifically Suzuki, Ullmann, Negishi, Heck, Stille and Kumada coupling reactions (J. Hassan et al., Chemical Reviews 102 (2002) 5; L. Ackermann: "Modern Arylation Methods" (Ed.: L. Ackermann), Wiley-VCH, Weinheim, 2009).

Preferably, the inventive metal carbene complex of formula (I') comprising a residue R^{5'} as mentioned above can be synthesized by one of the following coupling reactions:
i) Negishi coupling reaction using a compound of formula: R^{5'}-Y, wherein Y is ZnR³¹⁰R³¹¹, wherein R³¹⁰ is halogen and R³¹¹ is a C₁-C₁₀alkyl group, a C₆-C₁₂aryl group, or C₁-C₁₀alkenyl group. Reference is, for example, made to B. Vilas et al., Chem. Soc. Rev., 38 (2009) 1598-1607.
ii) Stille coupling reaction using a compound of formula: R^{5'}-Y, wherein Y is -SnR³⁰⁷R³⁰⁸R³⁰⁹, wherein R³⁰⁷, R³⁰⁸ and R³⁰⁹ are identical or different and are H or C₁-C₆alkyl, wherein two radicals optionally form a common ring and these radicals are optionally branched or unbranched. Reference is, for example, made to J. K. Stille, Angew. Chem. 98 (1986) 504 - 519; P. Espinet et al., Angew. Chem. Int. Ed., 43 (2004) 4704-4734.
iii) Hiyama coupling reaction using a a compound of formula: R^{5'}-Y, wherein Y is SiR³¹²R³¹³R³¹⁴, wherein R³¹², R³¹³ and R³¹⁴ are identical or different and are halogen, or C₁-C₆alkyl. Reference is, for example, made to T. Hiyama et al., Pure Appl. Chem. 66 (1994) 1471-1478 and T. Hiyama et al., Synlett (1991) 845-853.
iv) Suzuki coupling reaction using a a compound of formula: R^{5'}-Y, wherein Y is -B(OH)₂, -B(OY¹)₂, 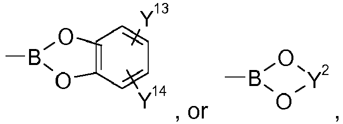 wherein Y¹ is a C₁-C₁₀alkyl group and Y² is independently in each occurrence a C₂-C₁₀alkylene group, such as -CY³Y⁴-CY⁵Y⁶-, or-CY⁷Y⁸-CY⁹Y¹⁰- CY¹¹Y¹²-, wherein Y³, Y⁴, Y⁵, Y⁶, Y⁷, Y⁸, Y⁹, Y¹⁰, Y¹¹ and Y¹² are independently of each other hydrogen, or a C₁-C₁₀alkyl group, especially -C(CH₃)₂C(CH₃)₂-, -CH₂C(CH₃)₂CH₂-, or -C(CH₃)₂CH₂C(CH₃)₂-, and Y¹³ and Y¹⁴ are independently of each other hydrogen, or a C₁-C₁₀alkyl group. Reference is, for example, made to A. Suzuki et al., Chemical Reviews 95 (1995) 2457-2483, "Suzuki in Modern Arene Chemistry" (Ed.: D. Astruc), Wiley-VCH, Weinheim, 2002, pp. 53 - 106. More preferably Suzuki and Negishi coupling reactions are used. Suzuki type reactions are most preferred.

Preferably, the Suzuki reaction of compound (III) with compound (IV) is carried out in presence of
a) a catalyst/ligand system comprising a palladium catalyst and an organic phosphine or phosphonium compound,
b) a base,
c) a solvent or a mixture of solvents.

The organic solvent is usually an aromatic hydrocarbon, a linear, branched, or cyclic ether, or a usual polar organic solvent, such as benzene, toluene, xylene, tetrahydrofurane, or dioxane, or mixtures thereof. If desired, water can be added to the organic reaction medium, in which case, depending on the organic solvent used, the reaction can be carried out in a single phase or in a two-phase mixture.

Usually, the amount of the solvent is chosen in the range of from 1 to 10 I per mol of boronic acid derivative.

Also preferred, the reaction is carried out under an inert atmosphere such as nitrogen, or argon.

Further, it is preferred to carry out the reaction in the presence of an aqueous base, such as an alkali metal hydroxide, metal phosphate, or carbonate such as NaOH, KOH, K₃PO₄, Na₂CO₃, K₂CO₃, or Cs₂CO₃.

Organic bases, such as, for example, tetraalkylammonium hydroxide, and phase transfer catalysts, such as, for example TBAB, can promote the activity of the boron (see, for example, Leadbeater & Marco; Angew. Chem. Int. Ed. Eng. 42 (2003) 1407 and references cited therein).

Usually, the molar ratio of the base to boronic acid or boronic ester derivative is chosen in the range of from 0.5:1 to 50:1, very especially in the range of 1:1 to 5:1.

Generally, the reaction temperature is chosen in the range of from 40 to 180°C, preferably under reflux conditions.

Generally, the reaction time is chosen in the range of from 0.5 to 80 hours, preferably from 2 hours to 60 hours.

In a preferred embodiment a usual catalyst for coupling reactions or for polycondensation reactions is used, preferably Pd-based, which is described in WO2007/101820. The palladium compound is added in a ratio of from 1:10000 to 1:50, preferably from 1:5000 to 1:200, based on the number of bonds to be closed. Preference is given, for example, to the use of palladium(II) salts such as PdOAc₂ or Pd₂dba₃ and to the addition of ligands selected from the group consisting of 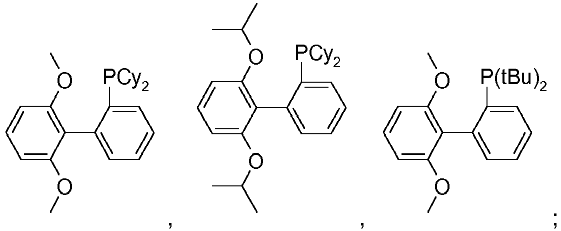 wherein

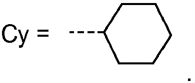

The ligand is added in a ratio of from 1:1 to 1:10, based on Pd. Also preferred, the catalyst is added as in solution or suspension. Preferably, an appropriate organic solvent such as the ones described above, preferably benzene, toluene, xylene, THF, dioxane, more preferably toluene, or mixtures thereof, is used. The amount of solvent usually is chosen in the range of from 1 to 10 I per mol of boronic acid derivative.

Other variations of reaction conditions are given by T. I. Wallow and B. M. Novak in J. Org. Chem. 59 (1994) 5034-5037; and M. Remmers, M. Schulze, G. Wegner in Macromol. Rapid Commun. 17 (1996) 239-252 and G. A. Molander und B. Canturk, Angew. Chem., 121 (2009) 9404 - 9425.

The following reaction systems are preferred:
i) aryl boronic acid, tris(dibenzylideneacetone) dipalladium(0), SPhos (Dicyclohexylphosphino-2',6'-dimethoxybiphenyl), tripotassium phosphate (solvent toluene/water mixture);
ii) aryl boronic acid, bis(tri-*t*-butylphosphin)palladium(0) (Pd[P(tBu)₃]₂), sodium hydroxide (solvent toluene/dioxane/water mixture); and
iii) aryl boronic acid, palladium acetate (Pd(OAc)₂), SPhos (Dicyclohexylphosphino-2',6'-dimethoxybiphenyl), tripotassium phosphate (o-xylene mixture).

The metal carbene complex, wherein the metal is selected from Ir and Pt, comprising at least one ligand of formula of formula (III) can be obtained by reacting a metal carbene complex, wherein the metal is selected from Ir and Pt, comprising at least one ligand of formula of formula (III') 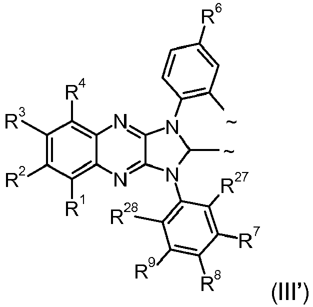 with a halogenating agent, wherein R¹, R², R³, R⁴, R⁶, R⁷, R⁸, R⁹, R²⁷ and R²⁸ have been defined before. The halogenation can be performed by methods known to those skilled in the art.

Halogenating agents according to the invention are the halogens X₂ or the interhalogens X-X and a base in a ratio of from 1:1 to 1:100 and optionally a Lewis acid in a ratio (halogen to Lewis acid) of from 1:0.1 to 1:0.0001, for example chlorine, bromine or iodine, or chlorine fluoride, bromine fluoride, iodine fluoride, bromine chloride, iodine chloride or iodine bromide, in combination with organic bases such as amines, for example triethylamine, tri-n-butylamine, diisopropylethylamine, morpholine, N-methylmorpholine and pyridine, or salts of carboxylic acids such as sodium acetate, sodium propionate, sodium benzoate, or inorganic bases such as sodium or potassium phosphate or hydrogenphosphate, potassium or sodium hydrogencarbonate, potassium or sodium carbonate, or else organic bromine complexes such as pyridinium perbromide, optionally each in combination with a Lewis acid, e.g. boron trifluoride, boron trifluoride etherate, boron trichloride, boron tribromide, boron triiodide, aluminum trichloride, aluminum tribromide, aluminum triiodide, iron(III) chloride, iron(III)bromide, zinc(II)chloride, zinc(II)bromide, tin(IV)chloride, tin(IV)bromide, phosphorus pentachloride, arsenic pentachloride and antimony pentachloride are used.

Further halogenating agents according to the invention are organic N-X compounds, such as 1-(chloromethyl)-4-fluoro-1,4-diazoniabicyclo[2.2.2]octane bis(tetrafluoroborate), or N-halocarboxamides such as N-chloro-, N-bromo- and N-iodoacetamide, N-chloro-, N-bromo- and N-iodopropionamide, N-chloro-, N-bromo- and N-iodobenzamide, or N-halocarboximides such as N-chloro-, N-bromo- and N-iodosuccinimide, N-chloro-, N-bromo- and N-iodophthalimide, or N,N-dihalohydantoins, such as 1,3-dibromo-5,5-dimethylhydantoin, 1,3-dichloro-5,5-dimethylhydantoin, 1,3-diiodo-5,5-dimethylhydantoin or N-dihalosulfonamides such as, benzenesulfo-N-dibromamide, or N-halosulfonamide salts such as chloramine B or T. In the case of these halogenating agents, the additive use of Lewis acids, as listed above, for example, may likewise be advantageous.

Preferred halogenating agents N-halocarboxamides such as N-chloro-, N-bromo- and N-iodosuccinimide, N-chloro-, N-bromo- and N-iodophthalimide, or N,N-dihalohydantoins, such as 1,3-dibromo-5,5-dimethylhydantoin, 1,3-dichloro-5,5-dimethylhydantoin and 1,3-diiodo-5,5-dimethylhydantoin.

In the process according to the invention, a stoichiometric ratio or an excess of the halogenating agent based on the content of active halogen, to the ligands (III') is used, and can lead selectively to the ligands (III). Preferably a stoichiometric ratio up to a ratio of 2:1 of the halogenating agent based on the content of active halogen to the ligands (III') is used. More preferably a stoichiometric ratio is used.

Reaction media according to the invention are protic or aprotic, halogen-free or halogenated solvents, for example alcohols such as methanol, ethanol, propanol, butanol, polyhydric alcohols such as ethylene glycol, propyleneglycol, nitriles such as acetonitrile, propionitrile or benzonitrile, ethers such as diethyl ether THF or dioxane, aromatic hydrocarbons such as benzonitrile, nitrobenzene or chlorobenzene, N,N-dialkylamides such as dimethylformamide, methylacetamide or N-methylpyrroldinone, sulfoxides, such as dimethyl sulfoxide, sulfones such as dimethylsulfone or sulfolane, halogenated hydrocarbons such as dichloromethane, trichloromethanen, 1,1-dichloroethane, 1,2-dichloroethane, 1,1,2,2-tetrachloroethane. Preference is given to aromatic or chlorinated solvents.

According to the invention, the concentration of the metal carbene complex comprising at least one ligand of formula (III') is in the range from 0.0005 mol/l to 2 mol/l, more preferably in the range from 0.002 mol/l to 0.1 mol/l.

According to the invention, the metal carbene complex comprising at least one ligand of formula (III') may be dissolved or suspended in the reaction medium.

According to the invention, the reaction is carried out in the temperature range from -78°C to 150°C, preferably at from 0°C to 80°C, more preferably at from 0°C. to 40°C.

According to the invention, the reaction is carried out within from 1 h to 100 hours, preferably within from 3 h to 60 h.

Brominating in the 3 position of the cyclometallating N-aryl group of the imidazo-quinoxaline carbene ligand can be, for example, accomplished by reaction of the metal carbene complex comprising at least one ligand of formula (III') with *N*-bromosuccinimide in dichloromethane.

Iodinating in the 3 position of the cyclometallating N-aryl group of the imidazo-quinoxaline carbene ligand can be, for example, accomplished by reaction of the metal carbene complex comprising at least one ligand of formula (III') with *N*-iodosuccinimide in dichloromethane.

### (c) Preparation of imidazo-quinoxaline carbene ligands

The imidazo-quinoxalines which form the basis for the imidazo-quinoxaline carbene ligands in the metal carbene complexes of the present invention are commercially available or prepared by methods known in the art and for example described in Saravanakumar et al., Chem. Commun. 2006, 640-642; Al-Raqa et al., Heteroatom Chem. 17: 634-647, 2006; EI-Sharief et al., Heteroatom Chem. 16: 218-225, 2005; Phukan et al., J. Org. Chem. 2013, 78, 11032-11039; JP-A 2000-121807; and Semenov et al., Russian Journal of Organic Chemistry, 2010, Vol. 46, No. 3, pp. 439-443.

Exemplary examples for the preparation of inidazo-quinoxaline ligands are shown in the experimental part of the present application.

### Organic electronic devices

The inventive metal carbene complexes can be used in organic electronic devices. Suitable organic electronic devices are selected from organic light-emitting diodes (OLEDs), organic photovoltaic cells (OPVs), organic field-effect transistors (OFETs) and light-emitting electrochemical cells (LEECs), preference being given to OLEDs.

The inventive metal carbene complexes are generally notable for improved device performance such as high external quantum efficiency, high luminous efficacy and low voltage, green to yellow emission, decreased lifetime of the luminescence τ (higher radiation rate k_{rad}), reduced color-shift (e.g. CIE-y shift) with increasing doping concentration, or long device lifetime and/or excellent thermal stability. The inventive metal-carbene complexes are therefore suitable with particular preference as emitter material in OLEDs

The present invention therefore concerns an organic electronic device, comprising at least one metal carbene complex according to the present invention.

In a preferred embodiment, the organic electronic device is an OLED. The present application therefore further provides an OLED comprising at least one inventive metal carbene complex. The inventive metal carbene complex is used in the OLED preferably as an emitter, matrix material, charge transport material, especially hole transport material, and/or charge blocker, more preferably as an emitter and/or hole transport material, most preferably as emitter.

In a further embodiment, the inventive metal carbene complex is used in the OLED as an electron transport material or as an electron transport material and a hole transport material.

The present application also provides for the use of the inventive metal carbene complexes in OLEDs, preferably as emitter, matrix material, charge transport material, especially hole transport material, and/or charge blocker, more preferably as emitter and/or hole transport material, most preferably as emitter.

The at least one inventive metal carbene complex is more preferably present in the light-emitting layer of an OLED, most preferably as emitter. The present application therefore also provides for a light-emitting layer comprising at least one inventive metal carbene complex, preferably as emitter. More preferably, the light-emitting layer additionally comprises at least one host material. Most preferably, the light-emitting layer additionally comprises two host materials.

In a further embodiment, the present invention relates to a light-emitting layer consisting of at least one inventive metal carbene complex.

Organic light-emitting diodes are in principle formed from a plurality of layers, e.g.:
(a) an anode,
(b) optionally a hole injection layer,
(c) optionally a hole transport layer,
(d) optionally an electron / exciton blocking layer
(e) a light-emitting layer,
(f) optionally a hole / exciton blocking layer,
(g) optionally an electron transport layer,
(h) optionally an electron injection layer, and
(i) a cathode.

It is, however, also possible that the OLED does not comprise all of the layers mentioned; for example, an OLED comprising layers (a) (anode), (e) (light-emitting layer) and (i) (cathode) is likewise suitable, in which case the functions of layers (c) (hole-transport layer) and (g) (electron-transport layer) are assumed by the adjoining layers. OLEDs comprising layers (a), (c), (e), (g) and (i) or (a), (c), (e) and (i) or layers (a), (e), (g) and (i) or (a), (b), (c), (d), (e), (g), (h) and (i) or (a), (b), (c), (e), (g), (h) and (i) or (a), (b), (c), (d), (e), (g) and (i) are likewise suitable.

The individual layers among the aforementioned layers of the OLED may in turn be formed from two or more layers. For example, the hole-transport layer may be formed from one layer, into which holes are injected from the electrode, and a layer which transports the holes away from the hole-injecting layer into the light-emitting layer. The electron-transport layer may likewise consist of a plurality of layers, for example of a layer in which electrons are injected through the electrode and a layer which receives electrons from the electron-injecting layer and transports them into the light-emitting layer. These layers mentioned are each selected according to factors such as energy level, thermal resistance and charge carrier mobility, and also energy difference of the layers mentioned with the organic layers or the metal electrodes. The person skilled in the art is capable of selecting the construction of the OLEDs such that it is matched optimally to the inventive metal-carbene complexes, preferably used as emitter substances in accordance with the invention.

In order to obtain particularly efficient OLEDs, the HOMO (highest occupied molecular orbital) of the hole-transport layer should be aligned to the work function of the anode, and the LUMO (lowest unoccupied molecular orbital) of the electron-transport layer should be aligned to the work function of the cathode.

Suitable materials for the aforementioned layers (anode, cathode, hole and electron injection materials, hole and electron transport materials and hole and electron blocker materials, matrix materials, fluorescence and phosphorescence emitters) are known to those skilled in the art and are specified, for example, in H. Meng, N. Herron, Organic Small Molecule Materials for Organic Light-Emitting Devices in Organic Light-Emitting Materials and Devices, eds: Z. Li, H. Meng, Taylor & Francis, 2007, Chapter 3, pages 295 to 411 as well as in US2012/0104422, D.J. Gaspar, E Polikarpov, OLED Fundamentals: Materials, Devices, and Processing of Organic Light-Emitting Diodes, CRC Press, Taylor & Francis, 2015,and Z.R. Li, Organic Light-Emitting Materials and Devices, CRC Press, Taylor & Francis, 2015.

In addition, it is possible that some or all of the layers (b) to (h) have been surface-treated in order to increase the efficiency of charge carrier transport. The selection of the materials for each of the layers mentioned is preferably determined by obtaining an OLED having a high efficiency.

The inventive metal carbene complexes are preferably used as emitter molecules and/or matrix materials in the light-emitting layer (e). The inventive metal-carbene complexes may - in addition to use as emitter molecules and/or matrix materials in the light-emitting layer (e) or instead of use in the light-emitting layer - also be used as a charge transport material in the hole-transport layer (c) or in the electron-transport layer (g) and/or as a charge blocker, preference being given to use as a charge transport material in the hole-transport layer (c) (hole transport material).

In a further embodiment, the inventive metal carbene complex is used as an electron transport material, or as an electron transport material and a hole transport material.

### Light-emitting layer (e)

### Emitter

Suitable emitter materials for OLEDs are known by a person skilled in the art. The light-emitting layer preferably comprises at least one phosphorescent emitter. Phosphorescent emitter are preferred because of the higher luminescent efficiencies associated with such materials. The light-emitting layer preferably also comprises at least one host material. Preferably, the host material is capable of transporting electrons and/or holes, doped with an emitting material that may trap electrons, holes, and/or excitons, such that excitons relax from the emissive material via a photoemissive mechanism. In a preferred embodiment, the light emitting layer comprises the emitter and two host materials. In this case the two host materials both contribute to the transport of electrons and/or holes. By adjusting the mixing ratio of the two host materials, the optimal charge carrier balance and thus the optimal device performance in terms of voltage, lifetime, efficiency and/or color can be achieved.

It is an object of the present invention to provide organic electronic devices, preferably OLEDs, having - compared with the organic electronic devices known in the art - a high color purity in the green to yellow region of the visible electromagnetic spectrum, a high efficiency, low voltage and/or improved lifetime/stability.to provide organic electronic devices, preferably OLEDs, having - compared with the organic electronic devices known in the art - a high color purity in the green to yellow region of the visible electromagnetic spectrum, a high efficiency, low voltage and/or improved lifetime/stability.

The emitter in the OLED of the present invention is therefore preferably a phosphorescent emitter emitting light in the green to yellow region of the visible electromagnetic spectrum ("phosphorescent green emitter").

The term "phosphorescent green emitter" as used herein refers to a yellow or green phosphorescent emitter having an emission maximum (λₘₐₓ), which is located at 510 nm to 590 nm, preferably at 515 nm to 570 nm.

Suitable phosphorescent green emitters are known in the prior art, for example in Baldo et al., Applied Physics Letters, vol. 75, No. 1, 5 July 1999, 4-6, US 2011/0227049 A1, US 2014/0203268 A1, US 2013/0341609, US 2013/0181190, US 2013/0119354, WO 2012/053627 A1, and WO 2013/112557,

Preferably, the inventive metal carbene complexes are used as emitter. The light-emitting layer (e) may comprise one or more of the inventive metal-carbene complexes as emitter material. Suitable and preferred inventive metal carbene complexes are mentioned above. It is also possible that the light-emitting layer comprises in addition to at least one inventive metal carbene complex one or more further emitters.

The light-emitting layer preferably comprises beside at least one emitter material (suitable emitter materials are mentioned above), preferably at least one metal cabene complex according to the present invention, at least one host material.

Suitable host materials are known by a person skilled in the art. Preferred host materials are mentioned below.

### Host

For efficient light emission the triplet energy of the host material has to be about 0.2 eV larger than the triplet energy of the phosphorescent emitter (preferably the metal carbene complex according to the present invention) used. Hence, all host materials fulfilling this requirement are, in principle, suitable as host compound.

Suitable host materials for phosphorescent green to yellow emitters are, for example, described in EP2363398A1, WO2008/031743, WO2008/065975, WO2010/145991, WO2010/047707, US2009/0283757, US2009/0322217, US2010/0001638, WO2010/002850, US2010/0060154, US2010/0060155, US2010/0076201, US2010/0096981, US2010/0156957, US2011/186825, US2011/198574, US2011/0210316, US2011/215714, US2011/284835, and WO2012/045710. Further suitable host materials for phosphorescent green to yellow emitters are, for example, described in WO2012/004765 and US2011/0006670 (e.g. SH-2 Host), US2014/0001446 and WO2015/014791. The host material may be a compound having hole-transporting property and/or an organic compound having electron-transporting property. Preferably, the host material is an organic compound or organometallic compound having hole-transporting property. Alternatively the host compound may be a mixture of an organic compound or organometallic compound having hole-transporting property and an organic compound or organometallic compound having electron-transporting property. In principle, any organic compound or organometallic compound having hole-transporting property or having electron-transporting property and sufficient triplet energy can be used as host in the light-emitting layer. In a preferred embodiment, it is also possible to combine an organic compound or organometallic compound having both hole- and electron-transporting property and an organic compound or organometallic compound having either hole- or electron-transporting properties as hosts. Both materials can be processed from separate sources or as one pre-mixed host-compound.

Examples of organic compounds which can be used for the host material include a carbazole derivative such as 4, 4'-di(carbazolyl)biphenyl (abbreviation: CBP), 1,3-bis(carbazolyl)benzene (abbreviation: mCP) or 1,3,5-tris(N-carbazolyl)benzene (abbreviation: TCzB), = DNTPD.

Examples of organometallic compounds which can be used for the host material include iridium carbene complexes. Suitable iridium carbene complexes are, for example, iridium carbene complexes as described in WO2005/019373A2, WO2006/056418 A2, WO2007/115970, WO2007/115981, WO2008/000727, WO2012/121936A2, US2012/0305894A1, and WO2012/172482A1. Examples of suitable iridium carbene complexes are Ir(DPBIC)₃ with the formula: 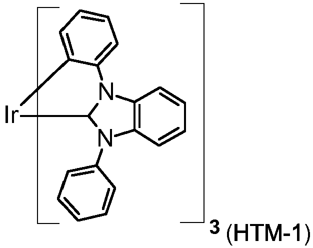 and Ir(ABIC)₃ with the Ia:

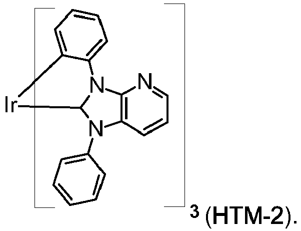

Further suitable host materials are the compounds described in WO2010/079051 (in particular pages on 19 to 26 and in the tables on pages 27 to 34, pages 35 to 37 and pages 42 to 43).

Also preferred as host compounds in the OLED and in the light-emitting layer of the present invention are the compounds mentioned in WO2012/130709; WO2013/050401; WO2014/009317; WO2014/044722; and the non-published European Patent Application EP13191100.0.

Further preferred host materials are binary host systems as described in WO2011/136755; the hosts described in WO2013/022419 and WO2013/112557; triphenylene derivatives for example as described in WO2010/028151, WO2010/002850, WO2010/0056669, US2010/0244004, US2011/0177641, US2011/022749, WO2011/109042, and WO2011/137157; azaborinine compounds for example as described in WO2011/143563; bicarbazole compounds for example as described in WO2012/023947; carbazolephenyl-pyridine, -pyrimidine and -triazine compounds for example as described in WO2012/108879; biscarbazolephenyl-pyridine, -pyrimidine and - triazine compounds for example as described in WO2012/108881; dibenzoquinoxaline compounds for example as described in US2011/0210316; triazole derivatives for example as described in US2011/0285276 and US2012/0025697; benzimidazole derivatives for example as described in US2011/0147792; heterocyclic compounds for example as described in US2012/0061651; phenanthrene derivatives for example as described in US2012/0104369; benzoxazole derivatives for example as described in US2012/0132896; oxazole derivatives for example as described in US2012/0130081; and carbazole-benzimidazole derivatives for example as described in US2012/0133274.

Further preferred host materials are described in US2011/0006670 (the SH-2 host is for example mentioned therein).

Especially suitable host materials are for example host materials described in WO2013/112557 having the following general formula: 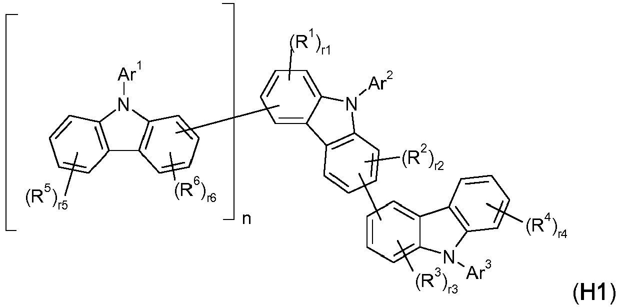 wherein R¹, R², R³, R⁴, R⁵, and R⁶ may be the same or different fluorine atom, chlorine atom, a deuterium atom, a cyano group, a trifluoromethyl group, a nitro group, linear or branched C₁-C₆alkyl group, C₅-C₁₀cyclo-alkyl group, linear or branched C₁-C₆alkoxy group, C₅-C₁₀cyclo-alkoxy group, substituted or unsubstituted aromatic hydrocarbon group, substituted or unsubstituted aromatic heterocyclic group, substituted or unsubstituted condensed polycyclic aromatic group,
r1, r4, r5 is 0, 1, 2, 3, or 4,
r2, r3, r6 is 0, 1, 2 or 3,
n is 0 or 1, and
Ar1, Ar², and Ar³ may be the same or different, substituted or unsubstituted aromatic hydrocarbon group, substituted or unsubstituted aromatic heterocyclic group, substituted or unsubstituted condensed polycyclic aromatic group, deuterium substituted aromatic hydrocarbon group, deuterium substituted aromatic heterocyclic group, or deuterium substituted condensed polycyclic aromatic group.

When Ar¹, Ar2, or Ar³ is a substituted aromatic hydrocarbon group, a substituted aromatic heterocyclic group, or a substituted polycyclic aromatic group, the substitution groups can be any non-carbon or carbon- containing functional group, such as, an aromatic hydrocarbon group, an aromatic heterocyclic group or a polycyclic aromatic group. For example, the substitution group on the aromatic ring structure of Ar¹, A², or Ar³ can be 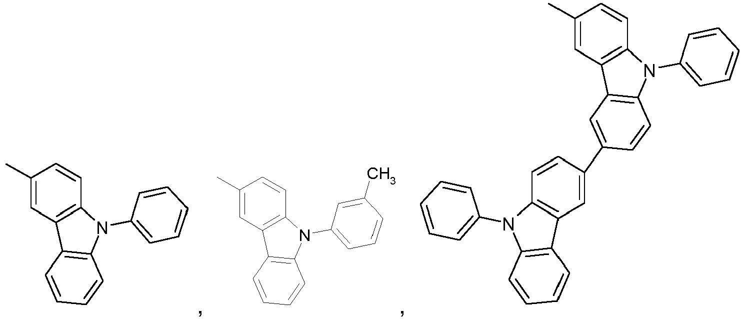 or the like.

Especially suitable are the compounds (H1-1), (H1-2), (H1-7) as mentioned below and the compounds (H1-3), (H1-4), (H1-5), (H1-6), (H1-8), (H1-9), (H1-10), (H1-11), (H1-12), (H1-13), (H1-14), (H1-14), (H-16) and (H1-17) as described in WO 2013/112557.

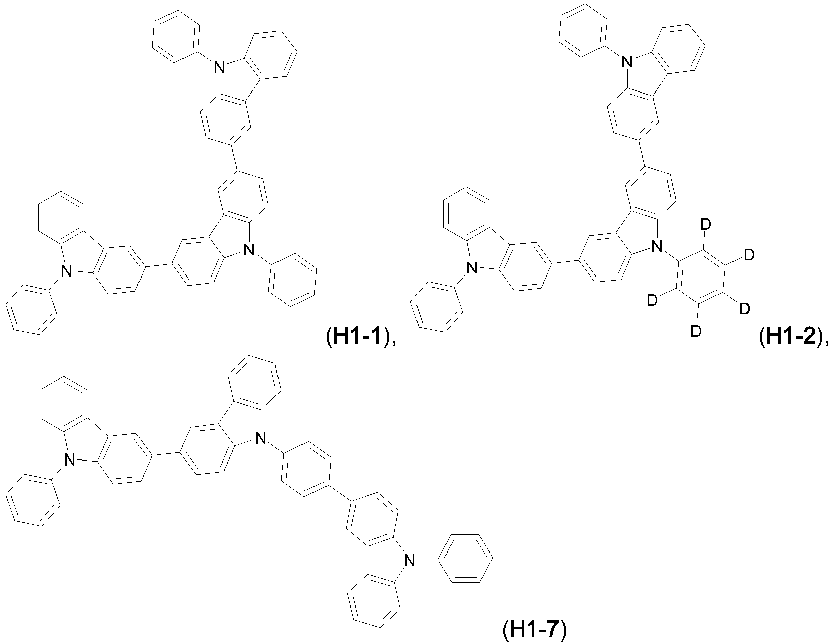

Further suitable host materials - which may be employed together with the host material mentioned before - are host materials containing at least one of the following groups in the molecule: 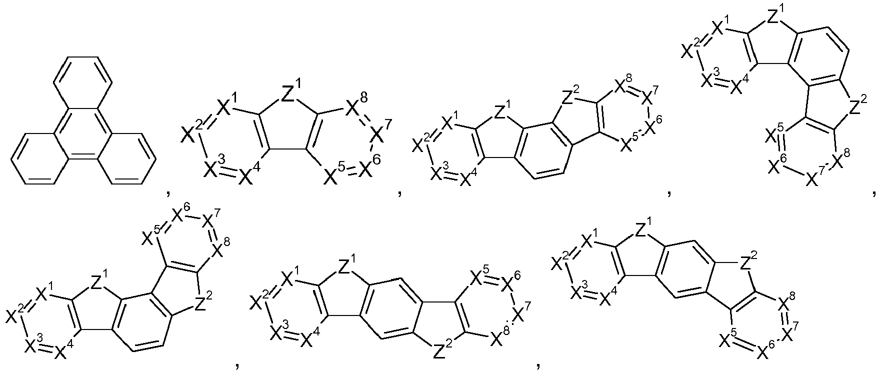 wherein X¹ to X⁸ is selected from C or N; and wherein Z¹ and Z² is S or O.

The groups mentioned above may be unsubstituted or substituted by an unfused substituent independently selected from the group consisting of CₙH₂ₙ₊₁, OCₙH₂ₙ₊₁, OAr₁, N(CₙH₂ₙ₊₁)₂, N(Ar₁)(Ar₂), CH=CH- CₙH₂ₙ₊₁, C=CHCₙH₂ₙ₊₁, A₁ , Ar₁-Ar₂, CₙH_{2n-Ar1}, wherein n is 1, 2, 3, 4, 5, 6, 7, 8, 9, or 10, and wherein Ar₁ and Ar₂ are independently selected from the group consisting of benzene, biphenyl, naphthalene, triphenylene, carbazole, and heteroaromatic analogs thereof.

Further suitable host compounds are compounds comprising a triphenylene containing benzo-fused thiophene. A combination of benzo-fused thiophenes and triphenylene as hosts in OLEDs may be beneficial. Therefore combining these two moieties in one molecule may offer improved charge balance which may improve device performance in terms of lifetime, efficiency and low voltage. Different chemical linkage of the two moieties can be used to tune the properties of the resulting compound to make it the most appropriate for a particular phosphorescent emitter, device architecture, and/or fabrication process. For example, m-phenylene linkage is expected to result in higher triplet energy and higher solubility whereas p-phenylene linkage is expected to result in lower triplet energy and lower solubility.

Similar to the characterization of benzo-fused thiophenes, benzo-fused furans are also suitable host materials. Examples of benzo-fused furans include benzofuran and dibenzofuran. Therefore, a material containing both triphenylene and benzofuran may be advantageously used as host material in OLEDs. A compound containing both of these two groups may offer improved electron stabilization which may improve device stability and efficiency with low voltage. The properties of the triphenylene containing benzofuran compounds may be tuned as necessary by using different chemical linkages to link the triphenylene and the benzofuran.

Benzo-fused furans are benzofurans and dibenzofurans. Benzo-fused thiophenes are benzothiophenes and dibenzothiophenes.

The benzo-fused thiophene and benzo-fused furans mentioned above may be unsubstituted or substituted for example by one or more unfused substituents independently selected from the group consisting of CₙH₂ₙ₊₁, OCₙH₂ₙ₊₁, OAr₁, N(CₙH₂ₙ₊₁)₂, N(Ar₁)(Ar₂), CH=CH- CₙH₂ₙ₊₁, C=CHCₙH₂ₙ₊₁, A₁, Ar₁-Ar₂, CₙH_{2n-Ar1}, wherein n is 1, 2, 3, 4, 5, 6, 7, 8, 9, or 10, and wherein Ar₁ and Ar₂ are independently selected from the group consisting of benzene, biphenyl, naphthalene, triphenylene, carbazole, and heteroaromatic analogs thereof.

The substituents of the compounds described above are unfused such that the substituents are not fused to the triphenylene, benzo-fused furan or benzo-fused thiophene moieties of the compound. The substituents may optionally be inter-fused (i.e. fused to each other).

The benzo-fused thiophene and benzo-fused furans mentioned above are for example described in WO2013/112557 and in WO2009/021126.

Further suitable host materials for phosphorescent green emitters are mentioned in US2013/0181190, especially in table 3, and US2013/0119354, especially in table 4.

Specific examples of organic compounds which can be used for the host material include a compounds such as 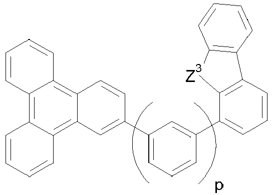 wherein Z³ is O or S and p is 0 or 1, such as 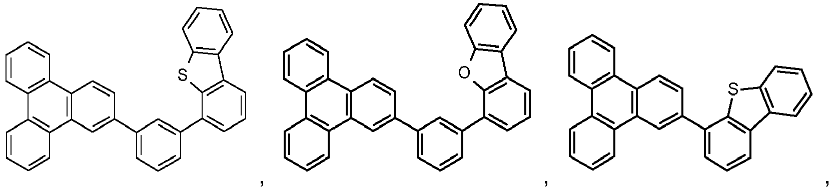 or

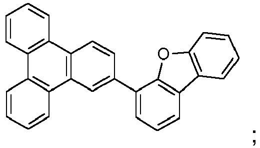

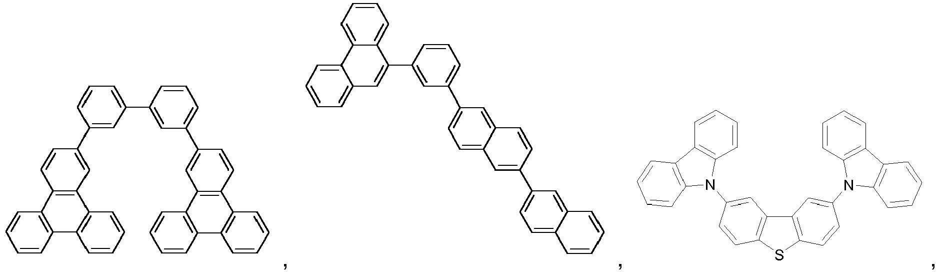

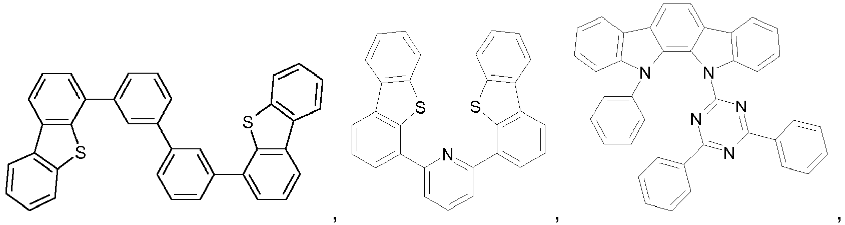

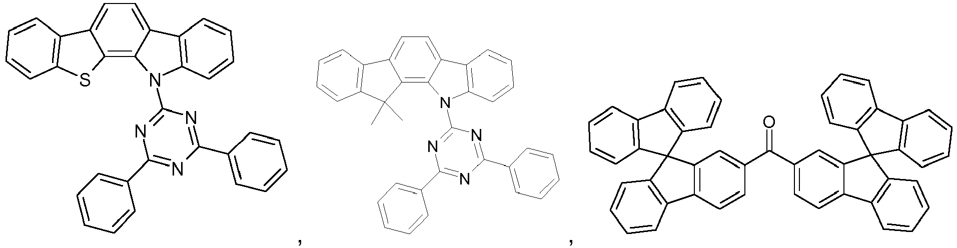

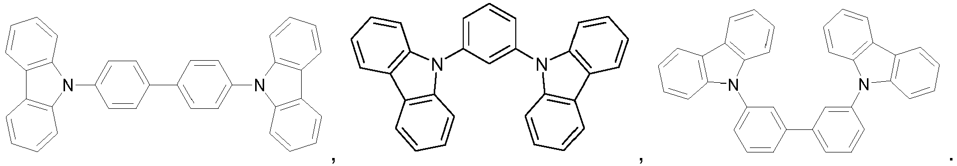

Further specific examples of organic compounds which can be used for the host material include the following compounds 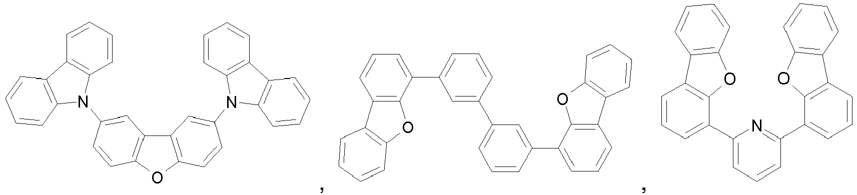 and

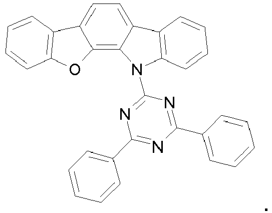

The host compound can be one compound or it can be a mixture of two or more compounds. Suitable mixtures are for example the binary hosts systems as described in WO2011/136755 and WO2013/112557.

A further suitable host material for the emitters of the present invention is mentioned in US2012/0235123 and US2011/0279020. A typical and preferred host material described in the documents mentioned before is

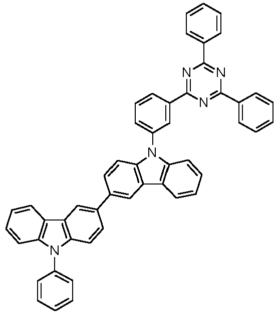

Additionally, as mentioned before, co-host systems are suitable as host material for the emitters of the present invention. A suitable co-host system is exemplified below. It is clear for a person skilled in the art that also similar co-host systems are suitable. 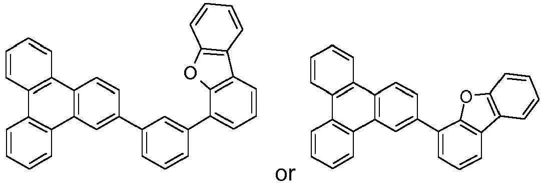 combined with

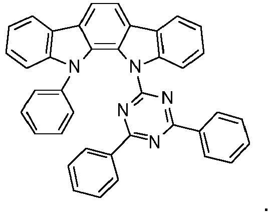

In a preferred embodiment, the light-emitting layer (e) comprises the emitter in an amount of 2 to 40% by weight, preferably 5 to 35% by weight, more preferably 5 to 20 % by weight and the host compound in an amount of 60 to 98% by weight, preferably 65 to 95% by weight, more preferably 80 to 95 % by weight, where the amount of the phosphorescent emitter and the host compound adds up to a total of 100% by weight. The emitter may be one emitter or a combination of two ore more emitters. The host may be one host or a combination of two or more hosts. In a preferred embodiment, in case of the use of two host compounds they are mixed in a ratio of 1:1 to 1:30, more preferably 1:1 to 1:7, most preferably 1:1 to 1:3.

### Anode (a)

The anode is an electrode which provides positive charge carriers. It may be composed, for example, of materials which comprise a metal, a mixture of different metals, a metal alloy, a metal oxide or a mixture of different metal oxides. Alternatively, the anode may be a conductive polymer. Suitable metals comprise the metals of groups 11, 4, 5 and 6 of the Periodic Table of the Elements, and also the transition metals of groups 8 to 10. When the anode is to be transparent, mixed metal oxides of groups 12, 13 and 14 of the Periodic Table of the Elements are generally used, for example indium tin oxide (ITO). It is likewise possible that the anode (a) comprises an organic material, for example polyaniline, as described, for example, in Nature, Vol. 357, pages 477 to 479 (June 11, 1992). Preferred anode materials include conductive metal oxides, such as indium tin oxide (ITO) and indium zinc oxide (IZO), aluminum zinc oxide (AlZnO), and metals. Anode (and substrate) may be sufficiently transparent to create a bottom-emitting device. A preferred transparent substrate and anode combination is commercially available ITO (anode) deposited on glass or plastic (substrate). A reflective anode may be preferred for some top-emitting devices, to increase the amount of light emitted from the top of the device. At least either the anode or the cathode should be at least partly transparent in order to be able to emit the light formed. Other anode materials and structures may be used.

### Hole injection layer (b)

Generally, injection layers are comprised of a material that may improve the injection of charge carriers from one layer, such as an electrode or a charge generating layer, into an adjacent organic layer. Injection layers may also perform a charge transport function. The hole injection layer may be any layer that improves the injection of holes from anode into an adjacent organic layer. A hole injection layer may comprise a solution deposited material, such as a spin-coated polymer, or it may be a vapor deposited small molecule material, such as, for example, CuPc or MTDATA. Polymeric hole-injection materials can be used such as poly(N-vinylcarbazole) (PVK), polythiophenes, polypyrrole, polyaniline, self-doping polymers, such as, for example, sulfonated poly(thiophene-3-[2[(2-methoxyethoxy)ethoxy]-2,5-diyl) (Plexcore® OC Conducting Inks commercially available from Plextronics), and copolymers such as poly(3,4-ethylenedioxythiophene)/poly(4-styrenesulfonate) also called PEDOT/PSS. Further suitable hole injection materials are mentioned in US2013/0181190, especially in table 3, and US2013/0119354, especially in table 4.

It is possible to use as hole injection materials p-doped layers. Suitable p-dopants are mentioned below concerning the hole transport layer. Examples for suitable p-dopants are MoO₃, F4-TCNQ or NDP-9. It is further possible to use layers of p-dopants itself. Suitable p-dopants are mentioned below concerning the hole transport layer. Examples for suitable p-dopants are MoO₃, F4-TCNQ or NDP-9.

Further suitable hole injection materials are described in US2006/0188745, US2006/0240280 and US2007/0092755, whereby the following material is an example for a preferred hole injection material:

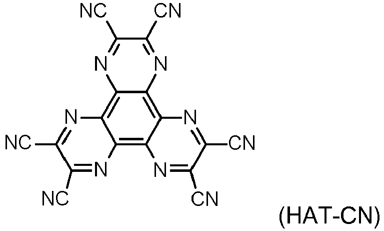

Further suitable hole injection materials are described in US2010/0219400, US2015/0073142 and US2015/0102331, whereby the following material is an example for a preferred hole injection material: 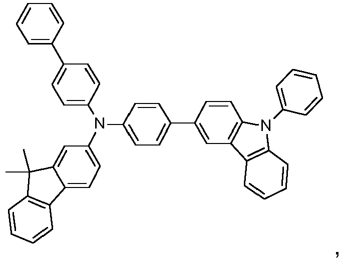 preferably doped with MoO₃, F4-TCNQ or NDP-9, more preferably doped with NDP-9.

The dopant NDP-9 is commercially available and for example described in EP 2 180 029. Further suitable hole injection materials are the following materials:

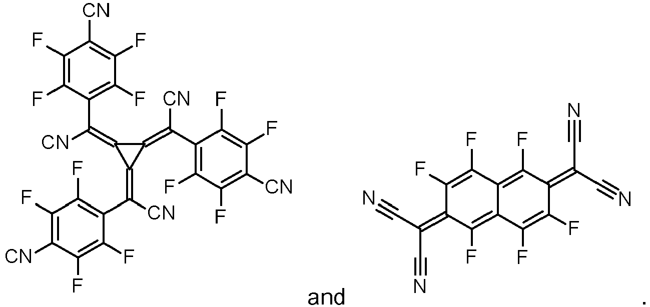

Further compounds suitable as hole injection material are for example mentioned in US2010/0044689 and US2014/0217392, e.g. the following compound 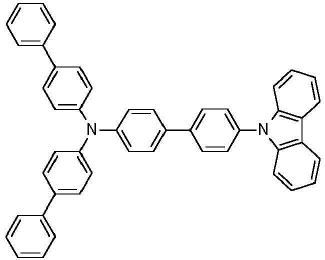 doped with a p-dopant. Suitable p-dopants are mentioned below concerning the hole transport layer. Examples for suitable p-dopants are MoO₃, F4-TCNQ or NDP-9.

Further compounds suitable as hole injection material are for example mentioned in US2010/0219400, US2015/0073142 and US2015/0102331, e.g. the following compound 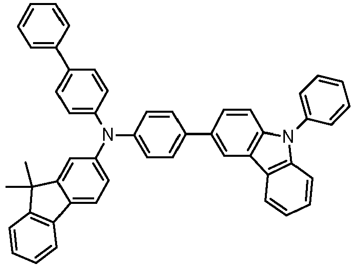 doped with a p-dopant. Suitable p-dopants are mentioned below concerning the hole transport layer. Examples for suitable p-dopants are MoO₃, F4-TCNQ or NDP-9.

Further compounds suitable as hole injection material are for example mentioned in US2008/0014464, e.g. the following compound 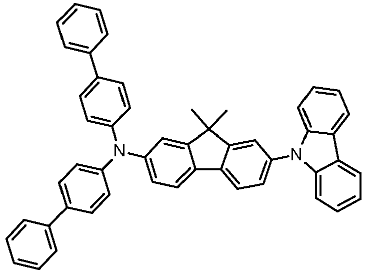 doped with a p-dopant. Suitable p-dopants are mentioned below concerning the hole transport layer. Examples for suitable p-dopants are MoO₃, F4-TCNQ or NDP-9 (*N,N'*-Di(1-naphthyl)-*N,N'*-diphenyl-(1,1'-biphenyl)-4,4'-diamine). F4-TCNQ:

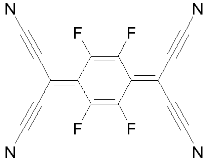

In addition to the hole injection materials mentioned above, the materials mentioned as hole transport materials in the hole transport layer are also useful as hole injection materials, especially in combination with a p-dopant, for example in combination with MoO₃, F4-TCNQ or NDP-9. Further suitable p-dopants are mentioned below (see hole transport layer (c)).

### Hole transport layer (c)

Either hole-transporting molecules or polymers may be used as the hole transport material. Suitable hole transport materials for layer (c) of the inventive OLED are disclosed, for example, in Kirk-Othmer Encyclopedia of Chemical Technology, 4th Edition, Vol. 18, pages 837 to 860, 1996, US20070278938, US2008/0106190, US2011/0163302 (triarylamines with (di)benzothiophen/(di)benzofuran; Nan-Xing Hu et al. Synth. Met. 111 (2000) 421 (indolocarbazoles), WO2010/002850 (substituted phenylamine compounds), WO2012/16601 (in particular the hole transport materials mentioned on pages 16 and 17 of WO2012/16601), US2013/0181190, especially in table 3, and US2013/0119354, especially in table 4. Further suitable hole transport materials are mentioned in US20120223296. Combination of different hole transport material may be used. Reference is made, for example, to wherein 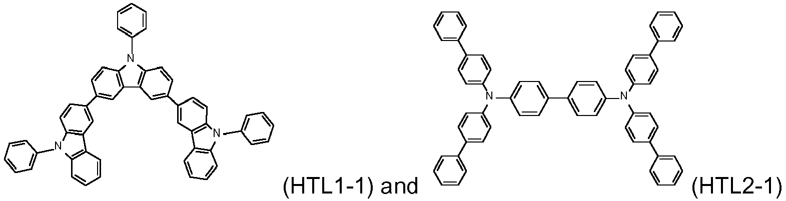 constitute the hole transport layer.

Customarily used hole-transporting molecules are selected from the group consisting of 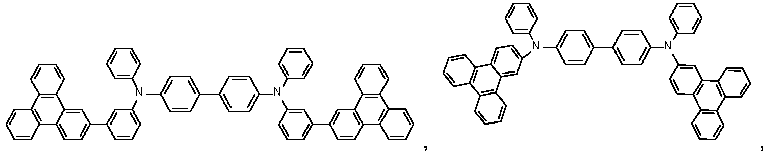 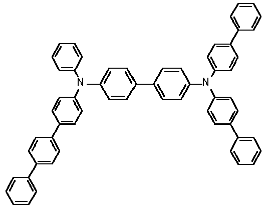 (4-phenyl-N-(4-phenylphenyl)-N-[4-[4-(N-[4-(4-phenyl-phenyl)phenyl]anilino)phenyl]phenyl]aniline), 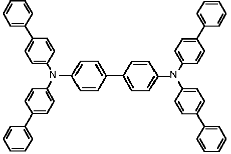 (4-phenyl-N-(4-phenylphenyl)-N-[4-[4-(4-phenyl-N-(4-phenylphenyl)anilino)phenyl]phenyl]aniline), 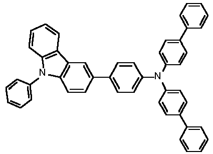 (4-phenyl-N-[4-(9-phenylcarbazol-3-yl)phenyl]-N-(4-phenylphenyl)aniline), 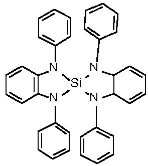 (1,1',3,3'-tetraphenylspiro[1,3,2-benzodiazasilole-2,2'-3a,7a-dihydro-1,3,2-benzodiazasilole]), 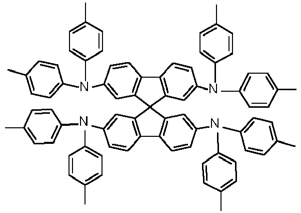 (N2,N2,N2',N2',N7,N7,N7',N7'-octakis(p-tolyl)-9,9'-spirobi[fluorene]-2,2',7,7'-tetramine),4,4'-bis[N-(1-naphthyl)-N-phenylamino]biphenyl (α-NPD), N,N-diphenyl-N,N-bis(3-methylphenyl)-[1,1-biphenyl]-4,4-diamine (TPD), 1,1-bis[(di-4-tolylamino)phenyl]cyclohexane (TAPC), N,N'-bis(4-methylphenyl)-N,N'-bis(4-ethylphenyl)-[1,1'-(3,3'-dimethyl)biphenyl]-4,4'-diamine (ETPD), tetrakis(3-methylphenyl)-N,N,N',N'-2,5-phenylenediamine (PDA), α-phenyl-4-N,N-diphenylaminostyrene (TPS), p-(diethylamino)benzaldehyde diphenylhydrazone (DEH), triphenylamine (TPA), bis[4-(N,N-diethylamino)2-methylphenyl](4-methylphenyl)methane (MPMP), 1-phenyl-3-[p-(diethylamino)styryl]5-[p-(diethylamino)phenyl]pyrazoline (PPR or DEASP), 1,2-trans-bis(9H-carbazol9-yl)-cyclobutane (DCZB), N,N,N',N'-tetrakis(4-methylphenyl)-(1,1'-biphenyl)-4,4'-diamine (TTB), fluorine compounds such as 2,2',7,7'-tetra(N,N-di-tolyl)amino9,9-spirobifluorene (spiro-TTB), N,N'-bis(naphthalen-1-yl)-N,N'-bis(phenyl)9,9-spirobifluorene (spiro-NPB) and 9,9-bis(4-(N,N-bis-biphenyl-4-yl-amino)phenyl-9Hfluorene, benzidine compounds such as N,N'-bis(naphthalen-1-yl)-N,N'-bis(phenyl)benzidine and porphyrin compounds such as copper phthalocyanines. In addition, polymeric hole-injection materials can be used such as poly(N-vinylcarbazole) (PVK), polythiophenes, polypyrrole, polyaniline, self-doping polymers, such as, for example, sulfonated poly(thiophene-3-[2[(2-methoxyethoxy)ethoxy]-2,5-diyl) (Plexcore® OC Conducting Inks commercially available from Plextronics), and copolymers such as poly(3,4-ethylenedioxythiophene)/poly(4-styrenesulfonate) also called PEDOT/PSS.

In a preferred embodiment it is possible to use metal carbene complexes as hole transport materials. Suitable carbene complexes are, for example, carbene complexes as described in WO2005/019373A2, WO2006/056418 A2, WO2007/115970, WO2007/115981, WO2008/000727, WO2012/121936A2, US2012/0305894A1, and WO2012/172482A1. One example of a suitable carbene complex is Ir(DPBIC)₃ (**HTM-1**). Another example of a suitable carbene complex is Ir(ABIC)₃ (**HTM-2**). The formulae of (**HTM-1**) and (**HTM-2**) are mentioned above.

Further compounds suitable as hole transport material are for example mentioned in US2010/0044689 and US2014/0217392, e.g. the following compound 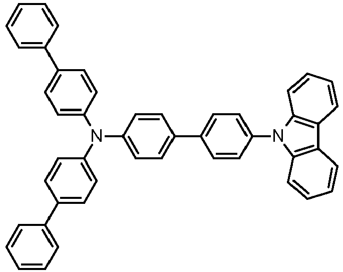 The compounds are employed in the hole transport layer in doped or undoped form. Suitable dopants are mentioned below.

Further compounds suitable as hole transport material are for example mentioned in US2010/0219400, US2015/0073142 and US2015/0102331, e.g. the following compound 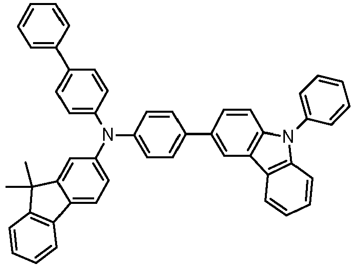 The compounds are employed in the hole transport layer in doped or undoped form. Suitable dopants are mentioned below.

Further compounds suitable as hole transport material are for example mentioned in US2008/0014464, e.g. the following compound 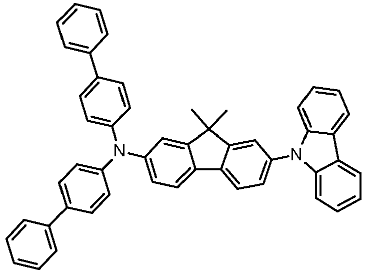 The compounds are employed in the hole transport layer in doped or undoped form. Suitable dopants are mentioned below.

Further compounds suitable as hole transport material are for example mentioned in WO2013/112557, e.g. the following compounds 1a to 12a mentioned in WO2013/112557:

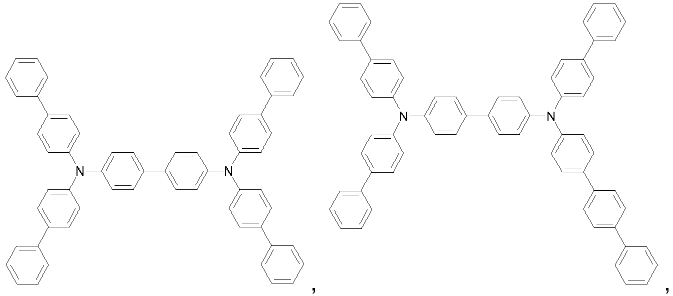

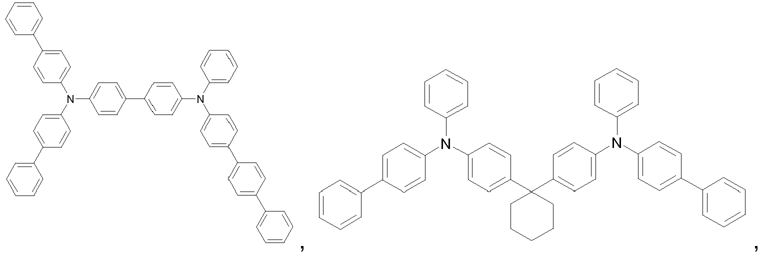

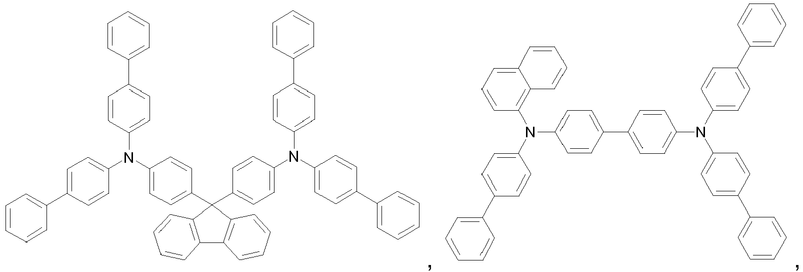

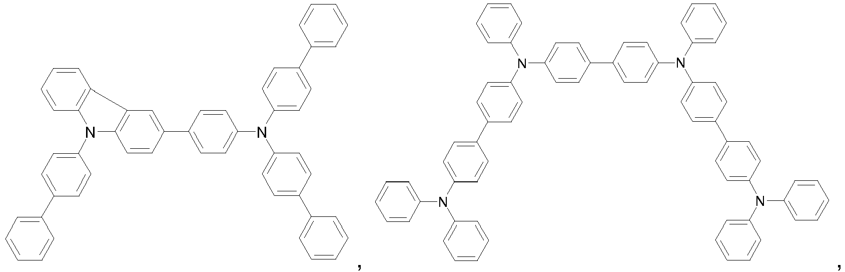

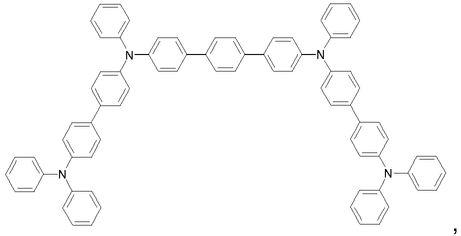

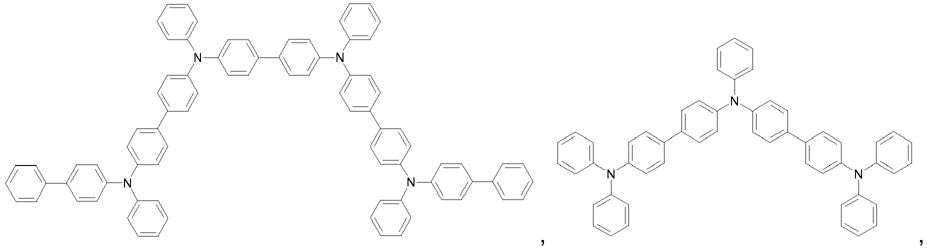

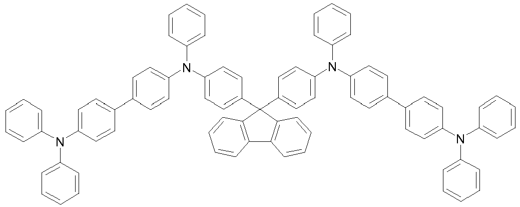

The hole-transporting layer may also be electronically doped in order to improve the transport properties of the materials used, in order firstly to make the layer thicknesses more generous (avoidance of pinholes/short circuits) and in order secondly to minimize the operating voltage of the device. Electronic doping is known to those skilled in the art and is disclosed, for example, in W. Gao, A. Kahn, J. Appl. Phys., Vol. 94, 2003, 359 (p-doped organic layers); A. G. Werner, F. Li, K. Harada, M. Pfeiffer, T. Fritz, K. Leo, Appl. Phys. Lett., Vol. 82, No. 25, 2003, 4495 and Pfeiffer et al., Organic Electronics 2003, 4, 89 - 103 and K. Walzer, B. Maennig, M. Pfeiffer, K. Leo, Chem. Soc. Rev. 2007, 107, 1233. For example it is possible to use mixtures in the hole-transporting layer, in particular mixtures which lead to electrical p-doping of the hole-transporting layer. p-Doping is achieved by the addition of oxidizing materials. These mixtures may, for example, be the following mixtures: mixtures of the abovementioned hole transport materials with at least one metal oxide, for example MoO₂, MoO₃, WOₓ, ReO₃ and/or V₂O₅, preferably MoO₃ and/or ReO₃, more preferably MoO₃, or mixtures comprising the aforementioned hole transport materials and one or more compounds selected from 7,7,8,8-tetracyanoquinodimethane (TCNQ), 2,3,5,6-tetrafluoro-7,7,8,8-tetracyanoquinodimethane (F₄-TCNQ), 2,5-bis(2-hydroxyethoxy)-7,7,8,8-tetracyanoquinodimethane, bis(tetra-n-butylammonium)tetracyanodiphenoquinodimethane, 2,5-dimethyl-7,7,8,8-tetracyanoquinodimethane, tetracyanoethylene, 11,11,12,12-tetracyanonaphtho2,6-quinodimethane, 2-fluoro-7,7,8,8-tetracyanoquino-dimethane, 2,5-difluoro-7,7,8,8etracyanoquinodimethane, dicyanomethylene-1,3,4,5,7,8-hexafluoro-6Hnaphthalen-2-ylidene)malononitrile (F₆-TNAP), Mo(tfd)₃ (from Kahn et al., J. Am. Chem. Soc. 2009, 131 (35), 12530-12531), compounds as described in EP1988587, US2008/265216, EP2180029, US2010/0102709, WO2010/132236, EP2180029 and quinone compounds as mentioned in EP2401254; as well as compounds as described in EP1713136 and WO2007/071450 and US2008/0265216.

Further materials useful in the hole transport layer are the following materials: 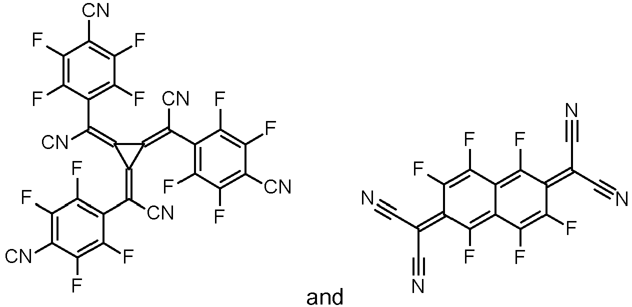 as well as NHT-49, NHT-51 (NHT-49, NHT-51 are commercially available from Novaled).

In addition to the hole transport materials mentioned above, the materials mentioned as hole injection materials in the hole injection layer are also useful as hole transport materials. Said materials may be used in undoped form or in combination with a p-dopant, for example in combination with MoO₃, F4-TCNQ or NDP-9, in the hole transport layer.

### Electron / Exciton blocking layer (d)

Blocking layers may be used to reduce the number of charge carriers (electrons or holes) and/or excitons that leave the emissive layer. An electron/exciton blocking layer (d) may be disposed between the emitting layer (e) and the hole transport layer (c), to block electrons from emitting layer (e) in the direction of hole transport layer (c). Blocking layers may also be used to block excitons from diffusing out of the emissive layer. Suitable metal complexes for use as electron/exciton blocker material are, for example, carbene complexes as described in WO2005/019373A2, WO2006/056418A2, WO2007/115970, WO2007/115981, WO2008/000727, WO2012/121936A2, US2012/0305894A1, and WO2012/172482A1. Explicit reference is made here to the disclosure of the WO applications cited, and these disclosures shall be considered to be incorporated into the content of the present application. One example of a suitable carbene complex is compound **HTM-1.** Another example of a suitable carbene complex is compound **HTM-2.** The formulae of (**HTM-1**) and (**HTM-2**) are mentioned above.

Also suitable as electron/exciton blocker materials are the compounds mentioned in WO2012/130709; WO2013/050401; WO2014/009317; WO2014/044722; and the non-published European Patent Application EP13191100.0.

Further suitable electron/exciton blocker materials are the compounds of formula (**H1**) mentioned in WO2013/112557, as described above.

Further suitable electron/exciton blocker materials are the compounds mentioned in US2012/0223296.

Especially suitable are the compounds (H1-1), (H1-2), (H1-7) as mentioned above and the compounds (H1-3), (H1-4), (H1-5), (H1-6), (H1-8), (H1-9), (H1-10), (H1-11), (H1-12), (H1-13), (H1-14), (H1-14), (H-16) and (H1-17) as described in WO 2013/112557.

(Further suitable electron/exciton blocker materials are: NHT-49, NHT-51 (which are commercially available from Novaled) and HTM-211,

Further compounds suitable as electron/exciton blocker materials are for example mentioned in US2010/0044689 and US2014/0217392, e.g. the following compound

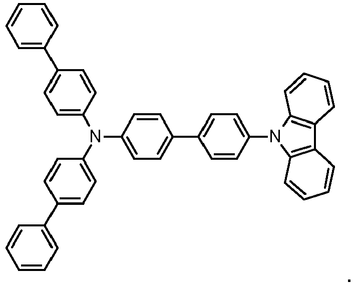

Further compounds suitable as electron/exciton blocker materials are for example mentioned in US2010/0219400, US2015/0073142 and US2015/0102331, e.g. the following compound

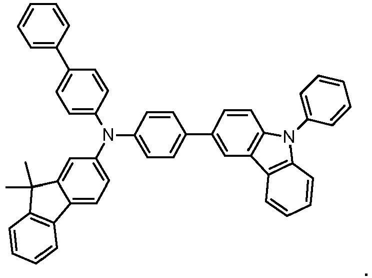

Further compounds suitable as electron/exciton blocker materials are for example mentioned in US2008/0014464, e.g. the following compound

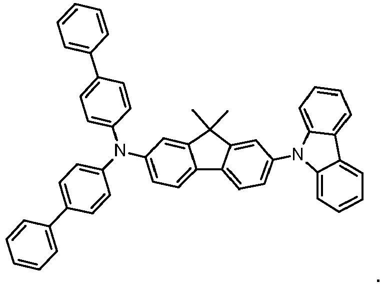

### Hole / exciton blocking layer (f)

Blocking layers may be used to reduce the number of charge carriers (electrons or holes) and/or excitons that leave the emissive layer. The hole blocking layer may be disposed between the emitting layer (e) and electron transport layer (g), to block holes from leaving layer (e) in the direction of electron transport layer (g). Blocking layers may also be used to block excitons from diffusing out of the emissive layer. Suitable hole/exciton blocking materials are, in principle, the host compounds mentioned above. The same preferences apply as for the host material.

Suitable hole/exciton blocker materials are therefore for example the materials containing both triphenylene and benzo-fused furans or benzo-fused thiophenes as mentioned above concerning suitable host materials.

Further hole/exciton blocking materials are one or more compounds of the general formula (**X**) 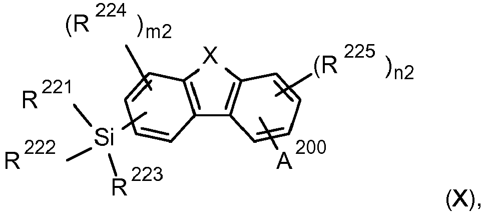 wherein
X is NR, S, O or PR;
R is aryl, heteroaryl, alkyl, cycloalkyl, or heterocycloalkyl;
A²⁰⁰ is -NR²⁰⁶R²⁰⁷, -P(O)R²⁰⁸R²⁰⁹, -PR²¹⁰R²¹¹, -S(O)₂R²¹², -S(O)R²¹³, -SR²¹⁴, or -OR²¹⁵;
R²²¹, R²²² and R²²³ are independently of each other aryl, heteroaryl, alkyl, cycloalkyl, or heterocycloalkyl, wherein at least on of the groups R²²¹, R²²², or R²²³ is aryl, or heteroaryl;
R²²⁴ and R²²⁵ are independently of each other alkyl, cycloalkyl, heterocycloalkyl, aryl, heteroaryl, a group A²⁰⁰, or a group having donor, or acceptor characteristics;
n2 and m2 are independently of each other 0, 1, 2, or 3;
R²⁰⁶ and R²⁰⁷ form together with the nitrogen atom a cyclic residue having 3 to 10 ring atoms, which can be unsubstituted, or which can be substituted with one, or more substituents selected from alkyl, cycloalkyl, heterocycloalkyl, aryl, heteroaryl and a group having donor, or acceptor characteristics; and/or which can be annulated with one, or more further cyclic residues having 3 to 10 ring atoms, wherein the annulated residues can be unsubstituted, or can be substituted with one, or more substituents selected from alkyl, cycloalkyl, heterocycloalkyl, aryl, heteroaryl and a group having donor, or acceptor characteristics; and
R²⁰⁸, R²⁰⁹ R²¹⁰, R²¹¹, R²¹², R²¹³, R²¹⁴ und R²¹⁵ are independently of each other aryl, heteroaryl, alkyl, cycloalkyl, or heterocycloalkyl.

Compounds of formula (**X**) are described in WO2010/079051 (in particular pages on 19 to 26 and in tables on pages 27 to 34, pages 35 to 37 and pages 42 to 43).

Further suitable hole/exciton blocker materials are mentioned in US2013/0181190, especially in table 3, and US 2013/0119354, especially in table 4. Further suitable hole/exciton blocker materials are mentioned in US2014/0001446 and WO2015/014791.

Examples are bathocuprine compounds such as: 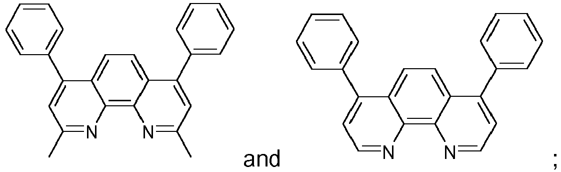 metal-8-hydroxy-quinolates such as: 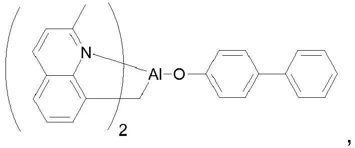 triazoles, oxadiazoles, imidazoles, benzoimidazoles, triphenylene compounds, fluorinated aromatic compounds, phenothiazine-S-oxides, silylated five-membered nitrogen, oxygen, sulfur or phosphorous dibenzoheterocycles, or Aza-carbazoles.

### Electron transport layer (g)

Electron transport layer may include a material capable of transporting electrons. Electron transport layer may be intrinsic (undoped), or doped. Doping may be used to enhance conductivity. Suitable electron-transporting materials for layer (g) of the inventive OLEDs comprise metals chelated with oxinoid compounds, such as tris(8-hydroxyquinolato)aluminum (Alq₃), compounds based on phenanthroline such as 2,9-dimethyl-4,7-diphenyl-1,10-phenanthroline (DDPA = BCP), 4,7-diphenyl-1,10-phenanthroline (Bphen), 2,4,7,9-tetraphenyl-1,10-phenanthroline, 4,7-diphenyl-1,10-phenanthroline (DPA) or phenanthroline derivatives disclosed in EP1786050, in EP1970371, or in EP1097981, and azole compounds such as 2-(4-biphenylyl)-5-(4-t-butylphenyl)-1,3,4-oxadiazole (PBD) and 3-(4-biphenylyl)-4phenyl-5-(4-t-butylphenyl)-1,2,4-triazole (TAZ).

It is likewise possible to use mixtures of at least two materials in the electron-transporting layer, in which case at least one material is electron-conducting. Preferably, in such mixed electron-transporting layers, at least one phenanthroline compound is used, preferably BCP, or at least one pyridine compound according to the formula (**VIII**) below, preferably a compound of the formula (**VIIIaa**) below. More preferably, in mixed electron-transporting layers, in addition to at least one phenanthroline compound, alkaline earth metal or alkali metal hydroxyquinolate complexes, for example Liq, are used. Suitable alkaline earth metal or alkali metal hydroxyquinolate complexes are specified below (**formula VII**). Reference is made to WO2011/157779.

The electron-transporting layer may also be electronically doped in order to improve the transport properties of the materials used, in order firstly to make the layer thicknesses more generous (avoidance of pinholes/short circuits) and in order secondly to minimize the operating voltage of the device. Electronic doping is known to those skilled in the art and is disclosed, for example, in W. Gao, A. Kahn, J. Appl. Phys., Vol. 94, No. 1, 1 July 2003 (p-doped organic layers); A. G. Werner, F. Li, K. Harada, M. Pfeiffer, T. Fritz, K. Leo, Appl. Phys. Lett., Vol. 82, No. 25, 23 June 2003 and Pfeiffer et al., Organic Electronics 2003, 4, 89 - 103 and K. Walzer, B. Maennig, M. Pfeiffer, K. Leo, Chem. Soc. Rev. 2007, 107, 1233. For example, it is possible to use mixtures which lead to electrical n-doping of the electron-transporting layer. n-Doping is achieved by the addition of reducing materials. These mixtures may, for example, be mixtures of the abovementioned electron transport materials with alkali/alkaline earth metals or alkali/alkaline earth metal salts, for example Li, Cs, Ca, Sr, Cs₂CO₃, with alkali metal complexes, for example 8-hydroxyquinolatolithium (Liq), and with Y, Ce, Sm, Gd, Tb, Er, Tm, Yb, Li₃N, Rb₂CO₃, dipotassium phthalate, W(hpp)₄ from EP1786050, or with compounds described in EP1837926B1, EP1837927, EP2246862, WO2010132236 and DE102010004453.

In a preferred embodiment, the electron-transporting layer comprises at least one compound of the general formula (**VII**) 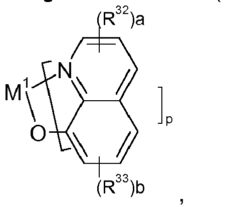 in which
R³² and R³³ are each independently F, C₁-C₈-alkyl, or C₆-C₁₄-aryl, which is optionally substituted by one or more C₁-C₈-alkyl groups, or
two R³² and/or R³³ substituents together form a fused benzene ring which is optionally substituted by one or more C₁-C₈-alkyl groups;
a and b are each independently 0, or 1, 2 or 3,
M¹ is an alkaline metal atom or alkaline earth metal atom,
p is 1 when M¹ is an alkali metal atom, p is 2 when M¹ is an earth alkali metal atom.

A very particularly preferred compound of the formula (**VII**) is 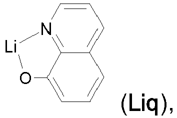 which may be present as a single species, or in other forms such as Li_{g}Q_{g} in which g is an integer, for example Li₆Q₆. Q is an 8-hydroxyquinolate ligand or an 8-hydroxyquinolate derivative.

In a further preferred embodiment, the electron-transporting layer comprises at least one compound of the formula (**VIII**), 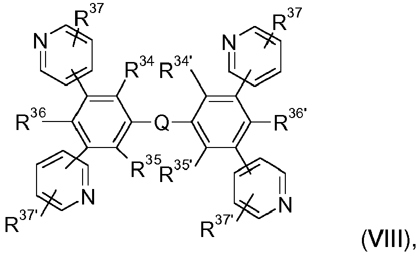 in which
R³⁴, R³⁵, R³⁶, R³⁷, R^{34'}, R^{35'}, R^{36'} and R^{37'} are each independently H, C₁-C₁₈-alkyl, C₁-C₁₈-alkyl which is substituted by E and/or interrupted by D, C₆-C₂₄-aryl, C₆-C₂₄-aryl which is substituted by G, C₂-C₂₀-heteroaryl or C₂-C₂₀-heteroaryl which is substituted by G,
Q is an arylene or heteroarylene group, each of which is optionally substituted by G;
D is -CO-; -COO-; -S-; -SO-; -SO₂-; -O-; -NR⁴⁰-; -SiR⁴⁵R⁴⁶-; -POR⁴⁷-; -CR³⁸=CR³⁹-; or -C=C-;
E is -OR⁴⁴; -SR⁴⁴; -NR⁴⁰R⁴¹; -COR⁴³; -COOR⁴²; -CONR⁴⁰R⁴¹; -CN; or F;
G is E, C₁-C₁₈-alkyl, C₁-C₁₈-alkyl which is interrupted by D , C₁-C₁₈-perfluoroalkyl, C₁-C₁₈-alkoxy, or C₁-C₁₈-alkoxy which is substituted by E and/or interrupted by D,
in which
R³⁸ and R³⁹ are each independently H, C₆-C₁₈-aryl; C₆-C₁₈-aryl which is substituted by C₁-C₁₈-alkyl or C₁-C₁₈-alkoxy; C₁-C₁₈-alkyl; or C₁-C₁₈-alkyl which is interrupted by -O-;
R⁴⁰ and R⁴¹ are each independently C₆-C₁₈-aryl; C₆-C₁₈-aryl which is substituted by C₁-C₁₈-alkyl or C₁-C₁₈-alkoxy; C₁-C₁₈-alkyl; or C₁-C₁₈-alkyl which is interrupted by -O-; or R⁴⁰ and R⁴¹ together form a 6-membered ring;
R⁴² and R⁴³ are each independently C₆-C₁₈-aryl; C₆-C₁₈-aryl which is substituted by C₁-C₁₈-alkyl or C₁-C₁₈-alkoxy; C₁-C₁₈-alkyl; or C₁-C₁₈-alkyl which is interrupted by -O-,
R⁴⁴ is C₆-C₁₈-aryl; C₆-C₁₈-aryl which is substituted by C₁-C₁₈-alkyl or C₁-C₁₈-alkoxy; C₁-C₁₈-alkyl; or C₁-C₁₈-alkyl which is interrupted by -O-,
R⁴⁵ and R⁴⁶ are each independently C₁-C₁₈-alkyl, C₆-C₁₈-aryl or C₆-C₁₈-aryl which is substituted by C₁-C₁₈-alkyl,
R⁴⁷ is C₁-C₁₈-alkyl, C₆-C₁₈-aryl or C₆-C₁₈-aryl which is substituted by C₁-C₁₈-alkyl.

Preferred compounds of the formula (VIII) are compounds of the formula (Villa) 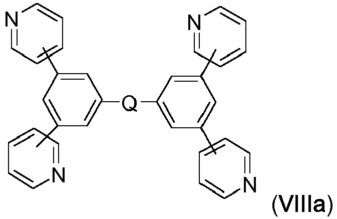 in which Q is: 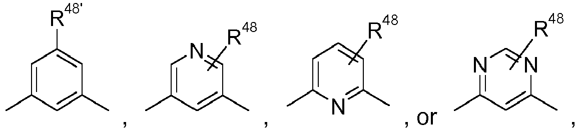 R⁴⁸ is H or C₁-C₁₈-alkyl and R^{48'} is H, C₁-C₁₈-alkyl or

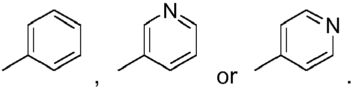

Particular preference is given to a compound of the formula

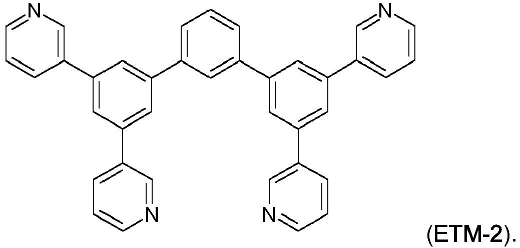

In a further, very particularly preferred embodiment, the electron-transporting layer comprises a compound **Liq** and a compound **ETM-2.**

In a preferred embodiment, the electron-transporting layer comprises the compound of the formula **(VII)** in an amount of 99 to 1% by weight, preferably 75 to 25% by weight, more preferably about 50% by weight, where the amount of the compounds of the formulae **(VII)** and the amount of the compounds of the formulae **(VIII)** adds up to a total of 100% by weight.

The preparation of the compounds of the formula **(VIII)** is described in J. Kido et al., Chem. Commun. (2008) 5821-5823, J. Kido et al., Chem. Mater. 20 (2008) 5951-5953 and JP2008/127326, or the compounds can be prepared analogously to the processes disclosed in the aforementioned documents.

It is likewise possible to use mixtures of alkali metal hydroxyquinolate complexes, preferably Liq, and dibenzofuran compounds in the electron-transporting layer. Reference is made to WO2011/157790. Dibenzofuran compounds **A-1** to **A-36** and **B-1** to **B-22** described in WO2011/157790 are preferred, wherein dibenzofuran compound 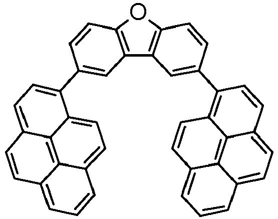 **(A-10; = ETM-1)** is most preferred.

In a preferred embodiment, the electron-transporting layer comprises **Liq** in an amount of 99 to 1% by weight, preferably 75 to 25% by weight, more preferably about 50% by weight, where the amount of **Liq** and the amount of the dibenzofuran compound(s), especially **ETM-1,** adds up to a total of 100% by weight.

In a preferred embodiment, the electron-transporting layer comprises at least one phenanthroline derivative and/or pyridine derivative.

In a further preferred embodiment, the electron-transporting layer comprises at least one phenanthroline derivative and/or pyridine derivative and at least one alkali metal hydroxyquinolate complex.

In a further preferred embodiment, the electron-transporting layer comprises at least one of the dibenzofuran compounds **A-1** to **A-36** and **B-1** to **B-22** described in WO2011/157790, especially **ETM-1**.

In a further preferred embodiment, the electron-transporting layer comprises a compound described in WO2012/111462, WO2012/147397, WO2012/014621, such as, for example, a compound of formula 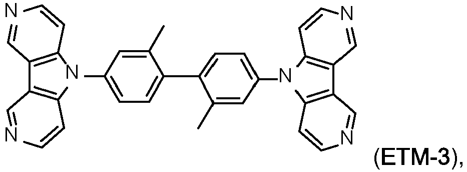 US2012/0261654 , such as, for example, a compound of formula 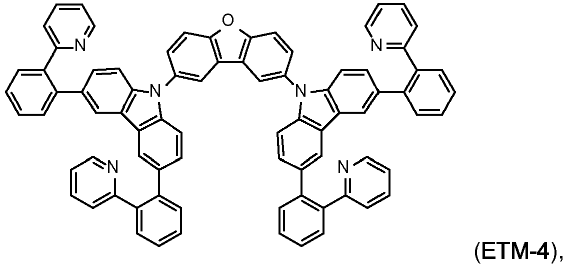 and WO2012/115034, such as for example, such as, for example, a compound of formula

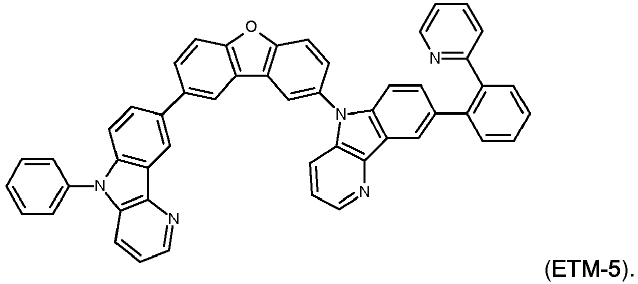

Further suitable electron transport materials are mentioned in US2013/0181190, especially in table 3, and US2013/0119354, especially in table 4.

Further suitable electron transport materials are mentioned in WO2013/079678, especially the compounds mentioned in the examples.

Further suitable electron transport materials are mentioned in EP2452946, especially compound (28) on page 5 and compound (10) on page 6.

A further suitable electron transport material is

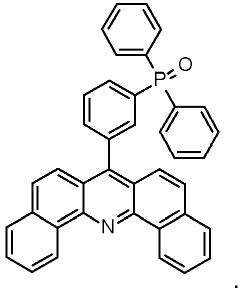

Further suitable electron transport materials are mentioned in EP2434559 and WO2013/187896, for example:

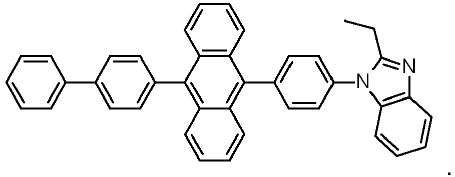

As n-dopant, for example the material mentioned in EP 1 837 926 is employed.

### Electron injection layer (h)

The electron injection layer may be any layer that improves the injection of electrons into an adjacent organic layer. Lithium-comprising organometallic compounds such as 8-hydroxyquinolatolithium (Liq), CsF, NaF, KF, Cs₂CO₃ or LiF may be applied between the electron transport layer (g) and the cathode (i) as an electron injection layer (h) in order to reduce the operating voltage.

### Cathode (i)

The cathode (i) is an electrode which serves to introduce electrons or negative charge carriers. The cathode may be any metal or nonmetal which has a lower work function than the anode. Suitable materials for the cathode are selected from the group consisting of alkali metals of group 1, for example Li, Cs, alkaline earth metals of group 2, metals of group 12 of the Periodic Table of the Elements, comprising the rare earth metals and the lanthanides and actinides. In addition, metals such as aluminum, indium, calcium, barium, samarium and magnesium, and combinations thereof, may be used.

In general, the different layers, if present, have the following thicknesses:
In general, the different layers in the inventive OLED, if present, have the following thicknesses: anode (a): 12 to 500 nm, preferably 40 to 500, more preferably 50 to 500 nm, most preferably 100 to 200 nm; in a further most preferred embodiment: 40 to 120 nm;
hole injection layer (b): 1 to 100 nm, preferably 5 to 100 nm, more preferably 2 to 80 nm, most preferably 20 to 80 nm, ,
hole-transport layer (c): 5 to 200 nm, preferably 5 to 100 nm, , more preferably 10 to 80 nm; electron/exciton blocking layer (d): 1 to 50 nm, preferably 5 to 10 nm, preferably 3 to 10 nm; light-emitting layer (e): 1 to 100 nm, preferably 5 to 60 nm, preferably 5 to-40 nm;
hole/exciton blocking layer (f): 1 to 50 nm, preferably 5 to 10 nm, preferably 3 to 10 nm; electron-transport layer (g): 5 to 100 nm, preferably 20 to 80 nm; preferably 20 to 50 nm; electron injection layer (h): 1 to 50 nm, preferably 2 to 10 nm;
cathode (i): 20 to 1000 nm, preferably 30 to 500 nm.

The inventive OLED can be produced by methods known to those skilled in the art. In general, the OLED is produced by successive vapor deposition of the individual layers onto a suitable substrate. Suitable substrates are, for example, glass, inorganic materials such as ITO or IZO or polymer films. For the vapor deposition, customary techniques may be used, such as thermal evaporation, chemical vapor deposition (CVD), physical vapor deposition (PVD) and others. In case of an active matrix OLED display (AMOLED), the substrate can be an AMOLED backplane.

In an alternative process, the organic layers may be coated from solutions or dispersions in suitable solvents, in which case coating techniques known to those skilled in the art are employed. Suitable coating techniques are, for example, spin-coating, the casting method, the Langmuir-Blodgett ("LB") method, the inkjet printing method, dip-coating, letterpress printing, screen printing, doctor blade printing, slit-coating, roller printing, reverse roller printing, offset lithography printing, flexographic printing, web printing, spray coating, coating by a brush or pad printing, and the like. Among the processes mentioned, in addition to the aforementioned vapor deposition, preference is given to spin-coating, the inkjet printing method and the casting method since they are particularly simple and inexpensive to perform. In the case that layers of the OLED are obtained by the spin-coating method, the casting method or the inkjet printing method, the coating can be obtained using a solution prepared by dissolving the composition in a concentration of 0.0001 to 90% by weight in a suitable organic solvent such as benzene, toluene, xylene, tetrahydrofuran, methyltetrahydrofuran, N,N-dimethylformamide, acetone, acetonitrile, anisole, dichloromethane, dimethyl sulfoxide, water and mixtures thereof.

It is possible that the layers of the OLED are all produced by the same coating method. Furthermore, it is likewise possible to conduct two or more different coating methods to produce the layers of the OLED.

The inventive OLEDs can be used in all devices in which electroluminescence is useful. Suitable devices are preferably selected from stationary and mobile visual display units and illumination means. Further suitable devices are devices such as keyboards; items of clothing; furniture; and wallpaper. The present invention therefore also relates to a device selected from the group consisting of stationary visual display units; mobile visual display units; illumination means; keyboards; items of clothing; furniture; and wallpaper comprising an inventive OLED or an inventive light-emitting layer.

Stationary visual display units are, for example, visual display units of computers, televisions, visual display units in printers, kitchen appliances and advertising panels, illuminations and information panels. Mobile visual display units are, for example, visual display units in cellphones, laptops, tablet PCs, digital cameras, mp-3 players, smartphones, vehicles, and destination displays on buses and trains.

The inventive metal carbene complexes can additionally be used in OLEDs with inverse structure. In these inverse OLEDs, the inventive complexes are in turn preferably used in the light-emitting layer. The structure of inverse OLEDs and the materials typically used therein are known to those skilled in the art.

The present invention further provides a white OLED comprising at least one inventive metal carbene complex. In a preferred embodiment, the inventive metal carbene complex is used as emitter material in the white OLED. Preferred embodiments of the inventive metal carbene complexes have been specified above. Suitable structures of white OLEDs and suitable components are known by a person skilled in the art.

In order to obtain white light, the OLED must generate light which colors the entire visible range of the spectrum. However, organic emitters normally emit only in a limited portion of the visible spectrum - i.e. are colored. White light can be generated by the combination of different emitters. Typically, red, green and blue emitters are combined. However, the prior art also discloses other methods for formation of white OLEDs, for example the triplet harvesting approach. Suitable structures for white OLEDs or methods for formation of white OLEDs are known to those skilled in the art.

In one embodiment of a white OLED, several dyes are layered one on top of another in the light-emitting layer of an OLED and hence combined (layered device). This can be achieved by mixing all dyes or by direct series connection of different-colored layers. The expression "layered OLED" and suitable embodiments are known to those skilled in the art.

In a further embodiment of a white OLED, several different-colored OLEDs are stacked one on top of another (stacked device). For the stacking of two OLEDs, what is called a charge generation layer (CG layer) is used. This CG layer may be formed, for example, from one electrically n-doped and one electrically p-doped transport layer. The expression "stacked OLED" and suitable embodiments are known to those skilled in the art.

In further embodiments of this "stacked device concept", it is also possible to stack only two or three OLEDs or to stack more than three OLEDs.

In a further embodiment of white OLEDs, the two concepts mentioned for white light generation can also be combined. For example, a single-color OLED (for example blue) can be stacked with a multicolor layered OLED (for example red-green). Further combinations of the two concepts are conceivable and known to those skilled in the art.

The inventive metal carbene complex can be used in any of the layers mentioned above in white OLEDs. In a preferred embodiment, it is used in one or more or all light-emitting layer(s) of the OLED(s), in which case the structure of the invention metal carbene complex is varied as a function of the use of the complex. Suitable and preferred components for the further layers of the light OLED(s) or materials suitable as matrix material in the light-emitting layer(s) and preferred matrix materials are likewise specified above.

The examples which follow, more particularly the methods, materials, conditions, process parameters, apparatus and the like detailed in the examples, are intended to support the present invention, but not to restrict the scope of the present invention.

### Examples

All experiments are carried out in protective gas atmosphere. The percentages and ratios mentioned in the examples below - unless stated otherwise - are % by weight and weight ratios.

### I. Synthesis Examples

### Synthesis Example 1. Synthesis of complex (I)

### a) Synthesis of N2,N3-bis(4-isopropylphenyl)quinoxaline-2,3-diamine

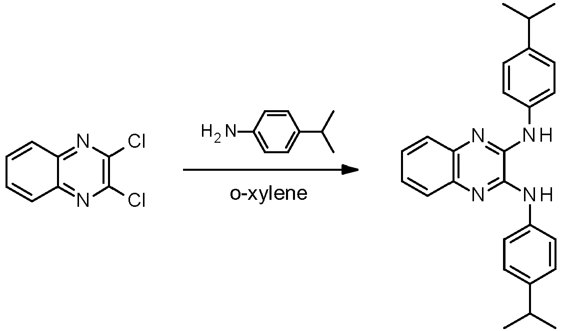

10.0 g (50.2 mmol) of 2,3-dichloroquinoxaline and 14.5 g (0.11 mol) 4-isopropylaniline in 90 ml of o-xylene are heated at 150°C during 90 minutes followed by stirring the resulting yellow suspension at room temperature during 16 hours. The thick yellow suspension is diluted with 140 ml of o-xylene and heating is continued at 160°C for another two hours. The suspension is cooled down to room temperature and diluted with heptane up to a total volume of 500 ml. The thick suspension is stirred during 20 minutes, filtered, followed by washing with ethanol, and the resulting yellow solid dried under vacuum. The solid is suspended in a mixture of 100 ml of ethanol, 100 ml of water and 50 ml of 25% aqueous ammonia solution, and the resulting suspension stirred during 15 minutes, providing a light brown emulsion. The emulsion is diluted with water and extracted with dichloromethane. The dichloromethane phase is separated and the aqueous phase extracted with an additional amount of dichloromethane. The combined dichloromethane fractions are washed with water, dried over magnesium sulfate, filtered and concentrated under vacuum. The yellow-brown oil is purified by chromatography (silica gel, heptane/ethyl acetate) giving the title product as a yellow solid (yield: 12.4 g (65%)).

¹H-NMR (400 MHz, CD₃OD): δ = 1.27 (d, 12 H), 2.90 (m, 2 H), 7.24 (m, 4 H), 7.30 (m, 2 H), 7.56 (m, 2 H), 7.69 (m, 4 H).

### b) Synthesis of [3-(4-isopropylanilino)quinoxalin-2-yl]-(4-isopropylphenyl)ammonium chloride

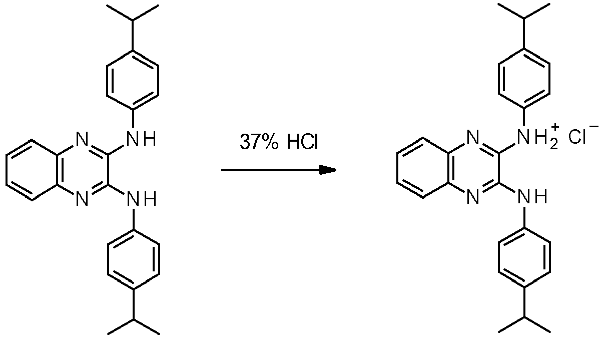

An orange suspension of 12.4 g (31.3 mmol) of N2,N3-bis(4-isopropylphenyl)quinoxaline-2,3-diamine and 250 ml of 37% hydrochloric acid solution is stirred at room temperature during one hour. The yellow suspension is carefully diluted with water and stirring continued for 10 minutes. The suspension is filtered und the solid washed with water and further dried under vacuum giving the title product as a yellow solid (yield: 22.0 g, still wet).

### c) Synthesis of 2-ethoxy-1,3-bis(4-isopropylphenyl)-2H-imidazo[4,5-b]quinoxaline

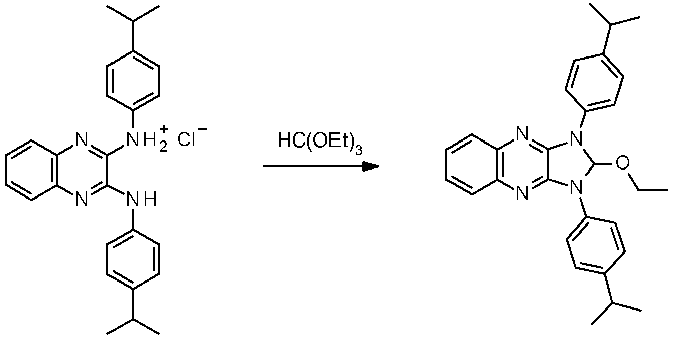

22 g (max. 31 mmol, still including residual water) of [3-(4-isopropylanilino)quinoxalin-2-yl]-(4-isopropylphenyl)ammonium chloride and 200 ml (1.2 mol) of triethyl orthoformate are heated under argon at 95°C during 90 minutes. The light yellow-greenish turbid solution is cooled down and triethyl orthoformate distilled off under vacuum. 50 ml of ethanol are added and the resulting suspension stirred over an ice-bath. The suspension is filtered and the solid washed with 25 ml of ethanol giving the title product as a white solid (yield: 12.1 g (86%)).

¹H-NMR (400 MHz, d₆-DMSO): δ = 0.91 (t, 3 H), 1.26 (d, 12 H), 2.96 (m, 2 H), 3.28 (m, 2 H), 7.37 (m, 2 H), 7.42 (m, 4 H), 7.61 (m, 2 H), 7.78 (s, 1 H), 8.02 (m, 4 H).

### d) Synthesis of complex (I)

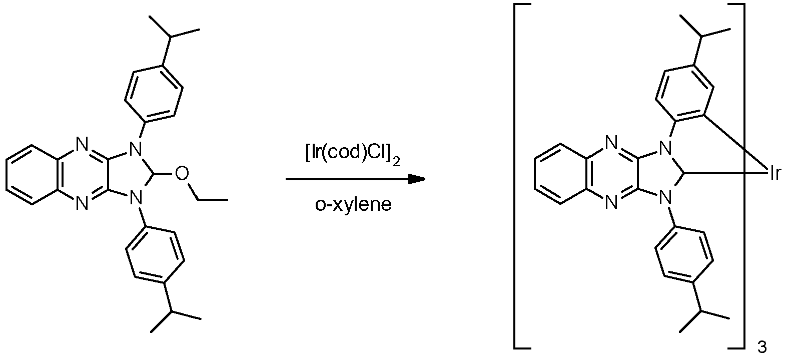

4.00 g (8.84 mmol) of 2-ethoxy-1,3-bis(4-isopropylphenyl)-2H-imidazo[4,5-b]quinoxaline and 0.60 g (0.89 mmol) of chloro(1,5-cyclooctadiene)iridium(I) dimer are suspended under argon in 70 ml of o-xylene. The orange suspension is three times evacuated and backfilled with argon, followed by heating at 142°C during 9 hours. The solution is cooled down to room temperature and concentrated under vacuum. The solid is treated with ethanol and stirred at room temperature during one hour. The suspension is filtered and the solid further purified by chromatography (silica gel, heptane/dichloromethane). The resulting solid is dissolved in 50 ml of dichloromethane followed by the addition of 250 ml of ethanol. The resulting yellow suspension is stirred at room temperature during 30 minutes, then filtered, the solid washed with ethanol, dried under vacuum, giving the title product as a bright yellow solid (yield: 1.90 g (75%)).

APCI-LC-MS (positive, m/z): exact mass of C₈₁H₇₅IrN₁₂ = 1408.59; found 1409.7 [M+1]⁺. ¹H-NMR (400 MHz, CD₂Cl₂): δ = 0.70 (d, 9 H), 0.80 (d, 9 H), 1.01 (d, 9 H), 1.11 (d, 9 H), 2.11 (m, 3 H), 2.66 (m, 3 H), 6.05 (br. s, 3 H), 6.35-6.79 (2x br. s, and d, 9 H), 7.12 (dd, 3 H), 7.37 (br. s, 3 H), 7.72 (m, 3 H), 7.84 (m, 6 H), 8.35 (d, 3 H), 8.99 (d, 3 H).

### Synthesis Example 2. Synthesis of complex (II)

### a) Synthesis of complex intermediate (II-1)

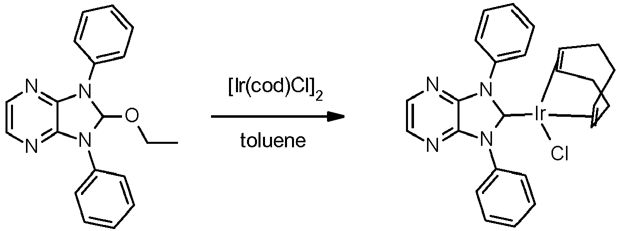

5.27 g (7.85 mmol) of chloro(1,5-cyclooctadiene)iridium(I) dimer are suspended in 250 ml of toluene and three times evacuated and backfilled with argon. 5.00 g (15.7 mmol) of 2-ethoxy-1,3-diphenyl-2H-imidazo[4,5-b]pyrazine are added in small portions at 66°C during 20 minutes. Heating is continued at 66°C and the generated ethanol continuously removed by using a distillation bridge. The yellow-brown suspension is cooled down to room temperature and diluted with 200 ml of ethanol, and cooling is continued until 5°C is reached. Stirring is continued at this temperature for 30 minutes, followed by filtration and washing with 50 ml of cold ethanol and 50 ml of heptane. The resulting solid is dried under vacuum giving the title product as a yellow solid (yield: 4.1 g (43%)).

¹H-NMR (400 MHz, CDCl₃): δ = 1.31-1.42 (m, 2 H), 1.43-1.64 (m, 4 H), 1.73-1.86 (m, 2 H), 2.50-2.59 (m, 2 H), 4.68-4.78 (m, 2 H), 7.57-7.69 (m, 6 H), 8.15-8.22 (m, 4 H), 8.33 (s, 2 H).

### b) Synthesis of complex (II)

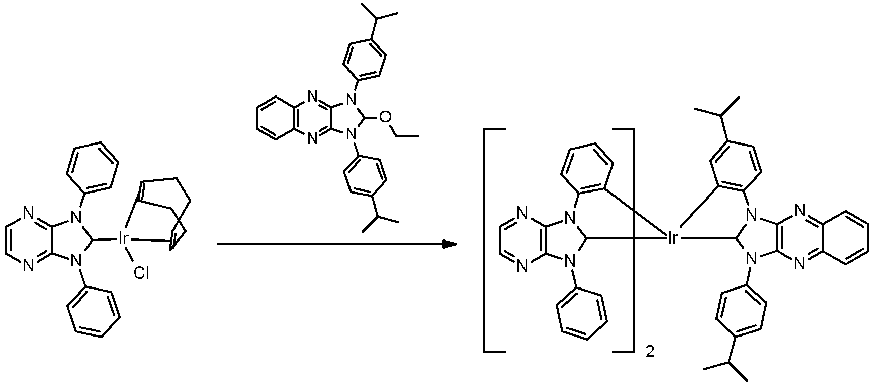

0.3 g (0.5 mmol) of intermediate complex (II-1) and 0.49 g (1.08 mmol) of 2-ethoxy-1,3-bis(4-isopropylphenyl)-2H-imidazo[4,5-b]quinoxaline are dissolved under argon in 50 ml of o-xylene. The yellow turbid solution is three times evacuated and backfilled with argon, followed by heating at 140°C during 10 hours. The reaction mixture is cooled down to 50°C and directly purified by elution via chromatography (silica gel, toluene/ethyl acetat) The product fractions are combined and concentrated under vacuum. The yellow resin is dissolved in a mimimum amount of dichloromethane and treated with ethanol until precipitation is initiated and further stirred over an ice-batch during one hour. The suspension is filtered and the solid dried under vacuum, giving the title product as a bright yellow solid (yield: 50 mg (18%)).

APCI-LC-MS (positive, m/z): exact mass of C₆₁H₄₇IrN₁₂ = 1140.37; found 1141.5 [M+1]⁺. ¹H-NMR (400 MHz, CD₂Cl₂): δ = 0.97 (d, 3 H), 1.02 (d, 3 H), 1.06 (d, 6 H), 2.54 (m, 1 H), 2.64 (m, 1 H), 6.02-7.67 (broad signals, 12 H), 6.55 (d, 1 H), 6.66 (m, 4 H), 6.87 (m, 3 H), 7.13 (dd, 1 H), 7.20 (m, 2 H), 7.84 (ddd, 1 H), 7.90 (dd, 1 H), 8.09 (dd, 2 H), 8.31-8.43 (m, 3 H), 8.78 (dd, 1 H), 8.85 (dd, 1 H), 8.97 (d, 1 H).

### Synthesis Example 3. Synthesis of complex (III)

### a) Synthesis of 4,7-diethyl-2,1,3-benzothiadiazole

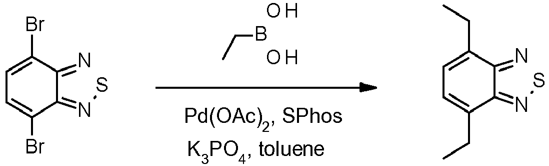

5.0 g (17.0 mmol) of 4,7-dibromo-2,1,3-benzothiadiazole and 3.77 g (51.0 mmol) of ethylboronic acid are suspended under argon in 50 ml of toluene. 150 mg (0.67 mmol) of palladium(II) acetate and 0.85 g (2.07 mmol) of 2-dicyclohexyl-phosphino-2',6'-dimethoxybiphenyl are added, followed by the addition of 36.1 g (0.16 mol) of potassium phosphate monohydrate. The yellow suspension is three times evacuated and backfilled with argon, followed by heating at 110°C during three hours. The yellow-brown reaction mixture is poured onto 200 ml water and 50 ml of toluene, followed by stirring for short time. The water phase is separated, and the organic phase two times washed with 200 ml of water. The organic phase is dried over magnesium sulfate and filtered. The orange solution is further filtered over a 3 cm layer of silica gel and the silica gel layer rinsed with toluene. The combined filtrates are concentrated under vacuum. The resulting yellow oil is cooled down and stirred together with 30 ml of heptane over an ice-bath providing a yellow suspension which is first further stirred during 30 minutes. The suspension is filtered, the white solid washed with heptane. The combined filtrates are concentrated under vacuum giving the title product as a yellow oil (yield: 3.21 g (98%)).

¹H-NMR (400 MHz, CD₂Cl₂): δ = 1.41 (t, 6 H), 3.15 (q, 4 H), 7.31 (s, 2 H).

### b) Synthesis of 3,6-diethylbenzene-1,2-diamine

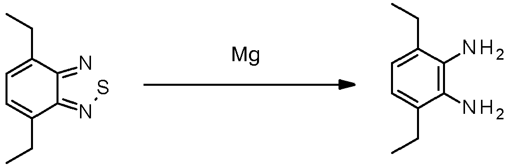

6.90 g (35.9 mmol) of 4,7-diethyl-2,1,3-benzothiadiazole are dissolved in 150 ml of methanol and heated under reflux. A total of 6.15 g (0.25 mol) of magnesium shavings are carefully added in four portions during one hour, and stirring continued for 30 minutes. The green slightly turbid solution is cooled down to room temperature and diluted with methanol up to a volume of 800 ml. The turbid solution is filtered over cellulose filter aid and the filtrate treated with 60 ml of water. The thick suspension is filtered and the solid rinsed with methanol. The filtrates are concentrated under vacuum and the resulting oil diluted with dichloromethane. The solution is filtered over a layer of silica gel followed by rinsing of the silica gel with dichloromethane. The collected fractions are concentrated under vacuum giving the title product as a yellow oil (yield: 3.52 g (60%)).

¹H-NMR (400 MHz, CD₂Cl₂): δ = 1.26 (t, 6 H), 2.57 (q, 4 H), 3.43 (br. s, 4 H), 6.62 (s, 2 H).

### c) Synthesis of 5,8-diethyl-1,4-dihydroquinoxaline-2,3-dione

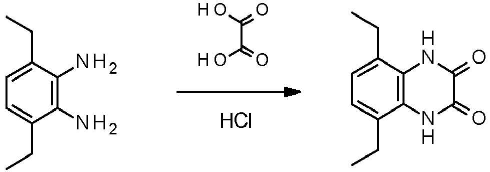

11.6 g (70.6 mmol) of 3,6-diethylbenzene-1,2-diamine are suspended in 130 ml of water and 80 ml of 4N aqueous hydrochloric acid. 9.05 g (71.8 mmol) of oxalic acid dihydrate are added and the white suspension heated under reflux during 15 hours. The pink suspension is cooled down to room temperature, followed by filtration and washing of the solid with water. The solid is stirred in 200 ml of 5% aqueous sodium bicarbonate. The suspension is filtered and the solid washed with water, giving the title product as a white solid (yield: 14.3 g (93%)).

¹H-NMR (400 MHz, d₆-DMSO): δ = 1.12 (t, 6 H), 2.75 (q, 4 H), 6.89 (s, 2 H), 11.18 (br. s, 2 H).

### d) Synthesis of 2,3-dichloro-5,8-diethyl-quinoxaline

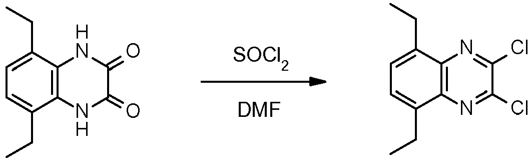

20.2 g (92.6 mmol) of 5,8-diethyl-1,4-dihydroquinoxaline-2,3-dione are slowly treated at room temperature with 50 ml (0.7 mol) of thionyl chloride. The white suspension is heated at 38°C during two hours, followed by heating at 73°C during 30 minutes. Thionyl chloride is distilled off and the yellow oil carefully transferred at room temperature into a beaker containing 1000 ml of water. The beige suspension is stirred during 10 minutes. The suspension is made slightly basic by the addition of sodium bicarbonate and sodium hydroxide. The suspension is further stirred during 10 minutes, followed by filtration and washing of the solid with water. The beige solid is treated with 100 ml of metanol and stirred during 10 minutes. The suspension is filtered and the solid washed with a small amount of metanol, giving the title product as a White solid (yield: 20.2 g (86%)).

¹H-NMR (400 MHz, CD₂Cl₂): δ = 1.36 (t, 6 H), 3.19 (q, 4 H), 7.63 (s, 2 H).

### e) Synthesis of (3-anilino-5,8-diethyl-quinoxalin-2-yl)-phenyl-ammonium chloride

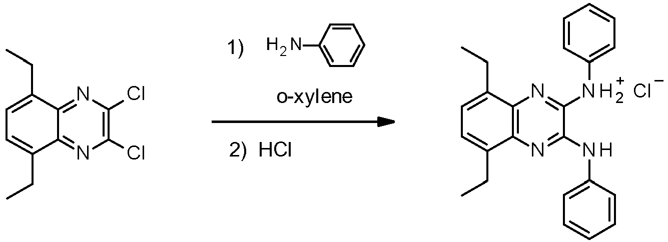

8.35 g (32.7 mmol) of 2,3-dichloro-5,8-diethyl-quinoxaline and 50 ml (0.55 mol) of aniline in 100 ml of o-xylene are heated under reflux during 18 hours. The yellow reaction mixture is cooled down to 50°C, filtered, and the solid rinsed with o-xylene. The yellow filtrate is treated with 200 ml of water and 50 ml of 25% aqueous ammonia solution, followed by stirring during 10 minutes, and dilution with 250 ml of heptane. The aqueous phase is separated and the organic phase three times washed with 300 ml of water. The organic phase is treated with 200 ml of water, and 15 ml of 37% aqueous hydrochlorid acid. The suspension is filtered and the solid stirred in 300 ml of heptane first, followed by stirring in 300 ml of water. The solid is filtered and dried under vacuum, giving the title product as a light yellow solid (yield: 9.3 g (70%)). ¹H-NMR (400 MHz, d₆-DMSO): δ = 1.28 (t, 6 H), 3.00 (q, 4 H), 7.06 (m, 2 H), 7.15 (s, 2 H), 7.39 (m, 4 H), 8.08 (d, 4 H), 9.41 (br. s, 2 H).

### f) Synthesis of 2-ethoxy-5,8-diethyl-1,3-diphenyl-2H-imidazo[4,5-b]quinoxaline

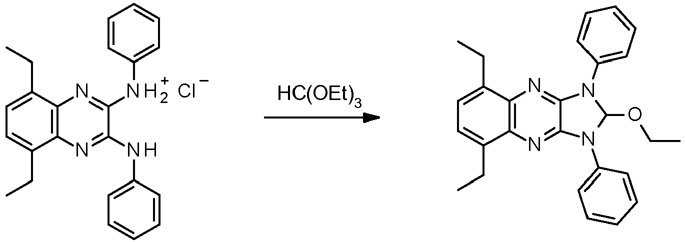

9.53 g (23.5 mmol) of (3-anilino-5,8-diethyl-quinoxalin-2-yl)-phenyl-ammonium chloride and 200 ml (1.2 mol) of triethyl orthoformate are heated under argon at 95°C during 90 minutes. The slightly turbid orange solution is concentrated under vacuum and the resulting solid three times stirred in 50 ml of heptane. The suspension is filtered and dried under vacuum, giving the title product as a light grey solid (yield: 7.5 g (75%)).

¹H-NMR (400 MHz, d₆-DMSO): δ = 0.89 (t, 3 H), 1.31 (t, 6 H), 3.05 (q, 4 H), 3.23 (q, 2 H), 7.22 (s, 2 H), 7.24 (t, 2 H), 7.54 (t, 4 H), 7.92 (s, 1 H), 8.28 (d, 4 H).

### g) Synthesis of complex (III)

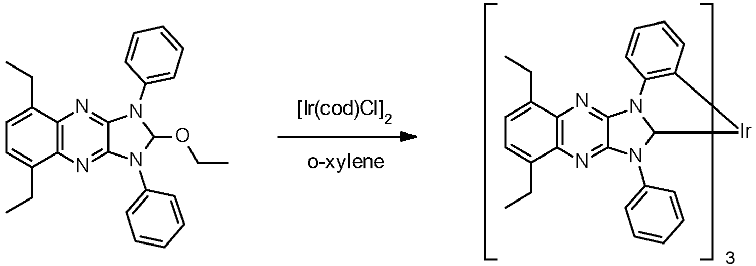

4.00 g (9.42 mmol) of 2-ethoxy-5,8-diethyl-1,3-diphenyl-2H-imidazo[4,5-b]quinoxaline and 0.63 (0.94 mmol) of chloro(1,5-cyclooctadiene)iridium(I) dimer are suspended under argon in 70 ml of o-xylene. The suspension is three times evacuated and backfilled with argon, followed by heating at 136°C during 15 hours. The reaction mixture is cooled down to 100°C and filtered through a 4.5 cm layer of silica gel. The silica gel layer is rinsed with o-xylene and dichloromethane. The collected filtrates are stirred over an ice-bath during 30 minutes. The suspension is filtered and the solid washed with a small amount of o-xylene, followed by drying under vacuum, giving the title product as a bright yellow solid (yield: 0.65 g (25%)).

APCI-LC-MS (positive, m/z): exact mass of C₇₅H₆₃IrN₁₂ = 1324.49; found 1325.5 [M+1]⁺. ¹H-NMR (400 MHz, CD₂Cl₂): δ = 1.19 (t, 9 H), 1.59 (t, 9 H), 2.88 (m, 3 H), 3.00 (m, 3 H), 3.49 (m, 6 H), 6.49-7.41 (broad signal, 12 H), 6.54 (td, 3 H), 6.76 (dd, 3 H), 6.89 (td, 3 H), 7.29 (td, 3 H), 7.54 (d, 3 H), 7.63 (d, 3 H), 9.09 (d, 3 H).

### Synthesis Example 4. Synthesis of complex (IV)

### a) Synthesis of 2,3-dianilino-quinoxaline

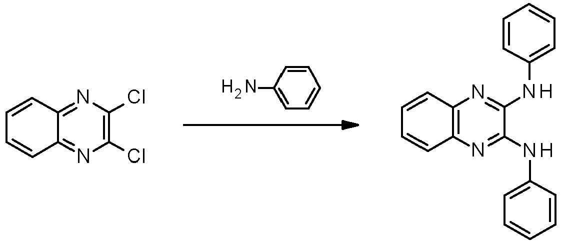

2,3-Dianilino-quinoxaline was synthetized similar to the protocol described in J. Chem. Soc. 1948, 777-782. 5.00 g (24.6 mmol) 2,3-dichloro-quinoxaline were added in portions to 25 ml aniline at 140 °C. The solution was heated to 160 °C and held at that temperature for 30 min. 100 ml methyl-tert.-butylether was added to the suspension after the solution had cooled down to room temperature. The precipitate was filtered off, washed five times with 10 ml methyl-tert.-butylether each, and dried at 30 °C in a vacuum oven. The solid was suspended in 150 ml water, then filtered off, washed four times with 20 ml water each, and sucked dry. The residue was dissolved in 70 ml methylenechloride. Magnesium sulfate was added. The solution was concentrated. Then 30 ml methyl-tert.-butylether was added. The suspension was concentrated to dryness and dried at 50 °C in a vacuum oven. 8.35 g yellow solid were obtained. It was used without further purification.

¹H-NMR (500 MHz, d₆-DMSO): δ [ppm] = 7.09 (mc; 2H), 7.34 (mc; 2H), 7.41 (mc; 4H), 7.55 (mc; 2H), 7.90 (mc; 4H), 9.03 (s; 2H).

### b) Synthesis of 2-alkoxy-1,3-diphenyl-2H-imidazo[4,5-b]quinoxaline

### (i) 2-Methoxy-1,3-diphenyl-2H-imidazo[4,5-b]quinoxaline

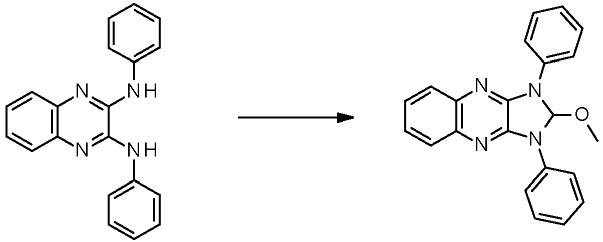

16.00 g (51.2 mmol) 2,3-dianilino-quinoxaline and 5.54 g (51.2 mmol) ammonium tetrafluoroborate were dissolved in 64 ml ortho-formic acid trimethylester. The solution was heated to 82 °C and held at that temperature for 1.5 h. After cooling to room temperature the suspension was filtered. The residue was washed three times with little cold ortho ester and then with petrol ether. The solid was dissolved in methylene chloride. The suspension was filtered to separate the product from the salt. The filtrate was concentrated to dryness. 13.7 g (75 % of theory) colorless solid were isolated.

¹H-NMR (400 MHz, CD₂Cl₂): δ [ppm] = 3.08 (s; 3H), 7.25 (mc; 2H), 7.36 (s; 1H), 7.41 (mc; 2H), 7.51 (mc; 4H), 7.73 (mc; 2H), 8.17 (mc; 4H)

### (ii) 2-Ethoxy-1,3-diphenyl-2H-imidazo[4,5-b]quinoxaline

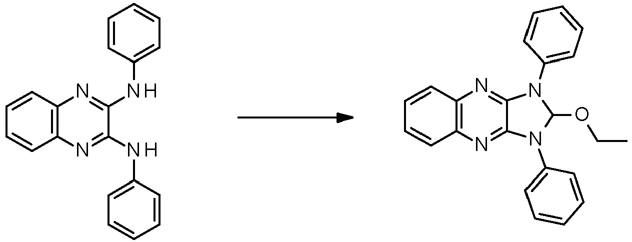

16.35 g (18.7 mmol) 2,3-dianilino-quinoxaline and 0.50 g (4.6 mmol) ammonium tetrafluoroborate were suspended in ortho-formic acid triethylester. The reaction mixture was heated to reflux for 1 h. The solution was cooled to room temperature, filtered, and concentrated to dryness. The residue was suspended in pentane, filtered, washed with pentane, and dried. 6.24 g (87 % of theory) colorless solid were obtained.

¹H-NMR (500 MHz, CD₂Cl₂): δ [ppm] = 1.04 (t; 3H), 3.36 (q; 2H), 7.26 (mc; 2H), 7.35 (s; 1H), 7.41 (mc; 2H), 7.51 (mc; 4H), 7.73 (mc; 2H), 8.20 (mc; 4H).

### c) Synthesis of complex (IV)

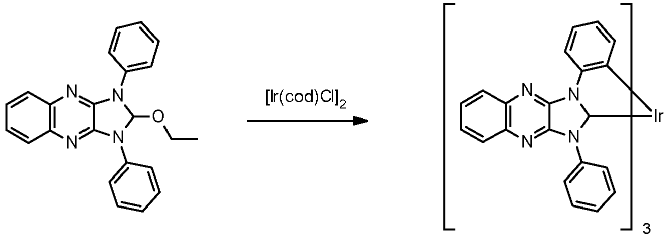

4.00 g (10.9 mmol) 2-ethoxy-1,3-diphenyl-2H-imidazo[4,5-b]quinoxaline and 0.948 g (1.41 mmol) chloro-(1,5-cyclooctadiene)-iridium(I) dimer were dissolved in 60 ml o-dichloro benzene. The suspension was heated to 150 °C and held at that temperature for 20 h. After cooling the solution to room temperature the precipitate was filtered, washed three times with 1.5 ml o-dichloro benzene each, then four times with 2 ml pentane each, and dried in a vacuum oven at 50 °C. The solid was suspended in tetrahydrofurane and heated to reflux for 1 h. The hot suspension was filtered. The residue was washed with THF, pentane, and dried in a vacuum oven at 70 °C. 0.902 g (28 % of theory) bright yellow solid was obtained.

MALDI-MS (positive, m/z): exact mass of C₆₃H₃₉IrN₁₂ = 1156.28; found 1156 [M + H]⁺.

¹H-NMR (500 MHz, CD₂Cl₂): δ [ppm] = 6.58 (mc) 6.67 (mc), 6.84 (mc), 7.72 (mc), 7.82 (mc), 7.87 (mc), 8.32 (mc), 9.05 (mc).

### Synthesis Example 5. Synthesis of complex (V)

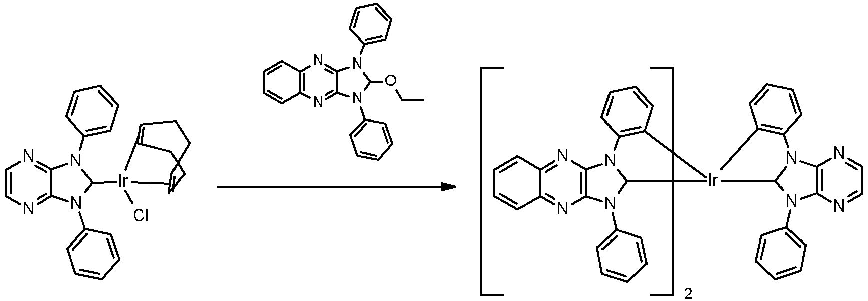

0.250 g 2-Ethoxy-1,3-diphenyl-2H-imidazo[4,5-b]quinoxaline and 0.206 g of intermediate complex (II-1) were dissolved/suspended in 18 ml o-xylene. The suspension was heated to 115 °C and held at that temperature for 43 h. The precipitate was filtered off after cooling the solution to room temperature. The filtrate was concentrated to brown resin and then suspended in methylenchloride. The solid was filtered off. The filtrate was purified at silica gel 60 (70 - 200 µm) with methylenchloride as the eluent. The last fractions monitored by TLC were combined and concentrated to dryness. The yellow solid (64 mg) was suspended in 5 ml methanol, then filtered off, washed three times with 1 ml methanol each, and dried at 60 °C in a vacuum oven. 53 mg (14 % of theory) yellow solid were obtained.

MALDI-MS (positive, m/z): exact mass of C₅₉H₃₇IrN₁₂ = 1106.22; found 1106 [M + H]⁺.

¹H-NMR (500 MHz, CD₂Cl₂): δ [ppm] = 6.56 - 6.89 (m; 18H), 7.15 - 7.45 (m; 5H), 7.45 - 7.73 (m; 3H), 7.81 (mc; 2H), 7.86 (mc; 2H), 8.08 (mc; 1H), 8.31 (mc; 2H), 8.35 (mc; 1H), 8.77 (mc; 1H), 9.04 (mc; 2H).

### Synthesis Example 6. Synthesis of complex (Via)

### a) Synthesis of N2,N3-bis(4-tert-butylphenyl)quinoxaline-2,3-diamine

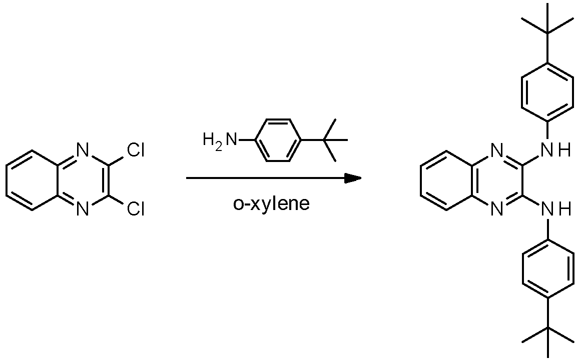

10.0 g (50.2 mmol) of 2,3-dichloroquinoxaline and 16.5 g (0.11 mol) 4-*tert*-butylaniline in 90 ml of o-xylene are heated at 150°C during five hours. The reaction mixture is cooled down to room temperature, diluted with a small amount of dichloromethane and concentrated under vacuum. The mixture is treated with 200 ml of water, 200 ml of ethanol, and solid sodium carbonate is added until a basic pH is reached. The organic phase is separated and the aqueous phase extracted with dichloromethane. The combined organic phases are two times washed with water, dried over sodium sulfate, and concentrated under vacuum. The resulting brown oil is mixed with 100 ml of heptane and heated up to reflux, and the solution cooled down to room temperature. The resulting suspension is filtered, the light yellow solid dissolved in 100 ml of heptane under reflux, followed by cooling down the solution to room temperature. The suspension is filtered and the solid dried under vacuum, giving the title product as a light yellow solid (yield: 13.4 g (63%)).

### b) Synthesis of [3-(4-tert-butylanilino)quinoxalin-2-yl]-(4-tert-butylphenyl)ammonium chloride

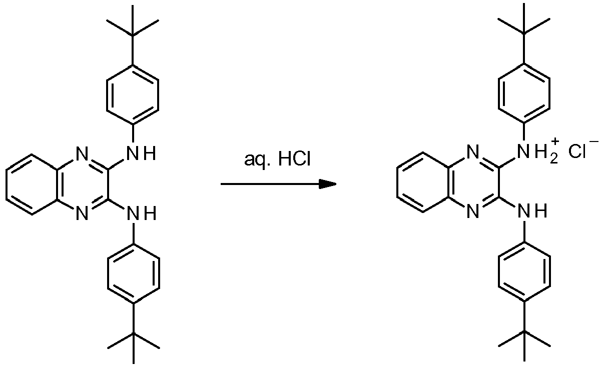

13.4 g (31.6 mmol) of N2,N3-bis(4-*tert*-butylphenyl)quinoxaline-2,3-diamine are added in several portions to 250 ml of concentrated aqueous hydrochloric acid and stirred at room temperature during one hour. The yellow suspension is carefully diluted with 300 ml of water and stirring continued for ten minutes. The suspension is filtered and the solid washed with water and further dried under vacuum, giving the title product as a yellow solid (12.1 g isolated, still including residual water).

¹H-NMR (400 MHz, d₆-DMSO): δ = 1.33 (s, 18 H), 7.32-7.38 (m, 2 H), 7.46 (d, 4 H), 7.55-7.61 (m, 2 H), 7.85 (d, 4 H), 10.14 (br. s, 2 H).

### c) Synthesis of 1,3-bis(4-tert-butylphenyl)-2-ethoxy-2H-imidazo[4,5-b]quinoxaline

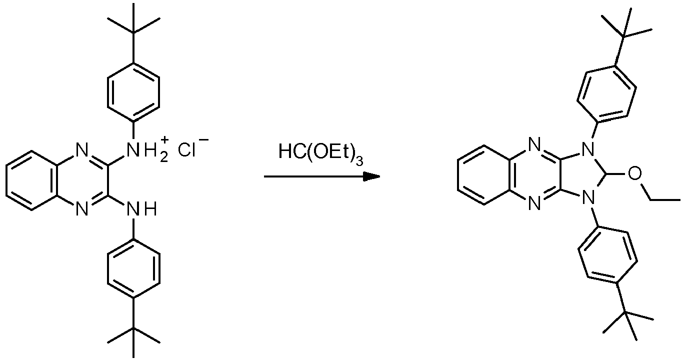

48.3 g (max. 0.1 mol, still including residual water) of [3-(4-*tert*-butylanilino)quinoxalin-2-yl]-(4-*tert*-butylphenyl)ammonium chloride and 250 ml (1.7 mol) of triethyl orthoformate are heated under argon at 95°C during 30 minutes in a reactor fitted with a Dean-Stark separator and condenser. 100 ml (0.7 mol) of triethyl orthoformate are added to the yellow suspension and stirring continued for 30 minutes. Another 100 ml of triethyl orthoformate are added after 30 minutes, and heating continued for one hour. The yellow suspension is cooled down to room temperature, then filtered, and the yellow solid washed with ethanol. The solid is further stirred in 60 ml of ethanol, and the suspension filtered, followed by drying the solid under vacuum. The solid is stirred in 50 ml of heptane, filtered, and dried under vacuum, giving the title product as a light yellow solid (yield: 18.5 g (min. 37%)).

¹H-NMR (400 MHz, d₆-DMSO): δ = 0.93 (t, 3 H), 1.35 (s, 18 H), 3.29 (q, 2 H), 7.35-7.41 (m, 2 H), 7.54-7.65 (2 m, 6 H), 7.78 (s, 1 H), 8.00-8.08 (m, 4 H).

### d) Synthesis of complex (VIa)

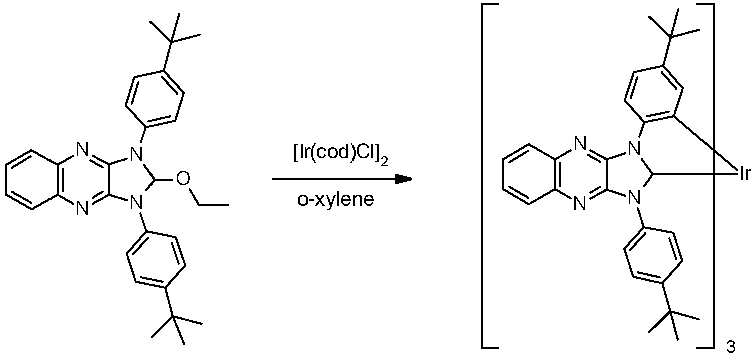

8.00 g (16.6 mmol) of 1,3-bis(4-*tert*-butylphenyl)-2-ethoxy-2H-imidazo[4,5-b]quinoxaline and 1.40 g (2.08 mmol) of chloro(1,5-cyclooctadiene)iridium(I) dimer are suspended under argon in 150 ml of o-xylene. The orange suspension is three times evacuated and backfilled with argon, followed by heating at 134°C during five hours. The orange-red solution is cooled down to room temperature and diluted with 200 ml of ethanol. The resulting suspension is filtered and the yellow solid washed with ethanol. The solid is dissolved in 600 ml of dichloromethane and filtered through a 5 cm layer of silica gel followed by rinsing the silica gel layer with 300 ml of dichloromethane. The collected eluents (orange solution) is treated with 50 ml of ethyl acetate and the solution concentrated under vacuum until a suspension is formed. The suspension is filtered and the solid washed subsequently with ethyl acetate and ethanol, respectively, followed by drying under vacuum. The solid is dissolved in 500 ml of dichloromethane and 50 ml of ethyl acetate, and the solution concentrated under vacuum until a suspension is formed. The suspension is filtered, the solid washed with ethyl acetate first, then with ethanol, followed by drying under vacuum, giving the title product as a yellow solid (yield: 4.15 g (67%)).

APCI-LC-MS (positive, m/z): exact mass of C₈₇H₈₇IrN₁₂ = 1492.68; found 1493.8 [M+1]⁺.

¹H-NMR (400 MHz, CD₂Cl₂): δ = 0.79 (s, 27 H), 1.10 (s, 27 H), 6.09-6.23 (br. signal, 3 H), 6.40-6.56 (br. signal, 6 H), 6.68 (d, 3 H), 7.29 (dd, 3 H), 7.47-7.62 (br. signal, 3 H), 7.68-7.75 (m, 3 H), 7.78-7.91 (m, 6 H), 8.35 (dd, 3 H), 9.01 (d, 3 H).

### Synthesis Example 7. Synthesis of complex (VII)

### a) Synthesis of complex intermediate (VII-a)

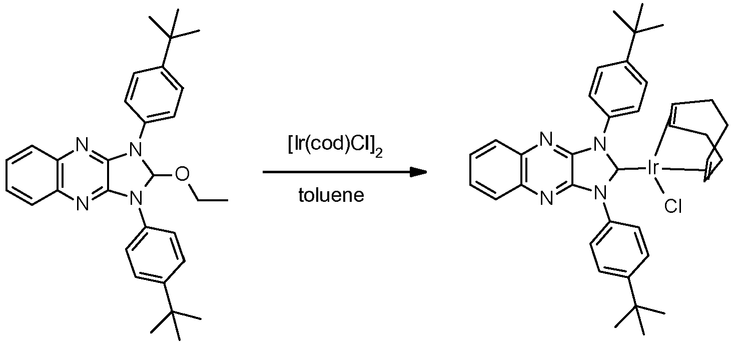

2.34 g (3.48 mmol) of chloro(1,5-cyclooctadiene)iridium(I) dimer are suspended in 100 ml of toluene. The suspension is three times evacuated and backfilled with argon and heated up to 77°C. 3.35 g (6.97 mmol) of 1,3-bis(4-*tert*-butylphenyl)-2-ethoxy-2H-imidazo[4,5-b]quinoxaline are added in small portions, and heating continued at 78°C during 19 hours. The brown solution is cooled down to room temperature and concentrated under vacuum. The resulting red solid is dissolved in dichloromethane first, followed by the addition of and 50 ml of ethanol. The solution is concentrated under vacuum until a suspension is formed. The suspension is filtered, the solid washed with ethanol and heptane, followed by drying under vacuum, giving the title product as a yellow solid (yield: 3.10 g (58%)).

¹H-NMR (400 MHz, CDCl3): δ = 1.30-1.52 (m, 4 H), 1.47 (s, 18 H), 1.53-1.65 (m, 2 H), 1.69-1.82 (m, 2 H), 2.46-2.55 (m, 2 H), 4.72-4.81 (m, 2 H), 7.68 (d, 2 H), 7.73-7.79 (d, 4 H), 8.11-8.20 (m, 6 H).

### b) Synthesis of complex (VII)

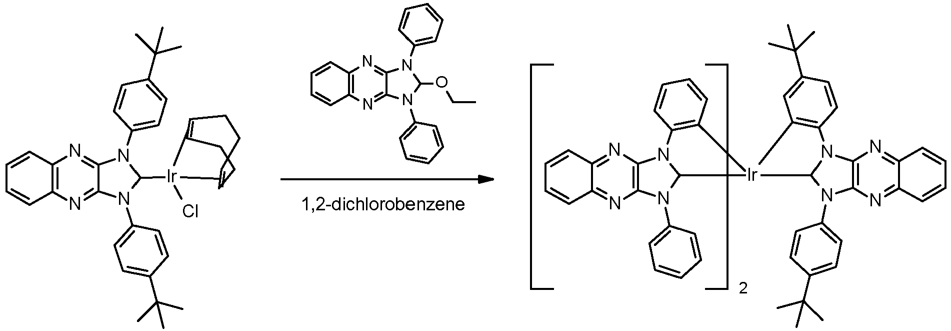

2.50 g (3.24 mmol) of complex intermediate (VII-a) and 2.39 g (6.49 mmol) of 2-ethoxy-1,3-diphenyl-2H-imidazo[4,5-b]quinoxaline are suspended under argon in 50 ml of 1,2-dichlorobenzene. The orange-red suspension is three times evacuated and backfilled with argon, followed by heating at 117°C during 20 hours. The reaction mixture is diluted with 50 ml of acetone, then filtered, and the solid washed with acetone. The combined filtrates are concentrated under vacuum, then dissolved in dichloromethane, followed by the addition of 50 ml of acetone. The solution is concentrated under vacuum until a suspension is formed. The suspension is filtered, the solid washed with acetone and ethanol, followed by drying under vacuum. The solid is further purified by chromatography (silica gel, dichloromethane), giving the title product as a yellow solid (yield: 1.05 g (25%)).

APCI-LC-MS (positive, m/z): exact mass of C₇₁H₅₅IrN₁₂ = 1268.43; found 1269.6 [M+1]⁺. ¹H-NMR (400 MHz, CD₂Cl₂): δ = 0.72 (s, 9 H), 1.08 (s, 9 H), 6.08-8.07 (br. signals, 12 H), 6.62-6.76 (m, 5 H), 6.86-6.93 (m, 2 H), 7.24-7.33 (m, 3 H), 7.69-7.79 (m, 3 H), 7.81-7.88 (m, 4 H), 7.88-7.94 (m, 2 H), 8.32 -8.39 (m, 3 H), 8.95 (d, 1 H), 9.09 (d, 1 H), 9.15 (d, 1 H).

### Synthesis Example 8. Synthesis of complex (VIII)

### a) Synthesis of complex intermediate (VIII-a)

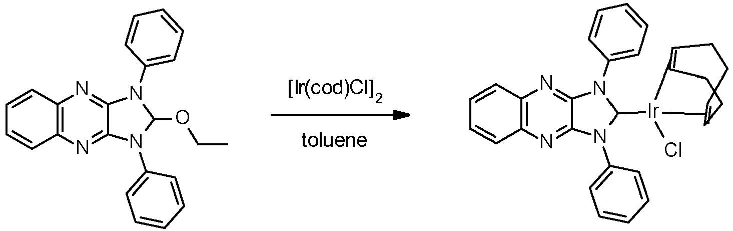

3.00 g (4.47 mmol) of chloro(1,5-cyclooctadiene)iridium(I) dimer are suspended in 50 ml of toluene. The suspension is three times evacuated and backfilled with argon and heated up to 75°C. A solution of 3.29 g (8.92 mmol) of 2-ethoxy-1,3-diphenyl-2H-imidazo[4,5-b]quinoxaline in 100 ml of toluene is added within two hours, and heating continued at 75°C during 21 hours. The reaction mixture is concentrated under vacuum and the residue dissolved in dichloromethane and a small amount of ethanol. The solution is concentrated under vacuum until a suspension is formed. The suspension is filtered, the solid washed with ethanol, and further dried under vacuum, giving the title product as a yellow solid (yield: 2.70 g (46%)).

¹H-NMR (400 MHz, CDCl3): δ = 1.31-1.87 (4 m, 8 H), 2.53-2.62 (m, 2 H), 4.74-4.84 (m, 2 H), 7.59-7.72 (m, 6 H), 7.73-7.79 (m, 2 H), 8.09-8.16 (m, 2 H), 8.22-8.29 (m, 4 H).

### b) Synthesis of complex (VIII)

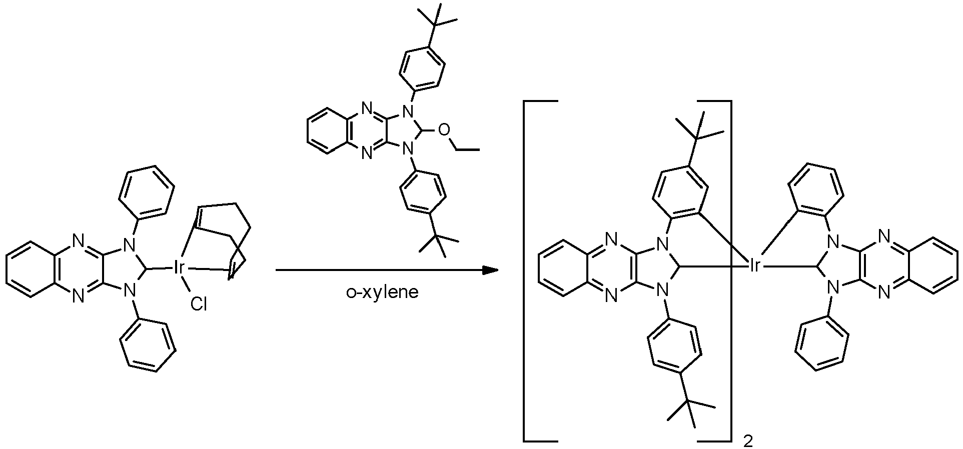

0.80 g (1.21 mmol) of complex intermediate (VIII-a) and 1.17 g (2.43 mmol) of 1,3-bis(4-*tert-*butylphenyl)-2-ethoxy-2H-imidazo[4,5-b]quinoxaline are suspended under argon in 25 ml of o-xylene. The orange suspension is three times evacuated and backfilled with argon, followed by heating at 138°C during three hours. The orange suspension is cooled down to room temperature and filtered. The filtrate is concentrated under vacuum and the resulting thick oil dissolved in dichloromethane first, followed by the addition of 30 ml of ethanol. The orange-red solution is concentrated under vacuum until a suspension is formed. The yellow suspension is filtered and the solid dried under vacuum. The solid is further purified by chromatrography (silica gel, heptane/ethyl acetate). The isolated product is dissolved in dichloromethane, followed by the addition of ethanol. The solution is concentrated under vacuum until a suspension is formed. The suspension is filtered, the solid washed with ethanol and further dried under vauum, giving the title product as a yellow solid (yield: 179 mg (11%)).

APCI-LC-MS (positive, m/z): exact mass of C₇₉H₇₁IrN₁₂ = 1380.56; found 1381.7 [M+1]⁺. ¹H-NMR (400 MHz, CD₂Cl₂): δ = 0.75 (s, 18 H), 1.08 (s, 9 H), 1.10 (s, 9 H), 6.03-7.69 (br. signals, 8 H), 6.49 (br. d, 2 H), 6.56 (d, 2 H), 6.62-6.71 (m, 3 H), 6.75 (d, 1 H), 6.89 (dt, 1 H), 7.24-7.32 (m, 3 H), 7.69-7.79 (m, 3 H), 7.79-7.95 (m, 6 H), 8.32-8.40 (m, 3 H), 8.94 (d, 1 H), 9.00 (d, 1 H), 9.15 (dd, 1 H).

### Synthesis Example 9. Synthesis of complex (IX)

### a) Synthesis of 1-methyl-2-(4-nitrophenyl)benzene

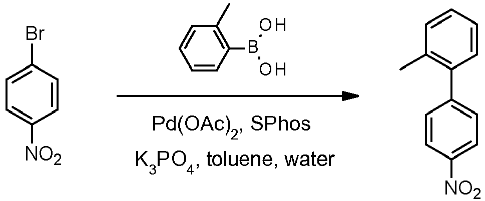

57.6 g (0.29 mol) of 1-bromo-4-nitrobenzene together with 50.0 g (0.37 mol) of o-tolylboronic acid, 161 g (0.70 mol) of potassium phosphate tribasic monohydrate, 1.72 g (4.19 mmol)) of 2-dicyclohexylphosphino-2',6'-dimethoxybiphenyl, and 314 mg (1.40 mmol) of palladium(II) acetate are suspended in 500 ml of toluene and 100 ml of water at room temperature under argon. The suspension is three times evacuated and backfilled with argon, followed by heating under reflux for two hours. The dark reaction mixture is cooled down to room temperature, diluted with toluene, and the resulting mixture two times extracted with water. The organic phase is dried over magnesium sulfate and concentrated under vacuum. The resulting solid is recrystallized from 2-propanol, giving the title product as an orange solid (yield: 39.3 g (66%)).

¹H-NMR (400 MHz, CD₂Cl₂): δ = 2.31 (s, 3 H), 7.25-7.39 (m, 4 H), 7.52-7.58 (m, 2 H), 8.27-8.33 (m, 2 H).

### b) Synthesis of 4-(o-tolyl)aniline

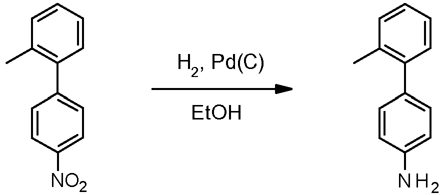

39.3 g (0.18 mol) of 1-methyl-2-(4-nitrophenyl)benzene and 2.25 g of 10 wt%-palladium on carbon in 400 ml of ethanol are reacted in a pressure reactor under 2 bar hydrogen pressure at 35°C during 5 hours. The reaction mixture is cooled down to room temperature and the reactor flooded with argon. The reaction mixture is filtered through a layer of Hyflo® filter aid and rinsed with additional ethanol, followed by drying under vacuum. The residual oil is further purified by distillation under vacuum (0.3 mbar/140°C), giving the title product as a beige solid (yield: 22.0 g (65%)).

¹H-NMR (300 MHz, CD₂Cl₂): δ = 2.35 (s, 3 H), 3.80 (br. s, 2 H), 6.75-6.82 (m, 2 H), 7.15-7.21 (m, 2 H), 7.24-7.35 (m, 4 H).

### c) Synthesis of N2,N3-bis[4-(o-tolyl)phenyl]quinoxaline-2,3-diamine

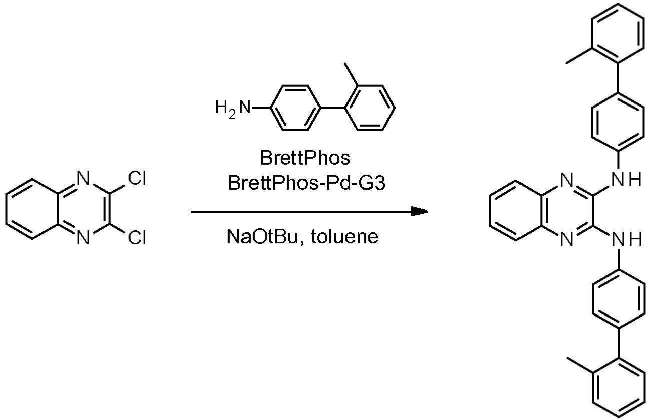

10.2 g (55.7 mmol) of 4-(o-tolyl)aniline and 6.40 g (66.6 mmol) of sodium tert-butoxide in 100 ml of toluene are three times evacuated and backfilled with argon. 135 mg (0.25 mmol) of BrettPhos ligand [= 2-(dicyclohexylphosphino)3,6-dimethoxy-2',4',6'-triisopropyl-1,1'-biphenyl, CAS No. 1070663-78-3] and 201 mg (0.25 mmol) of BrettPhos-Pd-G3 palladacycle {= [(2-dicyclohexylphosphino-3,6-dimethoxy-2',4',6'- triisopropyl-1,1'-biphenyl)-2-(2'-amino-1,1'-biphenyl)]palladium(II) methanesulfonate methanesulfonate, CAS No. 1470372-59-8} are added, followed by the addition of 5.00 g (25.1 mmol) of 2,3-dichloroquinoxaline. The suspension is heated under reflux during 4 hours, then cooled down to room temperature, and diluted with toluene and water. The water phase is separated, and the organic phase two times extracted with water. The organic phase is dried over magnesium sulfate first, then filtered, and the solution further filtered through a 4 cm layer of silica gel, followed by rinsing the silica gel layer with toluene. The combined eluents are concentrated under vacuum, and the residual resin stirred in toluene first, followed by the addition of half concentrated hydrochloric acid solution. Stirring is continued until a suspension is formed. The suspension is filtered, the solid washed with heptane, and then further suspended in a mixture of heptane and water. Concentrated aqueous sodium hydroxide solution is added until a basic pH is reached. The suspension is filtered, the solid washed with heptane, followed by drying under vacuum, giving the title product as a beige solid (yield: 1.68 g (14%)).

### d) Synthesis of [3-[4-(o-tolyl)anilino]quinoxalin-2-yl]-[4-(o-tolyl)phenyl]ammonium chloride

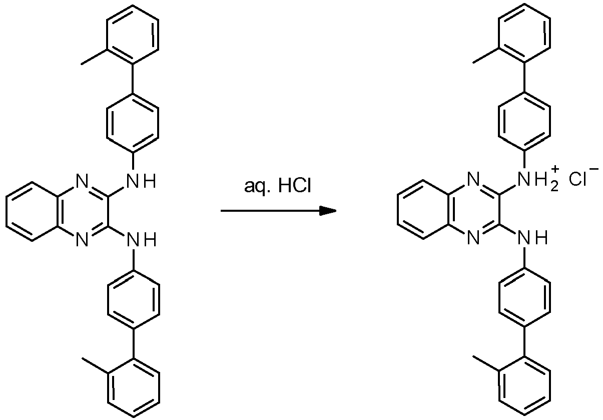

1.68 g (3.41 mmol) of N2,N3-bis[4-(o-tolyl)phenyl]quinoxaline-2,3-diamine are treated with 50 ml of concentrated aqueous hydrochloric acid and stirred at room temperature during 30 minutes. The orange suspension is carefully diluted with 50 ml of water first, then filtered, and the solid dried under vacuum, giving the title product as a yellow solid (2.3 g isolated, still including residual water).

### e) Synthesis of 2-ethoxy-1,3-bis[4-(o-tolyl)phenyl]-2H-imidazo[4,5-b]quinoxaline

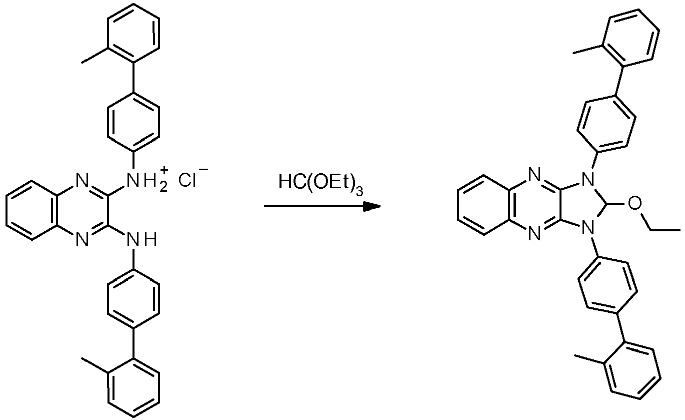

2.3 g (max. 4.3 mmol, still including residual water) of [3-[4-(o-tolyl)anilino]quinoxalin-2-yl]-[4-(o-tolyl)phenyl]ammonium chloride and 30 ml of triethyl orthoformate are heated under argon at 100°C during one hour in a reactor fitted with a Dean-Stark separator and condenser. The reaction mixture is cooled down to room temperature and concentrated under vacuum until a suspension formed. The suspension is diluted with heptane, then filtered, and the solid dissolved in dichloromethane. The solution is treated with ethanol, and concentrated under vacuum until a suspension is formed. The suspension is filtered, the solid washed with ethanol, followed by drying under vacuum, giving the title product as a yellow solid (yield: 1.70 g (minimum 71%)). ¹H-NMR (300 MHz, CD₂Cl₂): δ = 1.16 (t, 3 H), 2.40 (s, 6 H), 3.49 (q, 2 H), 7.27-7.40 (m, 8 H), 7.44-7.58 (m, 7 H), 7.77-7.85 (m, 2 H), 8.28-8.38 (m, 4 H).

### f) Synthesis of complex intermediate (IX-a)

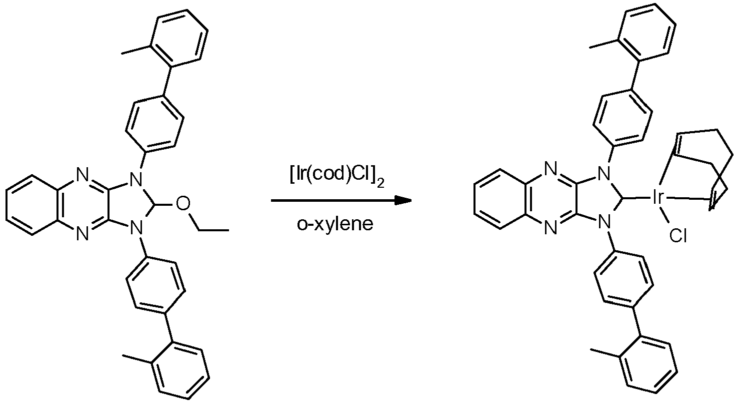

1.63 g (2.97 mmol) of 2-ethoxy-1,3-bis[4-(o-tolyl)phenyl]-2H-imidazo[4,5-b]quinoxaline are dissolved under argon in 50 ml of o-xylene. 1.06 g (1.58 mmol) of chloro(1,5-cyclooctadiene)-iridium(I) dimer are added and the resulting orange solution three times evacuated and backfilled with argon, followed by heating at 110°C during two hours. The heating bath is removed, the red solution treated with 50 ml of ethanol, followed by further cooling down to room temperature under stirring. The resulting orange suspension is further stirred during 30 minutes, then filtered, and the solid washed with 50 ml of ethanol. The solid is dissolved in dichloromethane and filtered through a 2.5 cm layer of silica gel, followed by rinsing the silica gel layer with dichloromethane. The combined eluents are diluted with 150 ml of ethanol and concentrated under vacuum until a suspension is formed. The suspension is filtered, the solid washed with ethanol, followed by drying under vacuum, giving the title product as a yellow solid (yield: 0.95 g (38%)).

¹H-NMR (400 MHz, CD₂Cl₂): δ = 1.44-1.56 (m, 2 H), 1.57-1.76 (m, 4 H), 1.81-1.96 (m, 2 H), 2.47 (s, 6 H), 2.69-2.77 (m, 2 H), 4.75-4.85 (m, 2 H), 7.33-7.48 (m, 8 H), 7.64-7.72 (m, 4 H), 7.81-7.88 (m, 2 H), 8.15-8.22 (m, 2 H), 8.31-8.38 (m, 4 H).

### g) Synthesis of complex (IX)

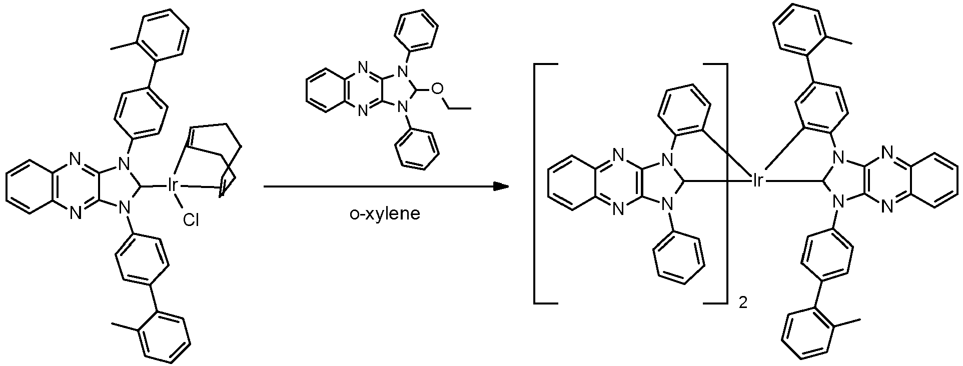

0.95 g (1.13 mmol) of complex intermediate (IX-a) and 1.67 g (4.53 mmol) of 2-ethoxy-1,3-diphenyl-2H-imidazo[4,5-b]quinoxaline are suspended under argon in 50 ml of o-xylene. The yellow suspension is three times evacuated and backfilled with argon, followed by heating at 124°C during two hours. The orange suspension is cooled down to room temperature, then concentrated under vacuum, and further purified by chromatography (silica gel, toluene/dichloromethane). The pure product fractions are concentrated under vacuum, and the resulting solid dissolved in dichloromethane, followed by the addition of ethanol. The solution is concentrated under vacuum until a suspension is formed. The suspension is filtered, the solid washed with ethanol, followed by drying under vacuum, giving 0.7 g product. The solid is heated in 30 ml of DMF during one hour at 130°C first, then at room temperature during 30 minutes. The resulting suspension is filtered, the solid two times washed with ethanol, followed by drying under vacuum, giving the title product as a yellow solid (yield: 0.5 g (33%)).

APCI-LC-MS (positive, m/z): exact mass of C₇₇H₅₁IrN₁₂ = 1336.40; found 1337.5 [M+1]⁺. ¹H-NMR (400 MHz, CD₂Cl₂): δ = 1.97 (s, 3 H), 2.04 (s, 3 H), 6.05 (d, 1 H), 6.16-8.04 (br. signal, 12 H), 6.58-6.70 (m, 4 H), 6.72 (d, 1 H), 6.79-6.89 (m, 2 H), 6.90-6.96 (m, 1 H), 6.99-7.07 (m, 2 H), 7.09-7.15 (m, 3 H), 7.15-7.39 (m, 4 H), 7.65-7.94 (m, 8 H), 7.99 (dd, 1 H), 8.27 (dd, 1 H), 8.34 (dd, 1 H), 8.39 (dd, 1 H), 9.03 (dd, 1 H), 9.11-9.17 (m, 2 H).

### Synthesis Example 10. Synthesis of complex (X)

### a) Synthesis of N2,N3-bis(m-tolyl)quinoxaline-2,3-diamine

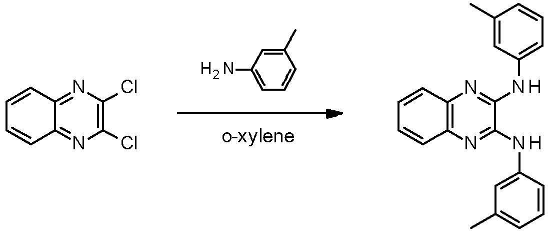

10.0 g (50.2 mmol) of 2,3-dichloroquinoxaline and 12.0 g (0.11 mol) of m-toluidine in 70 ml of o-xylene are heated at 143°C during one hour. The reaction mixture is cooled down to room temperature and treated with a small amount of 25% aqueous ammonia solution. The mixture is two times extracted with 500 ml of water, and the organic phase dried over magnesium sulfate and concentrated under vacuum. The dark brown oil is stirred at room temperature in 250 ml of heptane, and heated up to 40°C. The resulting suspension is stirred over an ice-bath during 15 minutes. The beige suspension is filtered and the solid dissolved in 300 ml of toluene, then treated with 10 ml of concentrated aqueous hydrochloric acid, and stirred at room temperature during 15 minutes. The suspension is filtered, the resulting solid washed with toluene first, followed by stirring in 250 ml of heptane and 50 ml of water. 30 g of a 33% aqueous sodium hydroxide solution are added and the mixture stirred during one hour. The resulting suspension is filtered, the solid washed with heptane, followed by drying under vacuum, giving the title product as a light yellow solid (yield: 5.07 g (30%)).

¹H-NMR (400 MHz, d₆-DMSO): δ = 2.36 (s, 6 H), 6.90 (d, 2 H), 7.28 (t, 2 H), 7.34 (dd, 2 H), 7.54 (dd, 2 H), 7.74 (s, 2 H), 7.81 (d, 2 H), 9.16 (br. s, 2 H).

### b) Synthesis of [3-(3-methylanilino)quinoxalin-2-yl]-(m-tolyl)ammonium chloride

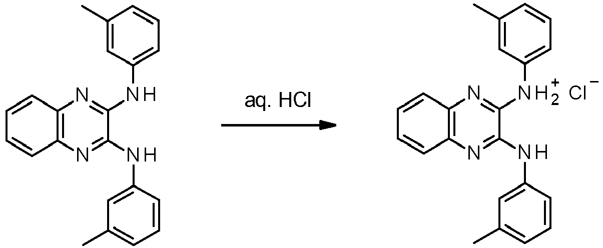

5.07 g (14.9 mmol) of [3-(3-methylanilino)quinoxalin-2-yl]-(m-tolyl)ammonium chloride are treated with 25 ml of concentrated aqueous hydrochloric acid and stirred at room temperature during 20 minutes. 50 ml of water are added and the suspension stirred during 10 minutes. The yellow suspension is filtered, the solid washed with a small amount of water, followed by drying under vacuum, giving the title compound as a yellow solid (4.57 g isolated, still including residual water).

¹H-NMR (400 MHz, d₆-DMSO): δ = 2.37 (s, 6 H), 7.01 (d, 2 H), 7.33 (t, 2 H), 7.37 (dd, 2 H), 7.61 (dd, 2 H), 7.72-7.85 (m, 4 H), 10.41 (br. s, 2 H).

### c) Synthesis of 2-ethoxy-1,3-bis(m-tolyl)-2H-imidazo[4,5-b]quinoxaline

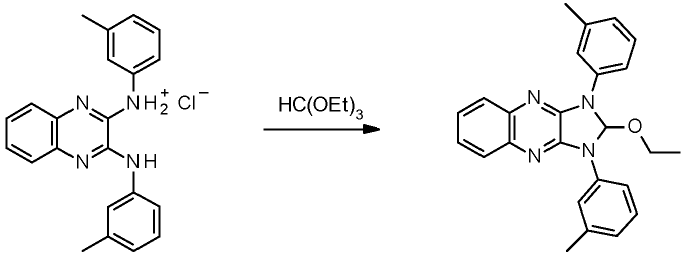

4.57 g (max. 14.9 mmol, still including residual water) of [3-(3-methylanilino)quinoxalin-2-yl]-(m-tolyl)ammonium chloride and 75 ml of triethyl orthoformate are heated under argon at 105°C during one hour in a reactor fitted with a Dean-Stark separator and condenser. The resulting solution is treated with a small amount of active charcoal first, and then cooled down under stirring until 40°C are reached, followed by filtration over a 4 cm silica gel layer. The silica gel layer is rinsed with a small amount of ethanol and the combined eluents concentrated under vacuum. The resulting oil is stirred at room temperature in 50 ml of heptane until a solid is precipitating. The resulting suspension is filtered, the solid washed with heptane, followed by drying under vacuum, giving the title product as a white solid (yield: 3.74 g (78%)).

¹H-NMR (300 MHz, d₆-DMSO): δ = 0.89 (t, 3 H), 2.42 (s, 6 H), 3.25 (q, 2 H), 7.09 (d, 2 H), 7.34-7.48 (m, 4 H), 7.60-7.70 (m, 2 H), 7.83 (s, 1 H), 7.92-8.06 (m, 4 H).

### d) Synthesis of complex (X)

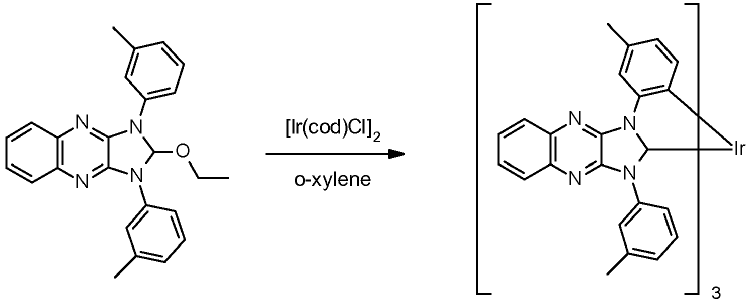

75 ml of o-xylene are three times evacuated and backfilled with argon and heated up to 130°C. 0.52 g (0.77 mmol) of chloro(1,5-cyclooctadiene)iridium(I) dimer are added first and the orange suspension stirred during 5 minutes, followed by the addition of 3.03 g (7.46 mmol) of 2-ethoxy-1,3-bis(m-tolyl)-2H-imidazo[4,5-b]quinoxaline. The suspension is heated under reflux during 17 hours, then cooled down to 80°C, and poured into 300 ml of ethanol. The wine-red suspension is further cooled down to room temperature, and stirring continued for one hour. The suspension is filtered, and the solid washed with ethanol. The solid is dissolved in 600 ml of dichloromethane, followed by the addition of 200 ml of ethyl acetate, and concentration under vacuum until a suspension is formed. The suspension is further stirred at room temperature during 30 minutes, followed by filtration. The solid is washed with ethanol, followed by drying under vacuum, giving the title product as a yellow solid (0.91 g (47%)).

APCI-LC-MS (positive, m/z): exact mass of C₆₉H₅₁IrN₁₂ = 1240.40; found 1241.5 [M+1]⁺.

### Synthesis Example 11. Synthesis of complex (XI)

### a) Synthesis of [3-(3-ethylanilino)quinoxalin-2-yl]-(3-ethylphenyl)ammonium chloride

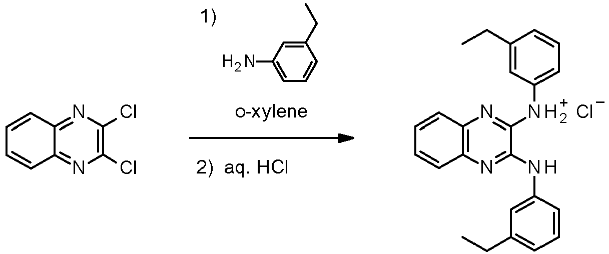

3.05 g (15.3 mmol) of 2,3-dichloroquinoxaline and 4.10 g (33.8 mmol) of 3-ethylaniline in 25 ml of o-xylene are heated at 122°C during two hours. The resulting yellow thick suspension is cooled down to room temperature and treated with 100 ml of heptane. The mixture is further stirred under heating, then cooled down to room temperature and treated with 50 ml of 25% aqueous ammonia solution first, followed by the addition of 300 ml of water together with 50 ml of heptane and 50 ml of toluene, and further stirred at room temperature for 30 minutes. The organic phase is three times washed with 200 ml of water and treated with 30 ml of concentrated hydrochloric acid. The suspension is filtered, the solid washed with heptane, followed by washing with a 4:1-mixture of water and ethanol. The solid is further dried under vacuum, giving the title product as a slightly yellow solid (5.9 g isolated, still including residual water).

¹H-NMR (300 MHz, d₆-DMSO): δ = 1.25 (t, 6 H), 2.67 (q, 4 H), 6.97-7.05 (m, 2 H), 7.29-7.43 (m, 4 H), 7.54-7.63 (m, 2 H), 7.74-7.86 (m, 4 H), 10.12 (br. s, 2 H).

### b) Synthesis of 2-ethoxy-1,3-bis(3-ethylphenyl)-2H-imidazo[4,5-b]quinoxaline

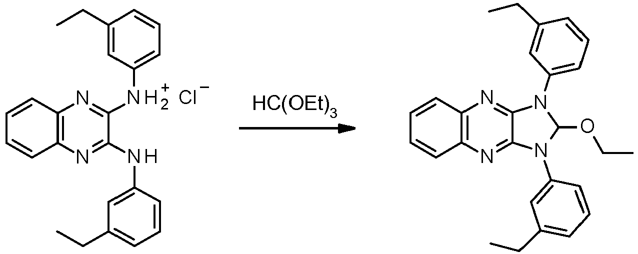

A yellow suspension of 5.9 g (max. 14.6 mmol, still including residual water) of [3-(3-ethylanilino)quinoxalin-2-yl]-(3-ethylphenyl)ammonium chloride and 50 g (0.34 mol) of triethyl orthoformate is heated in a reactor fitted with a Dean-Stark separator and condenser under argon at 80°C during two hours first, and at 100°C during one hour. The reaction solution is concentrated under vacuum. The residual oil is stirred together with 25 ml of heptane during 10 minutes. The resulting suspension is filtered, the solid washed with a small amount of heptane, followed by drying under vacuum, giving the title product as a blueish-white solid (yield: 3.54 g (min. 57%)).

¹H-NMR (400 MHz, d₆-DMSO): δ = 0.90 (t, 3 H), 1.27 (t, 6 H), 2.27 (q, 4 H), 3.27 (q, 2 H), 7.09-7.17 (m, 2 H), 7.35-7.48 (2 m, 4 H), 7.60-7.67 (m, 2 H), 7.85 (s, 1 H), 7.97-8.06 (m, 4 H).

### c) Synthesis of complex (XI)

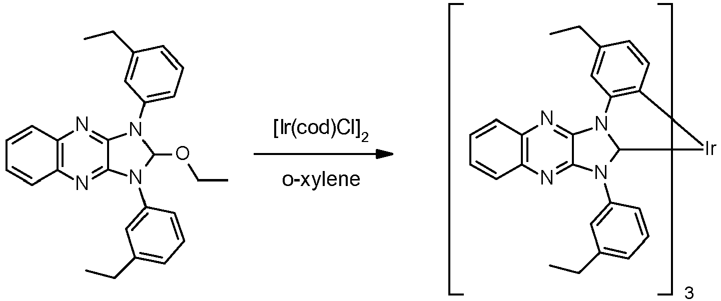

50 ml of o-xylene are three times evacuated and backfilled with argon and heated up to 132°C. A slightly turbid orange solution of 2.95 g (6.95 mmol) of 2-ethoxy-1,3-bis(3-ethylphenyl)-2H-imidazo[4,5-b]quinoxaline and 0.59 g (0.88 mmol) of chloro(1,5-cyclooctadiene)iridium(I) dimer is added, using an additional portion of pre-heated o-xylene (total 20 ml) for rinsing the flask for complete transfer of the reagents. The resulting dark red solution is heated at 143°C during 17 hours. The dark reaction solution is cooled down to 110°C and poured onto 300 ml of ethanol. The red suspension is stirred until a temperature of 32°C is reached. The suspension is filtered, the solid washed with ethanol, followed by drying under vacuum. The solid is dissolved in dichloromethane and filtered through a 4 cm layer of silica gel, followed by rinsing the silica gel layer with dichloromethane and a mixture of dichloromethane/ethanol. The combined fractions are diluted with 100 ml of ethanol and concentrated under vacuum, until a suspension formed. The suspension is further stirred at room temperature, then filtered, the solid washed with ethanol, followed by drying under vacuum, giving the title product as a yellow solid (yield: 1.42 g (61%)).

APCI-LC-MS (positive, m/z): exact mass of C₇₅H₆₃IrN₁₂ = 1324.49; found 1325.5 [M+1]⁺. ¹H-NMR (400 MHz, CD₂Cl₂): δ = 0.65-1.40 (br. signal, 9 H), 1.36 (t, 9 H), 1.89-2.91 (br. signal, 6 H), 2.67-2.87 (m, 6 H), 5.98-7.67 (br. signal, 12 H), 6.55 (d, 3 H), 6.71 (d, 3 H), 7.75 (t, 3 H), 7.84 (t, 3 H), 7.92 (d, 3 H), 8.34 (d, 3 H), 8.89 (br. s, 3 H).

### Synthesis Example 12. Synthesis of complex (XII)

### a) Synthesis of N2,N3-bis(3,4-dimethylphenyl)quinoxaline-2,3-diamine

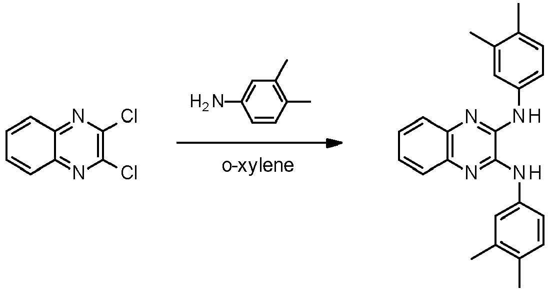

20.0 g (0.10 mol) of 2,3-dichloroquinoxaline and 28.0 g (0.23 mol) 3,4-dimethylaniline in 400 ml of o-xylene are heated at 140°C during 23 hours. 28.0 g of 3,4-dimethylaniline are added and heating continued at the same temperature during 19 hours. The yellow suspension is cooled down to room temperature and diluted with 200 ml of heptane. The suspension is filtered and the solid stirred in 500 ml of heptane, followed by filtration. The solid is stirred in 500 ml of water together with 100 ml of 25% aqueous ammonia solution and 250 ml heptane. The suspension is filtered, followed by stirring the solid in 500 ml of heptane, and then by stirring the solid in methanol (2x 500 ml). The suspension is filtered, the solid dried under vacuum giving the title product as a light yellow solid (yield: 36.6 g (99%)).

¹H-NMR (400 MHz, d₆-DMSO): δ = 2.26 (s, 6 H), 2.28 (s, 6 H), 7.21 (d, 2 H), 7.31-7.39 (m, 2 H), 7.55-7.62 (m, 2 H), 7.62-7.72 (m, 4 H), 10.22 (br. s, 2 H).

### b) Synthesis of [3-(3,4-dimethylanilino)quinoxalin-2-yl]-(3,4-dimethylphenyl)ammonium chloride

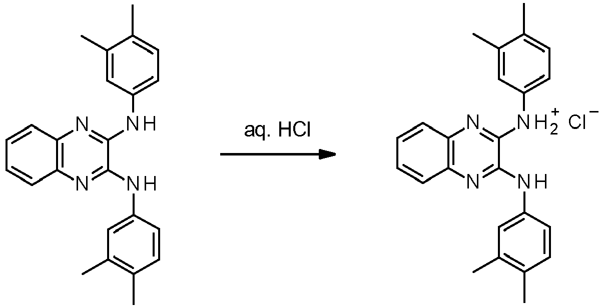

36.6 g (0.10 mol) of N2,N3-bis(3,4-dimethylphenyl)quinoxaline-2,3-diamine are added in several portions to 350 ml of concentrated hydrochloric acid and stirred at room temperature during one hour. The reaction mixture is filtered and the solid dried under vacuum, followed by two times stirring in cyclohexane. The suspension is filtered, followed by drying the solid under vacuum, giving the title product as a light yellow solid (41.9 g isolated, sill including residual water). ¹H-NMR (400 MHz, d₆-DMSO): δ = 2.27 (s, 6 H), 2.28 (s, 6 H), 7.25 (d, 2 H), 7.34-7.43 (m, 2 H), 7.58-7.73 (m, 6 H), 11.42 (br. s, 2 H).

### c) Synthesis of 1,3-bis(3,4-dimethylphenyl)-2-ethoxy-2H-imidazo[4,5-b]quinoxaline

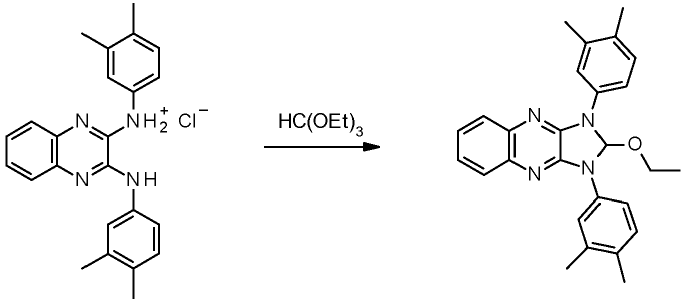

40.2 g (max. 0.1 mol, still including residual water) of [3-(3,4-dimethylanilino)quinoxalin-2-yl]-(3,4-dimethylphenyl)ammonium chloride and 350 ml of triethyl orthoformate are heated under argon at 95°C during 30 minutes in a reactor fitted with a Dean-Stark separator and condenser. The reaction mixture is cooled down to room temperature and treated with 1.2 g of active charcoal, followed by stirring at 110°C during 30 minutes. The mixture is cooled down and filtered over a 3 cm layer of Hyflo® filter aid, followed by rinsing the filter aid with 150 ml of ethanol. After short time precipitation of a solid is starting in the combined filtrates, providing a white suspension. The suspension is stirred at room temperature during 30 minutes, followed by filtration, and rinsing the solid with 50 ml of ethanol. The solid is further dried under vacuum, and then mixed with 250 ml of cyclohexane and 150 ml of dichloromethane. The suspension is heated up to 50°C and the resulting light yellow solution concentrated under vacuum until most of dichloromethane is evaporated off. The residual solution is cooled down to room temperature and the resulting suspension filtered. The solid is washed with a small amount of cyclohexane, followed by drying under vacuum, giving the title compound as a white solid (yield: 36.2 g (min. 86%)).

¹H-NMR (400 MHz, d₆-DMSO): δ = 0.89 (t, 3 H), 2.28 (s, 6 H), 2.33 (s, 6 H), 3.25 (q, 2 H), 7.29 (d, 2 H), 7.36 (m, 2 H), 7.61 (m, 2 H), 7.78 (s, 1 H), 7.83-7.93 (m, 4 H).

### d) Synthesis of complex (XII)

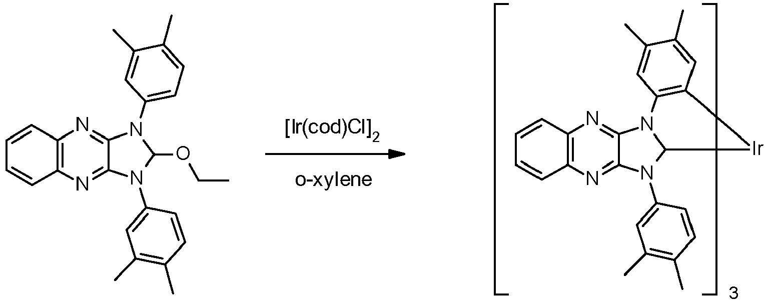

75 ml of o-xylene are three times evacuated and backfilled with argon and heated up to 135°C. A slightly turbid orange solution of 6.00 g (14.1 mmol) of 1,3-bis(3,4-dimethylphenyl)-2-ethoxy-2H-imidazo[4,5-b]quinoxaline and 1.19 g (1.77 mmol) of chloro(1,5-cyclooctadiene)iridium(I) dimer is added, using an additional portion of pre-heated o-xylene (total 20 ml) for rinsing the flask for complete transfer of the reagents. The resulting reaction mixture is heated at 132°C during 17 hours. The dark reaction solution is cooled down to 120°C and poured onto 1.2 L of ethanol. The orange-yellow suspension is stirred until 35°C are reached. The yellow suspension is filtered and the solid washed with ethanol. The solid is suspended in 200 ml of ethanol and heated under reflux during one hour. The suspension is cooled down to room temperature and filtered, the solid washed with ethanol, followed by drying. The solid is suspended in toluene and heated under reflux. The solution is cooled down to 9°C and the solid filtered off, and washed with a small amount of toluene. The solid is further purified by chromatography (silica gel, dichloromethane/heptane), giving the title product as a yellow solid (yield: 1.78 g (38%)). APCI-LC-MS (positive, m/z): exact mass of C₇₅H₆₃IrN₁₂ = 1324.49; found 1325.5 [M+1]⁺. ¹H-NMR (400 MHz, CD₂Cl₂): δ = 1.25 (br. s, 9 H), 1.48-2.36 (br. signal, 9 H), 2.05 (s, 9 H), 2.41 (s, 9 H), 5.84-7.67 (br. signal, 12 H), 7.67-7.98 (m, 9 H), 8.35 (d, 3 H), 8.78 (s, 3 H).

### Synthesis Example 13. Synthesis of complex (XIII)

### a) Synthesis of N2,N3-bis(4-tert-butylphenyl)pyrazine-2,3-diamine

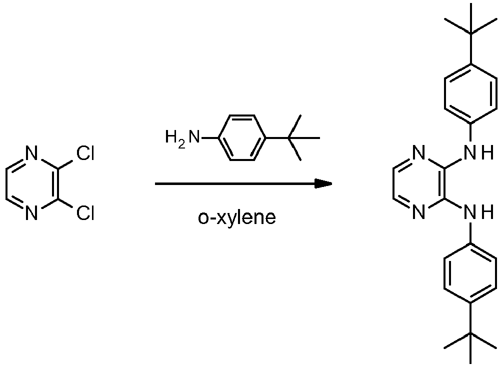

71.3 g 4-*tert*-butyl aniline (0.47 mol) are added to a solution of 2,3-dichloropyrazine (32.3 g; 0.21 mol) in 200 ml o-xylene. The red solution is heated to 150°C over 1.25 hours and stirred at that temperature overnight. The mixture turns to a brownish yellow suspension. After cooling to room temperature, the yellow solid is filtered and washed with successive portions of heptane, aqueous saturated sodium bicarbonate, and ethanol. The product is dried under vacuum at 60°C to give the title product as a bright yellow solid (yield: 52.5 g (66%)).

¹H-NMR (300 MHz, d₆-DMSO): δ = 8.91 (br.s, 2H), 7.59 (m, 4H), 7.48 (s, 2H) 7.36 (m, 4H), 1.29 (s, 18H).

### b) Synthesis of 1,3-bis(4-tert-butylphenyl)-2-ethoxy-2H-imidazo[4,5-b]pyrazine

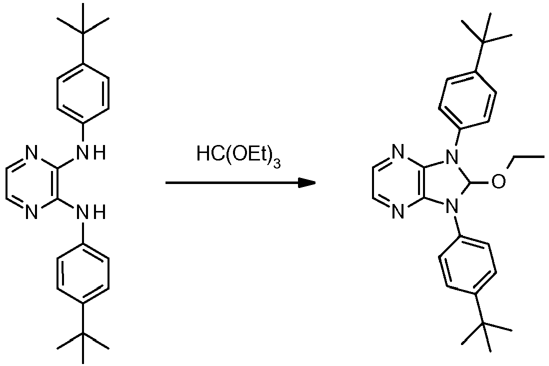

17.1 g (45.7 mmol) of N2,N3-bis(4-*tert*-butylphenyl)pyrazine-2,3-diamine and 67.7 g (0.46 mol) of triethylothoformate are heated in a 3-necked flask fitted with a Dean-Stark separator and condenser to 130°C (bath temperature). Distillation of a ethanol/triethylorthoformate mixture starts at ca. 105°C internal temperature. After 105 minutes (int. temperature 120°C), distillation ceases and the suspension is filtered at ca. 80°C in order to remove some residual solid. The filtrate is concentrated under vacuum to give 17 g of pink crude product, which is recrystallized from 35 g heptane to give the title compound as a light pinkish solid (yield: 13.0 g (66%)).

¹H-NMR (400 MHz, CDCl₃): δ = 7.94-7.89 (m, 4H), 7.52 (s, 2H), 7.51-7.47 (m, 4H), 7.21 (s, 1H), 3.38 (q, *J* = 7.0 Hz, 2H), 1.37 (s, 18H), 1.13 (t, *J* = 7.0 Hz, 3H).

### c) Synthesis of complex intermediate (XIII-a)

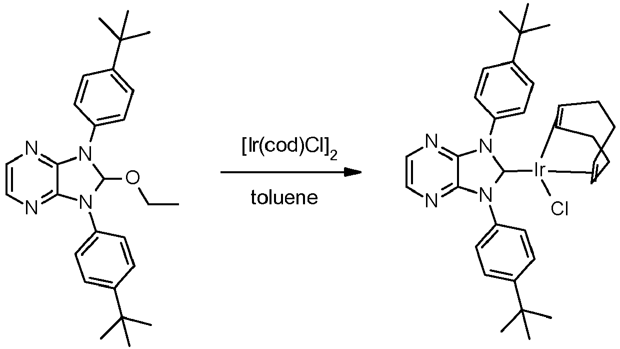

3.90 g (5.81 mmol) of chloro(1,5-cyclooctadiene)iridium(I) dimer are suspended in 70 ml of toluene and three times evacuated and backfilled with argon, and heated up to 73°C. A solution of 5.00 g (11.6 mmol) of 1,3-bis(4-*tert*-butylphenyl)-2-ethoxy-2H-imidazo[4,5-b]pyrazine in 70 ml of toluene is added within 45 minutes and the resulting greenish-brown solution heated at 74°C during 17 hours. The warm reaction mixture is filtered, the solid washed with toluene and heptane, followed by drying under vacuum, giving the title product as a brownish-yellow solid (yield: 6.83 g (82%)).

¹H-NMR (400 MHz, CDCl₃): δ = 1.25-1.49 (2 m, 4 H), 1.44 (s, 18 H), 1.49-1.62 (m, 2 H), 1.67-1.81 (m, 2 H), 2.45-2.55 (m, 2 H), 4.63-4.74 (m, 2 H), 7.65 (d, 4 H), 8.07 (d, 4 H), 8.32 (s, 2 H).

### d) Synthesis of complex (XIII)

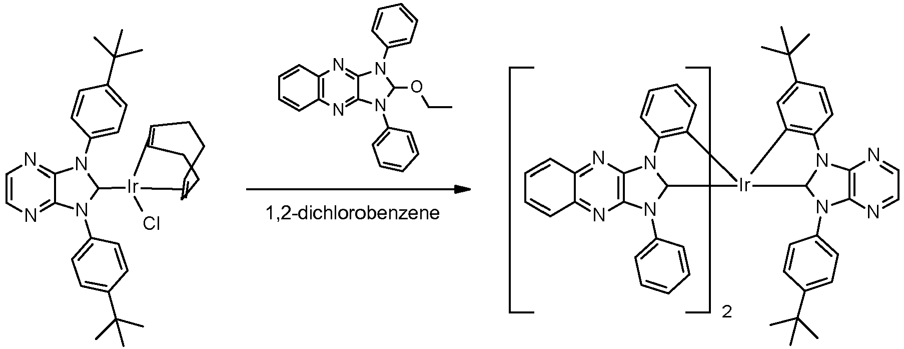

2.00 g (2.78 mmol) of complex intermediate (XIII-a) and 2.05 g (5.56 mmol) of 2-ethoxy-1,3-diphenyl-2H-imidazo[4,5-b]quinoxaline are suspended under argon in 40 ml of 1,2-dichlorobenzene. The yellow suspension is three times evacuated and backfilled with argon, followed by heating at 116°C during seven hours. The dark solution is cooled down to room temperature, diluted with 100 ml of heptane and filtered. The solid is washed with ethanol. The combined filtrates are concentrated under vacuum and the residue subjected to further purification by chromatography (silica gel, dichloromethane/heptane), giving the title product as a yellow solid (yield: 0.64 g (19%)).

APCI-LC-MS (positive, m/z): exact mass of C₆₇H₅₃IrN₁₂ = 1218.41; found 1219.5 [M+1]⁺. ¹H-NMR (400 MHz, CD₂Cl₂): δ = 0.69 (s, 9 H), 1.06 (s, 9 H), 5.99-7.99 (br. signal, 10 H), 6.54 (br. d, 2 H), 6.61-6.69 (m, 2 H), 6.69-6.75 (m, 2 H), 6.85-6.97 (m, 3 H), 7.18-7.33 (m, 3 H), 7.69-7.78 (m, 2 H), 7.79-7.87 (m, 2 H), 7.87-7.93 (m, 1 H), 8.11 (d, 1 H), 8.31-8.37 (m, 2 H), 8.38 (d, 1 H), 8.67 (d, 1 H), 9.08 (d, 1 H), 9.15 (d, 1 H).

### Synthesis Example 14. Synthesis of complex (XIV)

### a) Synthesis of [3-(3-ethylanilino)pyrazin-2-yl]-(3-ethylphenyl)ammonium chloride

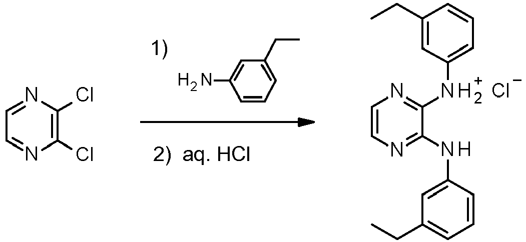

13.3 g (8.93 mmol) of 2,3-dichloropyrazine and 25 ml (0.2 mol) of 3-ethylaniline in 30 ml of o-xylene are heated under reflux during 20 hours. The dark reaction mixture is cooled down to room temperature and poured onto 300 ml of 10% aqueous hydrochloric acid solution, followed by the addition of 200 ml of heptane, and stirring for one hour. The suspension is filtered and the solid washed with water and heptane, followed by drying under vacuum. The solid is suspended in 1 L of 10% aqueous sodium hydroxide and 1 L of heptane, followed by stirring during 30 minutes and filtration. The solid is washed with water and heptane, and then stirred in 500 ml of 10% aqueous hydrochloric acid and 400 ml of heptane during 30 minutes. The suspension is filtered and the solid washed with water and further dried under vacuum giving the title product as a white solid (28.5 g isolated, still including residual water).

¹H-NMR (400 MHz, d₆-DMSO): δ = 1.21 (t, 6 H), 2.62 (q, 4 H), 6.95 (d, 2 H), 7.28 (t, 2 H), 7.49 (s, 2 H), 7.53 (s, 2 H), 7.58 (d, 2 H), 9.68 (br. s, 2 H).

### b) Synthesis of 2-ethoxy-1,3-bis(3-ethylphenyl)-2H-imidazo[4,5-b]pyrazine

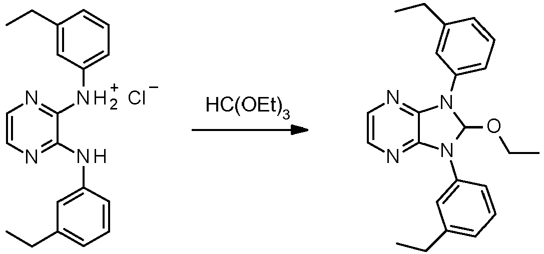

27.0 g (max. 76 mmol, still including residual water) of [3-(3-ethylanilino)pyrazin-2-yl]-(3-ethylphenyl)ammonium chloride and 200 ml (1.2 mol) of triethyl orthoformate are heated under argon at 130°C during five hours in a reactor fitted with a Dean-Stark separator and condenser. The reaction solution is concentrated under vauum and dried, giving the title compound as a yellowish solid (yield: 22.2 g (78%)).

¹H-NMR (400 MHz, d₆-DMSO): δ = 0.90 (t, 3 H), 1.23 (t, 6 H), 2.66 (q, 4 H), 3.18 (q, 2 H), 7.03 (d, 2 H), 7.36 (t, 2 H), 7.51 (s, 2 H), 7.72 (s, 1 H), 7.84-7.94 (m, 4 H).

### c) Synthesis of complex intermediate (XIV-a)

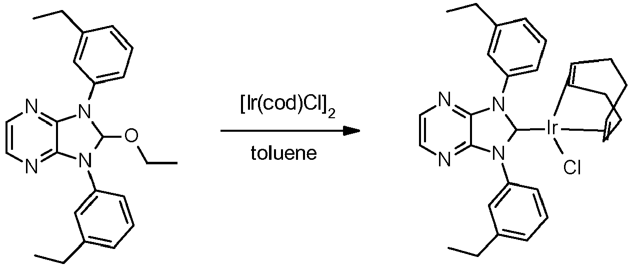

3.68 g (5.48 mmol) of chloro(1,5-cyclooctadiene)iridium(I) dimer are suspended in 50 ml of toluene and three times evacuated and backfilled with argon, and heated up to 73°C. A solution of 4.10 g (10.9 mmol) of 2-ethoxy-1,3-bis(3-ethylphenyl)-2H-imidazo[4,5-b]pyrazine in 50 ml of toluene is slowly added and the resulting greenish-brown solution heated at 74°C during one hour. The orange-brown slightly turbid solution is filtered and the filtrate diluted with 100 ml of ethanol and cooled down using an ice-bath. The resulting suspension is filtered and the solid washed with ethanol and heptane, followed by drying under vacuum, giving the title product as a yellow solid (yield: 4.10 g (56%)).

¹H-NMR (400 MHz, CD₂Cl₂): δ = 1.28-1.66 (m, 6 H), 1.40 (t, 6 H), 1.69-1.87 (m, 2 H), 2.54-2.64 (m, 2 H), 2.78-2.93 (m, 4 H), 4.56-4.67 (m, 2 H), 7.42-7.49 (m, 2 H), 7.55 (t, 2 H), 7.79-7.87 (m, 2 H), 8.16-8.22 (m, 2 H), 8.32 (s, 2 H).

### d) Synthesis of complex (XIV)

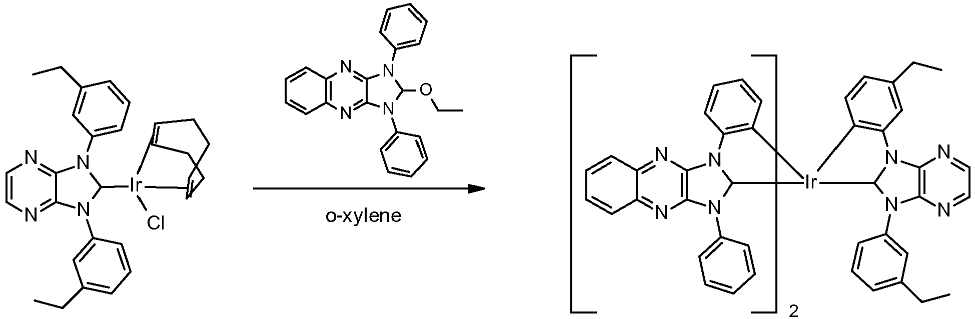

2.00 g (3.0 mmol) of complex intermediate (XIV-a) and 2.18 g (6.0 mmol) of the 2-ethoxy-1,3-diphenyl-2H-imidazo[4,5-b]quinoxaline are suspended in 100 ml of o-xylene, and heated at 144°C during 18 hours. The dark solution is cooled down to room temperature, diluted with 150 ml of ethanol, and further cooled down with an ice-bath. The suspension is filtered, the solid washed with ethanol, followed by drying under vacuum. The solid is dissolved in 1 L of dichloromethane and the solution filtered through a 4 cm layer of silica gel, followed by rinsing the silica gel layer with 500 ml of dichloromethane. The combined fractions are mixed with 50 ml of ethanol and the solution concentrated under vacuum until a solid formed. The solid is filtered off and dissolved in 1 L of dichloromethane, then filtered and the filtrate treated with 50 ml of ethyl acetate. The solution is concentrated under vacuum to a volume of 250 ml, and the resulting suspension filtered. The solid is washed with ethyl acetate and dried under vacuum, giving the title product as a yellow solid (yield: 0.36 g (10%)).

APCI-LC-MS (positive, m/z): exact mass of C₆₃H₄₅IrN₁₂ = 1162.35; found 1163.5 [M+1]⁺. ¹H-NMR (400 MHz, CD₂Cl₂): δ = 1.22-1.36 (m, 6 H), 2.73 (q, 4 H), 6.00-7.98 (br. signal, 12 H), 6.55 (d, 1 H), 6.58-6.66 (m, 1 H), 6.66-6.76 (m, 3 H), 6.81-6.96 (m, 3 H), 7.21-7.32 (m, 2 H), 7.77-7.80 (m, 2 H), 7.80-7.95 (m, 4 H), 8.11 (d, 1 H), 8.26-8.42 (m, 3 H), 8.70 (s, 1 H), 9.01-9.12 (m, 2 H).

### Synthesis Example 15. Synthesis of complex (XV)

### a) Synthesis of N2,N3-bis(m-tolyl)pyrazine-2,3-diamine

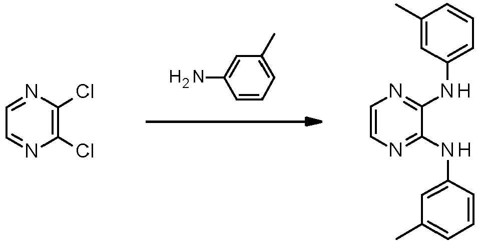

A solution of 13.8 g 2,3-dichloropyrazine (92.6 mmol) in 100 g m-toluidine (0.93 mol) is heated at 140°C for five hours. The mixture is allowed to cool to 50°C and diluted with 150 ml methanol. It is further cooled in an ice bath whereby products starts to precipitate. After stirring at room temperature overnight, the mixture is cooled again to 10°C and the light beige suspension is filtered. The crude product is resuspended in 100 ml cold methanol, filtered, and dried under vacuum to give the title product as a light beige solid (yield: 19.2 g (71.6%)).

¹H-NMR (300 MHz, d₆-DMSO): δ = 8.93 (bs, 2H), 7.71-7.41 (m, 6H), 7.27-7.09 (m, 2H), 6.88-6.72 (m, 2H), 2.30 (s, 6H).

### b) Synthesis of [3-(3-methylanilino)pyrazin-2-yl]-(m-tolyl)ammonium chloride

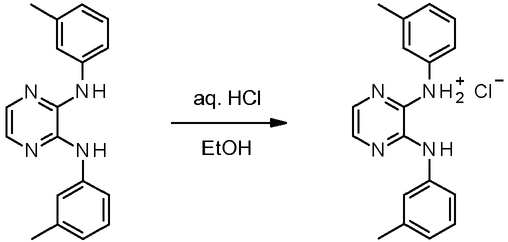

A yellow suspension of 19 g (65 mmol) of N2,N3-bis(m-tolyl)pyrazine-2,3-diamine in 400 ml of ethanol and 128 g of 37% hydrochloric acid is stirred at room temperature overnight. The product is filtered, washed with heptane (3x100 ml), and dried under vacuum. The product is obtained as a yellow solid (17.9 g isolated, still including residual water).

¹H-NMR (300 MHz, d₆-DMSO): δ = 10.07 (bs, 2H), 7.69 - 7.52 (m, 4H), 7.48 (s, 2H), 7.31 - 7.14 (m, 2H), 6.91 (dt, *J* = 6.8, 1.2 Hz, 2H), 6.7 (bs, 1H), 2.32 (s, 6H).

### c) Synthesis of 2-ethoxy-1,3-bis(m-tolyl)-2H-imidazo[4,5-b]pyrazine

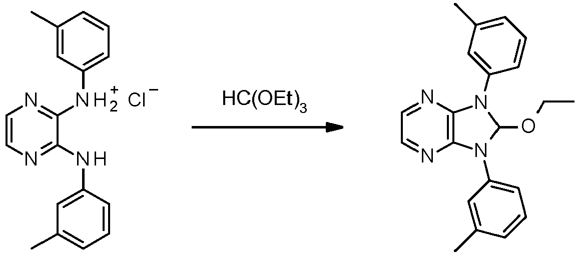

17.8 g of [3-(3-methylanilino)pyrazin-2-yl]-(m-tolyl)ammonium chloride (max. 55 mmol, still including residual water) are suspended in 207 g triethyl orthoformate (1.36 mol) are heated at 110°C for six hours in a reactor fitted with a Dean-Stark separator and condenser. 14 ml of ethanol and triethylorthoformate are separated during the reaction time. The reaction mixture is cooled, filtered, and the orange filtrate is concentrated under vacuum. The crude product is washed with ethanol and heptane, filtered, purified by resuspension in ethanol (3x), and dried under vacuum. The title compound is obtained as a salmon pink powder (yield: 10.8 g (57%)). ¹H-NMR (300 MHz, d₆-DMSO): δ = 7.89 (m, 2H), 7.85 (m, 2H), 7.75 (s, 1H), 7.52 (s, 2H), 7.36 (t, 2H), 7.02 (m, 2H), 3.18 (q, *J* = 7.0 Hz, 2H), 2.38 (s, 6H), 0.91 (t, *J* = 7.0 Hz, 3H).

### d) Synthesis of complex intermediate (XV-a)

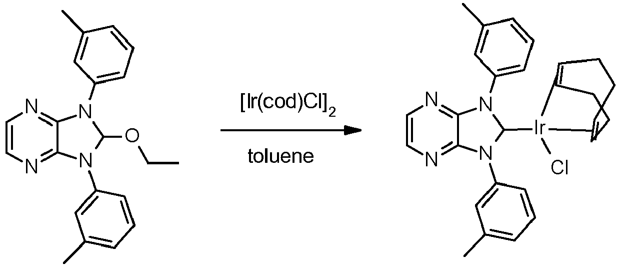

3.00 g (4.47 mmol) of chloro(1,5-cyclooctadiene)iridium(I) dimer and 3.09 g (8.92 mmol) of 2-ethoxy-1,3-bis(m-tolyl)-2H-imidazo[4,5-b]pyrazine are dissolved in 50 ml of toluene. The dark solution is three times evacuated and backfilled with argon, and heated at 75°C during two hours. The reaction mixture is cooled down to room temperature and diluted with 100 ml of ethanol. The resulting suspension is filtered, the solid washed with ethanol and heptane, followed by drying under vacuum, giving the title product as a yellow solid (yield: 3.88 g (68%)).

¹H-NMR (400 MHz, CD₂Cl₂): δ = 1.33-1.45 (m, 2 H), 1.47-1.66 (m, 4 H), 1.75-1.88 (m, 2 H), 2.55 (s, 6 H), 2.58-2.65 (m, 2 H), 4.59-4.67 (m, 2 H), 7.43 (d, 2 H), 7.53 (t, 2 H), 7.92 (d, 2 H), 8.06 (s, 2 H), 8.33 (s, 2 H).

### e) Synthesis of complex (XV)

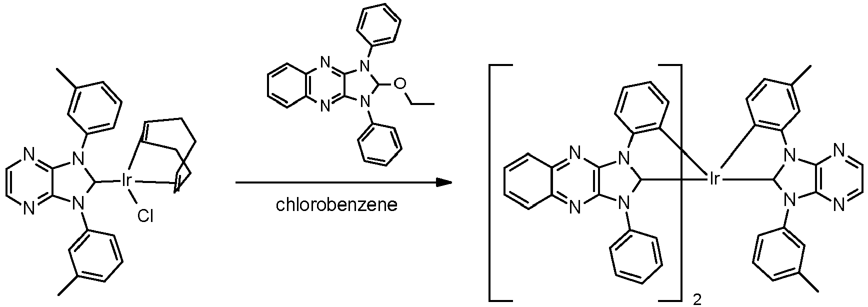

2.00 g (3.14 mmol) of complex intermediate (XV-a) and 4.63 g (12.6 mmol) of 2-ethoxy-1,3-diphenyl-2H-imidazo[4,5-b]quinoxaline are dissolved under argon in 40 ml of chlorobenzene. The yellow solution is three times evacuated and backfilled with argon, followed by heating at 124°C during 23 hours. The reaction mixture is cooled down to room temperature and treated with 40 ml of ethanol and 80 ml of acetone, followed by stirring during 30 minutes. The suspension is filtered, and the solid washed with 30 ml of ethanol first, followed by washing with 30 ml of acetone and 30 ml of heptane. The solid is dried under vacuum and further purified by chromatography (silica gel, dichloromethane/heptane), giving the title product as a yellow solid (yield: 1.94 g (54%)).

APCI-LC-MS (positive, m/z): exact mass of C₆₁H₄₁IrN₁₂ = 1134.32; found 1135.3 [M+1]⁺. ¹H-NMR (400 MHz, CD₂Cl₂): δ = 1.61-2.67 (br. signals, 3 H), 2.43 (s, 3 H), 5.86-7.69 (br. signals, 12 H), 6.53 (d, 1 H), 6.59-6.76 (m, 5 H), 6.82-6.92 (m, 2 H), 7.21-7.33 (m, 2 H), 7.70-7.96 (m, 6 H), 8.10 (d, 1 H), 8.26-8.42 (m, 3 H), 8.67 (s, 1 H), 9.00-9.14 (m, 2 H).

### Synthesis Example 16. Synthesis of complex (XVI)

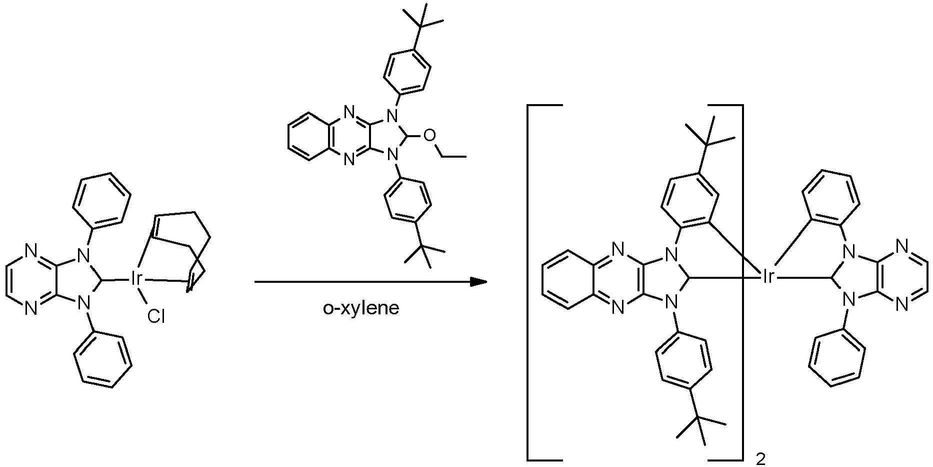

1.50 g (2.47 mmol) of complex intermediate (II-1) and 2.38 g (4.95 mmol) of 1,3-bis(4-*tert*-butylphenyl)-2-ethoxy-2H-imidazo[4,5-b]quinoxaline are suspended under argon in 70 ml of o-xylene. The grey-yellow suspension is three times evacuated and backfilled with argon, followed by heating at 128°C during 20 hours. The reaction mixture is cooled down to room temperature and concentrated under vacuum. The residue is dissolved in dichloromethane and filtered through a 4 cm layer of silica gel followed by rinsing the silica gel layer with dichloromethane. The combined eluents are concentrated under vacuum and the solid further purified by chromatography (silica gel, heptane/ethyl acetate). The isolated product is dissolved in dichloromethane first, followed by the addition of 20 ml of ethanol. The solution is concentrated until a suspension is formed. The suspension is filtered, the solid washed with ethanol and further dried under vacuum, giving a first crop of the title product as a yellow solid. The filtrate is concentrated giving a second crop of the title product (combined yield: 0.45 g (14%)). APCI-LC-MS (positive, m/z): exact mass of C₇₅H₆₉IrN₁₂ = 1330.54; found 1331.7 [M+1]⁺. ¹H-NMR (400 MHz, CD₂Cl₂): δ = 0.76 (s, 9 H), 1.08 (2 s, 18 H), 1.10 (s, 9 H), 6.10-7.68 (br. signal, 12 H), 6.60-6.73 (m, 4 H), 6.87 (t, 1 H), 7.18-7.30 (m, 3 H), 7.69-7.78 (m, 2 H), 7.79-7.93 (m, 4 H), 8.09 (d, 1 H), 8.30-8.38 (m, 2 H), 8.39 (d, 1 H), 8.86-8.93 (m, 2 H), 8.90 (d, 1 H).

### Synthesis Example 17. Synthesis of complex (XVII)

### a) Synthesis of N2,N3-bis(4-phenylphenyl)pyrazine-2,3-diamine

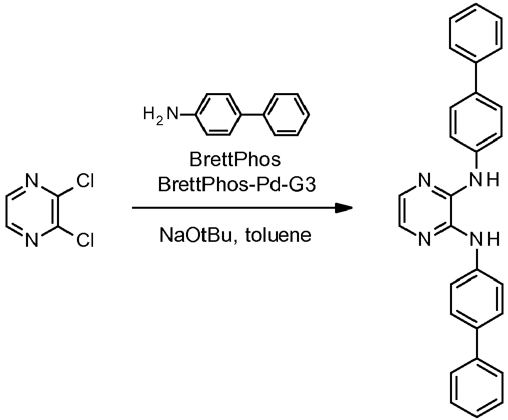

25.0 g (0.15 mol) of 4-biphenylamine and 16.8 g (0.17 mol) of sodium tert-butoxide in 200 ml of toluene are three times evacuated and backfilled with argon. 0.36 g (0.67 mmol) of BrettPhos ligand [= 2-(dicyclohexylphosphino)3,6-dimethoxy-2',4',6'-triisopropyl-1,1'-biphenyl, CAS No. 1070663-78-3] and 0.54 g (0.68 mmol) of BrettPhos-Pd-G3 palladacycle {= [(2-di-cyclohexylphosphino-3,6-dimethoxy-2',4',6'- triisopropyl-1,1'-biphenyl)-2-(2'-amino-1,1'-biphenyl)]palladium(II) methanesulfonate methanesulfonate, CAS No. 1470372-59-8} are added, followed by the addition of 10.2 g (68.5 mmol) of 2,3-dichloropyrazine. The temperature is raised up to 85°C during which a thick suspension is formed. Heating is continued at 85°C during 20 hours. The reaction mixture is cooled down to room temperature, filtered, and the solid rinsed with toluene. The yellow solid is suspended first in 300 ml of heptane, then filtered, followed by stirring the resulting solid in 150 ml of ethanol under reflux. The hot suspension is filtered and the solid washed with ethanol. The solid is stirred in solution of 150 ml of water and 1.5 g of sodium cyanide under moderate heating. The suspension is filtered, the solid washed with water and heated up again in 150 ml of ethanol. The hot suspension is filtered, the solid dried under vacuum, giving the title product as a light yellow solid (yield: 18.1 g (65%)).

¹H-NMR (400 MHz, d₆-DMSO): δ = 7.33 (t, 2 H), 7.46 (t, 4 H), 7.60-7.73 (m, 10 H), 7.80 (d, 4 H), 8.70 (s, 2 H).

### b) Synthesis of [3-(4-phenylanilino)pyrazin-2-yl]-(4-phenylphenyl)ammonium chloride

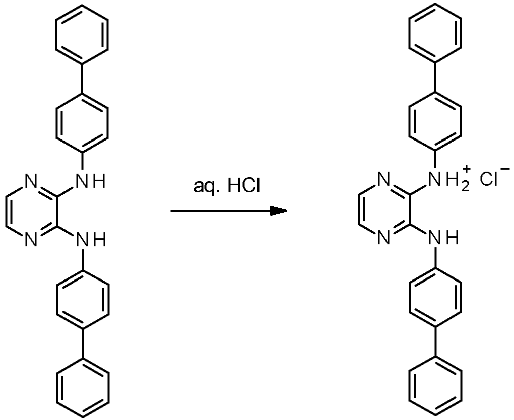

A yellow suspension of 18.1 g (43.6 mmol) of N2,N3-bis(4-phenylphenyl)pyrazine-2,3-diamine and 120 ml of concentrated hydrochloric acid is stirred at room temperature during 15 minutes. 100 ml of water are carefully added under stirring and the resulting suspension filtered, and the solid dried under vacuum, giving the title product as a light yellow solid (32.6 g isolated, still including residual water).

¹H-NMR (400 MHz, d₆-DMSO): δ = 7.34 (t, 2 H), 7.47 (t, 4 H), 7.55 (s, 2 H), 7.63-7.77 (m, 8 H), 7.91 (d, 4 H), 10.21 (br. s, 2 H).

### c) Synthesis of 2-ethoxy-1,3-bis(4-phenylphenyl)-2H-imidazo[4,5-b]pyrazine

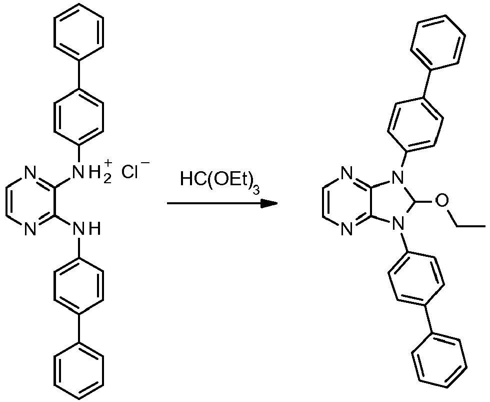

20.4 g (max. 45 mmol, still including residual water) of [3-(4-phenylanilino)pyrazin-2-yl]-(4-phenylphenyl)ammonium chloride are suspended in 200 ml of triethyl orthoformate and heated at 110°C during 17 hours in a reactor fitted with a Dean-Stark separator and condenser. The orange-brown slightly turbid solution is cooled down and filtered through a 2 cm layer of silica gel, followed by rinsing the silica gel layer with heptane and ethanol. The combined eluents are filtered over cellulose powder, followed by rinsing the cellulose powder with heptane. The combined eluents are concentrated under vacuum until a suspension is formed. The suspension is further stirred at room temperature, then filtered, and the solid washed with ethanol, followed by

drying under vacuum. The solid is dissolved in dichloromethane followed by addition of ethanol. The solution is concentrated under vacuum until a suspension is formed. The suspension is cooled down to room temperature under stirring, then filtered, and the solid washed with ethanol, followed by drying under vacuum, giving the title product as a light pink solid (yield: 11.2 g (mininmum 53%)).

¹H-NMR (400 MHz, d₆-DMSO): δ = 0.95 (t, 3 H), 3.24 (q, 2 H), 7.37 (t, 2 H), 7.49 (t, 4 H), 7.59 (s, 2 H), 7.73 (d, 4 H), 7.82 (d, 4 H), 7.90 (s, 1 H), 8.19 (d, 4 H).

### d) Synthesis of complex intermediate (XVII-a)

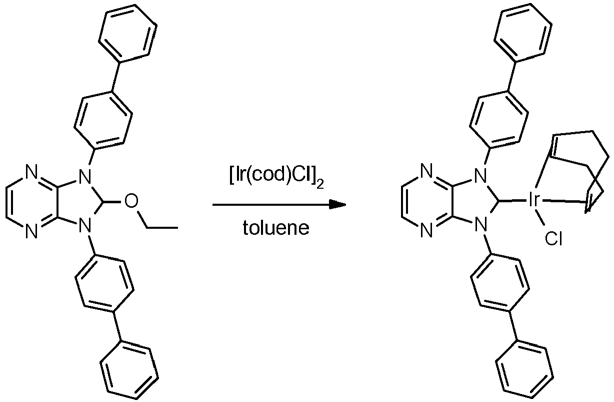

4.32 g (6.43 mmol) of chloro(1,5-cyclooctadiene)iridium(I) dimer and 6.02 g (12.8 mmol) of 2-ethoxy-1,3-bis(4-phenylphenyl)-2H-imidazo[4,5-b]pyrazine are dissolved in 250 ml of toluene. The orange slightly turbid solution is three times evacuated and backfilled with argon, and heated under reflux during one hour. The hot hot orange suspension is filtered through a 3 cm layer of silica gel and the silica gel layer rinsed two times with 25 ml of toluene. The solid is dried under vacuum, giving the title product as a yellow solid (yield: 7.9 g (81%)).

¹H-NMR (400 MHz, CD₂Cl₂): δ = 1.36-1.47 (m, 2 H), 1.51-1.68 (m, 4 H), 1.77-1.92 (m, 2 H), 2.67 (m, 2 H), 4.71 (m, 2 H), 7.44-7.51 (m, 2 H), 7.52-7.61 (m, 4 H), 7.77-7.83 (m, 4 H), 7.88-7.95 (m, 4 H), 8.26-8.33 (m, 4 H), 8.37 (s, 2 H).

### e) Synthesis of complex (XVII)

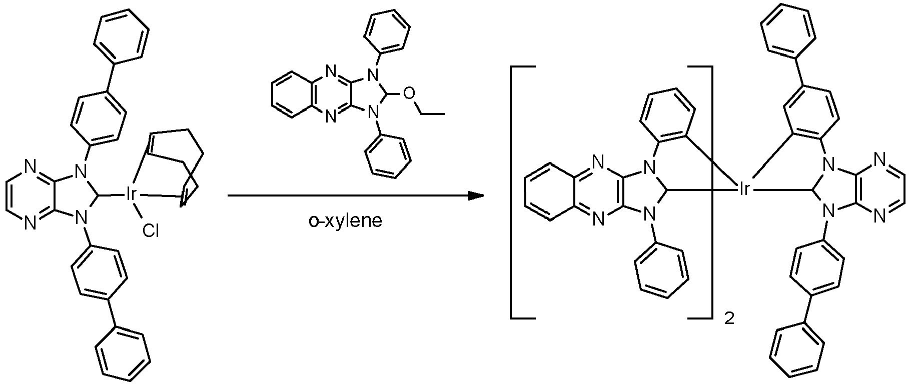

50 ml of o-xylene are three times evacuated and backfilled with argon and heated up to 132°C. 0.80 g (1.05 mmol) of complex intermediate (XVII-a) and 0.81 g (2.20 mmol) of 2-ethoxy-1,3-diphenyl-2H-imidazo[4,5-b]quinoxaline are added and stirring continued at 134°C during one hour. The dark red suspension is cooled down to room temperature followed by filtration. The solid is washed with o-xylene. The filtrate is treated with 200 ml of ethanol and the resulting suspension stirred during 10 minutes, followed by filtration. The filtrate is filtered over a 0.5 cm layer of Hyflo® filter aid, followed by rinsing the filter aid with dichloromethane. The combined filtrates are concentrated under vacuum. The resulting solid is further purified by chromatography (silica gel, dichloromethane/heptane). The isolated product fractions are concentrated under vacuum and the solid dissolved in a minimal amount of dichloromethane followed by the addition of 50 ml of ethanol. The solution is concentrated under vauum until a suspension is formed. The suspension is further stirred at room temperature, then filtered, and the solid washed with ethanol, followed by drying under vacuum, giving the title product as a light yellow solid (190 mg (14%)).

APCI-LC-MS (positive, m/z): exact mass of C₇₁H₄₅IrN₁₂ = 1258.35; found 1259.5 [M+1]⁺. ¹H-NMR (300 MHz, CD₂Cl₂): δ = 6.16-7.96 (br. signal, 12 H), 6.59-6.69 (m, 3 H), 6.76-6.86 (m, 3 H), 6.88-7.03 (m, 5 H), 7.07-7.15 (m, 1 H), 7.16-7.24 (m, 1 H), 7.25-7.40 (m, 6 H), 7.46-7.53 (dd, 1 H), 7.59-7.87 (m, 5 H), 7.87-7.93 (m, 1 H), 8.16 (d, 1 H), 8.28-8.37 (m, 2 H), 8.42 (d, 1 H), 8.87 (d, 1 H), 9.08-9.19 (m, 2 H).

### Synthesis Example 18. Synthesis of complex (XVIII)

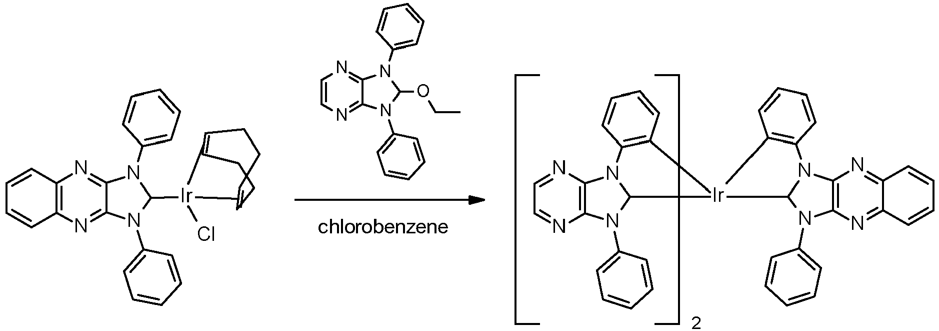

3.50 g (5.31 mmol) of complex intermediate (VIII-a) and 3.38 g (10.6 mmol) of 2-ethoxy-1,3-diphenyl-2H-imidazo[4,5-b]pyrazine (see synthesis example 16, WO2011/073149) are dissolved under argon in 70 ml of chlorobenzene. The reaction mixture is three times evacuated and backfilled with argon, followed by heating at 112°C during 18 hours. The reaction mixture is cooled down to room temperature, treated with 400 ml of ethanol and vigorously stirred during 30 minutes. The suspension is filtered, and the solid subjected to further purification by chromography (silica gel, dichloromethane/ethyl acetate), giving the title product as a yellow solid (yield: 1.53 g (27%)).

APCI-LC-MS (positive, m/z): exact mass of C₅₅H₃₅IrN₁₂ = 1056.27; found 1057.4 [M+1]⁺. ¹H-NMR (400 MHz, CD₂Cl₂): δ = 6.12-8.06 (br. signal, 12 H), 6.61 (t, 1 H), 6.67-6.75 (m, 3 H), 6.82-6.95 (m, 5 H), 7.17-7.32 (m, 3 H), 7.71-7.79 (m, 1 H), 7.80-7.93 (m, 2 H), 8.07-8.15 (m, 2 H), 8.30-8.43 (m, 3 H), 8.82 (t, 2 H), 9.09 (d, 1 H).

### Synthesis Example 19. Synthesis of complex (XIX)

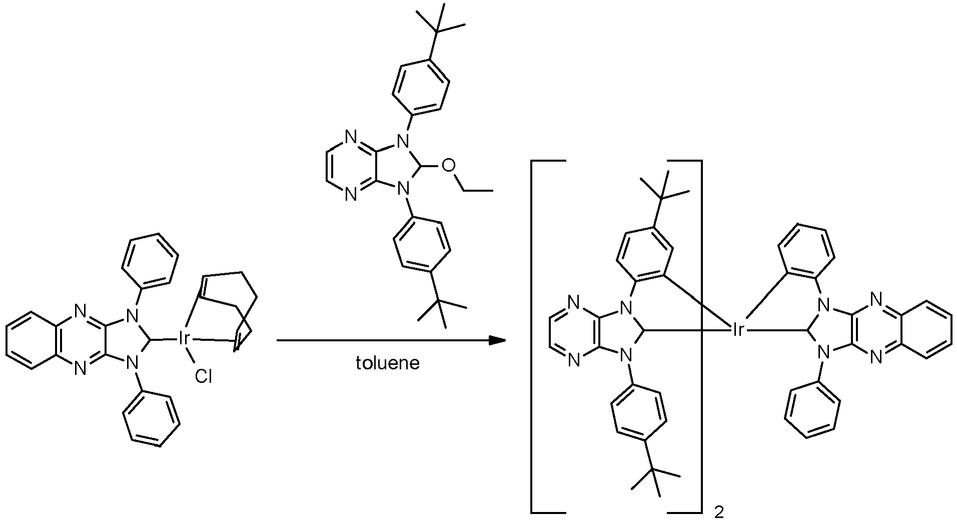

2.50 g (3.80 mmol) of complex intermediate (VIII-a) and 3.27 g (7.59 mmol) of 1,3-bis(4-*tert-*butylphenyl)-2-ethoxy-2H-imidazo[4,5-b]pyrazine are suspended under argon in 100 ml of toluene. The yellow suspension is three times evacuated and backfilled with argon, followed by heating at 108°C during 22 hours. The reaction mixture is cooled down to room temperature and diluted with 400 ml of heptane, followed by stirring during one hour. The suspension is filtered and the solid washed with heptane. The combined filtrates are concentrated under vacuum and the solid further purified by chromatography (silica gel, dichloromethane/heptane), giving the title product as a yellow solid (yield: 1.40 g (28%)).

APCI-LC-MS (positive, m/z): exact mass of C₇₁H₆₇IrN₁₂ = 1280.52; found 1281.7 [M+1]⁺. ¹H-NMR (400 MHz, CD₂Cl₂): δ = 0.73 (s, 9 H), 1.08 (s, 27 H), 5.92-7.93 (br. signal, 12 H), 6.61 (d, 1 H), 6.64 (d, 1 H), 6.76 (d, 1 H), 6.88 (t, 1 H), 6.97 (t, 1 H), 7.18-7.30 (m, 3 H), 7.66-7.74 (m, 1 H), 7.77-7.88 (m, 2 H), 8.06-8.13 (m, 2 H), 8.33 (d, 1 H), 8.38 (dd, 2 H), 8.67 (d, 1 H), 8.72 (d, 1 H), 9.11 (d, 1 H).

### Synthesis Example 20. Synthesis of complex (XX)

### a) Synthesis of complex intermediate (XX-a)

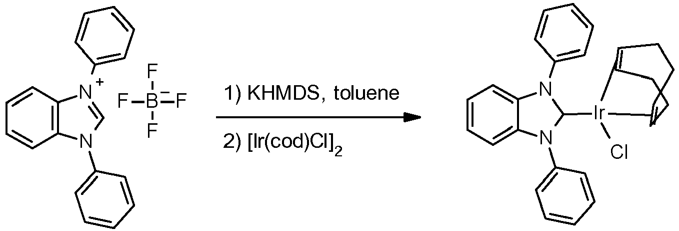

5.00 g (14.0 mmol) of 1,3-diphenylbenzimidazol-3-ium tetrafluoroborate (see synthesis in WO2005/019373) are suspended in 80 ml of toluene and cooled down to -10°C. 27.9 ml (14.0 mmol) of potassium bis(trimethylsilyl)amide solution (KHMDS, 0.5M in toluene) are added within 10 minutes at a maximum temperature of -8°C. The cooling bath is removed and the suspension stirred during 40 minutes reaching room temperature. The greenish suspension is added within 15 minutes to a preheated brownish solution of 4.69 g (7.0 mmol) of chloro(1,5-cyclooctadiene)iridium(I) dimer in 120 ml of toluene at 74°C, and stirring continued at the same temperature during three hours. The warm suspension is filtered through a 3 cm layer of silica gel and the silica gel layer rinsed with toluene. The collected fractions are concentrated under vacuum and the resulting solid dissolved in a minimal amount of dichloromethane, followed by the addition of 50 ml of ethanol. The solution is concentrated until a suspension is generated. The suspension is filtered, the solid washed with cold ethanol and dried under vacuum, giving the title compound as a yellow solid (yield: 6.20 g (74%)).

¹H-NMR (400 MHz, CD₂Cl₂): δ = 1.22-1.36 (m, 2 H), 1.39-1.54 (m, 4 H), 1.66-1.82 (m, 2 H), 2.52-2.62 (m, 2 H), 4.39-4.49 (m, 2 H), 7.28-7.40 (2 m, 4 H), 7.57-7.70 (m, 6 H), 8.04-8.13 (m, 4 H).

### b) Synthesis of complex (XX)

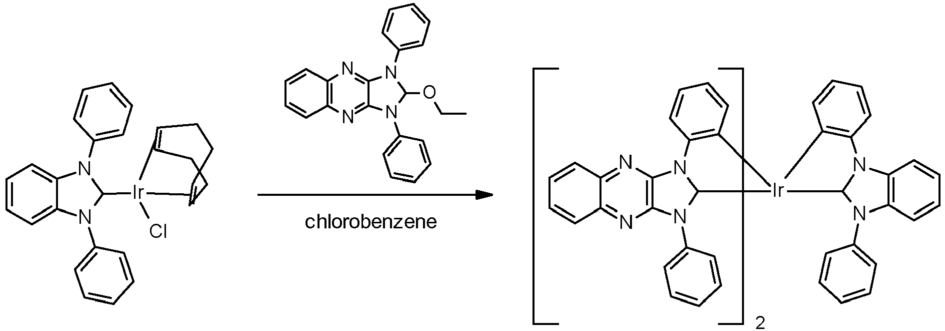

8.00 g (13.2 mmol) of complex intermediate (XX-a) and 19.5 g (52.8 mmol) of 2-ethoxy-1,3-diphenyl-2H-imidazo[4,5-b]quinoxaline are dissolved under argon in 120 ml of chlorobenzene. The yellow solution is three times evacuated and backfilled with argon, followed by heating at 124°C during 21 hours. The reaction mixture is cooled down to room temperature and treated with 100 ml of ethanol and 300 ml of acetone, followed by stirring during 30 minutes. The suspension is filtered, the solid washed with 100 ml of ethanol first, followed by washing with 100 ml of acetone and 100 ml of heptane. The collected filtrates are concentrated under vacuum and further purified by chromatography (silica gel, dichloromethane/heptane). The pure product fractions are collected and concentrated under vacuum, until a suspension is formed. The suspension is filtered, the solid washed with 100 ml of ethanol and 100 ml of heptane, followed by drying under vacuum, giving the title product as a yellow solid (yield: 5.10 g (35%)). APCI-LC-MS (positive, m/z): exact mass of C₆₁H₃₉IrN₁₀ = 1104.30; found 1105.2 [M+1]⁺.

¹H-NMR (400 MHz, CD₂Cl₂): δ = 5.92-7.68 (br. signal, 8 H), 6.32-6.41 (m, 2 H), 6.47-6.67 (m, 5 H), 6.67-6.76 (t, 2 H), 6.78-6.92 (m, 4 H), 7.13 (t, 1 H), 7.17-7.30 (m, 3 H), 7.30-7.44 (m, 2 H), 7.69-7.94 (2 m, 6 H), 8.06 (d, 1 H), 8.22 (d, 1 H), 8.33 (t, 2 H), 9.03 (d, 1 H), 9.09 (d, 1 H).

### Synthesis Example 21. Synthesis of complex (XXI)

### a) Synthesis of N1,N2-bis(4-tert-butylphenyl)benzene-1,2-diamine

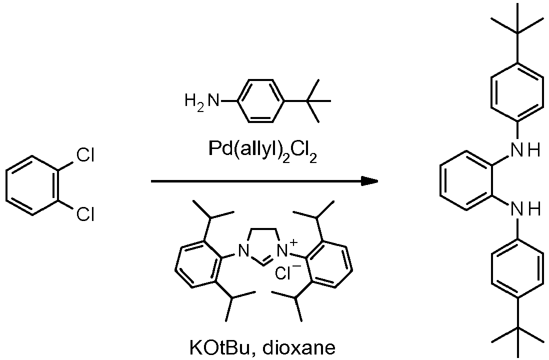

12.0 g (81.6 mmol) of 1,2-dichlorobenzene and 26.8 g (0.18 mol) of 4-*tert*-butylaniline are dissolved under argon in 100 ml of dioxane. 27.5 g (0.25 mol) of potassium tert-butoxide are added first, followed by the addition of 150 mg (0.41 mmol) allylpalladium(II) chloride dimer and 350 mg (0.82 mmol) of 1,3-bis-(2,6-diisopropylphenyl)imidazolium chloride. The reaction mixture is three times evacuated and backfilled with argon, followed by heating at 94°C during three hours. The reaction mixture is diluted with 200 ml of toluene and filtered through a 5 cm layer of Hyflo® filter aid. The filtrate is concentrated under vacuum and the residue dissolved in hot ethanol. The solution is cooled down to room temperature, and the resulting suspension filtered. The solid is washed with ethanol and heptane, followed by drying under vacuum, giving the title product as a white solid (yield: 23.6 g (78%)).

¹H-NMR (400 MHz, d₆-DMSO): δ = 1.25 (s, 18 H), 6.83-6.88 (m, 2 H), 6.90 (d, 4 H), 7.09 (s, 2 H), 7.16-7.25 (m, 6 H).

### b) Synthesis of 1,3-bis(4-tert-butylphenyl)benzimidazol-3-ium tetrafluoroborate

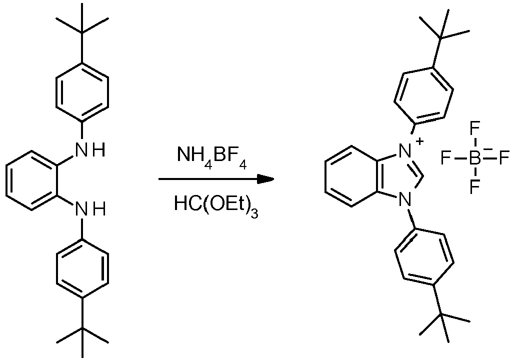

A dark blue suspension of 20.0 g (53.7 mmol) of N1,N2-bis(4-*tert*-butylphenyl)benzene-1,2-diamine and 5.63 g (53.7 mmol) of ammonium tetrafluoroborate in 90 ml (0.54 mol) of triethyl orthoformate are heated at 128°C during three hours. The reaction mixture is cooled down to room temperature and diluted with 200 ml of heptane. The dark suspension is filtered, the solid washed with heptane, followed by drying under vacuum, giving the title compound as an off-white solid (yield: 24.9 g (99%).

¹H-NMR (400 MHz, d₆-DMSO): δ = 1.40 (s, 18 H), 7.74-7.90 (m, 10 H), 7.91-8.01 (m, 2 H), 10.45 (s, 1 H).

### c) Synthesis of complex intermediate (XXI-a)

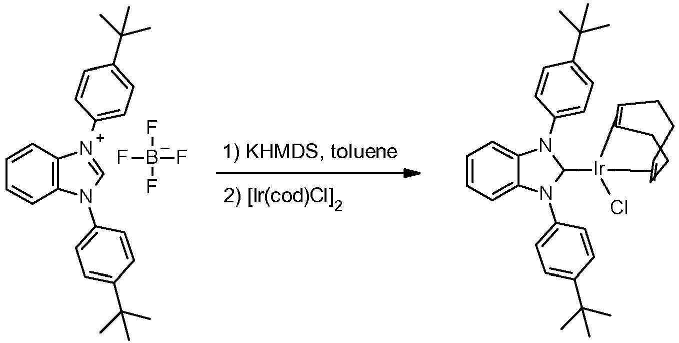

6.00 g (12.8 mmol) of 1,3-bis(4-*tert*-butylphenyl)benzimidazol-3-ium tetrafluoroborate are suspended in 100 ml of toluene and cooled down to -12°C. 25.5 ml (12.8 mmol) of potassium bis(trimethylsilyl)amide solution (KHMDS, 0.5M in toluene) are added within 20 minutes. The cooling bath is removed and the suspension stirred during 30 minutes until room temperature is reached. The brown suspension is added within 20 minutes to a preheated brownish solution of 4.28 g (6.37 mmol) of chloro(1,5-cyclooctadiene)iridium(I) dimer in 70 ml toluene at 74°C, and stirring continued at the same temperature during 30 minutes. The hot reaction mixture is filtered through a 4 cm layer of silica gel and the silica gel layer rinsed with toluene. The combined eluents are concentrated under vacuum and the residue stirred in hot ethanol. The suspension is filtered, the solid washed with ethanol, followed by drying under vacuum, giving the title product as a yellow solid (yield: 7.78 g (85%)).

¹H-NMR (400 MHz, CDCl₃): δ = 1.17-1.61 (m, 6 H), 1.45 (s, 18 H), 1.62-1.75 (m, 2 H), 2.40-2.50 (m, 2 H), 4.44-4.55 (m, 2 H), 7.23-7.38 (m, 2 H), 7.34-7.41 (m, 2 H), 7.61 (d, 4 H), 7.97 (d, 4 H).

### d) Synthesis of complex (XXI)

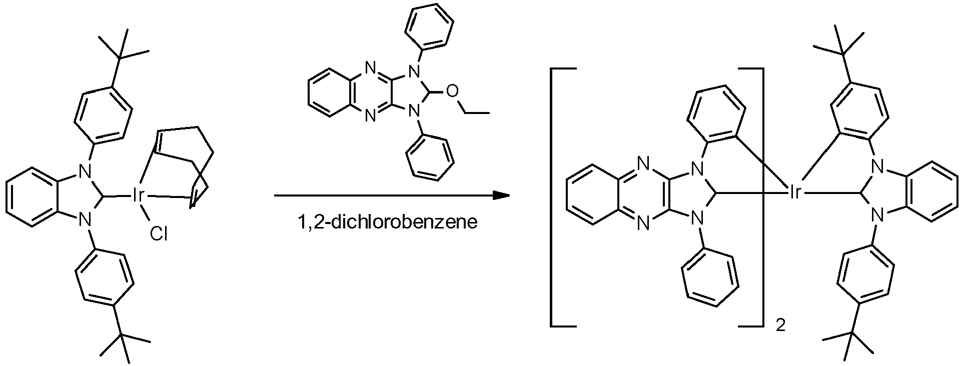

4.62 g (12.5 mmol) of complex intermediate (XXI-a) and 4.50 g (6.26 mmol) of 2-ethoxy-1,3-diphenyl-2H-imidazo[4,5-b]quinoxaline are suspended in 100 ml of 1,2-dichlorobenzene, and heated at 123°C during during 49 hours. The reaction mixture is cooled down to room temperature and concentrated under vacuum to a volume of ca. 40 ml, followed by the addition of 300 ml of ethanol and 300 ml of heptane. The resulting suspension is filtered, the solid washed with 100 ml of ethanol, followed by drying under vacuum. The solid is further purified by chromatography (silica gel, dichloromethane/heptane). The isolated product fractions are diluted with 100 ml of ethanol and concentrated under vacuum until a suspension is formed. The suspension is filtered, the solid washed with ethanol, followed by drying under vacuum, giving the title product as a yellow solid (yield: 2.71 g (36%)).

APCI-LC-MS (positive, m/z): exact mass of C₆₉H₅₅IrN₁₀ = 1216.42; found 1217.4 [M+1]⁺. ¹H-NMR (400 MHz, CD₂Cl₂): δ = 0.69 (s, 9 H), 1.06 (s, 9 H), 5.98-8.08 (br. signals, 8 H), 6.28 (dd, 1 H), 6.33 (dd, 1 H), 6.40 (dd, 1 H), 6.52 (d, 1 H), 6.59-6.65 (m, 2 H), 6.70-6.77 (m, 2 H), 6.82-6.94 (m, 3 H), 7.12 (t, 1 H), 7.17-7.29 (m, 3 H), 7.35-7.45 (m, 2 H), 7.66-7.87 (m, 5 H), 7.88-7.93 (m, 1 H), 7.95 (d, 1 H), 8.22 (d, 1 H), 8.30-8.38 (m, 2 H), 9.09 (d, 2 H).

### Synthesis Example 22. Synthesis of complex (XXII)

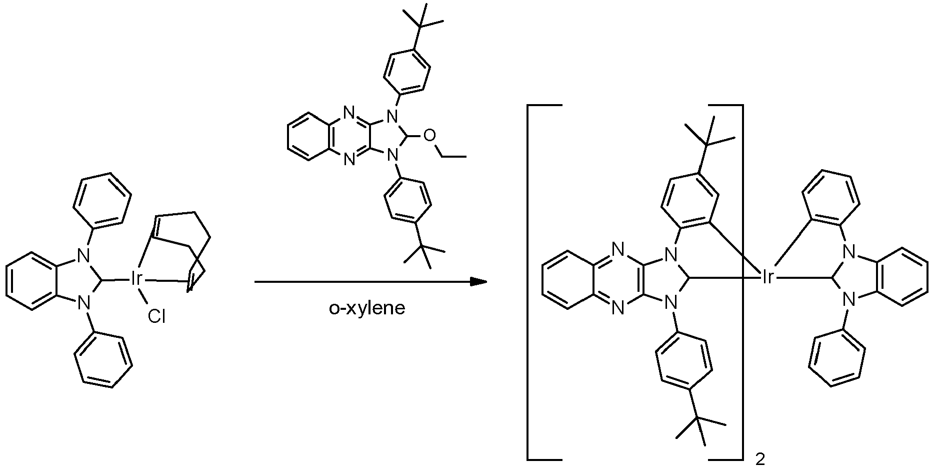

1.50 g (2.47 mmol) of complex intermediate (XX-a) and 2.37 g (4.93 mmol) of the 1,3-bis(4-*tert-*butylphenyl)-2-ethoxy-2H-imidazo[4,5-b]quinoxaline are dissolved in 70 ml of o-xylene, and heated at 141°C during 21 hours. The reaction mixture is cooled down to room temperature and concentrated under vacuum. The residue is dissolved in dichloromethane and filtered through a 4 cm layer of silica gel followed by rinsing the silica gel layer with dichloromethane. The combined eluents are concentrated under vacuum and the solid further purified by chromatography (silica gel, heptane/ethyl acetate 4:1). The isolated product is dissolved in dichloromethane first, followed by the addition of 30 ml ethanol. The solution is concentrated until a suspension is formed. The suspension is filtered, the solid washed with ethanol and further dried under vacuum, giving the title product as a yellow solid (yield: 421 mg (13%)).

APCI-LC-MS (positive, m/z): exact mass of C₇₇H₇₁IrN₁₀ = 1328.55; found 1329.7 [M+1]⁺. ¹H-NMR (400 MHz, CD₂Cl₂): δ = 0.76 (s, 9 H), 1.04 (s, 9 H), 1.08 (s, 9 H), 1.09 (s, 9 H), 6.05-7.97 (br. signals, 8 H), 6.10 (d, 1 H), 6.20 (t, 1 H), 6.38 (d, 1 H), 6.48 (d, 1 H), 6.56-6.66 (m, 2 H), 6.68 (d, 1 H), 6.73 (d, 1 H), 6.82 (t, 1 H), 7.10 (t, 1 H), 7.16-7.29 (m, 3 H), 7.29-7.43 (m, 2 H), 7.68-7.76 (m, 2 H), 7.77-7.85 (m, 2 H), 7.88 (d, 2 H), 8.09 (d, 1 H), 8.25-8.38 (m, 3 H), 8.85 (d, 1 H), 9.00 (d, 1 H).

### Synthesis Example 23. Synthesis of complex (XXIII)

### a) Synthesis of N1,N2-bis(3-ethylphenyl)benzene-1,2-diamine

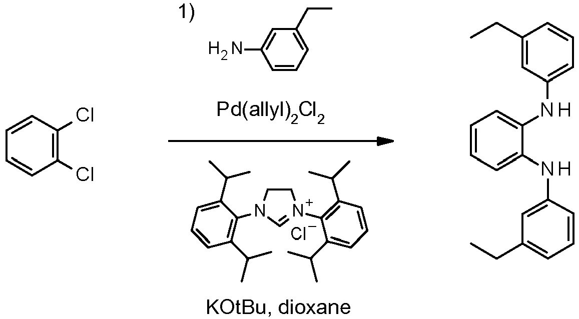

11.1 g (75.8 mmol) of 1,2-dichlorobenzene and 20.2 g (0.17 mol) of 3-ethylaniline are dissolved under argon in 100 ml of dioxane. 25.5 g (0.23 mol) of potassium tert-butoxide are added first, followed by the addition of 139 mg (0.38 mmol) allylpalladium(II) chloride dimer and 0.32 g (0.75 mmol) of 1,3-bis-(2,6-diisopropylphenyl)imidazolium chloride. The reaction mixture is three times evacuated and backfilled with argon, followed by heating at 92°C during 90 minutes. The dark suspension is diluted with toluene and filtered through a 5 cm layer of silica gel, followed by rinsing the silica gel layer with 100 ml of toluene. The collected eluents are concentrated under vacuum, and then dissolved in 100 ml of heptane and 200 ml of 20% aqueous hydrochloric acid, followed by strirring at 50°C during 30 minutes. The suspension is cooled down to room temperature, then filtered, and the solid washed with water and heptane. The solid is suspended in 10% aqueous sodium hydroxide and 100 ml of toluene. The toluene phase is separated then washed two times with 50 ml water, followed by dyring over sodium sulfate, and concentrated under vacuum, giving the title product as a light yellow oil (yield: 13.1 g (55%)).

¹H-NMR (400 MHz, d₆-DMSO): δ = 1.12 (t, 6 H), 2.49 (q, 4 H), 6.61 (d, 2 H), 6.74-6.81 (2 br. signals, 4 H), 6.87-6.94 (m, 2 H), 7.08 (t, 2 H), 7.17 (s, 2 H), 7.20-7.27 (m, 2 H).

### b) Synthesis of 1,3-bis(3-ethylphenyl)benzimidazol-3-ium tetrafluoroborate

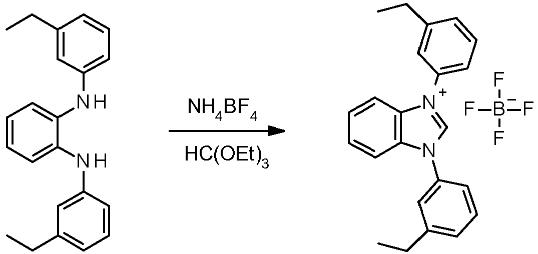

A dark blue suspension of 13.0 g (41.1 mmol) of N1,N2-bis(3-ethylphenyl)benzene-1,2-diamine and 4.31 g (41.1 mmol) of ammonium tetrafluoroborate in 70 ml (0.42 mol) of triethyl orthoformate are heated under reflux during four hours. The reaction mixture is cooled down to room temperature and diluted with 200 ml of heptane, followed by stirring during 17 hours. The dark suspension is filtered, the solid washed with heptane and further dried under vacuum, giving the title compound as a light yellow solid (yield: 16.3 g (96%)).

¹H-NMR (400 MHz, d₆-DMSO): δ = 1.30 (t, 6 H), 2.82 (q, 4 H), 7.59-7.65 (2 br. signals, 2 H), 7.69-7.84 (m, 8 H), 7.94-8.00 (m, 2 H), 10.53 (s, 1 H).

### c) Synthesis of complex intermediate (XXIII-a)

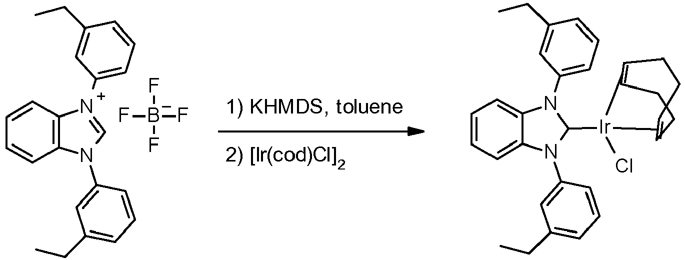

5.00 g (12.1 mmol) of 1,3-bis(3-ethylphenyl)benzimidazol-3-ium tetrafluoroborate are suspended in 100 ml of toluene and cooled down to -13°C. 24.0 ml (12.0 mmol) of potassium bis(trimethylsilyl)amide solution (KHMDS, 0.5M in toluene) are added within 15 minutes. The cooling bath is removed and the suspension stirred during 30 minutes reaching room temperature. The brown suspension is added within 35 minutes to a preheated brownish solution of 4.05 g (6.03 mmol) of chloro(1,5-cyclooctadiene)iridium(I) dimer in 70 ml toluene at 74°C, and stirring continued at the same temperature during three hours. The warm reaction mixture is filtered through a 3 cm layer of silica gel, and the silica gel layer rinsed with toluene. The collected eluents are concentrated under vacuum and stirred in warm ethanol. The suspension is filtered, the solid washed with ethanol and further dried under vacuum, giving the title product as a yellow solid (yield: 5.5 g (69%)).

¹H-NMR (400 MHz, CDCl₃): δ = 1.18-1.29 (m, 2 H), 1.33-1.51 (2 m, 4 H), 1.38 (t, 6 H), 1.65-1.79 (m, 2 H), 2.45-2.52 (m, 2 H), 2.75-2.90 (m, 4 H), 4.46-4.54 (m, 2 H), 7.24-7.30 (m, 2 H), 7.33-7.41 (m, 4 H), 7.50 (t, 2 H), 7.76 (d, 2 H), 8.06 (s, 2 H).

### d) Synthesis of complex (XXIII)

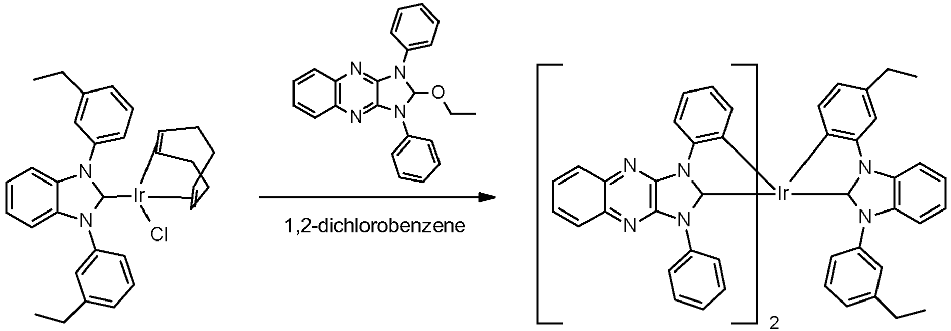

3.00 g (4.53 mmol) of complex intermediate (XXIII-a) and 3.34 g (9.07 mmol) of 2-ethoxy-1,3-diphenyl-2H-imidazo[4,5-b]quinoxaline are dissolved in 90 ml of 1,2-dichlorobenzene, and heated first at 112°C during 20 hours, followed by heating at 123°C during 48 hours. The reaction mixture is cooled down to room temperature, diluted with 200 ml of acetone, and stirred during three hours. The suspension is filtered, the solid washed with acetone and ethanol and further dried under vacuum, giving the title product as a yellow solid (yield: 1.69 g (32%)). APCI-LC-MS (positive, m/z): exact mass of C₆₅H₄₇IrN₁₀ = 1160.36; found 1161.4 [M+1]⁺.

### Synthesis Example 24. Synthesis of complex (XXIV)

### a) Synthesis of N1,N2-bis(4-phenylphenyl)benzene-1,2-diamine

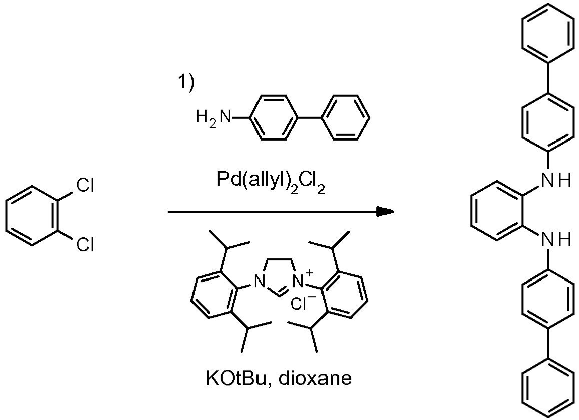

10.9 g (73.9 mmol) of 1,2-dichlorobenzene and 25.0 g (0.15 mol) of 4-biphenylamine are dissolved under argon in 100 ml of dioxane. 24.9 g (0.22 mol) of potassium tert-butoxide are added first, followed by the addition of 135 mg (0.37 mmol) allylpalladium(II) chloride dimer and 315 mg (0.74 mmol) of 1,3-bis-(2,6-diisopropylphenyl)imidazolium chloride. The reaction mixture is three times evacuated and backfilled with argon, followed by heating under reflux during 20 hours. 5.00 g (29.5 mmol) of 4-biphenylamine are added and heating continued during 24 hours. The reaction mixture is cooled down to room temperature, then diluted with 200 ml of toluene, followed by filtration through Hyflo® filter aid. The filter aid is rinsed with toluene and the combined eluents concentrated under vacuum. The residue is stirred in ethanol under reflux and the resulting suspension filtered. The solid is washed with ethanol and dissolved in 600 ml of dichloromethane. 100 ml of a 5% aqueous sodium cyanide solution are added under stirring and stirring continued during 30 minutes. The organic phase is separated and two times washed with 100 ml of water, and further diluted with 200 ml of ethanol. The solution is concentrated under vacuum until a suspension is formed. The suspension is filtered, the solid washed with ethanol, followed by drying under vacuum, giving the title product as a solid (yield: 15.3 g (50%)).

¹H-NMR (400 MHz, d₆-DMSO): δ = 6.91-7.02 (m, 2 H), 7.06 (d, 4 H), 7.22-7.36 (m, 4 H), 7.41 (t, 4 H), 7.50 (s, 2 H), 7.48-7.55 (m, 4 H), 7.56-7.63 (m, 4 H).

### b) Synthesis of 1,3-bis(4-phenylphenyl)benzimidazol-3-ium tetrafluoroborate

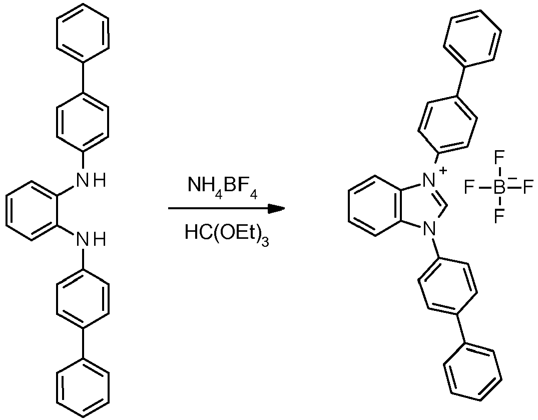

A beige suspension of 10.0 g (24.2 mmol) of N1,N2-bis(4-phenylphenyl)benzene-1,2-diamine, 2.54 g (24.2 mmol) of ammonium tetrafluoroborate and 36.6 g (0.25 mol) of triethyl orthoformate is heated at 112°C during 15 minutes. An additional 36.6 g (0.25 mol) of triethyl orthoformate are added and heating continued at 119°C during 4 h 30 min. The beige suspension is cooled down to room temperature first, then diluted with ethanol, and filtered. The resulting solid is washed with ethanol first, followed by drying under vacuum, giving the title product as an off-white solid (yield: 11.6 g (94%)).

¹H-NMR (400 MHz, d₆-DMSO): δ = 7.49 (t, 2 H), 7.58 (t, 4 H), 7.82-7.89 (m, 6 H), 8.03-8.09 (m, 6 H), 8.10-8.16 (m, 4 H), 10.65 (s, 1 H).

### c) Synthesis of complex intermediate (XXIV-a)

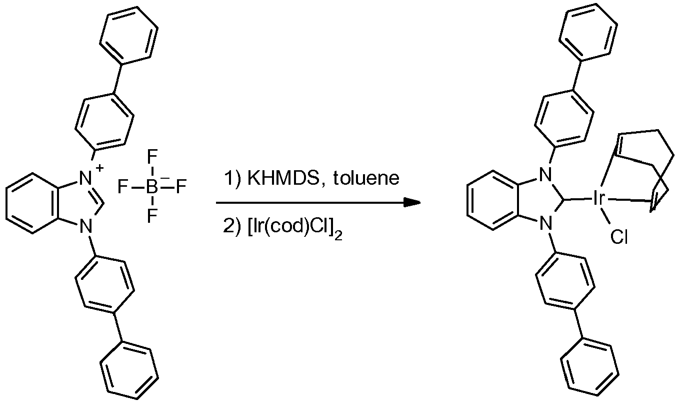

4.56 g (8.94 mmol) of 1,3-bis(4-phenylphenyl)benzimidazol-3-ium tetrafluoroborate are suspended in 50 ml of toluene and cooled down to -14°C. 18.0 ml (9.00 mmol) of potassium bis(trimethylsilyl)amide solution (KHMDS, 0.5M in toluene) are added within 15 minutes. The cooling bath is removed and the suspension stirred during 25 minutes until room temperature is reached. 3.00 g (4.47 mmol) of chloro(1,5-cyclooctadiene)iridium(I) dimer are added and the suspension heated at 63°C during 1 h 40 min. The hot reaction mixture is filtered through Hyflo® filter aid, followed by rinsing the filter aid with toluene. The combined eluents are partly concentrated under vacuum and diluted with 100 ml of ethanol. The resulting suspension is filtered, the solid dried under vacuum, giving the title product as a yellow solid (yield: 4.10 g (61%)).

¹H-NMR (400 MHz, d₆-DMSO): δ = 1.18-1.30 (m, 2 H), 1.32-1.46 (m, 4 H), 1.61-1.74 (m, 2 H), 2.57-2.66 (m, 2 H), 4.30-4.39 (m, 2 H), 7.38-7.51 (m, 6 H), 7.56 (t, 4 H), 7.85 (d, 4 H), 7.98 (d, 4 H), 8.18 (d, 4 H).

### d) Synthesis of complex (XXIV)

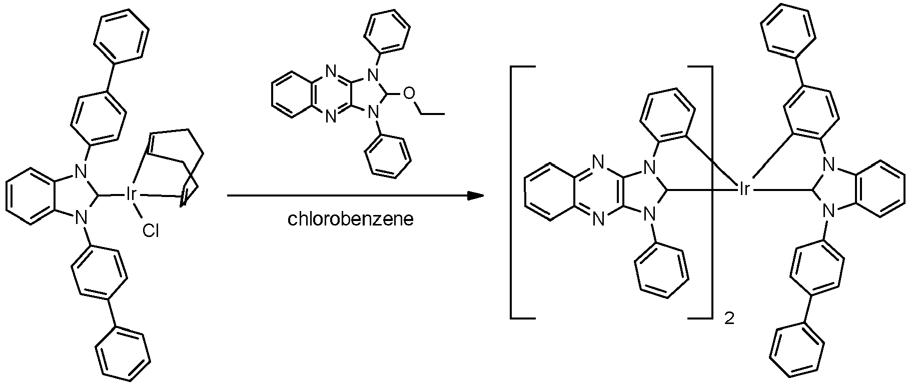

4.00 g (5.27 mmol) of complex intermediate (XXIV-a) and 7.80 g (21.1 mmol) of 2-ethoxy-1,3-diphenyl-2H-imidazo[4,5-b]quinoxaline are dissolved under argon in 100 ml of chlorobenzene. The green-brown solution is three times evacuated and backfilled with argon, followed by heating at 124°C during 19 hours. The orange-brown solution is cooled down to room temperature first, then treated with 400 ml of acetone, and stirring continued during one hour. The resulting suspension is filtered, the solid washed with 100 ml of acetone and 200 ml of ethanol. The solid is dissolved in 75 ml of dichloromethane and filtered through a 4 cm layer of silica gel, followed by rinsing the silica gel layer with 400 ml of dichloromethane. The combined eluents are treated with 100 ml of acetone, and concentrated under vacuum to a volume of 50 ml until a suspension is formed. The suspension is filtered, the solid washed with 100 ml of acetone and 50 ml of pentane, followed by drying under vacuum. The solid is further purified by chromatography (silica gel, dichloromethane/heptane), giving the title product as a yellow solid (yield: 4.23 g (44%)). APCI-LC-MS (positive, m/z): exact mass of C₇₃H₄₇IrN₁₀ = 1256.36; found 1257.4 [M+1]⁺.

¹H-NMR (400 MHz, CD₂Cl₂): δ = 5.98-7.70 (br. signal, 8 H), 6.46 (dd, 1 H), 6.57-6.64 (m, 2 H), 6.64-6.72 (m, 4 H), 6.73-6.83 (m, 2 H), 6.85-6.95 (m, 3 H), 6.95-7.03 (m, 3 H), 7.11 (t, 1 H), 7.14-7.23 (m, 2 H), 7.24-7.33 (m, 4 H), 7.33-7.39 (m, 2 H), 7.43 (t, 1 H), 7.50 (dd, 1 H), 7.56-7.65 (m, 3 H), 7.71-7.79 (m, 2 H), 7.80-7.86 (m, 1 H), 7.91 (dd, 1 H), 8.12 (d, 1 H), 8.27 (t, 2 H), 8.33 (dd, 1 H), 9.09 (dd, 1 H), 9.13 (dd, 1 H).

### Synthesis Example 25. Synthesis of complex (XXV)

### a) Synthesis of 5,6-dicyano-1,3-diphenyl-benzimidazolium tetrafluoroborate

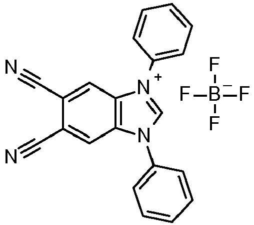

22.6 g (170 mmol) of chloromethylene-dimethyliminium chloride (*Vilsmeyer* reagent) are dissolved in 270 ml of acetonitrile at -5°C. 9.20 g (26.6 mmol) 4,5-dianilinophthalic acid diamide described in EP0600832 are added in portions within 5 minutes. The dark green solution is stirred for one hour at 0°C. The reaction mixture is warmed up to room temperature and stirred overnight. 19.0 g (173 mmol) of sodium tetrafluoroborate are added to the dark blue solution. After stirring the suspension for 4.5 hours the solid is filtered off and washed with acetonitrile. The filtrate is concentrated. 100 ml of an ice-water mixture are added. After stirring the suspension for 30 min the residue is filtered off, washed three times with 20 ml ice-cold water each, and is sucked dry. The solid is suspended three times in 20 ml of isopropanol each, sucked dry, and is washed twice with 20 ml of n-pentane each. The solid is dried under vacuum in a drying cabinet at 60°C for 16 hours. 10.6 g (94% of theory) slightly turquoise solid are obtained.

¹H-NMR (400 MHz, CD₃CN): δ [ppm] = 7.80 (mc; 10H), 8.50 (mc; 2H), 9.78 (s; 1H).

### b) Synthesis of 2-methoxy-1,3-diphenyl-2H-benzimidazol-5,6-dicarbonitrile

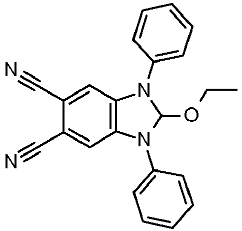

10.6 g (26.0 mmol) of 5,6-dicyano-1,3-diphenyl-benzimidazolium tetrafluoroborate are suspended in 250 ml of methanol. After cooling the suspension to 0°C a solution, 4.68 g (26.0 mmol) of sodium methoxide in methanol (30%) is added within 10 minutes. The reaction mixture is stirred at 0°C for 40 minutes and then warmed up to room temperature and stirred for three hours. The residue is filtered off, washed three times with 10 ml of ice-cold methanol, and dried under vacuum in drying cabinet overnight at 50°C. 8.51 g (93% of theory) greenish solid are obtained.

¹H-NMR (400 MHz, CD₂Cl₂): δ [ppm] = 3.17 (s; 3H), 7.02 (s; 1H), 7.19 (mc; 2H), 7.32 (mc; 2H), 7.50 (mc; 8H).

### c) Synthesis of complex intermediate (XXV-a)

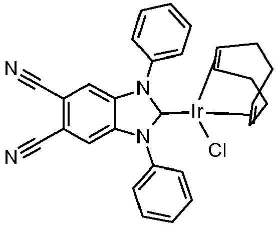

9.50 g (27.0 mmol) 2-methoxy-1,3-diphenyl-2H-benzimidazol-5,6-dicarbonitrile and 9.05 g (13.5 mmol) of µ-chloro-1,5-cyclooctadiene-iridium(I) dimer are added to 500 ml toluene. The flask is rinsed with 150 ml of toluene. After heating the suspension to 60°C a solution is formed which is heated at that temperature for 24 hours. The suspension is cooled to 15°C and then filtered. The residue is washed five times with 5 ml of toluene, then three times with 10 ml of n-pentane, and dried under vacuum in drying cabinet at 60°C during 16 hours. 14.1 g (80 % of theory) of an olive-green solid are obtained.

¹H-NMR (400 MHz, CD₂Cl₂): δ [ppm] = 1.30-1.60 (m; 6H), 1.71 (mc; 2H), 2.54 (mc; 2H), 4.57 (mc; 2H), 7.68 (mc; 6H), 7.73 (mc; 2H), 7.99 (mc; 4H).

### d) Synthesis of complex (XXV)

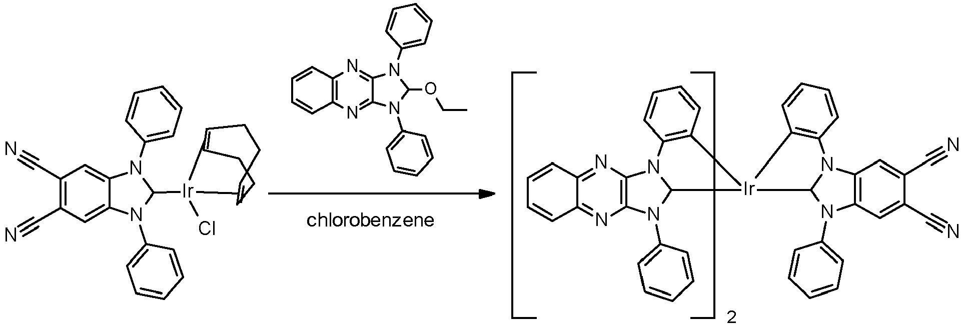

1.00 g (1.52 mmol) of complex intermediate (XXV-a) and 2.25 g (6.10 mmol) 2-ethoxy-1,3-diphenyl-2H-imidazo[4,5-b]quinoxaline are suspended in 30 ml of chlorobenzene. The suspension is heated to 125°C and stirred at that temperature for 17 hours. After cooling the reaction mixture to room temperature 15 ml of acetone and 45 ml of absolute ethanol are added. The suspension is stirred for 30 minutes and then filtered. The filtrate is evaporated to dryness. The brown solid is dissolved in 5 ml of dichloromethane and then precipitated by adding 7 ml of absolute ethanol. The precipitate is filtered off, three times washed with 3 ml of n-pentane, and dried under vacuum in drying cabinet at 60°C overnight. A dark yellow solid is obtained that is further purified by MPLC with the *CombiFlash Companion* (silica gel, dichloromethane/methanol 99.5 : 0.5). The purified yellow solid (0.52 g) is boiled up in 10 ml of acetonitrile. The hot suspension is filtered. The residue is washed three times with 1 ml of acetonitrile, then washed twice with 3 ml of ethanol, and three times with 3 ml of n-pentane, and dried under vacuum in a drying cabinet at 100°C overnight. The yellow solid (0.41 g) obtained is again purified by boiling up in acetonitrile as described before. The yellow solid is purified by MPLC a second time as described before. The yellow solid is boiled up in acetonitrile again as described before. 225 mg (13 % of theory) yellow solid are obtained.

ESI-LC/MS (positive, m/z): exact mass of C₆₃H₃₇IrN₁₂ = 1154.29; found 1154.2 [M + H]⁺

¹H-NMR (500 MHz, CD₂Cl₂): δ [ppm] = 6.30 (mc), 6.39 (mc), 6.53-6.61 (m), 6.68 (mc), 6.78-6.84 (m), 6.88 (mc), 6.92 (mc), 7.21 (mc), 7.36 (mc), 7.72 (mc; 2H), 7.78-7.87 (m; 5H), 8.29 (mc; 2H), 8.56 (mc; 1H), 9.01 (mc; 2H).

### Synthesis Example 26. Synthesis of complex (XXVI)

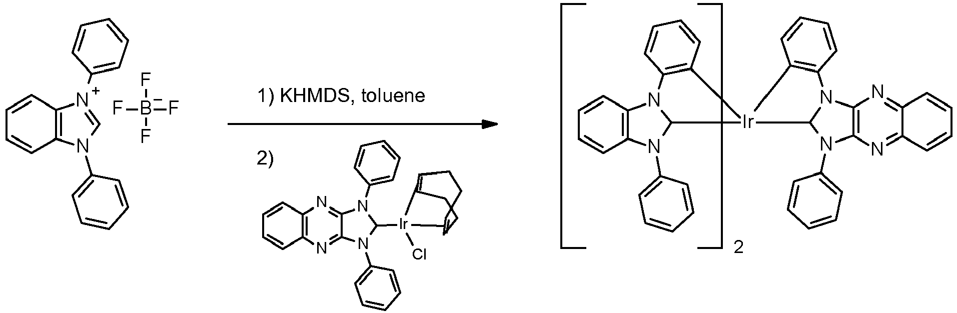

A suspension of 8.69 g (24.3 mmol) of 1,3-diphenylbenzimidazol-3-ium tetrafluoroborate (see synthesis in WO2005/019373) in 50 ml of toluene is cooled down to -11°C. 48.6 ml (24.3 mmol) of potassium bis(trimethylsilyl)amide solution (KHMDS, 0.5M in toluene) are added within 20 minutes. The cooling bath is removed and stirring continued until room temperature is reached. The green suspension is treated with 4.00 g (6.07 mmol) of complex intermediate (VIII-a) and 100 ml of toluene, and heated at 109°C during three hours. The reaction mixture is cooled down to room temperature, filtered, and the solid washed with 50 ml of toluene. The combined filtrates are diluted with 300 ml of ethanol and 500 ml of heptane, followed by stirring during one hour. The suspension is filtered, the solid washed with ethanol and heptane, followed by drying under vacuum. The solid is further purified by chromatography (silica gel, dichloromethane/heptane), giving the title product as a yellow solid (yield: 1.64 g (26%)).

APCI-LC-MS (positive, m/z): exact mass of C₅₉H₃₉IrN₈ = 1052.29; found 1053.3 [M+1]⁺.

¹H-NMR (400 MHz, CD₂Cl₂): δ = 6.23-7.49 (br. signal, 4 H), 6.25-6.40 (m, 4 H), 6.45 (d, 1 H), 6.49-6.61 (m, 3 H), 6.61-6.69 (m, 3 H), 6.70-6.89 (m, 6 H), 7.06-7.24 (m, 5 H), 7.27-7.41 (m, 4 H), 7.68-7.75 (m, 1 H), 7.77-7.84 (m, 1 H), 7.88 (d, 1 H), 7.98-8.08 (m, 2 H), 8.20 (t, 2 H), 8.31 (d, 1 H), 9.02 (d, 1 H).

### Synthesis Example 27. Synthesis of complex (XXVII)

### a) Synthesis of N2,N3-diphenylnaphthalene-2,3-diamine

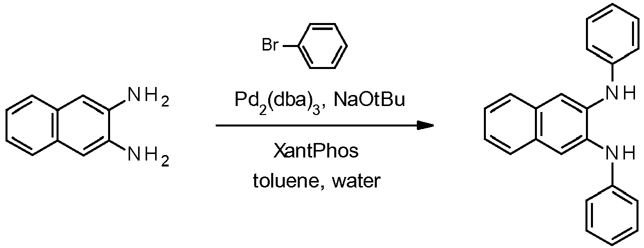

A mixture of 25 g (0.16 mol) of 2,3-diaminonaphthalene, 49.6 g (0.32 mol) of bromobenzene and 250 ml of toluene is degassed under vacuum and backfilling with argon (repeated three times). 1.45 g (1.58 mmol) of dipalladium tris(dibenzylidene acetonate), 2.74 g (4.74 mmol) of XantPhos ligand (= 4,5-bis(diphenylphosphino)-9,9-dimethylxanthene), 21.0 g sodium *tert-*butoxide (0.22 mol) and 2.84 ml of degassed water are added and the mixture degassed again 3 times with vacuum / argon backfilling. The dark suspension is refluxed under argon for 20 hours and cooled to room temperature. The mixture is diluted with 400 ml of dichloromethane, extracted twice with a 1% aqueous solution of sodium cyanide, washed three times with water, dried over sodium sulfate, and concentrated under vacuum. The residue is purified by chromatography (silica gel, dichloromethane 99.5% : triethylamine 0.5%) to give the title product as a brown powder (yield: 23.5 g (48%)).

¹H-NMR (300 MHz, CDCl₃): δ = 7.67 (s, 2H), 7.64-7.60 (m, 2H), 7.37-7.27 (m, 6H), 7.10 (m, 4H), 7.00 (tt, 2H), 5.84 (s, 2H).

### b) Synthesis of 1,3-diphenylbenzo[flbenzimidazol-3-ium tetrafluoroborate

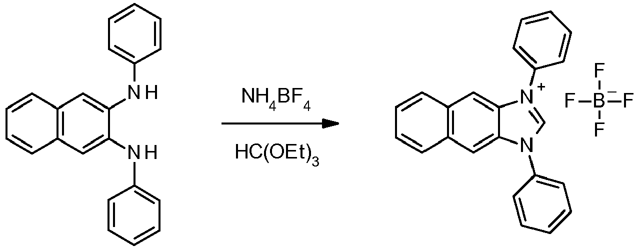

A mixture of 22 g of N2,N3-diphenylnaphthalene-2,3-diamine (71 mmol) and 7.44 g ammonium tetrafluoroborate (71 mmol) in 154.8 g triethyl orthoformate (1.05 mol) is heated for 20 hours at 100°C in a reactor fitted with a Dean-Stark separator and condenser. The reaction mixture is cooled to 15°C and the precipitate is rinsed with cold triethyl orthoformate and heptane. The crude product is dissolved in 600 ml of dichloromethane, filtered, and the filtrate concentrated under vacuum. The title product is obtained as a brown powder (yield: 24 g (85%)).

¹H-NMR (300 MHz, d₆-DMSO): δ = 10.74 (s, 1H), 8.61 (s, 2H), 8.30 (m, 2H), 8.05 (m, 4H), 7.85 (m, 6H), 7.71 (m, 2H).

### c) Synthesis of N2,N3-bis(4-isopropylphenyl)quinoxaline-2,3-diamine (XXVII-a)

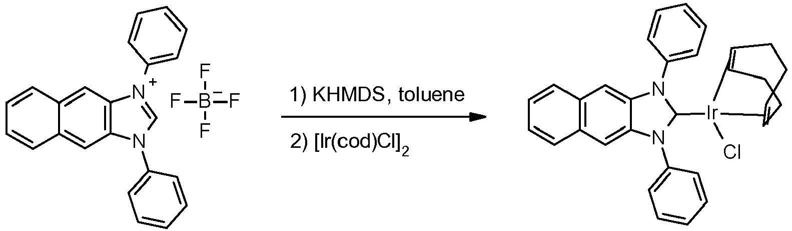

5.00 g (12.2 mmol) of 1,3-diphenylbenzo[f]benzimidazol-3-ium tetrafluoroborate are suspended in 100 ml of toluene and cooled down to -13°C. 24.5 ml (12.3 mmol) of potassium bis(trimethylsilyl)amide solution (KHMDS, 0.5M in toluene) are added within 20 minutes. The cooling bath is removed and the suspension stirred during one hour until room temperature is reached. The orange suspension is treated with 4.11 g (6.12 mmol) of chloro(1,5-cyclooctadiene)iridium(I) dimer and 50 ml of toluene, and then heated at 66°C during one hour. The hot reaction mixture is filtered through a 3 cm layer of Hyflo® filter aid, and the filter aid layer rinsed with 30 ml of toluene. The combined eluents are concentrated under vacuum, and the black residue stirred in 100 ml of ethanol during 15 minutes. The resulting suspension is filtered, the solid washed with 30 ml of ethanol, followed by drying under vacuum, giving the title product as a greenish yellow solid (yield: 4.54 g (56%)).

¹H-NMR (400 MHz, d₆-DMSO): δ = 1.19-1.49 (m, 6 H), 1.57-1.71 (m, 2 H), 2.58-2.66 (m, 2 H), 4.28-4.37 (m, 2 H), 7.47-7.54 (m, 2 H), 7.63-7.76 (m, 2 H), 7.88 (s, 2 H), 8.05-8.11 (m, 2 H), 8.11-8.17 (m, 4 H).

### d) Synthesis of complex (XXVII)

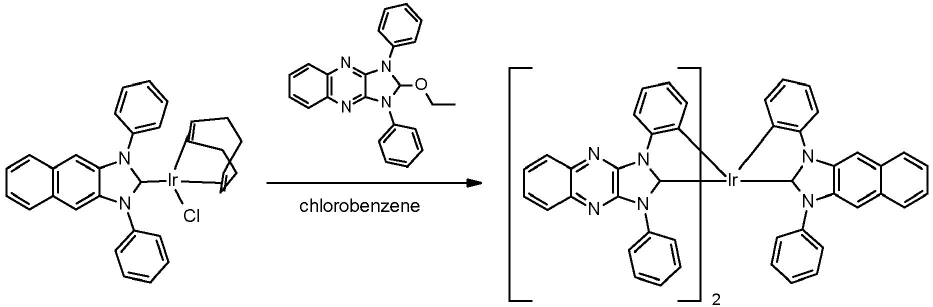

4.00 g (6.10 mmol) of complex intermediate (XXVII-a) and 9.00 g (24.4 mmol) of 2-ethoxy-1,3-diphenyl-2H-imidazo[4,5-b]quinoxaline are dissolved under argon in 100 ml of chlorobenzene. The dark solution is three times evacuated and backfilled with argon, followed by heating at 126°C during 23 hours. The reaction mixture is treated with 100 ml of DMF and then cooled down to room temperature, followed by stirring at ice-bath temperature during 30 minutes. The suspension is filtered and the resulting solid washed with 20 ml of DMF. The solid is further stirred in 20 ml of DMF, and the resulting suspension filtered, followed by stirring the solid two times in 30 ml of ethanol first, and then two times in 30 ml of heptane. The suspension is filtered and the solid dried under vacuum. The solid is dissolved in 80 ml of hot NMP. The brownish yellow solution is cooled down to room temperature and the resulting suspension stirred during 30 minutes. The suspension is filtered, the solid washed with 20 ml of NMP first, then 50 ml of ethanol and 50 ml of heptane, followed by drying under vacuum. The yellow solid is stirred in 1 L of dichloromethane during one hour, followed by filtration. The filtrate is treated with 10 g of Hyflo® filter aid, and concentrated under vacuum. The solid Hyflo®-product mixture is subjected to further purification by chromatography (silica gel, dichloromethane/toluene), giving the title product as a yellow solid (yield: 1.73 g (25%)).

APCI-LC-MS (positive, m/z): exact mass of C₆₅H₄₁IrN₁₀ = 1154.31; found 1155.4 [M+1]⁺.

¹H-NMR (400 MHz, CD₂Cl₂): δ = 6.04-7.63 (br. signal, 8 H), 6.44 (m, 2 H), 6.54-6.78 (m, 7 H), 6.79-6.91 (m, 4 H), 7.17-7.34 (m, 3 H), 7.39 (t, 1 H), 7.48 (t, 1 H), 7.57 (t, 1 H), 7.67-7.80 (m, 3 H), 7.80-7.96 (m, 4 H), 8.17 (d, 1 H), 8.24 (d, 1 H), 8.35 (t, 2 H), 8.64 (s, 1 H), 9.03 (d, 1 H), 9.10 (d, 1 H).

### Synthesis Example 28. Synthesis of complex (XXVIII)

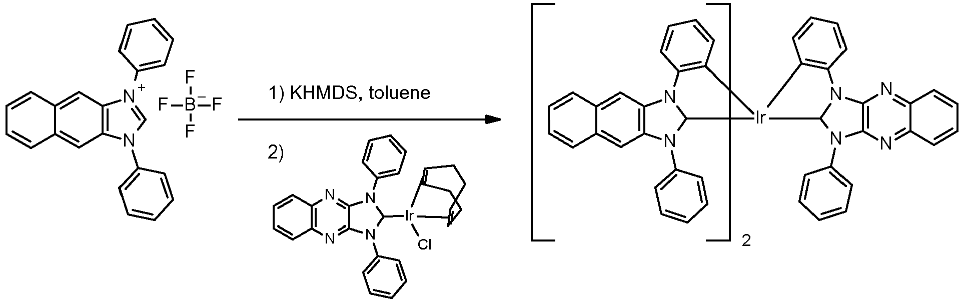

A suspension of 9.40 g (23.0 mmol) of 1,3-diphenylbenzo[f]benzimidazol-3-ium tetrafluoroborate in 150 ml of toluene is cooled down to -12°C. 46.1 ml (23.1 mmol) of potassium bis(trimethylsilyl)amide solution (KHMDS, 0.5M in toluene) are added within 25 minutes at a maximum temperature of -9°C. The cooling bath is removed and stirring continued until room temperature is reached. The red suspension is treated with 3.80 g (5.76 mmol) of complex intermediate (VIII-a), and heated under reflux during 75 minutes. The hot orange-brown suspension is filtered through a 3 cm layer of Hyflo® filter aid, and the filter aid rinsed with 30 ml of toluene. The combined eluents are diluted with 600 ml of ethanol and stirred during 45 minutes. The suspension is filtered, the solid washed with ethanol, followed by drying under vacuum. The solid is further purified by chromatography (silica gel, dichloromethane/heptane), giving the title product as a yellow solid (yield: 3.49 g (53%)).

APCI-LC-MS (positive, m/z): exact mass of C₆₇H₄₃IrN₈ = 1152.32; found 1153.3 [M+1]⁺.

¹H-NMR (400 MHz, CD₂Cl₂): δ = 6.26-7.63 (br. signal, 4 H), 6.27-6.50 (m, 4 H), 6.57 (t, 1 H), 6.61-6.88 (m, 12 H), 6.90 (s, 1 H), 7.15-7.32 (m, 3 H), 7.34-7.60 (m, 5 H), 7.65-7.94 (m, 5 H), 8.10-8.28 (m, 4 H), 8.32 (dd, 1 H), 8.61 (d, 2 H), 9.03 (dd, 1 H).

### Synthesis Example 29. Synthesis of complex (XXIX)

### a) Synthesis of 1,3-diphenylimidazol-1-ium tetrafluoroborate

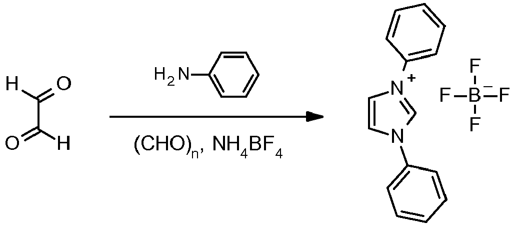

A solution of 50.0 g (0.34 mol) of a 40% aqueous glyoxal solution, 65.3 g (0.70 mol) of aniline and 500 ml of ethyl acetate is stirred over an ice-bath during one hour. The ice-bath is removed and the reaction mixture stirred at room temperature during one hour. The light orange solution is slowly treated at ice-bath temperature with an ice-cold suspension of 5.20 g of paraformaldehyde in 120 ml of 1,4-dioxane and 52 g of concentrated aqueous hydrochloric acid, followed by stirring during 20 minutes. The ice-bath is removed and stirring continued until room temperature is reached, followed by stirring during one hour at room temperature. The resulting suspension is treated with 500 ml of saturated aqueous sodium hydrogencarbonate solution first, then filtered, and the solid washed with ethyl acetate. The water phase is separated of the filtrate solution, and two times washed with 100 ml of ethyl acetate. The water phase is further treated with 45.4 g of 48% aqueous solution of tetrafluoroboric acid and stirred for a short time. The resulting suspension is filtered and the solid dried under vacuum, giving the title product as a white solid (yield: 22.7 g (21%)).

¹H-NMR (400 MHz, d₆-DMSO): δ = 7.65 (t, 2 H), 7.73 (t, 4 H), 7.93 (d, 4 H), 8.58 (d, 2 H), 10.34 (s, 1 H).

### b) Synthesis of complex intermediate (XXIX-a)

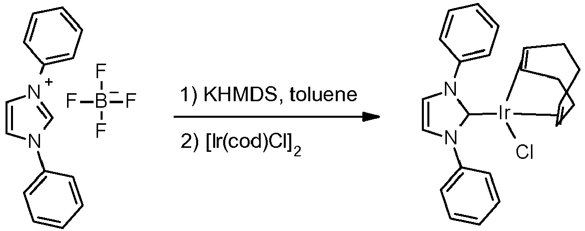

0.92 g (14.0 mmol) of 1,3-diphenylimidazol-1-ium tetrafluoroborate are suspended under argon in 15 ml of toluene and cooled down to -10°C. 6.0 ml (3.0 mmol) of potassium bis(trimethylsilyl)-amide solution (KHMDS, 0.5M in toluene) are dropwise added at a max. temperature of -8°C. The cooling bath is removed and the suspension stirred until room temperature is reached. The orange suspension is dropwise added to a preheated brownish solution of 1.00 g (1.49 mmol) of chloro(1,5-cyclooctadiene)iridium(I) dimer in 15 ml of toluene at 74°C, and stirring continued at the same temperature during two hours. The warm orange suspension is diluted with 50 ml of toluene and filtered through a 3 cm layer of silica gel and the silica gel layer rinsed with toluene. The collected fractions are concentrated under vacuum and the resulting solid dissolved in a minimal amount of dichloromethane, followed by the addition of 30 ml of ethanol. The solution is concentrated until a suspension is generated. The suspension is filtered, the solid washed with cold ethanol and dried under vacuum, giving the title compound as a yellow solid (yield: 0.64 g (39%)).

¹H-NMR (400 MHz, CD₂Cl₂): δ = 1.17-1.31 (m, 2 H), 1.40-154 (m, 4 H), 1.74-1.89 (m, 2 H), 2.37-2.45 (m, 2 H), 4.40-4.48 (m, 2 H), 7.39 (s, 2 H), 7.47-7.61 (m, 6 H), 8.11-8.18 (m, 4 H).

### c) Synthesis of complex (XXIX)

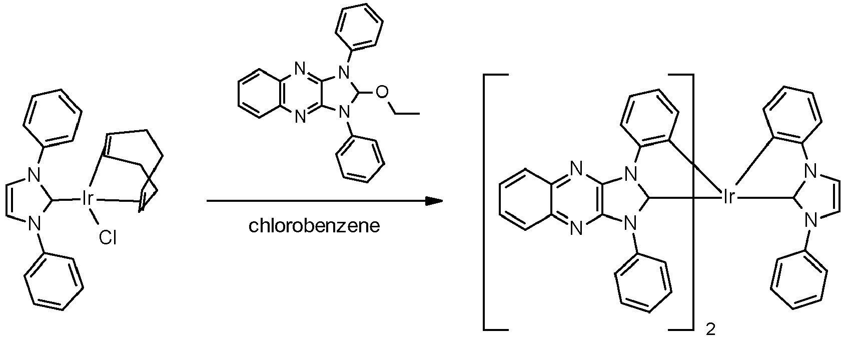

0.50 g (0.90 mmol) of complex intermediate (XXIX-a) and 1.34 g (3.64 mmol) of 2-ethoxy-1,3-diphenyl-2H-imidazo[4,5-b]quinoxaline are dissolved under argon in 25 ml of chlorobenzene. The yellow solution is three times evacuated and backfilled with argon, followed by heating at 116°C during 16 hours. The reaction mixture is cooled down to room temperature and treated with 20 ml of ethanol, followed by stirring during 30 minutes. The suspension is filtered, the solid washed with ethanol first, followed by washing with heptane. The collected filtrates are concentrated under vacuum, and further purified by chromatography (silica gel, dichloromethane/heptane). The pure product fractions are collected and concentrated under vacuum, until a suspension is formed. The suspension is filtered, the solid washed with ethanol, followed by drying under vacuum, giving the title produt as a yellow solid (yield: 0.3 g (32%)).

APCI-LC-MS (positive, m/z): exact mass of C₅₇H₃₇IrN₁₀ = 1054.28; found 1055.2 [M+1]⁺.

¹H-NMR (400 MHz, CD₂Cl₂): δ = 6.21-7.66 (br. signals, 8 H), 6.35 (dd, 2 H), 6.48 (tt, 1 H), 6.55 (d, 1 H), 6.56-6.65 (m, 3 H), 6.66-6.90 (m, 7 H), 7.10 (td, 1 H), 7.24 (td, 2 H), 7.40 (m, 1 H), 7.49 (d, 1 H), 7.68-7.88 (m, 5 H), 7.93 (dd, 1 H), 8.29 (dd, 1 H), 8.34 (dd, 1 H), 8.97 (dd, 1 H), 9.08 (dd, 1 H).

### Synthesis Example 30. Synthesis of complex (XXX)

### a) Synthesis of complex intermediate (XXX-a)

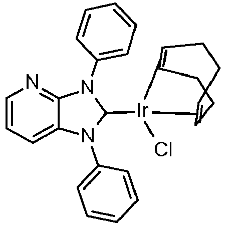

0.50 g (1.64 mmol) of 1,3-Diphenyl-imidazo[4,5-b]pyridiniumchloride (synthesis described in WO2011/073149, example 26) are dissolved in 10 ml toluene and cooled to -10°C. 3.28 ml (1.64 mmol) of a 0.5M KHMDS solution in toluene are added to the solution within five minutes. The solution is stirred another five minutes und then slowly warmed up to room temperature. 0.55 g (0.82 mmol) µ-chloro-1,5-cyclooctadien-iridium(I) dimer are added to the reaction mixture. After heating the suspension to 60°C it is held at that temperature for 20.5 hours. The suspension is cooled to room temperature and then filtered through *Decalite Speed.* The filtrate is washed with water and then with brine. The organic solution is dried with magnesium sulfate and filtered. The solution is concentrated under vacuum. The solid (0.83 g) is dissolved in dichloromethane and adsorbed on 2 g of *Decalite Speed.* The solid is filtered off and further purified by MPLC with the *CombiFlash Companion* (silica gel, ethyl acetate/n-heptane), giving the title product as a yellow solid (yield: 0.21 g (21%)).

¹H-NMR (500 MHz, CD₂Cl₂): δ [ppm] = 1.29-1.34 (m, 2H), 1.29-1.52 (m, 4H), 1.74 (mc, 2H), 2.50-2.59 (m, 2H), 4.48 (mc, 2H), 7.25 (mc, 1H), 7.54-7.66 (m, 7H), 8.05 (mc, 2H), 8.12 (mc, 2H), 8.32 (mc, 1H).

### b) Synthesis of complex (XXX)

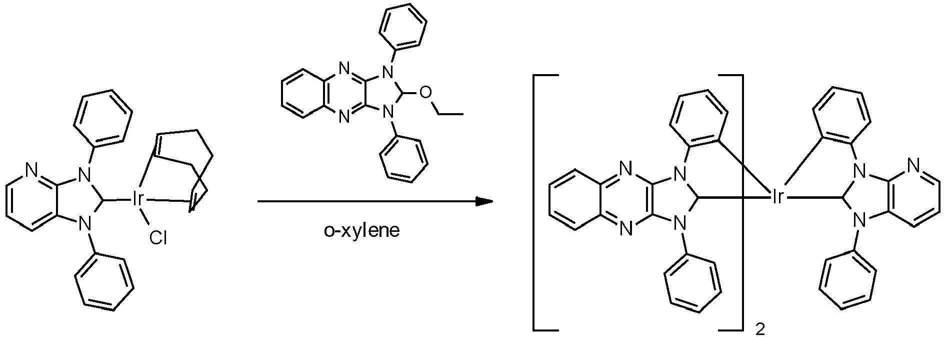

0.40 g (0.66 mmol) of complex intermediate (XXX-a) and 0.49 g (1.32 mmol) 2-ethoxy-1,3-diphenyl-2H-imidazo[4,5-b]quinoxaline are dissolved in 20 ml o-xylene. The solution is heated to 115°C and held at that temperature for 21.5 hours. After cooling the reaction mixture to room temperature it is evaporated to dryness. The solid is added to ethyl acetate. After the suspension has been filtered the filtrate is evaporated to dryness. The solid is purified by MPLC with the *CombiFlash Companion* (silica gel, ethyl acetate/n-heptane). After evaporating the solvent the solid is recrystallized in toluene. The solid is filtered, and dried under vacuum, giving the title product as a yellow solid (yield: 20 mg (3 %)).

ESI-LC/MS (positive, m/z): exact mass of C₆₀H₃₈IrN₁₁ = 1105.29; found 1106.3 [M + H]⁺. ¹H-NMR (500 MHz, CD₂Cl₂): δ [ppm] = 6.28-7.36 (m; 26H), 7.72 (mc; 2H), 7.76-7.88 (m; 4H), 8.30 (mc; 2H), 8.41 (mc; 1H), 9.02 (mc, 3H).

### Synthesis Example 31. Synthesis of complex (XXXI)

### a) Synthesis of 2-ethoxy-1-(o-tolyl)-3-phenyl-6-(trifluoromethyl)-2H-imidazo[4,5-b]pyridine

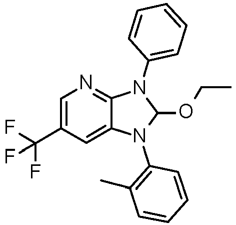

5.32 g (14.0 mmol) HCl-Adduct of 2,3-dianilino-5-trifluoromethyl-pyridine are heated in 45 g triethyl orthoformate at 120°C for 16 h. The reaction mixture is evaporated to dryness in vacuum. 6.39 g oil are obtained containing small amounts of triethyl orthoformate.

### b) Synthesis of complex intermediate (XXXI-a)

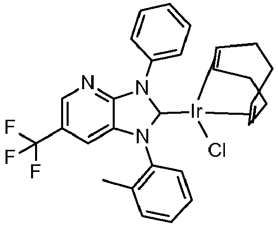

A solution of 6.39 g of 2-ethoxy-1-(o-tolyl)-3-phenyl-6-(trifluoromethyl)-2H-imidazo[4,5-b]pyridine and 4.49 g (6.68 mmol) µ-chloro-cyclooctadien-iridium dimer in 75 ml toluene is heated at 55°C for 50 min. The reaction mixture is evaporated to dryness in vacuum. 50 ml ethanol are added to the residue. The mixture is stirred during five minutes and then filtered. The solid is dried under vacuum giving the title product as a solid (yield: 5.32 g).

### c) Synthesis of complex (XXXI)

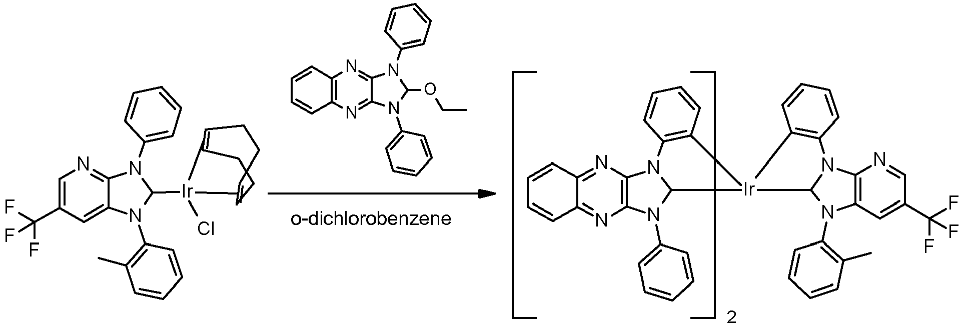

A solution of 12.83 g (34.8 mmol) complex intermediate (XXXI-a) and 8.00 g 2-ethoxy-1,3-diphenyl-2H-imidazo[4,5-b]quinoxaline in 300 ml o-dichlorobenzene is heated at 150°C for one hour. After cooling the reaction mixture to room temperature the suspension is filtered. The residue is purified by MPLC with *CombiFlash Companion* (silica gel, dichloromethane/n-heptane), giving the title product as a yellow solid (yield: 2.80 g (20%)).

MALDI-MS (positive, m/z): exact mass of C₆₂H₃₉F₃IrN₁₁ = 1187.30; found 1187 [M + H]⁺

¹H-NMR (500 MHz, d₆-DMSO): δ [ppm] = 0.77 (s; 3H), 6.20 (mc; 1H), 6.50-6.65 (m; 5H), 6.68-6.78 (m; 4H), 6.82 (mc; 1H), 6.90-7.23 (m; 9H), 7.78 (mc, 2H), 7.81-7.90 (m; 4H), 8.25 (mc; 1H), 8.31 (mc; 1H), 8.72 (mc; 1H), 8.81 (mc; 1H), 8.84 (mc; 1H), 8.95 (mc; 1H).

### Synthesis Example 32. Synthesis of complex (XXXII)

### a) Synthesis of phenanthrene-9,10-dione oxime

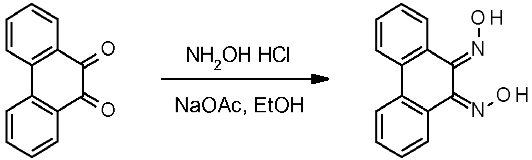

12.6 g (61 mmol) 9,10-Phenthrenedione, 16.9 g (243 mmol) hydroxylamine hydrochloride, 12.5 g (152 mmol) sodium acetate and 250 ml ethanol are heated under reflux over night. After cooling to room temperature the precipitate is filtered off. The solid residue is suspended in water (50 ml) and filtered off. It is washed with water and petroleum spirits. The crude product is recrystallized from methanol. Isomers of phenanthrene-9,10-dione oxime are obtained as light-orange solid (yield: 11.9 g (83%)).

¹H-NMR (400 MHz, d₆-DMSO): δ = 7.43-7.50 (m, 2 H), 7.52-7.60 (m, 2 H), 7.80 + 7.85 (2 x d, 1H), 8.09-8.15 (m, 2 H), 8.46-8.49 (m, 1 H), 12.20 + 12.24 + 12.31 + 12.49 (4 x s, 2 H).

### b) Synthesis of phenanthrene-9,10-diamine hydrochloride

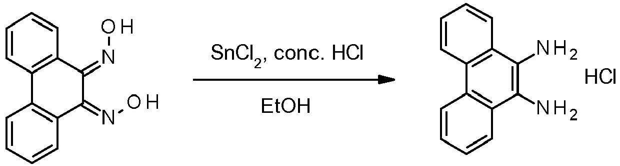

3.4 g (14.3 mmol) of phenanthrene-9,10-dione oxime are dissolved in refluxing ethanol (135 ml). The solution is cooled below 70 °C and 14.9 g (78.5 mmol) SnCl₂ dissolved in 135 ml hydrochloric acid (32%) are added dropwise within 10 minutes. The reaction mixture starts to reflux upon the exothermic reaction. The reaction is refluxed for additional 10 minutes. After cooling to room temperature the precipitate is filtered off and is washed with ethanol. The crude product is directly used in the next reaction.

### c) Synthesis of 1,4-dihydrophenanthro[9,10-b]pyrazine-2,3-dione

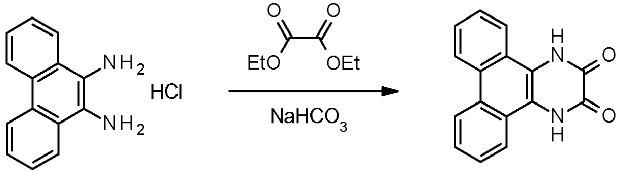

3.5 g (14.3 mmol) of crude phenanthrene-9,10-diamine hydrochloride and 9.34 g (111 mmol) NaHCO₃ are suspended in 140 ml diethyl oxalate. The mixture is heated to 130°C overnight.

After cooling to room temperature the precipitate is filtered off. The residue is suspended in 100 ml water and filtered off. The solid is washed with ethanol and dried under vacuum. 1,4-Dihydro-phenanthro[9,10-b]pyrazine-2,3-dione is obtained as light-orange powder (yield: 481 mg (13% w.r.t. phenanthrene-9,10-dione oxime)).

¹H-NMR (500 MHz, d₆-DMSO): δ = 7.71-7.77 (m, 4 H), 8.69 (d, 2 H), 8.91 (d, 2 H), 12.17 (s, br, 2 H).

### d) Synthesis of 2,3-dichlorophenanthro[9,10-b]pyrazine

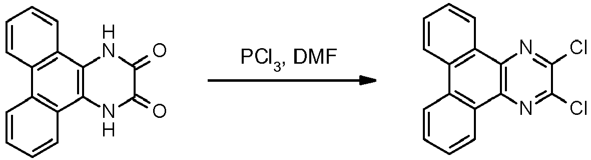

600 mg (2.29 mmol) of 1,4-dihydrophenanthro[9,10-b]pyrazine-2,3-dione are dissolved in 9 ml DMF under argon. 4 ml (6.28 g, 20 mmol) PCl₃ are added dropwise and the reaction mixture is heated to 100°C for 3.5 h. After cooling to room temperature the reaction mixture is quenched with water. The precipitate is filtered off and washed with ethanol. After drying under vacuum 2,3-dichlorophenanthro[9,10-b]pyrazine is obtained as light-brown solid (yield: 539 mg (78%)). ¹H-NMR (400 MHz, d₆-DMSO): δ = 7.90 (t, 2 H), 7.99 (t, 2 H), 8.95-8.99 (m, 4 H).

### e) Synthesis of N2,N3-diphenylphenanthro[9,10-b]pyrazine-2,3-diamine

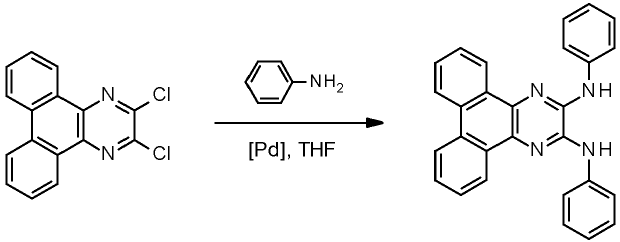

582 mg (1.95 mmol) of 2,3-dichlorophenanthro[9,10-b]pyrazine and 0.43 ml (435 mg, 2.4 mmol) aniline are dissolved in 5 ml THF under argon. The solution is degassed. 106 mg (0.12 mmol) BrettPhos Pd(II) (G3) and 63 mg (0.12 mmol) BrettPhos ligand are added. 4.7 ml LiHMDS (4.7 mmol in THF) are added dropwise within 5 minutes. Then, the reaction mixture is heated under reflux over night. After cooling to room temperature the reaction is quenched with ice and 1 M hydrochlorid acid. Solids are fitered off and the filtrate is diluted with 20 ml dichloromethane. The layers are separated and the aqueous layer is extracted with dichloromethane (2 x 20 ml). The combinded organic layers are washed with brine (20 ml) and dried over Na₂SO₄. The solvent is removed in vacuo. The crude product is recrystallized from methanol. N2,N3-Diphenyl-phenanthro[9,10-b]pyrazine-2,3-diamine is obtained as light-brown solid (yield: 435 mg (54%)). ¹H-NMR (400 MHz, d₆-DMSO): δ = 7.18 (t, 2 H), 7.54 (t, 4 H), 7.72-7.80 (m, 4 H), 8.04 (d, 4 H), 8.83-8.86 (m, 4 H), 9.20 (s, 2 H).

### f) Synthesis of (1,3-bisphenyl-2-ethoxy-2H-imidazo)phenanthro[9,10-b]pyrazine

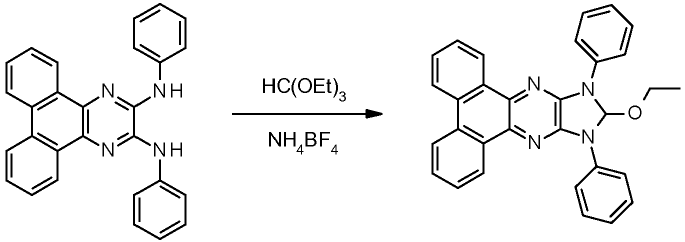

225 mg (0.55 mmol) of N2,N3-diphenylphenanthro[9,10-b]pyrazine-2,3-diamine, 2.5 ml (2.23 g, 15 mmol) triethyl orthoformate and 5 mg (0.05 mmol) NH₄BF₄ are heated to 135 °C with stirring for 10 h under argon. After cooling to room temperature the residue is suspended in ethanol and filtered off. After drying in vacuo (1,3-bisphenyl-2-ethoxy-2H-imidazo)phenanthro[9,10-b]pyrazine is obtained as light-brown solid (yield: 131 mg (51%)).

¹H-NMR (400 MHz, d₆-DMSO): δ = 0.96 (t, 3 H), 3.35 (H₂O peak + q, 2 H), 7.35 (t, 2 H), 7.68 (t, 4 H), 7.78 (t, 2 H), 7.84 (m, 2 H), 8. 09 (s, 1 H), 8.39 (d, 4 H), 8.89 (d, 2 H), 9.01 (d, 2 H).

### g) Synthesis of intermediate complex (XXXII-a)

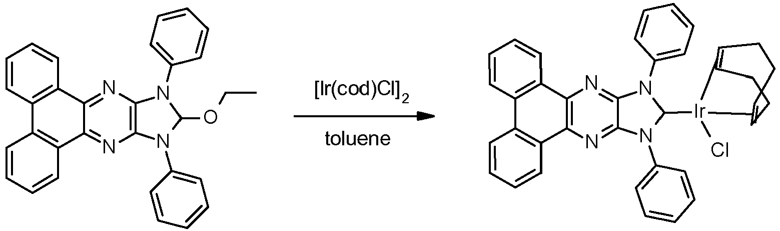

115 mg (0.24 mmol) of (1,3-bisphenyl-2-ethoxy-2H-imidazo)phenanthro[9,10-b]pyrazine and 84 mg (0.12 mmol) of chloro(1,5-cyclooctadiene)iridium(I) dimer are dissolved in 5 ml toluene. The suspension is degassed and subsequently heated to 80 °C. Upon heating a dark solution is obtained. Stirring at 80 °C is continued over night. After cooling a precipitate is formed and filtered off and the solid is washed with ethanol. Complex intermediate (XXXII-a) is obtained as a dark solid (yield: 130 mg (70%)).

¹H-NMR (400 MHz, CD₂Cl₂): δ = 1.36-1.44 (m, 2 H), 1.54 (H₂O peak + m, 2 H), 1.58-1.62 (m, 2 H), 1.79-1.87 (m, 2H), 2.63-2.64 (m, 2 H), 4.70-4.72 (m, 2 H), 7.66-7.76 (m, 8 H), 7.79-7.83 (m, 2 H), 8.37-8.40 (m, 4 H), 8.69 (d, 2 H), 9.09 (d, 2 H).

### h) Synthesis of complex (XXXII)

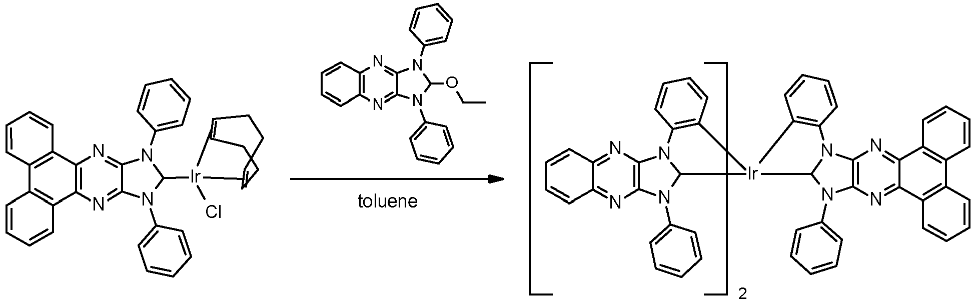

120 mg (0.16 mmol) of complex intermediate (**XXXII-a**) and 116 mg (0.32 mmol) of 2-ethoxy-1,3-diphenyl-2H-imidazo[4,5-b]quinoxaline are dissolved in 9 ml toluene under argon. The solution is degassed and subsequently heated to 100 °C with stirring over night. After cooling to room temperature the solvent is removed in vacuo and the residue is filtered through a short alumina column with cyclohexane/ethyl acetate (1:1). The solvent is again removed in vacuo and the crude product is purified by silica column chromatography with dichloromethane/hexane 4:1. The title product is obtained as yellow powder (yield: 8 mg (4%)).

HPLC-MS (positive, m/z): exact mass of C₇₁H₄₃IrN₁₂ = 1256.34; found 1257.5 [M+1]⁺.

¹H-NMR (400 MHz, CD₂Cl₂): δ = 6.35-7.02 (br, 12 H), 6.54 (t, 1 H), 6.59 (t, 1 H), 6.65-6.74 (m, 4 H), 6.83-6.91 (m, 4 H), 7.25 (t, 2 H), 7.35 (t, 1 H), 7.58 (t, 1 H), 7.69-7.76 (m, 2 H), 7.80-7.92 (m, 6 H), 8.31-8.35 (m, 2 H), 8.69 (d, 1 H), 8.72-8.76 (m, 2 H), 9.06 (d, 1H), 9.10 (d, 1H), 9.21 (d, 1H), 9.49 (d, 1H).

### Synthesis Example 33. Synthesis of complex (XXXIII)

### a) Synthesis of N6,N7-diphenylquinoxaline-6,7-diamine

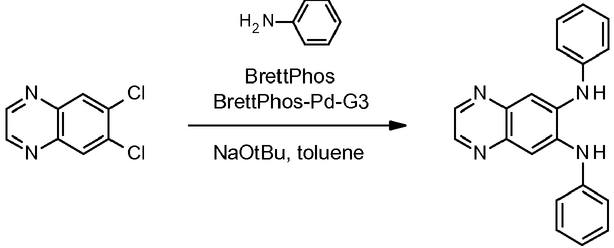

A suspension of 19.5 g of 6,7-dichloroquinoxaline (0.098 mol; prepared according to J. Chem. Soc., Perkin Trans. 1, 1999, 803), 20.2 g aniline (0.22 mol) and 25.2 g sodium *tert*-butoxide (0.26 mol) in 300 ml of anhydrous toluene is degassed by cooling down to -70°C in a dry ice/acetone bath under vacuum and backfilling with argon (repeated three times). Then 1.07 g (2 mmol) of BrettPhos ligand [= 2-(dicyclohexylphosphino)3,6-dimethoxy-2',4',6'-triisopropyl-1,1'-biphenyl, CAS No. 1070663-78-3] and 1.60g (2 mmol) of BrettPhos-Pd-G3 palladacycle {= [(2-di-cyclohexylphosphino-3,6-dimethoxy-2',4',6'- triisopropyl-1,1'-biphenyl)-2-(2'-amino-1,1'-biphenyl)]palladium(II) methanesulfonate methanesulfonate, CAS No. 1470372-59-8} are added and degassing repeated. The thick suspension is heated for 18 hours at 100°C (propeller stirrer), cooled to room temperature, filtered (very slow), and rinsed with ca. 200 ml of dichloromethane. The filtrate is acidified with 10% aqueous hydrogen chloride (100 ml) and the precipitated salt is filtered and rinsed with water. The red-brown solid is taken up in 350 ml of dichloromethane and stirred during 30 min with 250 ml of saturated aqueous sodium hydrogen carbonate. The organic phase is separated, extracted with water first, then 1% aqueous sodium cyanide solution, followed by water (3x), dried over magnesium sulfate, and concentrated under vacuum. The crude product is purified by chromatography (1.1 kg neutral aluminum oxide, heptane/ethyl acetate 1:1) to give the title product as a yellow-brown solid (yield: 18.6 g (61%)).

¹H-NMR (300 MHz, CDCl₃): δ = 8.57 (s, 2H), 7.79 (s, 2H), 7.37 (m, 4H), 7.19 (m, 4H), 7.10 (m, 2H), 6.03 (s, 2H).

### b) Synthesis of 1,3-diphenylimidazo[4,5-g]quinoxalin-3-ium tetrafluoroborate

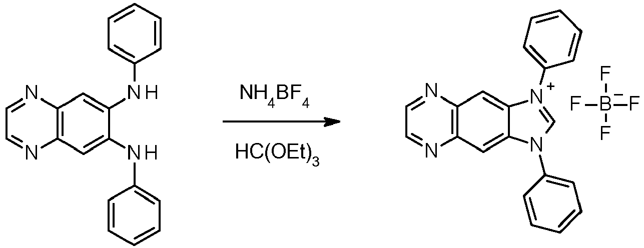

A suspension of 18.64 g of N6,N7-diphenylquinoxaline-6,7-diamine (0.06 mol) and 6.38 g of ammonium tetrafluoroborate (0.06 mol) in 190 ml triethyl orthoformate is heated for six hours at a temperature of 100-122°C in a reactor fitted with a Dean-Stark separator and condenser. After cooling to room temperature, the precipitated product is filtered and rinsed successively with cold triethyl orthoformate and heptane, then dried under vacuum. The title product is obtained as a red-brown solid (yield: 20.64 g (84%)).

¹H-NMR (300 MHz, d₆-DMSO): · = 10.94 (s, 1H), 9.18 (s, 2H), 8.63 (s, 2H), 8.08 (m, 4H), 7.85 (m, 4H).

### c) Synthesis of complex intermediate (XXXIII-a)

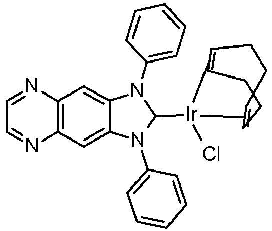

9.46 g (23.1 mmol) of 1,3-Diphenyl-imidazo[4,5-g]quinoxalinium-tetrafluoroborate and 7.75 g (11.5 mmol) of µ-chloro-1,5-cyclopentadiene-iridium(I) dimer are suspended in 310 ml of toluene. The suspension is heated to 60°C. 46.1 ml of a0.5M (23.1 mmol) solution of potassium bis(trimethylsilyl)amide in toluene are added within 25 minutes to the reaction mixture and stirred at 60°C for 15 min. 15 g of Diatomaceous earth are added to the reaction mixture at 60°C. The solid is filtered off and washed four times with 25 ml of warm toluene (50-60°C). The filtrate is concentrated under vacuum. The solid is stirred in 90 ml ethanol for one hour, then filtered off, washed three times with 10 ml of ethanol, and then washed three times with 10 ml n-pentane, and dried under vacuum in a drying cabinet at 60°C for 17 hours. 10.8 g dark brown solid are obtained.

¹H-NMR (500 MHz, CD₂Cl₂): δ [ppm] = 1.34 (mc; 2H), 1.42-1.56 (m; 4H), 1.73 (mc; 2H), 2.63 (mc; 2H), 4.52 (mc; 2H), 7.67 (mc; 6H), 7.94 (mc; 2H), 8.13 (mc; 4H), 8.80 (mc; 2H).

### d) Synthesis of complex (XXXIII)

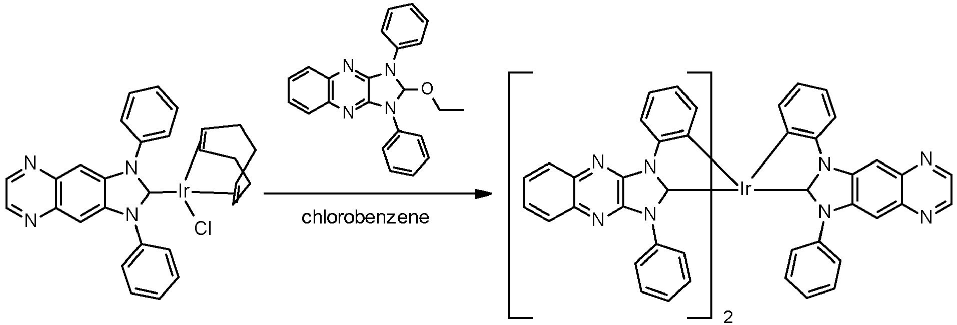

2.16 g (2.95 mmol) of complex intermediate (XXXIII-a) and 4.35 g (11.8 mmol) 2-ethoxy-1,3-diphenyl-2H-imidazo[4,5-b]quinoxaline are added to 70 ml of chlorobenzene. The suspension is heated to 125°C and is held at that temperature for 22 hours. After cooling the reaction mixture to room temperature the precipitate is filtered off. The filtrate is evaporated to dryness in an attenuated vacuum. The solid is washed three times with 2 ml of chlorobenzene, then three times with 3 ml n-pentane, and dried under vacuum in a drying cabinet at 60°C for 3 hours. 0.33 g brown solid are obtained. The solid is dissolved in 90 ml of dichloromethane and purified by MPLC with the *CombiFlash Companion* (silica gel, dichloromethane/methanol 98 : 2). The obtained solid (0.26 g) is heated in 5 ml of acetonitrile. The suspension is filtered hot. The precipitate is washed twice with 1 ml of hot acetonitrile each, and then washed twice with 1 ml of hot THF, and dried under vacuum in a drying cabinet at 60°C for 17 hours. 0.21 g yellow solid are obtained which are recrystallized from chlorobenzene. The filtered precipitation is washed with a small amount of chlorobenzene and n-pentane. The solid is dried under vacuum in a drying cabinet at 60°C for 65 hours, giving the title product as a yellow solid (yield: 80 mg).

¹H-NMR (400 MHz, CD₂Cl₂): δ [ppm] = 6.40 (mc; 2H), 6.55-6.85 (m; 15H), 7.11 (mc; 1H), 7.24 (mc; 4H), 7.40 (mc; 2H), 7.74 (mc; 2H), 7.79-7.90 (m; 5H), 8.20 (mc; 1H), 8.33 (mc; 2H), 8.76 (mc; 1H), 8.82 (mc;1H), 8.89 (mc; 1H), 9.02 (mc; 1H), 9.08 (mc; 1H).

### Synthesis of Comparitive Examples

### Comparative Synthesis Example 1. Synthesis of comparative complex (CC-1)

Desribed in WO2014/147134

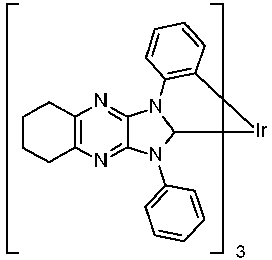

The synthesis of the comparitive complex **CC-1** is described in WO2014/147134 (example BE-12).

### Comparative Synthesis Example 2. Synthesis of comparative complex (CC-2)

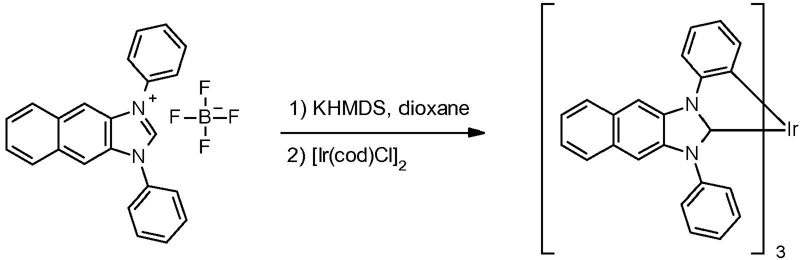

9.12 g (22.3 mmol) of 1,3-diphenylbenzo[f]benzimidazol-3-ium tetrafluoroborate in 200 ml dioxane are three times evacuated and backfilled with argon. 53.6 ml (26.8 mmol) of potassium bis(trimethylsilyl)amide solution (KHMDS, 0.5M in toluene) are added at room temperature within 15 minutes. The orange-red-suspension is heated up to 67°C and treated with 1.50 g (2.23 mmol) of chloro(1,5-cyclooctadiene)iridium(I) dimer, followed by heating at 101°C during 22 hours. The reaction mixture is cooled down to 80°C and filtered. The solid is washed with dioxane and acetone, followed by drying under vacuum. The solid is suspended in 1.5 L of dichloromethane and filtered through a 5 cm layer of silica gel, followed by rinsing the silica gel layer with 200 ml of dichloromethane. The combined eluents are treated with 200 ml of acetone and concentrated under vacuum until a suspension formed. The suspension is filtered, the solid washed with acetone, followed by drying under vacuum, giving the title product as a light yellow solid (yield: 3.34 g (65%)).

APCI-LC-MS (positive, m/z): exact mass of C₆₉H₄₅IrN₆ = 1150.33; found 1151.4 [M+1]⁺.

¹H-NMR (400 MHz, CD₂Cl₂): δ = 6.36 (br. d, 6 H), 6.61-6.67 (m, 3 H), 6.69 (dd, 3 H), 6.76 (td, 3 H), 6.82 (br. d, 3 H), 6.87 (s, 3 H), 7.18-7.25 (m, 3 H), 7.37-7.48 (m, 6 H), 7.50-7.57 (m, 3 H), 7.69 (d, 3 H), 8.14 (d, 3 H), 8.18 (d, 3 H), 8.59 (s, 3 H).

### Comparative Synthesis Example 3. Synthesis of comparative complex (CC-3)

### a) Synthesis of N2-methyl-N3-phenyl-quinoxaline-2,3-diamine

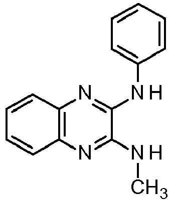

A suspension of 22.60 g (0.227 mol) 2-methylamino-3-chloro-quinoxaline which has been synthetized according to DE 1135471, 16.37 g (0.176 mol) aniline, and 1.06 g (0.006 mol) HBr 48 % are dissolved in 375 ml diethylenglycol by heating to 170 °C. The reaction mixture is held at that temperature for 15 min. After cooling the reaction mixture to room temperature the solid is filtered off, and then shortly stirred in 300 ml water. The solid is filtered off and dried in a vacuum drying cabinet at 60 °C. 15.69 g solid are obtained.

MALDI-MS (positive, m/z): exact mass of C₄₈H₃₃IrN₁₂ = 970.26; found 970 [M + H]⁺

¹H-NMR (400 MHz, D₆-DMSO): δ [ppm] = 3.22 (s; 3H), 7.13 (mc; 1H), 7.43 (mc; 4H), 7.60 (mc; 1H), 7.85 (mc; 1H), 8.07 (mc; 2H), 10.11 (s; 1H, broad), 10.64 (s; 1H, very broad).

### b) Synthesis of 2-ethoxy-1-methyl-3-phenyl-2H-imidazo[4,5-b]quinoxaline

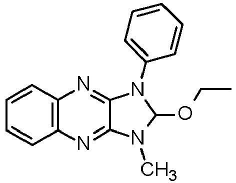

A solution of 11.80 g (47.1 mmol) N2-methyl-N3-phenyl-quinoxaline-2,3-diamine in 224 ml triethyl ortho-formiate is stirred at 90 °C for 24 h. After cooling the reaction mixture to 60 °C the solution is evaporated to dryness in an attenuated vacuum until 70 °C. The residue is stirred in diethylether for 1 h. The precipitate is filtered off, washed with diethylether, and is dried in a vacuum drying cabinet at 60 °C. 10.5 g solid are obtained

¹H-NMR (400 MHz, CD₃CN): δ [ppm] = 1.06 (t; 3H), 3.18 (s; 3H), 3.27 (q; 2H), 6.90 (s; 1H), 7.24 (mc; 1H), 7.32 (mc; 2H), 7.50 (mc; 2H), 7.56 (mc; 1H), 7.60 (mc; 1H), 8.10 (mc; 2H).

¹H-NMR (400 MHz, CD₃CN): · [ppm] = 1.06 (t; 3H), 3.18 (s; 3H), 3.27 (q; 2H), 6.90 (s; 1H), 7.24 (mc; 1H), 7.32 (mc; 2H), 7.50 (mc; 2H), 7.56 (mc; 1H), 7.60 (mc; 1H), 8.10 (mc; 2H).

### c) Synthesis of comparative complex (CC-3)

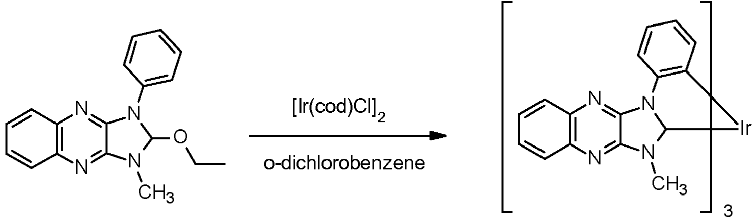

A solution of 10.40 g (33.95 mmol) of 2-ethoxy-1-methyl-3-phenyl-2H-imidazo[4,5-b]quinoxaline and 2.97 g (4.42 mmol) µ-chloro-cyclooctadien-iridium dimer in 130 ml o-dichlorobenzene is heated to 150 °C and stirred at that temperature for 21 h. After cooling the reaction mixture to room temperature the precipitate is filtered off, washed with o-dichlorobenzene, and dried in a vacuum drying cabinet at 60 °C. The solid is stirred in hot ethanol for 30 min. After cooling the suspension to room temperature the precipitate is filtered off, washed with n-pentane, and is dried in a vacuum drying cabinet at 80 °C. 8.60 g beige solid are obtained. 1.88 g of the beige solid are treated with 20 ml 1M aqueous HCl in 190 ml ethylmethylketone. The reaction mixture is heated at 70 °C for 29.5 h. After cooling the reaction mixture to 60 °C it is filtered. The residue is washed with n-pentane and dried at 60 °C in a vacuum drying cabinet. 1.80 g dark yellow solid is obtained. The solid is heated in 35 ml chlorobenzene under reflux for 1 h. The suspension is cooled to 110 °C and filtered. The residue is washed with warm chlorobenzene and then with n-pentane. The solid is dried at 150 °C at 6.5 x 10⁻² mbar for 7 h. 1.25 g (66 % of theory in two steps) yellow solid are obtained.

¹H-NMR (400 MHz, CD₂Cl₂): δ [ppm] = 3.59 (s; 9H), 6.55 (mc; 3H), 6.79 (mc; 3H), 7.16 (mc; 3H), 7.80 (mc; 6H), 8.10 (mc; 3H), 8.30 (mc; 3H), 8.93 (mc; 3H).

### II. Photoluminescence Examples

### Photoluminescence Examples A

### Determination of the photoluminescence Spectra (2% film in PMMA matrix)

The photoluminescence (PL) spectra of the complexes are measured on thin polymer films doped with the respective complexes. The thin films are prepared by the following procedure: a 10%-w/w polymer solution is made by dissolving 1 g of the polymer *"PMMA 6N"* (*Evonik*) in 9 g of dichloromethane, followed by stirring for one hour. 2 mg of the respective complexes are added to 0.098 g of the PMMA solution, and stirring continued for one minute. The solutions are casted by doctor-blading with a film applicator (*Model 360 2082, Erichsen*) with a 60 µm gap onto quartz substrates providing thin doped polymer films (thickness ca. 6 µm). The PL spectra and quantum-yields (Q.Y.) of these films are measured with the integrating-sphere method using the Absolute PL Quantum Yield Measurement System (*Hamamatsu, Model C9920-02*) (excitation wavelength: 370 nm).

### Determination of the lifetime of luminescence τ_{V}

The lifetime (τ_{V}) of the luminescence of the complexes in the prepared films are measured by the following procedure: For excitation of the emission a sequence of short laser pulses (THG Nd-YAG, 355 nm, 1 nsec pulse length, 1 kHz repetition rate) is used. The emissions are detected by the time-resolved photon-counting technique in the multi-channel scaling modus using a combination of photomultiplier, discriminator and a multiscaler card (*FAST ComTec GmbH, Model P7888*).

The PL Q.Y., λₘₐₓ, CIE x, y, and τ_{V} values of the photoluminescence measurements are included in the following tables.

| **Cpd.** | **Formula** | **PL Q.Y.** | **λₘₐₓ (nm)** | **CIE x, y** | **τ_{V} (µs)** |
|---|---|---|---|---|---|
| I | 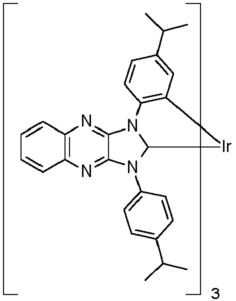 | 84% | 543 | 0.39, 0.58 | 1.7 |
| II | 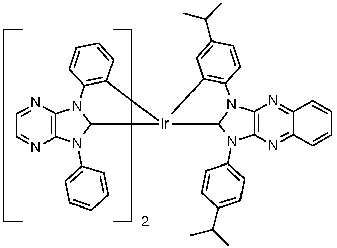 | 88% | 539 | 0.37, 0.59 | |

### Photoluminescence Examples B

### Determination of the photoluminescence Spectra

The photoluminescence (PL) spectra of the complexes are measured on thin polymer films doped with the respective complexes. The thin films are prepared by the following procedure: a 10%-w/w polymer solution is made by dissolving 1 g of the polymer *"PMMA 6N*" (*Evonik*) in 9 g of dichloromethane, followed by stirring for one hour. 2 mg of the respective complexes are added to 0.098 g of the PMMA solution, and stirring continued for one minute. The solutions are casted by doctor-blading with a film applicator (*Model 360 2082, Erichsen*) with a 60 µm gap onto quartz substrates providing thin doped polymer films (thickness ca. 6 µm). The PL spectra and quantum-yields (Q.Y.) of these films are measured with the integrating-sphere method using the Absolute PL Quantum Yield Measurement System (*Hamamatsu, Model C9920-02*) (excitation wavelength: 400 nm).

### Determination of the lifetime of luminescence τ_{V}

The lifetime (τ_{V}) of the luminescence of the complexes in the prepared films are measured by the following procedure: For excitation of the emission a sequence of short laser pulses (THG Nd-YAG, 355 nm, 1 nsec pulse length, 1 kHz repetition rate) is used. The emissions are detected by the time-resolved photon-counting technique in the multi-channel scaling modus using a combination of photomultiplier, discriminator and a multiscaler card (*FAST ComTec GmbH, Model P7888*).

The PL Q.Y., λₘₐₓ, CIE x, y color coordinates, full width at half maximum (FWHM) of the emission spectra, and τ_{V} values of the photoluminescence measurements in the iridium complex doped PMMA films are included in the following tables. Data of all emitters are given from PL measurements of 2% films in PMMA matrix, except for compound IV, of which the data are given from a PL measurement of a 1% film in PMMA matrix.

| **Cpd.** | **Formula** | **PL Q.Y.** | **λₘₐₓ (nm)** | **CIE x, y** | **FWHM (nm)** | **τ_{V} (µs)** |
|---|---|---|---|---|---|---|
| **I** | 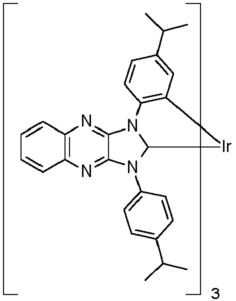 | 84% | 543 | 0.39, 0.58 | 80 | 1.7 |
| **II** | 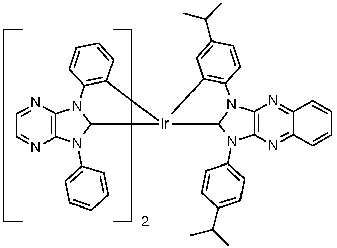 | 88% | 539 | 0.37, 0.59 | 83 | 2.8 |
| **IV O795** | 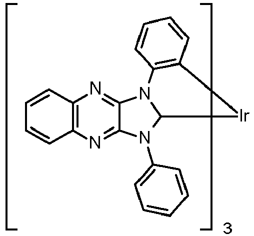 | 92% | 521 | 0.32, 0,62 | 73 | 2.4 |
| **V 035191** | 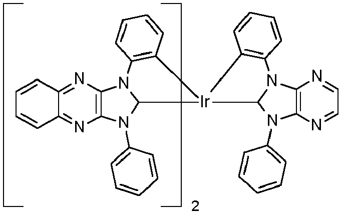 | 95% | 531 | 0.34, 0.61 | 78 | 2.1 |
| **VIa** | 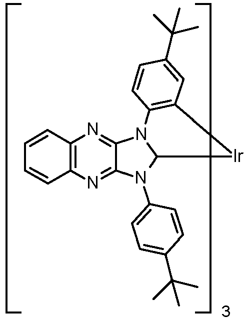 | 86% | 542 | 0.39, 0.59 | 86 | 1.8 |
| **VII** | 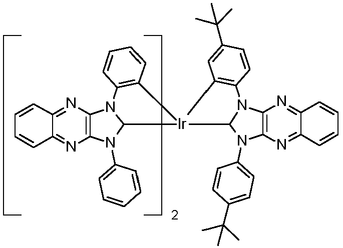 | 90% | 534 | 0.35, 0.61 | 76 | 2.1 |
| **VIII** | 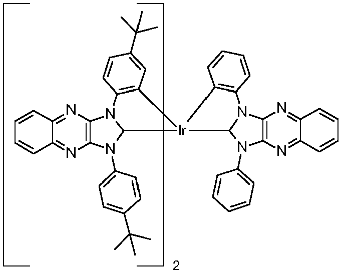 | 89% | 539 | 0.38, 0.59 | 79 | 1.8 |
| **X** | 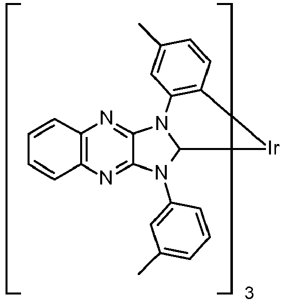 | 84% | 546 | 0.40, 0.57 | 85 | 1.1 |
| **XI** | 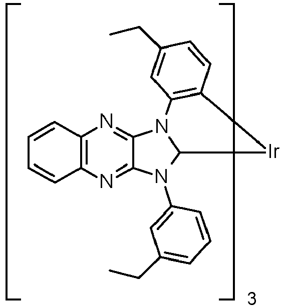 | 82% | 549 | 0.41, 0.57 | 85 | 1.4 |
| **XIII** | 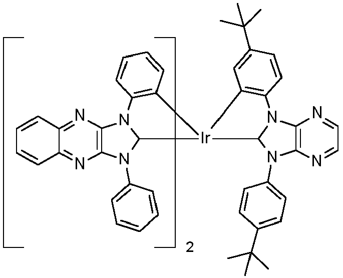 | 89% | 531 | 0.35, 0.61 | 79 | 2.2 |
| **XIV** | 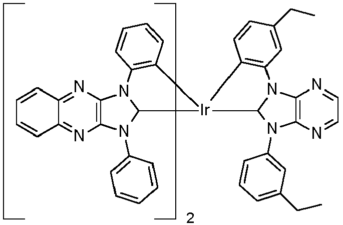 | 92% | 530 | 0.34, 0.61 | 78 | 1.9 |
| **XV** | 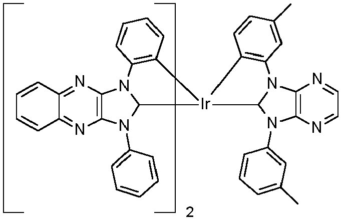 | 88% | 533 | 0.35, 0.61 | 78 | 1.9 |
| **XVI** | 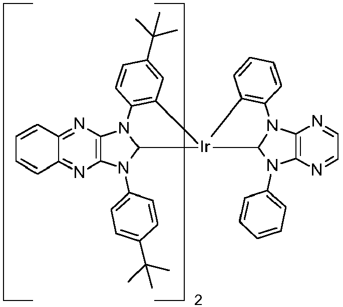 | 87% | 542 | 0.39, 0.59 | 80 | 2.3 |
| **XVII** | 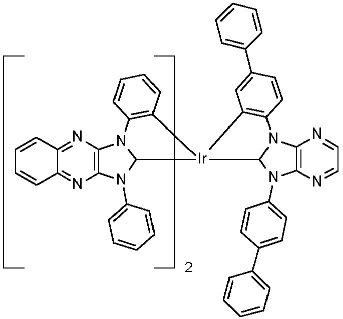 | 95% | 527 | 0.33, 0.61 | 76 | 2.4 |
| **XVIII** | 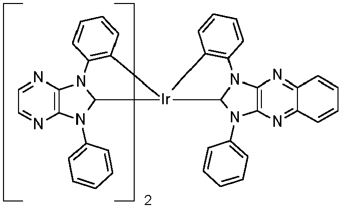 | 89% | 530 | 0.33, 0.61 | 79 | 2.3 |
| **XIX** | 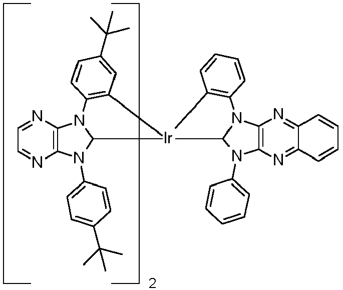 | 95% | 536 | 0.35, 0.61 | 79 | 1.9 |
| **XX** | 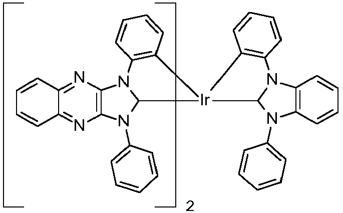 | 91% | 538 | 0.37, 0.60 | 80 | 1.4 |
| **XXI** | 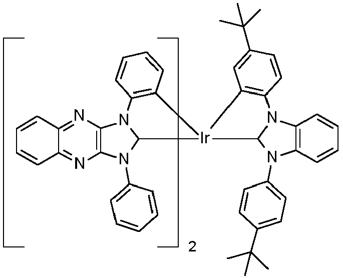 | 89% | 544 | 0.39, 0.59 | 81 | 1.2 |
| **XXII** | 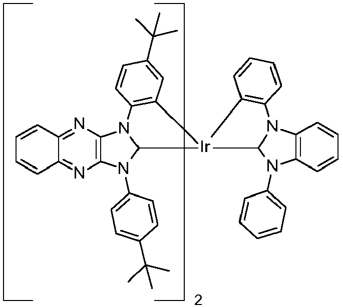 | 79% | 551 | 0.42, 0.56 | 82 | 1.3 |
| **XXIII** | 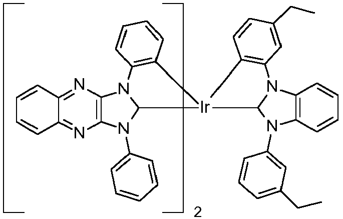 | 89% | 544 | 0.40, 0.58 | 82 | 1.5 |
| **XXIV** | 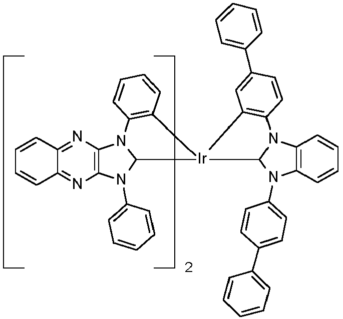 | 94% | 540 | 0.38, 0.59 | 81 | 1.5 |
| **XXV** | 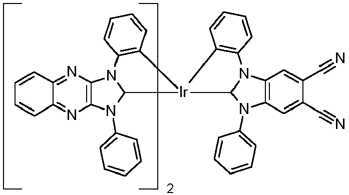 | 87% | 523 | 0.32, 0.62 | 74 | 2.6 |
| **XXVI** | 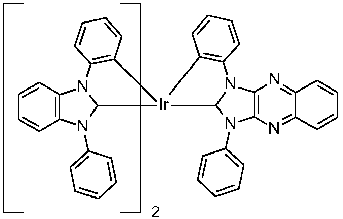 | 86% | 553 | 0.43, 0.56 | 90 | 1.2 |
| **XXVII** | 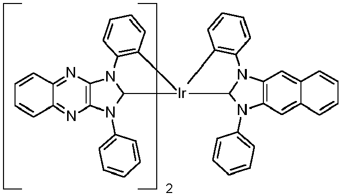 | 90% | 535 | 0.36, 0.60 | 79 | 2.3 |
| **XXVIII** | 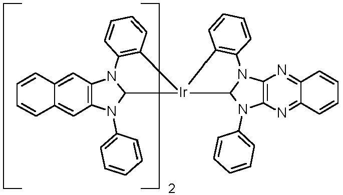 | 87% | 542 | 0.38, 0.59 | 84 | 2.9 |
| **XXIX** | 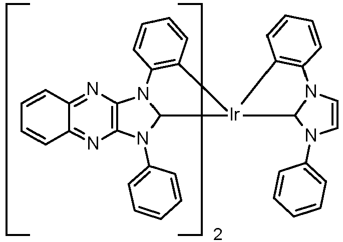 | 84% | 548 | 0.40, 0.57 | 85 | 1.1 |
| **XXX** | 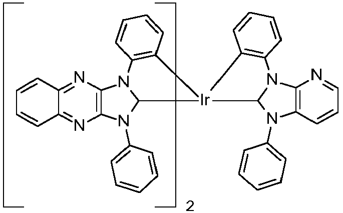 | 91% | 536 | 0.36, 0.60 | 79 | 1.7 |
| **XXXI** | 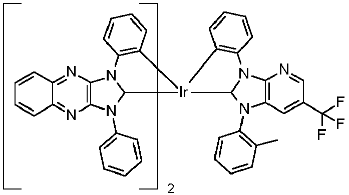 | 95% | 525 | 0.33, 0.62 | 74 | 3.0 |
| **XXXII** | 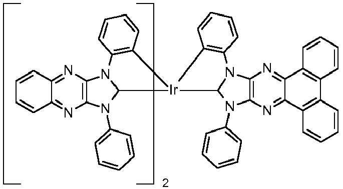 | 91% | 525 | 0.33, 0.62 | 75 | 3.0 |

As evident from the above table, the complexes of the present invention show an emission in the green to yellow-green area, with very high absolute PL quantum efficiency values Q.Y., with short lifetimes of luminescence τᵥ, which are as low as down to 1.1 µs.

### Comparitive examples

### Comparative example 1

The PL Q.Y., λₘₐₓ, CIE x, y color coordinates and τ_{V} values of the photoluminescence measurements of complexes **IV** and **CC-1** are included in the following table. Data of both complexes are given from PL measurements of 1% films of the respective complexes in PMMA matrix. Synthesis of the comparative complex **CC-1** is described in WO2014/147134 (example **BE-12**). überall weg

| **Cpd.** | **Formula** | **PL Q.Y.** | **λₘₐₓ (nm)** | **CIE x, y** | **τ_{V} (µs)** |
|---|---|---|---|---|---|
| **IV** | 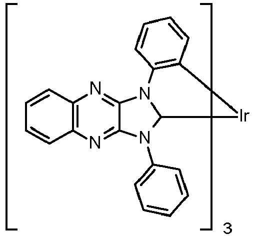 | 92% | 521 | 0.32, 0,62 | 2.4 |
| **CC-1** | 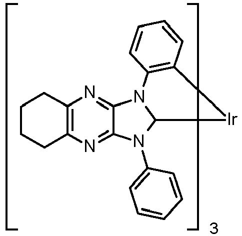 | 86% | 473 | 0.14, 0.20 | 6.0 |

As is evident from the above table, the green emitting inventive metal carbene complex **IV** shows a factor of 2.5 shorter (improved) lifetime of the luminescence τᵥ in comparison to comparative compound **CC-1.**

The inventive metal carbene complex **IV** with an imidazo-quinoxaline carbene ligand shows a green emission with CIE x,y color coordinates of (0.32, 0.62), with very high absolute PL quantum efficiency Q.Y. of 92% close to the theoretical limit, and a very good (= short) lifetime of the luminescence τᵥ of 2.4 µs. The comparative complex **CC-1** with a cyclohexane unit attached to the imidazo-pyrazine unit, instead of the benzene unit, as in the inventive complex IV, shows a blue emission with CIE x,y color coordinates of (0.14, 0.20), with a high absolute PL quantum efficiency Q.Y. of 86%, but a lifetime of luminescence τᵥ which is elongated to 6.0 µs.

The short lifetime of luminescence τᵥ of the inventive complex **IV** is surprising in respect to the elongated lifetime of luminescence τᵥ of the comparative complex **CC-1.** As is evident from the above table, surprisingly, despite the attached benzene ring at the imidazo-pyrazine unit of the carbene ligand in complex **IV** the lifetime of the luminescence τᵥ is very good (= short), although the attached cyclic alkane unit to the imidazo-pyrazine unit of the carbene ligand in comparative complex **CC-1** is leading to a long lifetime of the luminescence τᵥ.

### Comparative Example 2

The PL Q.Y., λₘₐₓ, CIE x, y color coordinates and τ_{V} values of the photoluminescence measurements of complexes **IV** and **CC-2** are included in the following table. Data of both complexes are given from PL measurements of 1% films of the respective complexes in PMMA matrix. Synthesis of the comparative complex **CC-2** is described in Comparative synthesis Example 2.

| **Cpd.** | **Formula** | **PL Q.Y.** | **λₘₐₓ (nm)** | **CIE x, y** | **τ_{V} (µs)** |
|---|---|---|---|---|---|
| **IV** | 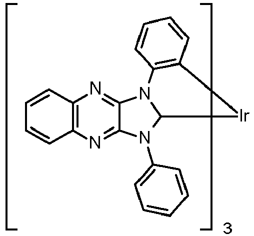 | 92% | 521 | 0.32, 0,62 | **2.4** |
| **CC-2** | 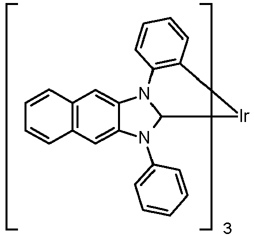 | 85% | 512 | 0.32, 0.62 | **105** |

As is evident from the above table, the green emitting inventive metal carbene complex **IV** shows a factor of 44 shorter (improved) lifetime of the luminescence τᵥ in comparison to green emitting comparative compound **CC-2,** at the same CIE x,y color coordinates.

The inventive metal carbene complex **IV** with an imidazo-quinoxaline carbene ligand shows a green emission with CIE x,y color coordinates of (0.32, 0.62), with very high absolute PL quantum efficiency Q.Y. of 92% close to the theoretical limit, and a very good (= short) lifetime of the luminescence τᵥ of 2.4 µs. The comparative complex **CC-2** with an imidazo-naphthalene carbene ligand instead shows a green emission with the same CIE x,y color coordinates, with a high absolute PL quantum efficiency Q.Y. of 85%, but a lifetime of luminescence τᵥ which is extremely elongated to 105 µs, compared to 2.4 µs in the case of the inventive complex **IV.** The short lifetime of luminescence τᵥ of the inventive complex IV is suprising in respect to the highly elongated lifetime of luminescence τᵥ of **CC-2.**

As is evident from the above tables, a carbene metal complex is emitting in the green to yellow-green area, with a very high Q.Y. close to the theoretical limit, and together with a short luminescence τᵥ if an inventive imidazo-quinoxaline cabene ligand is used.

### III Device Examples

### Production of an OLED (general procedure)

The ITO substrate used as the anode is cleaned first by rinsing with isopropanol. To eliminate possible organic residues, the substrate is exposed to a continuous ozone flow in an UV ozone oven for a further 20 minutes. This treatment also improves the hole injection properties of the ITO.

Thereafter, the organic materials specified below are applied by vapor deposition to the cleaned substrate at a pressure of about 10⁻⁷-10⁻⁹ mbar and at a rate of approx. 0.5-5 nm/min. The hole conductor and exciton blocker applied to the substrate is Ir(DPBIC)₃ (devices 1 to 3). Depending on the emissive layer thickness and thus for adjusting the optical cavity, the hole conductor has a thickness of 50 or 55 nm, the blocker has a thickness of 10nm. The hole conducting layer is doped with MoOₓ (50wt.-% : 50 wt.-%) to improve the conductivity. 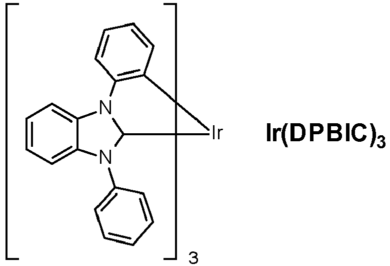 (for preparation of Ir(DPBIC)₃ see Ir complex (7) in the application WO2005/019373).

Subsequently, a mixture of emitter, Ir(DPBIC)₃ and a host material (the emitter, the host material (SH-1 or SH-2) and the relative amounts in % by weight are given in the specific device examples) is applied by vapor deposition with a thickness of 30 or 40 nm (devices 1 to 3). Subsequently, the host material is applied by vapor deposition with a thickness of 5 nm as an exciton and hole blocker.

### Host material:

**SH-1:** 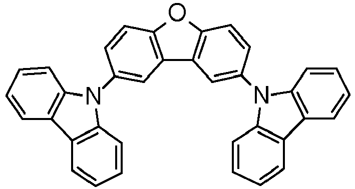 (compound "3-1" in "Synthetic example 2" in US2009/066226)
**SH-2:** 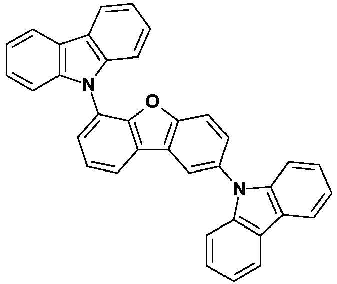 (compound I-1, on page 7 and 78, in US2011/0006670)

Next, as an electron transporter, a mixture of Liq and ETM (ETM-1 as specified in the specific device examples) (50 wt.-% : 50 wt.-%) is applied by vapor deposition in a thickness of 30 nm; then a 4 nm KF layer is applied; and finally a 100 nm-thick Al electrode is applied. The whole device is encapsulated by attaching a glass lid under inert nitrogen atmosphere with an UV curable adhesive with very low water vapor permeation rate.

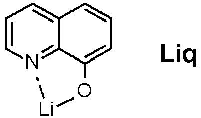

### Electron transport material:

**ETM-1**: 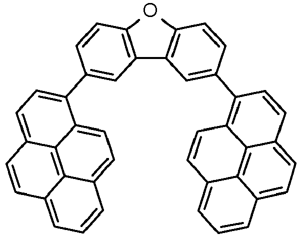 (compound A1 in WO2011/157779; compound A-10 in WO2006/128800)

To characterize the OLED, electroluminescence spectra are recorded at different currents and voltages. In addition, the current-voltage characteristic is measured in combination with the light output emitted. The light output can be converted to photometric parameters by calibration with a photometer. The lifetime LT₉₅ of the diode is defined by the time taken for the luminance to fall to 95% of its initial value. The lifetime measurement is carried out at a constant current. The CIE_{x,y} coordinates are extracted from the spectra according to CIE 1931 as known in the state-of-the-art.

For the different emitters, host materials and electron transport materials in the above-described OLED structure, the following electrooptical data are obtained:
All data are obtained at 1000 cd/m², lifetime data is taken at 4000 cd/m² initial luminance.

### Device 1:

50nm Ir(DPBIC)₃:MoO₃ (50:50) - 10nm Ir(DPBIC)₃ - 40nm emitter/SH-1/Ir(DPBIC)₃ (15:80:5) - 5nm SH-1 - 30nm ETM-1:Liq (50:50) - 4nm KF - 100nm Al

### Device 2:

55nm Ir(DPBIC)₃:MoO₃ (50:50) - 10nm Ir(DPBIC)₃ - 30nm emitter/SH-1/ Ir(DPBIC)₃ (15:80:5) - 5nm SH-1 - 35nm ETM-1:Liq (50:50) - 4nm KF - 100nm Al

### Device 3:

55nm Ir(DPBIC)₃:MoO₃ (50:50) - 10nm Ir(DPBIC)₃ - 30nm emitter/SH-2/ Ir(DPBIC)₃ (15:80:5) - 5nm SH-2 - 35nm ETM-1:Liq (50:50) - 4nm KF - 100nm Al

Synthesis of the comparative complex **CC-3** is described in Comparative Synthesis Example 3.

**Table 5**

| | Emitter | Voltage [V] | CurrEff [cd/A] | LumEff [lm/W] | EQE [%] | CIE x, y | λₘₐₓ / FWHM (nm) | LT₉₅ (h) |
|---|---|---|---|---|---|---|---|---|
| Dev. 1 | **IV** | 5.13 | 66.9 | 41.0 | 18.2 | 0.34, 0.62 | 528 / 70 | 360 |
| Dev. 3 | **IV** | 4.56 | 61.1 | 42.1 | 16.7 | 0.33, 0.62 | 526 / 71 | 500 |
| Dev. 1 | **V** | 5.81 | 72.0 | 38.9 | 19.5 | 0.34, 0.62 | 528 / 71 | 370 |
| Dev. 2 | **V** | 4.82 | 72.6 | 47.3 | 19.7 | 0.34, 0.62 | 529 / 70 | 310 |
| Dev. 2 | **XX** | 4.26 | 72.9 | 53.8 | 19.9 | 0.38, 0.59 | 543 / 74 | 380 |
| Dev. 3 | **XXVII** | 4.60 | 65.5 | 44.8 | 17.7 | 0.37,0.61 | 537 / 74 | 340 |
| Dev. 3 | **XXIX** | 4.42 | 64.1 | 45.6 | 18.0 | 0.41, 0.58 | 549 / 77 | 250 |
| Dev. 3 | **XVIII** | 5.32 | 71.2 | 42.0 | 19.3 | 0.35, 0.61 | 531 / 76 | 230 |
| Dev. 3 | **XXVI** | 4.20 | 58.6 | 43.8 | 16.8 | 0.42, 0.56 | 554 / 78 | 160 |
| Dev. 1 | **VII** | 5.53 | 57.8 | 32.8 | 15.8 | 0.36, 0.61 | 534 / 75 | 350 |
| Dev. 1 | **XXI** | 5.75 | 68.9 | 37.7 | 18.8 | 0.38, 0.60 | 541 / 73 | 130 |
| Dev. 1 | **VIa** | 5.79 | 56.3 | 30.5 | 15.2 | 0.38, 0.60 | 537/71 | 100 |
| Dev. 3 | **CC-3** | 4.71 | 60.8 | 40.5 | 16.8 | 0.36, 0.60 | 532 / 78 | 2 |

As is evident from the above table, the inventive green emitting metal complex **IV** shows much improved device lifetime LT₉₅ against comparative green emitting complex **CC-3** in the same device setup 3. LT₉₅ is improved by a factor of 250, at otherwise comparable device characteristics, and at highly comparable emission (λₘₐₓ and CIE x,y).

As is also evident from the above table, the inventive metal carbene complexes show a green to yellow-green emission color at remarcable high external quantum efficiencies (EQEs) and high current efficiencies. In those tables, all EQEs are calculated from the measured luminance in forward direction under the assumption of Lambertian emission. As shown above, typical examples of inventive emitters demonstrate remarkable high device stability, as shown for devices 1, 2, or 3, respectively.

The device setups 4 and 5 are similar to device setups 1 to 3, but demonstrate optimized setups, including different emitter concentrations, different Ir(DPBIC)₃ concentration, or use of a different host SH-1 or SH-2.

### Optimized setups

### Device 4:

50nm Ir(DPBIC)₃:MoO₃ (50:50) - 10nm Ir(DPBIC)₃ - 40nm emitter/SH-2/Ir(DPBIC)₃ (15:80:5) - 5nm SH-2 - 30nm ETM-1:Liq (50:50) - 4nm KF - 100nm Al

### Device 5:

55nm Ir(DPBIC)₃:MoO₃ (50:50) - 10nm Ir(DPBIC)₃ - 30nm emitter/SH-1/ Ir(DPBIC)₃ (25:65:10) - 5nm SH-1 - 35nm ETM-1:Liq (50:50) - 4nm KF - 100nm Al

**Table 6**

| | Emitter | Voltage [V] | CurrEff [cd/A] | LumEff [lm/W] | EQE [%] | CIE x, y | λₘₐₓ / FWHM (nm) | LT₉₅ (h) |
|---|---|---|---|---|---|---|---|---|
| Dev. 4 | **IV** | 5.96 | 56.8 | 29.9 | 15.5 | 0.34 , 0.62 | 527 / 74 | 670 |
| Dev. 5 | **XX** | 4.08 | 66.1 | 50.9 | 18.3 | 0.40 , 0.58 | 545 / 77 | 610 |

As is evident from the above table, for example, LT₉₅ of both inventive metal complexes **IV** and **XX** is further increased to over 600 h by using adapted device setups 4 or 5, respectively.

For a comparison of the influence of the emission layer thickness on the driving voltage, the following results in device 6 of the inventive emitter example **V** are shown.

### Device 6:

50nm Ir(DPBIC)₃:MoO₃ (50:50) - 10nm Ir(DPBIC)₃ - 20-40nm V/SH-1/ Ir(DPBIC)₃ (20:75:5) - 3nm SH-1 - 30nm ETM-1:Liq (50:50) - 4nm KF - 100nm Al

**Table 7**

| Emissive layer thickness | Voltage [V] | CurrEff [cd/A] | LumEff [lm/W] | EQE [%] | CIE x, y | λₘₐₓ / FWHM (nm) | LT₉₅ (h) |
|---|---|---|---|---|---|---|---|
| 20nm | 3.55 | 67.9 | 60.0 | 18.6 | 0.33 , 0.63 | 526 / 67 | 230 |
| 30nm | 4.34 | 69.3 | 50.2 | 18.8 | 0.33 ,0.62 | 527 / 68 | 405 |
| 40nm | 5.19 | 69.6 | 42.1 | 18.9 | 0.34 , 0.62 | 530 / 72 | 430 |

As is evident from the above table, a voltage drop from 5.19 eV to 3.55 eV can be observed when decreasing the layer thickness from 40 nm to 20 nm, at the same time leaving all other initial performance parameters almost unchanged.

Additional results in device setup 7 are demonstrating the same findings using the inventive emitter example **IV.**

### Device 7:

60-45nm Ir(DPBIC)₃:MoO₃ (50:50) - 10nm Ir(DPBIC)₃ - 20-50nm IV/SH-1/ Ir(DPBIC)₃ (20:75:5) - 5nm SH-1 - 40-25nm ETM-1:Liq (50:50) - 4nm KF - 100nm Al

**Table 8**

| Emissive layer thickness | Voltage [V] | CurrEff [cd/A] | LumEff [lm/W] | EQE [%] | CIE x, y | λₘₐₓ / FWHM (nm) | LT₉₅ (h) |
|---|---|---|---|---|---|---|---|
| 20nm | 3.79 | 64.6 | 53.6 | 17.6 | 0.33 , 0.62 | 527 / 71 | 250 |
| 30nm | 4.51 | 64.7 | 45.1 | 17.6 | 0.33 , 0.62 | 528 / 72 | 320 |
| 40nm | 5.35 | 66.1 | 38.8 | 17.9 | 0.33 , 0.62 | 527 / 70 | 250 |
| 50nm | 6.06 | 66.5 | 34.5 | 18.1 | 0.34 , 0.62 | 527 / 71 | 220 |

By changing molecular properties of the inventive compounds it is possible to directly influence the driving voltage of the OLED devices. This can be done either by modification of the electron affinity which will affect the electron transport property of the emissive layer since the emitter acts as a deep trap (see data in the following table 9). Or the number of electron transporting ligands of the inventive compound is modified which leads to altered electron transporting properties between the emitter molecules (see data in the following table 10).

Results in the following tables are achieved using the inventive compounds **XVIII, XXVI, XX,** respectively, in device setup 7 with 20% of emitter concentration and 30nm emissive layer thickness. Electron Affinities (EA) are calculated based on geometries of neutral and anionic molecules from density functional theory with the b-p86 functional and a SVp basis set in the gas phase. EA is then obtained as the energy difference between the single point energy of the anionic and neutral state, both evaluated within the Conductor Like Screening Model (COSMO) employing a dielectric constant of 4.5 using the b-p86 functional and a TZVp basis set. All calculations are performed using the TURBOMOLE package. The number of electron transporting ligands is obtained by analyzing the LUMO distribution from the gas phase calculation of the neutral molecule.

**Table 9**

| Emitter | EA [eV] | # of e-transporting ligands | Voltage [V] |
|---|---|---|---|
| **XVIII** | **2.53** | 1 | 5.13 |
| **XXVI** | **2.30** | 1 | 3.98 |

**Table 10**

| Emitter | EA [eV] | # of e-transporting ligands | Voltage [V] |
|---|---|---|---|
| **XVIII** | 2.53 | 1 | 5.13 |
| **XX** | 2.62 | 2 | 4.42 |

As is evident from the above table, starting from a higher voltage of 5.13 V for **XVIII,** it is possible to reduce the voltage down to <4 V by reduction of the EA, and thus reduction of the electron trap depth, for inventive compound **XXVI.** By just looking at the EA of the inventive compound **XX** one would now expect an even higher voltage compared to **XVIII,** since the trap depth is even larger for electrons. However, the driving voltage can be reduced to 4.42 eV by increasing the number of e-transporting ligands from one to two and thus increasing the propability for an electron to hop between the emitter molecules.

### FIGURE

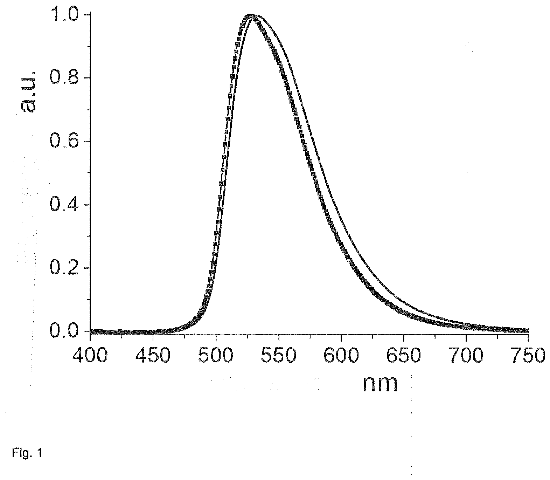

**Figure 1** (Fig. 1) shows a comparison of the emission spectrum of OLED **device 3** comprising inventive complex (**IV**) compared with the emission spectrum of OLED **device 3** comprising comparative complex (**CC-3**).

### In Fig 1:

The Y-axis shows the EL intensity in arbitrary units (a.u.) and the X-axis shows the wavelength in nm.

The dotted line shows the emission spectrum of the OLED comprising inventive complex (IV) and the continuous line shows the emission spectrum of the OLED comprising comparative complex (CC-3).

## Claims

1. A metal carbene complex, wherein the metal is selected from Ir and Pt, comprising at least one ligand of formula (A), preferably at least one ligand of formula (I) 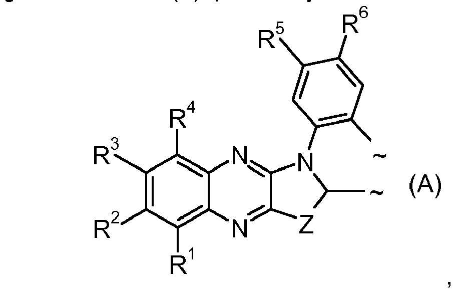 preferably 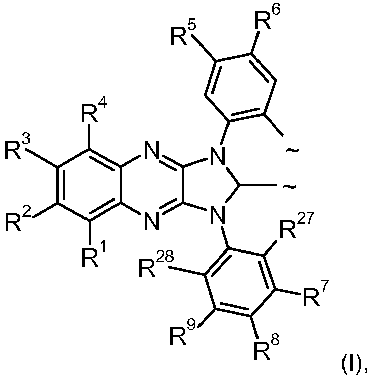 wherein
Z is NR^{x}, O or S, preferably NR^{x} or O, more preferably NR^{x},
R^{x} is 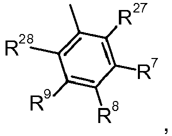
R¹, R², R³ and R⁴
are independently of each other hydrogen; a C₁-C₁₈alkyl group, which can optionally be substituted by at least one substituent E and/or interrupted by D; a C₃-C₁₂cycloalkyl group, which can optionally be substituted by at least one substituent E; a heterocycloalkyl group comprising 3 to 6 ring atoms, interrupted by at least one of O, S and NR⁶⁵ and/or substituted by at least one substituent E; a C₆-C₁₄aryl group, which can optionally be substituted by at least one substituent G; a -NR⁶⁵-C₆-C₁₄aryl group, preferably a -N(C₆-C₁₄aryl)₂ group, which can optionally be substituted by at least one substituent G; a heteroaryl group comprising 3 to 11 ring atoms, which can optionally be substituted by at least one substituent G, interrupted by at least one of O, S, N and NR⁶⁵; or a -NR⁶⁵-heteroaryl group, preferably a -N(heteroaryl)₂ group, comprising 3 to 11 ring atoms, which can optionally be substituted by at least one substituent G, interrupted by at least one of O, S, N and NR⁶⁵; a halogen atom, especially F or Cl; a C₁-C₁₈haloalkyl group such as CF₃; CN; or SiR⁸⁰R⁸¹R⁸²;
or
R¹ and R², R² and R³ or R³ and R⁴ form together a ring 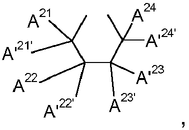 or 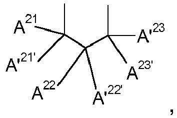 wherein A²¹, A^{21'}, A²², A^{22'}, A²³, A^{23'}, A^{24'} and A²⁴ are independently of each other H, a C₁-C₄alkyl group, a C₃-C₆cycloalkyl group, or a fluoroC₁-C₄alkyl group;
R⁵ and R⁶
are independently of each other hydrogen; a C₁-C₁₈alkyl group, which can optionally be substituted by at least one substituent E and/or interrupted by D; a C₃-C₁₂cycloalkyl group, which can optionally be substituted by at least one substituent E; a heterocycloalkyl group comprising 3 to 6 ring atoms, interrupted by at least one of O, S and NR⁶⁵ and/or substituted by at least one substituent E; a C₆-C₁₄aryl group, which can optionally be substituted by at least one substituent G; a -NR⁶⁵-C₆-C₁₄aryl group, preferably a -N(C₆-C₁₄aryl)₂ group, which can optionally be substituted by at least one substituent G; a heteroaryl group comprising 3 to 11 ring atoms, which can optionally be substituted by at least one substituent G, interrupted by at least one of O, S, N and NR⁶⁵; a halogen atom, especially F or Cl; a C₁-C₁₈haloalkyl group such as CF₃; CN; or SiR⁸⁰R⁸¹R⁸²;
R⁷, R⁸, R⁹, R²⁷ and R²⁸
are independently of each other hydrogen; a C₁-C₁₈alkyl group, which can optionally be substituted by at least one substituent E and/or interrupted by D; a C₃-C₁₂cycloalkyl group, which can optionally be substituted by at least one substituent E; a heterocycloalkyl group comprising 3 to 6 ring atoms, interrupted by at least one of O, S and NR⁶⁵ and/or substituted by at least one substituent E; a C₆-C₁₄aryl group, which can optionally be substituted by at least one substituent G; a heteroaryl group comprising 3 to 11 ring atoms, which can optionally be substituted by at least one substituent G, interrupted by at least one of O, S, N and NR⁶⁵ a halogen atom, especially F or Cl; a C₁-C₁₈haloalkyl group such as CF₃; CN; or SiR⁸⁰R⁸¹R⁸²; in addition to the groups mentioned above, R⁸ may be a -NR⁶⁵-C₆-C₁₄aryl group, preferably a -N(C₆-C₁₄aryl)₂ group, which can optionally be substituted by at least one substituent G; or a -NR⁶⁵-heteroaryl group, preferably a -N(heteroaryl)₂ group, comprising 3 to 11 ring atoms, which can optionally be substituted by at least one substituent G, interrupted by at least one of O, S, N and NR⁶⁵;
or
R⁵ and R⁶ and/or R⁸ and R⁹ together form a group of formula 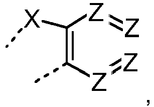 wherein Z is
N or CR'", wherein 0 or 1 Z is N, preferably 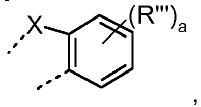 wherein X is O, S, NR⁷⁵ or CR⁷³R⁷⁴, preferably O; R'" is C₁-C₈alkyl and a is 0, 1 or 2, preferably 0 or 1, more preferably 0;
D is -CO-, -COO-, -S-, -SO-, -SO₂-, -O-, -NR⁶⁵-, -SiR⁷⁰R⁷¹-, -POR⁷²-, -CR⁶³=CR⁶⁴-, or-C≡C, preferably -O-, -S- or -NR⁶⁵-;
E is -OR⁶⁹, -SR⁶⁹, -NR⁶⁵R⁶⁶, -COR⁶⁸, -COOR⁶⁷, -CONR⁶⁵R⁶⁶, -CN, halogen, a C₁-C₁₈alkyl group, which can optionally be substituted by at least one substituent E and/or interrupted by D; preferably F; a C₁-C₈haloalkyl group such as CF₃, or a C₁-C₈alkyl group; preferably, E is C₁-C₈alkyl, C₁-C₈alkoxy, CN, halogen, preferably F, or C₁-C₈haloalkyl, such as CF₃; more preferably E is C₁-C₈alkyl, C₁-C₈alkoxy, or C₁-C₈haloalkyl, such as CF₃;
G is E; or an unsubstituted C₆-C₁₄aryl group; a C₆-C₁₄aryl group, which is substituted by F, C₁-C₁₈alkyl, or C₁-C₁₈alkyl, which is substituted by F and/or interrupted by O; an unsubstituted heteroaryl group comprising 3 to 11 ring atoms, interrupted by at least one of O, S, N and NR⁶⁵; or a heteroaryl group comprising 3 to 11 ring atoms, interrupted by at least one of O, S, N and NR⁶⁵, which is substituted by F, unsubstituted C₁-C₁₈alkyl, SiR⁸⁰R⁸¹R⁸², or C₁-C₁₈alkyl which is substituted by F and/or interrupted by O;
preferably, G is a C₁-C₈alkyl group, or a group of formula 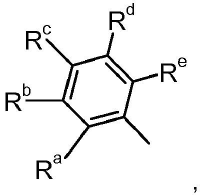 R^{a} is H, a C₁-C₈alkyl group, a fluoroC₁-C₄alkyl group, or a C₃-C₆cycloalkyl group,
R^{e} is H, a C₁-C₈alkyl group, a fluoroC₁-C₄alkyl group, or a C₃-C₆cycloalkyl group, R^{c}, R^{b} and R^{d} are independently of each other hydrogen; a C₁-C₁₈alkyl group, which can optionally be substituted by E and/or interupted by D; a C₃-C₁₂cycloalkyl group, which can optionally be substituted by G; a C₃-C₁₀heterocycloalkyl radical which is interrupted by at least one of O, S and NR⁶⁵ and/or substituted by E; a C₆-C₂₄aryl group, which can optionally be substituted by G; or a C₂-C₃₀heteroaryl group, which can optionally be substituted by G; a halogen atom, especially F or Cl; C₁-C₈haloalkyl such as CF₃; CN; or SiR⁸⁰R⁸¹R⁸²; or
R^{c} and R^{b}, or R^{a} and R^{b} together form a group of formula 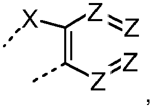 wherein Z is N or
CR"', wherein 0 or 1 Z is N, preferably 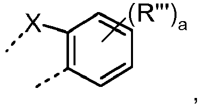 wherein X is O, S, NR⁷⁵ or
CR⁷³R⁷⁴, preferably O; R'" is C₁-C₈alkyl and a is 0, 1 or 2, preferably 0 or 1, more preferably 0;
R⁶³ and R⁶⁴ are independently of each other H; unsubstituted C₆-C₁₈aryl; C₆-C₁₈aryl which is substituted by C₁-C₁₈alkyl, or C₁-C₁₈alkoxy; unsubstituted C₁-C₁₈alkyl; or C₁-C₁₈alkyl which is interrupted by -O-; preferably unsubstituted C₆-C₁₈aryl; C₆-C₁₈aryl which is substituted by C₁-C₁₈alkyl, or C₁-C₁₈alkoxy; unsubstituted C₁-C₁₈alkyl; or C₁-C₁₈alkyl which is interrupted by -O-;
R⁶⁵ and R⁶⁶ are independently of each other H, an unsubstituted C₆-C₁₈aryl group; a C₆-C₁₈aryl group which is substituted by C₁-C₁₈alkyl, or C₁-C₁₈alkoxy; an unsubstituted C₁-C₁₈alkyl group; or a C₁-C₁₈alkyl group, which is interrupted by -O-;
R⁶⁵ and R⁶⁶ together form a five or six membered ring,
R⁶⁷ is H, an unsubstituted C₆-C₁₈aryl group; a C₆-C₁₈aryl group, which is substituted by C₁-C₁₈alkyl, or C₁-C₁₈alkoxy; an unsubstituted C₁-C₁₈alkyl group; or a C₁-C₁₈alkyl group, which is interrupted by -O-; preferably an unsubstituted C₆-C₁₈aryl group; a C₆-C₁₈aryl group, which is substituted by C₁-C₁₈alkyl, or C₁-C₁₈alkoxy; an unsubstituted C₁-C₁₈alkyl group; or a C₁-C₁₈alkyl group, which is interrupted by -O-;
R⁶⁸ is H; an unsubstituted C₆-C₁₈aryl group; a C₆-C₁₈aryl group, which is substituted by C₁-C₁₈alkyl, or C₁-C₁₈alkoxy; an unsubstituted C₁-C₁₈alkyl group; or a C₁-C₁₈alkyl group, which is interrupted by -O-;
R⁶⁹ is H, an unsubstituted C₆-C₁₈aryl; a C₆-C₁₈aryl, which is substituted by C₁-C₁₈alkyl, or C₁-C₁₈alkoxy; an unsubstituted C₁-C₁₈alkyl group; or a C₁-C₁₈alkyl group, which is interrupted by -O-; preferably an unsubstituted C₆-C₁₈aryl; a C₆-C₁₈aryl, which is substituted by C₁-C₁₈alkyl, or C₁-C₁₈alkoxy; an unsubstituted C₁-C₁₈alkyl group; or a C₁-C₁₈alkyl group, which is interrupted by -O-;
R⁷⁰ and R⁷¹ are independently of each other an unsubstituted C₁-C₁₈alkyl group; an unsubstituted C₆-C₁₈aryl group; or a C₆-C₁₈aryl group, which is substituted by C₁-C₁₈alkyl; R⁷² is an unsubstituted C₁-C₁₈alkyl group; an unsubstituted C₆-C₁₈aryl group, or a C₆-C₁₈aryl group, which is substituted by C₁-C₁₈alkyl;
R⁷³ and R⁷⁴ are independently of each other H, C₁-C₂₅alkyl, C₁-C₂₅alkyl which is interrupted by O, C₇-C₂₅arylalkyl, C₆-C₂₄aryl, C₆-C₂₄aryl which is substituted by C₁-C₁₈alkyl, C₂-C₂₀heteroaryl, or C₂-C₂₀heteroaryl which is substituted by C₁-C₁₈alkyl;
R⁷⁵ is a C₆-C₁₈aryl group; a C₆-C₁₈aryl which is substituted by C₁-C₁₈alkyl, or C₁-C₁₈alkoxy; a C₁-C₁₈alkyl group; or a C₁-C₁₈alkyl group, which is interrupted by -O-;
R⁸⁰, R⁸¹ and R⁸² are independently of each other a C₁-C₂₅alkyl group, which can optionally be interrupted by O; a C₆-C₁₄aryl group, which can optionally be substituted by C₁-C₁₈alkyl; or a heteroaryl group comprising 3 to 11 ring atoms, which can optionally be substituted by C₁-C₁₈alkyl;
∼ is a bonding site to the metal.

2. The metal carbene complex according to claim 1, wherein
R¹, R², R³ and R⁴
are independently of each other hydrogen; a C₁-C₁₂alkyl group, which can optionally be substituted by at least one substituent E and/or interrupted by D; a C₃-C₁₂cycloalkyl group, which can optionally be substituted by at least one substituent E; a C₆-C₁₄aryl group, which can optionally be substituted by one or two groups G; a heteroaryl group comprising 3 to 11 ring atoms, which can optionally be substituted by one or two groups G; or a - N(phenyl)₂ group, which can optionally be substituted by one or two groups G.
R⁵ and R⁶
are independently of each other hydrogen; a C₁-C₁₂alkyl group, which can optionally be substituted by E and/or interrupted by D; a C₃-C₁₂cycloalkyl group, which can optionally be substituted by E;
or
one of R⁵ and R⁶, preferably R⁵, is a group of formula 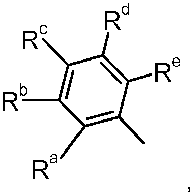 in a further preferred embodiment, R⁶ is a group of formula 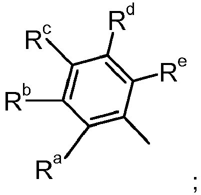
R^{a} is H, a C₁-C₅alkyl group, a fluoroC₁-C₄alkyl group, or a C₃-C₆cycloalkyl group; preferably H, a C₁-C₅alkyl group, C₃-C₆cycloalkyl group; more preferably H, or a C₁-C₅alkyl group; R^{e} is H, a C₁-C₅alkyl group, a fluoroC₁-C₄alkyl group, or a C₃-C₆cycloalkyl group; preferably H, a C₁-C₅alkyl group, C₃-C₆cycloalkyl group; more preferably H, or a C₁-C₅alkyl group; R^{c}, R^{b} and R^{d} are independently of each other hydrogen; a C₁-C₁₈alkyl group, which can optionally be substituted by E and/or interupted by D; a C₃-C₁₂cycloalkyl group, which can optionally be substituted by G; a C₆-C₁₄aryl group, which can optionally be substituted by G; or a C₂-C₃₀heteroaryl group, which can optionally be substituted by G; C₁-C₈haloalkyl such as CF₃; or SiR⁸⁰R⁸¹R⁸²; preferably R^{c}, R^{b} and R^{d} are independently of each other H, a C₁-C₅alkyl group, C₃-C₆cycloalkyl group; more preferably H, or a C₁-C₅alkyl group; further preferably, R^{b}, R^{c} and R^{d} are hydrogen or a phenyl group, which can optionally be substituted by one or two groups G;
or
R^{c} and R^{b}, or R^{a} and R^{b} together form a group of formula 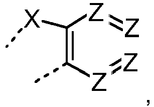 wherein Z is N or
CR"', wherein 0 or 1 Z is N, preferably 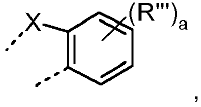 wherein X is O, S, NR⁷⁵ or
CR⁷³R⁷⁴, preferably O; R'" is C₁-C₈alkyl and a is 0, 1 or 2, preferably 0 or 1, more preferably 0.
R⁷, R⁸ and R⁹
are independently of each other hydrogen; a C₁-C₁₂alkyl group, which can optionally be substituted by E and/or interrupted by D; a C₃-C₁₂cycloalkyl group, which can optionally be substituted by E, a C₆-C₁₄aryl group, which can optionally be substituted by one or two groups G; a heteroaryl group comprising 3 to 11 ring atoms, which can optionally be substituted by one or two groups G.
R²⁷, R²⁸
independently of each other hydrogen; or a C₁-C₁₂alkyl group, which can optionally be substituted by E and/or interrupted by D, preferably a CH₂-C₁-C₇alkyl group, which can optionally be substituted by E and/or interrupted by D;
preferably, at least one of R²⁷ and R²⁸ is hydrogen;
D is -S-, or -O-
E is -OR⁶⁹, CF₃, C₁-C₈alkyl or F;
G is -OR⁶⁹, CF₃ or C₁-C₈alkyl;
R⁶⁵ is a phenyl group, which can optionally be substituted by one or two C₁-C₈alkyl groups; an unsubstituted C₁-C₁₈alkyl group; or a C₁-C₁₈alkyl group, which is interrupted by -O-; and
R⁶⁹ is a phenyl group, which can optionally be substituted by one or two C₁-C₈alkyl groups; an unsubstituted C₁-C₁₈alkyl group; or a C₁-C₁₈alkyl group, which is interrupted by -O-.

3. The metal carbene complex according to claim 1 or 2, wherein at least one of the radicals R¹, R², R³, R⁴, R⁵, R⁶, R⁷, R⁸, and R⁹ is not hydrogen; preferably, either R⁵ is not hydrogen or at least two of the radicals R¹, R², R³, R⁴, R⁵, R⁶, R⁷, R⁸ and R⁹ are not hydrogen.

4. The metal carbene complex according to anyone of claims 1 to 3, wherein
R¹, R², R³ and R⁴
are independently of each other hydrogen; a C₁-C₈alkyl group, which can optionally be substituted by at least one substituent E; a C₃-C₆cycloalkyl group, which can optionally be substituted by at least one substituent E; or a phenyl group, which can optionally be substituted by one or two groups G;
R⁵ and R⁶
are independently of each other hydrogen; a C₁-C₈alkyl group, which can optionally be substituted by at least one substituent E; or a C₃-C₆cycloalkyl group, which can optionally be substituted by at least one substituent E; or a phenyl group, which can optionally be substituted by one or two groups G;
R⁷, R⁸ and R⁹
are independently of each other hydrogen; a C₁-C₈alkyl group, which can optionally be substituted by at least one substituent E; or a C₃-C₆cycloalkyl group, which can optionally be substituted by at least one substituent E; or a phenyl group, which can optionally be substituted by one or two groups G;
R²⁷ and R²⁸
are hydrogen;
E is CF₃, C₁-C₈alkyl or F;
G is CF₃ or C₁-C₈alkyl; preferably C₁-C₈alkyl;
R⁶⁵ is a phenyl group, which can optionally be substituted by one or two C₁-C₈alkyl groups; an unsubstituted C₁-C₈alkyl group; or a C₁-C₈alkyl group, which is interrupted by - O-; and
R⁶⁹ is a phenyl group, which can optionally be substituted by one or two C₁-C₈alkyl groups; an unsubstituted C₁-C₈alkyl group; or a C₁-C₈alkyl group, which is interrupted by - O-.

5. The metal carbene complex according to anyone of claims 1 to 4, wherein
R¹, R², R³ and ^{R4}
are independently of each other hydrogen; a C₁-C₈alkyl group; or a C₃-C₆cycloalkyl group;
R⁵, R⁶, R⁷, R⁸ and R⁹
are independently of each other hydrogen; a C₁-C₈alkyl group; or a C₃-C₆cycloalkyl group;
or one of R⁵ and R⁶ is a phenyl group, which can optionally be substituted by one or two groups G; and
R²⁷ and R²⁸
are hydrogen.

6. The metal carbene complex according to anyone of claims 1 to 5, wherein
either R² and R³ or R¹ and R⁴ are H.

7. The metal carbene complex according to anyone of claims 1 to 6, wherein
R⁵ and R⁶
are independently of each other hydrogen; a C₁-C₈alkyl group; or one of R⁵ and R⁶, preferably R⁵, is a phenyl group, which can optionally be substituted by one or two groups selected from CF₃ or C₁-C₈alkyl, preferably optionally be substituted by one C₁-C₈alkyl group; in a further preferred embodiment R⁶ is a phenyl group, which can optionally be substituted by one or two groups selected from CF₃ or C₁-C₈alkyl, preferably optionally be substituted by one C₁-C₈alkyl group;
preferably, at least one of R⁵ and R⁶ is hydrogen;
R⁷ and R⁹
are C₁-C₈alkyl;
R8
is hydrogen; a C₁-C₈alkyl group; or a phenyl group, which can optionally be para-substituted by one group selected from CF₃ or C₁-C₈alkyl, preferably optionally be substituted by one C₁-C₈alkyl group;
R²⁷ and R²⁸
are hydrogen.

8. The metal carbene complex according to anyone of claims 1 to 6, wherein
R5
is hydrogen; a C₁-C₈alkyl group, which can optionally be substituted by at least one substituent selected from CF₃, C₁-C₈alkyl and F; a C₃-C₆cycloalkyl group, which can optionally be substituted by at least one substituent selected from CF₃, C₁-C₈alkyl and F; or a phenyl group, which can optionally be substituted by one or two groups selected from CF₃ and
C₁-C₈alkyl, preferably optionally be substituted by one or two C₁-C₈alkyl groups;
R⁶ and R⁸
are identical and selected from the group consisting of a C₁-C₈alkyl group, which can optionally be substituted by at least one substituent selected from CF₃, C₁-C₈alkyl and F; a C₃-C₆cycloalkyl group, which can optionally be substituted by at least one substituent selected from CF₃, C₁-C₈alkyl and F; and a phenyl group, which can optionally be substituted by one or two groups selected from CF₃ and C₁-C₈alkyl, preferably optionally be substituted by one or two C₁-C₈alkyl groups; and
R⁷ and R⁹
are hydrogen,
wherein R⁵ and R⁶ are not at the same time a phenyl group, which can optionally be substituted by one or two groups selected from CF₃ and C₁-C₈alkyl, preferably optionally be substituted by one or two C₁-C₈alkyl groups;
R²⁷ and R²⁸
are hydrogen.

9. The metal carbene complex according to anyone of claims 1 to 6, wherein
R⁷, R⁸ and R⁹ are H; and
R⁶ is H; and
R²⁷ and R²⁸
are hydrogen.

10. The metal carbene complex according to anyone of claims 1 to 9, having the following formula (II) 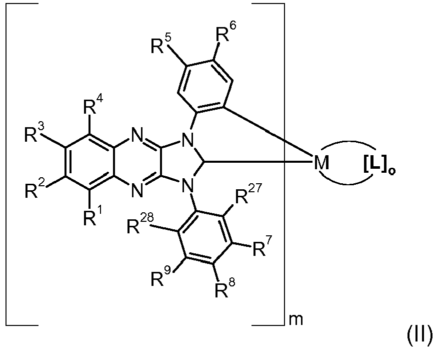 wherein
M is Pt, or Ir, preferably Ir;
if M is Ir, m is 1, 2, or 3; o is 0, 1, or 2; and the sum of m + o is 3;
in the case that o = 2, the ligands L may be the same or different, preferably the same;
and in the case that m is 2 or 3, the m carbene ligands may be the same or different, preferably the same;
if M is Pt, m is 1, or 2; o is 0, or 1; and the sum of m + o is 2;
in the case that m is 2, the m carbene ligands may be the same or different, preferably the same; and
L is a monoanionic bidentate ligand.

11. The metal carbene complex according to anyone of claims 1 to 10, wherein L is a group of formula 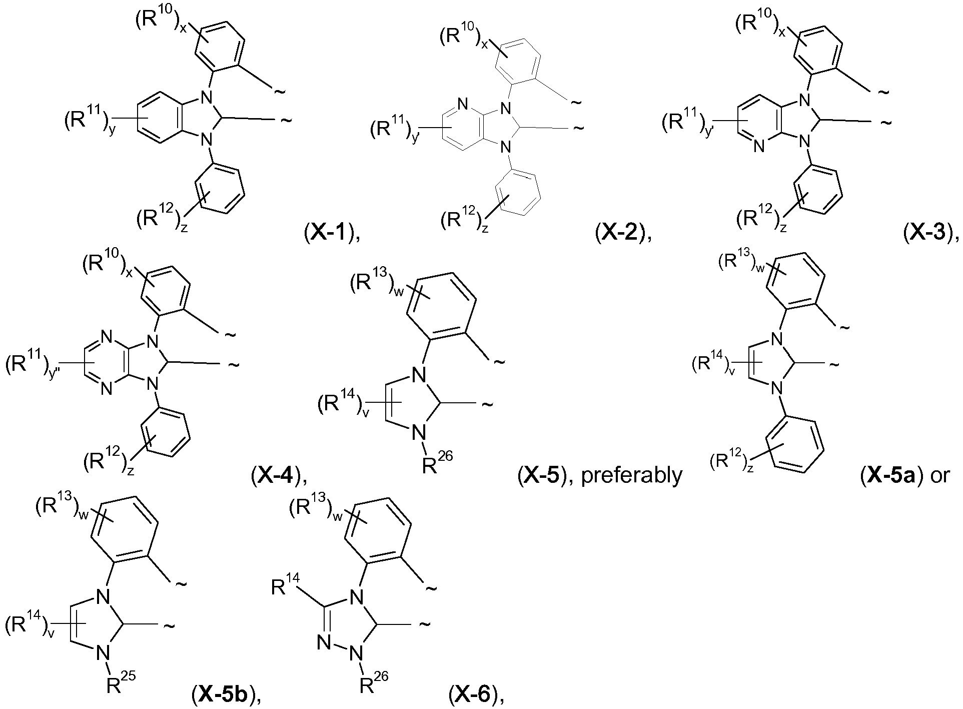 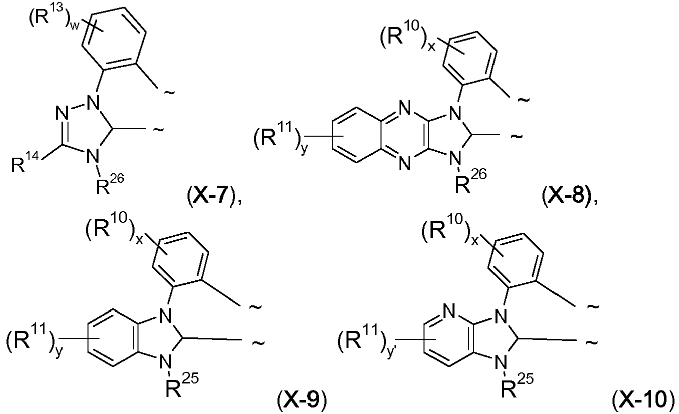 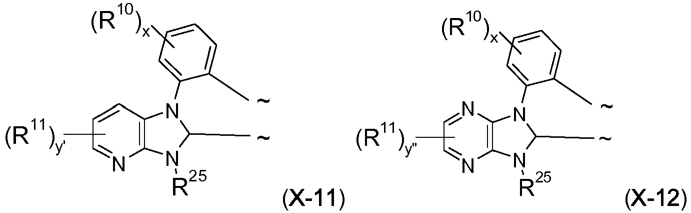 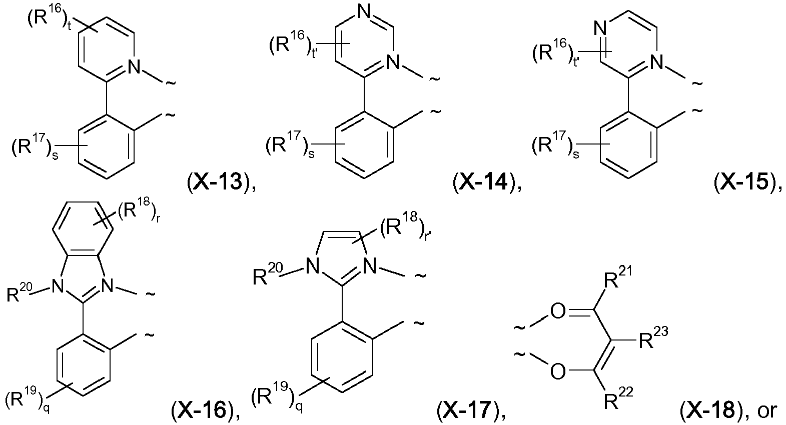 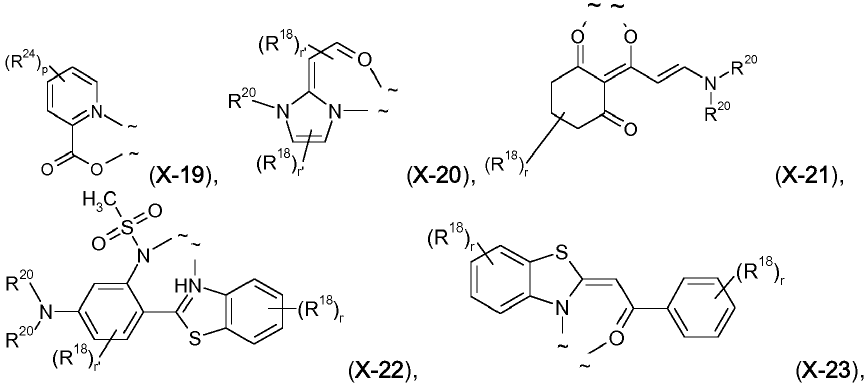 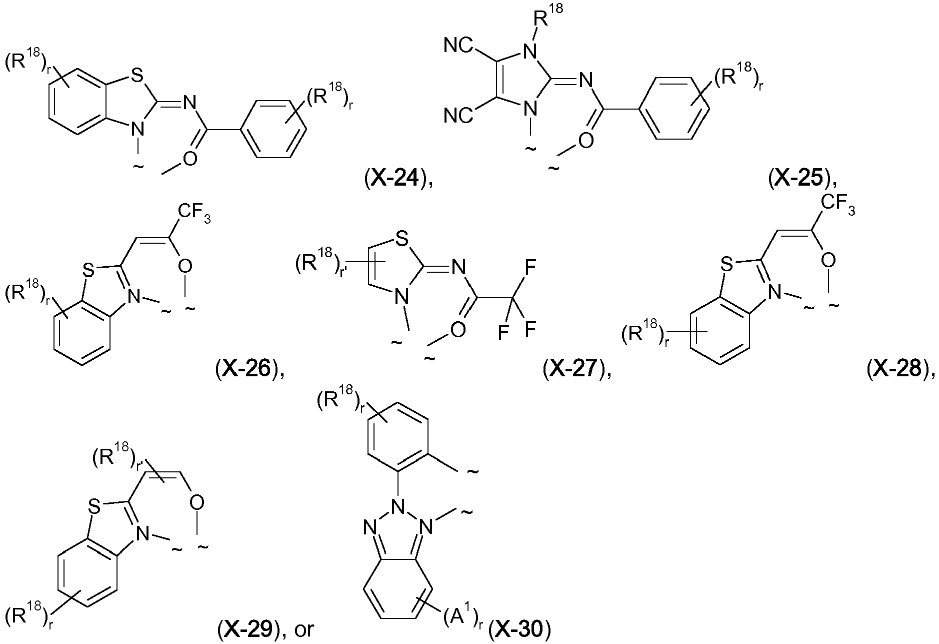 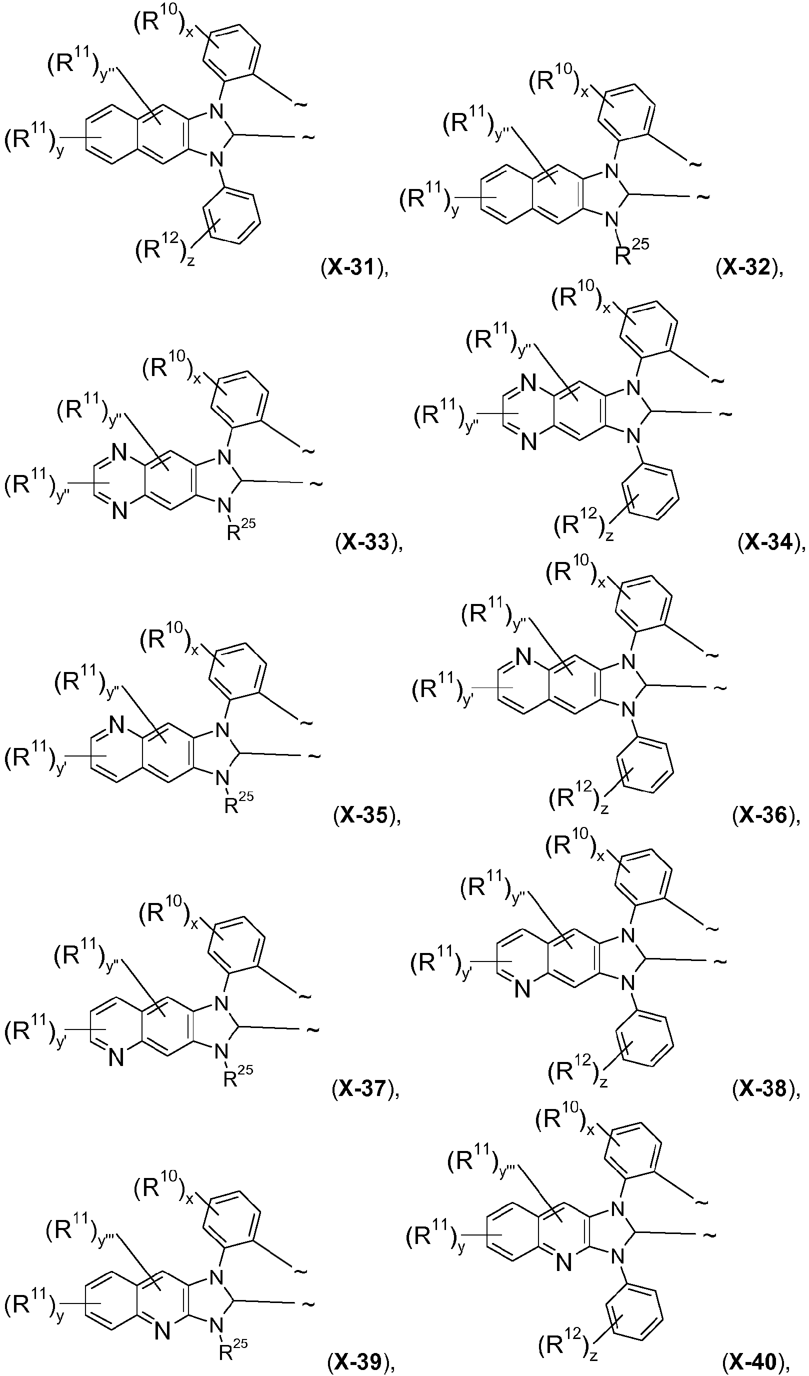 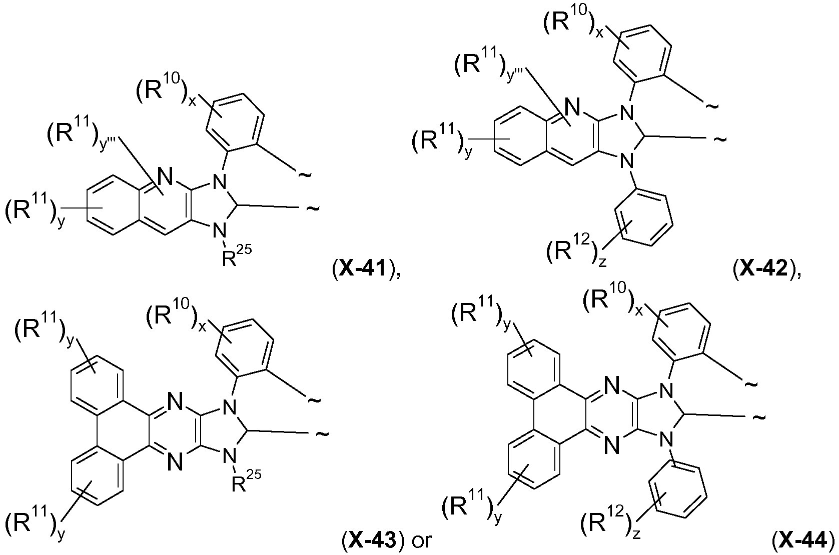 wherein
R¹⁰, R¹², R¹³, R¹⁶, R¹⁷, R¹⁸ and R¹⁹
the radicals R¹⁰, R¹², R¹³, R¹⁶, R¹⁷, R¹⁸ and R¹⁹ are - in each case - independently of each other a C₁-C₁₈alkyl group, which can optionally be substituted by E and/or interrupted by D; a C₃-C₁₂cycloalkyl group, which can optionally be substituted by E; a heterocycloalkyl group comprising 3 to 6 ring atoms, interrupted by at least one heteroatom selected from -O-, -Sand -NR⁶⁵-, optionally bearing at least one substituent E; a halogen atom, especially F or Cl; C₁-C₈haloalkyl such as CF₃; CN; or SiR⁸⁰R⁸¹R⁸²; or
one radical R¹⁰ and/or one radical R¹²; one radical R¹³ and/or one radical R¹²; one radical R¹⁶ and/or one radical R¹⁷; one radical R¹⁸ and/or one radical R¹⁹ is a group of formula 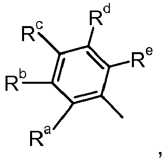
R^{a} is H, a C₁-C₅alkyl group, a fluoroC₁-C₄alkyl group, or a C₃-C₆cycloalkyl group, preferably C₁-C₅-alkyl, or H, more preferably H,
R^{e} is H, a C₁-C₅alkyl group, a fluoroC₁-C₄alkyl group, or a C₃-C₆cycloalkyl group, preferably C₁-C₅-alkyl, or H, more preferably H,
R^{c}, R^{b} and R^{d} are independently of each other hydrogen; a C₁-C₁₈alkyl group, which can optionally be substituted by E and/or interupted by D; a C₃-C₁₂cycloalkyl group, which can optionally be substituted by G; a C₃-C₁₀heterocycloalkyl radical which is interrupted by at least one of O, S and NR⁶⁵ and/or substituted by E; a C₆-C₂₄aryl group, which can optionally be substituted by G; or a C₂-C₃₀heteroaryl group, which can optionally be substituted by G; a halogen atom, especially F or Cl; C₁-C₈haloalkyl such as CF₃; CN; or SiR⁸⁰R⁸¹R⁸²; preferably H or a C₁-C₈alkyl group, more preferably, R^{d} is H and one of R^{b} or R^{c} is a C₁-C₈alkyl group and the other one of R^{b} and R^{d} is H; even more preferably R^{c}, R^{b} and R^{d} are H;
or
two adjacent radicals R¹⁰ and/or two adjacent radicals R¹²; two adjacent radicals R¹³ and/or two adjacent radicals R¹²; two adjacent radicals R¹⁶ and/or two adjacent radicals R¹⁷; or two adjacent radicals R¹⁹; or R^{c} and R^{b}, or R^{a} and R^{b} together form a group of formula 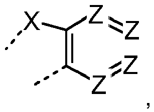 wherein Z is N or CR'", wherein 0 or 1 Z is N, preferably 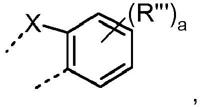 wherein X is O, S, NR⁷⁵ or CR⁷³R⁷⁴, preferably O; R'" is C₁-C₈alkyl and a' is 0 or 1, preferably 0;
preferably, the radicals R¹⁰, R¹², R¹³, R¹⁶, R¹⁷, R¹⁸ and R¹⁹ are - in each case - independently of each other a C₁-C₈alkyl group, which can optionally be substituted by at least one substituent E and/or interrupted by D, especially methyl, ethyl, i-propyl, n-butyl, sec-butyl, tert-butyl or isoamyl; a C₃-C₆cycloalkyl group, which can optionally be substituted by at least one substituent E; F; Cl; C₁-C₈haloalkyl such as CF₃; CN;
in a further preferred embodiment, R¹⁰, R¹², R¹³, R¹⁶, R¹⁷, R¹⁸ and R¹⁹ are - in each case - independently of each other hydrogen, a C₁-C₈alkyl group especially methyl, ethyl, i-propyl, n-butyl, sec-butyl, tert-butyl or isoamyl; or a phenyl group, which can optionally be substituted by one or two groups G; or a C₂-C₃₀heteroaryl group, which can optionally be substituted by G; more preferably hydrogen, a C₁-C₈alkyl group especially methyl, ethyl, i-propyl, n-butyl, sec-butyl, tert-butyl or isoamyl; or a phenyl group, which can optionally be substituted by one or two C₁-C₈alkyl groups, for example 2-tolyl, 3-tolyl, 4-tolyl, 2-ethylphenyl, 3-ethylphenyl, 4-ethylphenyl, 2-isopropylphenyl, 3-isopropylphenyl or 4-isopropylphenyl; most preferably hydrogen or a C₁-C₈alkyl group especially methyl, ethyl, i-propyl, n-butyl, sec-butyl, tert-butyl or isoamyl.
or
two adjacent radicals R¹⁰ and/or two adjacent radicals R¹²; two adjacent radicals R¹³ and/or two adjacent radicals R¹²; two adjacent radicals R¹⁶ and/or two adjacent radicals R¹⁷; or two adjacent radicals R¹⁹ together form a group of formula 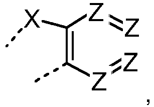 wherein Z is N or
CR"', wherein 0 or 1 Z is N, preferably 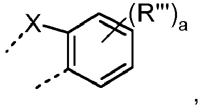 wherein X is O, S, NR⁷⁵ or
CR⁷³R⁷⁴, preferably O or S; more preferably O; R'" is C₁-C₈alkyl and a' is 0 or 1, preferably 0; R¹¹, R¹⁴, R²⁰, R²¹, R²², R²³ and R²⁴:
the radicals R¹¹, R¹⁴, R²⁰, R²¹, R²², R²³ and R²⁴ are - in each case - independently of each other a C₁-C₁₈alkyl group, which can optionally be substituted by at least one substituent E and/or interrupted by D; a C₃-C₁₂cycloalkyl group, which can optionally be substituted by at least one substituent E; a heterocycloalkyl group comprising 3 to 6 ring atoms, interrupted by at least one heteroatom selected from -O-, -S- and -NR⁶⁵-, optionally bearing at least one substituent E; a C₆-C₁₄aryl group, which can optionally be substituted by one or two groups G; a heteroaryl group comprising 3 to 11 ring atoms, which can optionally be substituted by one or two groups G; or a -NR⁶⁵-phenyl group, which can optionally be substituted by one or two groups G;
preferably, R¹¹, R¹⁴, R²⁰, R²¹, R²², R²³ and R²⁴ are - in each case - independently of each other hydrogen; a C₁-C₈alkyl group, which can optionally be substituted by at least one substituent E and/or interrupted by D; a C₃-C₆cycloalkyl group, which can optionally be substituted by at least one substituent E; or a phenyl group, which can optionally be substituted by one or
two groups G; C₁-C₈ haloalkyl such as CF₃; or SiR⁸⁰R⁸¹R⁸²; or in the case of **X-1, X-2, X-3, X-31, X-34, X-35, X-36, X-37** and **X-38** CN;
or
two adjacent radicals R¹¹ or two adjacent radicals R¹⁴ form together a group 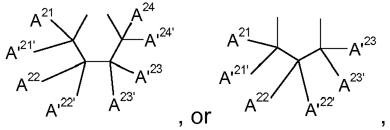 wherein A²¹, A^{21'}, A²², A^{22'}, A²³, A^{23'}, A^{24'} and A²⁴ are independently of each other H, a C₁-C₄alkyl group, a C₃-C₆cycloalkyl group, or a fluoroC₁-C₄alkyl group;
preferably, R¹¹, R¹⁴, R²⁰, R²¹, R²², R²³ and R²⁴ are - in each case - independently of each other a C₁-C₈alkyl group, which can optionally be substituted by at least one substituent E and/or interrupted by D, especially methyl, ethyl, i-propyl, n-butyl, sec-butyl, tert-butyl or isoamyl; a C₃-C₆cycloalkyl group, which can optionally be substituted by at least one substituent E; C₁-C₈haloalkyl such as CF₃; or in the case of **X-1, X-2, X-3, X-31, X-34, X-35, X-36, X-37** and **X-38** CN;
in a further preferred embodiment R¹¹, R¹⁴, R²⁰, R²¹, R²², R²³ and R²⁴ are - in each case - independently of each other hydrogen, a C₁-C₈alkyl group especially methyl, ethyl, i-propyl, n-butyl, sec-butyl, tert-butyl or isoamyl; or a phenyl group, which can optionally be substituted by one or two groups G; or a C₂-C₃₀heteroaryl group, which can optionally be substituted by G; more preferably hydrogen, a C₁-C₈alkyl group especially methyl, ethyl, i-propyl, n-butyl, sec-butyl, tert-butyl or isoamyl; or a phenyl group, which can optionally be substituted by one or two C₁-C₈alkyl groups, for example 2-tolyl, 3-tolyl, 4-tolyl, 2-ethylphenyl, 3-ethylphenyl, 4-ethylphenyl, 2-isopropylphenyl, 3-isopropylphenyl or 4-isopropylphenyl; most preferably hydrogen or a C₁-C₈alkyl group especially methyl, ethyl, i-propyl, n-butyl, sec-butyl, tert-butyl or isoamyl;
or
two adjacent radicals R¹¹ or two adjacent radicals R¹⁴ form together a group 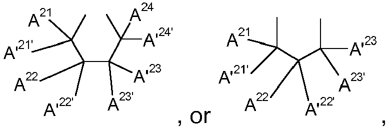 wherein A²¹, A^{21'}, A²², A^{22'}, A²³, A^{23'}, A^{24'} and A²⁴ are independently of each other H, a C₁-C₄alkyl group, a C₃-C₆cycloalkyl group, or a fluoroC₁-C₄alkyl group;
R²⁵ is CH₃ or ethyl or iso-propyl;
R²⁶ is a phenyl group, which can optionally be substituted by one or two groups selected from CF₃ and C₁-C₈alkyl; preferably optionally substituted by one or two C₁-C₈alkyl groups; or
R²⁶ is CH₃; or iso-propyl; preferably, R²⁶ is a phenyl group, which can optionally be substituted by one or two groups selected from CF₃ and C₁-C₈alkyl preferably optionally substituted by one or two C₁-C₈alkyl groups; in a further preferred embodiment R²⁶ is a phenyl group,
which is substituted by one or two phenyl groups;
D is -S-, -O-, or -NR⁶⁵-;
E is -OR⁶⁹, -CN, CF₃, C₁-C₈alkyl or F; preferably CF₃ or C₁-C₈alkyl; more preferably C₁-C₈alkyl;
G is -OR⁶⁹, -CN, CF₃ or C₁-C₈alkyl; preferably C₁-C₈alkyl;
R⁶⁵ is a phenyl group, which can optionally be substituted by one or two C₁-C₈alkyl groups;
an unsubstituted C₁-C₁₈alkyl group; or a C₁-C₁₈alkyl group, which is interrupted by -O-; and
R⁶⁹ is a phenyl group, which can optionally be substituted by one or two C₁-C₈alkyl groups;
an unsubstituted C₁-C₁₈alkyl group; or a C₁-C₁₈alkyl group, which is interrupted by -O-;
A¹ is C₆-C₁₀aryl;
or
two adjoint groups A¹ together form a group 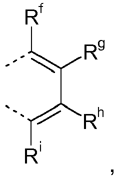 wherein R^{f}, R^{g}, R^{h} and Rⁱ are independently of each other H, or C₁-C₈alkyl;
Q¹ and Q² are independently of each other hydrogen, C₁-C₁₈alkyl, or C₆-C₁₈aryl;
w, x are are independently of each other 0, 1 or 2, preferably 0 or 1; more preferably 0;
z is 0, 1, 2 or 3, preferably 0, 1, more preferably 0;
y, y', y", u, v
are independently of each other 0, 1 or 2, preferably 0 or 2; more preferably 0;
y'" is 0 or 1, preferably 0;
p, q, r, s, t, t', t"
are are independently of each other 0, 1, 2, 3 or 4, preferably 0, 1, 2 or 3;
r' is 0, 1 or 2, preferably 0 or 1, more preferably 0.

12. The metal carbene complex according to anyone of claims 1 to 11, wherein the metal is Ir.

13. The metal carbene complex according to claim 12, selected from 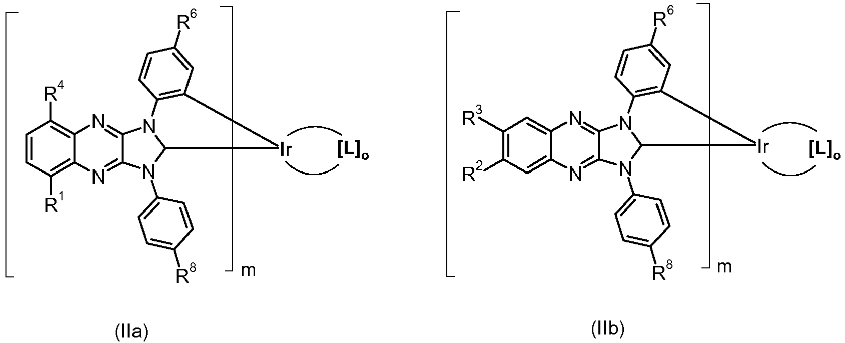 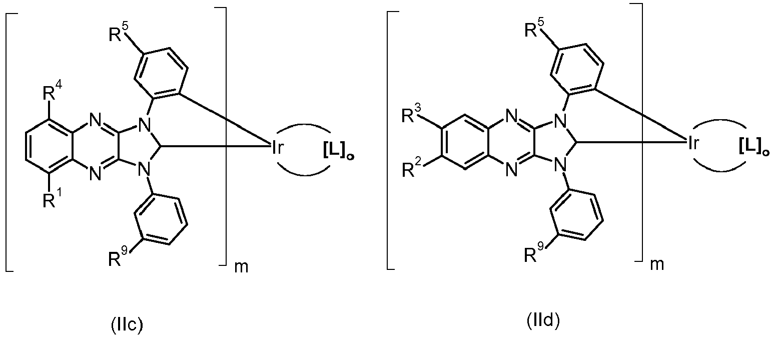 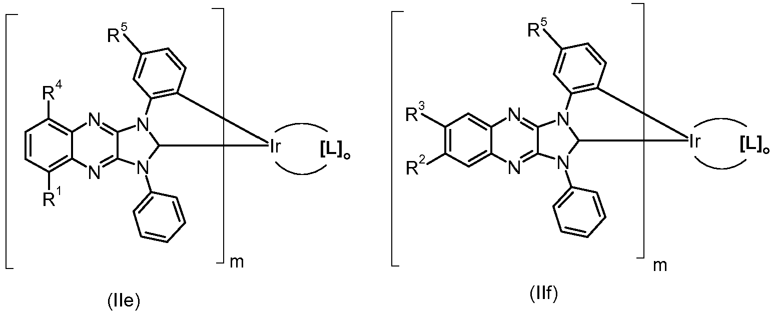 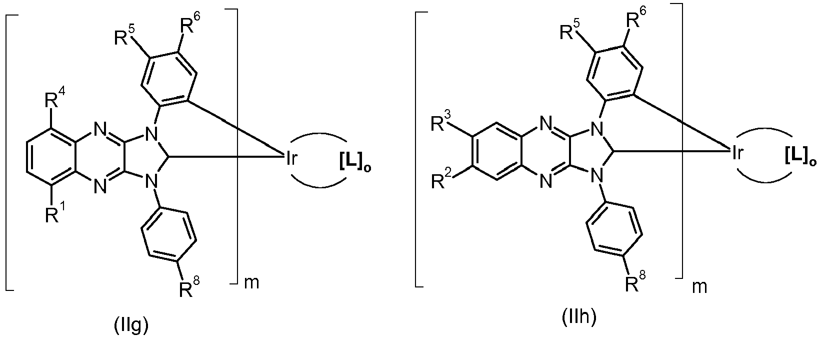 wherein
R¹, R², R³ and R⁴
are independently of each other - in each case - hydrogen; a C₁-C₈alkyl group, which can optionally be substituted by at least one substituent E and/or interrupted by D; a C₃-C₆cycloalkyl group, which can optionally be substituted by at least one substituent E; or a phenyl group, which can optionally be substituted by one or two groups G;
preferably, in the case that R¹, R², R³ and/or R⁴ are a phenyl group, which can optionally be substituted by one or two groups G; R⁵, R⁶, R⁸ and R⁹ are not a phenyl group, which can optionally be substituted by one or two groups G;
more preferably, R¹, R², R³ and R⁴ are independently of each other - in each case - hydrogen; a C₁-C₈alkyl group, which can optionally be substituted by at least one substituent E and/or interrupted by D; or a C₃-C₆cycloalkyl group, which can optionally be substituted by at least one substituent E;
most preferably, R¹ and R⁴ as well as R² and R³ are identical; even further more preferably, R¹, R², R³ and R⁴ are hydrogen;
R⁵ and R⁶
are independently of each other - in each case - hydrogen; a C₁-C₈alkyl group, which can optionally be substituted by at least one substituent E and/or interrupted by D; or a C₃-C₆cycloalkyl group, which can optionally be substituted by at least one substituent E; or a phenyl group, which can optionally be substituted by one or two groups G;
preferably, R⁵ and R⁶ are independently of each other - in each case - hydrogen; a C₁-C₈alkyl group, which can optionally be substituted by at least one substituent E and/or interrupted by D; or a C₃-C₆cycloalkyl group, which can optionally be substituted by at least one substituent E; or either R⁵ or R⁶, preferably R⁵, are a phenyl group, which can optionally be substituted by one or two groups G;
more preferably, R⁵ and R⁶ are independently of each other - in each case - hydrogen; a C₁-C₈alkyl group, which can optionally be substituted by at least one substituent E and/or
interrupted by D; or a C₃-C₆cycloalkyl group, which can optionally be substituted by at least one substituent E; or either R⁵ or R⁶, preferably R⁵, is a phenyl group, which can optionally be substituted by one or two groups G; in a further preferred embodiment, R⁶ is a phenyl group, which can optionally be substituted by one or two groups G; more preferably, R⁵ and R⁶ are hydrogen;
R⁸ and R⁹
are independently of each other hydrogen; a C₁-C₈alkyl group, which can optionally be substituted by at least one substituent E and/or interrupted by D; or a C₃-C₆cycloalkyl group, which can optionally be substituted by at least one substituent E; or a phenyl group, which can optionally be substituted by one or two groups G;
preferably, R⁸ and R⁹ are independently of each other - in each case - hydrogen; a C₁-C₈alkyl group, which can optionally be substituted by at least one substituent E and/or interrupted by D; or a C₃-C₆cycloalkyl group, which can optionally be substituted by at least one substituent E; or either R⁸ or R⁹ are a phenyl group, which can optionally be substituted by one or two groups G;
more preferably, R⁸ and R⁹ are independently of each other - in each case - hydrogen; a C₁-C₈alkyl group, which can optionally be substituted by at least one substituent E and/or
interrupted by D; or a C₃-C₆cycloalkyl group, which can optionally be substituted by at least one substituent E; more preferably, R⁹ is hydrogen and R⁸ is hydrogen or a phenyl group which can be optionally substituted by one or two groups G; most preferably, R⁸ and R⁹ are hydrogen;
D is -S- or -O-;
E is -OR⁶⁹, -CN, CF₃, C₁-C₈alkyl or F; preferably CF₃ or C₁-C₈alkyl; preferably C₁-C₈alkyl;
G is -OR⁶⁹, -CN, CF₃ or C₁-C₈alkyl; preferably C₁-C₈alkyl;
R⁶⁹ is a phenyl group, which can optionally be substituted by one or two C₁-C₈alkyl groups; an unsubstituted C₁-C₈alkyl group; or a C₁-C₈alkyl group, which is interrupted by - O-;
L is a monoanionic bidentate ligand;
m is 1, 2, or 3; preferably 2 or 3; or - in a further preferred embodiment - 1;
o is 0, 1, or 2; preferably 0 or 1; or - in a further preferred embodiment - 2;
and the sum of m + o is 3;
in the case that o = 2, the ligands L may be the same or different, preferably the same;
and in the case that m is 2 or 3, the m carbene ligands may be the same or different, preferably the same.

14. The metal carbene complex according to claim 13, selected from 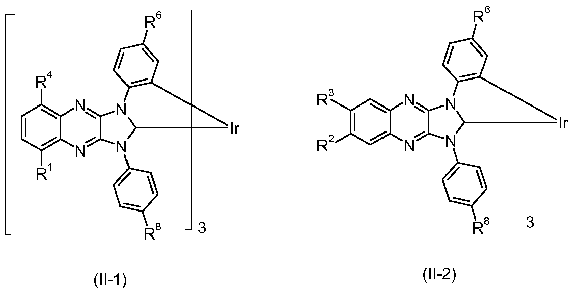 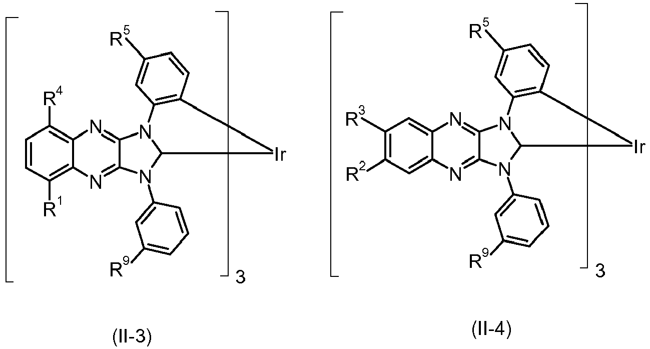 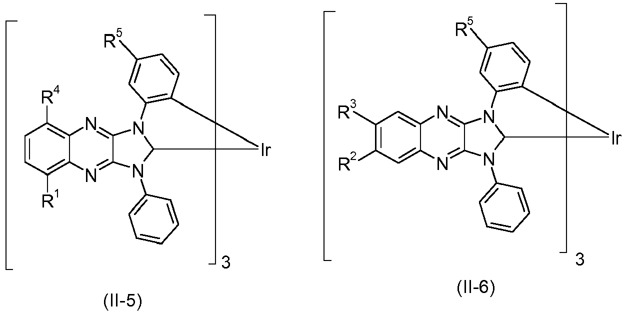 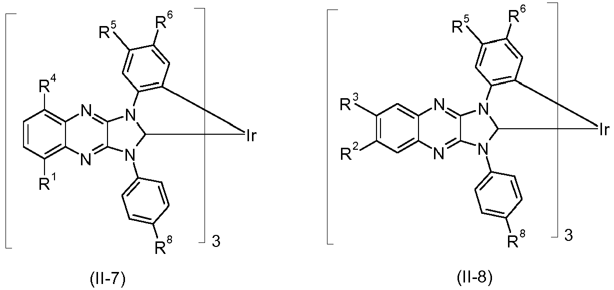 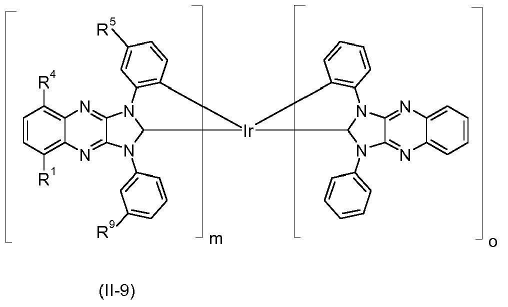 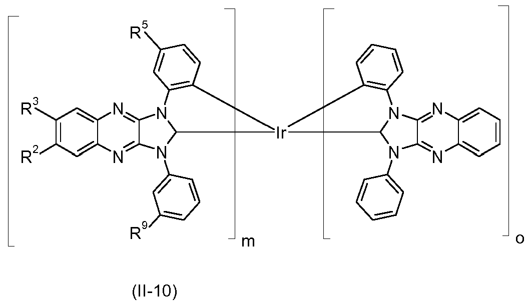 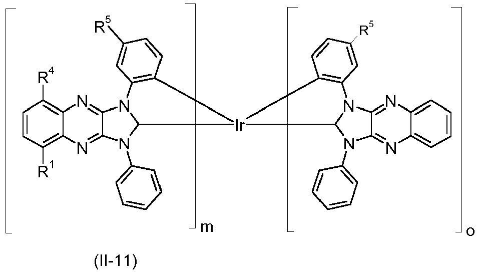 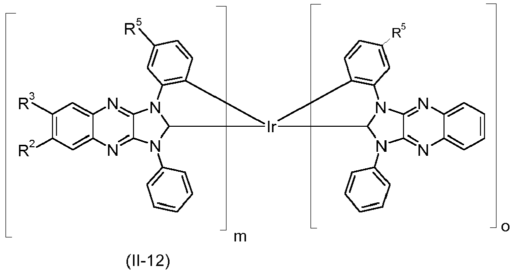 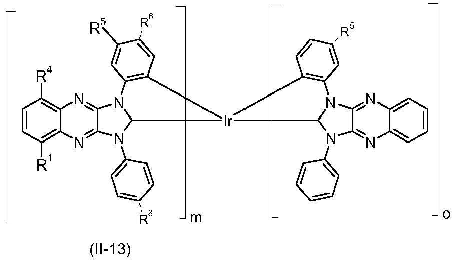 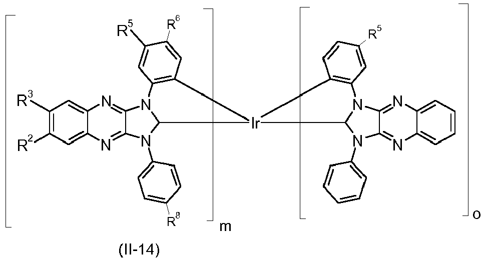 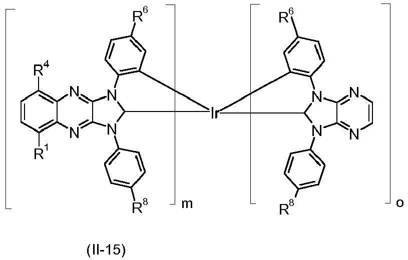 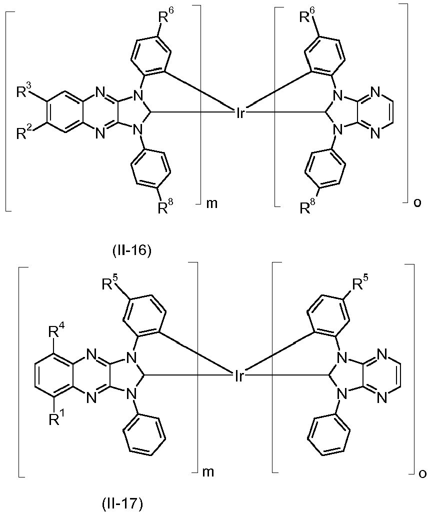 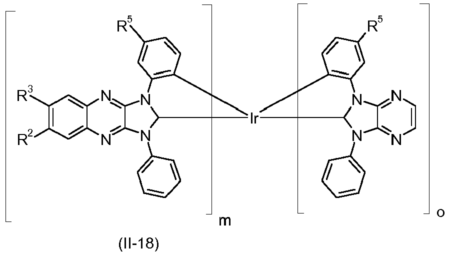 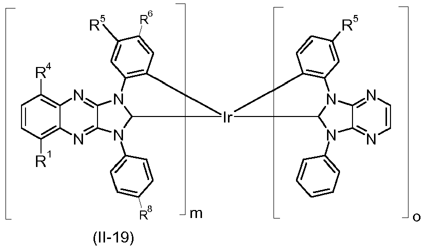 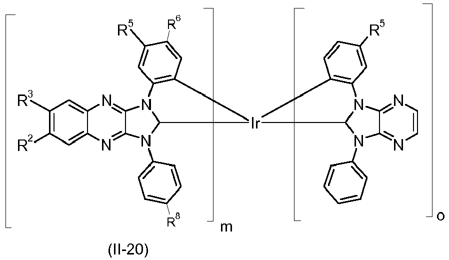 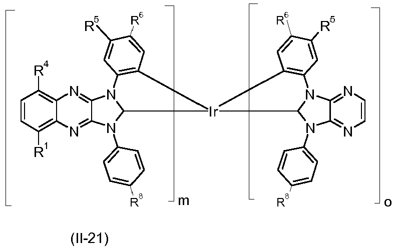 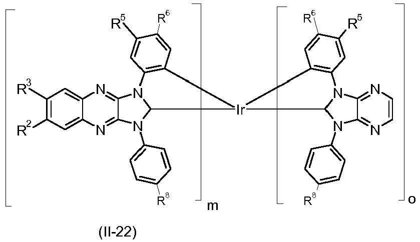 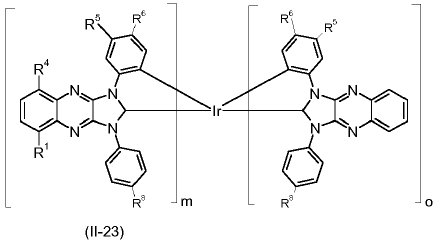 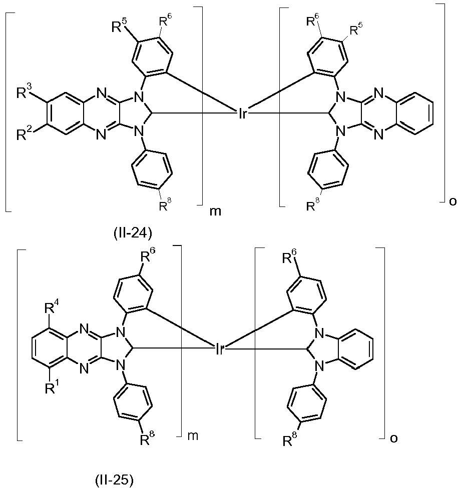 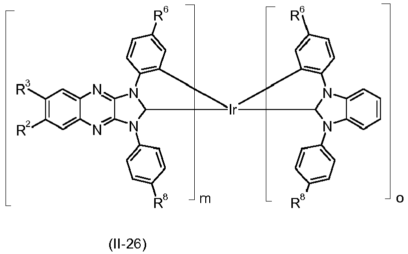 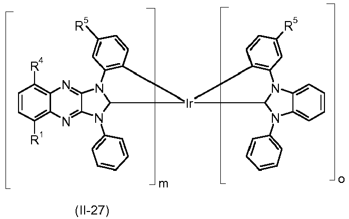 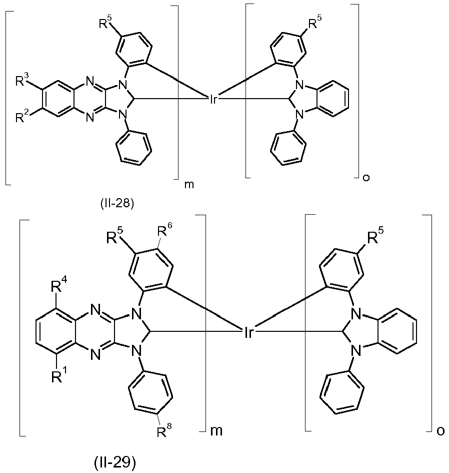 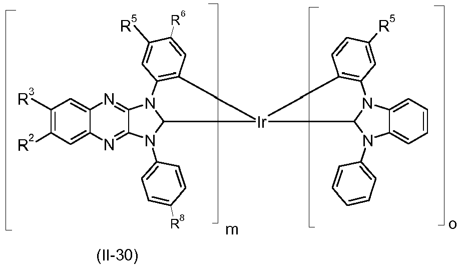 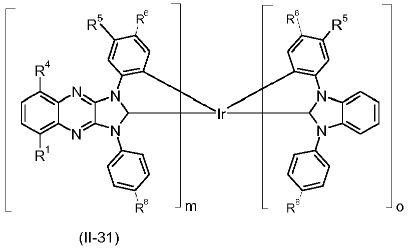 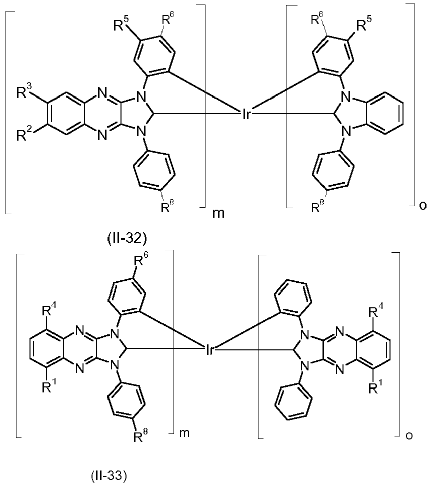 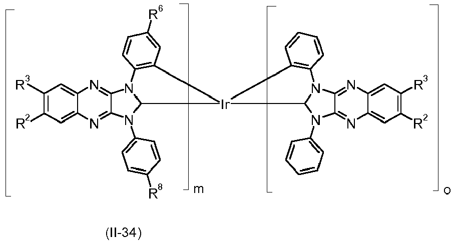 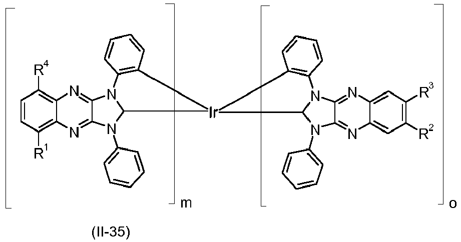 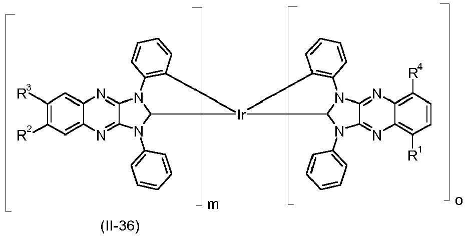 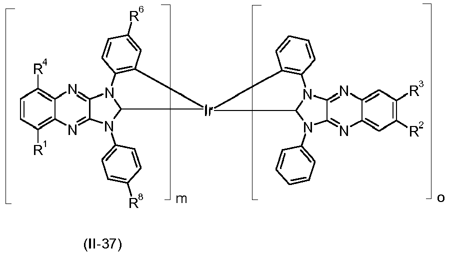 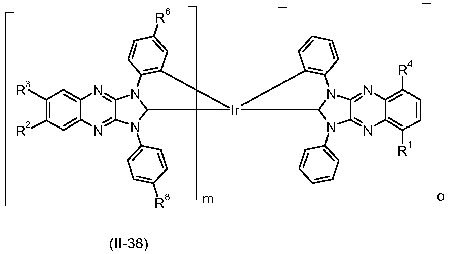 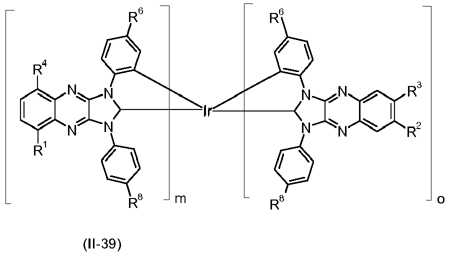 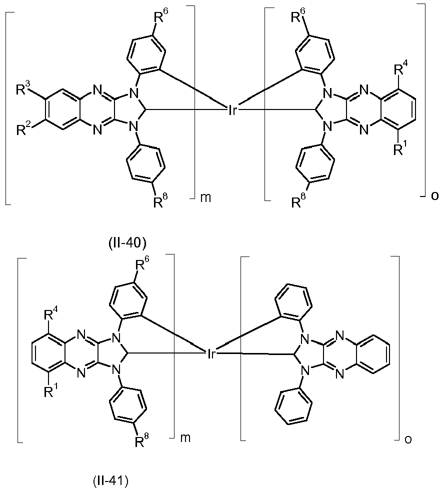 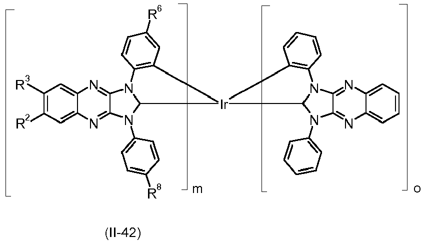 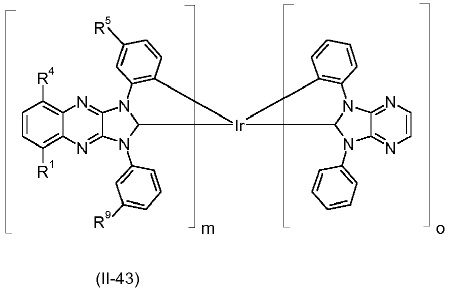 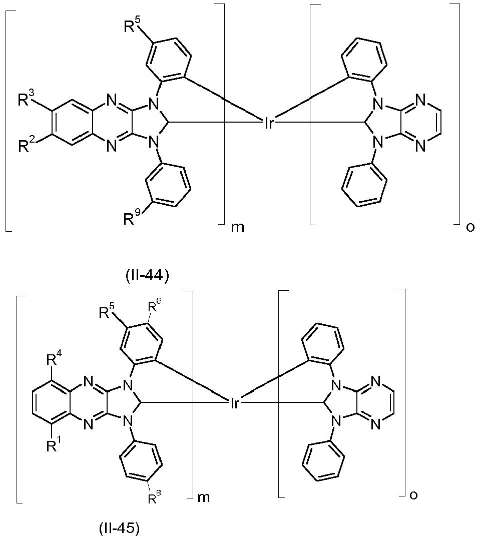 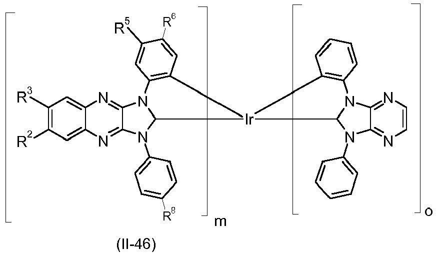 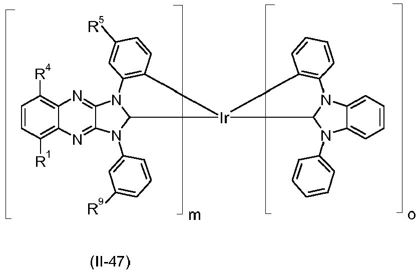 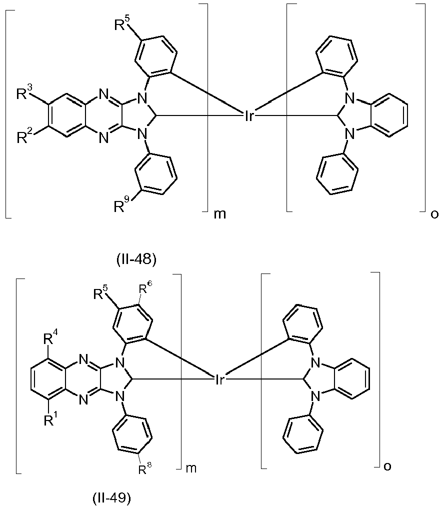 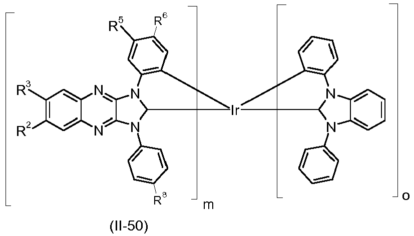 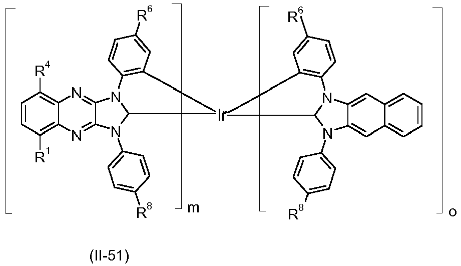 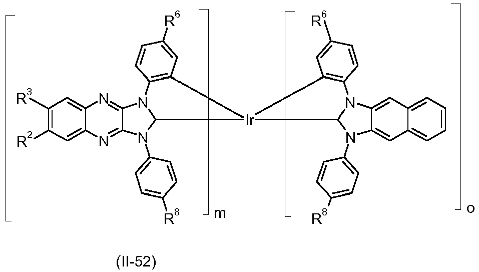 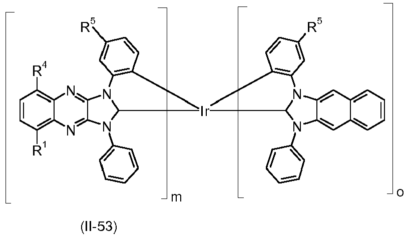 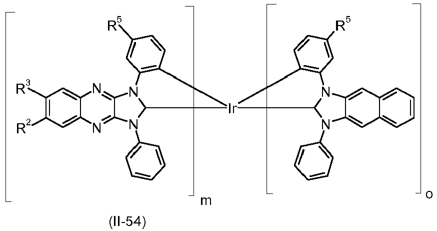 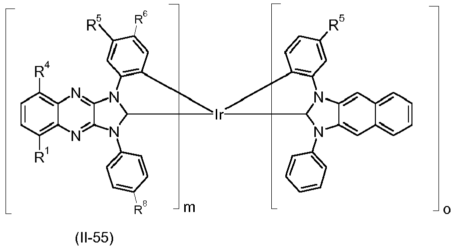 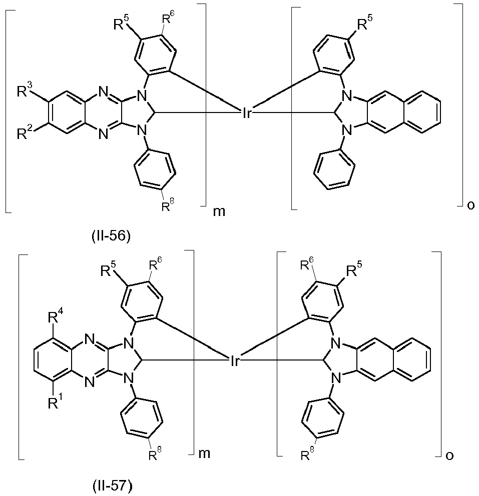 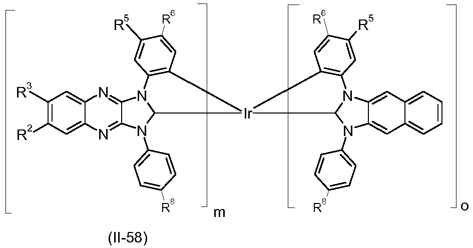 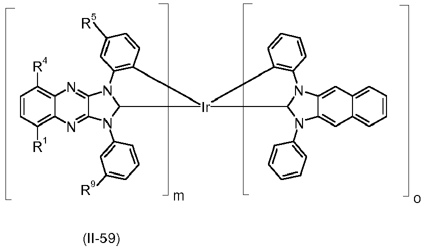 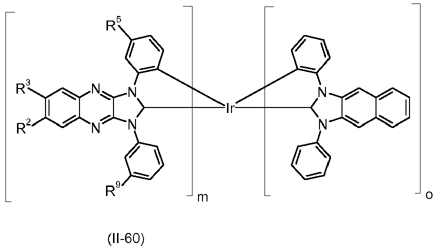 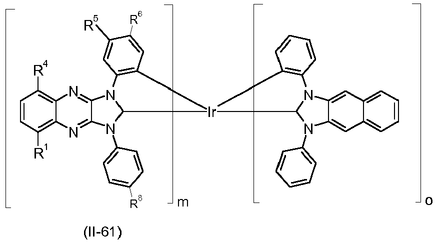 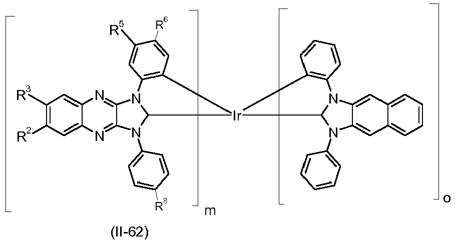 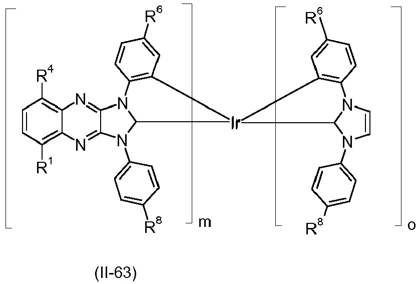 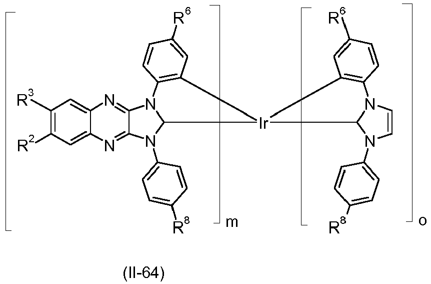 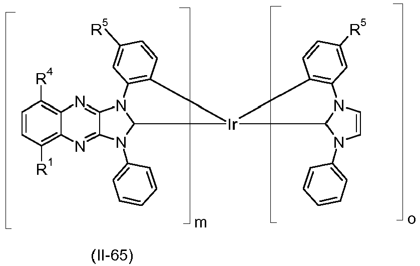 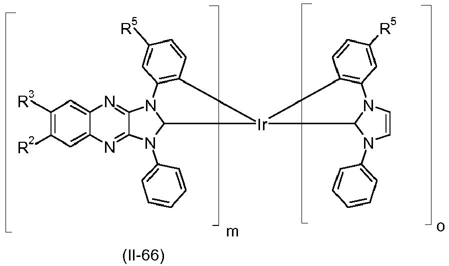 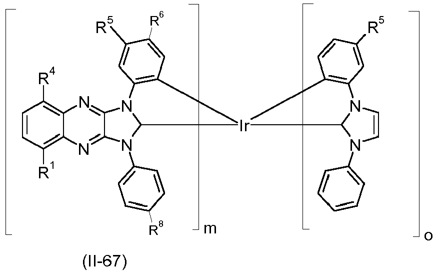 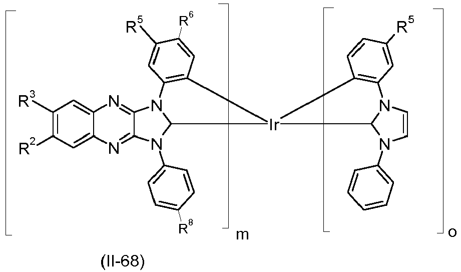 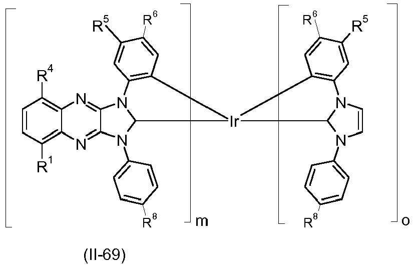 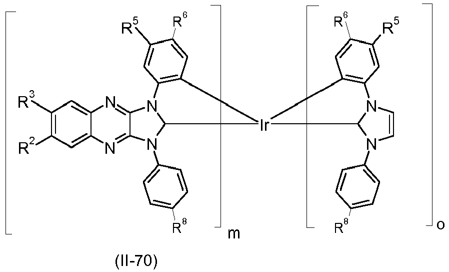 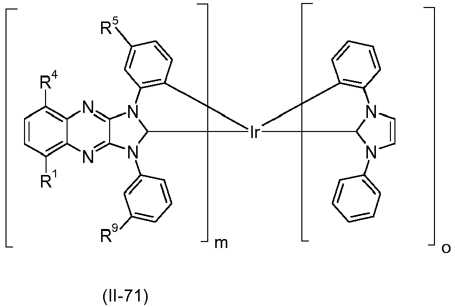 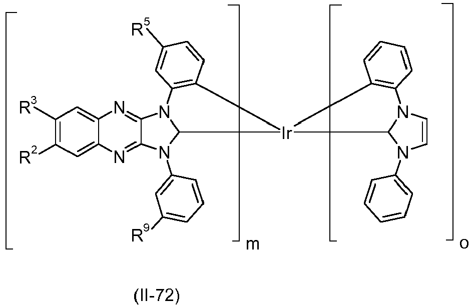 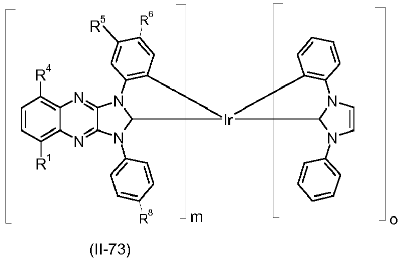 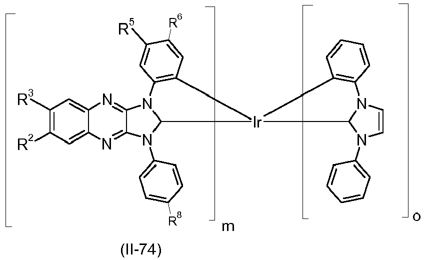 wherein
R¹, R², R³ and R⁴
are independently of each other - in each case - hydrogen, a C₁-C₈alkyl group, which can optionally be substituted by at least one substituent E and/or interrupted by D; a C₃-C₆cycloalkyl group, which can optionally be substituted by at least one substituent E; or a phenyl group, which can optionally be substituted by one or two groups G;
preferably, in the case that R¹, R², R³ and/or R⁴ are a phenyl group, which can optionally be substituted by one or two groups G; R⁵, R⁶, R⁸ and R⁹ are not a phenyl group, which can optionally be substituted by one or two groups G;
more preferably, R¹, R², R³ and R⁴ are independently of each other - in each case - hydrogen, a C₁-C₈alkyl group, which can optionally be substituted by at least one substituent E and/or interrupted by D; or a C₃-C₆cycloalkyl group, which can optionally be substituted by at least one substituent E;
most preferably, R¹ and R⁴ as well as R² and R³ are identical; even further more preferably, R¹, R², R³ and R⁴ are hydrogen;
R⁵ and R⁶
are independently of each other - in each case - hydrogen, a C₁-C₈alkyl group, which can optionally be substituted by at least one substituent E and/or interrupted by D; or a C₃-C₆cycloalkyl group, which can optionally be substituted by at least one substituent E; or a phenyl group, which can optionally be substituted by one or two groups G;
preferably, R⁵ and R⁶ are independently of each other - in each case - hydrogen, a C₁-C₈alkyl group, which can optionally be substituted by at least one substituent E and/or interrupted by D; or a C₃-C₆cycloalkyl group, which can optionally be substituted by at least one substituent E; or either R⁵ or R⁶, preferably R⁵, are a phenyl group, which can optionally be substituted by one or two groups G;
more preferably, R⁵ and R⁶ are independently of each other - in each case - hydrogen, a C₁-C₈alkyl group, which can optionally be substituted by at least one substituent E and/or
interrupted by D; or a C₃-C₆cycloalkyl group, which can optionally be substituted by at least one substituent E; or either R⁵ or R⁶, preferably R⁵, is a phenyl group, which can optionally be substituted by one or two groups G; in a further preferred embodiment, R⁶ is a phenyl group, which can optionally be substituted by one or two groups G; more preferably, R⁵ and R⁶ are hydrogen;
R⁸ and R⁹
are independently of each other - in each case - hydrogen, a C₁-C₈alkyl group, which can optionally be substituted by at least one substituent E and/or interrupted by D; or a C₃-C₆cycloalkyl group, which can optionally be substituted by at least one substituent E; or a phenyl group, which can optionally be substituted by one or two groups G;
preferably, R⁸ and R⁹ are independently of each other - in each case - hydrogen, a C₁-C₈alkyl group, which can optionally be substituted by at least one substituent E and/or interrupted by D; or a C₃-C₆cycloalkyl group, which can optionally be substituted by at least one substituent E; or either R⁸ or R⁹ are a phenyl group, which can optionally be substituted by one or two groups G;
more preferably, R⁸ and R⁹ are independently of each other - in each case - a C₁-C₈alkyl group, which can optionally be substituted by at least one substituent E and/or interrupted by D; or a C₃-C₆cycloalkyl group, which can optionally be substituted by at least one substituent E; more preferably, R⁹ is hydrogen and R⁸ is hydrogen or a phenyl group which can be optionally substituted by one or two groups G; most preferably, R⁸ and R⁹ are hydrogen;
most preferably, in the case that R⁶ and R⁸ are both present, R⁶ and R⁸ are identical; in the case that R⁵ and R⁹ are both present, R⁵ and R⁹ are identical;
D is -S- or -O-;
E is -OR⁶⁹, -CN, CF₃, C₁-C₈alkyl or F; preferably CF₃ or C₁-C₈alkyl; preferably C₁-C₈alkyl;
G is -OR⁶⁹, -CN, CF₃ or C₁-C₈alkyl; preferably C₁-C₈alkyl;
R⁶⁹ is a phenyl group, which can optionally be substituted by one or two C₁-C₈alkyl groups; an unsubstituted C₁-C₈alkyl group; or a C₁-C₈alkyl group, which is interrupted by -O-;
m is 2 or 1, preferably 2; in the case that m is 2, the two ligands are identical or different, preferably, the two ligands are identical;
o is 1 or 2, preferably 1; in the case that m is 2, the two ligands are identical or different, preferably, the two ligands are identical;
and the sum of m + o is 3.

15. An organic electronic device, comprising at least one metal carbene complex according to any of claims 1 to 14 and 22 and 23.

16. The organic electronic device according to claim 15, wherein the organic electronic device is selected from organic light-emitting diodes (OLEDs), organic photovoltaic cells (OPVs), organic field-effect transistors (OFETs) and light-emitting electrochemical cells (LEECs).

17. A light-emitting layer comprising at least one metal carbene complex according to any of claims 1 to 14 and 22 and 23.

18. The light-emitting layer according to claim 17, comprising at least one metal carbene complex according to any of claims 1 to 14 and 22 and 23 and at least one host material.

19. An apparatus selected from the group consisting of stationary visual display units such as visual display units of computers, televisions, visual display units in printers, kitchen appliances and advertising panels, illuminations, information panels, and mobile visual display units such as visual display units in cellphones, tablet PCs, laptops, digital cameras, MP3 players, vehicles and destination displays on buses and trains; illumination units; keyboards; items of clothing; furniture; wallpaper, comprising the organic electronic device according to claim 15, or 16, or the emitting layer according to claim 17 or 18.

20. Use of a metal carbene complex according to any of claims 1 to 14 and 22 and 23 for electrophotographic photoreceptors, photoelectric converters, organic solar cells (organic photovoltaics), switching elements, organic light emitting field effect transistors (OLEFETs), image sensors, dye lasers and electroluminescent devices.

21. A process for preparing a metal carbene complex according to anyone of claims 1 to 14 and 22 and 23, comprising at least one ligand of formula (I') 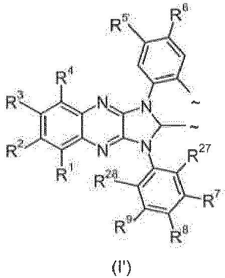 wherein
wherein the residues R¹, R², R³, R⁴, R⁶, R⁷, R⁸, R⁹, R²⁷ and R²⁸ are defined in any one of claims 1 to 14, and
R⁵ is a C₁-C₁₈alkyl group, which can optionally be substituted by at least one substituent E and/or interrupted by D; a C₃-C₁₂cycloalkyl group, which can optionally be substituted by at least one substituent E; a C₆-C₁₄aryl group, which can optionally be substituted by at least one substituent G; a -N(C₆-C₁₄aryl)₂ group, which can optionally be substituted by at least one substituent G; or a heteroaryl group comprising 3 to 11 ring atoms, which can optionally be substituted by at least one substituent G, interrupted by at least one of O, S and N;
comprising reacting metal carbene complex, wherein the metal is selected from Ir and Pt, comprising at least one ligand of formula of formula (III) 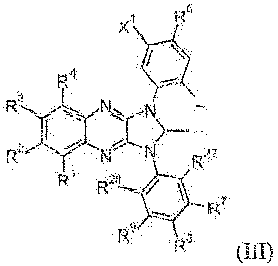 with a compound of formula (IV) corresponding to the respective Y-substituted residue R^{5'}:
R^{5'}-Y **(IV)**
wherein
X' is Cl, Br, or I, especially Br;
Y is -B(OH)₂, -B(OY¹)₂, 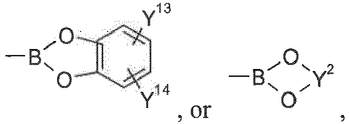 wherein Y¹ is a C₁-C₁₀alkyl group and Y² is independently in each occurrence a C₂-C₁₀alkylene group, such as-CY³Y⁴-CY⁵Y⁶-, or -CY⁷Y⁸-CY⁹Y¹⁰-CY¹¹Y¹²-, wherein Y³,Y⁴, Y⁵, Y⁶, Y⁷, Y⁸, Y⁹, Y¹⁰, Y¹¹ and Y¹² are independently of each other hydrogen, or a C₁-C₁₀alkyl group, especially -C(CH₃)₂C(CH₃)₂-, -CH₂C(CH₃)₂CH₂-, or -C(CH₃)₂CH₂C(CH₃)₂-, and Y¹³ and Y¹⁴ are independently of each other hydrogen, or a C₁-C₁₀alkyl group;
-SnR³⁰⁷R³⁰⁸ R³⁰⁹, wherein R³⁰⁷, R³⁰⁸ and R³⁰⁹ are identical or different and are H or C₁-C₆alkyl, wherein two radicals optionally form a common ring and these radicals are optionally branched or unbranched;
ZnR³¹⁰R³¹¹, wherein R³¹⁰ is halogen and R³¹¹ is a C₁-C₁₀alkyl group, a C₆-C₁₂aryl group, or C₁-C₁₀alkenyl group; or
SiR³¹²R³¹³R³¹⁴, wherein R³¹², R³¹³ and R³¹⁴ are identical or different and are halogen, or C₁-C₆alkyl.

22. The metal carbene complex according to anyone of claims 1, 2, 4-14, wherein the radicals R¹, R², R³, R⁴, R⁵, R⁶, R⁷, R⁸, R⁹, R²⁷ and R²⁹ are hydrogen.

23. The metal carbene complex according to anyone of claims 1 to 14, wherein the metal carbene complex has one of the following formulae 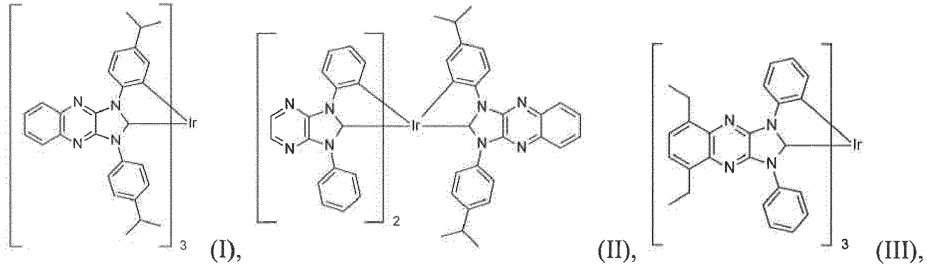 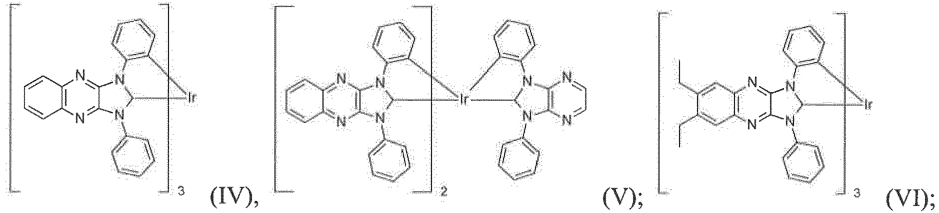 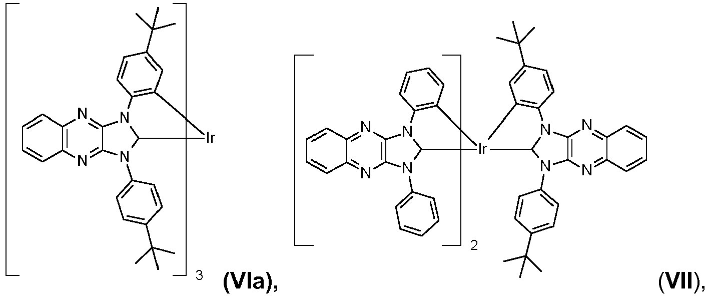 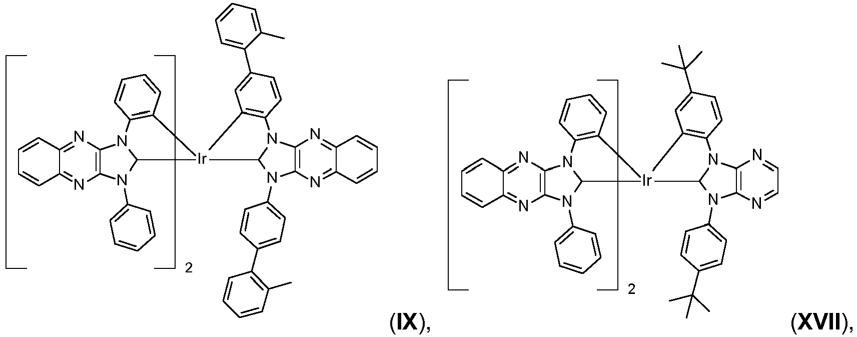 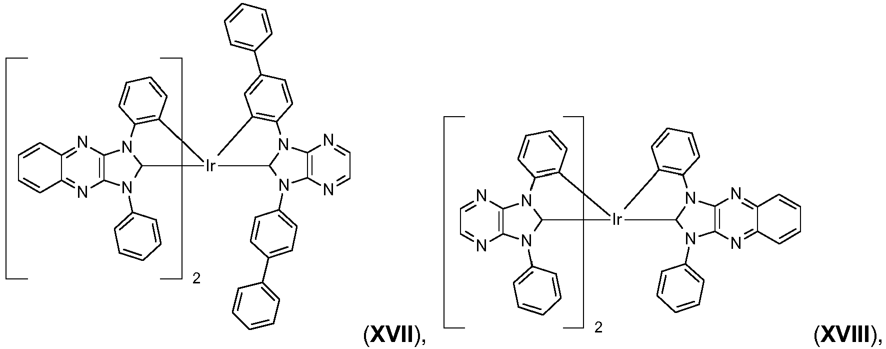 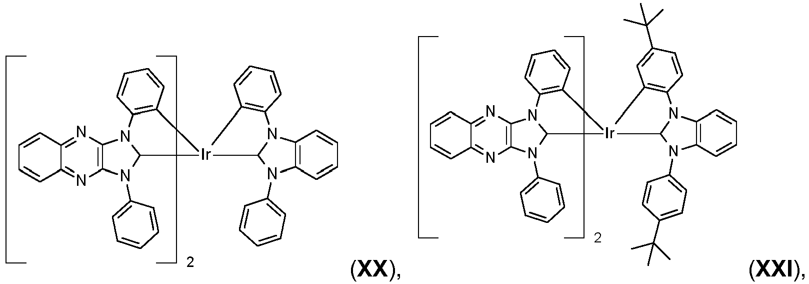 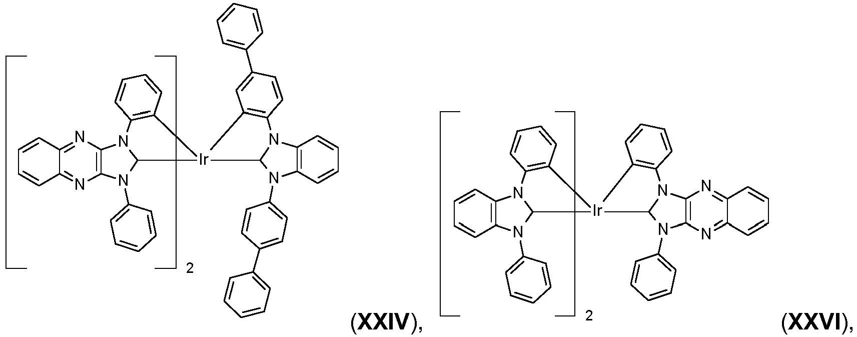 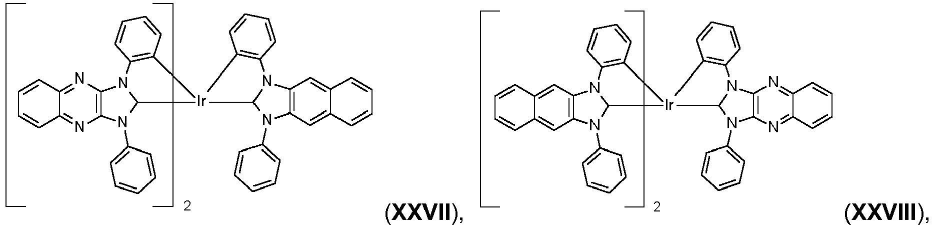 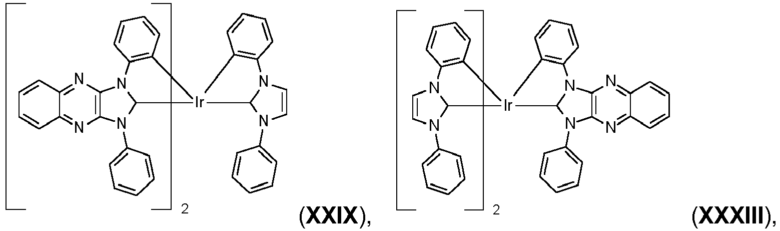 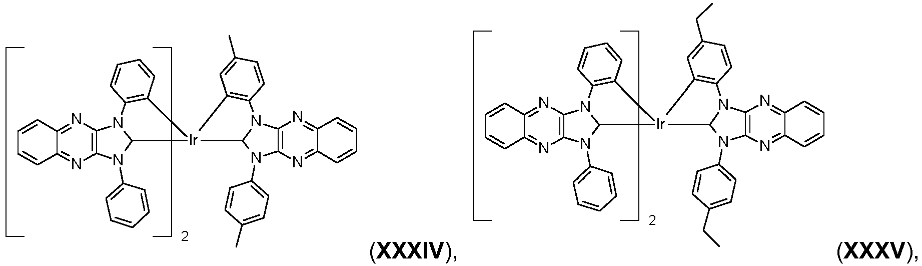 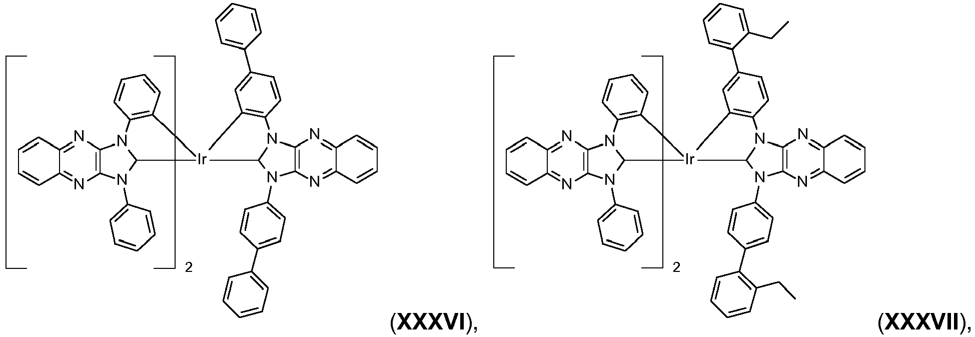 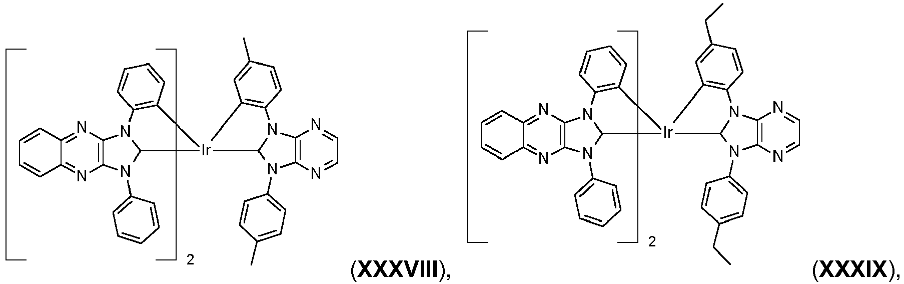 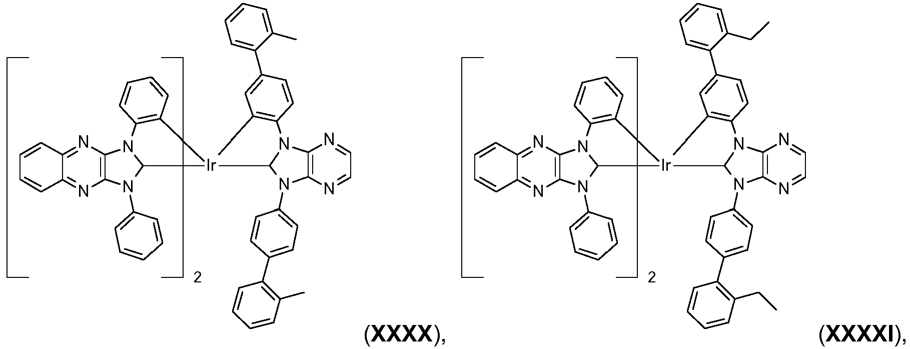 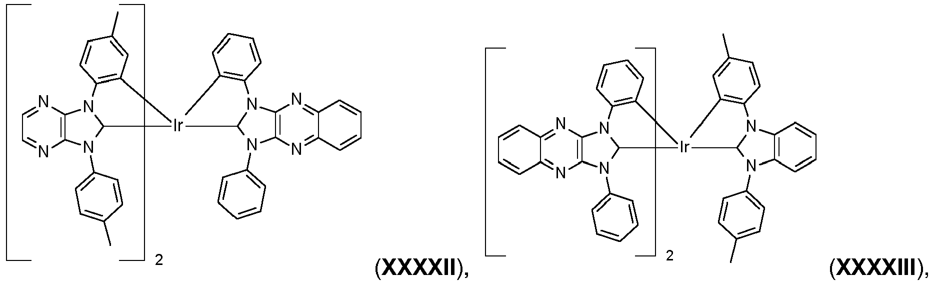 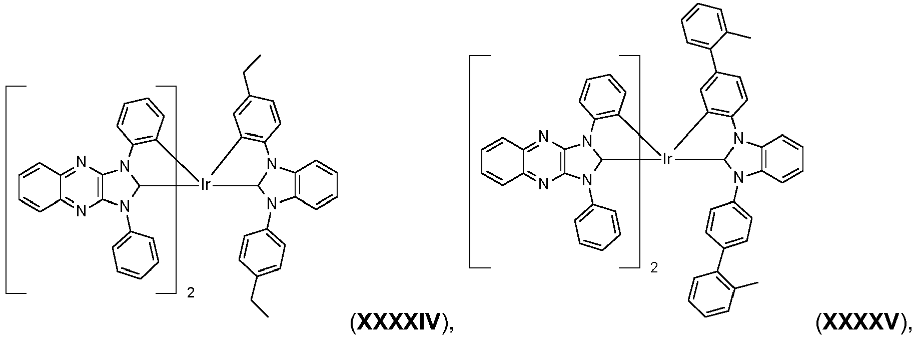 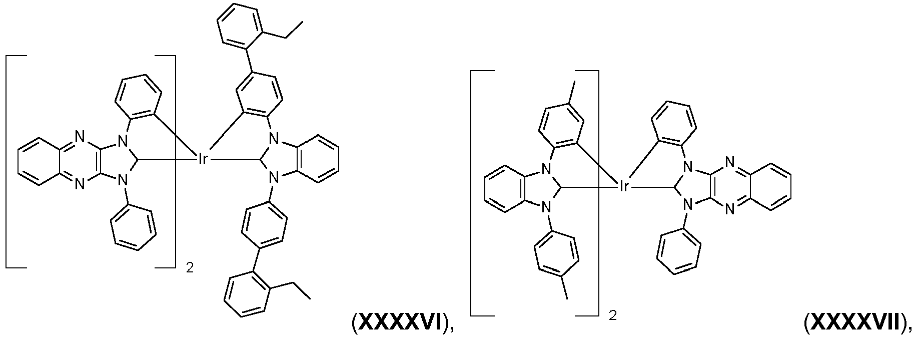 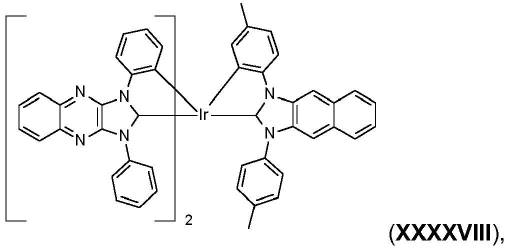 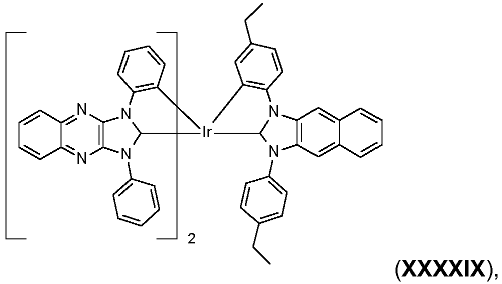 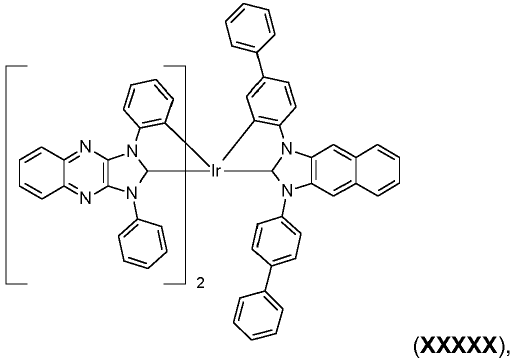 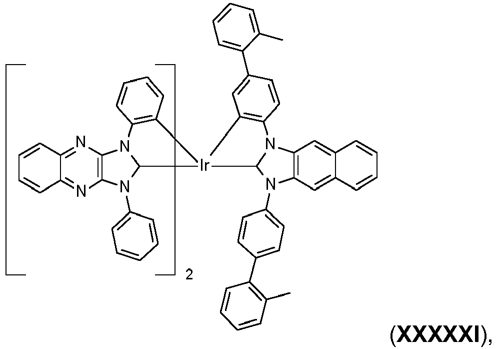 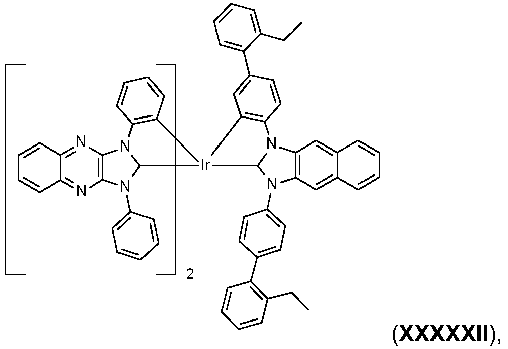 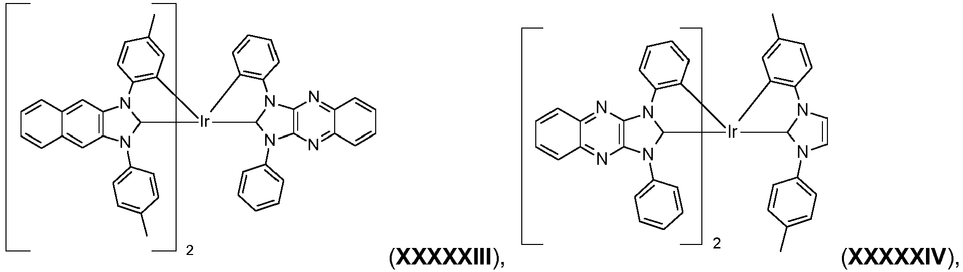 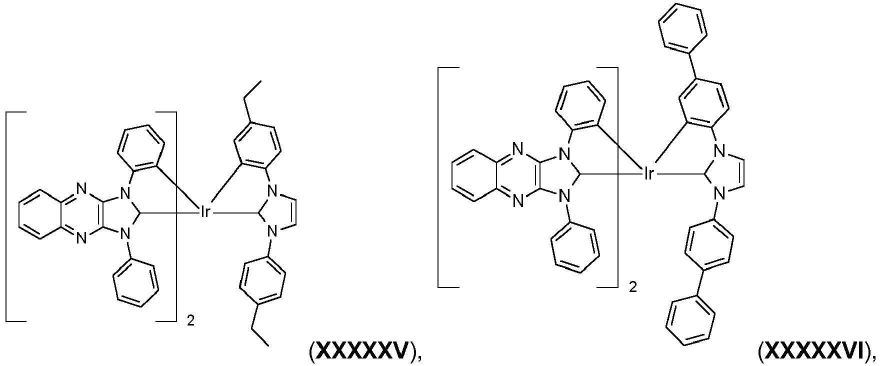 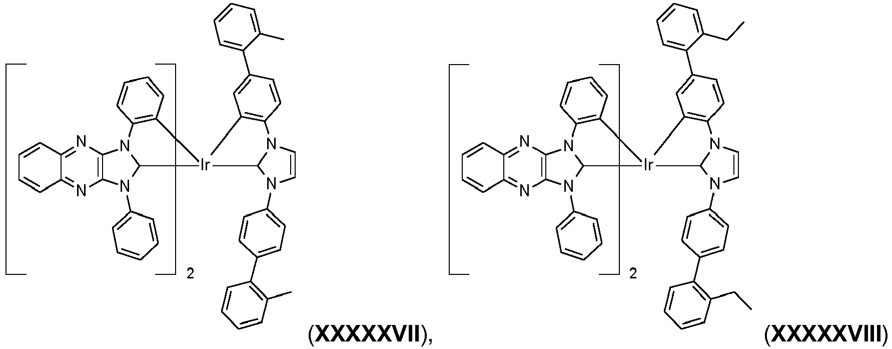 and

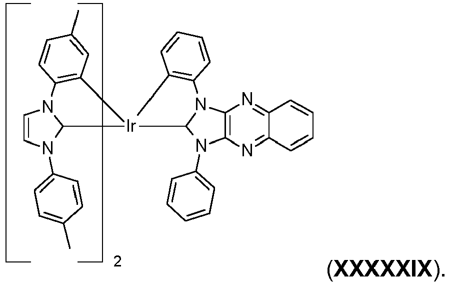

## Patentansprüche

1. Ein Metall-Carben Komplex, wobei das Metall aus Ir oder Pt ausgewählt ist, umfassend mindestens einen Liganden der Struktur (A), vorzugsweise mindestens einen Liganden der Struktur (I) 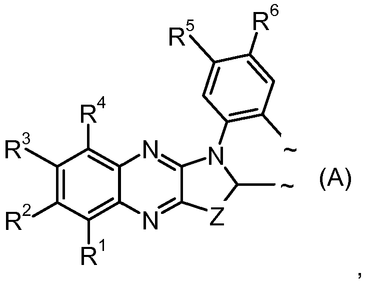 vorzugsweise 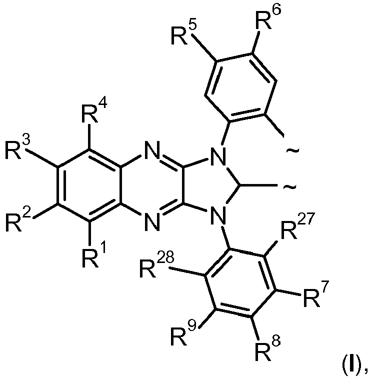 wobei
Z NR^{x}, O oder S ist, bevorzugt NR^{x} oder O, besonders bevorzugt NR^{x},
R^{x} ist 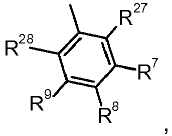
R¹, R², R³ und R⁴
sind unabhängig voneinander Wasserstoff; eine C₁-C₁₈ Alkyl-Gruppe, die gegebenenfalls mit mindestens einem Substituenten E substituiert und/oder durch D unterbrochen sein kann; eine C₃-C₁₂ Cycloalkyl-Gruppe, die gegebenenfalls mit mindestens einem Substituenten E substituiert sein kann; eine Heterocycloalkyl-Gruppe, umfassend 3 bis 6 Ringatome, unterbrochen durch mindestens eines von O, S oder NR⁶⁵ und/oder mit mindestens einem Substituenten E substituiert; eine C₆-C₁₄ Aryl-Gruppe, die gegebenenfalls mit mindestens einem Substituenten G substituiert sein kann; eine -NR⁶⁵-C₆-C₁₄ Aryl-Gruppe, vorzugsweise eine -N(C₆-C₁₄ Aryl)₂ Gruppe, die gegebenenfalls mit mindestens einem Substituenten G substituiert sein kann; eine Heteroaryl-Gruppe umfassend 3 bis 11 Ringatome, die gegebenenfalls mit mindestens einem Substituenten G substituiert sein kann, unterbrochen durch mindestens eines von O, S, N und NR⁶⁵; oder eine -NR⁶⁵-Heteroaryl-Gruppe, vorzugsweise eine -N(Heteroaryl)₂-Gruppe, umfassend 3 bis 11 Ringatome, die gegebenenfalls mit mindestens einem Substituenten G substituiert sein kann, unterbrochen durch mindestens eines von O, S, N und NR⁶⁵; ein Halogen-Atom, insbesondere F oder Cl;
eine C₁-C₁₈ Halogenalkyl-Gruppe wie CF₃; CN; oder SiR⁸⁰R⁸¹R⁸²;
oder
R¹ und R², R² und R³ oder R³ und R⁴ bilden einen Ring 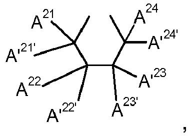 oder 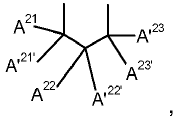 wobei A²¹, A^{21'}, A²², A^{22'}, A²³, A^{23'}, A^{24'} und A²⁴ unabhängig voneinander Wasserstoff, eine C₁-C₄ Alkyl-Gruppe, eine C₃-C₆ Cycloalkyl-Gruppe, oder eine Fluoro-C₁-C₄-Alkyl-Gruppe sind;
R⁵ und R⁶
sind unabhängig voneinander Wasserstoff; eine C₁-C₁₈ Alkyl-Gruppe, die gegebenenfalls mit mindestens einem Substituenten E substituiert und/oder durch D unterbrochen sein kann; eine C₃-C₁₂ Cycloalkyl-Gruppe, die gegebenenfalls mit mindestens einem Substituenten E substituiert sein kann; eine Heterocycloalkyl-Gruppe, umfassend 3 bis 6 Ringatome, unterbrochen durch mindestens eines von O, S und NR⁶⁵ und/oder mit mindestens einem Substituenten E substituiert; eine C₆-C₁₄ Aryl-Gruppe, die gegebenenfalls mit mindestens einem Substituenten G substituiert sein kann; eine -NR⁶⁵-C₆-C₁₄ Aryl-Gruppe, vorzugsweise eine -N(C₆-C₁₄ Aryl)₂ Gruppe, die gegebenenfalls mit mindestens einem Substituenten G substituiert sein kann; eine Heteroaryl-Gruppe umfassend 3 bis 11 Ringatome, die gegebenenfalls mit mindestens einem Substituenten G substituiert sein kann, unterbrochen durch mindestens eines von O, S N, und NR⁶⁵; ein Halogen-Atom, insbesondere F oder Cl; eine C₁-C₁₈ Halogenalkyl-Gruppe wie CF₃; CN; oder SiR⁸⁰R⁸¹R⁸²;
R⁷, R⁸, R⁹, R²⁷ und R²⁸
sind unabhängig voneinander Wasserstoff; eine C₁-C₁₈-Alkyl-Gruppe, die gegebenenfalls mit mindestens einem Substituenten E substituiert und/oder durch D unterbrochen sein kann; eine C₃-C₁₂ Cycloalkyl-Gruppe, die gegebenenfalls mit mindestens einem Substituenten E substituiert sein kann; eine Heterocycloalkyl-Gruppe, umfassend 3 bis 6 Ringatome, unterbrochen durch mindestens eines von O, S und NR⁶⁵ und/oder mit mindestens einem Substituenten E substituiert; eine C₆-C₁₄ Aryl-Gruppe, die gegebenenfalls mit mindestens einen Substituenten G substituiert sein kann; eine Heteroaryl-Gruppe umfassend 3 bis 11 Ringatome, die gegebenenfalls mit mindestens einem Substituenten G substituiert sein kann, unterbrochen durch mindestens eines von O, S N, und NR⁶⁵; ein Halogen-Atom, insbesondere F oder Cl; eine C₁-C₁₈ Halogenalkyl-Gruppe wie CF₃; CN; oder SiR⁸⁰R⁸¹R⁸²; zusätzlich zu den oben erwähnten Gruppen kann R⁸ eine -NR⁶⁵-C₆-C₁₄ Aryl-Gruppe sein, vorzugsweise eine -N(C₆-C₁₄ Aryl)₂ Gruppe, die gegebenenfalls mit mindestens einem Substituenten G substituiert sein kann; oder eine -NR⁶⁵-Heteroaryl-Gruppe, vorzugsweise eine -N(Hetero-Aryl)₂-Gruppe, umfassend 3 bis 11 Ringatome, die gegebenenfalls mit mindestens einem Substituenten G substituiert sein kann, unterbrochen durch mindestens eines von O, S N, und NR⁶⁵;
oder
R⁵ und R⁶ und/oder R⁸ und R⁹ bilden eine Gruppe folgender Struktur 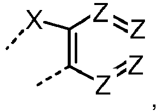 wobei Z für N oder CR'" steht, wobei 0 oder 1 Z für N steht, vorzugsweise 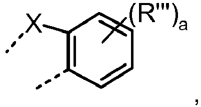 wobei X für O, S, NR⁷⁵ oder CR⁷³R⁷⁴ steht, vorzugsweise O; R'" ist C₁-C₈ Alkyl und a ist 0, 1 oder 2, bevorzugt 0 oder 1, besonders bevorzugt 0;
D ist -CO-, -COO-, -S-, -SO-, -SO₂-, -O-, -NR⁶⁵-, -SiR⁷⁰R⁷¹-, -POR⁷²-, -CR⁶³=CR⁶⁴-, oder -C≡C, vorzugsweise -O-, -S- oder -NR⁶⁵-;
E ist -OR⁶⁹, -SR⁶⁹, -NR⁶⁵R⁶⁶, -COR⁶⁸, -COOR⁶⁷, -CONR⁶⁵R⁶⁶, -CN, Halogen, eine C₁-C₁₈ Alkyl-Gruppe, die gegebenenfalls mit mindestens einem Substituenten E substituiert und/oder durch D unterbrochen sein kann; vorzugsweise F; eine C₁-C₈ Halogenalkyl-Gruppe wie CF₃, oder eine C₁-C₈ Alkyl-Gruppe; E ist bevorzugt C₁-C₈ Alkyl, C₁-C₈ Alkoxy, CN, Halogen, vorzugsweise F, oder C₁-C₈ Halogenalkyl, wie CF₃; besonders bevorzugt C₁-C₈ Alkyl, C₁-C₈ Alkoxy, oder C₁-C₈ Halogen-Alkyl, wie CF₃;
G ist E; oder eine unsubstituierte C₆-C₁₄ Aryl-Gruppe; eine C₆-C₁₄ Aryl-Gruppe, die mit F substituiert ist, C₁-C₁₈ Alkyl, oder C₁-C₁₈ Alkyl, das mit F substituiert und/oder durch O unterbrochen ist; eine unsubstituierte Heteroaryl-Gruppe, umfassend 3 bis 11 Ringatome, unterbrochen durch mindestens eines von O, S, N und NR⁶⁵; oder eine Heteroaryl-Gruppe, umfassend 3 bis 11 Ringatome, unterbrochen durch mindestens eines von O, S, N und NR⁶⁵, die durch F, unsubstituiertes C₁-C₁₈ Alkyl, SiR⁸⁰R⁸¹R⁸², oder C₁-C₁₈ Alkyl, das durch F substituiert und/oder durch O unterbrochen ist, substituiert ist;
vorzugsweise ist G eine C₁-C₈ Alkyl-Gruppe, oder eine Gruppe der Struktur 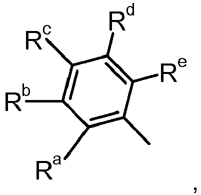
R^{a} ist H, eine C₁-C₅ Alkyl-Gruppe, eine Fluor-C₁-C₄-Alkyl-Gruppe, oder eine C₃-C₆ Cycloalkyl-Gruppe,
R^{e} ist H, eine C₁-C₅ Alkyl-Gruppe, eine Fluor-C₁-C₄-Alkyl-Gruppe, oder eine C₃-C₆ Cycloalkyl-Gruppe,
R^{c}, R^{b} und R^{d} sind unabhängig voneinander Wasserstoff; eine C₁-C₁₈ Alkyl-Gruppe, die gegebenenfalls mit E substituiert und/oder durch D unterbrochen sein kann; eine C₃-C₁₂ Cycloalkyl-Gruppe, die gegebenenfalls mit G substituiert sein kann; ein C₃-C₁₀ Heterocycloalkyl Radikal, unterbrochen durch mindestens eines von O, S, N und NR⁶⁵ und/oder mit E substituiert; eine C₆-C₂₄ Aryl-Gruppe, die gegebenenfalls mit G substituiert sein kann; oder eine C₂-C₃₀ Heteroaryl-Gruppe, die gegebenenfalls mit G substituiert sein kann; ein Halogen-Atom, insbesondere F oder Cl; ein C₁-C₈ Halogenalkyl wie CF₃; CN; oder SiR⁸⁰R⁸¹R⁸²;
oder
R^{c} und R^{b}, oder R^{a} und R^{b} bilden eine Verbindung der Struktur 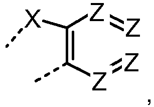 wobei Z
für N oder CR'" steht, wobei 0 oder 1 Z für N steht, vorzugsweise 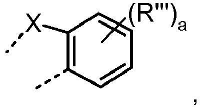 wobei X für O, S, NR⁷⁵ oder CR⁷³R⁷⁴steht, vorzugsweise O; R'" ist C₁-C₈ Alkyl und a ist 0, 1 oder 2, vorzugsweise 0 oder 1, besonders bevorzugt 0;
R⁶³ und R⁶⁴ sind unabhängig voneinander Wasserstoff, unsubstituiertes C₆-C₁₈ Aryl; C₆-C₁₈ Aryl, das mit C₁-C₁₈ Alkyl substituiert ist, oder C₁-C₁₈ Alkoxy; unsubstituiertes C₁-C₁₈ Alkyl; oder C₁-C₁₈ Alkyl das durch -O- unterbrochen ist; vorzugsweise unsubstituiertes C₆-C₁₈ Aryl; C₆-C₁₈ Aryl, das mit C₁-C₁₈ Alkyl substituiert ist, oder C₁-C₁₈ Alkoxy; unsubstituiertes C₁-C₁₈ Alkyl; oder C₁-C₁₈ Alkyl das durch -O- unterbrochen ist;
R⁶⁵ und R⁶⁶ sind unabhängig voneinander Wasserstoff, eine unsubstituierte C₆-C₁₈ Aryl-Gruppe; eine C₆-C₁₈ Aryl-Gruppe, die mit C₁-C₁₈ Alkyl substituiert ist, oder C₁-C₁₈ Alkoxy; eine unsubstituierte C₁-C₁₈ Alkyl-Gruppe; oder eine C₁-C₁₈ Alkyl-Gruppe die durch -O- unterbrochen ist;
R⁶⁵ und R⁶⁶ bilden zusammen einen 5-oder 6-gliedrigen Ring,
R⁶⁷ ist H, eine unsubstituierte C₆-C₁₈ Aryl-Gruppe; eine C₆-C₁₈ Aryl-Gruppe, die durch C₁-C₁₈ Alkyl substituiert ist, oder durch C₁-C₁₈ Alkoxy; eine unsubstituierte C₁-C₁₈ Alkyl-Gruppe; oder eine C₁-C₁₈ Alkyl-Gruppe die durch -O-unterbrochen ist; vorzugsweise eine unsubstituierte C₆-C₁₈ Aryl-Gruppe; eine C₆-C₁₈ Aryl-Gruppe, die durch C₁-C₁₈ Alkyl substituiert ist, oder C₁-C₁₈ Alkoxy; eine unsubstituierte C₁-C₁₈ Alkyl-Gruppe; oder eine C₁-C₁₈ Alkyl-Gruppe die durch -O- unterbrochen ist;
R⁶⁸ ist H, eine unsubstituierte C₆-C₁₈ Aryl-Gruppe; eine C₆-C₁₈ Aryl-Gruppe, die mit C₁-C₁₈ Alkyl substituiert ist, oder C₁-C₁₈ Alkoxy; eine unsubstituierte C₁-C₁₈ Alkyl-Gruppe;
oder eine C₁-C₁₈ Alkyl-Gruppe die durch -O- unterbrochen ist;
R⁶⁹ ist H, eine unsubstituierte C₆-C₁₈ Aryl-Gruppe; eine C₆-C₁₈ Aryl-Gruppe, die mit C₁-C₁₈ Alkyl substituiert ist, oder C₁-C₁₈ Alkoxy; eine unsubstituierte C₁-C₁₈ Alkyl-Gruppe; oder eine C₁-C₁₈ Alkyl-Gruppe die durch -O-unterbrochen ist; vorzugsweise eine unsubstituierte C₆-C₁₈ Aryl-Gruppe; eine C₆-C₁₈ Aryl-Gruppe, die mit C₁-C₁₈ Alkyl substituiert ist, oder C₁-C₁₈ Alkoxy; eine unsubstituierte C₁-C₁₈ Alkyl-Gruppe; oder eine C₁-C₁₈ Alkyl-Gruppe die durch -O- unterbrochen ist;
R⁷⁰ und R⁷¹ sind unabhängig voneinander eine unsubstituierte C₁-C₁₈ Alkyl-Gruppe; eine unsubstituierte C₆-C₁₈ Aryl-Gruppe; oder eine C₆-C₁₈ Aryl-Gruppe die mit C₁-C₁₈ Alkyl substituiert ist;
R⁷² ist eine unsubstituierte C₁-C₁₈ Alkyl-Gruppe; eine unsubstituierte C₆-C₁₈ Aryl-Gruppe, oder eine C₆-C₁₈ Aryl-Gruppe, die mit C₁-C₁₈ Alkyl substituiert ist;
R⁷³ und R⁷⁴ sind unabhängig voneinander Wasserstoff, C₁-C₂₅ Alkyl, C₁-C₂₅ Alkyl, das durch -O- unterbrochen ist, C₇-C₂₅ Arylalkyl, C₆-C₂₄ Aryl, C₆-C₂₄ Aryl, das mit C₁-C₁₈ Alkyl substituiert ist, C₂-C₂₀ Heteroaryl, oder C₂-C₂₀ Heteroaryl, das mit C₁-C₁₈ Alkyl substituiert ist;
R⁷⁵ ist eine C₆-C₁₈ Aryl-Gruppe; C₆-C₁₈ Aryl das mit C₁-C₁₈ Alkyl substituiert ist, oder C₁-C₁₈ Alkoxy; eine C₁-C₁₈ Alkyl-Gruppe; oder eine C₁-C₁₈ Alkyl-Gruppe, die durch -O-unterbrochen ist;
R⁸⁰, R⁸¹ und R⁸² sind unabhängig voneinander eine unsubstituierte C₁-C₂₅ Alkyl-Gruppe, die gegebenenfalls durch -O- unterbrochen sein kann; eine C₆-C₁₄ Aryl-Gruppe, die gegebenenfalls mit C₁-C₁₈ Alkyl substituiert sein kann; oder eine Heteroaryl-Gruppe, umfassend 3 bis 11 Ringatome, die gegebenenfalls mit C₁-C₁₈ Alkyl substituiert sein kann;
ist eine Bindestelle zum Metall.

2. Der Metall-Carben-Komplex gemäß Anspruch 1, wobei
R¹, R², R³ und R⁴
unabhängig voneinander Wasserstoff sind; eine C₁-C₁₂ Alkyl-Gruppe, die gegebenenfalls mit mindestens einem Substituenten E substituiert und/oder durch D unterbrochen sein kann; eine C₃-C₁₂ Cycloalkyl-Gruppe, die gegebenenfalls mit mindestens einem Substituenten E substituiert sein kann; eine C₆-C₁₄ Aryl-Gruppe, die gegebenenfalls mit einer oder zwei Gruppen G substituiert sein kann; eine Heteroaryl-Gruppe, umfassend 3 bis 11 Ringatome, die gegebenenfalls mit einer oder zwei Gruppen G substituiert sein kann; oder eine -N(phenyl)₂-Gruppe, die gegebenenfalls mit einer oder zwei Gruppen G substituiert sein kann.
R⁵ und R⁶
sind unabhängig voneinander Wasserstoff; eine C₁-C₁₂ Alkyl-Gruppe, die gegebenenfalls mit E substituiert und/oder durch D unterbrochen sein kann; eine C₃-C₁₂ Cycloalkyl-Gruppe, die gegebenenfalls mit E substituiert sein kann;
oder
R⁵ oder R⁶, vorzugsweise R⁵, ist eine Gruppe der Struktur 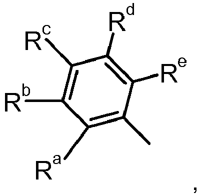 in einer
weiteren, bevorzugten Ausführungsform ist R⁶ eine Gruppe der Struktur 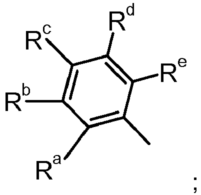
R^{a} ist H, eine C₁-C₅ Alkyl-Gruppe, eine Fluor-C₁-C₄ Alkyl-Gruppe, oder eine C₃-C₆ Cycloalkyl-Gruppe; vorzugsweise H, eine C₁-C₅ Alkyl-Gruppe, C₃-C₆ Cyclo Alkyl-Gruppe; besonders bevorzugt H, oder eine C₁-C₅ Alkyl-Gruppe;
R^{e} ist H, eine C₁-C₅ Alkyl-Gruppe, eine Fluor-C₁-C₄ Alkyl-Gruppe, oder eine C₃-C₆ Cycloalkyl-Gruppe; vorzugsweise H, eine C₁-C₅ Alkyl-Gruppe, C₃-C₆ Cyclo Alkyl-Gruppe; besonders bevorzugt H, oder eine C₁-C₅ Alkyl-Gruppe;
R^{c}, R^{b} und R^{d} sind unabhängig voneinander Wasserstoff; eine C₁-C₁₈ Alkyl-Gruppe, die gegebenenfalls mit E substituiert und/oder durch D unterbrochen sein kann; eine C₃-C₁₂ Cycloalkyl-Gruppe, die gegebenenfalls durch G substituiert sein kann; eine C₆-C₁₄ Aryl-Gruppe, die gegebenenfalls durch G substituiert sein kann; oder eine C₂-C₃₀ Hetero-Aryl-Gruppe, die gegebenenfalls durch G substituiert sein kann; ein C₁-C₈ Halogen-Alkyl wie CF₃; oder SiR⁸⁰R⁸¹ R⁸²; vorzugsweise sind R^{c}, R^{b} und R^{d} unabhängig voneinander Wasserstoff, eine C₁-C₅ Alkyl-Gruppe, eine C₃-C₆ Cycloalkyl-Gruppe; besonders bevorzugt H, oder eine C₁-C₅ Alkyl-Gruppe; am meisten bevorzugt sind R^{b}, R^{c} und R^{d} Wasserstoff oder eine Phenyl-Gruppe, die gegebenenfalls mit einer oder zwei Gruppen G substituiert sein kann;
oder
R^{c} und R^{b}, oder R^{a} und R^{b} bilden eine Gruppe der Struktur 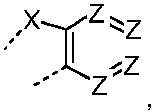 wobei Z für N
oder CR'" steht, wobei 0 oder 1 Z für N stehen, vorzugsweise 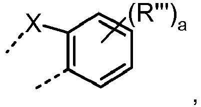 wobei X für O, S, NR⁷⁵ oder CR⁷³R⁷⁴ steht, vorzugsweise O; R'" ist C₁-C₈ Alkyl und a ist 0, 1 oder 2, vorzugsweise 0 oder 1, besonders bevorzugt 0.
R⁷, R⁸ und R⁹
sind unabhängig voneinander Wasserstoff; eine C₁-C₁₂ Alkyl-Gruppe, die gegebenenfalls mit E substituiert und/oder durch D unterbrochen sein kann; eine C₃-C₁₂ Cycloalkyl-Gruppe, die gegebenenfalls mit E substituiert sein kann; eine C₆-C₁₄ Aryl-Gruppe, die gegebenenfalls mit einer oder zwei Gruppen G substituiert sein kann; eine Heteroaryl-Gruppe umfassend 3 bis 11 Ringatome, die gegebenenfalls mit einer oder zwei Gruppen G substituiert sein kann;
R²⁷, R²⁸
sind unabhängig voneinander Wasserstoff; eine C₁-C₁₂ Alkyl-Gruppe, die gegebenenfalls mit E substituiert und/oder durch D unterbrochen sein kann; vorzugsweise eine CH₂-C₁-C₇ Alkyl-Gruppe, die mit E substituiert und/oder durch D unterbrochen sein kann;
vorzugsweise ist entweder R²⁷ oder R²⁸ Wasserstoff;
D ist -S-, oder -O-
E ist -OR⁶⁹, CF₃, C₁-C₈ Alkyl oder F;
G ist -OR⁶⁹, CF₃ oder C₁-C₈ Alkyl;
R⁶⁵ ist eine Phenyl-Gruppe, die gegebenenfalls mit einer oder zwei C₁-C₈ Alkyl-Gruppen substituiert sein kann; eine unsubstituierte C₁-C₁₈ Alkyl-Gruppe; oder eine C₁-C₁₈ Alkyl-Gruppe, die unterbrochen ist durch -O-; und
R⁶⁹ ist eine Phenyl-Gruppe, die gegebenenfalls mit einer oder zwei C₁-C₈ Alkyl-Gruppen substituiert sein kann; eine unsubstituierte C₁-C₁₈ Alkyl-Gruppe; oder eine C₁-C₁₈ Alkyl-Gruppe, die unterbrochen ist durch -O-.

3. Der Metall-Carben-Komplex gemäß Anspruch 1 oder 2, wobei mindestens eines der Radikale R¹, R², R³, R⁴, R⁵, R⁶, R⁷, R⁸, und R⁹ kein Wasserstoff ist; vorzugsweise sind R⁵ oder mindestens zwei der Radikale R¹, R², R³, R⁴, R⁵, R⁶, R⁷, R⁸ und R⁹ kein Wasserstoff.

4. Der Metall-Carben-Komplex gemäß einem der Ansprüche 1 bis 3, wobei
R¹, R², R³ und R⁴
unabhängig voneinander Wasserstoff sind; eine C₁-C₈ Alkyl-Gruppe, die gegebenenfalls mit mindestens einem Substituenten E substituiert sein kann; eine C₃-C₆ Cycloalkyl-Gruppe, die gegebenenfalls mit mindestens einem Substituenten E substituiert sein kann; oder eine Phenyl-Gruppe, die gegebenenfalls mit einer oder zwei Gruppen G substituiert sein kann;
R⁵ und R⁶
sind unabhängig voneinander Wasserstoff; eine C₁-C₈ Alkyl-Gruppe, die gegebenenfalls mit mindestens einem Substituenten E substituiert sein kann; oder eine C₃-C₆ Cycloalkyl-Gruppe, die gegebenenfalls mit mindestens einem Substituenten E substituiert sein kann; oder eine Phenyl-Gruppe, die gegebenenfalls mit einer oder zwei Gruppen G substituiert sein kann;
R⁷, R⁸ und R⁹
sind unabhängig voneinander Wasserstoff; eine C₁-C₈ Alkyl-Gruppe, die gegebenenfalls mit mindestens einem Substituenten E substituiert sein kann; oder eine C₃-C₆ Cycloalkyl-Gruppen, die gegebenenfalls mit mindestens einem Substituenten E substituiert sein kann; oder eine Phenyl-Gruppe, die gegebenenfalls mit einer oder zwei Gruppen G substituiert sein kann;
R²⁷ und R²⁸
sind Wasserstoff;
E ist CF₃, C₁-C₈ Alkyl oder F;
G ist CF₃ oder C₁-C₈ Alkyl; vorzugsweise C₁-C₈ Alkyl;
R⁶⁵ ist eine Phenyl-Gruppe, die gegebenenfalls mit einer oder zwei C₁-C₈ Alkyl-Gruppen substituiert sein kann; eine unsubstituierte C₁-C₈ Alkyl-Gruppe; oder eine C₁-C₈ Alkyl-Gruppe, die unterbrochen ist durch -O-; und
R⁶⁹ ist eine Phenyl-Gruppe, die gegebenenfalls mit einer oder zwei C₁-C₈ Alkyl-Gruppen substituiert sein kann; eine unsubstituierte C₁-C₈ Alkyl-Gruppe; oder eine C₁-C₈ Alkyl-Gruppe, die unterbrochen ist durch -O-.

5. Der Metall-Carben-Komplex gemäß einem der Ansprüche 1 bis 4, wobei R¹, R², R³ und R⁴
sind unabhängig voneinander Wasserstoff; eine C₁-C₈ Alkyl-Gruppe; oder eine C₃-C₆ Cycloalkyl-Gruppe;
R⁵, R⁶, R⁷, R⁸ und R⁹
sind unabhängig voneinander Wasserstoff; eine C₁-C₈ Alkyl-Gruppe; oder eine C₃-C₆ Cycloalkyl-Gruppe; oder R⁵ oder R⁶ ist eine Phenyl-Gruppe, die gegebenenfalls mit einer oder zwei Gruppen G substituiert sein kann; und
R²⁷ und R²⁸ sind Wasserstoff.

6. Der Metall-Carben-Komplex gemäß den Ansprüchen 1 bis 5, wobei entweder R² und R³ oder R¹ und R⁴ Wasserstoff sind.

7. Der Metall-Carben-Komplex gemäß einem der Ansprüche 1 bis 6, wobei R⁵ und R⁶
unabhängig voneinander Wasserstoff sind; eine C₁-C₈ Alkyl-Gruppe; oder einer von R⁵ oder R⁶, vorzugsweise R⁵, eine Phenyl-Gruppe ist, die gegebenenfalls mit einer oder
zwei Gruppen, ausgewählt aus CF₃ oder C₁-C₈ Alkyl, substituiert sein kann,
vorzugsweise gegebenenfalls mit einer C₁-C₈ Alkyl-Gruppe substituiert ist; in einer weiteren bevorzugten Ausführungsform ist R⁶ eine Phenyl-Gruppe, die gegebenenfalls mit einer oder zwei Gruppen, ausgewählt aus CF₃ oder C₁-C₈ Alkyl, substituiert sein kann, vorzugsweise gegebenenfalls substituiert mit einer C₁-C₈ Alkyl-Gruppe;
vorzugsweise ist mindestens einer von R⁵ oder R⁶ Wasserstoff;
R⁷ und R⁹
sind C₁-C₈ Alkyl;
R8
ist Wasserstoff; eine C₁-C₈ Alkyl-Gruppe; oder eine Phenyl-Gruppe, die gegebenenfalls mit einer Gruppe, ausgewählt aus CF₃ oder C₁-C₈ Alkyl, para-substituiert sein kann, vorzugsweise gegebenenfalls substituiert durch eine C₁-C₈ Alkyl-Gruppe;
R²⁷ und R²⁸ sind Wasserstoff.

8. Der Metall-Carben-Komplex gemäß einem der Ansprüche 1 bis 6, wobei
R⁵
Wasserstoff ist; eine C₁-C₈ Alkyl-Gruppe, die gegebenenfalls mit mindestens einem Substituenten, ausgewählt aus CF₃, C₁-C₈ Alkyl und F substituiert sein kann; eine C₃-C₆ Cycloalkyl-Gruppe, die gegebenenfalls mit mindestens einem Substituenten,
ausgewählt aus CF₃, C₁-C₈ Alkyl-Gruppen und F substituiert sein kann; oder eine Phenyl-Gruppe, die gegebenenfalls mit einer oder zwei Gruppen, ausgewählt aus CF₃ und C₁-C₈ Alkyl-Gruppen, substituiert sein kann, vorzugsweise gegebenenfalls substituiert mit einer oder zwei C₁-C₈ Alkyl-Gruppen;
R⁶ und R⁸
sind identisch und ausgewählt aus der Gruppe bestehend aus einer C₁-C₈ Alkyl-Gruppe, die gegebenenfalls mit mindestens einem Substituenten, ausgewählt aus CF₃,
C₁-C₈ Alkyl und F substituiert sein kann; eine C₃-C₆ Cycloalkyl-Gruppe, die gegebenenfalls mit mindestens einem Substituenten, ausgewählt aus CF₃, C₁-C₈ Alkyl-Gruppen und F substituiert sein kann; und eine Phenyl-Gruppe, die gegebenenfalls mit einer oder zwei Gruppen, ausgewählt aus CF₃ und C₁-C₈ Alkyl substituiert sein kann,
vorzugsweise gegebenenfalls substituiert mit einer oder zwei C₁-C₈ Alkyl-Gruppen;
R⁷ und R⁹
sind Wasserstoff,
wobei R⁵ und R⁶ nicht gleichzeitig eine Phenyl-Gruppe sind, die gegebenenfalls mit einer oder zwei Gruppen, ausgewählt aus CF₃, und C₁-C₈ Alkyl, substituiert sein kann, vorzugsweise gegebenenfalls substituiert mit einer oder zwei C₁-C₈ Alkyl-Gruppen;
R²⁷ und R²⁸
sind Wasserstoff.

9. Der Metall-Carben-Komplex gemäß einem der Ansprüche 1 bis 6, wobei
R⁷, R⁸ und R⁹ für H stehen; und
R⁶ ist H; und
R²⁷ und R²⁸ sind Wasserstoff.

10. Der Metall-Carben-Komplex gemäß einem der Ansprüche 1 bis 9, mit der folgenden Struktur (II) 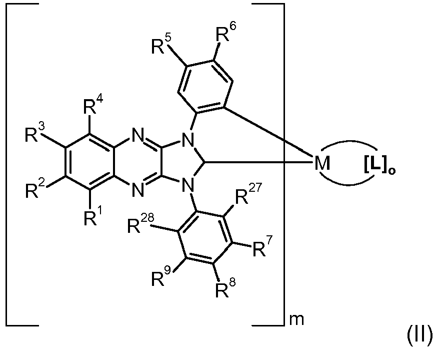 wobei
M ist Pt, oder Ir, vorzugsweise Ir;
wenn M für Ir steht, dann ist m 1, 2, oder 3; o ist 0, 1, oder 2; und die Summe aus m + o ist 3;
im Falle, dass o = 2 ist, können die Liganden L gleich oder verschieden sein,
vorzugsweise gleich; und im Falle, dass m 2 oder 3 ist, können die m Carbenliganden gleich oder verschieden sein, vorzugsweise gleich;
wenn M für Pt steht, dann ist m 1 oder 2; o ist 0 oder 1; und die Summe aus m + o ist 2;
im Falle, dass m gleich 2 ist, können die m Carbenliganden gleich oder verschieden sein, vorzugsweise gleich; und
L ist ein monoanionischer bidentater Ligand.

11. Der Metall-Carben-Komplex gemäß einem der Ansprüche 1 bis 10, wobei L eine Gruppe der folgenden Strukturen ist 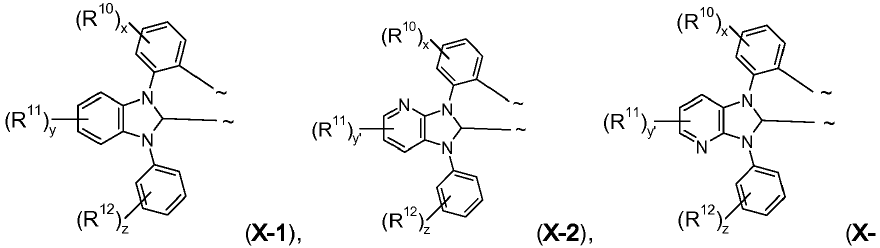 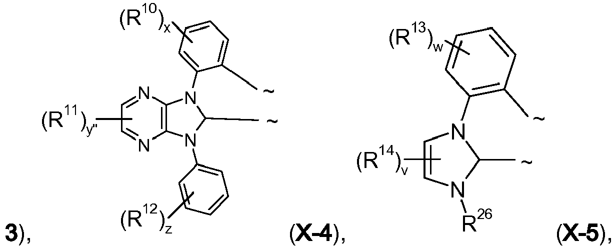 vorzugsweise 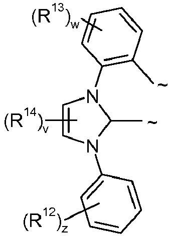 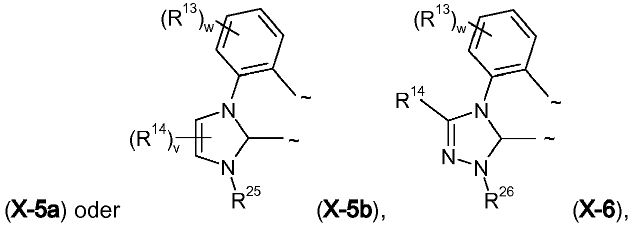 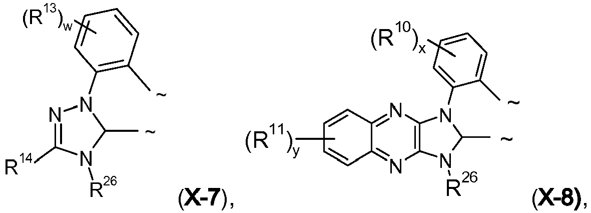 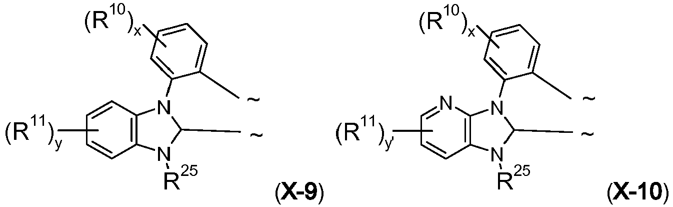 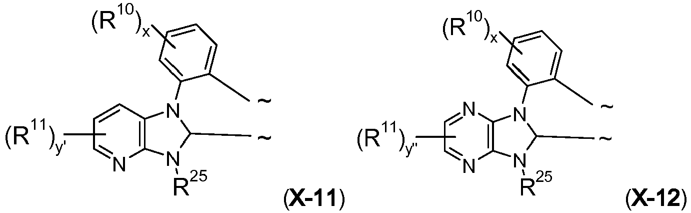 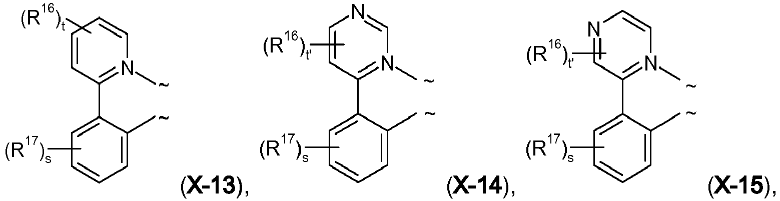 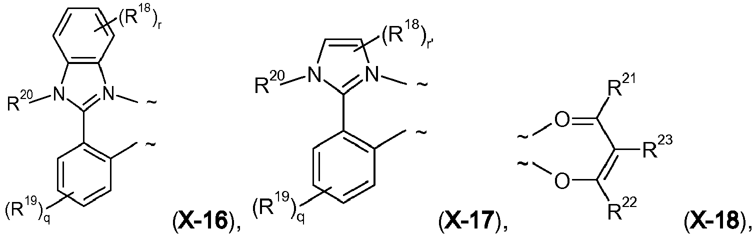 oder 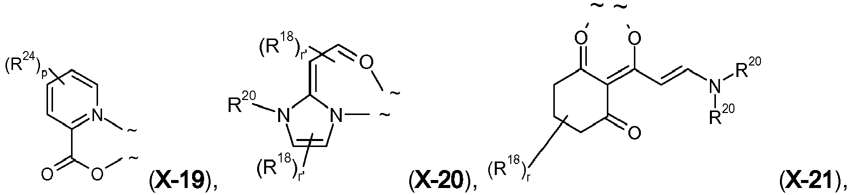 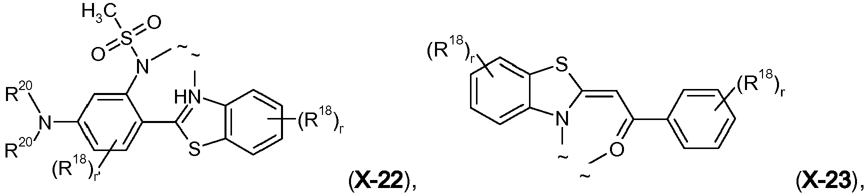 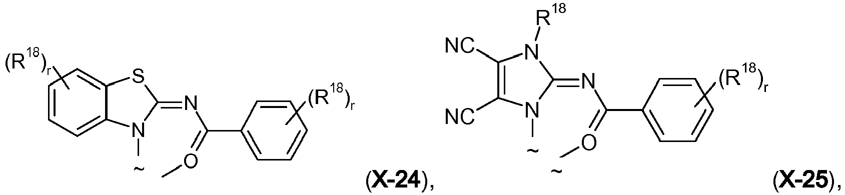 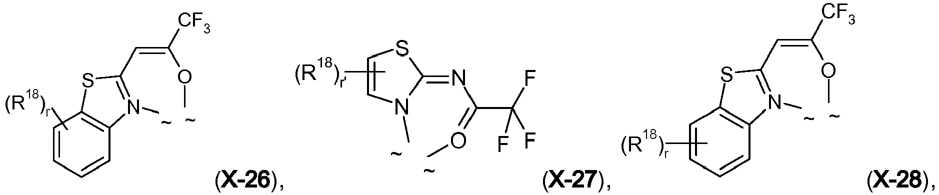 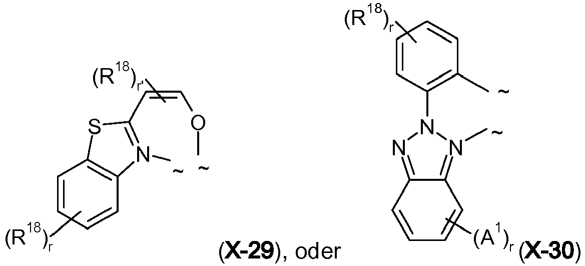 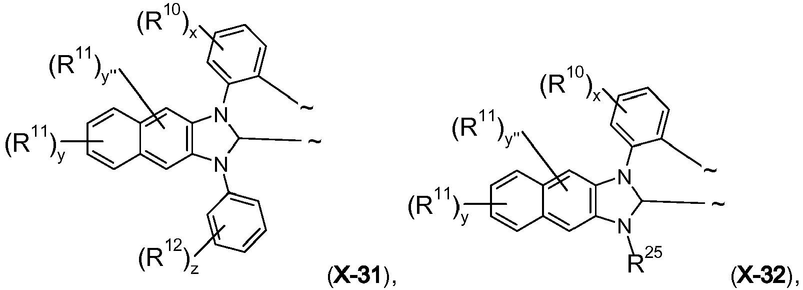 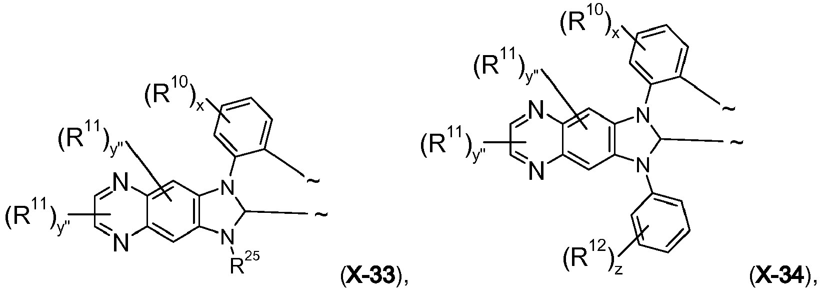 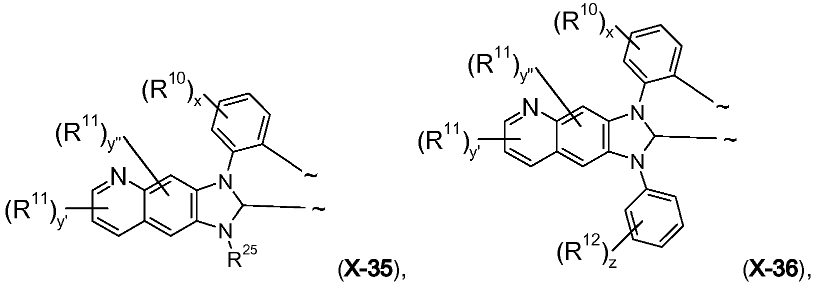 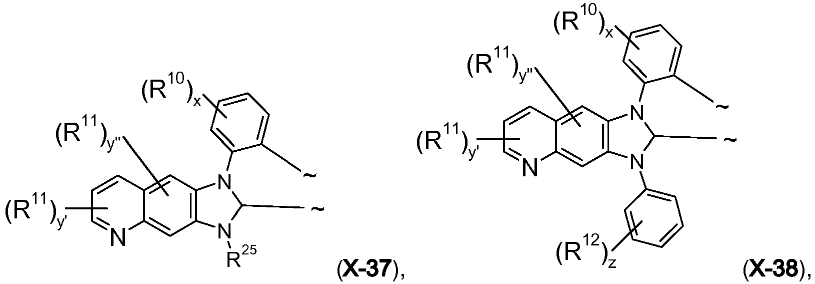 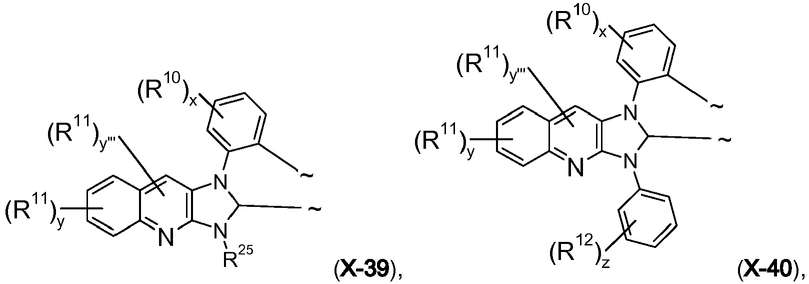 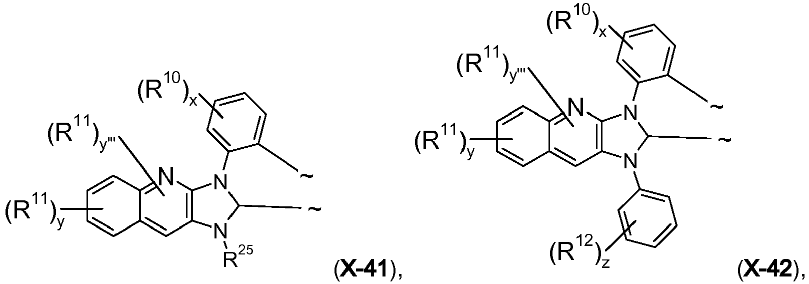 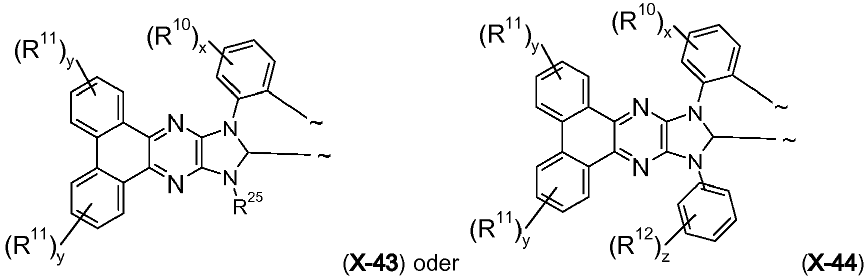 wobei
R¹⁰, R¹², R¹³, R¹⁶, R¹⁷, R¹⁸ und R¹⁹:
die Radikale R¹⁰, R¹², R¹³, R¹⁶, R¹⁷, R¹⁸ und R¹⁹ sind - in jedem Fall- unabhängig voneinander eine C₁-C₁₈ Alkyl-Gruppe, die gegebenenfalls mit E substituiert und/oder durch D unterbrochen sein kann; eine C₃-C₁₂ Cycloalkyl-Gruppe, die gegebenenfalls mit E substituiert sein kann; eine Heterocycloalkyl-Gruppe, umfassend 3 bis 6 Ringatome,
unterbrochen durch mindestens ein Heteroatom ausgewählt aus -O-, -S- und -NR⁶⁵-,
gegebenenfalls enthaltend einen Substituenten E; ein Halogen-Atom, insbesondere F oder Cl; C₁-C₈ Halogenalkyl wie CF₃; CN; oder SiR⁸⁰R⁸¹R⁸²; oder
ein Radikal R¹⁰ und/oder ein Radikal R¹²; ein Radikal R¹³ und/oder ein Radikal R¹²; ein Radikal R¹⁶ und/oder ein Radikal R¹⁷; ein Radikal R¹⁸ und/oder ein Radikal R¹⁹ ist eine
Gruppe der Struktur 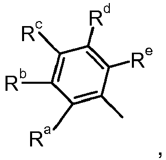
R^{a} ist H, eine C₁-C₅ Alkyl-Gruppe, eine Fluor-C₁-C₄ Alkyl-Gruppe, oder eine C₃-C₆ Cycloalkyl-Gruppe, vorzugsweise ein C₁-C₅ Alkyl, oder H, besonders bevorzugt H,
R^{e} ist H, eine C₁-C₅ Alkyl-Gruppe, eine Fluor-C₁-C₄ Alkyl-Gruppe, oder eine C₃-C₆ Cycloalkyl-Gruppe, vorzugsweise ein C₁-C₅ Alkyl, oder H, besonders bevorzugt H, R^{c}, R^{b} und R^{d} sind unabhängig voneinander Wasserstoff; eine C₁-C₁₈- Alkyl-Gruppe, die gegebenenfalls mit E substituiert und/oder durch D unterbrochen sein kann; eine C₃-C₁₂ Cycloalkyl-Gruppe, die gegebenenfalls mit G substituiert sein kann; ein C₃-C₁₀ Heterocycloalkyl Radikal, unterbrochen durch mindestens eines von O, S, N oder NR⁶⁵ und/oder mit E substituiert; eine C₆-C₂₄ Aryl-Gruppe, die gegebenenfalls mit G substituiert sein kann; oder eine C₂-C₃₀ Heteroaryl-Gruppe, die gegebenenfalls mit G substituiert sein kann; ein Halogen-Atom, insbesondere F und Cl; ein C₁-C₈ Halogenalkyl wie CF₃; CN;
oder SiR⁸⁰R⁸¹R⁸²; vorzugsweise H oder eine C₁-C₈ Alkyl-Gruppe, besonders bevorzugt ist R^{d} H und eine von R^{b} oder R^{c} eine C₁-C₈ Alkyl-Gruppe und die andere von R^{b} oder R^{d} ist H; insbesondere bevorzugt sind R^{c}, R^{b} und R^{d} gleich H;
oder
zwei benachbarte Radikale R¹⁰ und/oder zwei benachbarte Radikale R¹²; zwei benachbarte Radikale R¹³ und/oder zwei benachbarte Radikale R¹²; zwei benachbarte Radikale R¹⁶ und/oder zwei benachbarte Radikale R¹⁷; oder zwei benachbarte Radikale R¹⁹; oder R^{c} und R^{b}, oder R^{a} und R^{b} bilden zusammen eine Gruppe der Struktur 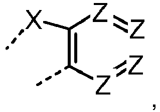 wobei Z für N oder CR'" steht, wobei 0 oder 1 Z für N stehen, vorzugsweise 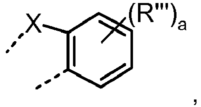 wobei X für O, S, NR⁷⁵ oder CR⁷³R⁷⁴ steht, vorzugsweise O; R'" ist C₁-C₈ Alkyl und a ist 0 oder 1, vorzugsweise 0;
vorzugsweise sind die Radikale R¹⁰, R¹², R¹³, R¹⁶, R¹⁷, R¹⁸ und R¹⁹ - in jedem Fall - unabhängig voneinander eine C₁-C₈ Alkyl-Gruppe, die gegebenenfalls mit mindestens einem Substituenten E substituiert und/oder durch D unterbrochen sein kann, insbesondere durch Methyl, Ethyl, i-Propyl, n-Butyl, sec-Butyl, tert-Butyl oder Isoamyl; eine C₃-C₆ Cycloalkyl-Gruppe, die gegebenenfalls mit mindestens einem Substituenten E substituiert sein kann; F; Cl; ein C₁-C₈ Halogenalkyl wie CF₃; CN;
in einer weiteren bevorzugten Ausführungsform sind R¹⁰, R¹², R¹³, R¹⁶, R¹⁷, R¹⁸ und R¹⁹ - in jedem Fall - unabhängig voneinander Wasserstoff, eine C₁-C₈ Alkyl-Gruppe insbesondere Methyl, Ethyl, i-Propyl, n-Butyl, sec-Butyl, tert-Butyl oder Isoamyl; oder eine Phenyl-Gruppe, die gegebenenfalls mit einer oder zwei Gruppen G substituiert sein kann; oder eine C₂-C₃₀ Heteroaryl-Gruppe, die gegebenenfalls mit G substituiert sein kann; besonders bevorzugt Wasserstoff, eine C₁-C₈ Alkyl-Gruppe, insbesondere Methyl, Ethyl, i-Propyl, n-Butyl, sec-Butyl, tert-Butyl oder Isoamyl; oder eine Phenyl-Gruppe, die gegebenenfalls mit einer oder zwei C₁-C₈ Alkyl-Gruppen substituiert sein kann, zum Beispiel 2-Tolyl, 3-Tolyl, 4-Tolyl, 2-Ethylphenyl, 3-Ethylphenyl, 4-Ethylphenyl, 2-Isopropylphenyl, 3-Isopropylphenyl oder 4-Isopropylphenyl; insbesondere Wasserstoff oder eine C₁-C₈ Alkyl-Gruppe, insbesondere Methyl, Ethyl, i-Propyl, n-Butyl, sec-Butyl, tert-Butyl oder Isoamyl.
oder
zwei benachbarte Radikale R¹⁰ und/oder zwei benachbarte Radikale R¹²; zwei benachbarte Radikale R¹³ und/oder zwei benachbarte Radikale R¹²; zwei benachbarte Radikale R¹⁶ und/oder zwei benachbarte Radikale R¹⁷; oder zwei benachbarte Radikale R¹⁹ bilden eine Gruppe der Struktur 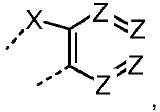 wobei Z für N oder CR'" steht, wobei 0 oder 1 Z für N stehen, vorzugsweise 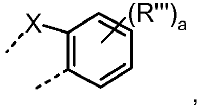 wobei X für O, S, NR⁷⁵ oder CR⁷³R⁷⁴ steht, vorzugsweise O oder S, besonders bevorzugt O; R'" ist C₁-C₈ Alkyl und a' ist 0 oder 1, vorzugsweise 0;
R¹¹, R¹⁴, R²⁰, R²¹, R²², R²³ und R²⁴:
die Radikale R¹¹, R¹⁴, R²⁰, R²¹, R²², R²³ und R²⁴ sind - in jedem Fall- unabhängig voneinander eine C₁-C₁₈ Alkyl-Gruppe, die gegebenenfalls mit mindestens einem Substituenten E substituiert und/oder durch D unterbrochen sein kann; eine C₃-C₁₂ Cycloalkyl-Gruppe, die gegebenenfalls mit mindestens einem Substituenten E substituiert sein kann; eine Heterocycloalkyl-Gruppe, umfassend 3 bis 6 Ringatome, unterbrochen durch mindestens ein Heteroatom ausgewählt aus -O-, -S- und -NR⁶⁵-, gegebenenfalls enthaltend einen Substituenten E; eine C₆-C₁₄ Aryl-Gruppe, die gegebenenfalls mit einer oder zwei Gruppen G substituiert sein kann; eine Heteroaryl-Gruppe, umfassend 3 bis 11 Ringatome, die gegebenenfalls mit einer oder zwei Gruppen G substituiert sein kann; oder eine-NR⁶⁵-Phenyl-Gruppe, die gegebenenfalls mit einer oder zwei Gruppen G substituiert sein kann;
vorzugsweise sind R¹¹, R¹⁴, R²⁰, R²¹, R²², R²³ und R²⁴- in jedem Fall - unabhängig voneinander Wasserstoff; eine C₁-C₈ Alkyl-Gruppe, die gegebenenfalls mit mindestens einem Substituenten E substituiert und/oder durch D unterbrochen sein kann; eine C₃-C₆ Cycloalkyl-Gruppe, die gegebenenfalls mit mindestens einem Substituenten E substituiert sein kann; oder eine Phenyl-Gruppe, die gegebenenfalls mit einer oder zwei Gruppen G substituiert sein kann; ein C₁-C₈ Halogenalkyl wie CF₃; oder SiR⁸⁰R⁸¹R⁸²; oder im Fall von **X-1, X-2, X-3, X-31, X-34, X-35, X-36, X-37** und **X-38** CN;
oder
zwei benachbarte Radikale R¹¹ oder zwei benachbarte Radikale R¹⁴ bilden zusammen
eine Gruppe 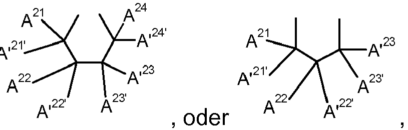 wobei A²¹, A^{21'}, A²², A^{22'}, A²³, A^{23'}, A^{24'} und A²⁴ unabhängig voneinander Wasserstoff sind, eine C₁-C₄ Alkyl-Gruppe, a C₃-C₆ Cycloalkyl-Gruppe, oder eine Fluor-C₁-C₄ Alkyl-Gruppe;
vorzugsweise sind R¹¹, R¹⁴, R²⁰, R²¹, R²², R²³ und R²⁴- in jedem Fall - jeweils unabhängig voneinander eine C₁-C₈ Alkyl-Gruppe, die gegebenenfalls mit mindestens einem Substituenten E substituiert und/oder durch D unterbrochen sein kann; insbesondere Methyl, Ethyl, i-Propyl, n-Butyl, sec-Butyl, tert-Butyl oder Isoamyl; eine C₃-C₆ Cycloalkyl-Gruppe, die gegebenenfalls mit mindestens einem Substituenten E substituiert sein kann; eine C₁-C₈ Halogenalkyl Gruppe wie CF₃; oder im Fall von **X-1, X-2, X-3, X-31, X-34, X-35, X-36, X-37** und **X-38** CN;
in einer weiteren bevorzugten Ausführungsform sind R¹¹, R¹⁴, R²⁰, R²¹, R²², R²³ und R²⁴ - in jedem Fall - unabhängig voneinander Wasserstoff, eine C₁-C₈ Alkyl-Gruppe insbesondere Methyl, Ethyl, i-Propyl, n-Butyl, sec-Butyl, tert-Butyl oder Isoamyl; oder eine Phenyl-Gruppe, die gegebenenfalls mit einer oder zwei Gruppen G substituiert sein kann; oder eine C₂-C₃₀ Heteroaryl-Gruppe, die gegebenenfalls mit G substituiert sein kann; besonders bevorzugt Wasserstoff, eine C₁-C₈ Alkyl-Gruppe, insbesondere Methyl, Ethyl, i-Propyl, n-Butyl, sec-Butyl, tert-Butyl oder Isoamyl; oder eine Phenyl-Gruppe, die gegebenenfalls mit einere oder zwei C₁-C₈ Alkyl-Gruppen substituiert sein kann, zum Beispiel 2-Tolyl, 3-Tolyl, 4-Tolyl, 2-Ethylphenyl, 3-Ethylphenyl, 4-Ethylphenyl, 2-Isopropylphenyl, 3-Isopropylphenyl oder 4-Isopropylphenyl; insbesondere Wasserstoff oder eine C₁-C₈ Alkyl-Gruppe, insbesondere Methyl, Ethyl, i-Propyl, n-Butyl, sec-Butyl, tert-Butyl oder Isoamyl;
oder
zwei benachbarte Radikale R¹¹ oder zwei benachbarte Radikale R¹⁴ bilden zusammen eine Gruppe 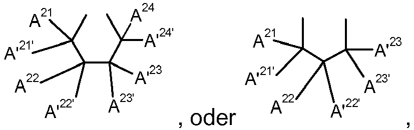 wobei A²¹, A^{21'}, A²², A^{22'}, A²³, A^{23'}, A^{24'} und A²⁴ unabhängig voneinander H sind, eine C₁-C₄ Alkyl-Gruppe, eine C₃-C₆ Cycloalkyl-Gruppe, oder eine Fluor-C₁-C₄ Alkyl-Gruppe;
R²⁵ ist CH₃ oder Ethyl oder iso-Propyl;
R²⁶ ist eine Phenyl-Gruppe, die gegebenenfalls mit einer oder zwei der Gruppen, ausgewählt aus CF₃, und C₁-C₈ Alkyl, substituiert sein kann; vorzugsweise gegebenenfalls substituiert mit einer oder zwei C₁-C₈ Alkyl-Gruppen; oder R²⁶ ist CH₃; oder iso-Propyl; vorzugsweise ist R²⁶ eine Phenyl-Gruppe, die gegebenenfalls durch ein oder zwei Gruppen, ausgewählt aus CF₃ und C₁-C₈ Alkyl substituiert sein kann, vorzugsweise gegebenenfalls substituiert durch eine oder zwei C₁-C₈ Alkyl-Gruppen; in einer weiteren bevorzugten Ausführungsform ist R²⁶ eine Phenyl-Gruppe, die durch ein oder zwei Phenyl-Gruppen substituiert ist;
D ist -S-, -O-, oder -NR⁶⁵-;
E ist -OR⁶⁹, -CN, CF₃, C₁-C₈ Alkyl oder F; vorzugsweise CF₃ oder C₁-C₈ Alkyl; besonders bevorzugt C₁-C₈ Alkyl;
G ist -OR⁶⁹, -CN, CF₃, oder C₁-C₈ Alkyl; vorzugsweise C₁-C₈ Alkyl;
R⁶⁵ ist eine Phenyl-Gruppe, die gegebenenfalls mit einer oder zwei C₁-C₈ Alkyl-Gruppen substituiert sein kann; eine unsubstituierte C₁-C₁₈ Alkyl-Gruppe; oder eine C₁-C₁₈ Alkyl-Gruppe, die durch -O- unterbrochen ist; und
R⁶⁹ ist eine Phenyl-Gruppe, die gegebenenfalls durch ein oder zwei C₁-C₈ Alkyl-Gruppen substituiert sein kann; eine unsubstituierte C₁-C₁₈ Alkyl-Gruppe; oder eine C₁-C₁₈ Alkyl-Gruppe, die durch -O- unterbrochen ist;
A¹ ist C₆-C₁₀ Aryl;
oder
zwei benachbarte Gruppen A¹ bilden zusammen eine Gruppe 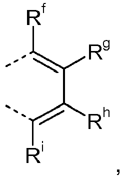 wobei R^{f}, R^{g}, R^{h} und Rⁱ unabhängig voneinander Wasserstoff sind, oder C₁-C₈ Alkyl;
Q¹ und Q² sind unabhängig voneinander Wasserstoff, C₁-C₁₈ Alkyl, oder C₆-C₁₈ Aryl;
w, x sind unabhängig voneinander 0, 1 oder 2, vorzugsweise 0 oder 1; besonders bevorzugt 0;
z ist 0, 1, 2 oder 3, vorzugsweise 0, 1, besonders bevorzugt 0;
y, y', y", u, v
sind unabhängig voneinander 0, 1 oder 2, vorzugsweise 0 oder 2; besonders bevorzugt 0;
y'" ist 0 oder 1, vorzugsweise 0;
p, q, r, s, t, t', t"
sind unabhängig voneinander 0, 1, 2, 3 oder 4, vorzugsweise 0, 1, 2 oder 3;
r' ist 0, 1 oder 2, vorzugsweise 0 oder 1, besonders bevorzugt 0.

12. Der Metall-Carben-Komplex gemäß einem der Ansprüche 1 bis 11, wobei das Metall Ir ist.

13. Der Metall-Carben-Komplex gemäß Anspruch 12, ausgewählt aus 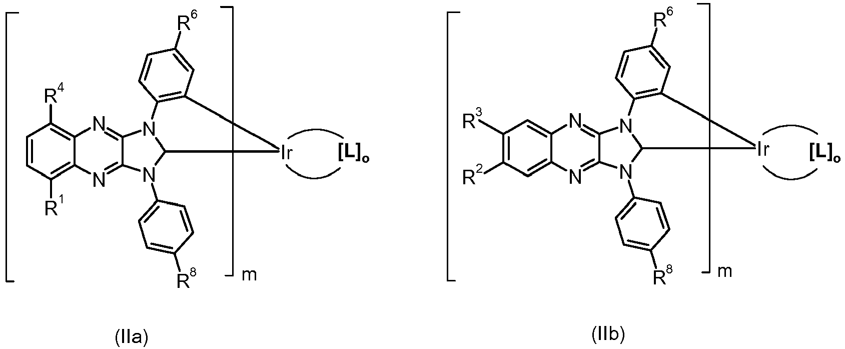 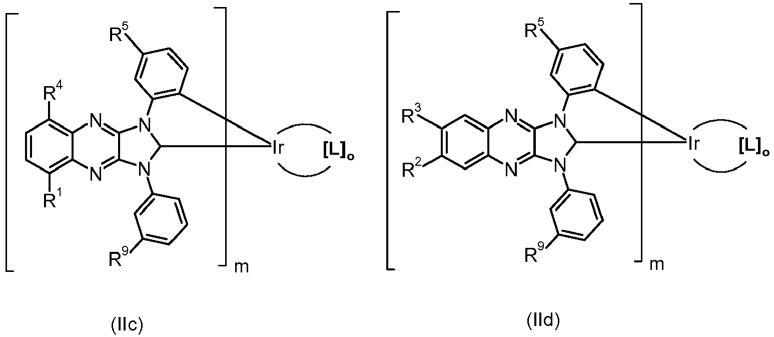 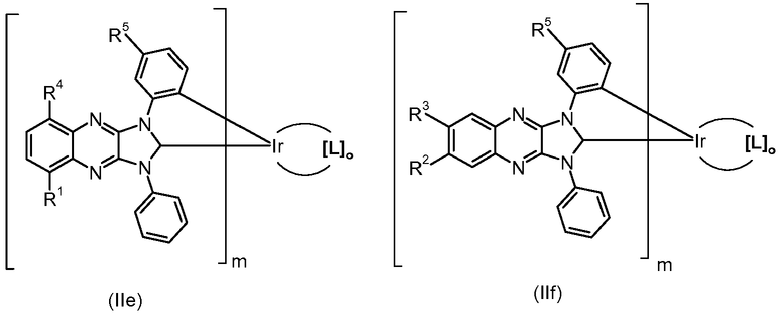 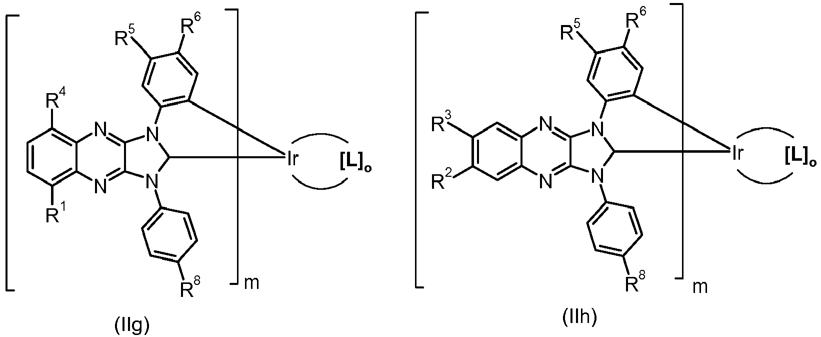 wobei
R¹, R², R³ und R⁴
unabhängig voneinander -in jedem Fall- sind: Wasserstoff; eine C₁-C₈ Alkyl-Gruppe, die gegebenenfalls mit mindestens einem Substituenten E substituiert und/oder durch D unterbrochen sein kann; eine C₃-C₆ Cycloalkyl-Gruppe, die gegebenenfalls mit mindestens einem Substituenten E substituiert sein kann; oder eine Phenyl-Gruppe, die gegebenenfalls mit einem oder zwei Substituenten G substituiert sein kann;
vorzugsweise, im Fall, dass R¹, R², R³ und/oder R⁴ Phenyl-Gruppen sind, die gegebenenfalls mit einem oder zwei Substituenten G substituiert sein können; sind R⁵, R⁶, R⁸ und R⁹ keine Phenyl-Gruppe, die gegebenenfalls mit einem oder zwei Substituenten G substituiert sein kann;
besonders bevorzugt sind R¹, R², R³ und R⁴ -in jedem Fall- unabhängig voneinander Wasserstoff; eine C₁-C₈ Alkyl Gruppe, die gegebenenfalls mit mindestens einem Substituenten E substituiert und/oder durch D unterbrochen sein kann; oder eine C₃-C₆ Cycloalkyl Gruppe, die gegebenenfalls mit mindestens einem Substituenten E substituiert sein kann;
stärker bevorzugt sind R¹ und R⁴ genauso wie R² und R³ identisch; am meisten bevorzugt sind R¹, R², R³ und R⁴ Wasserstoff;
R⁵ und R⁶
sind unabhängig voneinander-in jedem Fall- Wasserstoff; eine C₁-C₈ Alkyl-Gruppe, die gegebenenfalls mit mindestens einem Substituenten E substituiert und/oder durch D unterbrochen sein kann; eine C₃-C₆ Cycloalkyl-Gruppe, die gegebenenfalls mit mindestens einem Substituenten E substituiert sein kann; oder eine Phenyl-Gruppe, die gegebenenfalls mit einem oder zwei Substituenten G substituiert sein kann; vorzugsweise sind R⁵ und R⁶ -in jedem Fall- unabhängig voneinander Wasserstoff;
eine C₁-C₈ Alkyl Gruppe, die gegebenenfalls mit mindestens einem Substituenten E substituiert und/oder durch D unterbrochen sein kann; oder eine C₃-C₆ Cycloalkyl Gruppe, die gegebenenfalls mit mindestens einem Substituenten E substituiert sein kann; oder entweder R⁵ oder R⁶, vorzugsweise R⁵, ist eine Phenyl Gruppe, die gegebenenfalls mit einer oder zwei Substituenten G substituiert sein kann;
besonders bevorzugt sind R⁵ und R⁶ unabhängig voneinander -in jedem Fall-Wasserstoff; eine C₁-C₈ Alkyl Gruppe, die gegebenenfalls mit mindestens einem Substituenten E substituiert und/oder durch D unterbrochen sein kann; oder eine C₃-C₆ Cycloalkyl Gruppe, die gegebenenfalls mit mindestens einem Substituenten E substituiert sein kann; oder entweder R⁵ oder R⁶, vorzugsweise R⁵, ist eine Phenyl Gruppe, die gegebenenfalls mit einem oder zwei Substituenten G substituiert sein kann; in einer weiteren bevorzugten Ausführungsform ist R⁶ eine Phenyl Gruppe, die gegebenenfalls mit einer oder zwei Gruppen G substituiert sein kann; besonders bevorzugt sind R⁵ und R⁶ Wasserstoff;
R⁸ und R⁹
sind -in jedem Fall- unabhängig voneinander Wasserstoff; eine C₁-C₈ Alkyl-Gruppe, die gegebenenfalls mit mindestens einem Substituenten E substituiert und/oder durch D unterbrochen sein kann; eine C₃-C₆ Cycloalkyl-Gruppe, die gegebenenfalls mit mindestens einem Substituenten E substituiert sein kann; oder eine Phenyl-Gruppe, die gegebenenfalls mit einer oder zwei Gruppen G substituiert sein kann;
vorzugsweise sind R⁸ und R⁹ -in jedem Fall- unabhängig voneinander Wasserstoff;
eine C₁-C₈ Alkyl Gruppe, die gegebenenfalls mit mindestens einem Substituenten E substituiert und/oder durch D unterbrochen sein kann; oder eine C₃-C₆ Cycloalkyl Gruppe, die gegebenenfalls mit mindestens einem Substituenten E substituiert sein kann; oder entweder R⁸ oder R⁹ ist eine Phenyl Gruppe, die gegebenenfalls mit einer oder zwei Gruppen G substituiert sein kann;
besonders bevorzugt sind R⁸ und R⁹ -in jedem Fall- unabhängig voneinander Wasserstoff; eine C₁-C₈ Alkyl Gruppe, die gegebenenfalls mit mindestens einem Substituenten E substituiert und/oder durch D unterbrochen sein kann; oder eine C₃-C₆ Cycloalkyl Gruppe, die gegebenenfalls mit mindestens einem Substituenten E substituiert sein kann; am meisten bevorzugt ist R⁹ Wasserstoff und R⁸ ist Wasserstoff oder eine Phenyl-Gruppe, die gegebenenfalls mit einer oder zwei Gruppen G substituiert sein kann; insbesondere sind R⁸ und R⁹ Wasserstoff;
D ist -S-, oder -O-;
E ist -OR⁶⁹, -CN, CF₃, C₁-C₈ Alkyl oder F; vorzugsweise C₁-C₈ Alkyl;
G ist -OR⁶⁹, -CN, CF₃, oder C₁-C₈ Alkyl; vorzugsweise C₁-C₈ Alkyl;
R⁶⁹ ist eine Phenyl-Gruppe, die gegebenenfalls mit einer oder zwei C₁-C₈ Alkyl-Gruppen substituiert sein kann; eine unsubstituierte C₁-C₈ Alkyl-Gruppe; oder eine C₁-C₈ Alkyl-Gruppe, die durch -O- unterbrochen ist;
L ist ein monoanionischer bidentater Ligand;
m ist 1, 2, oder 3; vorzugsweise 2 oder 3; oder -in einer bevorzugten Ausführungsform- 1;
o ist 0, 1, oder 2; vorzugsweise 0 oder 1; oder - in einer bevorzugten Ausführungsform- 2;
und die Summe aus m + o ist 3;
im Falle, dass o = 2 ist, können die Liganden L gleich oder verschieden sein,
vorzugsweise gleich;
und im Falle, dass m = 2 oder 3 ist, können die m Carbenliganden gleich oder
verschieden sein, vorzugsweise gleich.

14. Der Metall-Carben-Komplex gemäß Anspruch 13, ausgewählt aus 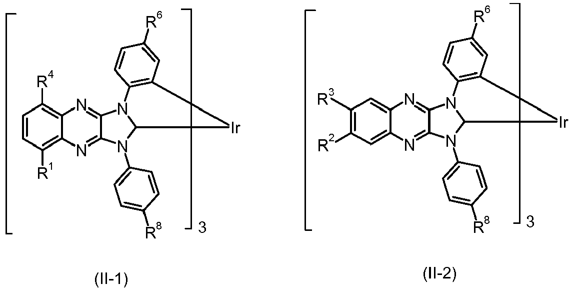 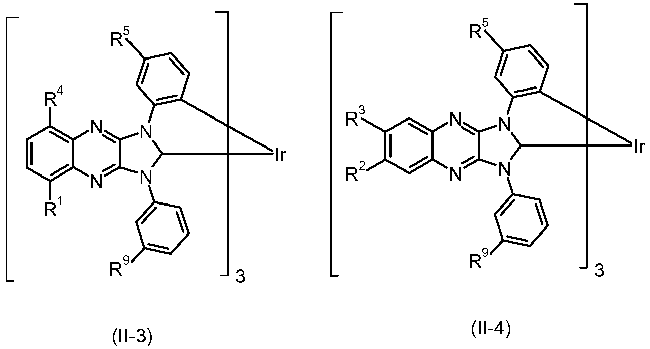 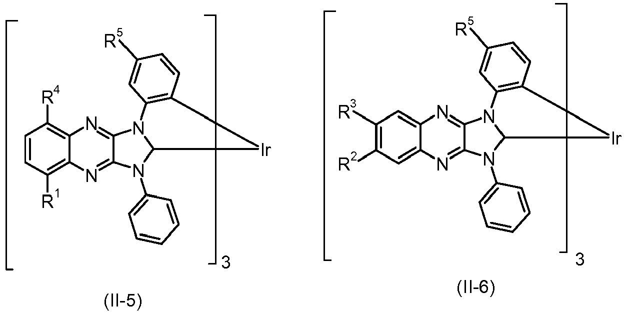 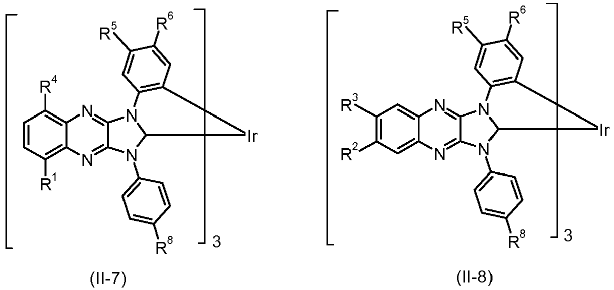 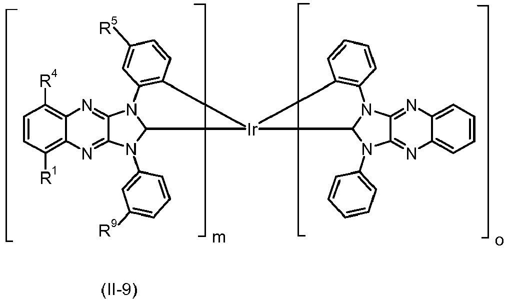 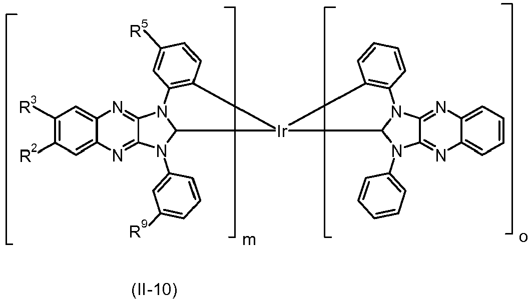 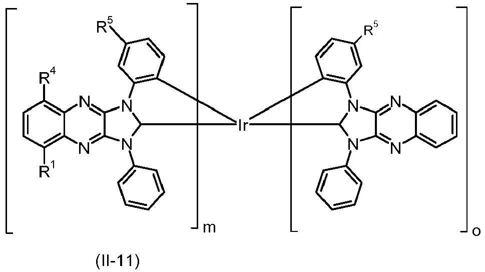 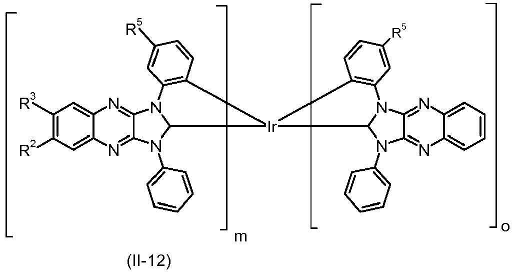 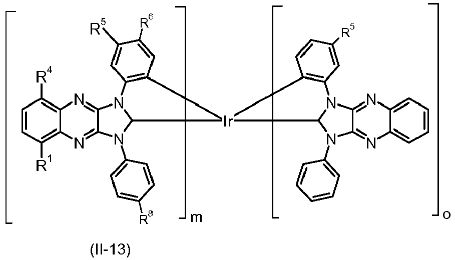 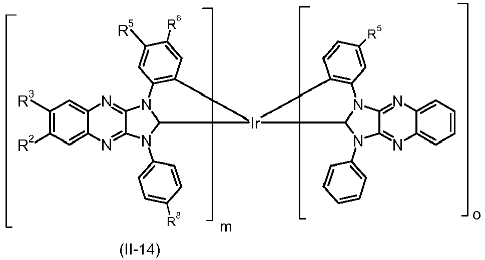 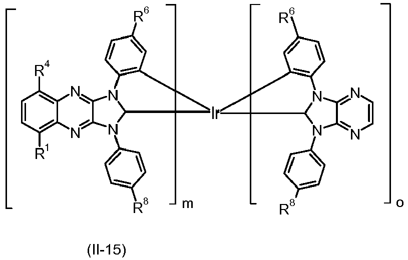 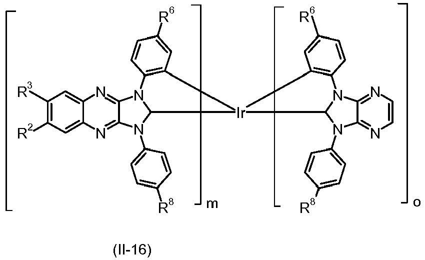 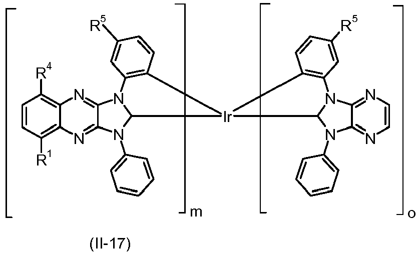 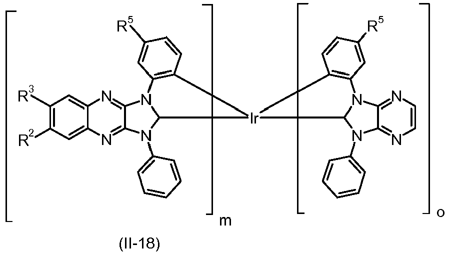 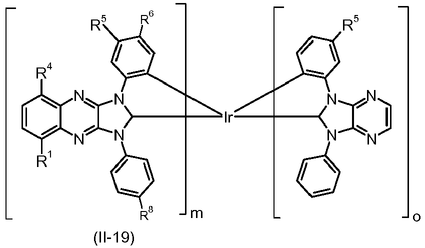 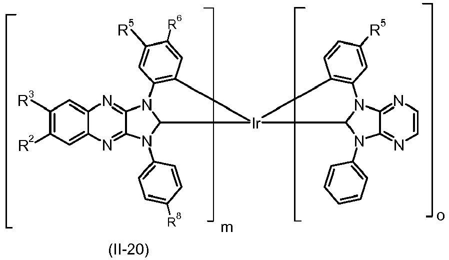 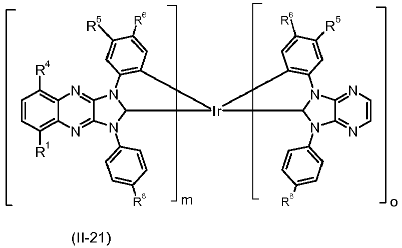 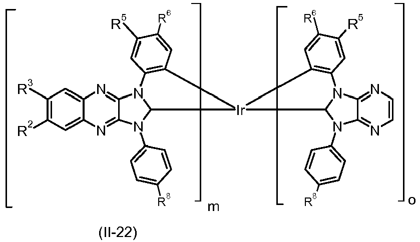 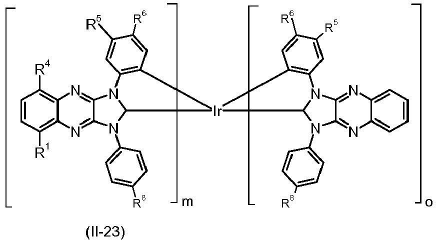 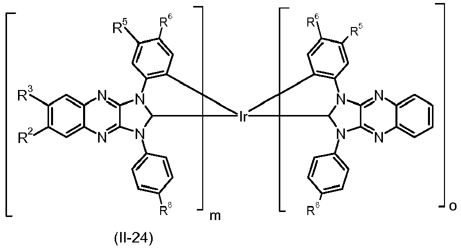 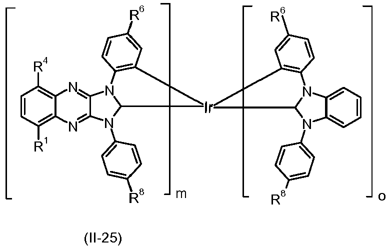 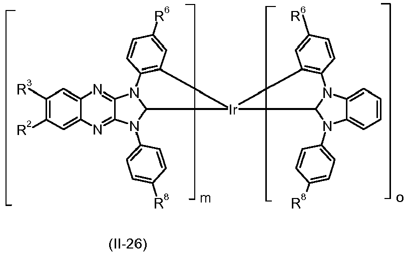 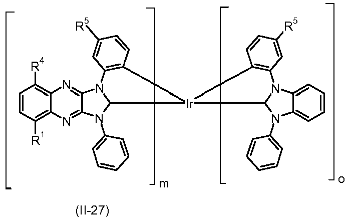 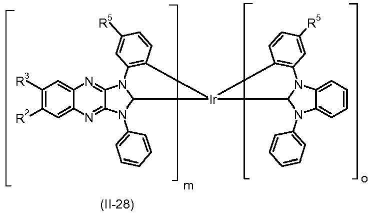 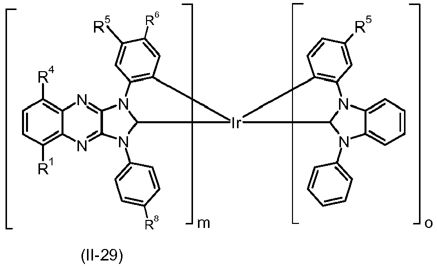 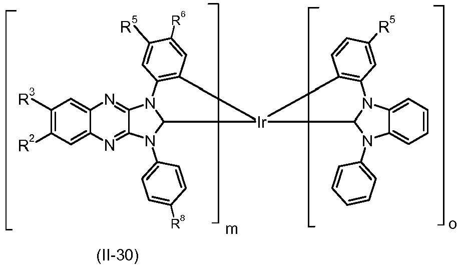 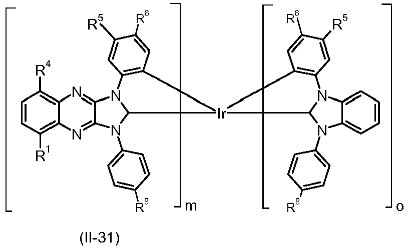 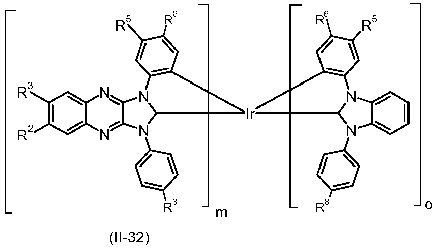 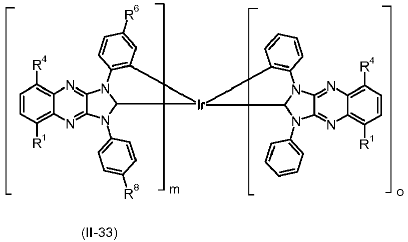 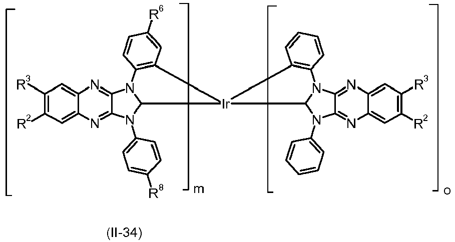 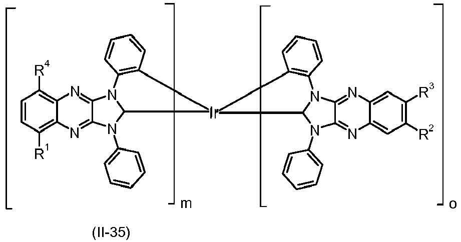 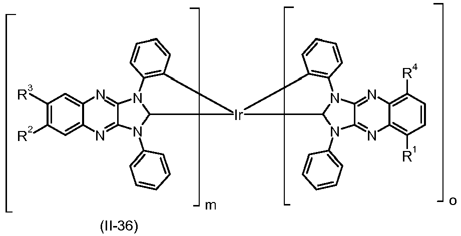 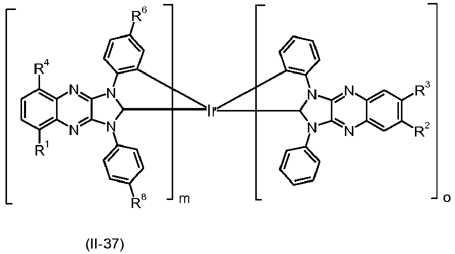 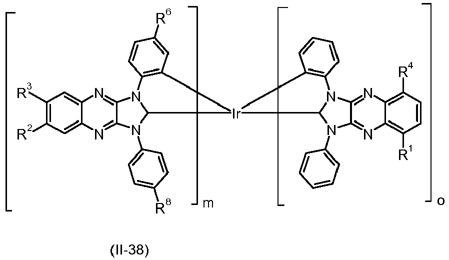 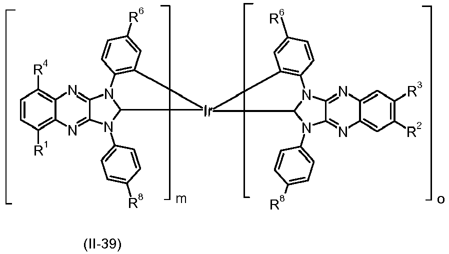 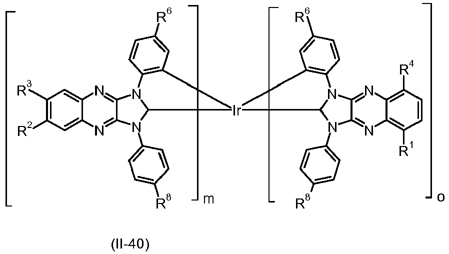 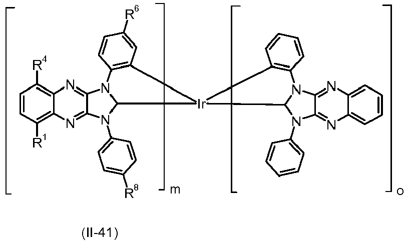 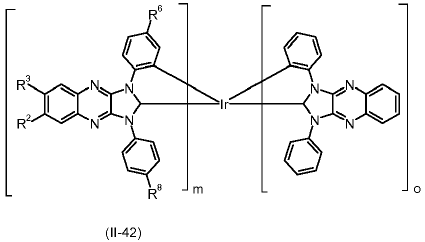 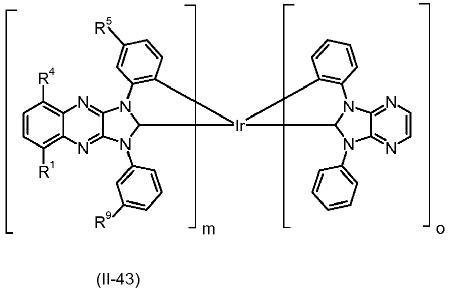 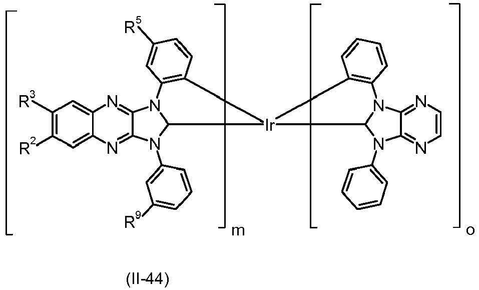 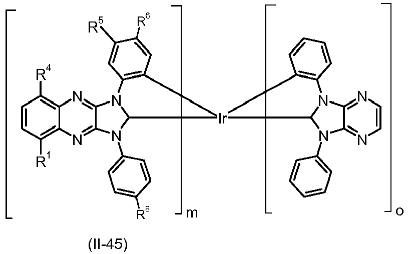 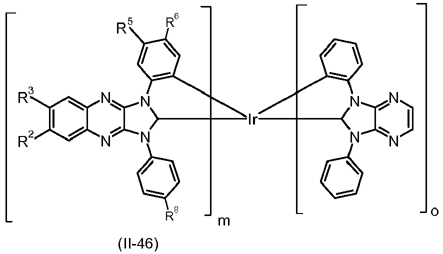 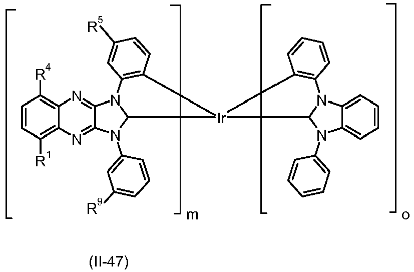 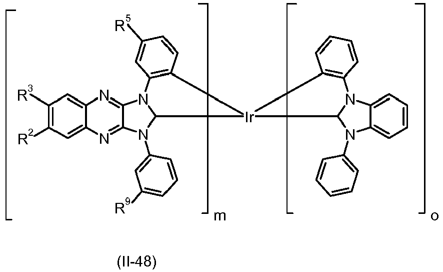 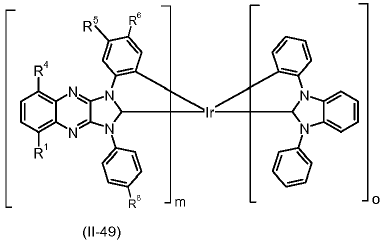 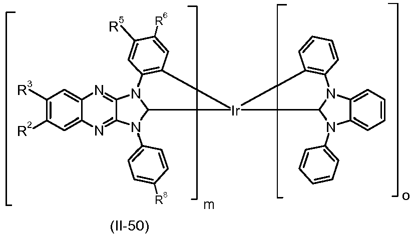 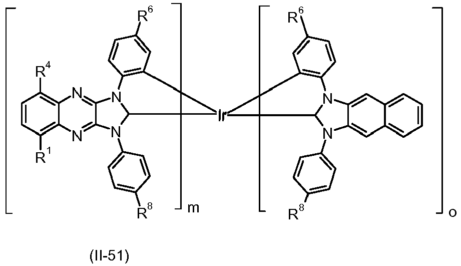 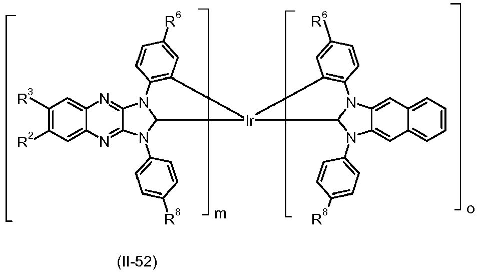 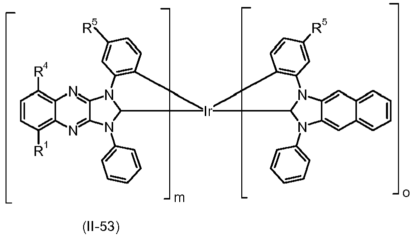 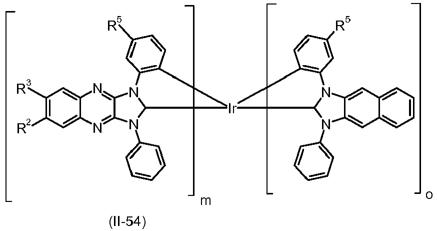 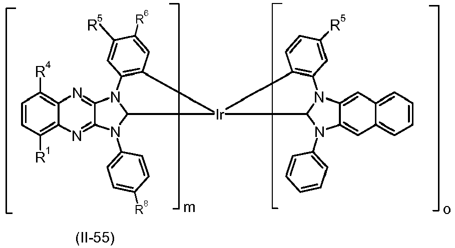 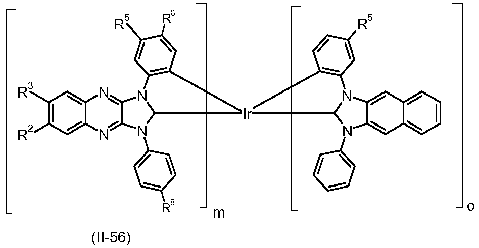 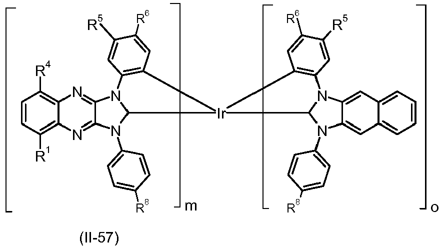 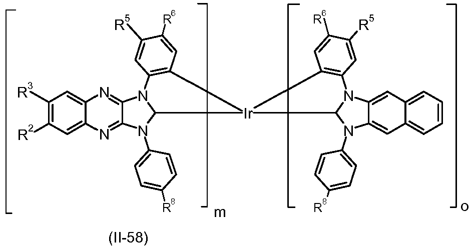 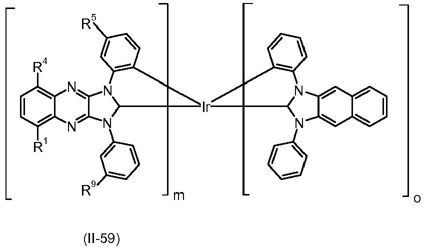 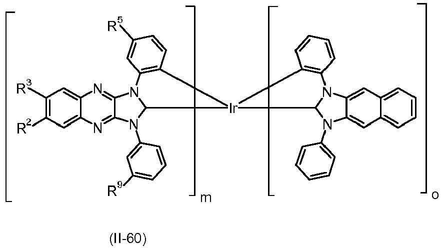 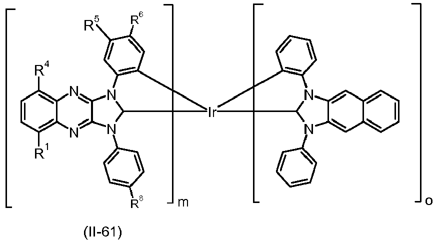 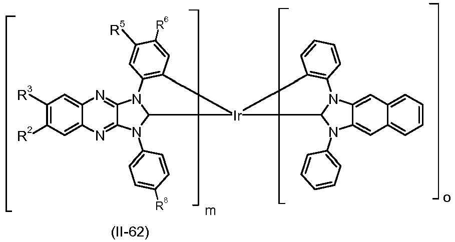 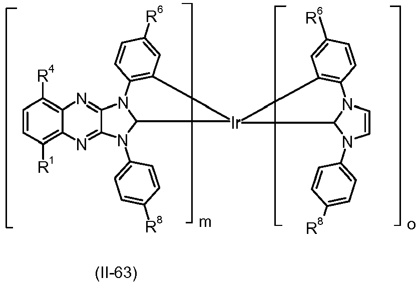 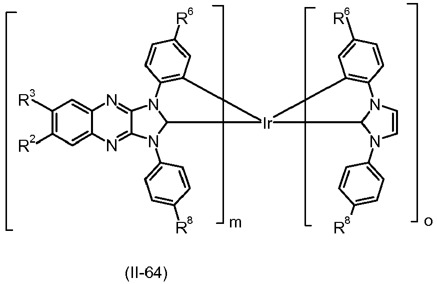 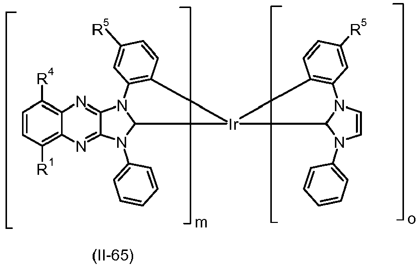 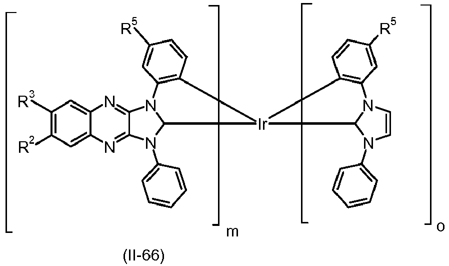 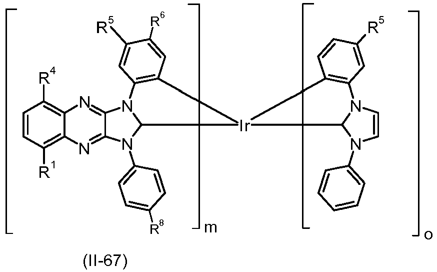 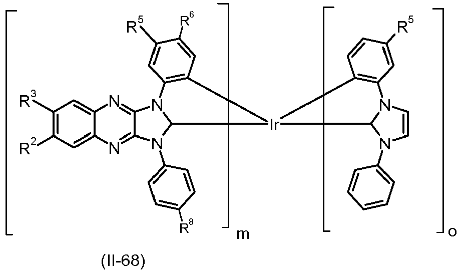 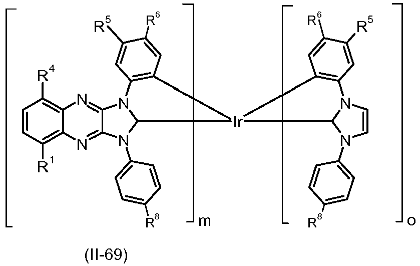 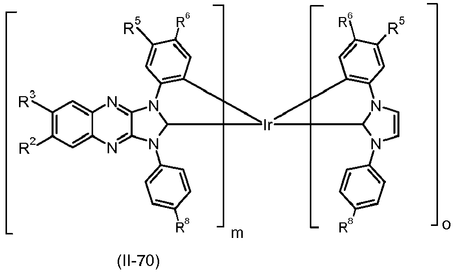 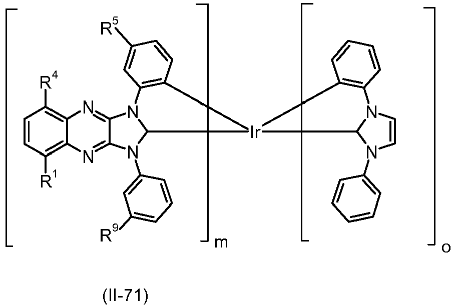 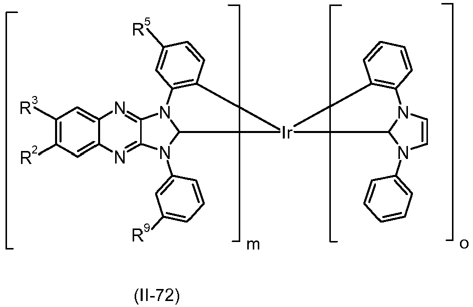 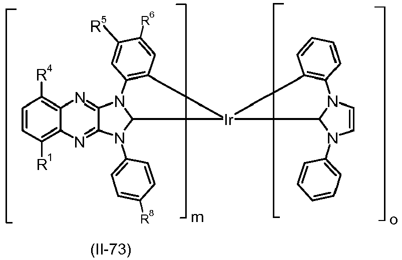 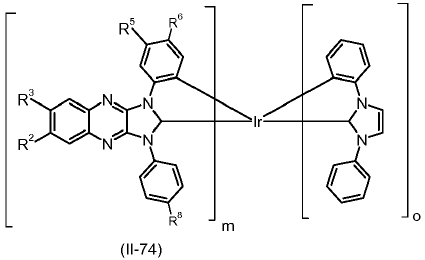 wobei
R¹, R², R³ und R⁴
unabhängig voneinander -in jedem Fall- sind: Wasserstoff; eine C₁-C₈ Alkyl-Gruppe, die gegebenenfalls mit mindestens einem Substituenten E substituiert und/oder durch D unterbrochen sein kann; eine C₃-C₆ Cycloalkyl-Gruppe, die gegebenenfalls mit mindestens einem Substituenten E substituiert sein kann; oder eine Phenyl-Gruppe, die gegebenenfalls mit einem oder zwei Substituenten G substituiert sein kann;
bevorzugt, im Fall, dass R¹, R², R³ und/oder R⁴ Phenyl-Gruppen sind, die gegebenenfalls mit einem oder zwei Substituenten G substituiert sein können; sind R⁵, R⁶, R⁸ und R⁹ keine Phenyl-Gruppe, die gegebenenfalls mit einem oder zwei Substituenten G substituiert sein kann;
besonders bevorzugt sind R¹, R², R³ und R⁴ -in jedem Fall- unabhängig voneinander Wasserstoff; eine C₁-C₈ Alkyl Gruppe, die gegebenenfalls mit mindestens einem Substituenten E substituiert und/oder durch D unterbrochen sein kann; oder eine C₃-C₆ Cycloalkyl Gruppe, die gegebenenfalls mit mindestens einem Substituenten E substituiert sein kann;
weiters bevorzugt sind R¹ und R⁴ genauso wie R² und R³ identisch; am meisten bevorzugt sind R¹, R², R³ und R⁴ Wasserstoff;
R⁵ und R⁶
sind unabhängig voneinander-in jedem Fall- Wasserstoffe; eine C₁-C₈ Alkyl-Gruppe,
die gegebenenfalls mit mindestens einem Substituenten E substituiert und/oder durch D unterbrochen sein kann; eine C₃-C₆ Cycloalkyl-Gruppe, die gegebenenfalls mit mindestens einem Substituenten E substituiert sein kann; oder eine Phenyl-Gruppe,
die gegebenenfalls mit einem oder zwei Substituenten G substituiert sein kann;
vorzugsweise sind R⁵ und R⁶ -in jedem Fall- unabhängig voneinander Wasserstoff;
eine C₁-C₈ Alkyl-Gruppe, die gegebenenfalls mit mindestens einem Substituenten E substituiert und/oder durch D unterbrochen sein kann; oder eine C₃-C₆ Cycloalkyl-Gruppe, die gegebenenfalls mit mindestens einem Substituenten E substituiert sein kann; oder entweder R⁵ oder R⁶, vorzugsweise R⁵, ist eine Phenyl Gruppe, die gegebenenfalls mit einer oder zwei Gruppen G substituiert sein kann;
besonders bevorzugt sind R⁵ und R⁶ -in jedem Fall- unabhängig voneinander Wasserstoff; eine C₁-C₈ Alkyl-Gruppe, die gegebenenfalls mit mindestens einem Substituenten E substituiert und/oder durch D unterbrochen sein kann; oder eine C₃-C₆ Cycloalkyl-Gruppe, die gegebenenfalls mit mindestens einem Substituenten E substituiert sein kann; oder entweder R⁵ oder R⁶, vorzugsweise R⁵, ist eine Phenyl Gruppe, die gegebenenfalls mit einem oder zwei Substituenten G substituiert sein kann, in einer bevorzugten Ausführungsform ist R⁶ eine Phenyl Gruppe, die gegebenenfalls mit einer oder zwei Gruppen G substituiert sein kann; besonders bevorzugt sind R⁵ und R⁶ Wasserstoff;
R⁸ und R⁹
sind unabhängig voneinander-in jedem Fall- Wasserstoff; eine C₁-C₈ Alkyl-Gruppe, die gegebenenfalls mit mindestens einem Substituenten E substituiert und/oder durch D unterbrochen sein kann; eine C₃-C₆ Cycloalkyl-Gruppe, die gegebenenfalls mit mindestens einem Substituenten E substituiert sein kann; oder eine Phenyl-Gruppe, die gegebenenfalls mit einer oder zwei Gruppen G substituiert sein kann; vorzugsweise sind R⁸ und R⁹ -in jedem Fall- unabhängig voneinander Wasserstoff;
eine C₁-C₈ Alkyl Gruppe, die gegebenenfalls mit mindestens einem Substituenten E substituiert und/oder durch D unterbrochen sein kann; oder eine C₃-C₆ Cycloalkyl Gruppe, die gegebenenfalls mit mindestens einem Substituenten E substituiert sein kann; oder entweder R⁸ oder R⁹ ist eine Phenyl Gruppe, die gegebenenfalls mit einer oder zwei Gruppen G substituiert sein kann;
besonders bevorzugt sind R⁸ und R⁹ -in jedem Fall- unabhängig voneinander eine C₁-C₈ Alkyl Gruppe, die gegebenenfalls mit mindestens einem Substituenten E substituiert und/oder durch D unterbrochen sein kann; oder eine C₃-C₆ Cycloalkyl Gruppe, die gegebenenfalls mit mindestens einem Substituenten E substituiert sein kann; besonders bevorzugt ist R⁹ Wasserstoff und R⁸ ist Wasserstoff oder eine Phenyl-Gruppe, die gegebenenfalls mit einer oder zwei Gruppen G substituiert sein kann; am meisten bevorzugt sind R⁸ und R⁹ Wasserstoff;
am meisten bevorzugt sind, im Falle, dass sowohl R⁶ als auch R⁸ vorliegt, R⁶ und R⁸ identisch; im Falle, dass R⁵ und R⁹ beide vorliegen, sind R⁵ und R⁹ identisch;
D ist -S-, oder -O-;
E ist -OR⁶⁹, -CN, CF₃, C₁-C₈ Alkyl oder F; vorzugsweise CF₃ oder C₁-C₈ Alkyl;
vorzugsweise C₁-C₈ Alkyl;
G ist -OR⁶⁹, -CN, CF₃, oder C₁-C₈ Alkyl; vorzugsweise C₁-C₈ Alkyl;
R⁶⁹ ist eine Phenyl-Gruppe, die gegebenenfalls mit einer oder zwei C₁-C₈ Alkyl-Gruppen substituiert sein kann; eine unsubstituierte C₁-C₈ Alkyl-Gruppe; oder eine C₁-C₁₈ Alkyl-Gruppe, die durch -O- unterbrochen ist;
m ist 2 oder 1, vorzugsweise 2; im Falle, dass m 2 ist, können die beiden Liganden gleich oder verschieden sein, vorzugsweise sind die beiden Liganden gleich;
o ist 1, oder 2, vorzugsweise 1; im Falle, dass m 2 ist, können die beiden Liganden gleich oder verschieden sein, vorzugsweise sind die beiden Liganden gleich;
und die Summe aus m + o ist 3.

15. Eine organische elektronische Vorrichtung, umfassend mindest einen Metall-Carben-Komplex gemäß einem der Ansprüche 1 bis 14 sowie 22 und 23.

16. Die organische elektronische Vorrichtung gemäß Anspruch 15, wobei die organische elektronische Vorrichtung ausgewählt ist aus organischen Leuchtdioden (OLEDs), organische Photovoltaik Zellen (OPVs), organische Feldeffekttransistoren (OFETs) und lichtemittierende elektrochemische Zellen (LEECs).

17. Eine Licht emittierende Schicht, umfassend mindest einen Metall-Carben-Komplex gemäß einem der Ansprüche 1 bis 14 sowie 22 und 23.

18. Die Licht emittierende Schicht gemäß Anspruch 17, umfassend mindest einen Metall-Carben-Komplex gemäß einem der Ansprüche 1 bis 14 sowie 22 und 23 und mindestens ein Hostmaterial.

19. Ein Gerät ausgewählt aus der Gruppe bestehend aus stationären Anzeigeeinheiten, wie Bildschirme von Computern, Fernseher, Bildschirme in Druckern, Küchengeräten, Werbetafeln, Beleuchtungen, Informationstafeln, und mobile Anzeigeeinheiten wie Bildschirme in Mobiltelefonen, Tablet-Computern, Laptops, Digitalkameras, MP3 Playern, Fahrzeuganzeigen und Zielanzeigen in Bussen und Zügen; Beleuchtungseinheiten; Tastaturen; Kleidungsstücke, Einrichtungsgegenstände; Tapeten, umfassend die organische elektronische Vorrichtung gemäß den Ansprüchen 15 oder 16, oder die emittierende Schicht gemäß den Ansprüchen 17 und 18.

20. Die Verwendung eines Metall-Carben-Komplexes gemäß einem der Ansprüche 1 bis 14 sowie 22 und 23, für elektrophotografische Photorezeptoren, photoelektrische Wandler, organische Solarzellen (organische Photovoltaica), Schaltelemente, organische lichtemittierende Feldeffekttransistoren (OLEFETs), Bildsensoren, Farbstofflaser und elektrolumineszierende Vorrichtungen.

21. Ein Verfahren zur Herstellung eines Metall-Carben-Komplexes gemäß einem der Ansprüche 1 bis 14 sowie 22 und 23, umfassend mindestens einen Liganden der Struktur (I') 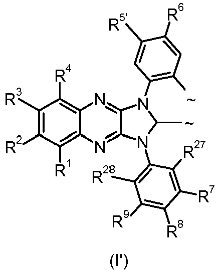 wobei
die Reste R¹, R², R³, R⁴, R⁶, R⁷, R⁸, R⁹, R²⁷ und R²⁸ in einem der Ansprüche 1 bis 14 definiert sind, und
R^{5'} eine C₁-C₁₈ Alkyl-Gruppe ist, die gegebenenfalls mit mindestens einem Substituenten E substituiert und/oder durch D unterbrochen sein kann; eine C₃-C₁₂ Cycloalkyl Gruppe, die gegebenenfalls mit mindestens einem Substituenten E substituiert sein kann; eine C₆-C₁₄ Aryl-Gruppe, die gegebenenfalls mit mindestens einem Substituenten G substituiert sein kann; eine -N(C₆-C₁₄aryl)₂-Gruppe, die gegebenenfalls mit mindestens einem Substituenten G substituiert sein kann; oder eine Heteroaryl-Gruppe, umfassend 3 bis 11 Ringatome, die gegebenenfalls mit mindestens einem Substituenten G substituiert sein kann; unterbrochen durch wenigstens eines von O, S, N;
umfassend das Umsetzen des Metall-Carben-Komplexes, wobei das Metall ausgewählt ist aus Ir und Pt, umfassend mindestens einen Liganden der Struktur (III) 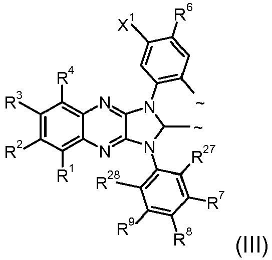 mit einer Verbindung der Struktur (IV), entsprechend dem jeweiligen Y-substituierten Rest R^{5'}: R^{5'}-Y (**IV**)
wobei
X¹ für Cl, Br, oder I steht, insbesondere Br;
Y ist -B(OH)₂, -B(OY¹)₂, 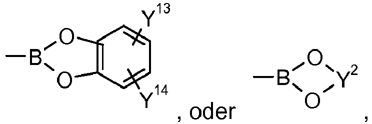 wobei Y¹ eine C₁-C₁₀ Alkyl-Gruppe ist und Y² unabhängig bei jedem Auftreten eine C₂-C₁₀ Alkylen-Gruppe ist, wie etwa -CY³Y⁴-CY⁵Y⁶-, oder -CY⁷Y⁸-CY⁹Y¹⁰- CY¹¹Y¹²-, wobei Y³, Y⁴, Y⁵, Y⁶, Y⁷, Y⁸, Y⁹, Y¹⁰, Y¹¹ und Y¹² unabhängig voneinander Wasserstoff sind, oder eine C₁-C₁₀ Alkyl-Gruppe, insbesondere -C(CH₃)₂C(CH₃)₂-, -CH₂C(CH₃)₂CH₂-, oder
-C(CH₃)₂CH₂C(CH₃)₂-, und Y¹³ und Y¹⁴ sind unabhängig voneinander Wasserstoff, oder eine C₁-C₁₀ Alkyl-Gruppe;
-SnR³⁰⁷R³⁰⁸ R³⁰⁹, wobei R³⁰⁷, R³⁰⁸ und R³⁰⁹ identisch oder verschieden sind und H oder C₁-C₆ Alkyl sind, wobei zwei Radikale gegebenenfalls einen Ring bilden und diese Radikale gegebenenfalls verzweigt oder unverzweigt sein können;
ZnR³¹⁰R³¹¹, wobei R³¹⁰ Halogen und R³¹¹ eine C₁-C₁₀ Alkyl-Gruppe, eine C₆-C₁₂ Aryl-Gruppe, oder eine C₁-C₁₀ Alkenyl-Gruppe ist; oder
SiR³¹²R³¹³R³¹⁴, wobei R³¹², R³¹³ und R³¹⁴ identisch oder verschieden sind und Halogen oder C₁-C₆ Alkyl sind.

22. Der Metall-Carben-Komplex gemäß einem der Ansprüche 1, 2, 4 - 14, wobei die Radikale R¹, R², R³, R⁴, R⁵, R⁶, R⁷, R⁸, R⁹, R²⁷ and R²⁹ Wasserstoff sind.

23. Der Metall-Carben-Komplex gemäß einem der Ansprüche 1 bis 14, wobei der Metall-Carben-Komplex eine der folgenden Strukturen hat 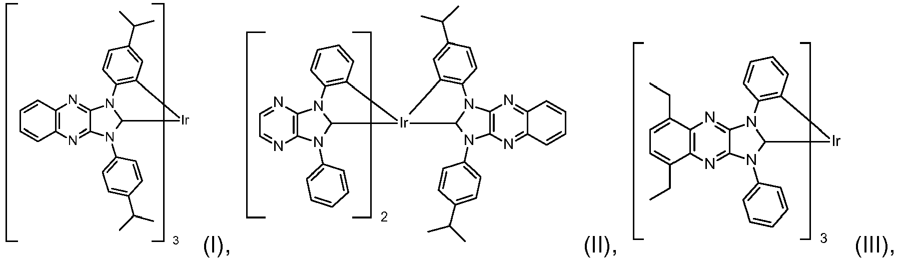 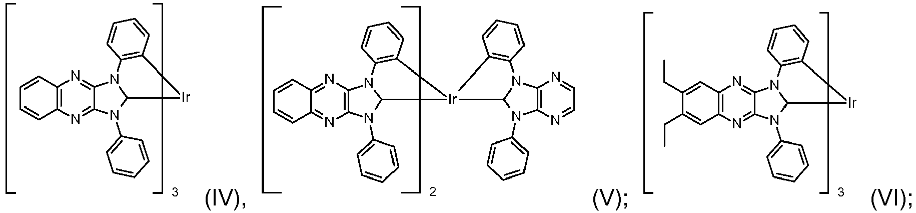 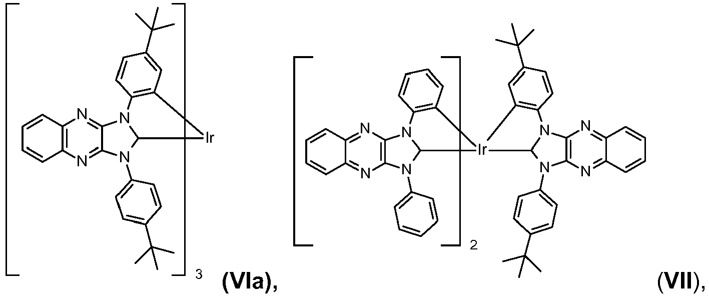 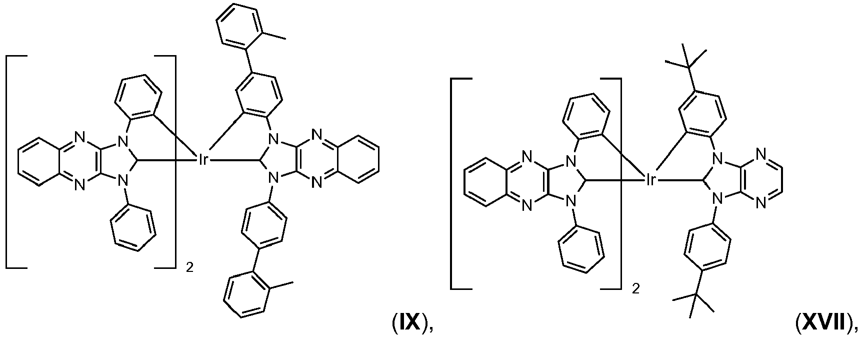 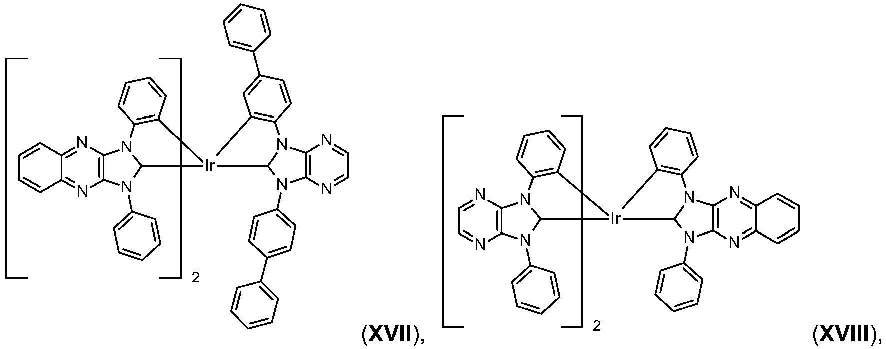 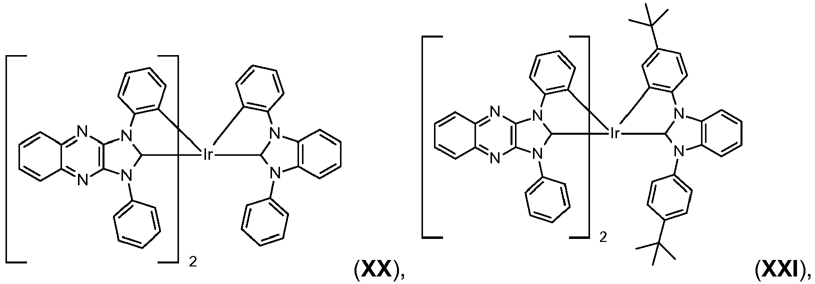 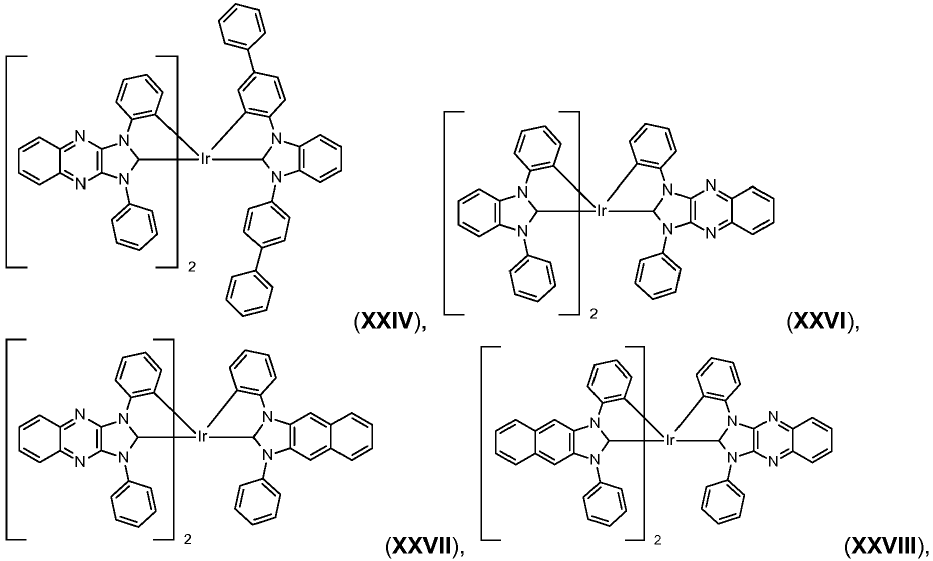 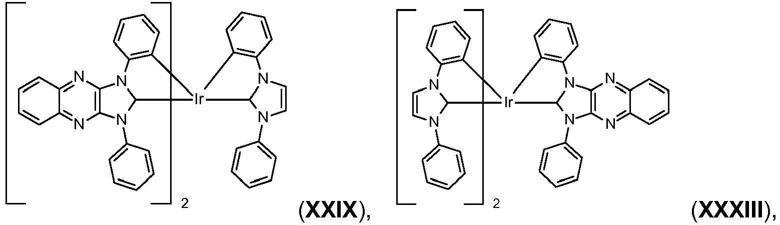 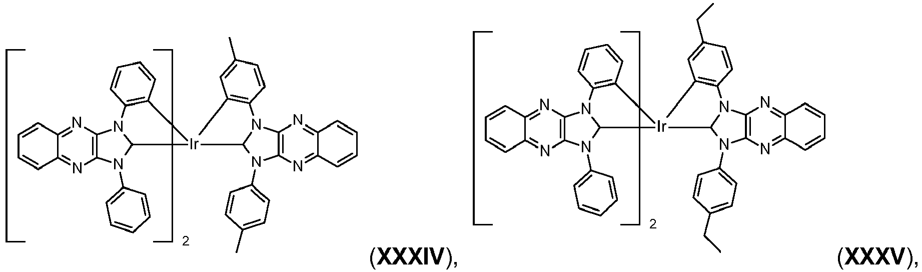 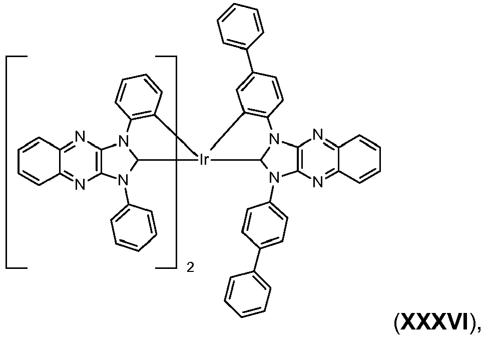 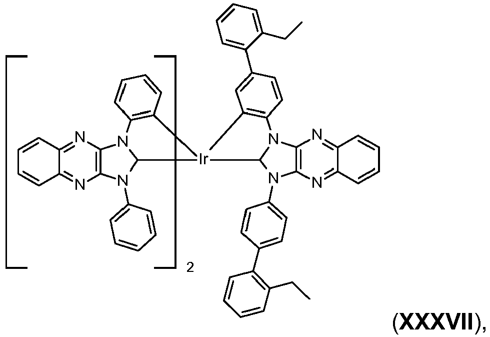 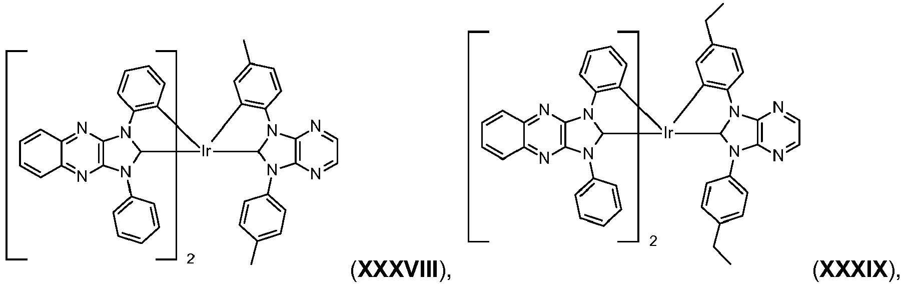 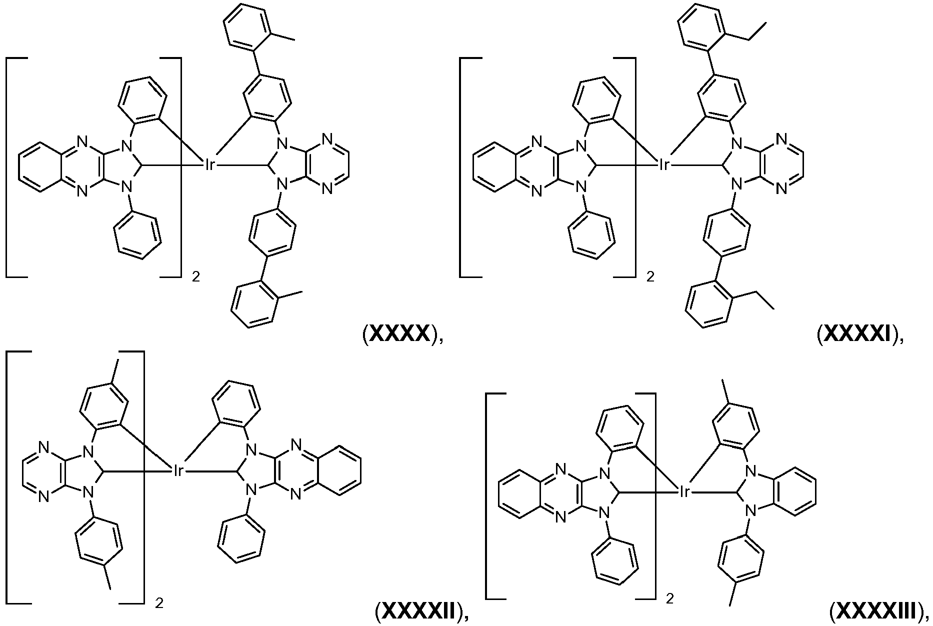 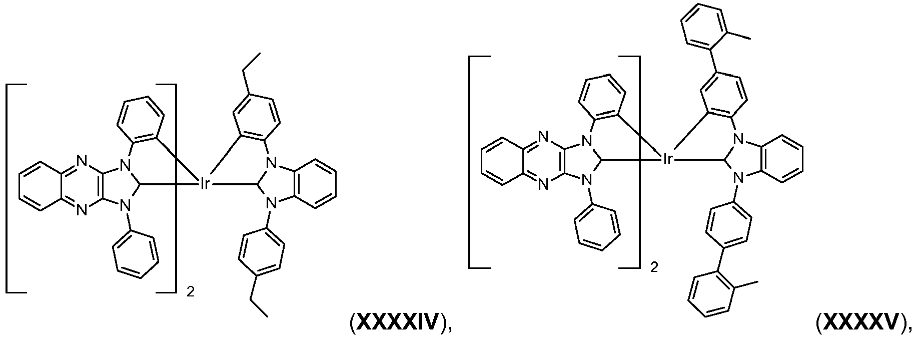 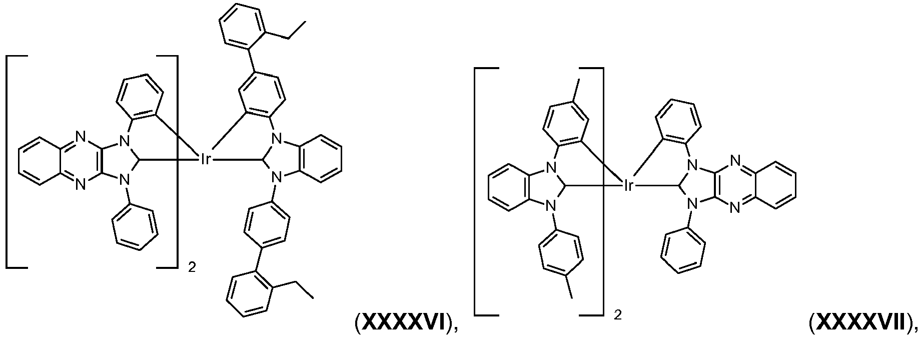 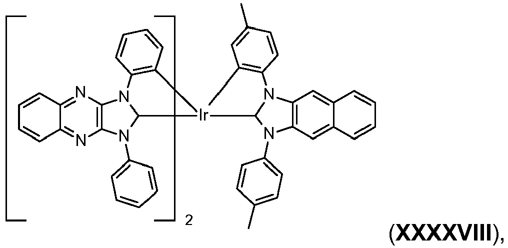 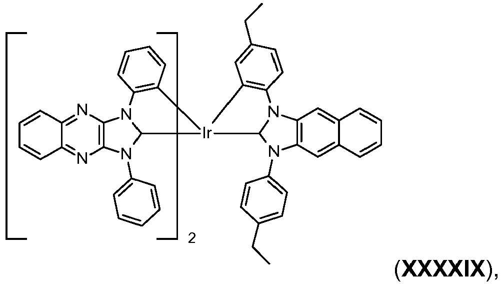 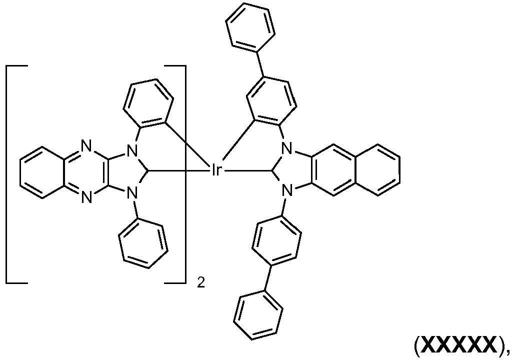 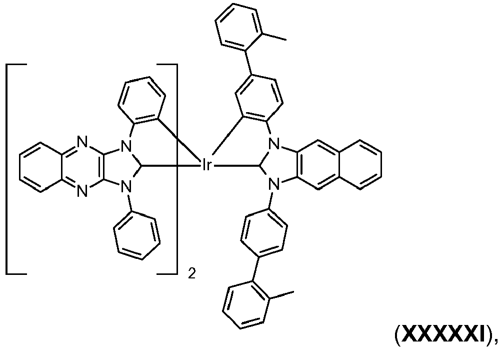 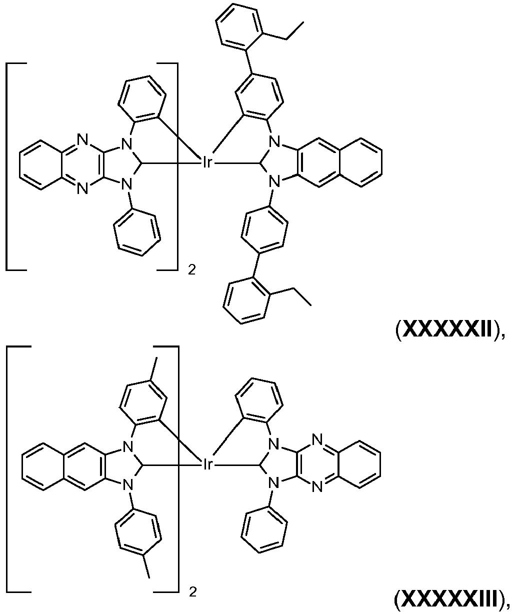 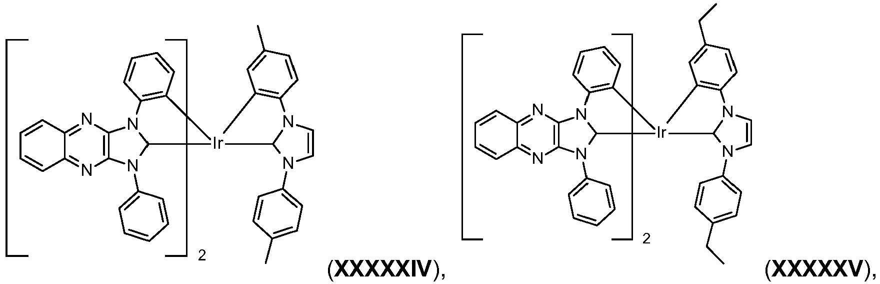 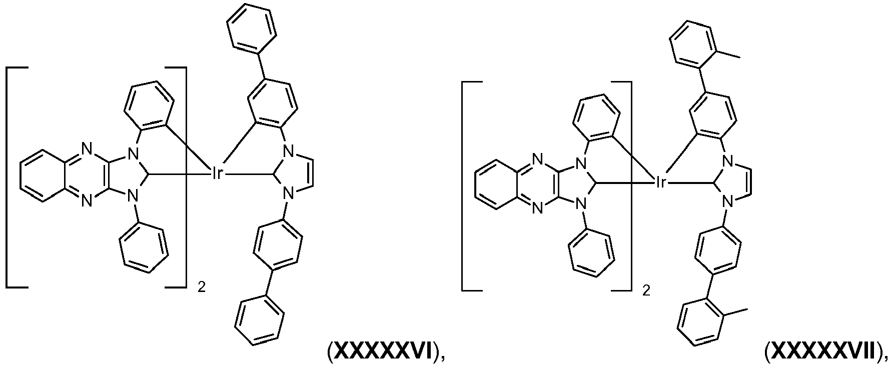 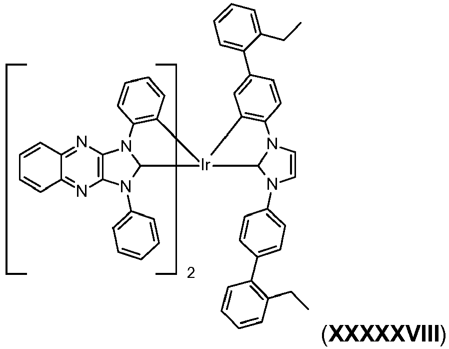 und

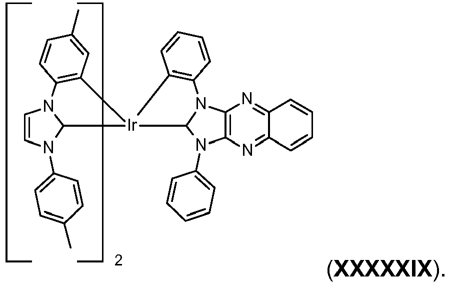

## Revendications

1. Complexe carbène métal, où le métal est choisi parmi Ir et Pt, comprenant au moins un ligand de formule (A), de préférence au moins un ligand de formule (I) 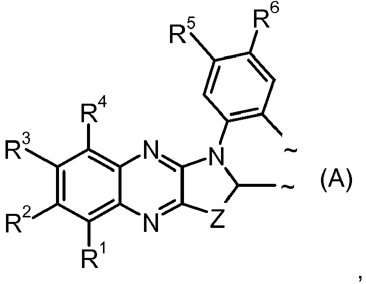 de préférence 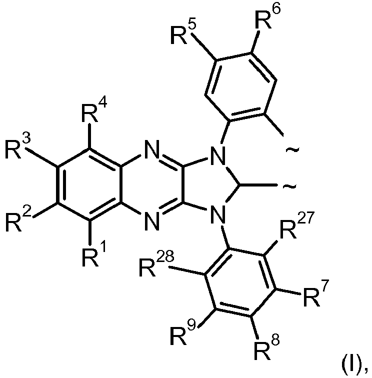 où
Z est NR^{x}, O ou S, de préférence NR^{x} ou O, plus préférablement NR^{x},
R^{x} est 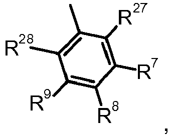 R¹, R², R³ et R⁴
sont indépendamment les uns des autres l'hydrogène ; un groupe alkyle en C₁-C₁₈, qui peut être facultativement substitué par au moins un substituant E et/ou interrompu par D ; un groupe cycloalkyle en C₃-C₁₂, qui peut être facultativement substitué par au moins un substituant E ; un groupe hétérocycloalkyle comprenant 3 à 6 atomes de cycle, interrompu par au moins l'un parmi O, S et NR⁶⁵ et/ou substitué par au moins un substituant E ; un groupe aryle en C₆-C₁₄, qui peut être facultativement substitué par au moins un substituant G ; un groupe -NR⁶⁵-aryle en C₆-C₁₄, de préférence un groupe -N(aryle en C₆-C₁₄)₂, qui peut être facultativement substitué par au moins un substituant G ; un groupe hétéroaryle comprenant 3 à 11 atomes de cycle, qui peut être facultativement substitué par au moins un substituant G, interrompu par au moins l'un parmi O, S, N et NR⁶⁵; ou un groupe -NR⁶⁵-hétéroaryle, de préférence un groupe -N(hétéroaryle)₂, comprenant 3 à 11 atomes de cycle, qui peut être facultativement substitué par au moins un substituant G, interrompu par au moins l'un parmi O, S, N et NR⁶⁵; un atome d'halogène, notamment F ou Cl ; un groupe haloalkyle en C₁-C₁₈ tel que CF₃; CN ; ou SiR⁸⁰R⁸¹R⁸²;
ou
R¹ et R², R² et R³ ou R³ et R⁴ forment ensemble un cycle 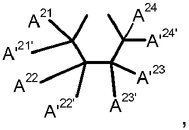 ou 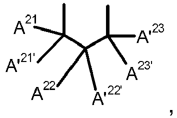 où A²¹, A^{21'}, A²², A^{22'}, A²³, A^{23'}, A^{24'} et A²⁴ sont indépendamment les uns des autres H, un groupe alkyle en C₁-C₄, un groupe cycloalkyle en C₃-C₆, ou un groupe fluoroalkyle en C₁-C₄ ;
R⁵ et R⁶
sont indépendamment l'un de l'autre l'hydrogène ; un groupe alkyle en C₁-C₁₈, qui peut être facultativement substitué par au moins un substituant E et/ou interrompu par D ; un groupe cycloalkyle en C₃-C₁₂, qui peut être facultativement substitué par au moins un substituant E ; un groupe hétérocycloalkyle comprenant 3 à 6 atomes de cycle, interrompu par au moins l'un parmi O, S et NR⁶⁵ et/ou substitué par au moins un substituant E ; un groupe aryle en C₆-C₁₄, qui peut être facultativement substitué par au moins un substituant G ; un groupe -NR⁶⁵-aryle en C₆-C₁₄, de préférence un groupe -N(aryle en C₆-C₁₄)₂, qui peut être facultativement substitué par au moins un substituant G ; un groupe hétéroaryle comprenant 3 à 11 atomes de cycle, qui peut être facultativement substitué par au moins un substituant G, interrompu par au moins l'un parmi O, S, N et NR⁶⁵; un atome d'halogène, notamment F ou Cl ; un groupe haloalkyle en C₁-C₁₈ tel que CF₃; CN ; ou SiR⁸⁰R⁸¹R⁸² ;
R⁷, R⁸, R⁹, R²⁷ et R²⁸
sont indépendamment les uns des autres l'hydrogène ; un groupe alkyle en C₁-C₁₈, qui peut être facultativement substitué par au moins un substituant E et/ou interrompu par D ; un groupe cycloalkyle en C₃-C₁₂, qui peut être facultativement substitué par au moins un substituant E ; un groupe hétérocycloalkyle comprenant 3 à 6 atomes de cycle, interrompu par au moins l'un parmi O, S et NR⁶⁵ et/ou substitué par au moins un substituant E ; un groupe aryle en C₆-C₁₄, qui peut être facultativement substitué par au moins un substituant G ; un groupe hétéroaryle comprenant 3 à 11 atomes de cycle, qui peut être facultativement substitué par au moins un substituant G, interrompu par au moins l'un parmi O, S, N et NR⁶⁵; un atome d'halogène, notamment F ou Cl ; un groupe haloalkyle en C₁-C₁₈ tel que CF₃; CN ; ou SiR⁸⁰R⁸¹R⁸² ; en plus des groupes mentionnés ci-dessus, R⁸ peut être un groupe -NR⁶⁵-aryle en C₆-C₁₄, de préférence un groupe -N(aryle en C₆-C₁₄)₂, qui peut être facultativement substitué par au moins un substituant G ; ou un groupe -NR⁶⁵-hétéroaryle, de préférence un groupe -N(hétéroaryle)₂, comprenant 3 à 11 atomes de cycle, qui peut être facultativement substitué par au moins un substituant G, interrompu par au moins l'un parmi O, S, N et NR⁶⁵ ;
ou
R⁵ et R⁶ et/ou R⁸ et R⁹ forment ensemble un groupe de formule 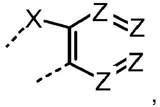 où Z est N
ou CR"', où 0 ou 1 Z est N, de préférence 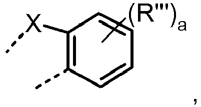 où X est O, S, NR⁷⁵ ou CR⁷³R⁷⁴, de préférence O ; R'" est alkyle en C₁-C₈ et a est 0, 1 ou 2, de préférence 0 ou 1, plus préférablement 0 ;
D est -CO-, -COO-, -S-, -SO-, -SO₂-, -O-, -NR⁶⁵-, -SiR⁷⁰R⁷¹-, -POR⁷²-, -CR⁶³=CR⁶⁴-, ou -C≡C, de préférence -O-, -S- ou -NR⁶⁵-;
E est -OR⁶⁹, -SR⁶⁹, -NR⁶⁵R⁶⁶, -COR⁶⁸, -COOR⁶⁷, -CONR⁶⁵R⁶⁶, -CN, un halogène, un groupe alkyle en C₁-C₁₈, qui peut être facultativement substitué par au moins un substituant E et/ou interrompu par D ; de préférence F ; un groupe haloalkyle en C₁-C₈ tel que CF₃, ou un groupe alkyle en C₁-C₈ ;
de préférence, E est alkyle en C₁-C₈, alcoxy en C₁-C₈, CN, un halogène, de préférence F, ou haloalkyle en C₁-C₈, tel que CF₃ ; plus préférablement E est alkyle en C₁-C₈, alcoxy en C₁-C₈, ou haloalkyle en C₁-C₈, tel que CF₃ ;
G est E ; ou un groupe aryle en C₆-C₁₄ non substitué ; un groupe aryle en C₆-C₁₄, qui est substitué par F, alkyle en C₁-C₁₈, ou alkyle en C₁-C₁₈, qui est substitué par F et/ou interrompu par O ; un groupe hétéroaryle non substitué comprenant 3 à 11 atomes de cycle, interrompu par au moins l'un parmi O, S, N et NR⁶⁵; ou un groupe hétéroaryle comprenant 3 à 11 atomes de cycle, interrompu par au moins l'un parmi O, S, N et NR⁶⁵, qui est substitué par F, alkyle en C₁-C₁₈ non substitué, SiR⁸⁰R⁸¹R⁸², ou alkyle en C₁-C₁₈ qui est substitué par F et/ou interrompu par O ;
de préférence, G est un groupe alkyle en C₁-C₈, ou un groupe de formule 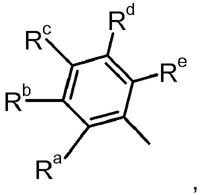
R^{a} est H, un groupe alkyle en C₁-C₅, un groupe fluoroalkyle en C₁-C₄, ou un groupe cycloalkyle en C₃-C₆,
R^{e} est H, un groupe alkyle en C₁-C₅, un groupe fluoroalkyle en C₁-C₄, ou un groupe cycloalkyle en C₃-C₆,
R^{c}, R^{b} et R^{d} sont indépendamment les uns des autres l'hydrogène ; un groupe alkyle en C₁-C₁₈, qui peut être facultativement substitué par E et/ou interrompu par D ; un groupe cycloalkyle en C₃-C₁₂, qui peut être facultativement substitué par G ; un radical hétérocycloalkyle en C₃-C₁₀ qui est interrompu par au moins l'un parmi O, S et NR⁶⁵ et/ou substitué par E ; un groupe aryle en C₆-C₂₄, qui peut être facultativement substitué par G ; ou un groupe hétéroaryle en C₂-C₃₀, qui peut être facultativement substitué par G ; un atome d'halogène, notamment F ou Cl ; haloalkyle en C₁-C₈ tel que CF₃; CN ; ou SiR⁸⁰R⁸¹R⁸² ;
ou
R^{c} et R^{b}, ou R^{a} et R^{b} forment ensemble un groupe de formule 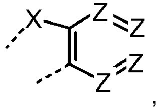 où Z est N
ou CR"', où 0 ou 1 Z est N, de préférence 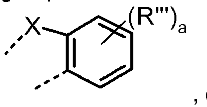 où X est O, S, NR⁷⁵ ou CR⁷³R⁷⁴, de préférence O ; R'" est alkyle en C₁-C₈ et a est 0, 1 ou 2, de préférence 0 ou 1, plus préférablement 0 ;
R⁶³ et R⁶⁴ sont indépendamment l'un de l'autre H ; aryle en C₆-C₁₈ non substitué ; aryle en C₆-C₁₈ qui est substitué par alkyle en C₁-C₁₈, ou alcoxy en C₁-C₁₈ ; alkyle en C₁-C₁₈ non substitué ; ou alkyle en C₁-C₁₈ qui est interrompu par -O- ; de préférence aryle en C₆-C₁₈ non substitué ; aryle en C₆-C₁₈ qui est substitué par alkyle en C₁-C₁₈, ou alcoxy en C₁-C₁₈ ; alkyle en C₁-C₁₈ non substitué ; ou alkyle en C₁-C₁₈ qui est interrompu par -O- ;
R⁶⁵ et R⁶⁶ sont indépendamment l'un de l'autre H, un groupe aryle en C₆-C₁₈ non substitué ; un groupe aryle en C₆-C₁₈ qui est substitué par alkyle en C₁-C₁₈, ou alcoxy en C₁-C₁₈; un groupe alkyle en C₁-C₁₈ non substitué ; ou un groupe alkyle en C₁-C₁₈, qui est interrompu par -O- ;
R⁶⁵ et R⁶⁶ forment ensemble un cycle à cinq ou six chaînons,
R⁶⁷ est H, un groupe aryle en C₆-C₁₈ non substitué ; un groupe aryle en C₆-C₁₈, qui est substitué par alkyle en C₁-C₁₈, ou alcoxy en C₁-C₁₈ ; un groupe alkyle en C₁-C₁₈ non substitué ; ou un groupe alkyle en C₁-C₁₈, qui est interrompu par -O- ; de préférence un groupe aryle en C₆-C₁₈ non substitué ; un groupe aryle en C₆-C₁₈, qui est substitué par alkyle en C₁-C₁₈, ou alcoxy en C₁-C₁₈ ; un groupe alkyle en C₁-C₁₈ non substitué ; ou un groupe alkyle en C₁-C₁₈, qui est interrompu par -O- ;
R⁶⁸ est H ; un groupe aryle en C₆-C₁₈ non substitué ; un groupe aryle en C₆-C₁₈, qui est substitué par alkyle en C₁-C₁₈, ou alcoxy en C₁-C₁₈ ; un groupe alkyle en C₁-C₁₈ non substitué ; ou un groupe alkyle en C₁-C₁₈, qui est interrompu par -O- ;
R⁶⁹ est H, un aryle en C₆-C₁₈ non substitué ; un aryle en C₆-C₁₈, qui est substitué par alkyle en C₁-C₁₈, ou alcoxy en C₁-C₁₈ ; un groupe alkyle en C₁-C₁₈ non substitué ; ou un groupe alkyle en C₁-C₁₈, qui est interrompu par -O- ; de préférence un aryle en C₆-C₁₈ non substitué ; un aryle en C₆-C₁₈, qui est substitué par alkyle en C₁-C₁₈, ou alcoxy en C₁-C₁₈ ; un groupe alkyle en C₁-C₁₈ non substitué ; ou un groupe alkyle en C₁-C₁₈, qui est interrompu par -O- ;
R⁷⁰ et R⁷¹ sont indépendamment l'un de l'autre un groupe alkyle en C₁-C₁₈ non substitué ; un groupe aryle en C₆-C₁₈ non substitué ; ou un groupe aryle en C₆-C₁₈, qui est substitué par alkyle en C₁-C₁₈ ;
R⁷² est un groupe alkyle en C₁-C₁₈ non substitué ; un groupe aryle en C₆-C₁₈ non substitué, ou un groupe aryle en C₆-C₁₈, qui est substitué par alkyle en C₁-C₁₈;
R⁷³ et R⁷⁴ sont indépendamment l'un de l'autre H, alkyle en C₁-C₂₅, alkyle en C₁-C₂₅ qui est interrompu par O, arylalkyle en C₇-C₂₅, aryle en C₆-C₂₄, aryle en C₆-C₂₄ qui est substitué par alkyle en C₁-C₁₈, hétéroaryle en C₂-C₂₀, ou hétéroaryle en C₂-C₂₀ qui est substitué par alkyle en C₁-C₁₈ ;
R⁷⁵ est un groupe aryle en C₆-C₁₈ ; un aryle en C₆-C₁₈ qui est substitué par alkyle en C₁-C₁₈, ou alcoxy en C₁-C₁₈ ; un groupe alkyle en C₁-C₁₈ ; ou un groupe alkyle en C₁-C₁₈, qui est interrompu par -O- ;
R⁸⁰, R⁸¹ et R⁸² sont indépendamment les uns des autres un groupe alkyle en C₁-C₂₅, qui peut être facultativement interrompu par O ; un groupe aryle en C₆-C₁₄, qui peut être facultativement substitué par alkyle en C₁-C₁₈ ; ou un groupe hétéroaryle comprenant 3 à 11 atomes de cycle, qui peut être facultativement substitué par alkyle en C₁-C₁₈ ;
∼ est un site de liaison au métal.

2. Complexe carbène métal selon la revendication 1, où
R¹, R², R³ et R⁴
sont indépendamment les uns des autres l'hydrogène ; un groupe alkyle en C₁-C₁₂, qui peut être facultativement substitué par au moins un substituant E et/ou interrompu par D ;
un groupe cycloalkyle en C₃-C₁₂, qui peut être facultativement substitué par au moins un substituant E ; un groupe aryle en C₆-C₁₄, qui peut être facultativement substitué par un ou deux groupes G ; un groupe hétéroaryle comprenant 3 à 11 atomes de cycle, qui peut être facultativement substitué par un ou deux groupes G ; ou un groupe -N(phényle)₂, qui peut être facultativement substitué par un ou deux groupes G ;
R⁵ et R⁶
sont indépendamment l'un de l'autre l'hydrogène ; un groupe alkyle en C₁-C₁₂, qui peut être facultativement substitué par E et/ou interrompu par D ; un groupe cycloalkyle en C₃-C₁₂, qui peut être facultativement substitué par E ;
ou
l'un parmi R⁵ et R⁶, de préférence R⁵, est un groupe de formule 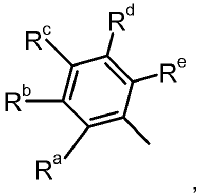 dans un autre mode de réalisation préféré, R⁶ est un groupe de formule 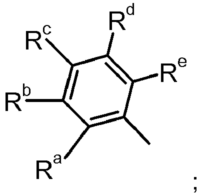 R^{a} est H, un groupe alkyle en C₁-C₅, un groupe fluoroalkyle en C₁-C₄, ou un groupe cycloalkyle en C₃-C₆ ; de préférence H, un groupe alkyle en C₁-C₅, un groupe cycloalkyle en C₃-C₆ ; plus préférablement H, ou un groupe alkyle en C₁-C₅ ;
R^{e} est H, un groupe alkyle en C₁-C₅, un groupe fluoroalkyle en C₁-C₄, ou un groupe cycloalkyle en C₃-C₆ ; de préférence H, un groupe alkyle en C₁-C₅, un groupe cycloalkyle en C₃-C₆ ; plus préférablement H, ou un groupe alkyle en C₁-C₅ ;
R^{c}, R^{b} et R^{d} sont indépendamment les uns des autres l'hydrogène ; un groupe alkyle en C₁-C₁₈, qui peut être facultativement substitué par E et/ou interrompu par D ; un groupe cycloalkyle en C₃-C₁₂, qui peut être facultativement substitué par G ; un groupe aryle en C₆-C₁₄, qui peut être facultativement substitué par G ; ou un groupe hétéroaryle en C₂-C₃₀, qui peut être facultativement substitué par G ; haloalkyle en C₁-C₈ tel que CF₃; ou
SiR⁸⁰R⁸¹R⁸²; de préférence R^{c}, R^{b} et R^{d} sont indépendamment les uns des autres H, un groupe alkyle en C₁-C₅, groupe cycloalkyle en C₃-C₆ ; plus préférablement H, ou un groupe alkyle en C₁-C₅ ; plus préférablement encore, R^{b}, R^{c} et R^{d} sont l'hydrogène ou un groupe phényle, qui peut être facultativement substitué par un ou deux groupes G ;
ou
R^{c} et R^{b}, ou R^{a} et R^{b} forment ensemble un groupe de formule 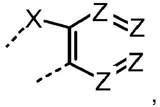 où Z est N
ou CR"', où 0 ou 1 Z est N, de préférence 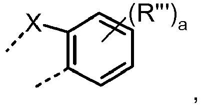 où X est O, S, NR⁷⁵ ou CR⁷³R⁷⁴, de préférence O ; R"' est alkyle en C₁-C₈ et a est 0, 1 ou 2, de préférence 0 ou 1, plus préférablement 0 ;
R⁷, R⁸ et R⁹
sont indépendamment les uns des autres l'hydrogène ; un groupe alkyle en C₁-C₁₂, qui peut être facultativement substitué par E et/ou interrompu par D ; un groupe cycloalkyle en C₃-C₁₂, qui peut être facultativement substitué par E ; un groupe aryle en C₆-C₁₄, qui peut être facultativement substitué par un ou deux groupes G ; un groupe hétéroaryle comprenant 3 à 11 atomes de cycle, qui peut être facultativement substitué par un ou
deux groupes G ;
R²⁷, R²⁸
sont indépendamment l'un de l'autre l'hydrogène ; ou un groupe alkyle en C₁-C₁₂, qui peut être facultativement substitué par E et/ou interrompu par D, de préférence un groupe CH₂-alkyle en C₁-C₇, qui peut être facultativement substitué par E et/ou interrompu par D ;
de préférence, au moins l'un parmi R²⁷ et R²⁸ est l'hydrogène ;
D est -S- ou -O-
E est -OR⁶⁹, CF₃, alkyle en C₁-C₈ ou F ;
G est -OR⁶⁹, CF₃ ou alkyle en C₁-C₈ ;
R⁶⁵ est un groupe phényle, qui peut être facultativement substitué par un ou deux groupes alkyle en C₁-C₈ ; un groupe alkyle en C₁-C₁₈ non substitué ; ou un groupe alkyle en C₁-C₁₈,
qui est interrompu par -O- ; et
R⁶⁹ est un groupe phényle, qui peut être facultativement substitué par un ou deux groupes alkyle en C₁-C₈ ; un groupe alkyle en C₁-C₁₈ non substitué ; ou un groupe alkyle en C₁-C₁₈,
qui est interrompu par -O-.

3. Complexe carbène métal selon la revendication 1 ou 2, où au moins l'un des radicaux R¹, R², R³, R⁴, R⁵, R⁶, R⁷, R⁸, et R⁹ n'est pas l'hydrogène ; de préférence, soit R⁵ n'est pas l'hydrogène soit au moins deux des radicaux R¹, R², R³, R⁴, R⁵, R⁶, R⁷, R⁸ et R⁹ ne sont pas l'hydrogène.

4. Complexe carbène métal selon l'une quelconque des revendications 1 à 3, où
R¹, R², R³ et R⁴
sont indépendamment les uns des autres l'hydrogène ; un groupe alkyle en C₁-C₈, qui peut être facultativement substitué par au moins un substituant E ; un groupe cycloalkyle en C₃-C₆, qui peut être facultativement substitué par au moins un substituant E ; ou un groupe phényle, qui peut être facultativement substitué par un ou deux groupes G ;
R⁵ et R⁶
sont indépendamment l'un de l'autre l'hydrogène ; un groupe alkyle en C₁-C₈, qui peut être facultativement substitué par au moins un substituant E ; ou un groupe cycloalkyle en C₃-C₆, qui peut être facultativement substitué par au moins un substituant E ; ou un groupe phényle, qui peut être facultativement substitué par un ou deux groupes G ;
R⁷, R⁸ et R⁹
sont indépendamment les uns des autres l'hydrogène ; un groupe alkyle en C₁-C₈, qui peut être facultativement substitué par au moins un substituant E ; ou un groupe cycloalkyle en C₃-C₆, qui peut être facultativement substitué par au moins un substituant E ; ou un groupe phényle, qui peut être facultativement substitué par un ou deux groupes G;
R²⁷ et R²⁸
sont l'hydrogène ;
E est CF₃, alkyle en C₁-C₈ ou F ;
G est CF₃ ou alkyle en C₁-C₈ ; de préférence alkyle en C₁-C₈ ;
R⁶⁵ est un groupe phényle, qui peut être facultativement substitué par un ou deux groupes alkyle en C₁-C₈ ; un groupe alkyle en C₁-C₈ non substitué ; ou un groupe alkyle en C₁-C₈, qui est interrompu par -O- ; et
R⁶⁹ est un groupe phényle, qui peut être facultativement substitué par un ou deux groupes alkyle en C₁-C₈ ; un groupe alkyle en C₁-C₈ non substitué ; ou un groupe alkyle en C₁-C₈,
qui est interrompu par -O-.

5. Complexe carbène métal selon l'une quelconque des revendications 1 à 4, où
R¹, R², R³ et R⁴
sont indépendamment les uns des autres l'hydrogène ; un groupe alkyle en C₁-C₈ ; ou un groupe cycloalkyle en C₃-C₆ ;
R⁵, R⁶, R⁷, R⁸ et R⁹
sont indépendamment les uns des autres l'hydrogène ; un groupe alkyle en C₁-C₈ ; ou un groupe cycloalkyle en C₃-C₆ ; ou l'un parmi R⁵ et R⁶ est un groupe phényle, qui peut être facultativement substitué par un ou deux groupes G ; et
R²⁷ et R²⁸
sont l'hydrogène.

6. Complexe carbène métal selon l'une quelconque des revendications 1 à 5, où soit R² et R³ soit R¹ et R⁴ sont H.

7. Complexe carbène métal selon l'une quelconque des revendications 1 à 6, où R⁵ et R⁶
sont indépendamment l'un de l'autre l'hydrogène ; un groupe alkyle en C₁-C₈; ou l'un parmi R⁵ et R⁶, de préférence R⁵, est un groupe phényle, qui peut être facultativement substitué par un ou deux groupes choisis parmi CF₃ ou alkyle en C₁-C₈, de préférence être facultativement substitué par un groupe alkyle en C₁-C₈ ; dans un autre mode de réalisation préféré R⁶ est un groupe phényle, qui peut être facultativement substitué par un ou deux groupes choisis parmi CF₃ ou alkyle en C₁-C₈, de préférence être facultativement substitué par un groupe alkyle en C₁-C₈ ;
de préférence, au moins l'un parmi R⁵ et R⁶ est l'hydrogène ;
R⁷ et R⁹
sont alkyle en C₁-C₈ ;
R8
est l'hydrogène ; un groupe alkyle en C₁-C₈ ; ou un groupe phényle, qui peut être facultativement substitué en position para par un groupe choisi parmi CF₃ ou alkyle en C₁-C₈, de préférence être facultativement substitué par un groupe alkyle en C₁-C₈ ;
R²⁷ et R²⁸
sont l'hydrogène.

8. Complexe carbène métal selon l'une quelconque des revendications 1 à 6, où
R5
est l'hydrogène ; un groupe alkyle en C₁-C₈, qui peut être facultativement substitué par au moins un substituant choisi parmi CF₃, alkyle en C₁-C₈ et F ; un groupe cycloalkyle en C₃-C₆, qui peut être facultativement substitué par au moins un substituant choisi parmi CF₃,
alkyle en C₁-C₈ et F ; ou un groupe phényle, qui peut être facultativement substitué par un ou deux groupes choisis parmi CF₃ et alkyle en C₁-C₈, de préférence être facultativement substitué par un ou deux groupes alkyle en C₁-C₈ ;
R⁶ et R⁸
sont identiques et choisis dans le groupe constitué par un groupe alkyle en C₁-C₈, qui peut être facultativement substitué par au moins un substituant choisi parmi CF₃, alkyle en C₁-C₈ et F ; un groupe cycloalkyle en C₃-C₆, qui peut être facultativement substitué par au moins un substituant choisi parmi CF₃, alkyle en C₁-C₈ et F ; et un groupe phényle, qui peut être facultativement substitué par un ou deux groupes choisis parmi CF₃ et alkyle en C₁-C₈, de préférence être facultativement substitué par un ou deux groupes alkyle en C₁-C₈; et
R⁷ et R⁹
sont l'hydrogène,
où R⁵ et R⁶ ne sont pas en même temps un groupe phényle, qui peut être facultativement substitué par un ou deux groupes choisis parmi CF₃ et alkyle en C₁-C₈, de préférence être facultativement substitué par un ou deux groupes alkyle en C₁-C₈ ;
R²⁷ et R²⁸
sont l'hydrogène.

9. Complexe carbène métal selon l'une quelconque des revendications 1 à 6, où
R⁷, R⁸ et R⁹ sont H ; et
R⁶ est H ; et
R²⁷ et R²⁸
sont l'hydrogène.

10. Complexe carbène métal selon l'une quelconque des revendications 1 à 9, ayant la formule (II) suivante 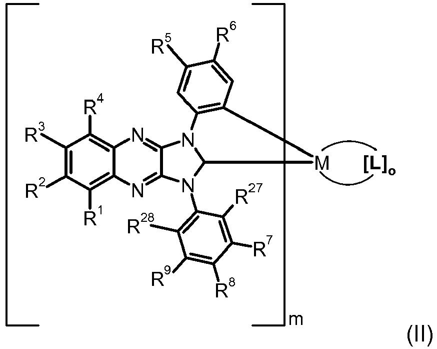 où
M est Pt, ou Ir, de préférence Ir ;
si M est Ir, m est 1, 2 ou 3 ; o est 0, 1 ou 2 ; et la somme de m + o est 3 ;
dans le cas où o = 2, les ligands L peuvent être identiques ou différents, de préférence identiques ; et dans le cas où m est 2 ou 3, les m ligands carbène peuvent être identiques ou différents, de préférence identiques ;
si M est Pt, m est 1, ou 2 ; o est 0, ou 1, et la somme de m + o est 2 ;
dans le cas où m est 2, les m ligands carbène peuvent être identiques ou différents, de préférence identiques ; et
L est un ligand bidentate monoanionique.

11. Complexe carbène métal selon l'une quelconque des revendications 1 à 10, où L est un groupe de formule 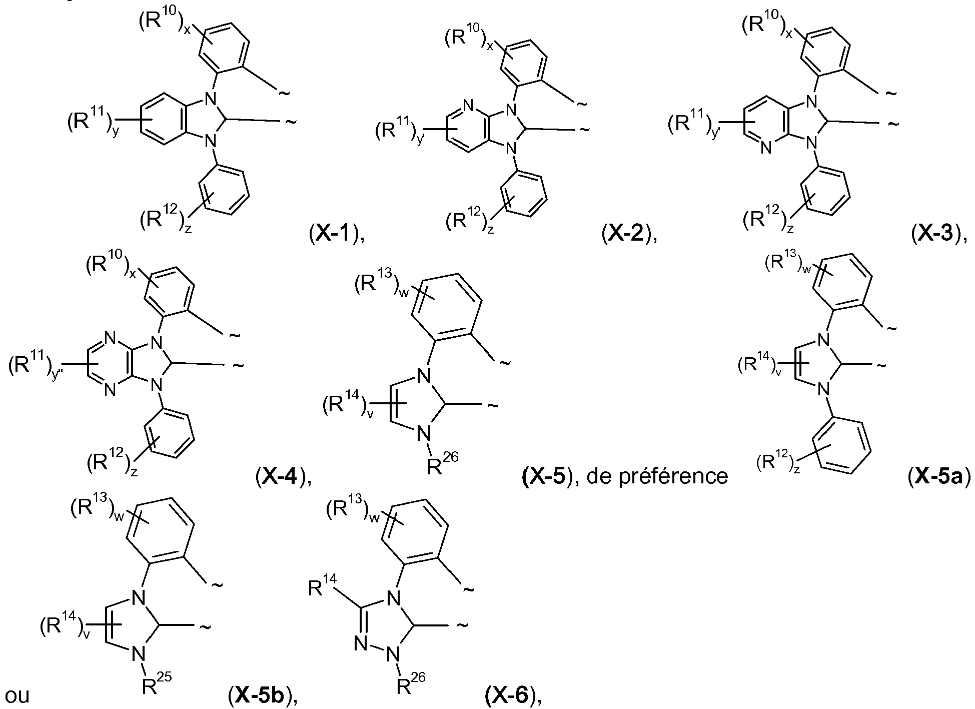 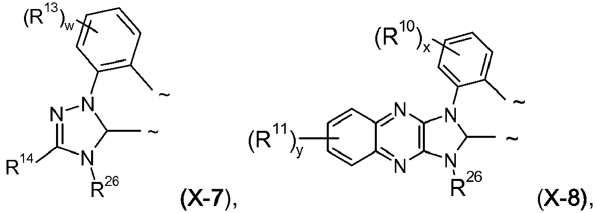 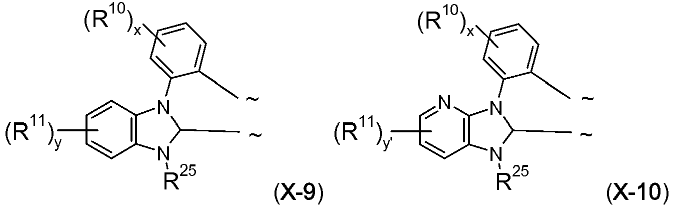 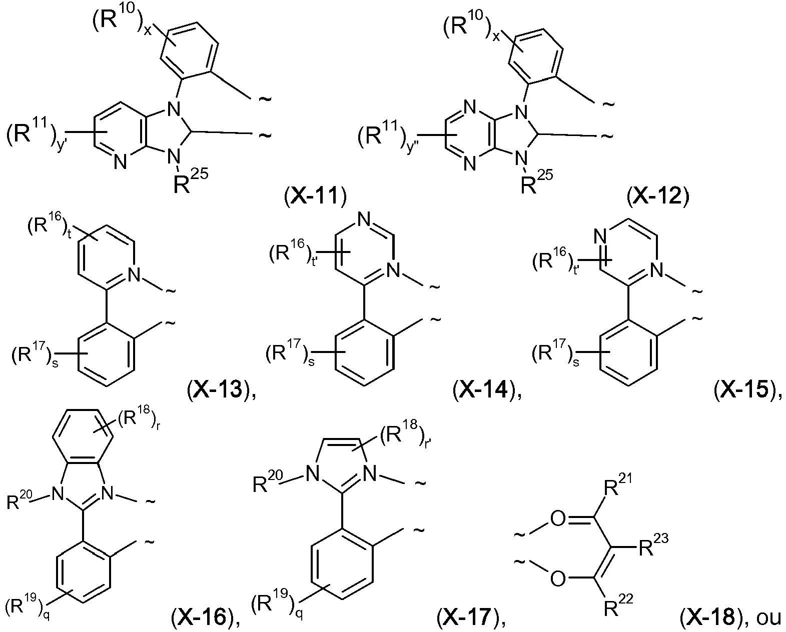 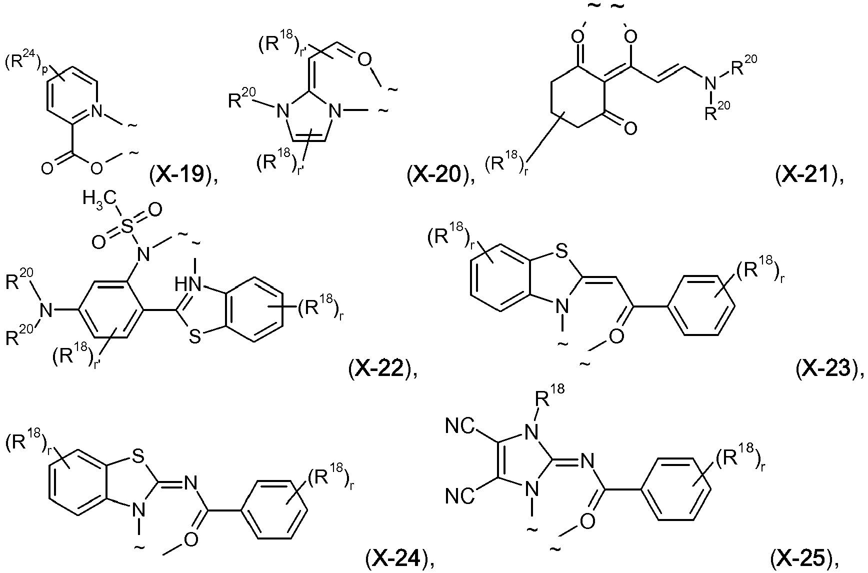 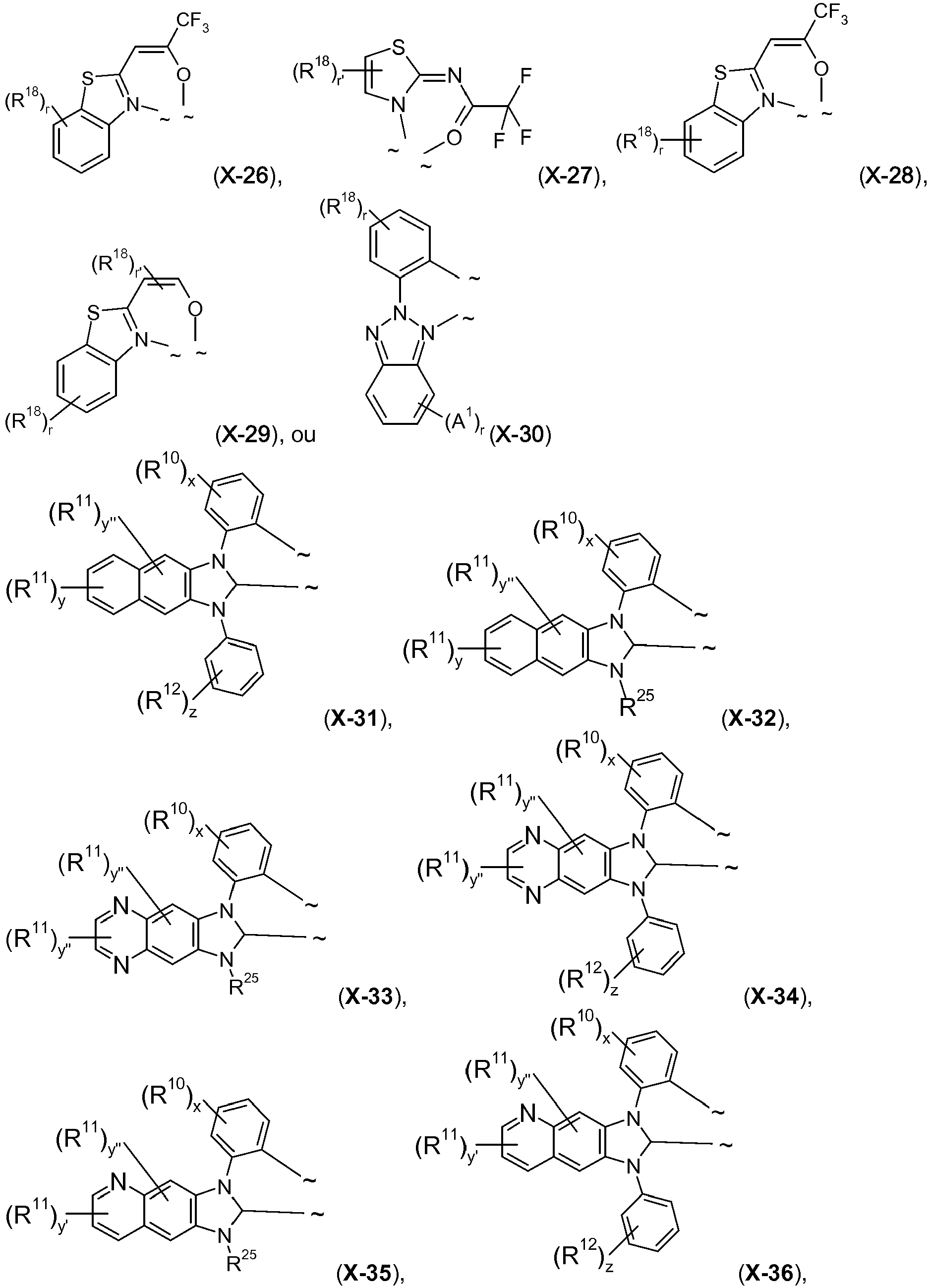 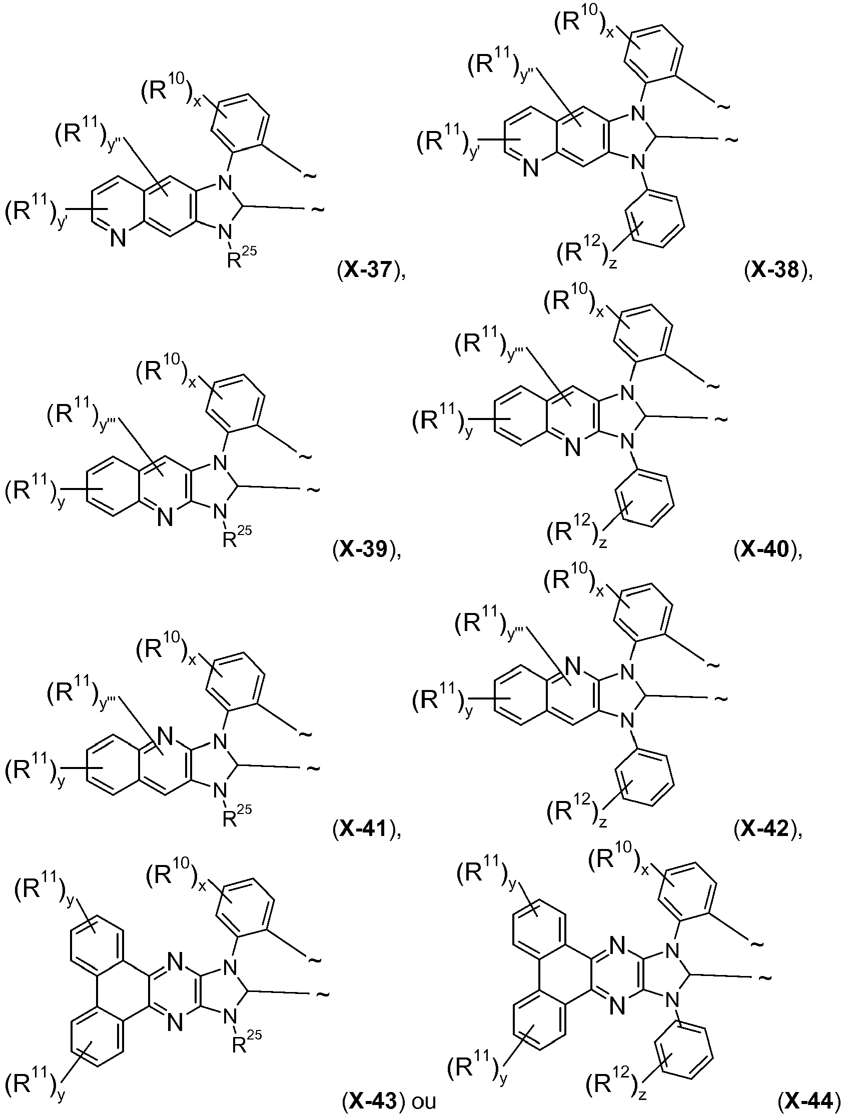 où
R¹⁰, R¹², R¹³, R¹⁶, R¹⁷, R¹⁸ et R¹⁹
les radicaux R¹⁰, R¹², R¹³, R¹⁶, R¹⁷, R¹⁸ et R¹⁹ sont - dans chaque cas - indépendamment les uns des autres un groupe alkyle en C₁-C₁₈, qui peut être facultativement substitué par E et/ou interrompu par D ; un groupe cycloalkyle en C₃-C₁₂, qui peut être facultativement substitué par E ; un groupe hétérocycloalkyle comprenant 3 à 6 atomes de cycle, interrompu par au moins un hétéroatome choisi parmi -O-, -S- et -NR⁶⁵-, portant facultativement au moins un substituant E ; un atome d'halogène, notamment F ou Cl ; haloalkyle en C₁-C₈ tel que CF₃; CN ; ou SiR⁸⁰R⁸¹R⁸² ; ou
un radical R¹⁰ et/ou un radical R¹²; un radical R¹³ et/ou un radical R¹²; un radical R¹⁶ et/ou un
radical R¹⁷; un radical R¹⁸ et/ou un radical R¹⁹ est un groupe de formule 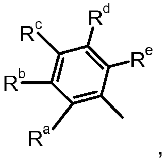 R^{a} est H, un groupe alkyle en C₁-C₅, un groupe fluoroalkyle en C₁-C₄, ou un groupe cycloalkyle en C₃-C₆, de préférence alkyle en C₁-C₅, ou H, plus préférablement H,
R^{e} est H, un groupe alkyle en C₁-C₅, un groupe fluoroalkyle en C₁-C₄, ou un groupe cycloalkyle en C₃-C₆, de préférence alkyle en C₁-C₅, ou H, plus préférablement H, R^{c}, R^{b} et R^{d} sont indépendamment les uns des autres l'hydrogène ; un groupe alkyle en C₁-C₁₈, qui peut être facultativement substitué par E et/ou interrompu par D ; un groupe cycloalkyle en C₃-C₁₂, qui peut être facultativement substitué par G ; un radical hétérocycloalkyle en C₃-C₁₀ qui est interrompu par au moins l'un parmi O, S et NR⁶⁵ et/ou substitué par E ; un groupe aryle en C₆-C₂₄, qui peut être facultativement substitué par G ; ou un groupe hétéroaryle en C₂-C₃₀, qui peut être facultativement substitué par G ; un atome d'halogène, notamment F ou Cl ; haloalkyle en C₁-C₈ tel que CF₃; CN ; ou SiR⁸⁰R⁸¹R⁸² ; de préférence H ou un groupe alkyle en C₁-C₈, plus préférablement, R^{d} est H et l'un parmi R^{b} ou R^{c} est un groupe alkyle en C₁-C₈ et l'autre parmi R^{b} et R^{d} est H ; plus préférablement encore R^{c}, R^{b} et R^{d} sont H ;
ou
deux radicaux adjacents R¹⁰ et/ou deux radicaux adjacents R¹²; deux radicaux adjacents R¹³ et/ou deux radicaux adjacents R¹²; deux radicaux adjacents R¹⁶ et/ou deux radicaux adjacents R¹⁷ ; ou deux radicaux adjacents R¹⁹; ou R^{c} et R^{b}, ou R^{a} et R^{b} forment ensemble un groupe de formule 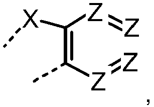 où Z est N ou CR"', où 0 ou 1 Z est N, de préférence 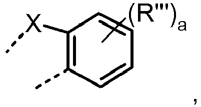 où X est O, S, NR⁷⁵ ou CR⁷³R⁷⁴, de préférence O ; R'" est alkyle en C₁-C₈ et a' est 0 ou 1, de préférence 0 ;
de préférence, les radicaux R¹⁰, R¹², R¹³, R¹⁶, R¹⁷, R¹⁸ et R¹⁹ sont - dans chaque cas - indépendamment les uns des autres un groupe alkyle en C₁-C₈, qui peut être facultativement substitué par au moins un substituant E et/ou interrompu par D, notamment méthyle, éthyle, i-propyle, n-butyle, sec-butyle, tert-butyle ou isoamyle ; un groupe cycloalkyle en C₃-C₆, qui peut être facultativement substitué par au moins un substituant E ; F ; Cl ; haloalkyle en C₁-C₈ tel que CF₃; CN ;
dans un autre mode de réalisation préféré, R¹⁰, R¹², R¹³, R¹⁶, R¹⁷, R¹⁸ et R¹⁹ sont - dans chaque cas - indépendamment les uns des autres l'hydrogène, un groupe alkyle en C₁-C₈ notamment méthyle, éthyle, i-propyle, n-butyle, sec-butyle, tert-butyle ou isoamyle ; ou un groupe phényle, qui peut être facultativement substitué par un ou deux groupes G ; ou un groupe hétéroaryle en C₂-C₃₀, qui peut être facultativement substitué par G ; plus préférablement l'hydrogène, un groupe alkyle en C₁-C₈ notamment méthyle, éthyle, i-propyle, n-butyle, sec-butyle, tert-butyle ou isoamyle ; ou un groupe phényle, qui peut être facultativement substitué par un ou deux groupes alkyle en C₁-C₈, par exemple 2-tolyle, 3-tolyle, 4-tolyle, 2-éthylphényle, 3-éthylphényle, 4-éthylphényle, 2-isopropylphényle, 3-isopropylphényle ou 4-isopropylphényle ; le plus préférablement l'hydrogène ou un groupe alkyle en C₁-C₈ notamment méthyle, éthyle, i-propyle, n-butyle, sec-butyle, tert-butyle ou isoamyle ;
ou
deux radicaux adjacents R¹⁰ et/ou deux radicaux adjacents R¹²; deux radicaux adjacents R¹³ et/ou deux radicaux adjacents R¹²; deux radicaux adjacents R¹⁶ et/ou deux radicaux adjacents R¹⁷ ; ou deux radicaux adjacents R¹⁹ forment ensemble un groupe de formule 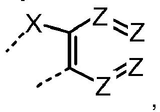 où Z est N ou CR"', où 0 ou 1 Z est N, de préférence 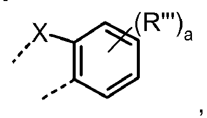 où X est O, S, NR⁷⁵ ou CR⁷³R⁷⁴, de préférence O ou S ; plus préférablement O ; R'" est alkyle en C₁-C₈ et a' est 0 ou 1, de préférence 0 ;
R¹¹, R¹⁴, R²⁰, R²¹, R²², R²³ et R²⁴:
les radicaux R¹¹, R¹⁴, R²⁰, R²¹, R²², R²³ et R²⁴ sont - dans chaque cas - indépendamment les uns des autres un groupe alkyle en C₁-C₁₈, qui peut être facultativement substitué par au moins un substituant E et/ou interrompu par D ; un groupe cycloalkyle en C₃-C₁₂, qui peut être facultativement substitué par au moins un substituant E ; un groupe hétérocycloalkyle comprenant 3 à 6 atomes de cycle, interrompu par au moins un hétéroatome choisi parmi -O-, -S- et -NR⁶⁵-, portant facultativement au moins un substituant E ; un groupe aryle en C₆-C₁₄, qui peut être facultativement substitué par un ou deux groupes G ; un groupe hétéroaryle comprenant 3 à 11 atomes de cycle, qui peut être facultativement substitué par un ou deux groupes G ; ou un groupe -NR⁶⁵-phényle, qui peut être facultativement substitué par un ou deux groupes G ;
de préférence, R¹¹, R¹⁴, R²⁰, R²¹, R²², R²³ et R²⁴ sont - dans chaque cas - indépendamment les uns des autres l'hydrogène ; un groupe alkyle en C₁-C₈, qui peut être facultativement substitué par au moins un substituant E et/ou interrompu par D ; un groupe cycloalkyle en C₃-C₆, qui peut être facultativement substitué par au moins un substituant E ;
ou un groupe phényle, qui peut être facultativement substitué par un ou deux groupes G ;
haloalkyle en C₁-C₈ tel que CF₃; ou SiR⁸⁰R⁸¹R⁸² ; ou dans le cas de **X-1, X-2, X-3, X-31, X-34, X-35, X-36, X-37** et **X-38** CN ;
ou
deux radicaux adjacents R¹¹ ou deux radicaux adjacents R¹⁴ forment ensemble un groupe 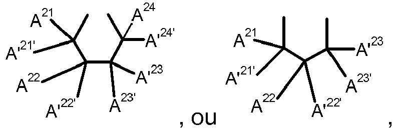 où A²¹, A^{21'}, A²², A^{22'}, A²³, A^{23'}, A^{24'} et A²⁴ sont indépendamment les uns des autres H, un groupe alkyle en C₁-C₄, un groupe cycloalkyle en C3-C6, ou un groupe fluoroalkyle en C₁-C₄ ;
de préférence, R¹¹, R¹⁴, R²⁰, R²¹, R²², R²³ et R²⁴ sont - dans chaque cas - indépendamment les uns des autres un groupe alkyle en C₁-C₈, qui peut être facultativement substitué par au moins un substituant E et/ou interrompu par D, notamment méthyle, éthyle, i-propyle, n-butyle, sec-butyle, tert-butyle ou isoamyle ; un groupe cycloalkyle en C₃-C₆, qui peut être facultativement substitué par au moins un substituant E ; haloalkyle en C₁-C₈ tel que CF₃; ou dans le cas de **X-1, X-2, X-3, X-31, X-34, X-35, X-36, X-37** et **X-38** CN ;
dans un autre mode de réalisation préféré R¹¹, R¹⁴, R²⁰, R²¹, R²², R²³ et R²⁴ sont - dans chaque cas - indépendamment les uns des autres l'hydrogène, un groupe alkyle en C₁-C₈ notamment méthyle, éthyle, i-propyle, n-butyle, sec-butyle, tert-butyle ou isoamyle ; ou un groupe phényle, qui peut être facultativement substitué par un ou deux groupes G ; ou un groupe hétéroaryle en C₂-C₃₀, qui peut être facultativement substitué par G ; plus préférablement l'hydrogène, un groupe alkyle en C₁-C₈ notamment méthyle, éthyle, i-propyle, n-butyle, sec-butyle, tert-butyle ou isoamyle ; ou un groupe phényle, qui peut être facultativement substitué par un ou deux groupes alkyle en C₁-C₈, par exemple 2-tolyle, 3-tolyle, 4-tolyle, 2-éthylphényle, 3-éthylphényle, 4-éthylphényle, 2-isopropylphényle, 3-isopropylphényle ou 4-isopropylphényle ; le plus préférablement l'hydrogène ou un groupe alkyle en C₁-C₈ notamment méthyle, éthyle, i-propyle, n-butyle, sec-butyle, tert-butyle ou isoamyle ;
ou
deux radicaux adjacents R¹¹ ou deux radicaux adjacents R¹⁴ forment ensemble un groupe 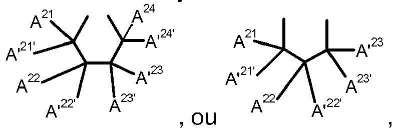 où A²¹, A^{21'}, A²², A^{22'}, A²³, A^{23'}, A^{24'} et A²⁴ sont indépendamment les uns des autres H, un groupe alkyle en C₁-C₄, un groupe cycloalkyle en C3-C6, ou un groupe fluoroalkyle en C₁-C₄ ;
R²⁵ est CH₃ ou éthyle ou iso-propyle ;
R²⁶ est un groupe phényle, qui peut être facultativement substitué par un ou deux groupes choisis parmi CF₃ et alkyle en C₁-C₈ ; de préférence facultativement substitué par un ou deux groupes alkyle en C₁-C₈ ; ou R²⁶ est CH₃ ; ou iso-propyle ; de préférence, R²⁶ est un groupe phényle, qui peut être facultativement substitué par un ou deux groupes choisis parmi CF₃ et alkyle en C₁-C₈ de préférence facultativement substitué par un ou deux groupes alkyle en C₁-C₈ ; dans une autre mode de réalisation préféré R²⁶ est un groupe phényle, qui est substitué par un ou deux groupes phényle ;
D est -S-, -O- ou -NR65- ;
E est -OR⁶⁹, -CN, CF₃, alkyle en C₁-C₈ ou F ; de préférence CF₃ ou alkyle en C₁-C₈ ; plus préférablement alkyle en C₁-C₈ ;
G est -OR⁶⁹, -CN, CF₃ ou alkyle en Ci-Cs ; de préférence alkyle en Ci-Cs ;
R⁶⁵ est un groupe phényle, qui peut être facultativement substitué par un ou deux groupes alkyle en C₁-C₈ ; un groupe alkyle en C₁-C₁₈ non substitué ; ou un groupe alkyle en C₁-C₁₈, qui est interrompu par -O- ; et
R⁶⁹ est un groupe phényle, qui peut être facultativement substitué par un ou deux groupes alkyle en C₁-C₈ ; un groupe alkyle en C₁-C₁₈ non substitué ; ou un groupe alkyle en C₁-C₁₈,
qui est interrompu par -O- ;
A¹ est aryle en C₆-C₁₀ ;
ou
deux groupes joints A¹ forment ensemble un groupe 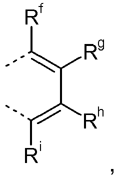 où R^{f}, R^{g}, R^{h} et Rⁱ sont indépendamment les uns des autres H, ou alkyle en Ci-Cs ;
Q¹ et Q² sont indépendamment l'un de l'autre l'hydrogène, alkyle en C₁-C₁₈, ou aryle en C₆-C₁₈ ;
w, x sont indépendamment l'un de l'autre 0, 1 ou 2, de préférence 0 ou 1 ; plus préférablement 0 ;
z est 0, 1, 2 ou 3, de préférence 0, 1, plus préférablement 0 ;
y, y', y", u, v
sont indépendamment les uns des autres 0, 1 ou 2, de préférence 0 ou 2 ; plus préférablement 0 ;
y'" est 0 ou 1, de préférence 0 ;
p, q, r, s, t, t', t"
sont indépendamment les uns des autres 0, 1, 2, 3 ou 4, de préférence 0, 1, 2 ou 3 ;
r' est 0, 1 ou 2, de préférence 0 ou 1, plus préférablement 0.

12. Complexe carbène métal selon l'une quelconque des revendications 1 à 11, où le métal est Ir.

13. Complexe carbène métal selon la revendication 12, choisi parmi 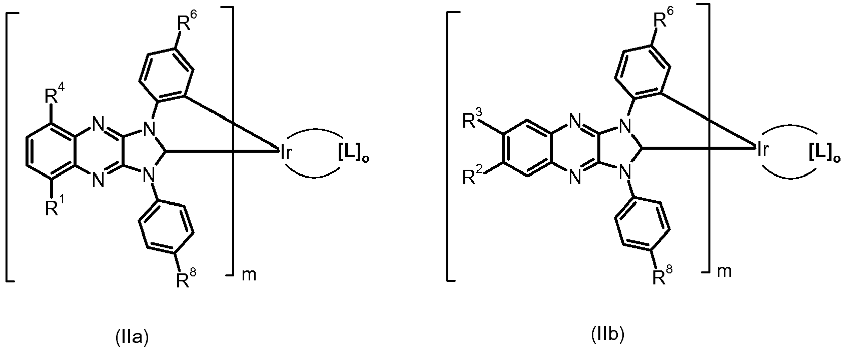 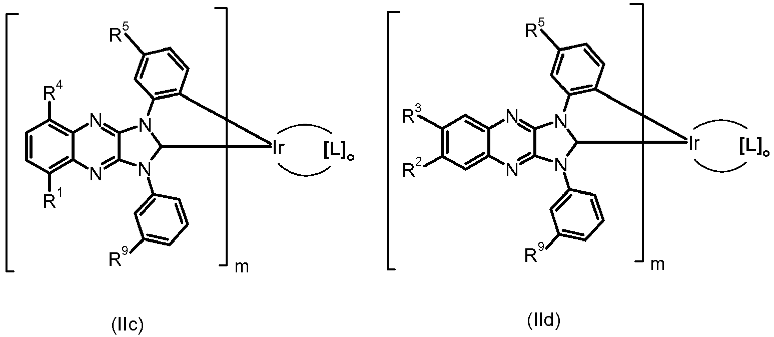 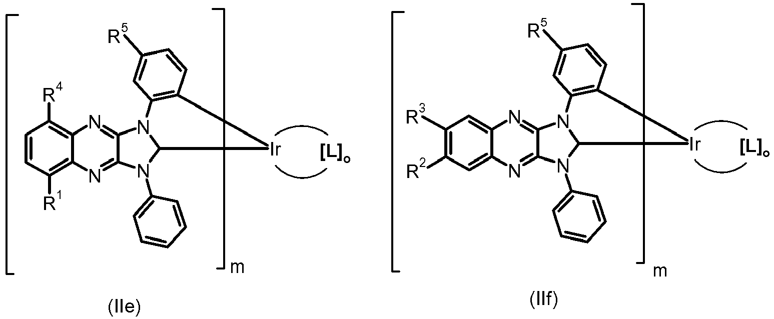 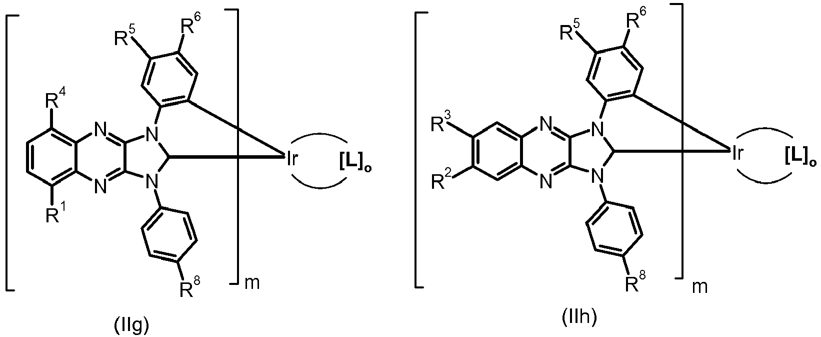 où
R¹, R², R³ et R⁴
sont indépendamment les uns des autres - dans chaque cas - l'hydrogène ; un groupe alkyle en C₁-C₈, qui peut être facultativement substitué par au moins un substituant E et/ou interrompu par D ; un groupe cycloalkyle en C₃-C₆, qui peut être facultativement substitué par au moins un substituant E ; ou un groupe phényle, qui peut être facultativement substitué par un ou deux groupes G ;
de préférence, dans le cas où R¹, R², R³ et/ou R⁴ sont un groupe phényle, qui peut être facultativement substitué par un ou deux groupes G ; R⁵, R⁶, R⁸ et R⁹ ne sont pas un groupe phényle, qui peut être facultativement substitué par un ou deux groupes G ;
plus préférablement, R¹, R², R³ et R⁴ sont indépendamment les uns des autres - dans chaque cas - l'hydrogène ; un groupe alkyle en C₁-C₈, qui peut être facultativement substitué par au moins un substituant E et/ou interrompu par D ; ou un groupe cycloalkyle en C₃-C₆, qui peut être facultativement substitué par au moins un substituant E ;
le plus préférablement, R¹ et R⁴, ainsi que R² et R³ sont identiques ; plus préférablement encore, R¹, R², R³ et R⁴ sont l'hydrogène ;
R⁵ et R⁶
sont indépendamment l'un de l'autre - dans chaque cas - l'hydrogène ; un groupe alkyle en C₁-C₈, qui peut être facultativement substitué par au moins un substituant E et/ou interrompu par D ; ou un groupe cycloalkyle en C₃-C₆, qui peut être facultativement substitué par au moins un substituant E ; ou un groupe phényle, qui peut être facultativement substitué par un ou deux groupes G ;
de préférence, R⁵ et R⁶ sont indépendamment l'un de l'autre - dans chaque cas - l'hydrogène ; un groupe alkyle en C₁-C₈, qui peut être facultativement substitué par au moins un substituant E et/ou interrompu par D ; ou un groupe cycloalkyle en C₃-C₆, qui peut être facultativement substitué par au moins un substituant E ; ou soit R⁵ soit R⁶, de préférence R⁵, est un groupe phényle, qui peut être facultativement substitué par un ou
deux groupes G ;
plus préférablement, R⁵ et R⁶ sont indépendamment l'un de l'autre - dans chaque cas - l'hydrogène ; un groupe alkyle en C₁-C₈, qui peut être facultativement substitué par au moins un substituant E et/ou interrompu par D ; ou un groupe cycloalkyle en C₃-C₆, qui peut être facultativement substitué par au moins un substituant E ; ou soit R⁵ soit R⁶, de préférence R⁵, est un groupe phényle, qui peut être facultativement substitué par un ou
deux groupes G ; dans un autre mode de réalisation préféré, R⁶ est un groupe phényle,
qui peut être facultativement substitué par un ou deux groupes G ; plus préférablement,
R⁵ et R⁶ sont l'hydrogène ;
R⁸ et R⁹
sont indépendamment l'un de l'autre l'hydrogène ; un groupe alkyle en C₁-C₈, qui peut être facultativement substitué par au moins un substituant E et/ou interrompu par D ; ou
un groupe cycloalkyle en C₃-C₆, qui peut être facultativement substitué par au moins un substituant E ; ou un groupe phényle, qui peut être facultativement substitué par un ou
deux groupes G ;
de préférence, R⁸ et R⁹ sont indépendamment l'un de l'autre - dans chaque cas - l'hydrogène ; un groupe alkyle en C₁-C₈, qui peut être facultativement substitué par au moins un substituant E et/ou interrompu par D ; ou un groupe cycloalkyle en C₃-C₆, qui peut être facultativement substitué par au moins un substituant E ; ou soit R⁸ soit R⁹ est un groupe phényle, qui peut être facultativement substitué par un ou deux groupes G ;
plus préférablement, R⁸ et R⁹ sont indépendamment l'un de l'autre - dans chaque cas - l'hydrogène ; un groupe alkyle en C₁-C₈, qui peut être facultativement substitué par au moins un substituant E et/ou interrompu par D ; ou un groupe cycloalkyle en C₃-C₆, qui peut être facultativement substitué par au moins un substituant E ; plus préférablement, R⁹ est l'hydrogène et R⁸ est l'hydrogène ou un groupe phényle qui peut être facultativement substitué par un ou deux groupes G ; plus préférablement, R⁸ et R⁹ sont l'hydrogène ;
D est -S- or -O- ;
E est -OR⁶⁹, -CN, CF₃, alkyle en C₁-C₈ ou F ; de préférence CF₃ ou alkyle en Ci-Cs ; de préférence alkyle en C₁-C₈ ;
G est -OR⁶⁹, -CN, CF₃ ou alkyle en C₁-C₈ ; de préférence alkyle en Ci-Cs ;
R⁶⁹ est un groupe phényle, qui peut être facultativement substitué par un ou deux groupes alkyle en C₁-C₈ ; un groupe alkyle en C₁-C₈ non substitué ; ou un groupe alkyle en C₁-C₈,
qui est interrompu par -O- ;
L est un ligand bidentate monoanionique ;
m est 1, 2 ou 3 ; de préférence 2 ou 3 ; ou - dans un autre mode de réalisation préféré - 1 ;
o est 0, 1 ou 2 ; de préférence 0 ou 1 ; ou - dans un autre mode de réalisation préféré - 2 ;
et la somme de m + o est 3 ;
dans le cas où o = 2, les ligands L peuvent être identiques ou différents, de préférence identiques ; et dans le cas où m est 2 ou 3, les m ligands carbène peuvent être identiques ou différents, de préférence identiques.

14. Complexe carbène métal selon la revendication 13, choisi parmi 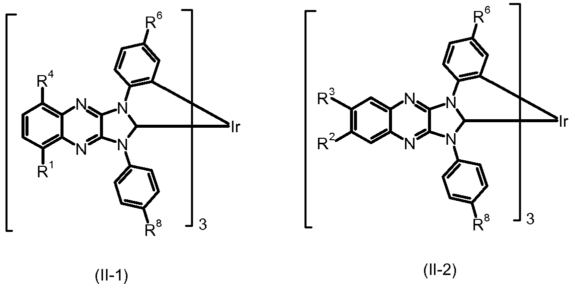 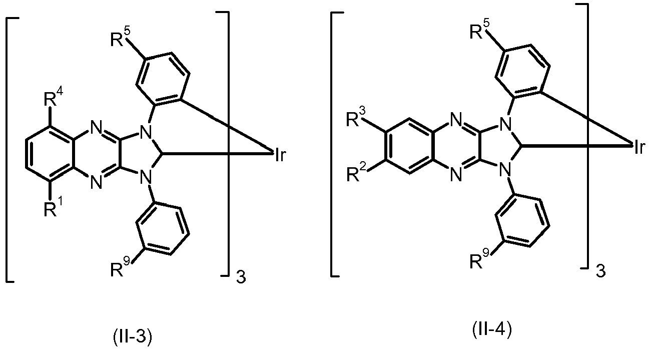 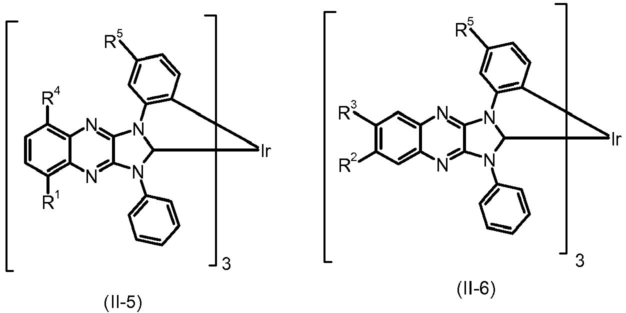 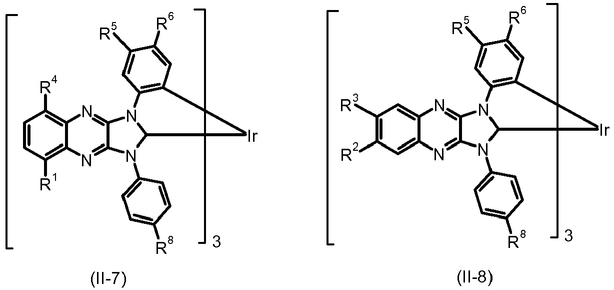 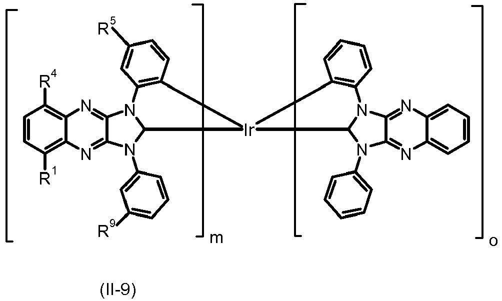 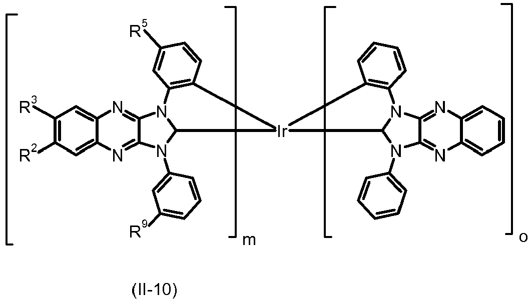 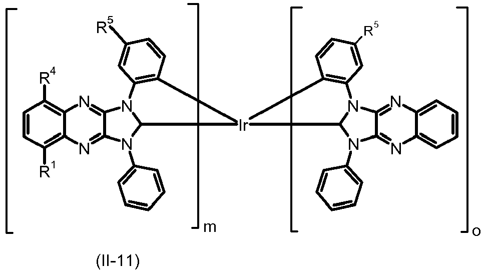 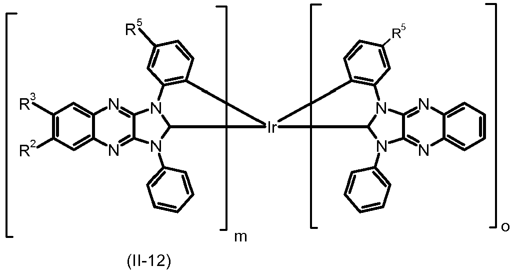 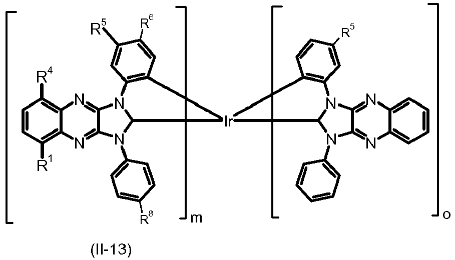 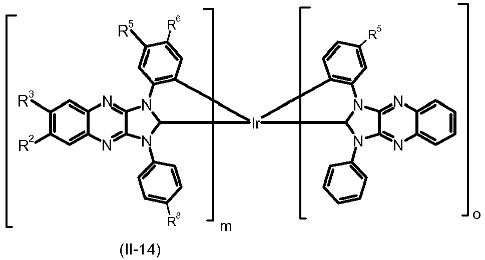 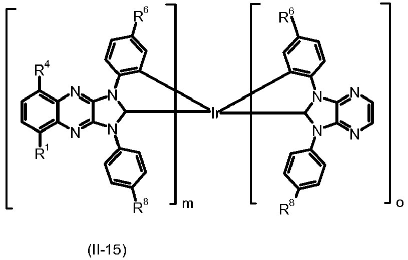 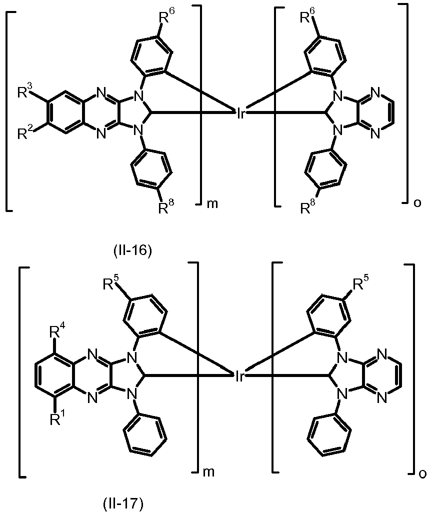 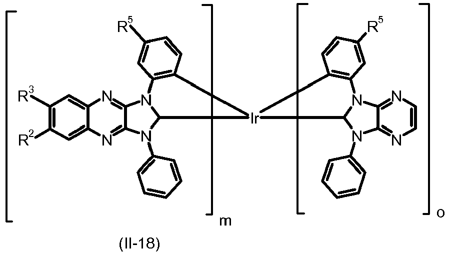 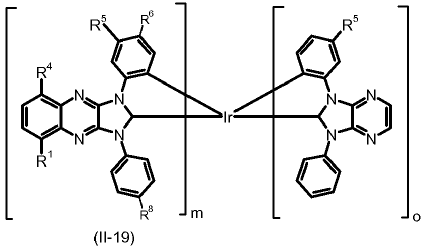 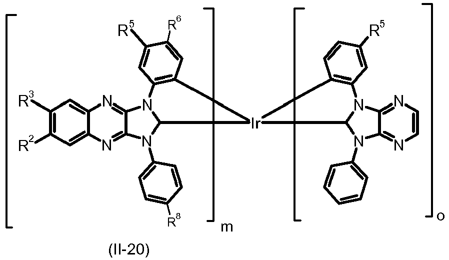 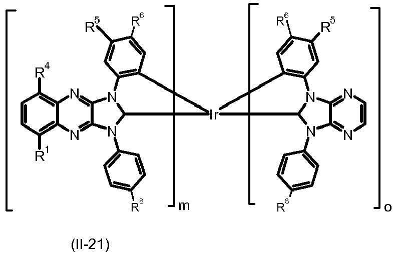 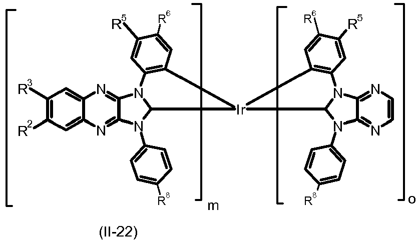 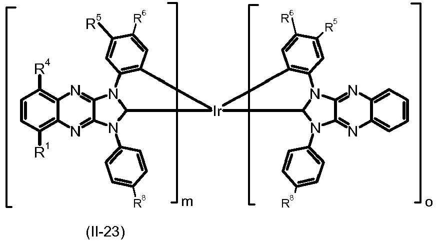 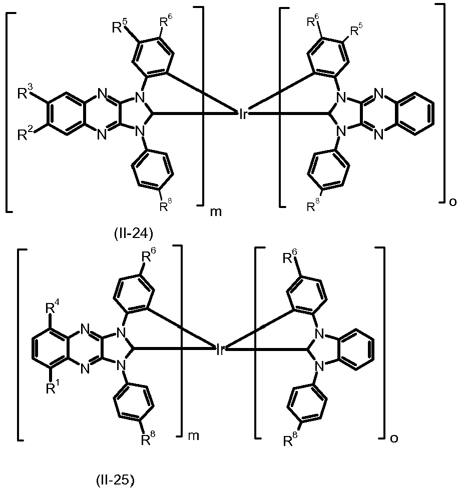 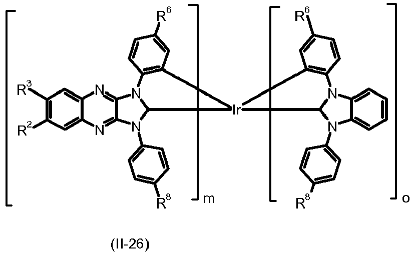 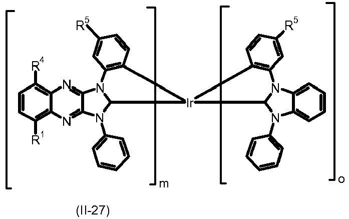 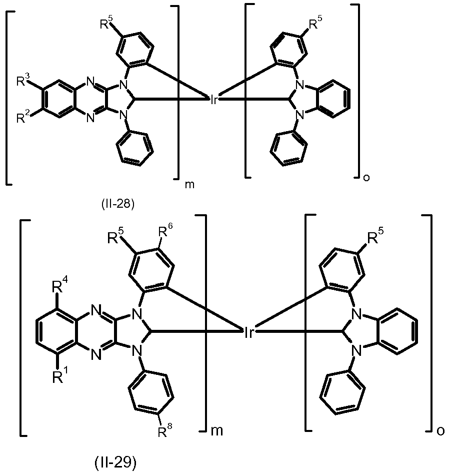 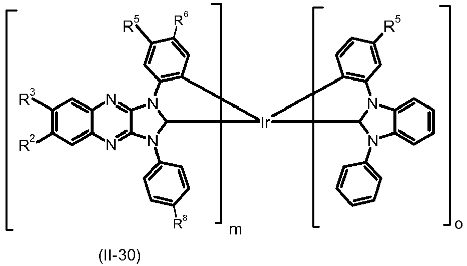 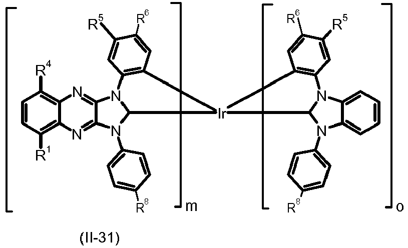 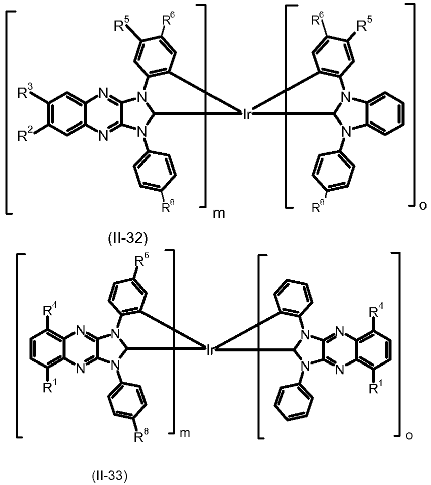 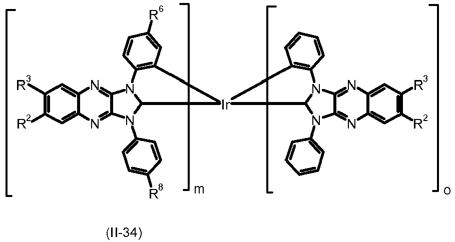 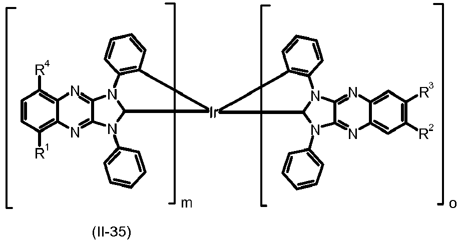 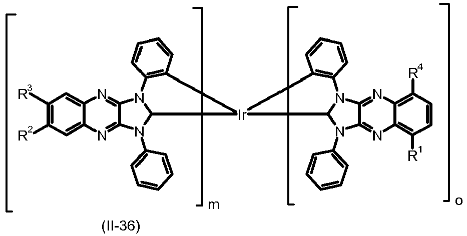 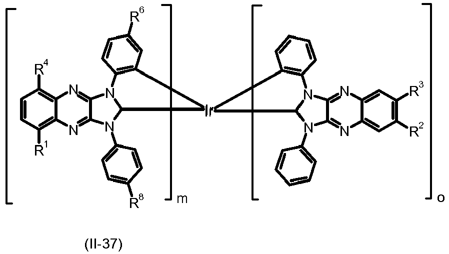 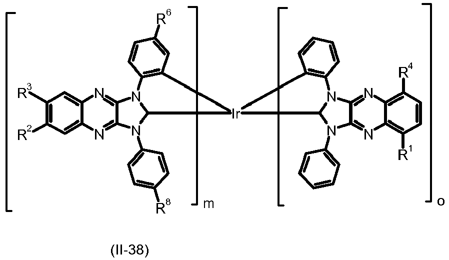 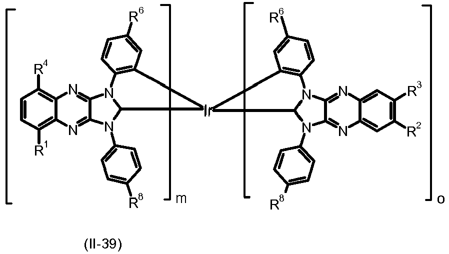 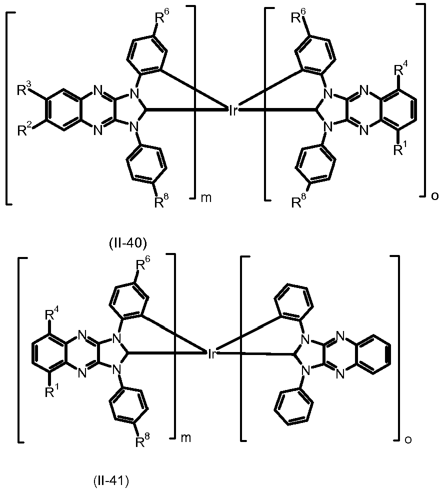 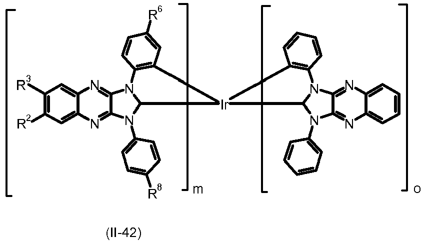 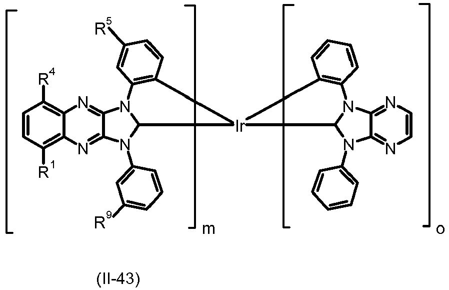 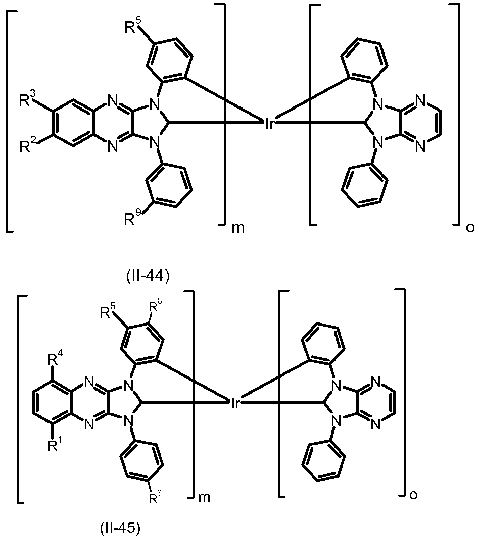 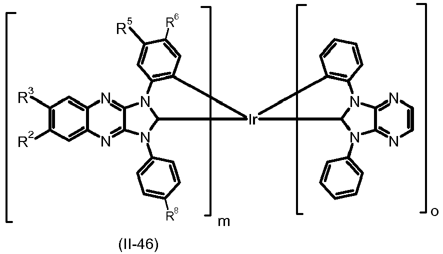 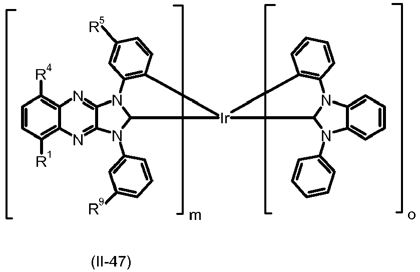 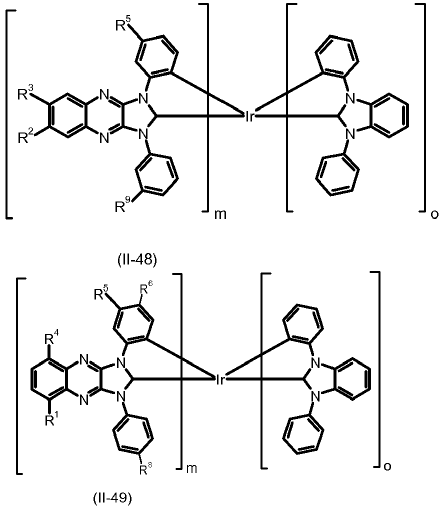 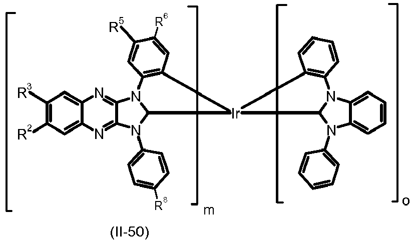 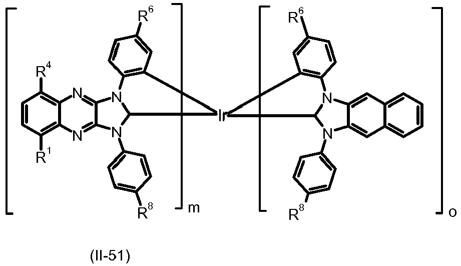 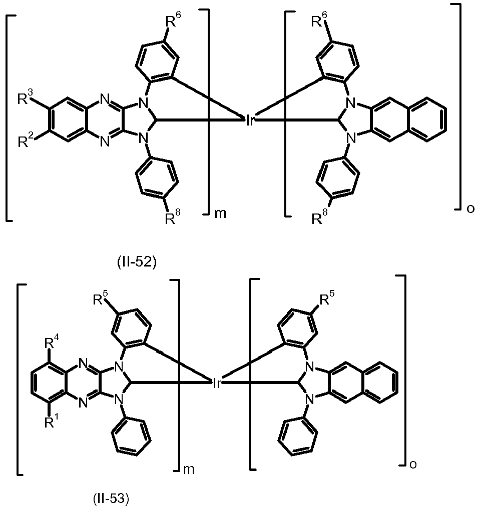 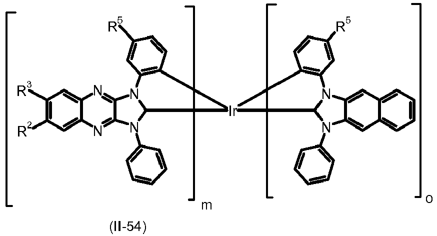 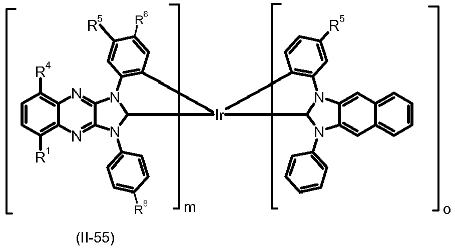 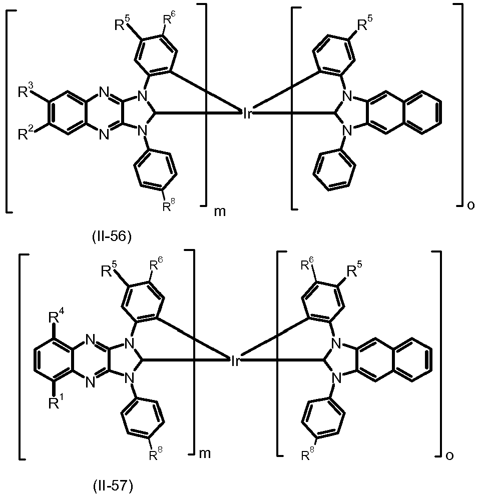 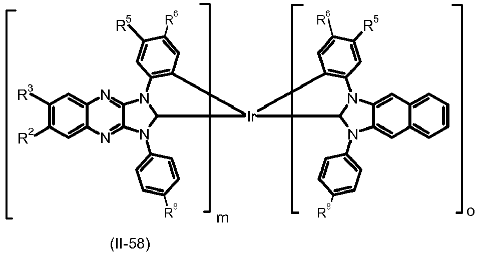 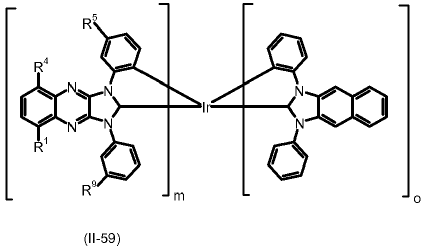 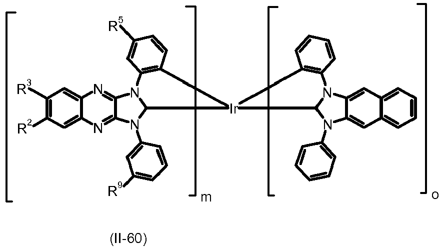 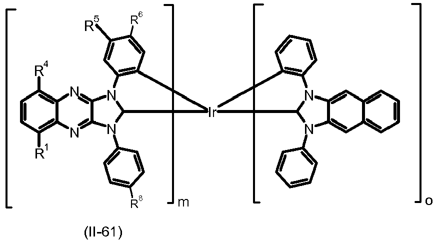 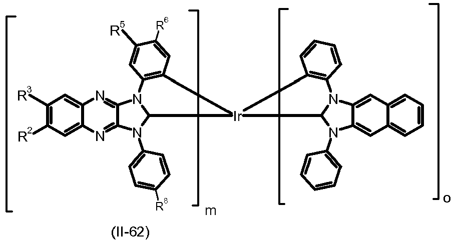 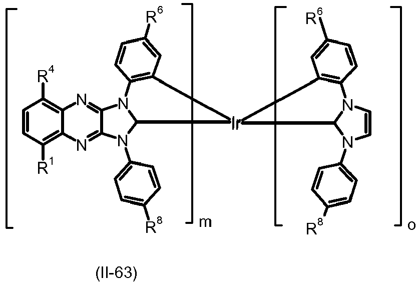 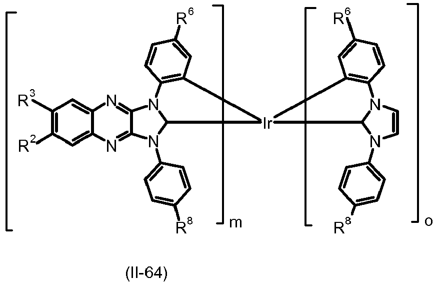 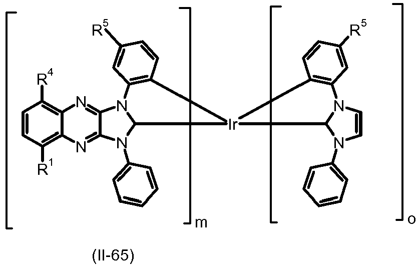 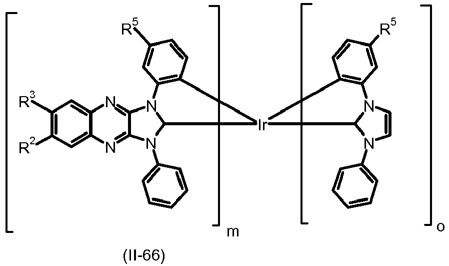 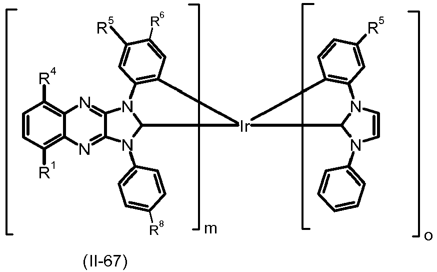 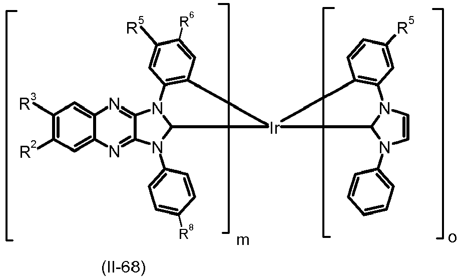 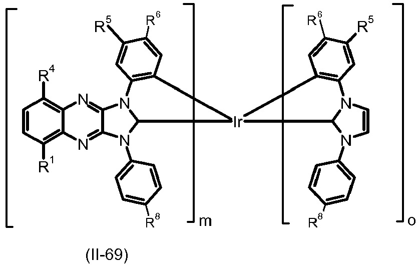 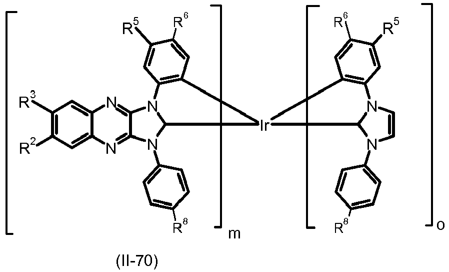 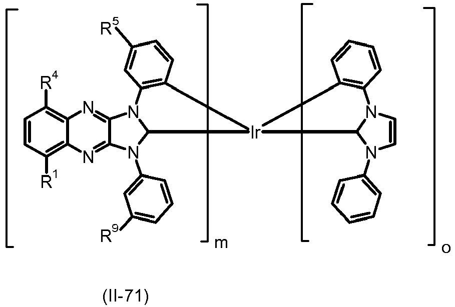 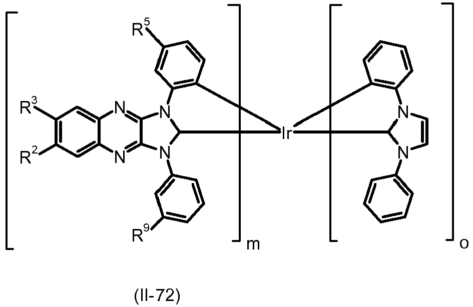 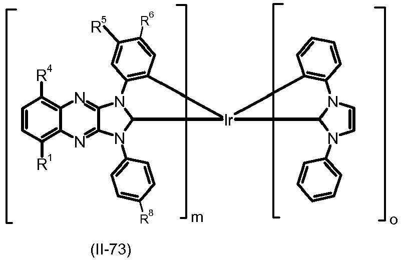 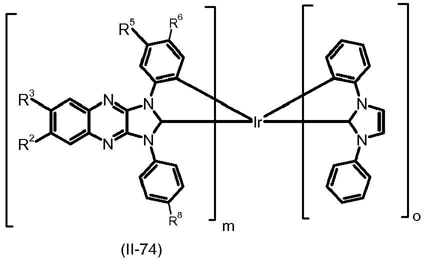 où
R¹, R², R³ et R⁴
sont indépendamment les uns des autres - dans chaque cas - l'hydrogène, un groupe alkyle en C₁-C₈, qui peut être facultativement substitué par au moins un substituant E et/ou interrompu par D ; un groupe cycloalkyle en C₃-C₆, qui peut être facultativement substitué par au moins un substituant E ; ou un groupe phényle, qui peut être facultativement substitué par un ou deux groupes G ;
de préférence, dans le cas où R¹, R², R³ et/ou R⁴ sont un groupe phényle, qui peut être facultativement substitué par un ou deux groupes G ; R⁵, R⁶, R⁸ et R⁹ ne sont pas un groupe phényle, qui peut être facultativement substitué par un ou deux groupes G ;
plus préférablement, R¹, R², R³ et R⁴ sont indépendamment les uns des autres - dans chaque cas - l'hydrogène, un groupe alkyle en C₁-C₈, qui peut être facultativement substitué par au moins un substituant E et/ou interrompu par D ; ou un groupe cycloalkyle en C₃-C₆, qui peut être facultativement substitué par au moins un substituant E ;
le plus préférablement, R¹ et R⁴, ainsi que R² et R³ sont identiques ; plus préférablement encore, R¹, R², R³ et R⁴ sont l'hydrogène ;
R⁵ et R⁶
sont indépendamment l'un de l'autre - dans chaque cas - l'hydrogène, un groupe alkyle en C₁-C₈, qui peut être facultativement substitué par au moins un substituant E et/ou interrompu par D ; ou un groupe cycloalkyle en C₃-C₆, qui peut être facultativement substitué par au moins un substituant E ; ou un groupe phényle, qui peut être facultativement substitué par un ou deux groupes G ;
de préférence, R⁵ et R⁶ sont indépendamment l'un de l'autre - dans chaque cas - l'hydrogène, un groupe alkyle en C₁-C₈, qui peut être facultativement substitué par au moins un substituant E et/ou interrompu par D ; ou un groupe cycloalkyle en C₃-C₆, qui peut être facultativement substitué par au moins un substituant E ; ou soit R⁵ soit R⁶, de préférence R⁵, est un groupe phényle, qui peut être facultativement substitué par un ou
deux groupes G ;
plus préférablement, R⁵ et R⁶ sont indépendamment l'un de l'autre - dans chaque cas - l'hydrogène, un groupe alkyle en C₁-C₈, qui peut être facultativement substitué par au moins un substituant E et/ou interrompu par D ; ou un groupe cycloalkyle en C₃-C₆, qui peut être facultativement substitué par au moins un substituant E ; ou soit R⁵ soit R⁶, de préférence R⁵, est un groupe phényle, qui peut être facultativement substitué par un ou deux groupes G ; dans un autre mode de réalisation préféré, R⁶ est un groupe phényle, qui peut être facultativement substitué par un ou deux groupes G ; plus préférablement, R⁵ et R⁶ sont l'hydrogène ;
R⁸ et R⁹
sont indépendamment l'un de l'autre - dans chaque cas - l'hydrogène, un groupe alkyle en C₁-C₈, qui peut être facultativement substitué par au moins un substituant E et/ou interrompu par D ; ou un groupe cycloalkyle en C₃-C₆, qui peut être facultativement substitué par au moins un substituant E ; ou un groupe phényle, qui peut être facultativement substitué par un ou deux groupes G ;
de préférence, R⁸ et R⁹ sont indépendamment l'un de l'autre - dans chaque cas - l'hydrogène, un groupe alkyle en C₁-C₈, qui peut être facultativement substitué par au moins un substituant E et/ou interrompu par D ; ou un groupe cycloalkyle en C₃-C₆, qui peut être facultativement substitué par au moins un substituant E ; ou soit R⁸ soit R⁹ est un groupe phényle, qui peut être facultativement substitué par un ou deux groupes G ;
plus préférablement, R⁸ et R⁹ sont indépendamment l'un de l'autre - dans chaque cas - un groupe alkyle en C₁-C₈, qui peut être facultativement substitué par au moins un substituant E et/ou interrompu par D ; ou un groupe cycloalkyle en C₃-C₆, qui peut être facultativement substitué par au moins un substituant E ; plus préférablement, R⁹ est l'hydrogène et R⁸ est l'hydrogène ou un groupe phényle qui peut être facultativement substitué par un ou deux groupes G ; le plus préférablement, R⁸ et R⁹ sont l'hydrogène ;
le plus préférablement, dans le cas où R⁶ et R⁸ sont tous les deux présents, R⁶ et R⁸ sont identiques ; dans le cas où R⁵ et R⁹ sont tous les deux présents, R⁵ et R⁹ sont identiques ;
D est -S- or -O- ;
E est -OR⁶⁹, -CN, CF₃, alkyle en C₁-C₈ ou F ; de préférence CF₃ ou alkyle en C₁-C₈ ; de préférence alkyle en C₁-C₈ ;
G est -OR⁶⁹, -CN, CF₃ ou alkyle en C₁-C₈ ; de préférence alkyle en C₁-C₈ ;
R⁶⁹ est un groupe phényle, qui peut être facultativement substitué par un ou deux groupes alkyle en C₁-C₈ ; un groupe alkyle en C₁-C₈ non substitué ; ou un groupe alkyle en C₁-C₈,
qui est interrompu par -O- ;
m est 2 ou 1, de préférence 2 ; dans le cas où m est 2, les deux ligands sont identiques ou différents, de préférence, les deux ligands sont identiques ;
o est 1 ou 2, de préférence 1 ; dans le cas où m est 2, les deux ligands sont identiques ou différents, de préférence, les deux ligands sont identiques ;
et la somme de m + o est 3.

15. Dispositif électronique organique, comprenant au moins un complexe carbène métal selon l'une quelconque des revendications 1 à 14 et 22 et 23.

16. Dispositif électronique organique selon la revendication 15, le dispositif électronique organique étant choisi parmi les diodes électroluminescentes organiques (OLED), les cellules photovoltaïques organiques (OPV), les transistors organiques à effet de champ (OFET) et les cellules électrochimiques électroluminescentes (LEEC).

17. Couche électroluminescente comprenant au moins un complexe carbène métal selon l'une quelconque des revendications 1 à 14 et 22 et 23.

18. Couche électroluminescente selon la revendication 17, comprenant au moins un complexe carbène métal selon l'une quelconque des revendications 1 à 14 et 22 et 23 et au moins une matière hôte.

19. Appareil choisi dans le groupe constitué par les unités d'affichage visuel stationnaires telles que les unités d'affichage visuel d'ordinateurs, les téléviseurs, les unités d'affichage visuel dans les imprimantes, les appareils de cuisine et les panneaux publicitaires, les éclairages, les panneaux d'information, et les unités d'affichage visuel mobiles telles que les unités d'affichage visuel dans les téléphones cellulaires, les tablettes électroniques, les ordinateurs portables, les appareils photo numériques, les lecteurs MP3, les véhicules et les affichages de destination sur les autobus et les trains ; les unités d'éclairage ; les claviers ; les articles vestimentaires ; les meubles ; les papiers peints, comprenant le dispositif électronique organique selon la revendication 15, ou 16, ou la couche d'émission selon la revendication 17 ou 18.

20. Utilisation d'un complexe carbène métal selon l'une quelconque des revendications 1 à 14 et 22 et 23 pour des photorécepteurs électrophotographiques, des convertisseurs photoélectriques, des cellules solaires organiques (photovoltaïques organiques), des éléments de commutation, des transistors organiques électroluminescents à effet de champ (OLEFET), des capteurs d'image, des lasers à colorants et des dispositifs électroluminescents.

21. Procédé pour la préparation d'un complexe carbène métal selon l'une quelconque des revendications 1 à 14 et 22 et 23, comprenant au moins un ligand de formule (I) 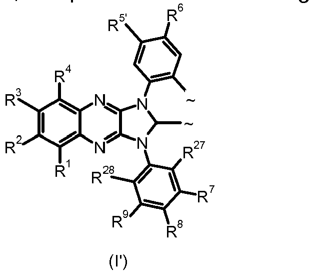 où
où les résidus R¹, R², R³, R⁴, R⁶, R⁷, R⁸, R⁹, R²⁷ et R²⁸ sont définis dans l'une quelconque des revendications 1 à 14, et
R^{5'} est un groupe alkyle en C₁-C₁₈, qui peut être facultativement substitué par au moins un substituant E et/ou interrompu par D ; un groupe cycloalkyle en C₃-C₁₂, qui peut être facultativement substitué par au moins un substituant E ; un groupe aryle en C₆-C₁₄, qui peut être facultativement substitué par au moins un substituant G ; un groupe -N(aryle en C₆-C₁₄)₂, qui peut être facultativement substitué par au moins un substituant G ; ou un groupe hétéroaryle comprenant 3 à 11 atomes de cycle, qui peut être facultativement substitué par au moins un substituant G, interrompu par au moins l'un parmi O, S et N ;
comprenant la réaction du complexe carbène métal, où le métal est choisi parmi Ir et Pt, comprenant au moins un ligand de formule (III) 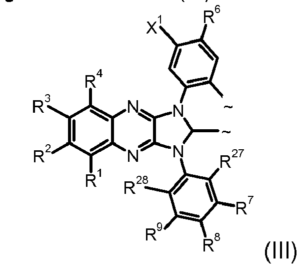 avec un composé de formule (IV) correspondant au résidu R^{5'} substitué par Y respectif :
R^{5'}-Y (IV)
où
X¹ est Cl, Br ou I, notamment Br ;
Y est -B(OH)₂, -B(OY¹)₂, 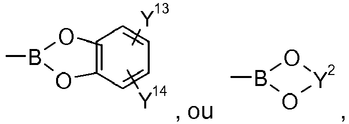 où Y¹ est un groupe alkyle en C₁-C₁₀ et Y² est indépendamment dans chaque occurrence un groupe alkylène en C₂-C₁₀, tel que -CY³Y⁴-CY⁵Y⁶-, ou -CY⁷Y⁸-CY⁹Y¹⁰-CY¹¹Y¹²-, où Y³, Y⁴, Y⁵, Y⁶, Y⁷, Y⁸, Y⁹, Y¹⁰, Y¹¹ et Y¹² sont indépendamment les uns des autres l'hydrogène, ou un groupe alkyle en C₁-C₁₀, notamment -C(CH₃)₂C(CH₃)₂-, -CH₂C(CH₃)₂CH₂-, ou -C(CH₃)₂CH₂C(CH₃)₂-, et Y¹³ et Y¹⁴ sont indépendamment l'un de l'autre l'hydrogène, ou un groupe alkyle en C₁-C₁₀; -SnR³⁰⁷R³⁰⁸R³⁰⁹, où R³⁰⁷, R³⁰⁸ et R³⁰⁹ sont identiques ou différents et sont H ou alkyle en C₁-C₆, où deux radicaux forment facultativement un cycle commun et ces radicaux sont facultativement ramifiés ou non ramifiés ;
ZnR³¹⁰R³¹¹, où R³¹⁰ est un halogène et R³¹¹ est un groupe alkyle en C₁-C₁₀, un groupe aryle en C₆-C₁₂, ou un groupe alcényle en C₁-C₁₀ ; ou
SiR³¹²R³¹³R³¹⁴, où R³¹², R³¹³ et R³¹⁴ sont identiques ou différents et sont un halogène, ou alkyle en C₁-C₆.

22. Complexe carbène métal selon l'une quelconque des revendications 1, 2, 4 à 14, où les radicaux R¹, R², R³, R⁴, R⁵, R⁶, R⁷, R⁸, R⁹, R²⁷ et R²⁹ sont l'hydrogène.

23. Complexe carbène métal selon l'une quelconque des revendications 1 à 14, le complexe carbène métal ayant l'une des formules suivantes 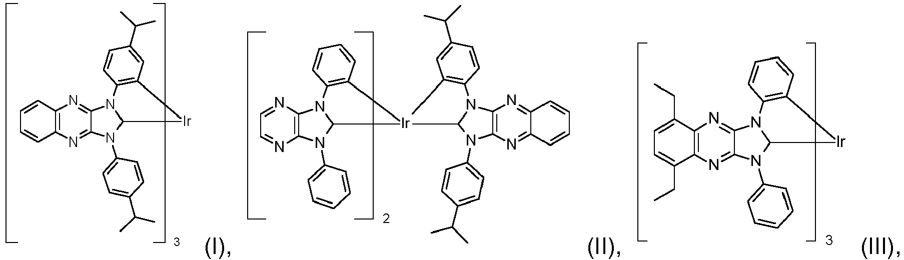 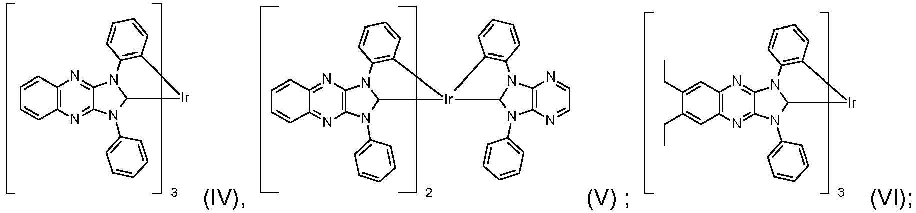 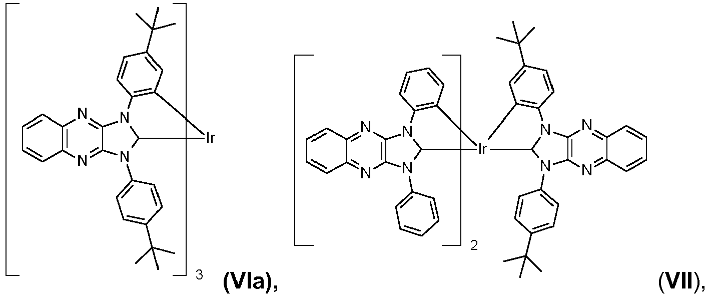 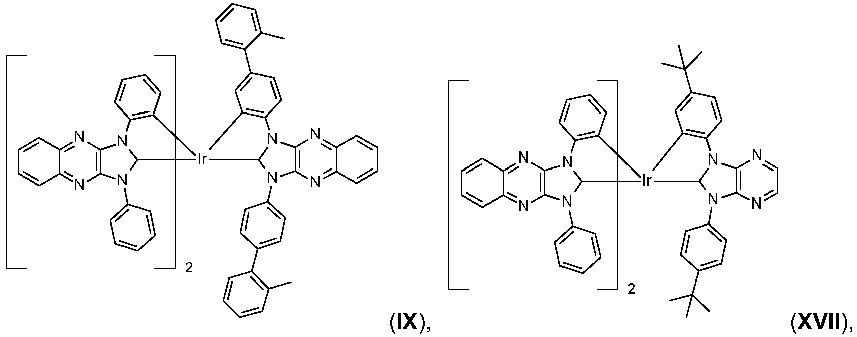 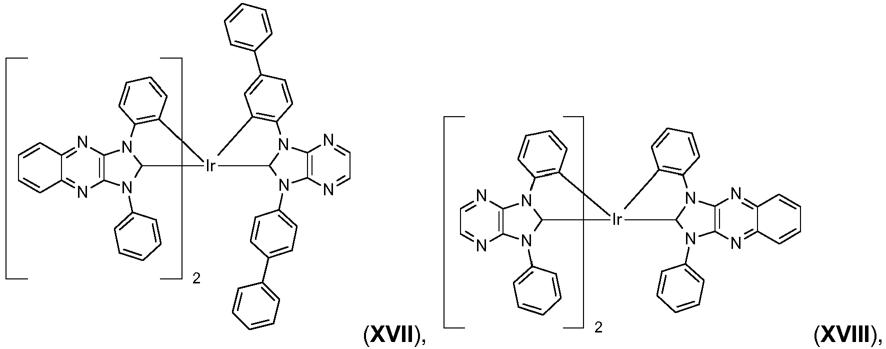 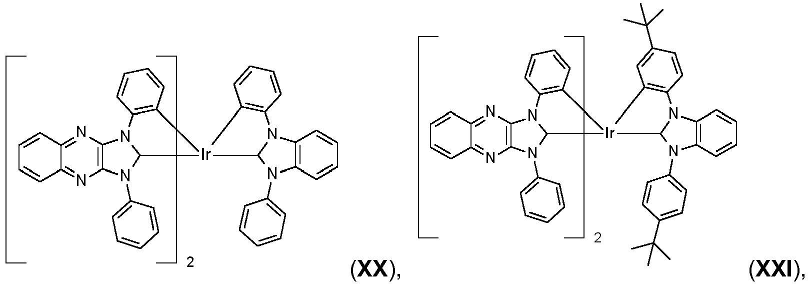 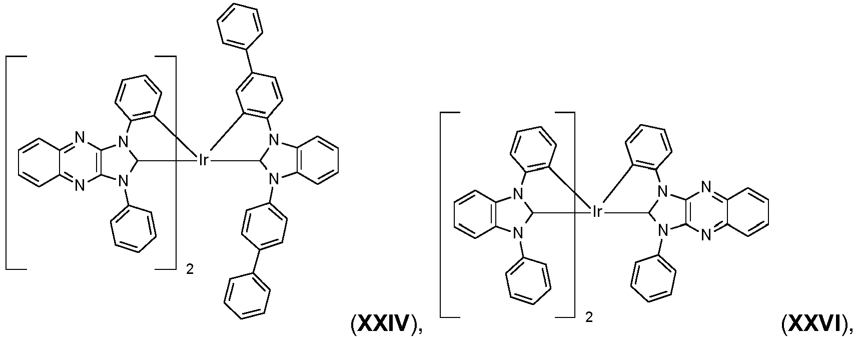 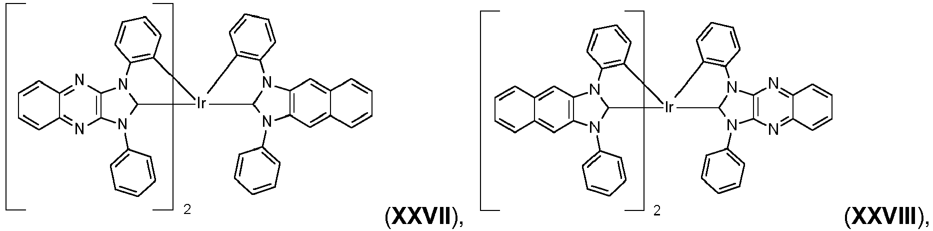 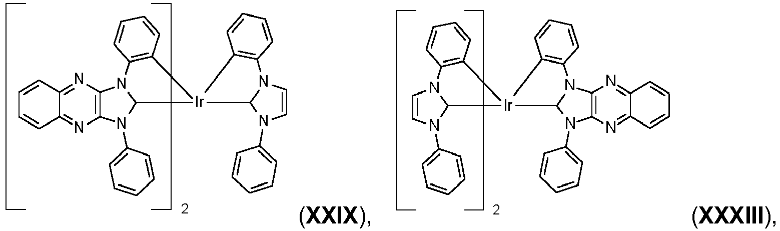 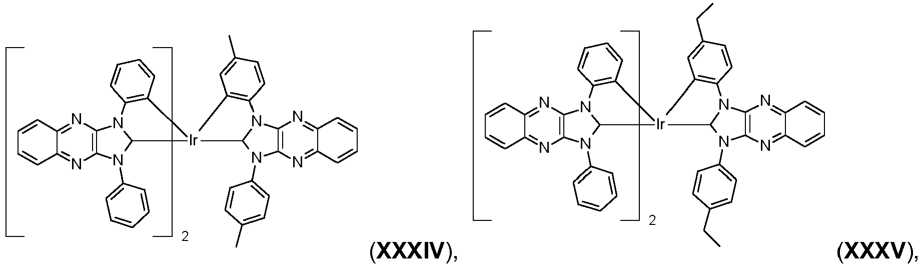 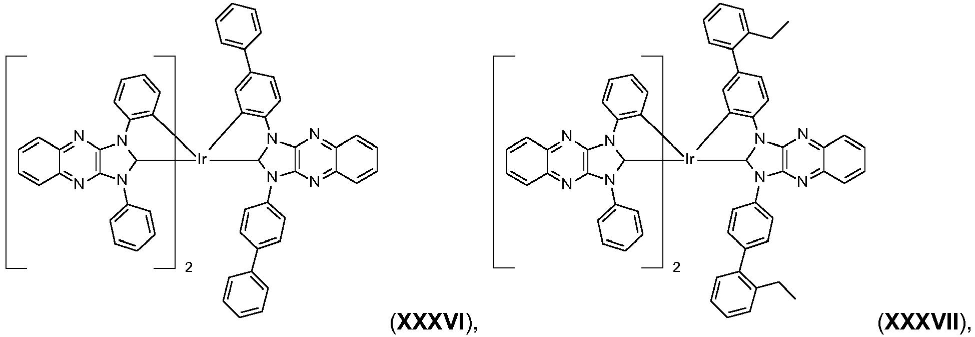 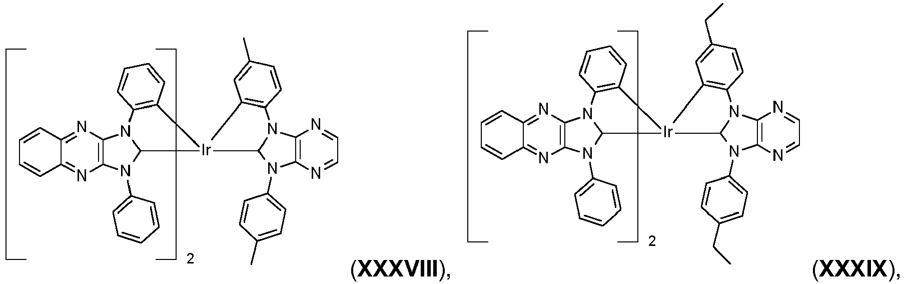 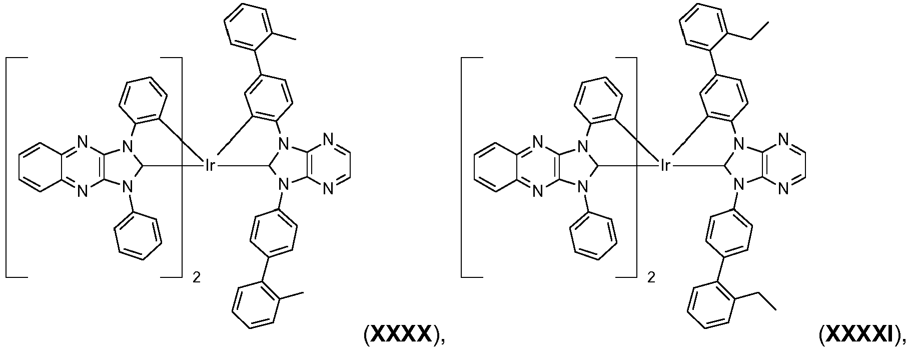 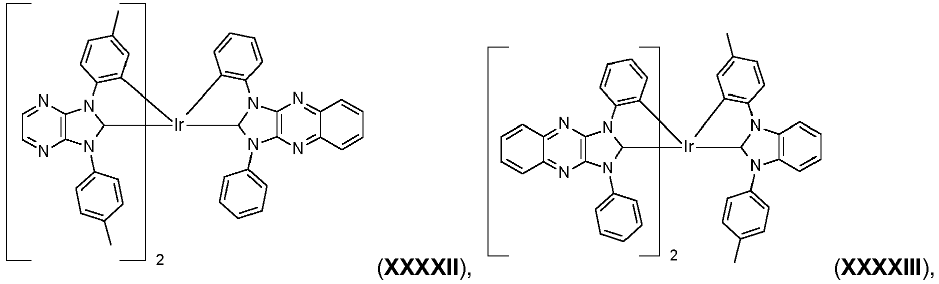 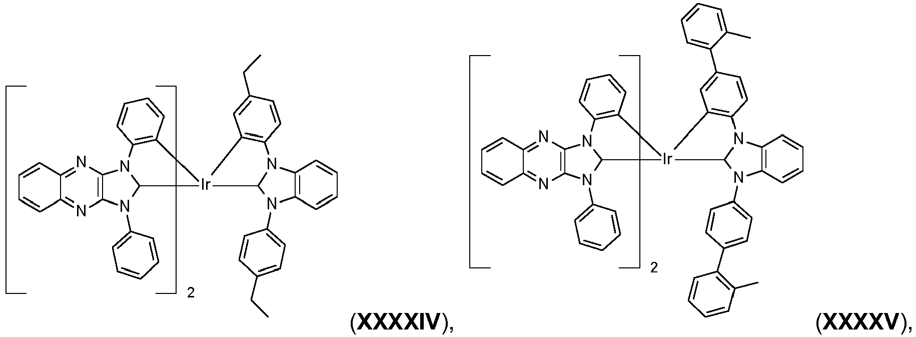 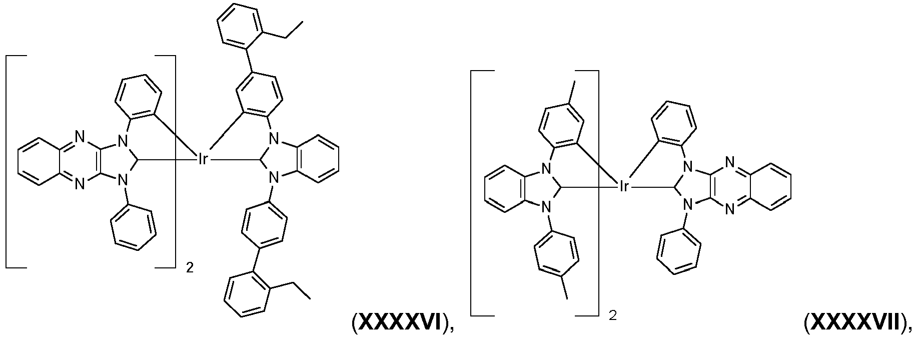 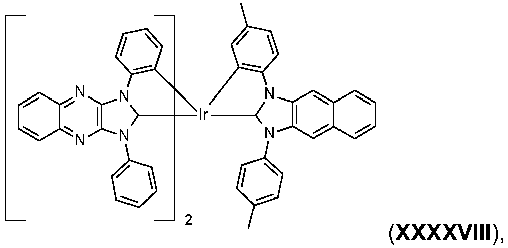 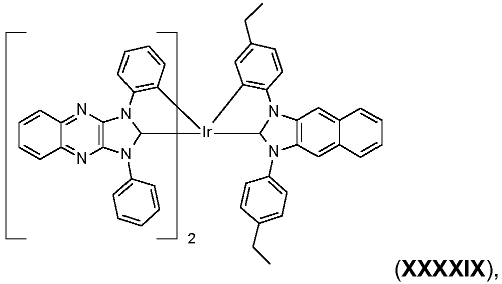 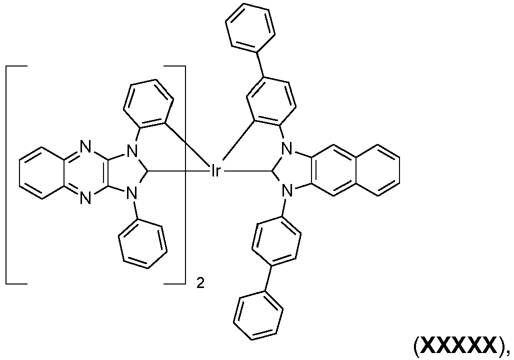 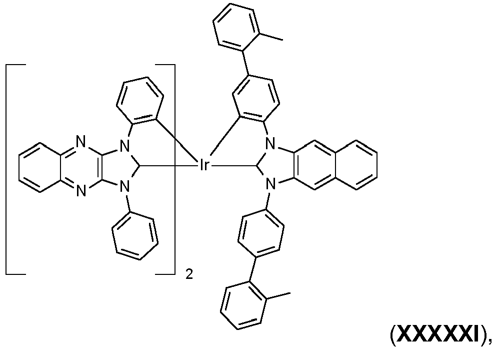 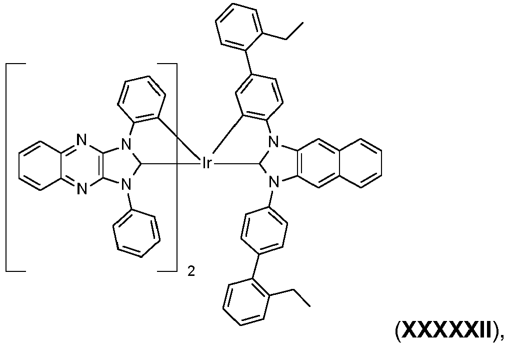 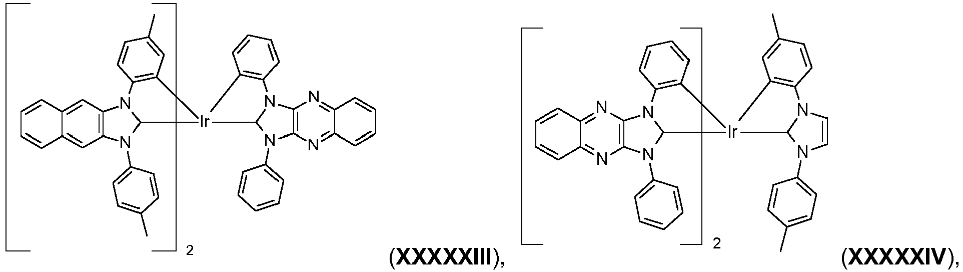 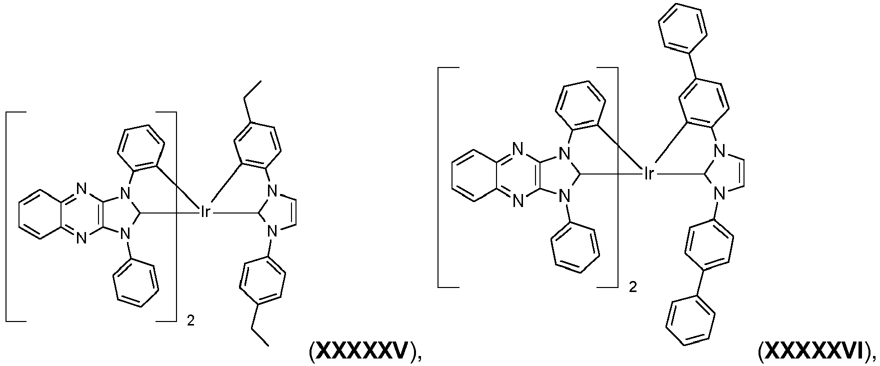 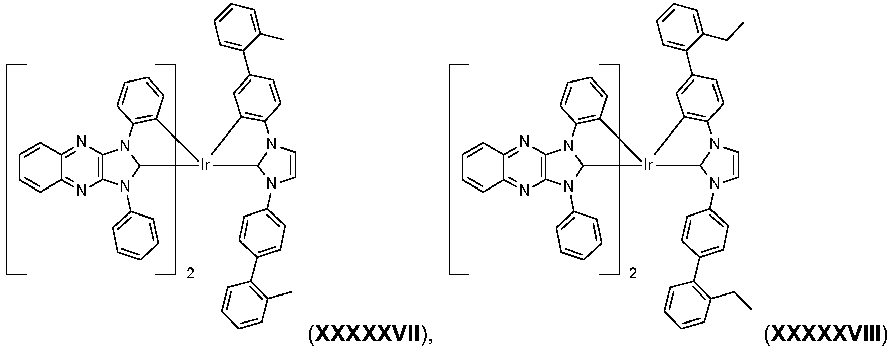 et
